(19) Europäisches Patentamt
European Patent Office
Office européen des brevets

(11) EP 1 217 438 B1

(12) EUROPEAN PATENT SPECIFICATION

(45) Date of publication and mention of the grant of the patent:
**14.12.2005 Bulletin 2005/50**

(51) Int Cl.$^7$: **G03C 9/08**, B29C 67/00

(21) Application number: **02075796.9**

(22) Date of filing: **17.04.1989**

(54) **Stereolithography using different types of vector scanning**

Stereolithografie mit verschiedenen Vektorabtastungsmoden

Stéréolithographie avec plusieurs types de balayage vectoriel

(84) Designated Contracting States:
**AT BE CH DE ES FR GB GR IT LI LU NL SE**

(30) Priority: **18.04.1988 US 182830**
**08.11.1988 US 269801**
**31.03.1989 US 331644**

(43) Date of publication of application:
**26.06.2002 Bulletin 2002/26**

(62) Document number(s) of the earlier application(s) in accordance with Art. 76 EPC:
**96114809.5 / 0 745 474**
**89303782.0 / 0 354 637**

(73) Proprietor: **3D SYSTEMS, INC.**
**Valencia, California 91355 (US)**

(72) Inventors:
- **Hull, Charles William**
  **Santa Clarita California 91387 (US)**
- **Spence, Stuart Thomas**
  **Sunland California 91040 (US)**
- **Albert, David J.**
  **Soquel California 95073 (US)**
- **Smalley, Dennis Rollette**
  **Newhall California 91321 (US)**
- **Harlow, Richard A.**
  **Marina del Rey, CA 90291 (US)**
- **Steinburgh, Philip**
  **Sunnyvale, CA 94088-3599 (US)**
- **Tarnoff, Harry L.**
  **Van Nuys, CA 91411 (US)**
- **Nguyen, Hop D.**
  **Quartz Hill California 93536 (US)**
- **Lewis, Charles William**
  **Sherman Oaks California 91403 (US)**
- **Vorgitch, Tom J.**
  **Simi Valley, CA 93063 (US)**
- **Remba, David Z.**
  **Valley Village California 91607 (US)**

(74) Representative: **Bluff, John William et al**
**Lloyd Wise**
**Commonwealth House,**
**1-19 New Oxford Street**
**London WC1A 1LW (GB)**

(56) References cited:
**EP-A- 0 250 121**
**US-A- 3 829 838**
**US-A- 4 575 330**
**US-A- 5 287 435**

- **TAKASHI NAKAI ET AL: "FABRICATION OF THREE-DIMENSIONAL OBJECTS USING LASER LITHOGRAPHY" SYSTEMS & COMPUTERS IN JAPAN, SCRIPTA TECHNICA JOURNALS. NEW YORK, US, vol. 20, no. 3, 1 March 1989 (1989-03-01), pages 58-66, XP000071510 ISSN: 0882-1666**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 217 438 B1

## Description

This invention relates to a method of forming a three-dimensional object. The selected pattern for each layer of transformable fluid medium is obtained by processing stored data defining a desired configuration of the object. The object is built of a succession of superposed laminae each of which is formed by solidifying a layer of a transformable fluid medium by selective application thereto of a prescribed stimulation the apparatus including a data processing means for generating from the stored data the pattern of stimulation applied to each fluid layer.

An object-forming technique of this kind has come to be known as "stereolithography". By use of this technique the object is built of a succession of superposed laminae. The stereolithography technique of this kind is described in U.S. patent 4 575 330 (Hull). The generation of layer-by-layer data may be generally referred to as "slicing". The stored data defining the desired object configuration can be derived from CAD/CAM data.

The present invention provides a method and apparatus for the ordering of vectors and skin regions in stereolithography.

Attached are the following appendices, which are all hereby fully incorporated into this disclosure as though set forth in full herein:

| | |
|---|---|
| Appendix A: | 3D Systems, Inc., SLA-1 Beta Site Stereolithography System Users Manual and Service Manual, November, 1987 |
| Appendix B: | 3D Systems, Inc., SLA-1 Software Manual, Beta Release, First Draft, October, 1987 |
| Appendix D: | 3D Systems, Inc., SLA-1, Training Manual, Revision 3.0, April 1988 |
| Appendix G: | "Slice" Flow Chart Implementing Style 1 |
| Appendix H: | "Slice" Flow Chart Implementing Style 2 |
| Appendix I: | Technical Papers, 3D Systems, Inc., Stereolithography CAD/CAM Interface Specification, December 1, 1987 |

This invention provides improvements in methods and apparatus for forming three-dimensional objects from a fluid medium and, more particularly, a stereolithography system involving the application of enhanced data manipulation and lithographic techniques to production of three-dimensional objects, whereby such objects can be formed more rapidly, reliably, accurately and economically. Specifically, this invention relates to the conversion of CAD/CAM data into stereolithographic data.

It is common practice in the production of plastic parts and the like to first design such a part and then painstakingly produce a prototype of the part, all involving considerable time, effort and expense. The design is then reviewed and, oftentimes, the laborious process is again and again repeated until the design has been optimized. After design optimitization, the next step is production. Most production plastic parts are injection molded. Since the design time and tooling costs are very high, plastic parts are usually only practical in high volume production. While other processes are available for the production of plastic parts, including direct machine work, vacuum-forming and direct forming, such methods are typically only cost effective for short run production, and the parts produced are usually inferior in quality to molded parts.

Very sophisticated techniques have been developed in the past for generating three-dimensional objects within a fluid medium which is selectively cured by beams of radiation brought to selective focus at prescribed intersection points within the three-dimensional volume of the fluid medium. Typical of such three-dimensional systems are those described in U.S. Pat. Nos. 4,041,476; 4,078,229; 4,238,840 and 4,288,861. All of these systems rely upon the buildup of synergistic energization at selected points deep within the fluid volume, to the exclusion of all other points in the fluid volume. Unfortunately, however, such three-dimensional forming systems face a number of problems with regard to resolution and exposure control. The loss of radiation intensity and image forming resolution of the focused spots as the intersections move deeper into the fluid medium create rather obvious complex control situations. Absorption, diffusion, dispersion and diffraction all contribute to the difficulties of working deep within the fluid medium on an economical and reliable basis. US 3,829,838 relates to a three-dimensional pattern generator capable of simultaneously operating a plurality of spots in a display medium.

In recent years, "stereolithography" systems, such as those described in U.S. Pat. No. 4,575,330 entitled "Apparatus For Production Of Three-Dimensional Objects By Stereolithography", have come into use. Basically, stereolithography is a method for automatically building complex plastic parts by successively printing cross-sections of photopolymer or the like (such as liquid plastic) on top of each other until all of the thin layers are joined together to form a whole part. With this technology, the parts are literally grown in a vat of liquid plastic. This method of fabrication is extremely powerful for quickly reducing design ideas to physical form and for making prototypes.

Photocurable polymers change from liquid to solid in the presence of light and their photospeed with ultraviolet light (UV) is fast enough to make them practical model building materials. The material that is not polymerized when a part is made is still usable and remains in the vat as successive parts are made. An ultraviolet laser generates a small intense spot of UV. This spot is moved across the liquid surface with a galvanometer mirror X-Y scanner. The scanner is driven by computer generated vectors or the like. Precise complex patterns can be rapidly produced with this technique.

The laser scanner, the photopolymer vat and the elevator, along with a controlling computer, combine together to form a stereolithography apparatus, referred to as an "SLA". An SLA is programmed to automatically make a plastic part by drawing one cross section at a time, and building it up layer by layer.

Stereolithography represents an unprecedented way to quickly make complex or simple parts without tooling. Since this technology depends on using a computer to generate its cross sectional patterns, there is a natural data link to CAD/CAM. However, such systems have encountered difficulties relating to structural stress, shrinkage, curl and other distortions, as well as resolution, speed, accuracy and difficulties in producing certain object shapes.

The following background discussion sets forth some of the history in the development of the system of the present invention, including problems encountered and solutions developed, in the course of providing an enhanced SLA incorporating the features of the invention.

The original stereolithography process approach to building parts was based on building walls that were one line width thick, a line width being the width of plastic formed after a single pass was made with a beam of ultraviolet light. This revealed two primary problems: 1) relatively weak structural strength, along with 2) layer to layer adhesion problems when making the transition from vertical to horizontal features. This technique was based on building parts using the Basic Programming Language to control the motion of a U.V. laser light beam.

Another approach to solving the transition problem was to build parts with a solid wall thickness based on completely solidifying the material between two surface boundaries. This procedure experienced problems with distortion of parts and with relatively long exposure times required. This procedure provided good structural strength and produced better results in connection with the transition from vertical to horizontal features.

Another approach was based on using inner and outer walls as boundaries for a section of an object, as all real objects have, but the area between these boundaries was not to be completely solidified, but rather criss-crossed by a grid structure known as cross-hatching. This technique provides good structural strength and resolved much of the transition problem. It also reduced the exposure time and distortion problem. However it now created a new potential problem in that, what had originally been a solid object, was now an object with walls but missing top and bottom surfaces.

The "hollowness" problem was then solved by filling in all horizontal sections with closely-spaced vectors thereby forming a top and bottom skin. This approach had all the advantages of the previous one, but still had problems of its own. As one made the transition from vertical to horizontal features, one would find holes in the part where the boundary lines of successive layers were offset by greater than one line width between layers. The original version of this approach also had skins that did not always fit as well as desired, but this was later solved by rounding the triangle boundaries to slicing layers. This rounding technique also solved another problem which could cause misdirected cross-hatching.

This problem of holes was approached by deciding to create skin fill in the offset region between layers when the triangles forming that portion of a layer had a slope less than a specified amount from the horizontal plane. This skin fill is known as near-horizontal or near-flat skin. This technique worked well for completing the creation of solid parts. A version of this technique also completed the work necessary for solving the transition problem. The same version of this technique that solved the transition problem also yielded the best vertical feature accuracy of objects.

There continues to be a long existing need in the design and production arts for the capability of rapidly and reliably moving from the design stage to the prototype stage and to ultimate production, particularly moving directly from the computer designs for such plastic parts to virtually immediate prototypes and the facility for large scale production on an economical and automatic basis. EP-A-0 250 121 (Scitex) discloses an object where desired configuration includes a hollow interior portion.

According to the present invention there is provided a method as defined in claim 1 and apparatus as defined in claim 15, which may achieve more rapid, reliable, accurate, economical and automatic means which would facilitate quickly moving from a design stage to the prototype stage and to production.

Particular embodiments of the invention are the subject of the dependent claims.

Briefly, and in general terms, the present invention provides a stereolithography system for generating a three-dimensional object by forming successive, adjacent, cross-sectional laminae of that object at the face of a fluid medium capable of altering its physical state in response to appropriate synergistic stimulation, information defining the object being specially processed to reduce stress, curl and distortion, and increase resolution, strength, accuracy, speed and economy of reproduction, even for rather difficult object shapes, the successive laminae being automatically integrated as they are formed to define the desired three-dimensional object.

Stereolithography harnesses the principles of computer generated graphics in combination with stereolithography, i.e., the application of lithographic techniques to the production of three-dimensional objects, to simultaneously execute computer aided design (CAD) and computer aided manufacturing (CAM) in producing three-dimensional objects directly from computer instructions. Stereolithography can be applied for the purposes of sculpturing models and prototypes in a design phase of product development, or as a manufacturing system, or even as a pure art form.

"Stereolithography" is a method and apparatus for making solid objects by successively "printing" thin layers of a curable material, e.g., a UV curable material, one on top of the other. A programmed movable spot beam of UV light shining on a surface or layer of UV curable liquid is used to form a solid cross-section of the object at the surface of the liquid. The object is then moved, in a programmed manner, away from the liquid surface by the thickness of one layer, and the next cross-section is then formed and adhered to the immediately preceding layer defining the object. This process is continued until the entire object is formed.

Essentially all types of object forms can be created with the technique of the present invention. Complex forms are more easily created by using the functions of a computer to help generate the programmed commands and to then send the program signals to the stereolithographic object forming subsystem.

Of course, it will be appreciated that other forms of appropriate synergistic stimulation for a curable fluid medium, such as particle bombardment (electron beams and the like), chemical reactions by spraying materials through a mask or by ink jets, or impinging radiation other than ultraviolet light, may be used in the practice of the invention without departing from the spirit and scope of the invention.

By way of example, in the practice of the present invention, a body of a fluid medium capable of solidification in response to prescribed stimulation is first appropriately contained in any suitable vessel to define a designated working surface of the fluid medium at which successive cross-sectional laminae can be generated. Thereafter, an appropriate form of synergistic stimulation, such as a spot of UV light or the like, is applied as a graphic pattern at the specified working surface of the fluid medium to form thin, solid, individual layers at the surface, each layer representing an adjacent cross-section of the three-dimensional object to be produced. In accordance with the invention, information defining the object is specially processed to reduce curl and distortion, and increase resolution, strength, accuracy, speed and economy of reproduction.

Superposition of successive adjacent layers on each other is automatically accomplished, as they are formed, to integrate the layers and define the desired three-dimensional object. In this regard, as the fluid medium cures and solid material forms as a thin lamina at the working surface, a suitable platform to which the first lamina is secured is moved away from the working surface in a programmed manner by any appropriate actuator, typically all under the control of a micro-computer of the like. In this way, the solid material that was initially formed at the working surface is moved away from that surface and new liquid flows into the working surface position. A portion of this new liquid is, in turn, converted to solid material by the programmed UV light spot to define a new lamina, and this new lamina adhesively connects to the material adjacent to it, i.e., the immediately preceding lamina. This process continues until the entire three-dimensional object has been formed. The formed object is then removed from the container and the apparatus is ready to produce another object, either identical to the first object or an entirely new object generated by a computer or the like.

The data base of a CAD system can take several forms. One form consists of representing the surface of an object as a mesh of polygons, typically triangles. These triangles completely form the inner and outer surfaces of the object. This CAD representation also includes a unit length normal vector for each triangle. The normal points away from the solid which the triangle is bounding and indicate slope. This invention provides a means of processing CAD data, which may be provided as "PHIGS" or the like, into layer-by-layer vector data that can be used for forming models through stereolithography. Such information may ultimately be converted to raster scan output data or the like, without in any way departing from the spirit and scope of the invention.

For stereolithography to successfully work, there must be good adhesion from one cross-sectional layer to the next. Hence, plastic from one layer must overlay plastic that was formed when the previous layer was built. In building models that are made of vertical segments, plastic that is formed on one layer will fall exactly on previously formed plastic from the preceding layer and, therefore, good adhesion is achieved. As one starts to make a transition from vertical to horizontal features using finite jumps in layer thickness, a point is eventually reached where the plastic formed on one layer does not make contact with the plastic formed on the previous layer, and this can result in severe adhesion problems. Horizontal surfaces themselves do not present adhesion problems since, by being horizontal, the whole section is built on one layer with side-to-side adhesion maintaining structural integrity. This.invention provides a general means of insuring adequate adhesion between layers when making transitions from vertical to horizontal or horizontal to vertical sections, as well as providing a means for completely bounding a surface and reducing stress and strain in formed objects.

As previously indicated, stereolithography is a three-dimensional printing process which uses a moving laser beam to build parts by solidifying successive layers of liquid plastic. This method enables a designer to create a design on a CAD system and build an accurate plastic model in a few hours. By way of example and not necessarily by way of limitation, a stereolithographic process in accordance with the invention may include the following steps.

First, the solid model is designed in the normal way on the CAD system, without specific reference to the stereolithographic process.

Model preparation for stereolithography involves selecting the optimum orientation, adding supports, and selecting the operating parameters of the stereolithography system. The optimum orientation will (1) enable the object to drain, (2) have the least number of unsupported surfaces, (3) optimize important surfaces, and (4) enable the object to fit in the resin vat. Supports must be added to secure unattached sections and for other purposes, and a CAD library of supports can be prepared for this purpose. The stereolithography operating parameters include selection of the model scale and layer (slice) thickness.

The surface of the solid model is then divided into triangles, typically "PHIGS". A triangle is the least complex polygon for vector calculations. The more triangles formed, the better the surface resolution and hence, the more accurate the formed object with respect to the CAD design.

Data points representing the triangle coordinates and normals thereto are then transmitted typically as PHIGS, to the stereolithographic system via appropriate network communication such as ETHERNET. The software of the stereolithographic system then slices the triangular sections horizontally (X-Y plane) at the selected layer thickness.

The stereolithographic unit (SLA) next calculates the section boundary, hatch, and horizontal surface (skin) vectors. Hatch vectors consist of cross-hatching between the boundary vectors. Several "styles" or slicing formats are available. Skin vectors, which are traced at high speed and with a large overlap, form the outside horizontal surfaces of the object. Interior horizontal areas, those within top and bottom skins, are not filled in other than by cross-hatch vectors.

The SLA then forms the object one horizontal layer at a time by moving the ultraviolet beam of a helium-cadmium laser or the like across the surface of a photocurable resin and solidifying the liquid where it strikes. Absorption in the resin prevents the laser light from penetrating deeply and allows a thin layer to be formed. Each layer is comprised of vectors which are typically drawn in the following order: border, hatch, and surface.

The first layer that is drawn by the SLA adheres to a horizontal platform located just below the liquid surface. This platform is attached to an elevator which then lowers the elevator under computer control. After drawing a layer, the platform dips a short distance, such as several millimeters into the liquid to coat the previous cured layer with fresh liquid, then rises up a smaller distance leaving a thin film of liquid from which the second layer will be formed. After a pause to allow the liquid surface to flatten out, the next layer is drawn. Since the resin has adhesive properties, the second layer becomes firmly attached to the first. This process is repeated until all the layers have been drawn and the entire three-dimensional object is formed. Normally, the bottom 0.25 inch (about 6.35mm) or so of the object is a support structure on which the desired part is built. Resin that has not been exposed to light remains in the vat to be used for the next part. There is very little waste of material.

Post processing typically involves draining the formed object to remove excess resin, ultraviolet or heat curing to complete polymerization, and removing supports. Additional processing, including sanding and assembly into working models, may also be performed.

Stereolithography has many advantages over currently used apparatus for producing plastic objects. The methods and apparatus of the present invention avoid the need of producing design layouts and drawings, and of producing tooling drawings and tooling. The designer can work directly with the computer and a stereolithographic device, and when he is satisfied with the design as displayed on the output screen of the computer, he can fabricate a part for direct examination. If the design has to be modified, it can be easily done through the computer, and then another part can be made to verify that the change was correct. If the design calls for several parts with interacting design parameters, the method of the invention becomes even more useful because of all of the part designs can be quickly changed and made again so that the total assembly can be made and examined, repeatedly if necessary. Moreover, the data manipulation techniques of the present invention enable production of objects with reduced stress, curl and distortion, and increased resolution, strength, accuracy, speed and economy of production, even for difficult and complex object shapes.

After the design is complete, part production can begin immediately, so that the weeks and months between design and production are avoided. Stereolithography is particularly useful for short run production because the need for tooling is eliminated and production set-up time is minimal. Likewise, design changes and custom parts are easily provided using the technique. Because of the ease of making parts, stereolithography can allow plastic parts to be used in many places where metal or other material parts are now used. Moreover, it allows plastic models of objects to be quickly and economically provided, prior to the decision to make more expensive metal or other material parts.

The present invention will now be described further within the context of a stelithographic system in conjunction with the accompanying drawings of illustrative embodiments.

FIG. 1 is a overall block diagram of a stereolithography system for the practice of the present invention;

FIGS. 2 and 3 are flow charts illustrating the basic concepts employed in practicing the method of stereolithography of the present invention;

FIG. 4 is a combined block diagram, schematic and elevational sectional view of a system suitable for practicing the invention;

FIG. 5 is an elevational sectional view of a second embodiment of a stereolithography system for the practice of the invention;

FIGS. 6 and 7 are exploded, perspective views of the major component groups in a suitable stereolithography system;

FIG. 8 is a block diagram of a suitable stereolithography system;

FIG. 9 is a perspective view of the laser and optical system in a stereolithography system which may utilize the present invention;

FIG. 10 is an overall block diagram of the software in a suitable stereolithography system;

FIGS. 11 and 12 are symbolic flowcharts of a suitable stereolithographic process;

FIGS. 13 and 14 illustrate a sample CAD designed object;

FIG. 15 shows typical slicing of a CAD object;

FIGS. 16, 17 and 18 show slice (layer) data forming the object;

FIG. 19a shows a faceted sketch of a solid cube;

FIG. 19b shows a faceted sketch of a hollow cube;

FIG. 19c shows a faceted sketch of a solid octagon shaped cylinder;

FIG. 20a shows a faceted CAD designed object in gridded space;

FIG. 20b shows a faceted CAD designed object after rounding of triangles - Scale 2 - Scale 4 - Scale 10;

FIG. 20c shows a faceted CAD designed object after rounding of triangles in which triangle overlap occurs;

FIG. 21a illustrates a faceted CAD designed object after rounding of triangles based on scale factor;

FIG. 21b shows a faceted CAD designed object after rounding of triangles in the vertical to slicing layers - layer thickness 20 mils;

FIG. 21c shows a faceted CAD designed object after rounding of triangles in the vertical to slicing layers - layer thickness 5 mils;

FIG. 22a shows a faceted CAD designed object to be sliced;

FIG. 22b shows a faceted CAD designed object sliced at 20 mil layers;

FIG. 22c illustrates a faceted CAD designed object sliced at variable layer thickness of 5 mil and 20 mil;

FIG. 23a shows a side view of the intersection of triangles with a layer and vectors that are created at this intersection;

FIG. 23b shows a side view of a faceted section of an object, the slicing layer, the offset, the vectors created, including a point vector;

FIG. 23c illustrates a side view of a CAD designed object with internal features (windows) after rounding has occurred;

FIG. 23d shows a side view of the same object after being built from obtaining boundary vectors at the slicing layer;

FIG. 23e is a side view of the same object after being built from obtaining boundary vectors at one bit above the slicing layer;

FIG. 24 is a top view of a cross-section of an object showing how hatch paths are determined;

FIG. 24a is a top view of an object filled by X hatch;

FIG. 24b is a top view of an object filled by Y hatch;

FIG. 24c is a top view of an object filled by 60/120 hatch;

FIG. 24d is a top view of a layer of an object completely filled in its solid regions;

FIG. 24e is a top view of a layer of an object properly filled in by cross-hatch (X & Y);

FIG. 24f is a top view of a layer of boundary vectors along with hatch vectors generated by a first algorithm (X & Y);

FIG. 24g is a top view of boundary vectors along with hatch vectors generated by a second algorithm (X & Y);

FIG. 24h is a top view of a layer of boundary vectors along with hatch vectors generated by still another algorithm (X & Y);

FIGS. 24i and 24j are top views of cross-sections of an object hatched using various MIAs;

FIG. 24k is a schematic boundary diagram;

FIG. 25a illustrates vertices of a flat triangle;

FIG. 25b shows a flat boundary derived from flat triangles;

FIG. 25c illustrates flat boundaries with pairs of duplicate vectors removed;

FIG. 25d shows a flat triangle with boundary vectors and two-dimensional normals;

FIG. 25e shows a flat triangle with vector list;

FIG. 25f is a top view of a flat skin surface and the triangles forming the surface;

FIG. 25g is a top view of the flat skin surface with duplicate pairs of vectors removed, along with one edge triangle flipping over, and how its normal points in the opposite direction to the other segment normals forming the boundary;

FIG. 25h is a top view of flat triangles forming a single double surface before flipping, after flipping, with segment normals, after cancellation of duplicate pairs, after splitting of vectors, and after loop determination (two);

FIGS. 26a and 26b are side views illustrating boundaries on two consecutive layers and the associated variables for determination of the MSA;

FIG. 26c shows a part requiring near-flat skin;

FIG. 26d shows near-flat triangles intersecting two layers and the first two boundary vectors being formed (three cases);

FIG. 26e is a top view of near-flat boundary vectors for a trapezoid and a triangle being completed;

FIG. 26f is a top view.of a trapezoid showing relationships between segment normals, boundaries, and inner and outer portions of the trapezoid;

FIG. 26g is a top view of near-flat skin triangle boundaries before removal of pairs of duplicate vectors;

FIG. 26h is a top view of a near-flat skin boundary after removal of duplicate vectors;

FIG. 27a is a top view of one order for drawing boundary vectors when they are not ordered;

FIG. 27b is a top view of an order of drawing boundary vectors after they have been ordered;

FIG. 27c is a top view of boundaries and hatch showing spacing so that the endpoint of one vector is closest to the beginning point of its neighboring vector;

FIG. 27d is a top view of boundaries and hatch showing an endpoint of a vector closer to a beginning point on a vector across a hollow instead of to its neighbor;

FIG. 27e is a top view of boundary and hatch showing an order of drawing of hatch;

FIG. 28a is a side view of a CAD designed object;

FIG. 28b is a side view of the same CAD designed object built using slicing STYLE 1 or 2, with the perimeter of the CAD object drawn around it;

FIG. 28c is a side view of the same CAD designed object built using slicing STYLE 3 or 4, with the perimeter of the CAD object drawn around it;

FIG. 29a is a side view of a CAD designed object showing slice layers and planes one bit above the layers where boundary vector will be obtained;

FIG. 29b is a side view of a CAD designed object showing boundary vectors;

FIG. 29c is a side view of a CAD designed object showing boundary vectors after they have been given a full cure;

FIG. 29d is a side view of a CAD designed object depicting flat skin boundaries after they have been moved to the layers on which they will be built;

FIG. 29e is a side view of a CAD designed object showing near flat skin frames at the locations where they were created;

FIG. 29f is a side view of a CAD designed object showing near flat skin boundaries after they have been given full cure;

FIG. 29g is a side view of a CAD designed object showing superposition of layer boundaries and near-flat boundaries after being cured;

FIGS. 29h and 29i are side views of a CAD designed object along with superposition of all vectors;

FIG. 30a is a side view of a CAD designed object showing positions of slice layers and planes one bit down for creation of layer boundary vectors;

FIG. 30b is a side view of a CAD designed object showing the layer boundary vectors at the positions where they were created;

FIG. 30c is a side view of a CAD designed object along with fully cured layer boundaries;

FIG. 30d is a side view of a CAD designed object along with near-flat skin boundaries;

FIG. 30e is a side view of a CAD designed object along with near-flat skin boundaries after being moved to the layers on which they will be built;

FIG. 30f is a side view of a CAD designed object along with near-flat skin boundaries being given a full cure and indicates where these boundaries overlap already cured layer boundaries;

FIG. 30g is a side view of a CAD designed object showing superposition of layer boundaries and near-flat skin boundaries;

FIG. 30h is a side view of a CAD designed object along with flat skin boundaries;

FIG. 30i is a side view of a CAD designed object along with flat skin boundaries being moved to the layers on which they will be built;

FIG. 30j is a side view of a CAD designed object showing superposition of all vectors, with down facing skins being drawn at the bottom of their layers;

FIG. 31a is a side view of a CAD designed object showing positions of slice layers and location of layer boundaries;

FIG. 31b is a side view of a CAD designed object with layer boundaries being given a full layer cure depth;

FIG. 31c is a side view of a CAD designed object showing positions where down-facing, near-flat boundaries are obtained;

FIG. 31d is a side view of a CAD designed object showing down-facing near-flat boundaries on which they will be built (up on layer);

FIG. 31e is a side view of a CAD designed object showing positions where up-facing, near-flat boundaries are obtained;

FIG. 31f is a side view of a CAD designed object showing up-facing near-flat boundaries after they are moved to the layers on which they will be built (down one layer);

FIG. 31g is a side view of a CAD designed object showing the positions where up-facing flat skin boundaries are obtained;

FIG. 31h is a side view of a CAD designed object showing up-facing flat boundaries after they are moved to the layers on which they will be built (down one layer);

FIG. 31i is a side view of a CAD designed object showing the positions where down-facing flat skin boundaries are obtained (built on same layer as obtained);

FIG. 31j is a side view of CAD designed object with all vectors superimposed and drawn to the proper cure depth;

FIG. 31k is a side view of a CAD designed object showing positions of slice layers and location of layer boundaries;

FIG. 31l is a side view of a CAD designed object with layer boundaries being given a full layer cure depth;

FIG. 31m is a side view of a CAD designed object showing positions where down-facing, near-flat boundaries are obtained;

FIG. 31n is a side view of a CAD designed object showing down-facing, near-flat boundaries after they are moved to the layers on which they will be built (up two layers);

FIG. 31o is a side view of a CAD designed object showing positions where up-facing near-flat boundaries are obtained;

FIG. 31p is a side view of a CAD designed object showing the positions where up-facing flat skin boundaries are obtained (built on the same layer derived);

FIG. 31q is a side view of a CAD designed object showing the positions where down-facing, flat skin boundaries are obtained;

FIG. 31r is a side view of a CAD designed object showing down-facing, flat boundaries after they are moved to the layers on which they will be built (up one layer);

FIG. 31s is a side view of CAD designed object with all vectors superimposed and drawn to the proper cure depth;

FIG. 31t are side views of straight but slanted beams showing that objects can be built with particular layer thickness but not with others;

FIG. 31u are side views of an object similar to that used in describing STYLES 3 and 4 but with a wider window and varying layer thicknesses;

FIGS. 32a and 32b are top views of the cross-section of a CAD designed object depicting desired boundaries and boundaries after curing;

FIG. 33 is a software architecture flowchart depicting in greater detail the overall data flow, data manipulation and data management in a stereolithography system incorporating the features of the invention;

FIGS. 34a, 34b and 34c are top views of vectors that can crossover if not handled properly;

FIGS. 34d through 34l are further schematic diagrams illustrating vector order;

FIGS. 35a and 35b are APL programs for such a model;

FIGS. 36a through 36m are graphs relevant to cure compensation; and

FIGS. 37a, 37b and 37c illustrate the mathematical basis and derivations for cure compensation.

FIG. 38 is a diagram showing the right hand rule relationship between border vectors and the triangle normal;

FIG. 39 is the format of the Object.STL file;

FIG. 40 is a diagram showing the difference between an interior cross-section and a top cross-section of an object;

FIG. 41 is a diagram showing the boundary, skin, and hatch vectors for an interior cross-section and a top cross-section of an object;

FIG. 42 illustrates an up-facing near-flat skin area and a down-facing flat skin area;

FIG. 43a illustrates the boundary and skin vectors for a flat down-facing skin area;

FIG. 43b illustrates the boundary and skin vectors for a near-flat up-facing skin area;

FIG. 44a illustrates the input parameters which can be keyed in at the SLICE user interface;

FIG. 44b illustrates the format of the Object.SLI file;

FIG. 45 illustrates the format of the Object.V file;

FIG. 46 illustrates a banjotop;

FIG. 47 illustrates a working curve;

FIG. 48 illustrates the relationship between radial mirror movement and linear movement along a flat surface;

FIG. 49 illustrates the overlapping of bullets;

FIG. 50a illustrates a screen format for the PREPARE program;

FIG. 50b illustrates the format of MATERIAL.MAT;

FIG. 50c is a report from PREPARE interpreting the contents of the Object.R file;

FIG. 50d illustrates the format of the Object.L file;

FIG. 51 illustrates the format of the BUILD.PRM file;

FIG. 52a illustrates an X-Y grid representing movement of the laser beam with no geometrical correction;
FIG. 52b illustrates the pincushion effect;
FIG. 53 illustrates a calibration plate;
FIG. 54a illustrates that correcting only vector endpoints will not solve the pincushion effect;
FIG. 54b illustrates breaking up and correcting the endpoints of microvectors;
FIG. 55 illustrates sweeping a laser beam past a pinhole;
FIG. 56 illustrates the pinholes used for drift calibration;
FIG. 57a illustrates a plot of a beam profile from the program BEAM;
FIG. 57b illustrates a plot of beam width in the X and Y directions from the program BEAM;
FIG. 58 is a flowchart of the SLICE STYLE algorithm;
FIG. 59a illustrates the difference between steep, near-flat, and flat triangles;
FIG. 59b illustrates the derivation of a layer boundary segment normal from the triangle normal of a steep triangle;
FIG. 60a illustrates two objects that are spaced from each other by a small amount on the order of 1 mil;
FIG. 60b illustrates the objects moving next to each other due to rounding error;
FIG. 60c illustrates the intersection of the slicing layer (and the X-Y plane 1 bit above the slicing layer) with two objects;
FIG. 60d illustrates the layer boundary vectors that result from the intersection shown in Fig. 60c;
FIG. 60e illustrates the layer boundary vectors after removal of the duplicate boundary vectors which are common to the two objects;
FIG. 61a illustrates the flipping of a triangle due to rounding error;
FIG. 61b illustrates the overlaying of the triangles after flipping;
FIG. 61c illustrates the overlapping layer boundary vectors that result from slicing at the overlapping areas illustrated in Fig. 61b;
FIG. 62a illustrates boundary vectors and their segment normals conforming to the left hand rule;
FIG. 62b illustrates the flipping of a triangle, and the resultant flipping of a segment normal;
FIG. 63a illustrates the "net summation" hatch vector generation algorithm;
FIG. 63b illustrates the performance of the "net summation" hatch generation algorithm in the case of flipping triangles;
FIG. 64a illustrates a flat up-facing triangle;
FIG. 64b illustrates the segment normals for the vector 5 spanning the triangle;
FIG. 64c illustrates the removal of duplicate vectors forming common sides to adjacent flat up-facing triangles;
FIG. 65a illustrates the flipping of a triangle;
FIG. 65b illustrates the segment normals after the flipping has occurred;
FIG. 66a illustrates the removal of duplicate boundary vectors and the flipping of segment normals;
FIG. 66b illustrates reversing the segment normals;
FIG. 67 illustrates the movement of flat up-facing skin from layer n+1 to layer n as per STYLE 1;
FIG. 68 illustrates the generation of a trapezoid from a near-flat down-facing triangle;
FIG. 69 illustrates the segment normals associated with the trapezoid;
FIG. 70 illustrates the placement of skin fill at the top or bottom of a layer;
FIG. 71 illustrates the generation of a trapezoid from a near-flat up-facing triangle;
FIG. 72 is a flowchart of the SLICE STYLE 2 algorithm;
FIG. 73 illustrates the difference in cure depth which results if over-curing by 6 mils to adhere to an adjacent layer;
FIG. 74a illustrates four slicing layers of an object, highlighting the FDB vectors;
FIG. 74b illustrates reversing segment normals for LB vectors to stop hatching in an area;
FIG. 75a illustrates that obtaining LB vectors 1 bit above the slicing layer means that FUB vectors will not duplicate LB vectors;
FIG. 75b illustrates the determination of the area required by STYLE 3;
FIG. 76a illustrates distortion at a sharp point caused by beam width compensation;
FIG. 76b illustrates a way of solving for the distortion;
FIG. 77a illustrates Type 2 distortion caused by beam width compensation;
FIG. 77b illustrates the apparent flipping of segment normals at the point of distortion illustrated in FIG. 77a;
FIG. 77c illustrates an aggravated form of the distortion illustrated in FIG. 77a;
FIG. 78a illustrates beam width compensation at a sharp vertex;
FIG. 78b illustrates the passage of the laser beam along the sharp vertex of FIG. 78a;
FIG. 78c illustrates Type 1 crossover of offset layer boundary vectors caused by beam width compensation;
FIG. 78d illustrates the passage of the laser beam along with the crossover layer boundary vectors of FIG. 78c;
FIG. 78e illustrates backing off the offsetting of the endpoints of certain layer boundary vectors to avoid the crossover of FIG. 78c;

FIG. 79 illustrates the false correction of a crossover;
FIG. 80a illustrates offsetting a first endpoint for beam width compensation at a sharp vertex;
FIG. 80b illustrates offsetting a second endpoint for beam width compensation at a sharp vertex;
FIG. 80c illustrates offsetting a third endpoint for beam width compensation, and the detection of a crossover;
FIG. 81a illustrates the crossed-over portion of the layer boundary vectors at a sharp vertex after beam width compensation;
FIG. 81b illustrates eliminating the crossed-over portion of FIG. 81a as a method of avoiding crossover;
FIG. 81c illustrates eliminating the crossed-over potion of FIG. 81a by replacing it with a single vector;
FIG. 82a illustrates offsetting a first endpoint for beam width compensation in a Type 2 situation;
FIG. 82b illustrates offsetting a second endpoint for beam width compensation in the example of FIG. 82a;
FIG. 82c illustrates offsetting a third endpoint for beam width compensation in the example of FIG. 82a;
FIG. 82d illustrates offsetting a fourth endpoint for beam width compensation in the example of FIG. 82a;
FIG. 82e illustrates offsetting a fifth endpoint for beam width compensation in the example of FIG. 82a and the deletion of a crossover;
FIG. 83a illustrates the crossed-over portions of the layer boundary vectors in the example of FIG. 82a;
FIG. 83b illustrates handling the crossover by eliminating the portion of the layer boundary vectors of FIG. 83a;
FIG. 83c illustrates the presence of crossover after beginning the offsetting of endpoints from a different endpoint than in Fig. 82a;
FIG. 83d illustrates backing up the endpoints to eliminate the crossover detected in FIG. 83c;
FIG. 84 illustrates a SLICE 3.20 STYLE 1 flowchart with beam width compensation added; and
FIG. 85 is a flowchart illustrating the beam width compensation substeps.

Referring now to the drawings, and particularly to Figure 1 thereof, there is shown a block diagram of an overall stereolithography system suitable for practicing the present invention. A CAD generator 2 and appropriate interface 3 provide a data description of the object to be formed, typically in PHIGS format, via network communication such as ETHERNET or the like to an interface computer 4 where the object data is manipulated to optimize the data and provide output vectors which reduce stress, curl and distortion, and increase resolution, strength, accuracy, speed and economy of reproduction, even for rather difficult and complex object shapes. The interface computer 4 generates layer data by slicing the CAD data, varying layer thickness, rounding polygon vertices, filling, generating flat skins, near-flat skins, up-facing and down-facing skins, scaling, cross-hatching, offsetting vectors and ordering vectors.

The vector data and parameters from the computer 4 are directed to a controller subsystem 5 for operating the system stereolithography laser, mirrors, elevator and the like.

FIGS. 2 and 3 are flow charts illustrating the basic system of the present invention for generating three-dimensional objects by means of stereolithography.

Many liquid state chemicals are known which can be induced to change to solid state polymer plastic by irradiation with ultraviolet light (UV) or other forms of synergistic stimulation such as electron beams, visible or invisible light, reactive chemicals applied by ink jet or via a suitable mask. UV curable chemicals are currently used as ink for high speed printing, in processes of coating or paper and other materials, as adhesives, and in other specialty areas.

Lithography is the art of reproducing graphic objects, using various techniques. Modern examples include photographic reproduction, xerography, and microlithography, as is used in the production of microelectronics. Computer generated graphics displayed on a plotter or a cathode ray tube are also forms of lithography, where the image is a picture of a computer coded object.

Computer aided design (CAD) and computer aided manufacturing (CAM) are techniques that apply the abilities of computers to the processes of designing and manufacturing. A typical example of CAD is in the area of electronic printed circuit design, where a computer and plotter draw the design of a printed circuit board, given the design parameters as computer data input. A typical example of CAM is a numerically controlled milling machine, where a computer and a milling machine produce metal parts, given the proper programming instructions. Both CAD and CAM are important and are rapidly growing technologies.

Stereolithography hamesses the principles of computer generated graphics, combined with UV curable plastic and the like, to simultaneously execute CAD and CAM, and to produce three-dimensional objects directly from computer instructions.

Stereolittiography, can be used to sculpture models and prototypes in a design phase of product development, or as a manufacturing device, or even as an art form. The present invention enhances the developments in stereolithography set forth in U.S. Patent No. 4,575,330, issued March 11, 1986, to Charles W. Hull, one of the inventors herein.

Referring now more specifically to Figure 2 of the drawing, the stereolithographic method is broadly outlined. Step 8 calls for generation of CAD or other data, typically in digital form, representing a three-dimensional object to be formed by the system. This CAD data usually defines surfaces in polygon format, triangles and normals perpendicular to the planes of those triangles, e.g., for slope indications, being presently preferred, and in a presently preferred embodiment of the invention conforms to the Programmer's Hierarchial Interactive Graphics System (PHIGS) now adapted as an ANSI standard. This standard is described, by way of example in the publication "Understanding PHIGS", published by Template, Megatek Corp., San Diego, California.

In Step 9, the PHIGS data or its equivalent is converted, in accordance with the invention, by a unique conversion system to a modified data base for driving the stereolithography output system in forming three-dimensional objects. In this regard, information defining the object is specially processed to reduce stress, curl and distortion, and increase resolution, strength and accuracy of reproduction.

Step 10 in Figure 2 calls for the generation of individual solid laminae representing cross-sections of a three-dimensional object to be formed. Step 11 combines the successively formed adjacent laminae to form the desired three-dimensional object which has been programmed into the system for selective curing.

Hence, stereolithography generates three-dimensional objects by creating a cross-sectional pattern of the object to be formed at a selected surface of a fluid medium, e.g., a UV curable liquid or the like, capable of altering its physical state in response to appropriate synergistic stimulation such as impinging radiation, electron beam or other particle bombardment, or applied chemicals (as by ink jet or spraying over a mask adjacent the fluid surface), successive adjacent laminae, representing corresponding successive adjacent cross-sections of the object, being automatically formed and integrated together to provide a step-wise laminar or thin layer buildup of the object, whereby a three-dimensional object is formed and drawn from a substantially planar or sheet-like surface of the fluid medium during the forming process.

The aforedescribed technique illustrated in Fig. 2 is more specifically outlined in the flowchart of Figure 3, where again Step 8 calls for generation of CAD or other data, typically in digital form, representing a three-dimensional object to be formed by the system. Again, in Step 9, the PHIGS data is converted by a unique conversion system to a modified data base for driving the stereolithography output system in forming three-dimensional objects. Step 12 calls for containing a fluid medium capable of solidification in response to prescribed reactive stimulation. Step 13 calls for application of that stimulation as a graphic pattern, in response to data output from the computer 4 in Fig. 1, at a designated fluid surface to form thin, solid, individual layers at that surface, each layer representing an adjacent cross-section of a three-dimensional object to be produced. In the practical application of the invention, each lamina will be a thin lamina, but thick enough to be adequately cohesive in forming the cross-section and adhering to the adjacent laminae defining other cross-sections of the object being formed.

Step 14 in Figure 3 calls for superimposing successive adjacent layers or laminae on each other as they are formed, to integrate the various layers and define the desired three-dimensional object. In the normal practice, as the fluid medium cures and solid material forms to define one lamina, that lamina is moved away from the working surface of the fluid medium and the next lamina is formed in the new liquid which replaces the previously formed lamina, so that each successive lamina is superimposed and integral with (by virtue of the natural adhesive properties of the cured fluid medium) all of the other cross-sectional laminae. Of course, as previously indicated, the present invention also deals with the problems posed in transitioning between vertical and horizontal features.

The process of producing such cross-sectional laminae is repeated over and over again until the entire three-dimensional object has been formed. The object is then removed and the system is ready to produce another object which may be identical to the previous object or may be an entirely new object formed by changing the program controlling the stereolithographic system.

FIGS. 4-5 of the drawings illustrate various apparatus suitable for implementing the stereolithographic methods illustrated and described by the systems and flow charts of FIGS. 1-3.

As previously indicated, "Stereolithography" is a method and apparatus for making solid objects by successively "printing" thin layers of a curable material, e.g., a UV curable material, one on top of the other. A programmable movable spot beam of UV light shining on a surface or layer of UV curable liquid is used to form a solid cross-section of the object at the surface of the liquid. The object is then moved, in a programmed manner, away from the liquid surface by the thickness of one layer and the next cross-section is then formed and adhered to the immediately preceding layer defining the object. This process is continued until the entire object is formed.

Essentially all types of object forms can be created with stereolithography. Complex forms are more easily created by using the functions of a computer to help generate the programmed commands and to then send the program signals to the stereolithographic object forming subsystem.

The data base of a CAD system can take several forms. One form, as previously indicated, consists of representing the surface of an object as a mesh of triangles (PHIGS). These triangles completely form the inner and outer surfaces of the object. This CAD representation also includes a unit length normal vector for each triangle. The normal points away from the solid which the triangle is bounding. This invention provides a means of processing such CAD data into the layer-by-layer vector data that is necessary for forming objects through stereolithography.

For stereolithography to successfully work, there must be good adhesion from one layer to the next. Hence, plastic from one layer must overlay plastic that was formed when the previous layer was built. In building models that are made of vertical segments, plastic that is formed on one layer will fall exactly on previously formed plastic from the preceding layer, and thereby provide good adhesion. As one starts to make a transition from vertical to horizontal features, using finite jumps in layer thickness, a point will eventually be reached where the plastic formed on one layer does not make contact with the plastic formed on the previous layer, and this causes severe adhesion problems. Horizontal surfaces themselves do not present adhesion problems because by being horizontal the whole section is built on one layer with side-to-side adhesion maintaining structural integrity. Stereolithography provides a general means of insuring adhesion between layers when making transitions from vertical to horizontal or horizontal to vertical sections, as well as providing a way to completely bound a surface, and ways to reduce or eliminate stress and strain in formed parts.

One stereolithographic system is shown in elevational cross-section in Figure 4. A container 21 is filled with a UV curable liquid 22 or the like, to provide a designated working surface 23. A programmable source of ultraviolet light 26 or the like produces a spot of ultraviolet light 27 in the plane of surface 23. The spot 27 is movable across the surface 23 by the motion of mirrors or other optical or mechanical elements (not shown in FIG. 4) used with the light source 26. The position of the spot 27 on surface 23 is controlled by a computer control system 28. As previously indicated, the system 28 may be under control of CAD data produced by a generator 20 in a CAD design system or the like and directed in PHIGS format or its equivalent to a computerized conversion system 25 where information defining the object is specially processed to reduce stress, curl and distortion, and increase resolution, strength and accuracy of reproduction.

A movable elevator platform 29 inside container 21 can be moved up and down selectively, the position of the platform being controlled by the system 28. As the device operates, it produces a three-dimensional object 30 by step-wise buildup of integrated laminae such as 30a, 30b, 30c.

The surface of the UV curable liquid 22 is maintained at a constant level in the container 21, and the spot of UV light 27, or other suitable form of reactive stimulation, of sufficient intensity to cure the liquid and convert it to a solid material is moved across the working surface 23 in a programmed manner. As the liquid 22 cures and solid material forms, the elevator platform 29 that was initially just below surface 23 is moved down from the surface in a programmed manner by any suitable actuator. In this way, the solid material that was initially formed is taken below surface 23 and new liquid 22 flows across the surface 23. A portion of this new liquid is, in turn, converted to solid material by the programmed UV light spot 27, and the new material adhesively connects to the material below it. This process is continued until the entire three-dimensional object 30 is formed. The object 30 is then removed from the container 21, and the apparatus is ready to produce another object. Another object can then be produced, or some new object can be made by changing the program in the computer 28.

The curable liquid 22, e.g., UV curable liquid, must have several important properties: (A) It must cure fast enough with the available UV light source to allow practical object formation times. (B) It must be adhesive, so that successive layers will adhere to each other. (C) Its viscosity must be low enough so that fresh liquid material will quickly flow across the surface when the elevator moves the object. (D) It should absorb UV so that the film formed will be reasonably thin. (E) It must be reasonably insoluble in that same solvent in the solid state, so that the object can be washed free of the UV cure liquid and partially cured liquid after the object has been formed. (F) It should be as non-toxic and nonirritating as possible.

The cured material must also have desirable properties once it is in the solid state. These properties depend on the application involved, as in the conventional use of other plastic materials. Such parameters as color, texture, strength, electrical properties, flammability, and flexibility are among the properties to be considered. In addition, the cost of the material will be important in many cases.

The UV curable material used in the presently preferred embodiment of a working stereolithograph (e.g., Figure 3) is DeSoto SLR 800 stereolithography resin, made by DeSoto, Inc. of Des Plains, Illinois.

The light source 26 produces the spot 27 of UV light small enough to allow the desired object detail to be formed, and intense enough to cure the UV curable liquid being used quickly enough to be practical. The source 26 is arranged so it can be programmed to be turned off and on, and to move, such that the focused spot 27 moves across the surface 23 of the liquid 22. Thus, as the spot 27 moves, it cures the liquid 22 into a solid, and "draws" a solid pattern on the surface in much the same way a chart recorder or plotter uses a pen to draw a pattern on paper.

The light source 26 is typically a helium-cadmium ultraviolet laser such as the Model 4240-N HeCd Multimode Laser, made by Liconix of Sunnyvale, California.

In the system of Figure 4, means may be provided to keep the surface 23 at a constant level and to replenish this material after an object has been removed, so that the focus spot 27 will remain sharply in focus on a fixed focus plane, thus insuring maximum resolution in forming a high layer along the working surface. In this regard, it is desired to shape the focal point to provide a region of high intensity right at the working surface 23, rapidly diverging to low intensity and thereby limiting the depth of the curing process to provide the thinnest appropriate cross-sectional laminae for the object being formed.

The elevator platform 29 is used to support and hold the object 30 being formed, and to move it up and down as required. Typically, after a layer is formed, the object 30 is moved beyond the level of the next layer to allow the liquid 22 to flow into the momentary void at surface 23 left where the solid was formed, and then it is moved back to the correct level for the next layer. The requirements for the elevator platform 29 are that it can be moved in a programmed fashion at appropriate speeds, with adequate precision, and that it is powerful enough to handle the weight of the object 30 being formed. In addition, a manual fine adjustment of the elevator platform position is useful during the set-up phase and when the object is being removed.

The elevator platform 29 can be mechanical, pneumatic, hydraulic, or electrical and may also be optical or electronic feedback to precisely control its position. The elevator platform 29 is typically fabricated of either glass or aluminum, but any material to which the cured plastic material will adhere is suitable.

A computer controlled pump (not shown) may be used to maintain a constant level of the liquid 22 at the working surface 23. Appropriate level detection system and feedback networks, well known in the art, can be used to drive a fluid pump or a liquid displacement device, such as a solid rod (not shown) which is moved out of the fluid medium as the elevator platform is moved further into the fluid medium, to offset changes in fluid volume and maintain constant fluid level at the surface 23. Alternatively, the source 26 can be moved relative to the sensed level 23 and automatically maintain sharp focus at the working surface 23. All of these alternatives can be readily achieved by appropriate data operating in conjunction with the computer control system 28.

As an overview, the portion of the processing referred to as "SLICE" takes in the object that is to be built, together with any scaffolding or supports that are necessary to make it more buildable. These supports are typically generated by the user's CAD. The first thing SLICE does is to find the outlines of the object and its supports.

SLICE defines each microsection or layer one at a time under certain specified controlling styles. SLICE produces a boundary to the solid portion of the object. If, for instance, the object is hollow, there will be an outside surface and an inside one. This outline then is the primary information. The SLICE program then takes that outline or series of outlines and, considering that the building of an outside skin and an inside skin won't join to one another, since there will be liquid between them and it will collapse, SLICE turns this into a real product, a real part by putting in cross-hatching between the surfaces, or solidifying everything in between or adding skins where it's so gentle a slope that one layer wouldn't join on top of the next, remembering past history or slope of the triangles (PHIGS). SLICE does all those things and other programs then use some lookup tables of the chemical characteristics of the photopolymer, how powerful the laser is, and related parameters to indicate how long to expose each of the output vectors used to operate the system. Those output vectors can be divided into identifiable groups. One group consists of the boundaries or outlines. Another group consists of cross-hatches. A third group consists of skins and there are subgroups of those, such as upward facing skins, and downward facing skins which have to be treated slightly differently. These subgroups are all tracked differently because they may get slightly different treatment; in the process, the output data is then appropriately managed to form the desired object and supports.

After the three-dimensional object 30 has been formed, the elevator platform 29 is raised and the object is removed from the platform for post processing.

In addition, there may be several containers 21 used in the practice of the invention, each container having a different type of curable material that can be automatically selected by the stereolithographic system. In this regard, the various materials might provide plastics of different colors, or have both insulating and conducting material available for the various layers of electronic products.

Referring now more particularly to the remaining drawings, in connection with various alternative embodiments of the invention, like reference numerals throughout the various figures of the drawings denote like or corresponding parts as those previously discussed in connection with the preferred embodiment of the invention shown in Figure 4.

As will be apparent from Figure 5 of the drawings, there is shown an alternate configuration of a stereolithograph wherein the UV curable liquid 22 or the like floats on a heavier UV transparent liquid 32 which is non-miscible and non-wetting with the curable liquid 22. By way of example, ethylene glycol or heavy water are suitable for the intermediate liquid layer 32. In the system of Figure 4, the three-dimensional object 30 is pulled up from the liquid 22, rather than down and further into the liquid medium, as shown in the system of Figure 3.

The UV light source 26 in Figure 5 focuses the spot 27 at the interface between the liquid 22 and the non-miscible intermediate liquid layer 32, the UV radiation passing through a suitable UV transparent window 33, of quartz or the like, supported at the bottom of the container 21. The curable liquid 22 is provided in a very thin layer over the non-miscible layer 32 and thereby has the advantage of limiting layer thickness directly rather than relying solely upon absorption and the like to limit the depth of curing since ideally an ultrathin lamina is to be provided. Hence, the region of formation will be more sharply defined and some surfaces will be formed smoother with the system of Figure 5 than with that of Figure 4. In addition a smaller volume of UV curable liquid 22 is required, and the substitution of one curable material for another is easier.

A commercial stereolithography system will have additional components and subsystems besides those previously shown in connection with the schematically depicted systems of FIGS. 1-5. For example, the commercial system would also have a frame and housing, and a control panel. It should have means to shield the operator from excess UV and visible light, and it may also have means to allow viewing of the object 30 while it is being formed. Commercial units will provide safety means for controlling ozone and noxious fumes, as well as conventional high voltage safety protection and interlocks. Such commercial units will also have means to effectively shield the sensitive electronics from electronic noise sources.

As previously mentioned, a number of other possible apparatus may be utilized to practice the stereolithographic method. For example, an electron source, a visible light source, or an x-ray source or other radiation source could be substituted for the UV light source 26, along with appropriate fluid media which are cured in response to these particular forms of reactive stimulation. For example, alphaoctadecylacrylic acid that has been slightly prepolymerized with UV light can be polymerized with an electron beam. Similarly, poly(2,3-dichloro-1-propyl acrylate) can be polymerized with an x-ray beam.

The commercialized SLA is a self-contained system that interfaces directly with the user's CAD system. The SLA, as shown in FIGS. 6 and 7, consists of four major component groups: the slice computer terminal, the electronic cabinet assembly, the optics assembly, and the chamber assembly. A block diagram of the SLA is shown in Figure 8.

The electronic cabinet assembly includes the process computer (disc drive), keyboard, monitor, power supplies, ac power distribution panel and control panel. The computer assembly includes plug-in circuit boards for control of the terminal, high-speed scanner mirrors, and vertical (Z-stage) elevator. Power supplies for the laser, dynamic mirrors, and elevator motor are mounted in the lower portion of the cabinet.

The control panel includes a power on switch/indicator, a chamber light switch/indicator, a laser on indicator, and a shutter open indicator.

Operation and maintenance parameters, including fault diagnostics and laser performance information, are also typically displayed on the monitor. Operation is controlled by keyboard entries. Work surfaces around the keyboard and disc drive are covered with formica or the like for easy cleaning and long wear.

The helium cadmium (HeCd) laser and optical components are mounted on top of the electronic cabinet and chamber assembly. The laser and optics plate may be accessed for service by removing separate covers. For safety reasons, a special tool is required to unlock the cover fasteners and interlock switches are activated when the covers are removed. The interlocks activate a solenoid-controlled shutter to block the laser beam when either cover is removed.

As shown in Figure 9, the shutter assembly, two ninety degree beam-turning mirrors, a beam expander, an X-Y scanning mirror assembly, and precision optical window are mounted on the optics plate. The rotary solenoid-actuated shutters are installed at the laser output and rotate to block the beam when a safety interlock is opened. The ninety degree beam-turning mirrors reflect the laser beam to the next optical component. The beam expander enlarges and focuses the laser beam on the liquid surface. The high speed scanning mirrors direct the laser beam to trace vectors on the resin surface. A quartz window between the optics enclosure and reaction chamber allows the laser beam to pass into the reaction chamber, but otherwise isolates the two regions.

The chamber assembly contains an environmentally-controlled chamber, which houses a platform, reaction vat, elevator, and beam profiler.

The chamber in which the object is formed is designed for operator safety and to ensure uniform operating conditions. The chamber may be heated to approximately 40° C (104° F) and the air is circulated and filtered. An overhead light illuminates the reaction vat and work surfaces. An interlock on the glass access door activates a shutter to block the laser beam when opened.

The reaction vat is designed to minimize handling of the resin. It is typically installed in the chamber on guides which align it with the elevator and platform.

The object is formed on a platform attached to the vertical axis elevator, or Z-stage. The platform is immersed in the resin vat and it is adjusted incrementally downward while the object is being formed. To remove the formed part, it is raised to a position above the vat. The platform is then disconnected from the elevator and removed from the chamber for post processing. Handling trays are usually provided to catch dripping resin.

The beam profilers are mounted at the sides of the reaction vat at the focal length of the laser. The scanning mirror is periodically commanded to direct the laser beam onto the beam profiler, which measures the beam intensity profile. The data may be displayed on the terminal, either as a profile with intensity contour lines or as a single number representing the overall (integrated) beam intensity. This information is used to determine whether the mirrors should be cleaned and aligned, whether the laser should be serviced, and what parameter values will yield vectors of the desired thickness and width.

A software diagram of the SLA is shown in Figure 10. There are three computers needed to control the stereolithographic apparatus, a CAD system, a SLICE computer, and a PROCESS computer. Any CAD system can be used to design a part in three-dimensional space. This is identified as the object file. In order to generate the part, supports must be added to prevent distortion..This is accomplished by adding the necessary supports to the CAD part design and creating a CAD support file. The resultant two or more CAD generated files are then physically inserted into the slice computer through ETHERNET.

The stereolithography apparatus builds the part one layer at a time starting with the bottom layer. The SLICE computer breaks down the CAD part into individual horizontal slices. The SLICE computer also calculates where hatch vectors will be created. This is done to achieve maximum strength as each layer is constructed. The SLICE computer may be a separate computer with its own keyboard and monitor. However, the SLICE computer may share a common keyboard and monitor with the PROCESS computer. The operator can vary the thickness of each slice and change other parameters of each slice with a User Interface program. The SLICE computer may use the XENIX or UNIX operating system and is connected to the SLA PROCESS computer by an ETHERNET network data bus or the like.

The sliced files are then transferred to the PROCESS computer through ETHERNET. The PROCESS computer merges the sliced object and support files into a layer control file and a vector file. The operator then inserts the necessary controls needed to drive the stereolithography apparatus in the layer control and a default parameter file. (The vector file is not usually edited.) The operator can strengthen a particular volume of the part by inserting rivets. This is accomplished by inserting the necessary parameters to a critical volume file prior to merging of the sliced files. The MERGE program integrates the object, support, and critical volume files and inserts the resultant data in the layer control file. The operator can edit the layer control file and change the default parameter file. The default parameter file contains the controls needed to operate the stereolithography apparatus to build the part. The PROCESS computer uses the MSDOS operating system and is directly connected to the stereolithography apparatus.

The stereolithographic process is broadly illustrated by the symbolic flowcharts of FIGS. 11 and 12.

Stereolithography is a three-dimensional printing process which uses a moving laser beam to build parts by solidifying successive layers of liquid plastic. This method enables a designer to create a design on a CAD system and build an accurate plastic model in a few hours. The stereolithographic process may comprise of the following steps.

First, the solid model is designed in the normal way on the CAD system, without specific reference to the stereolithographic process.

Model preparation for stereolithography involves selecting the optimum orientation, adding supports, and selecting the operating parameters of the stereolithography system. The optimum orientation will (1) enable the object to drain, (2) have the least number of unsupported surfaces, (3) optimize important surfaces, and (4) enable the object to fit in the resin vat. Supports must be added to secure unattached sections and for other purposes; a CAD library of supports can be prepared for this purpose. The stereolithography operating parameters include selection of the model scale and layer (slice) thickness.

The surface of the solid model is then divided into triangles, typically "PHIGS". A triangle is the least complex polygon for vector calculations. The more triangles formed, the better the surface resolution and hence the more accurate the formed object with respect to the CAD design

Data points representing the triangle coordinates are then transmitted to the stereolithographic system via appropriate network communications. The software of the stereolithographic system then slices the triangular sections horizontally (X-Y plane) at the selected layer thickness.

The stereolithographic unit (SLA) next calculates the section boundary, hatch, and horizontal surface (skin) vectors. Hatch vectors consist of cross-hatching between the boundary vectors. Several slicing styles are available. Skin vectors, which are traced at high speed and with a large overlap, form the outside horizontal surfaces of the object. Interior horizontal areas, those within top and bottom skins, are not filled in other than by cross-hatch vectors.

The SLA then forms the object one horizontal layer at a time by moving the ultraviolet beam of a helium-cadmium laser across the surface of a photocurable resin and solidifying the liquid where it strikes. Absorption in the resin prevents the laser light from penetrating deeply and allows a thin layer to be formed. Each layer is comprised of vectors which are drawn in he following order: border, hatch, and surface.

The first layer that is drawn by the SLA adheres to a horizontal platform located just below the liquid surface. This platform is attached to an elevator which then lowers its vertically under computer control. After drawing a layer, the platform dips several millimeters into the liquid to coat the previous cured layer with fresh liquid, then rises up a smaller distance leaving a thin film of liquid from which the second layer will be formed. After a pause to allow the liquid surface to flatten out, the next layer is drawn. Since the resin has adhesive properties, the second layer becomes firmly attached to the first. This process is repeated until all the layers have been drawn and the entire three-dimensional object is formed. Normally, the bottom 0.25 inch or so of the object is a support structure on which the desired part is built. Resin that has not been exposed to light remains in the vat to be used for the next part. There is very little waste of material.

Post processing involves draining the formed object to remove excess resin, ultraviolet or heat curing to complete polymerization, and removing supports. Additional processing, including sanding and assembly into working models, may also be performed.

The stereolithographic method and apparatus has many advantages over currently used methods for producing plastic objects. The method avoids the need of producing design layouts and drawings, and of producing tooling drawings and tooling. The designer can work directly with the computer and a stereolithographic device, and when he is satisfied with the design as displayed on the output screen of the computer, he can fabricate a part for direct examination. If the design has to be modified, it can be easily done through the computer, and then another part can be made to verify that the change was correct. If the design calls for several parts with interacting design parameters, the method becomes even more useful because all of the part designs can be quickly changed and made again so that the total assembly can be made and examined, repeatedly if necessary.

After the design is complete, part production can begin immediately, so that the weeks and months between design and production are avoided. Ultimate production rates and parts costs should be similar to current injection molding costs for short run production, with even lower labor costs than those associated with injection molding. Injection molding is economical only when large numbers of identical parts are required. Stereolithography is useful for short run production because the need for tooling is eliminated and production set-up time is minimal. Likewise, design changes and custom parts are easily provided using the technique. Because of the ease of making parts, stereolithography can allow plastic parts to be used in many places where metal or other material parts are now used. Moreover, it allows plastic models of objects to be quickly and economically provided, prior to the decision to make more expensive metal or other material parts.

Stereolithography embodies the concept of taking three-dimensional computer data describing an object and creating a three-dimensional plastic replica of the object. Construction of an object is based on converting the three-dimensional computer data into two-dimensional data representing horizontal layers and building the object layer by layer. The software that takes us from the three-dimensional data defining the object to vector data is called "SLICE". FIGS. 13 and 14 illustrate a sample CAD designed object. Figure 15 shows typical slicing of CAD object. FIGS. 16, 17 and 18 show slice (layer) data forming the object.

CAD data files are referred to as STL files. These STL files divide the surface area of an object into triangular facets. The simpler the object the fewer the triangles needed to describe it, and the more complex the object or the more accuracy used to represent its curvatures the more triangles required to describe it. These triangles encompass both inner and outer surfaces.

In this representation all triangles are required to have their vertices intersect the vertices of other triangles; therefore, no triangle may have a vertex coincide with the edge (between vertices) of another. This insures that when triangle vertices are rounded (at a later stage) that no holes in the surface (represented by the triangles) are inadvertently created.

Figure 33 is a software architecture flowchart depicting in greater detail the overall data flow, data manipulation and data management in a stereolithography system incorporating the features of the invention;

In the CAD data file, triangles are represented by four sets of three numbers each. Each of the first three sets of numbers represents a vertex of the triangle in three-dimensional space. The fourth set represents the coordinates of the normal vector perpendicular to the plane of the triangle. This normal is considered to start at the origin and point to the coordinates specified in the STL file. By convention this normal vector is also of unit length (i.e., one CAD unit). The normal vector can point in either of two directions, but by convention, the direction we have chosen points from solid to hollow (away from the solid interior of the object that the triangle is bounding). Also associated with each triangle is an attribute designation.

Figure 19a shows a faceted sketch of a solid cube. Figure 19b shows a faceted sketch of a hollow cube. Figure 19c shows a faceted sketch of a solid octagon shaped cylinder.

Scaling of an STL file involves a consideration of SLICE, the slicing program that converts the three-dimensional data into two-dimensional vectors, which is based on processing integers. The CAD units in which an object is dimensioned, and therefore the STL file, are arbitrary. A scale factor is used to divide the CAD units into bits (1 bit is approximately .3 mil), so that slicing can be done based on bits instead of on the units of design. This provides the ability to maximize the resolution with which an object will be built regardless of what the original design units were. For example, a part designed in inches has the maximum resolution of one inch but if it is multiplied by a scale factor of 1000 or maybe 10000 the resolution is increased to 0.001 inches (mils) or to 0.0001 inches (1/10th of a mil) (1 inch = 25.4 mm).

All vertices of triangles are rounded to the nearest bit in all three dimensions; therefore, the object's dimensions are quantized. This means a part designed in inches with a scale factor of 1000 will have its triangle vertices rounded to the nearest mil.

If there are triangles surfacing the object that collapse to a single point or a line because their dimensions and orientation are such that the vertices are not resolved as individual bits, they are ignored in subsequent processing. Collapsed triangles can not produce discontinuities (i.e. holes) in the triangle faceted surface of the object, and they do not cause overlapping of any triangles that are distorted when filling in the area of a collapsed triangle. Rounding of triangle vertices which does not produce collapsed triangles cannot produce discontinuities (holes) in the surface of the object, but can cause overlapping of sections of triangles and can cause triangle normals to change their directions to new quadrants (up to 180 degree changes in direction). This does not necessarily cause a problem, but does need to be considered in later processing, in particular when creating boundary and cross-hatch vectors. Overlapping of triangles can also occur if wall thickness or hollows are thinner than 1 bit. These problems can be prevented by either using an arbitrarily small bit size or by requiring that all triangles exceed certain minimum dimensions.

Figure 20a shows a faceted CAD designed object in gridded space (two-dimensional). Figure 20b shows a faceted CAD designed object after rounding of triangles - Scale 1 - Scale 4 - Scale 10. Figure 20c shows a faceted CAD designed object after rounding of triangles in which triangle overlap occurs.

There is a second rounding of triangle vertices which occurs, involving rounding the triangle vertices in the vertical direction to the nearest slicing layer. This rounding process causes a vertical distortion in the part and may cause the collapse or expansion of small features. This may not necessarily be serious since the maximum resolution in the vertical dimensions is one layer thickness. Regions containing critical features can be sliced into thinner layers to minimize distortion.

Rounding of triangle vertices provides several advantages over allowing them to remain at the locations that they were originally at in the STL file. If vertices are rounded then all horizontal triangles are moved to slicing layers. Thus, when flat skin is created .(derived from horizontal triangles) the skin will have excellent fit within the boundaries at a particular layer. In addition, the cross-hatching between the walls of objects will have more accurate placement. Cross hatching is based on hatch paths intersecting boundaries and then determining whether to turn hatching on and off. If a hatch path should strike a vertex point it would be difficult to make an accurate decision whether to turn hatch on or off. By rounding vertices, SLICE knows exactly where they are (in the vertical dimension) and can therefore avoid them when creating boundaries (which are used in the process of generating hatch).

Rounding of vertices to slicing layers is more likely to cause overlap of triangles than is rounding to the nearest scale bit. In addition, certain slicing styles require creating vectors 1 bit off the slicing layers so that the part comes out with the best vertical dimension. These styles are discussed in more detail farther on in this application. Unlike the rounding due to slicing scale, the problems associated with rounding of vertices to slicing layers cannot be solved by using arbitrarily small slicing layers or by limiting the minimum size of triangles. One possible way of minimizing the problem is to put a limit on the maximum dimension of triangles to slightly over one layer thickness. This could be used to reduce the number of overlapping surfaces. The proposed hatching algorithm will enable the handling of regions of overlapping triangles in a consistent and reliable manner.

Figure 21a illustrates a faceted CAD designed object after rounding of triangles based on scale factor. Figure 21b shows a faceted CAD designed object after rounding of triangles in the vertical to slicing layers - layer thickness 20 mils. Figure 21c shows a faceted CAD designed object after rounding of triangles in the vertical to slicing layers - layer thickness 5 mils.

When an object is sliced into layers, the vertical distance between layers can be varied depending on the vertical resolution needed in different areas. The selection of layer thickness is based on three distinct considerations: 1) desired resolution, 2) structural strength required of the layer, and 3) time allowed for building the object. Each of these factors is affected by layer thickness.

Item 1, resolution, is the most obvious item that is affected. The resolution of vertical features is inversely proportional to layer thickness. Item 2, structural strength, is proportional to cure thickness, and cure thickness is generally based on layer thickness plus a constant or a percentage of layer thickness.

As layers get thinner, a problem with structural strength of layers may develop even though layer-to-layer adhesion is satisfactory. An approach to solving this strength problem is based on giving layers more cure depth than required for good adhesion. This works well in many cases, but a few cases still exist, where these thicker cure depths may cause undesired structural differences between the part as designed and the part as actually built.

Another way of minimizing this problem is to design parts as separate objects that can be sliced separately using different layer thicknesses. So item 2 is sometimes a problem with regard to decreasing layer thickness but not necessarily.

Item 3 may or may not represent a problem when layer thickness is decreased. The time required to build a given part is based on three tasks: laser scanning time, liquid settling time, and number of layers per given thickness. As the layer thickness decreases, the liquid settling time increases, number of layers per unit thickness increases, and the drawing time decreases. On the other hand, with increasing layer thickness, the settling time decreases, number of layers per unit thickness decreases, and the drawing time increases.

These three tasks balance each other to give long part building times for thick layers, long part building times for thin layers, and shorter part building time for intermediate layer thickness.

Figure 22a shows a faceted CAD designed object to be sliced. Figure 22b shows a faceted CAD designed object sliced at 20 mil layers. Figure 22c illustrates a faceted CAD designed object sliced at variable layer thickness of 5 mil and 20 mil.

There are several types of boundaries that can be used to form the edges of layers and features when building parts. These boundaries include the layer boundary, down facing flat skin boundary, up facing flat skin boundary, down facing near-flat skin boundary, and up facing near-flat skin boundary. At this point in the description of the invention, we will concern ourselves with only the creation of layer boundaries, leaving the other boundary types for subsequent discussion.

Triangles are categorized into three main groups after they are rounded to both scale bits and to layers: scan triangles, near-flat triangles, and flat triangles. Flat triangles are those which have all three vertices all lying on the same layer. Near-flat triangles are those having normal vectors within some minimum angle from the vertical. All remaining triangles are scan triangles, i.e., those having normals outside the minimum angle from the vertical.

Layer boundaries are created at the line of intersection of scan and near-flat triangles with a horizontal plane intersecting the object at a vertical level slightly offset from the slicing layer. Each scan and near-flat triangle that is present at this slight vertical offset from a given layer will be used to create one vector that will form part of the layer boundary. Each triangle will have two points that cross a given layer and one of these points will be used as a starting point for a vector and the other point will be used as the ending point of the vector. Since triangles form complete surfaces around the object to be formed, both inside and outside, there will be vectors formed that will make a complete boundary around the layer.

After creation of layer boundary vectors, all degenerate vectors should be removed. These point vectors were not created from intersecting triangle vertices, since vertices are right on the slicing layer. But these point vectors can be created from triangles that are relatively narrow at the vertical level at which the vectors were derived, so narrow that the beginning and endpoints of the vector rounded to the same point. It should be noted that in some circumstances, vectors can overlap at more than their endpoints. This may present problems in later processing if not handled properly.

Figure 23a shows a side view of the intersection of triangles with a layer, and vectors that are created at this intersection. Figure 23b shows a side view of a faceted section of an object, the slicing layer, the offset, and the vectors created including a point vector.

It may seem that boundary vectors should be created right at the intersection of the triangles with the slicing layer but this creates several problems that can be readily solved by creating the boundary vectors from the intersection of triangles with a horizontal plane that is just slightly above or below the slicing layer. This concept of creating boundary vectors which are slightly offset from the slicing layer introduces some minor problems but they an be made negligible by making the offset arbitrarily small. A preferred offset is one scale bit off the actual layer level. For discussion's sake, an offset one bit above the slicing layer will be considered by way of example (STYLE 1). The table below is illustrative.

| | |
|---|---|
| Part design units | inches (1 inch = 25.4 mm) |
| Slice scale factor | 1000 |
| Layer spacing | 20 |
| Vertical location of part in CAD space | 1.000 to 1.100 inches |
| Location of layers in scaled units | 1000, 1020, 1040, 1060, 1080, 1100 |
| Locations of intersecting plane for determining boundary vectors in scaled units | 1001, 1021, 1041, 1061, 1081, 1101 |
| Layer designations associated with boundary vectors: | 1000, 1020, 1040 1060, 1080 |

Note: The original object was 100 mils tall. If SLICE would have obtained boundary vectors right at the slicing layer, it would have had six layers (to be built at 20 mils each) forming a 120 mil object, but since it sliced 1 bit above the slicing layer, it ends up with only five layers (to be built at 20 mils each) forming a 100 mil object.

The vertical offset for obtaining boundary vectors creates one potential problem: If the part has a near horizontal boundary at a particular layer then if SLICE obtains the boundary vectors from one bit above the layer, they may be considerably different from the vectors that would have been formed if the boundaries were obtained from the exact slicing level. This problem can be minimized by making the one bit offset extremely small compared to the part dimensions. This is why the one bit offset is preferred.

The offset described above avoids several potential difficulties: The first is that the object's vertical dimensions would be otherwise distorted. These distortions can take several forms: the overall height of the part would be one layer too tall, the bottom of all vertical openings would be placed one layer too high relative to the bottom of the part, and all these openings would be one layer shorter than desired. All of these distortions can be summarized by stating that all up facing features will be one layer too high relative to all down facing features.

The second problem deals with misplaced cross-hatch vectors (generated using one of SLICE's hatching algorithms). This is manifested in two ways: one is lack of consistency in generating cross-hatch for supporting up facing flat skin, the second way is the drawing of stray cross-hatch vectors running through hollow places within the object and/or cross-hatching missing from within the walls of the object.

Figure 23c illustrates a side view of a CAD designed object with internal features (windows) after rounding has occurred. Figure 23d shows a side view of the same object after being built from obtaining boundary vectors at the slicing layer. Figure 23e is a side view of the same object after being built from obtaining boundary vectors at one bit above the slicing layer.

Two data manipulation process algorithms for generation of cross-hatch have proven particularly useful in the practice of the present invention. The first algorithm is based on an on-off switching of cross-hatch as layer border vectors are encountered. The second algorithm is based on knowing where the solid portion of the object is and, therefore, where cross-hatching should be placed based on the direction that normal vectors point.

At this point, three types of cross-hatch will be defined along with two options of implementing them. The types of hatch are 1) hatch that runs parallel to the X-axis, 2) hatch that runs parallel to the Y-axis, and 3) hatch that runs at 60 degrees and 120 degrees to the X-axis.

Given a slice scale factor, the spacing between the hatch vectors is based on the number of bits specified in a slice command line for the parameters -Hx, -Hy, -Ha,-MIA, which parameters are defined below:

Spacing between hatch vectors that run parallel to the "X" axis - option = -Hx (number).

Spacing between hatch vectors that run parallel to the "Y" axis - option = -Hy (number).

Spacing between hatch vectors that run parallel to lines 60 degrees to the "X" axis, and vectors that run parallel to lines 120 degrees to the "X" axis - option = -Ha (number).

Allowed minimum intersect angle between cross-hatch and any boundary vectors that it would contact - option = -MIA (number).

The methods of implementing the hatch vectors are 1) implement all generated hatch or 2) implement only those hatch vectors that intersect both boundaries at angles greater than that specified with the slice command - MIA. Using the MIA option allows one to generate near-radial (nearly perpendicular to the boundaries) cross-hatch which can be an advantage in the case of objects that are prone to curl.

The locations of hatch paths are fixed in scaled CAD space. For this to be true, one hatch path for each orientation must be fixed with the other hatch paths being separated from the first by the number of bits specified in the "H" options. These fixed hatch paths are the paths parallel to the hatch directions that goes through the origin. This implies that all hatch vectors lay over hatch paths from previous layers; therefore, it does not matter where a part is designed in CAD space, hatch will be built above hatch. This is especially important for near-radial cross-hatch. By definition, near-radial cross-hatch is lacking a considerable amount of perpendicular hatch that could otherwise be used as support for hatch on upper layers.

The aforedescribed process works well, but may encounter difficulty in deciding where to put hatching when the hatch path intersects a boundary at the junction of two vectors. This problem manifests itself by sometimes not hatching in areas where it should (causing weakening of the part) and by sometimes hatching in areas of hollow where there should be none (known as stray vectors). In order to minimize the misplacement of hatch, a possible feature to add to the algorithm would allow only the drawing of hatch when an even number of boundary intersection points are encountered on a hatching path, whereas now, the algorithm just ignores the last intersection point if it is odd (so that hatch will not turn on and run until it runs out of space). Another feature added to the algorithm to minimize misplacement or non-placement of hatch vectors involves a determination of the slope (in the XY plane) of each of the boundary vectors that was used in the determination of an intersection point. If an intersection point is listed more than once, the slopes associated with it are used to determine how to interpret the point. If a point is derived from two vectors with the same sign (+ or -) of slope, the point is considered a boundary. If the slopes have the opposite sign the point is ignored.

The second process is based on using the normal vectors which are supplied with each triangle in the STL file. When layer borders are created, each vector created is derived from a triangle that intersects a horizontal plane one bit above the slicing layer.

Each boundary vector is stored as a beginning point (x,y) and an ending point (x,y) and associated with each vector are six attributes. These attributes describe the orientation of the normal vector that is associated with the triangle from which the vector was obtained. These six attributes are 1) did the normal point along the positive x axis? (true or false), 2) did the normal point along the -x axis?, 3) did the normal vector point along the +y axis?, 4) did the normal vector point along the -y axis?, 5) did the normal vector point along the +z axis?, 6) did the normal vector point along the -z axis. When SLICE determines where to place hatch vectors, SLICE still uses the intersection of a hatch path with boundary vectors to trigger a need to make a decision, but SLICE now bases whether or not to turn on or off the hatching based on whether the normals indicate SLICE is going into or out of solid. What actually happens is that SLICE determines the point at which each boundary vector intersects the hatching line, and puts this point in a list along with its normal information. This is done with each boundary vector for each hatch path. Each point is evaluated as to whether it indicates that hatch should be turned on or off or continued in the same state. The present utilization of this algorithm is based on original normals supplied by the STL file and not on normals recalculated after rounding of triangles to scale bits and slicing layers has occurred.

Of course, during rounding, some triangle normals may change quadrants even to the extreme of flipping 180 degrees. Therefore, an improved algorithm will involve a recalculation of normals after rounding. Actually, cross-hatch uses only the X and Y components of the normal, so for the sake of proper placement of cross-hatch, SLICE need only recalculate the horizontal components, and not the vertical components of the normal vectors. Recalculation of the vertical components must be based on how the recalculation will affect the vector types that use it. Also the present algorithm involves turning on the hatch if a boundary is intersected that contains a normal indicating that the hatching line is intersecting solid, whether or not other normals at the same point indicate that one is entering hollow. After hatching is on, it stays on until a boundary point is intersected that contains only normals that indicate the entering of hollow. So the present algorithm favors hatch staying on when a boundary that contains conflicting information is intersected. This algorithm can be improved by the recalculation of normal vectors after rounding, as mentioned earlier, and by taking the algebraic sum of the signs of the directions indicated by the normals when a point is listed more than once. If the sum is less than zero, the hatching turns on or continues on; if the sum is greater than zero the hatching turns off or continues off; and if the sum is zero the hatching continues on the same state whether on or off. It must be remembered that evaluation of points for hatching occurs starting with the smallest point and working toward the larger points along a given hatch path.

The second algorithm, as well as its proposed alternative, can cause the misplacement or non-placement of hatch vectors if separate objects that overlap in space are combined in the same STL file. Since these situations represent physically impossible objects, the CAD designer should be able to avoid them when creating STL files. If, for design convenience, an overlapping of objects would be convenient, the objects should be placed into separate STL files and sliced separately. The present as well as the proposed algorithm can cause the misplacement of vectors if dimensions of features or hollows in CAD space cause them to collapse in some manner (due to chosen scale or layer thickness), thereby forming a double skin in some regions of an object. The formation of misplaced hatch vectors has a different source for these two algorithms.

The present algorithm can misplace hatch the entire distance along the collapsed region except at the starting and ending points of boundary vectors. At these points, it will make the right decision some of the time. However, the alternative algorithm will make the proper decision at every point along the collapsed region except at the starting and ending points of boundary vectors. At these points, it will make the right decision a portion of the time. Therefore, it is not advisable to design parts that have regions where a collapse can occur, but if this is not possible, the alternative algorithm will at least reduce the likelihood of stray vectors (from the above mentioned source). The present algorithm can misplace hatch vectors when a hatch line intersects a boundary at a junction point where two or more boundary vectors meet. However, the improved algorithm will not misplace vectors in this situation.

All three algorithms implement cross-hatch along the X-axis only. To derive hatch parallel to the Y-axis the part is rotated 90°, hatched along the new X-axis and then rotated back. To derive 60 and 120° hatch, the object is rotated 60 and 120°, respectively, hatched along the new X-axis, then rotated back into place.

Figure 24 is a top view of a cross-section of an object showing how hatch paths are determined. Figure 24a is a top view of an object filled by X hatch. Figure 24b is a top view of an object filled by Y hatch. Figure 24c is a top view of an object filled by 60/120 hatch. Figure 24d is a top view of a layer of an object completely filled in its solid regions.

Figure 24e is a top view of a layer of an object properly filled in by cross-hatch (X & Y). Figure 24f is a top view of a layer of boundary vectors along with hatch vectors generated by the first algorithm (X & Y). Figure 24g is a top view of boundary vectors along with hatch vectors generated by the second algorithm (X & Y). Figure 24h is a top view of a layer of boundary vectors along with hatch vectors generated by the proposed algorithm (X & Y). FIGS. 24i and 24j are top views of cross-sections of an object hatched using various MIAs. FIGS. 24k is a schematic boundary diagram.

It is also possible to use a special normal vector to indicate that a boundary should not be considered when determining cross-hatch. This might be a normal vector of zero length (0,0,0). This normal would indicate that a particular triangle has no preferred orientation with regard to one side bounding solid and the other bounding empty space. This could be useful in building many objects, but certain problems must be considered in deciding how and when to implement it. Problems to be considered include: 1) how to specify in CAD or otherwise which triangles are regular and which are not, 2) how to insure triangles that form closed loops are of one type only, 3) how would tangent following be implemented (vector offsetting to account for line width a/k/a beam width compensation, discussed in more detail later), 4) would hatch associated with near-flat and flat boundaries still be used, etc.

Flat skin is generated from completely horizontal triangles. A horizontal triangle is one which has all three vertices at the same layer. Rounding of triangle vertices may produce flat triangles from triangles that were not originally horizontal. The first step in forming flat skins is to separate them into two groups, one consisting of up-facing triangles (up-pointing normals) and the other consisting of down-facing triangles. The triangles in each group are then ordered according to the layers which they belong to. Next, the edges of each triangle which belong to a particular layer are interpreted as boundary vectors for flat up or down-facing skin. These boundary vectors continue to tessellate an area of skin into a group of triangles. SLICE next removes all pairs of duplicate boundary vectors. This leaves flat skin boundaries that form a closed loop around an area of skin. These boundary vectors are then filled with very finely spaced cross-hatch (fill) vectors being separated perpendicularly by the number of bits specified by the -Hfx or -Hfy options of slice. This procedure of creating boundaries and fill for flat skins is repeated for both up-facing and down-facing horizontal triangles for each layer of the object.

The filling of the flat skin boundaries is based on the same algorithms as mentioned for cross-hatching above. Therefore, the intersection of a fill line with a boundary triggers the need for a decision to be made as to whether to turn on fill, turn off fill, or continue as is. The decision on what to do is again based on either an odd-even turn on/turn off condition or on the consideration of the direction of the normal vectors associated with each boundary segment (vector). These normals are created by SLICE, and are associated with the boundary vectors, unlike the normals discussed earlier, which are created by the CAD system and are associated with the triangles. For layer hatching, the normal associated with each vector is derived from the triangle it was obtained from, whereas the normal associated with each flat triangle points only in the vertical direction and therefore cannot be used to determine any characteristics designating the inside or outside of the triangle. The technique used to determine the normals for a flat skin boundary is based on the analysis of the three vectors that make up the boundary of a triangle as a group. The technique is to compare the coordinates of the vertices making up a vector to those of the third point of the triangle to determine which way is outside the triangle (relative to the vector). This information, along with the slope of the boundary vector, is sufficient to determine the proper normal direction. This same procedure is done for each of the segments that form the boundaries of a triangle. The normal is then reduced to designate which quadrant it points in, and that information is saved with the boundary segment data (beginning and endpoints). This procedure is repeated for all flat triangles. Then all pairs of duplicate boundary vectors are removed for a given skin type on a given layer. The fill vectors can then be calculated using the same algorithm previously described for hatch vectors.

Skin fill always runs parallel to the X or Y axis so it sufficient to know what quadrant a normal points to determine whether it indicates the entering of hollow or solid. This argument is true for hatch as well, since the algorithms are the same. But when SLICE considers 60/120 hatch, knowing the quadrant in which a normal points is not sufficient to determine accurately whether SLICE is entering or leaving solid. When hatching is done along the 60° or 120° line, SLICE can consider the part to be rotated counterclockwise 60 to 120 degrees. SLICE can consider the axis to be rotated clockwise 60 or 120 degrees so that it can still use X and Y normal indicators to determine whether or not solid or hollow is being entered. But, in doing this rotation, SLICE must not forget to recalculate the new quadrants in which the normals point.

Just as fill is determined for flat-skin, SLICE could determine cross-hatch if needed.

Figure 25a illustrates vertices of a flat triangles. Figure 25b is a flat boundary derived from flat triangles. Figure 25c is a flat boundaries with pairs of duplicate vectors removed. Figure 25d is a flat triangle with boundary vectors and two-dimensional normals. Figure 25e is a flat triangle with its associated vector list.

A further improved technique of generating skins is based on the original direction of the vertical component of the triangle normals as supplied in the STL file. Problems may occur when flat triangles on the edge of a flat surface flip over after rounding to vertices. These problems might occur because the segment normals associated with skin boundary vectors (from flipped triangles) may end up pointing toward the area requiring skin instead of away from it. This, in turn, can cause the misplacement of hatch or fill vectors.

Figure 25f is a top view of a flat skin surface and the triangles forming the surface. Figure 25g is a top view of the flat skin surface with duplicate pairs of vectors removed, along with one edge triangle flipping over, and how its normal points in the opposite direction to the other segment normals forming the boundary.

Two known possible solutions to this problem exist. The first solution is based on considerations similar to those used to develop the normal-sign summation hatching process. Six situations can develop when flat triangles flip over: 1) the flipped triangle forms a single flat surface, 2) the flipped triangle forms a single and a double flat surface, 3) the flipped triangle forms a double surface only, 4) the flipped triangle forms a double and a triple surface, 5) the flipped triangle forms a triple surface only, and 6) other situations that can develop between flat triangles involving features collapsing to single layers, yielding flat up and down-facing triangles covering the same area on a single layer. These situations are very similar to those used to develop the normal-sign summation hatching process. The only difference is that overlapping boundaries are one dimensional whereas the areas covered by overlapping triangles are two dimensional. In essence, the summation technique used for layer hatching computes the net boundary at the intersection of boundaries with hatch paths, whereas, the technique for skinning is based on determining net normals for areas based on addition of areas with like normals and subtraction of areas with opposite normals (up-facing, and down-facing). Then, the determination as to whether an area receives up-facing skin, down-facing skin, or no skin is based on whether the net normal of the areas points up, down, or does not exist. For this to work, the directions of the normals must be determined after distortion of the triangles.

This process yields skin boundaries and fill perfectly matched to features (distorted) requiring particular types of skin (up or down). This process is based on the assumption that no area on a single layer (layer of creation not layer of drawing) can require both up and down skin. This implies that a feature that is originally less than one layer in thickness might be lost.

The second solution is based on computing computer segment normals a second time after duplicate pairs of boundary vectors are removed. This recomputation would be based on the consideration that the majority of the segment normals on any closed boundary loop were.correct the first time they were created (from their triangles) but that a minority of them are wrong, or better yet, on the assumption that the segment normal from a non-flipped triangle is correct and all other segment normals can be made to match it. This method of recomputation is based on the vector ordering procedure described subsequently herein in greater detail. Once the vectors are ordered, the cross product of all boundary vectors (forming a given loop) with their segment normals should be consistently up or down for a given closed loop. With this knowledge, a comparison between cross products is made, and then any unusual segment normals reversed.

Some of the above assumptions might be inapplicable if boundaries are not closed, or two closed boundaries join. A list of possible skin configurations is shown below with a statement as to how this algorithm will form that skin: double surface - area properly skinned, single surface - area skinned properly, single/double - possibly one or both areas improperly skinned along with the possibility of skinning missing other areas also, triple surface - area skinned properly, and double/triple - area skinned properly. Therefore, this second technique has only one problem: single/double surfaces. The possibility of forming a single/double surface is very small, because the formation of a double/single surface implies that only two triangles are involved in the situation and that the one that did not flip is narrower than the one that did.

There is an algorithmic process for reducing the remaining problem further. The problem with single/double surfaces is that after elimination of duplicates, SLICE has only two crossed triangular shaped single surfaces left, but those single surfaces share two vectors and two vectors need one normal for one triangle and the opposite normal for the other. Whenever boundary vectors cross, SLICE needs one segment normal on one side of the cross and the opposite normal on the other side. The solution is based on the detection of crossing boundaries, then dividing the vectors that cross into vectors that end at the intersection point, and then reordering, the new vectors. In this reordering, special care must be taken in order to insure that boundary lines are not crossed and therefore insuring that the new loops are traversed properly. This is also true for two boundary loops that touch at a vertex point. Intersection and touching can be determined by the same algorithmic process. Then loops can be formed by requiring that at the intersection point, the loop not be formed by crossing boundaries but by proceeding to the boundary vector that forms the smallest angle with the last vector, and breaking off loops when they are completed. Figure 25h is a top view of flat triangles forming single/double surfaces before flipping, after flipping, with segment normals, after cancellation of duplicate pairs, after splitting of vectors, and after loop determination (two).

In building objects, SLICE generally considers the objects to have solid portions and hollow portions. Walls wider than two cure widths are created by boundary vectors forming side surfaces and filling in between the boundaries with cross-hatch. If the vertical slope of a wall is over one cure width wide for each layer thickness, then a gap will be formed between the boundary vectors on the two layers. This gap can cause the drainage of liquid from between wall surfaces. The problems of gaps between boundaries is solved by the concept of near-flat skin. Near-flat skin also solves the problem of making the transition from vertical to horizontal features.

This method of filling in the area between the boundaries of consecutive layers can be implemented in several ways. One of the simpler ways of generating fill vectors is based on the realization that areas that require near horizontal skin will be represented by triangles whose normals are within a certain angle of the vertical. This angle (MSA - minimum surface angle) is presently defined by the operator and is based on the angle at which two boundary vectors drawn on consecutive layers would no longer overlap. This is further based on the cure width of the segments forming the boundaries and the layer thickness.

FIGS. 26a and 26b are side views of boundaries on two consecutive layers and the associated variables for determination of the MSA. Figure 26c is a part requiring near-flat skin (the test box).

Since individual triangles can be analyzed to determine the need for near-flat skin, SLICE can process these specific triangles to yield boundary vectors for this skin. It would be difficult to base the development of near-flat skin on differences between layer borders from one layer to the next. Also, to consistently determine the proper near-flat fill, this fill must be generated from the intersection of near-flat triangles right at the slicing layers, not one bit up or down. As with all fill and hatch vectors, SLICE must first determine the boundaries between which it wants to fill. Once these boundaries are determined, the fill will be based on the same algorithms on which layer hatch and flat skin fill are based.

By having the triangle vertices land on slicing layers, SLICE insures that if a triangle affects the fill between two layers, it will have components that either land on each layer or at least intersect each layer. A situation cannot develop in which a triangle will affect the region between two layers and only cross one of them. Since a triangle crosses both layers, SLICE can generate two vectors from the intersection of the triangle with the two layers. These two vectors form two opposing sides of a trapezoid, or of a degenerate trapezoid (triangle).

Figure 26d is a near-flat triangle intersecting two layers and forming two boundary vectors.

The remaining two sides of the trapezoid are formed by producing straight non-intersecting lines from the endpoints of the first segment to the endpoints of the second segment. Now that SLICE has formed a two-dimensional boundary (in a plane) from a particular near-flat triangle, that can be filled with skin and/or hatch. The next step is to determine the segment normal vectors associated with each of these boundary vectors to clarify what is inside and what is outside of the trapezoid. This determination is very similar to that which was done for flat skin boundaries.

First, the vertical component of the normal of the near-flat triangle, which generated the trapezoid, is used to determine whether the trapezoid belongs to up-facing or down-facing near-flat skin. The segment normals for each trapezoid boundary are calculated by noting that the slope of the segment normal vector is the negative reciprocal of the segment slope and its direction is away from the remaining two points of the trapezoid. Remember that the information for the segment normal is only stored (after calculation) as 6 bits, indicating whether it has components along the positive or negative directions of the three axes. Normals are determined for each of the sides of the trapezoid. This procedure is then repeated for each of the layers that each near-flat triangle intersect.

At this time, all degenerate boundary vectors (the point vectors that turned some trapezoids into triangles) are removed. Following this, all pairs of duplicate boundary vectors of each type of each layer are removed. After removal of duplicate vectors, SLICE is left with complete boundaries of near-flat skin with associated segment normals indicating inside and outside of the boundaries. These boundaries can now be filled using either of the hatching algorithms. Near-flat hatch vectors generated will have the same characteristics as those of layer hatch and the near-flat skin fill vectors will have the same characteristics of flat skin fill. The concept of where to place near-flat skin after it has been created will be discussed in the next section.

Figure 26e is a top view of near-flat boundary vectors for a trapezoid and a triangle being completed. Figure 26f is a top view of the trapezoid showing relationships between segment normals, boundaries, and inner and outer portions of the trapezoid. Figure 26g is a top view of near-flat skin trapezoid boundaries before removal of pairs of duplicate vectors. Figure 26h is a top view of near-flat skin boundary after removal of duplicate vectors.

The same comments made regarding recalculating flat-skin boundary segment normals applies to near-flat boundary segment normals as well.

However, as with flat skin, there are situations in which near-flat skin fill and hatch can be misplaced. These situations come about from the same circumstances described in the comments relating to flat skin previously described. The solutions described in connection with flat skin also can be applied here. However, it should be noted that near-flat skin is much less likely to have problems than flat skin because it is much less likely to have flipped over triangles overlapping other triangles.

Boundary vectors are created from processing triangles that intersect a given layer. This processing of triangles can occur in any order and can therefore produce boundary vectors in any order. When objects are built, the movement of the laser across the liquid surface takes a finite time. During this finite time two things happen: 1) slight curing of the liquid occurs even if it does not produce measurable solid material, and 2) by the time the laser beam has reached a point which it is supposed to cure, it may have already received commands to move to a new point, or at minimum it will not sit at this first point for the proper length of time to give it proper cure. Taking these two points into consideration, the laser beam should not be jumping any more than it has to. When jumping cannot be avoided, it is better to jump over a region of solid than a region of hollow.

It must be remembered that the boundaries form closed loops of vectors; therefore, the location of the head of one vector will always correspond to the tail of another. If SLICE considers boundary vectors to be drawn from tail to head, it can minimize the jumps when drawing boundaries by ordering the vectors so that the first vector is followed by a second vector whose tail is at the same point as the head of the first, and the tail of the third vector is at the same point as the head of the second. This is continued for a given closed loop. The only time the beam needs to jump is when it begins drawing the boundary, when it starts drawing a new loop, and when it finishes the boundary. These statements apply to the ordering used for all types of boundaries.

Figure 27a is a top view of a possible order to drawing boundary vectors when they are not ordered. Figure 27b is a top view of drawing boundary vectors after they have been ordered.

Hatch and fill vectors are created from making decisions at the intersection points of hatch and fill paths with boundaries. After creation of hatch or fill vectors, they need to be ordered in a way to give optimum part building conditions (as with boundary vectors). When drawing hatch vectors, the number and lengths of the jumps of the laser beam should be minimized. Jumps over hollow areas need to be minimized, whereas jumps over solid areas can be considered less critical. Also, hatch types (X, Y, 60/120) should be drawn as groups to insure that stresses on a layer are developed in such a manner to minimize them on the layer as a whole, and to spread them uniformly over all areas so that there are no local area build ups. SLICE needs to consider ways of drawing blocks of hatch and fill vectors to minimize jumping. One method is based on a technique of minimizing jumping distance regardless of whether that distance is over solid or hollow. The steps for this method are as follows:

1) Start with any one hatch vector and define its tail and head and define it to be drawn from tail to head.
2) Search the remaining hatch vectors for the one that has a point closest to the head of the first vector.
3) Define this closest point as the tail of vector 2 (vector 2 to be drawn tail to head).
4) Search the remaining vectors for the one that has a point closest to the head of vector 2.
5) Define this closest point as the tail of vector 3.
6) Continue this process until all vectors are ordered.

This procedure will minimize the jumping distance (number of jumps is constant).

This is a reasonable method to minimize the jumping distance but is probably a relatively slow way of ordering the vectors. This algorithmic process does not distinguish between jumping over solid or hollow areas and will only minimize the jumps over hollow areas when the gap of the hollow is greater than the distance from the endpoint of one vector to the starting point of its neighboring vector (see Figure below).

Figure 27c is a top view of boundaries and hatch showing spacing so that the endpoint of 1 vector is closest to the beginning point of its neighboring vector. Figure 27d is a top view of boundaries and hatch showing an endpoint of a vector placed closer to a beginning point on a vector across a hollow instead of to its neighbor.

The way hatch and fill vectors are presently ordered in SLICE is based on a completely different algorithm than the one described. The present algorithm is based on drawing the first vector derived from the first hatch or fill path followed by the first vector derived from the second hatch or fill path. This process continues until all the paths are covered. Then the algorithm is repeated, this time looking for the second vector on each path, and then the third, until all vectors have been covered. Every other vector is drawn in reverse order so as to minimize the jumping distance. This algorithm keeps the jumps to a minimum and the jumps that do occur are generally over solid as opposed to hollow areas.

Figure 27e is a top view of boundary and hatch showing order of drawing of hatch.

There are several other algorithms that could be used to order the hatch and fill, but comments will only be provided for one more. This last algorithm is very similar to the first, but it has one difference. It uses a very small hatch spacing for calculating the drawing order but actually only outputs a portion of the vectors. This portion would be based on the desired spacing and on skipping an even number of dummy vectors so that the drawing order will be proper.

Four methods have been analyzed regarding placement of skins. These methods have been designated as STYLES 1 though 4. The first two styles (STYLE 1 and 2) have characteristics that allow the building of any general part; therefore, they have the characteristics of always having solid material on a previous layer which is available to attach to the solid material which is being formed on the following layer. STYLES 3 and 4, on the other hand, cannot be used to build general parts due to inconsistency in the availability of solid material from the previous layer on which to attach solid material from the present layer. This inconsistency disappears for parts that fit specific requirements, so STYLES 3 and 4 can be useful for some classes of parts.

STYLES 1 and 2 build parts whose solid areas are slightly oversized in the X and Y dimensions and whose hollow areas are slightly undersized in the X and Y dimensions. The amount to which these solid features are oversized is based on the vertical angles of the normals of the triangles that form the features. If a triangle's normal makes a large angle with the vertical, it will cause the features to be only slightly oversized; whereas if a triangle's normal makes a small angle with the vertical, it will produce a larger amount of oversizing.

STYLES 3 and 4, on the other hand, build parts whose solid features are slightly undersized in the X and Y dimensions and whose hollow features are slightly oversized in the X and Y dimensions. The amount to which these solid features are undersized is based on the vertical angles of the normals of the triangles that form the features. If a triangle's normal makes a large angle with the vertical, it will cause the features to be only slightly undersized; whereas if a triangle's normal makes a small angle with the vertical the features will be undersized by a larger amount. The amount of undersizing along with the horizontal separation of features will determine under what conditions STYLES 3 and 4 can no longer build real parts and, therefore, under what CAD design criteria STYLES 3 and 4 can effectively be used.

Figure 28a is a side view of a CAD designed object. Figure 28b is a side view of the same CAD designed object built using STYLE 1 or 2, with a perimeter of the CAD object drawn around it. Figure 28c is a side view of the same CAD designed object built using STYLE 3 or 4, with a perimeter of the CAD object drawn around it.

Layer boundary vectors are obtained from the intersection of scan and near-flat triangles with a horizontal plane 1 scale bit above the slice layer. Normals for these vectors are obtained from the triangles they are derived from, if appropriate for later hatching between boundaries. This 1 bit up obtainment of vectors gives the right vertical displacement between down facing and up facing features. This also gives the ability to consistently deal with flat up-facing, flat down-facing, near-flat up-facing, and near-flat down-facing skin based solely on the type of skin not on geometrical relations of features.

Figure 29a is a side view of a CAD designed object showing slice layers and planes one bit above the layers where boundary vector will be obtained. Figure 29b is a side view of a CAD designed object showing boundary vectors. Figure 29c is a side view of a CAD designed object showing boundary vectors after they have been given a full cure.

Layer hatch vectors are obtained from hatch lines intersecting layer boundaries.

Flat skin boundary vectors are separated into two categories: 1) up-facing, and 2) down-facing. Flat skin boundaries are obtained from the edges of horizontal triangles. Normal vectors to these boundary vectors are obtained by considering inside and outside areas of the triangles if appropriate to later filling or hatching. Duplicate boundary vectors are removed. Therefore, boundaries are converted from triangle boundaries to boundaries enclosing skin fill areas.

Flat skin hatch vectors are obtained from hatch lines intersecting flat skin boundaries. Flat skin hatch is not currently being used because it is basically redundant to layer hatch, after skins are put on the right layer, but it is available if it is needed.

Flat skin fill vectors are obtained from fill lines intersecting flat skin boundaries.

Vectors associated with flat up-facing skin are moved down 1 layer from the layer on which they were derived. This is due to the layer boundary and hatch being obtained from one bit above the slicing layer, causing there to be no layer boundary or hatch under these skins. Actually, this movement of skin is not due to the location of boundaries, but this movement of the skin is required for building parts with the right vertical dimensions, so SLICE picks the location at which to derive layer boundaries that would allow it to make this movement of skin in a consistent manner.

Figure 29d is a side view of a CAD designed object depicting flat skin boundaries after they have been moved to the layers on which they will be built.

Near-flat skin boundaries are created from the intersection of near-flat triangles with horizontal planes at the slice layers. Near-flat triangles are those defined by their normals being at smaller angles to the vertical than some specified angle. This angle is based on the point at which boundaries generated from this triangle on consecutive layers would no longer overlap given a particular cure width of the boundary and a particular thickness between the layers. Because triangle vertices are rounded, SLICE is assured that if there is a requirement for near-flat skin between two layers, that each triangle surfacing the object in that region will intersect a horizontal plane at each layer. These intersections are used to create boundary vector segments for near-flat skins. The additional two segments required are obtained by connecting the ends of these first two. Normals to each segment are generated if appropriate for later filling or hatching. These boundaries are divided into two types: 1) up facing, and 2) down facing. Duplicate near-flat boundary vectors are then removed along with point vectors.

Near-flat skin hatch vectors are obtained from hatch lines intersecting near-flat skin boundaries. Near-flat skin hatch is currently being used for down facing skin but not for up facing skin. Up facing skin hatch is basically redundant, to layer hatch, while down facing skin hatch isn't redundant because it is used to create full layer thickness sections of an object.

Figure 29e is a side view of a CAD designed object showing near flat skin frames at the locations where they were created.

Near-flat skin fill vectors are obtained from fill paths intersecting near-flat skin boundaries.

When creating near-flat skin for a layer, whether it be up-facing or down-facing, SLICE compares the current layer to the layer above. This means that near-flat, up-facing skin will always have hatch vectors and partial boundary vectors on which to be built, from layer boundary and hatch. But since down-facing, near-flat skin will have nothing to build on, full down-facing, near-flat boundaries and hatch will be required to support the skin. Also more important, giving near-flat, down-facing skin boundaries and hatch a full layer cure will give the part a consistent, slightly oversize X and Y dimension (perfect for smoothing by sanding to yield the right sized part).

Figure 29g is a side view of a CAD designed object showing near flat skin boundaries after they have been given full cure. Figure 29g is a side view of a CAD designed object showing superposition of layer boundaries and near-flat boundaries after being cured.

The technique used for generation and placement of near-flat skins provides a means of making a gradual transition from vertical to horizontal features while always insuring that solid material on previous layers is available to attach the current layer to.

Both down-facing flat and near-flat skin fill are to be drawn as relatively thin films at the top of their layers but eventually, before drawing of down-facing skin fill, there will probably be an up dip of the part in the liquid to allow the drawing of the fill to be at the bottom of the layer, instead of the top, thereby minimizing ripple between fill and hatch on down-facing features.

FIG. 29j is a side view of a CAD designed object along with superposition of all vectors.

STYLE 2 achieves the same end result as STYLE 1. The part is slightly oversized on its X and Y dimensions, while maintaining a placement of vertical features (Z dimension) which yields the best duplication of the CAD designed object possible, while building it with finite layer thickness. The approach of STYLE 2 is opposite to that of STYLE 1. This causes differences in how vectors are being obtained and implemented to build the correct sized part.

Layer boundary vectors are obtained from the intersection of scan and near-flat triangles with a horizontal plane 1 scale bit below the slice layer. This implies that down-facing features (skin) will have no layer boundary or layer hatch to build on, while up-facing features (skin) will have both layer hatch and boundaries available to build upon. Normals for these boundary vectors are obtained from the triangles that give rise to the vectors, if appropriate for later hatching between the boundaries. Obtainment of boundaries 1 bit below the slice layers allows the correct vertical displacement between down-facing and up-facing features. It also permits SLICE to deal with all 4 skin types in a consistent manner, based solely on the type of skin not on geometrical relations of features.

Layer hatch vectors are obtained from hatch lines intersecting layer boundaries.

Flat skin boundary vectors are separated into two categories: 1) up-facing, and 2) down-facing. Flat-skin boundaries are obtained from the edges of horizontal triangles. Normal vectors to the created boundary vectors are obtained by considering inside and outside areas of the triangles, if appropriate to later filling or hatching. Duplicate pairs of boundary vectors are removed, therefore converting from triangle boundaries to boundaries enclosing skin fill areas.

Flat skin hatch vectors are obtained from hatch lines intersecting flat skin boundaries. Flat skin hatch is currently considered unnecessary because it duplicates layer hatch which is available once skins are moved to the layers on which SLICE wants to build them, but it is available if needed.

Flat skin fill vectors are obtained from fill paths intersecting flat skin boundaries.

Vectors associated with flat, down-facing skin are moved up from the layer on which they were derived. This movement is due to the requirement of maintaining the best vertical duplication of the CAD designed object. Associated with this movement was the reason for obtaining layer boundaries 1 bit below the slice layer. In other words, by obtaining layer boundaries one bit below the slice layer, SLICE insures that flat down-facing skins won't have any hatch under them, and therefore they could be moved up. This also insures that up-facing, flat skins would always have hatch available to build on.

Near-flat skin boundaries are created in exactly the same way they are created for STYLE 1.

Near-flat skin hatch vectors are obtained from hatch lines intersecting near-flat skin boundaries. Near-flat skin hatch is required for up-facing skin, but not for down-facing skin. Down-facing hatch appears to duplicate layer hatch whereas up-facing hatch doesn't because it is used to create a full layer thickness of solid in a new area.

Figure 30a is a side view of a CAD designed object showing positions of slice layers and planes one bit down for creation of layer boundary vectors. Figure 30b is a side view of a CAD designed object showing the layer boundary vectors at the positions where they were created. Figure 30c is a side view of a CAD designed object along with fully cured layer boundaries.

Near-flat skin fill vectors are obtained from fill lines intersecting near-flat skin boundaries.

When creating near-flat skin for a layer, whether it be up-facing or down-facing, SLICE compares the current layer to the layer above (as stated earlier, this comparison is made exactly on the slice layers and not above or below). This means that near-flat, up-facing and near-flat, down-facing skin vectors have nothing to build on so they can be moved up or down to find support, or they can be moved to or stay on layers that don't already contain support if SLICE uses near-flat boundaries and hatch to build full a layer thickness of material (for support). The requirement of maintaining an object of consistent size and shape relative to the CAD design demands that near-flat up-facing skin vectors be moved up one layer and that the associated boundaries and hatch be given a full layer cure. Additionally, near-flat, down-facing vectors must be moved up a layer, therefore, making hatch unnecessary, because of the presence of layer hatch.

Figure 30d is a side view of a CAD designed object along with near-flat skin boundaries. Figure 30e is a side view of a CAD designed object along with near-flat skin boundaries after being moved to the layers that they will be built on. Figure 30f is a side view of a CAD designed object along with near-flat skin boundaries being given a full cure. Also indications as to where these boundaries overlap already cured layer boundaries are provided. Figure 30g is a side view of a CAD designed object showing superposition of layer boundaries and near-flat skin boundaries.

The STYLE 2 method of deriving vectors and their associated placement provides the same important result that STYLE 1 did: SLICE can make a gradual transition from vertical to horizontal structures while always insuring that it will have solid material below on previous layers to attach the current layer to.

All four types of skin fill are to be drawn as relatively thin films (i.e. shallow) at the top of the layers they are placed on, but eventually before drawing down-facing skins, the part will probably be lifted out of the liquid slightly (less than 1 layer) thereby allowing the skin to fill the bottom of the layer to minimize ripple between fill and hatch.

Figure 30h is a side view of a CAD designed object along with flat skin boundaries. Figure 30i is a side view of a CAD designed object along with flat skin boundaries being moved to the layers they will be built on. Figure 30j is a side view of a CAD designed object showing superposition of all vectors (with down facing skins being drawn at the bottom of their layers.

STYLE 3 and STYLE 4

STYLES 3 and 4 are very different from STYLES 1 and 2; STYLES 1 and 2 are used to build objects that are slightly oversized in the X and Y dimensions, whereas STYLES 3 and 4 are used to build objects that are slightly undersized in the X and Y dimensions. STYLES 1 and 2 can build any general object; whereas STYLES 3 and 4 can have problems when attempting to build parts that include thin walled sections at small angles to the horizontal. The circumstances under which problems can occur are based on relationships between layer thickness, layer levels, and geometric relationships between features. The conditions under which STYLES 3 and 4 can be used to successfully build objects will be discussed in more detail after discussing the methods of generating vectors. STYLES 3 and 4 derive their vectors from a combination of vector types used in STYLES 1 and 2, respectively. Note: The statements below that reference vector types from STYLES 1 and 2 refer to the layers from which those vector types were derived (they do not indicate the layer on which the vectors are moved to before they are drawn, which can be different).

Layer boundaries for STYLE 3 (layer n) surround the areas enclosed by the layer boundaries of STYLE 1 (layer n) minus the intersection of areas enclosed by the layer boundaries from STYLE 1 (layer n) with the areas enclosed by up-facing, near-flat boundaries from STYLE 1 (layer n).

Figure 31a is a side view of a CAD designed object showing positions of slice layers and obtainment of layer boundaries. Figure 31b is a side view of a CAD designed object with layer boundaries being given a full layer cure depth.

Layer hatch vectors are obtained from hatch paths intersecting layer boundaries.

Near-flat, down-facing boundaries for STYLE 3 (layer n) surround areas enclosed by the intersection of areas enclosed by down-facing near-flat boundaries from STYLE 1 (layer n) with areas enclosed by the layer boundaries of STYLE 1 from (layer n+1).

Figure 31c is a side view of a CAD designed object showing positions where down-facing near-flat boundaries are obtained. Figure 31d is a side view of a CAD designed object showing down-facing near-flat boundaries on which they will be built (up one layer).

Near-flat, down-facing hatch and fill are obtained from hatch and fill paths intersecting near-flat, down-facing boundaries. Near-flat, down-facing hatch duplicates layer hatch and is therefore not generally needed. Near-flat, down-facing vectors are moved up one layer to be built (layer n+1).

Up-facing, near-flat boundaries for STYLE 3 surround the areas enclosed by the intersection of areas enclosed by up-facing, near-flat boundaries from STYLE 1 (layer n) with the areas enclosed by layer boundaries of STYLE 1 (layer n-1).

Figure 31e is a side view of a CAD designed object showing positions where up-facing near-flat boundaries are obtained. Figure 31f is a side view of a CAD designed object showing up-facing near-flat boundaries after they are moved to the layers on which they will be built (down one layer).

Near-flat, up-facing hatch and fill are obtained from hatch and fill paths intersecting near-flat up-facing boundaries. Near-flat, up-facing hatch duplicates layer hatch and is therefore not generally needed. Near-flat, up-facing vectors are moved down to the previous layer (layer n-1).

Flat, up-facing skin boundaries for STYLE 3 surround the areas enclosed by flat-up facing skin boundaries from STYLE 1 (layer n) minus the intersection of areas enclosed by flat up-facing boundaries from STYLE 1 (layer n) with the areas enclosed by near-flat, down-facing boundaries from STYLE 1 (layer n-1).

Figure 31g is a side view of a CAD designed object showing the positions where up-facing flat skin boundaries are obtained. Figure 31h is a side view of a CAD designed object showing up-facing flat boundaries after they are moved to the layers on which they will be built (down one layer).

Flat, up-facing hatch and fill are generated from hatch and fill paths intersecting flat up-facing boundaries. Flat, up-facing hatch duplicates layer hatch and is, therefore, not generally needed. Vectors associated with flat, up-facing skin (layer n) are moved down to the previous layer to be built (layer n-1).

Flat, down-facing boundaries for STYLE 3 (layer n) surround the areas enclosed by flat down-facing boundaries from STYLE 1 (layer n) minus the intersection of areas enclosed by flat, down-facing boundaries from STYLE 1 (layer n) with the areas enclosed by near-flat, up-facing boundaries from STYLE 1 (layer n).

Figure 31i is a side view of a CAD designed object showing the positions where down-facing flat skin boundaries are obtained (built on same layer as obtained).

Flat, down-facing hatch and fill are obtained from hatch and fill paths intersecting flat down-facing boundaries. Flat, down-facing hatch duplicates layer hatch and is therefore not generally needed. Flat, down-facing skin vectors stay on the same layer on which they were found (layer n).

Figure 31j is a side view of CAD designed object with all vectors superimposed and drawn to the proper cure depth (remembering that hatch and fill always are created from boundaries).

STYLE 4

Layer boundaries for STYLE 4 (layer n) surround the areas enclosed by the layer boundaries of STYLE 2 (layer n) minus the intersection of the areas enclosed by layer boundaries from STYLE 2 (layer n) with the areas enclosed by down-facing, near-flat boundaries from STYLE 2 (layer n-1).

Figure 31k is a side view of a CAD designed object showing positions of slice layers and obtainment of layer boundaries. Figure 31l is a side view of a CAD designed object with layer boundaries being given a full layer cure depth.

Layer hatch vector are obtained from hatch paths intersecting layer boundaries.

Near-flat, down-facing boundaries for STYLE 4 surround areas enclosed by the intersection of the areas enclosed by down-facing near-flat boundaries from STYLE 2 (layer n) with the areas enclosed by layer boundaries from STYLE 2 (layer n+2).

Near-flat, down-facing hatch and fill are obtained from hatch and fill paths intersecting near-flat down-facing boundaries. Near-flat, down-facing hatch duplicates layer hatch and is therefore not generally needed. Near-flat, down-facing vectors are moved up two layers to be built (layer n+2).

Figure 31m is a side view of a CAD designed object showing positions where down-facing near-flat boundaries are obtained. Figure 31n is a side view of a CAD designed object showing down-facing near-flat boundaries after they are moved to the layers on which they will be built (up two layers).

Near-flat, up-facing boundaries for STYLE 4 surround areas enclosed by the intersection of the areas enclosed by near-flat, up-facing boundaries from STYLE 2 (layer n) with the areas surrounded by the layer boundaries from STYLE 2 (layer n).

Near-flat, up-facing hatch and fill are obtained from hatch and fill paths intersecting near-flat up-facing boundaries. Near-flat, up-facing hatch duplicates layer hatch and is, therefore, not generally needed. Near-flat, up-facing vectors are not moved, but remain on the layer from which they were derived when they are built (layer n).

Flat, up-facing skin boundaries for STYLE 4 surround the areas enclosed by the flat, up-facing skin boundaries of STYLE 2 (layer n) minus the intersection of areas enclosed by flat, up-facing boundaries from STYLE 2 (layer n) with the areas enclosed by near-flat, down-facing boundaries from STYLE 2 (layer n-1).

Figure 31o is a side view of a CAD designed object showing positions where up-facing near-flat boundaries are obtained. Figure 31p is a side view of a CAD designed object showing the positions where up-facing flat skin boundaries are obtained (built on the same layer as derived).

Flat, up-facing hatch and fill are generated from hatch and fill paths intersecting flat, up-facing boundaries. Flat, up-facing hatch duplicates layer hatch and is, therefore, not generally needed. Vectors associated with flat, up-facing skin (layer n) stay on the layer from which they were created when they were built.

Flat, down-facing boundaries for STYLE 4 (layer n) surround the areas enclosed by flat, down-facing boundaries from STYLE 2 (layer n) minus the intersection of areas enclosed by flat, down-facing boundaries from STYLE 2 (layer n) with areas enclosed by near-flat, up-facing boundaries from STYLE 2 (layer n).

Figure 31q is a side view of a CAD designed object showing the positions where down-facing flat skin boundaries are obtained. Figure 31r is a side view of a CAD designed object showing down-facing flat boundaries after they are moved to the layers on which they will be built (up one layer).

Flat, down-facing hatch and fill are obtained from hatch and fill paths intersecting flat down-facing boundaries. Flat, down-facing hatch duplicates layer hatch and is, therefore, not generally needed. Flat, down-facing skin vectors move up one layer relative to where they were found (layer n+1).

Figure 31s is a side view of a CAD designed object with all vectors superimposed and drawn to the proper cure depth (remembering that hatch and fill always are created from boundaries).

As stated earlier, STYLES 3 and 4 cannot be used to build general objects, but can be useful for building objects that meet particular requirements. To insure that STYLES 3 and 4 will build a particular object properly, the object should be inspected using the following criteria: 1) using the appropriate layer thickness, determine where each slice layer will be, 2) image the object being built completely within the envelope of its (rounded) CAD designed skin, 3) determine if there are any critical areas on each layer that will not adhere to the layer below; if such areas exist, the object cannot be built using the chosen parameters (layer thickness and/or slice layer levels). If such areas do not exist, the object can be built.

Figure 31t are side views of straight but slanted beams showing that objects can be built with particular layer thicknesses but not with others. Figure 31u are side views of an object similar to that used in describing STYLES 3 and 4 but with a wider window and varying layer thicknesses.

## OFFSETTING OF VECTORS

When boundary vectors are drawn, they cure a desired depth of material but they also cure a finite width of material. Since the boundary vectors are created at the exact edges of objects, these edges are displaced by 1/2 of a cure width into the area that is supposed to be hollow. Since any object has two edges per feature, this expansion will cause an increase of 1 cure width in cross-section of each feature. One cure width can range from 10 mils to 30 mils. This amount of over cure causes distortions outside of the desired tolerance of +/- 5 mils for any feature. The solution to this size problem can be implemented in the original CAD design, or preferably can be implemented in SLICE by an offset of all boundary vectors 1/2 a cure width into the solid region of the object. The CAD implementation is functional but trivial; therefore, the following will discuss a SLICE implementation of boundary vector offsetting.

FIGS. 32a and 32b are top views of the cross-section of a CAD designed object depicting desired boundaries after curing.

The major steps required in the offsetting procedure are as follows:

A) Produce boundary vectors. For each boundary vector, store the starting point (Xs, Ys), the ending point (Xe, Ye), the complete unit length normal information (in the plane), and the equation for the vector. The equation of the line should be specified in the form aX + bY = c.

B) Group vectors with same equations (whether normals are opposite or not).

1) Determine whether any vectors with the same equation overlap in space.

2) If any do, divide the vectors into separate vectors, ones that completely overlap with other vectors, and ones that do not overlap anywhere. This increases the number of vectors. Next, process the vectors that overlap to determine whether any of them can be reduced to a single non-overlapping vector. Vectors that overlap are processed by determining the net normal for the area covered by the vectors. The determination of the net normal yields a net normal of 0, or a normal of unit length pointing in one of two possible directions. If a non-zero net normal is determined, the overlapping vectors are to be considered as only one vector whose normal points in the net direction. This vector is to be placed in with the other non-overlapping vectors for further processing. If a zero net normal is determined, the overlapping vectors are to be considered as two vectors that have opposite pointing normals. These two vectors are to be removed from further processing. This leaves SLICE with boundaries formed by non-overlapping vectors.

3) Using the vectors from step 2 maximize the lengths of the vectors by combining any that join end to end and have the same equation. This will minimize the number of vectors.

C) Order the resulting vectors from the previous step, so that the head of one vector ends at the tail of the next, and continue until a closed loop is formed. After this loop is closed, take the next unused vector and continue to order the remaining vectors to form additional loops. If everything has been processed properly to this point, SLICE should only have closed loops formed. Also, these closed loops should have consistent normal directions.

D) The next step is to offset the boundary loops half a cure width into solid regions (opposite direction to boundary normals). The offsetting of vectors can be done by modifying the vector beginning and ending points by use of the following equations:

1) <u>Variable definitions</u>

Xbo = X coordinate beginning point after offsetting
Ybo = Y coordinate beginning point after offsetting
Xeo = X coordinate ending point after offsetting
Yeo = Y coordinate ending point after offsetting
Xb = X coordinate beginning point before offsetting
Yb = Y coordinate beginning point before offsetting
Xe = X coordinate ending point before offsetting
Ye = Y coordinate ending point before offsetting
Xn = X component of unit length boundary normal
Yn = Y component of unit length boundary normal <u>Equations</u>:

$$Xbo = Xb - Xn \qquad Xeo = Xe - Xn$$

$$Ybo = Yb - Yn \qquad Yeo = Ye = Yn$$

E) The next step is to recalculate the intersection points between boundary vectors. Since SLICE ordered vectors in an earlier step, it now knows which vectors should meet (consecutive vectors meet head to tail). The line equations for each pair of vectors are used to determine the new intersection point of the two vectors (head of the first vector and tail of the second).

Mathematically, it is simple to find the intersection of two lines but another check must be performed at the same time: each of the vectors must be checked to see if it is still pointing in the same direction. If it is, SLICE goes on to the next pair. If not, SLICE removes the vector that changed direction (180 degree flip), along with the calculated intersection point, and proceeds to recalculate a new intersection point based on the good vector from the first pair and the next vector in the list. This procedure is continued until the new intersection points for all boundary vectors are obtained. Note this procedure is based on the assumption that no feature will collapse when the offset occurs.

The previous section described a method of implementing cure compensation based on determining a reliable vector ordering procedure, then offsetting all vectors 1/2 a line width in the direction opposite to the direction in which the normal pointed, and then finally recalculating the intersection points between consecutive vectors along with removal of vectors that changed directions. In this section, a description of another method of implementing cure compensation is provided based on determining another reliable vector ordering procedure and then offsetting vector beginning and end points. By offsetting beginning and end points, SLICE does not need to recalculate intersections of vectors after the compensation as it needed to do previously, but it still needs to insure that vectors don't cross each other (change direction). There are subtle differences between these two approaches with each having some disadvantages and advantages compared to the other. Some appropriate mixing of the techniques will probably yield an even better cure compensation process.

Ordering of vectors as presently implemented begins with picking any boundary vector, and defining the tail to head orientation of the vector to keep its normal pointing towards the left, while proceeding in a direction from head to tail along the vector. Next, SLICE searches the remaining vectors for one that adjoins to the head of this first vector that will have its normal pointing in the proper direction when this adjoining point is defined as the tail of this second vector. This process is continued until a closed loop is formed, and then the loop is set aside and processing continues until all vectors are used. Note, cure compensation is done only to boundary vectors; hatch and fill are determined after compensation is completed on the boundary vectors.

Two difficulties can arise when ordering vectors: 1) Several vectors can meet at one point, so that going along the wrong path can lead to inappropriate formation of loops, and 2) Sometimes, due to flipping of triangles, normals can point in the wrong direction so formation of loops is not possible when requiring that vectors have the proper normal.

The first difficulty can be resolved by a technique of breaking off loops when they form. For example, if 10 vectors are ordered, and then another vector is ordered, vectors 5 through 11 may form a closed loop. If this occurs, SLICE can set vectors 5 thru 11 aside, and start with vector 4 again and look for an adjoining vector.

The second problem is not really solved by this process. Closed boundary loops may not always be possible, so SLICE doesn't require them in this implementation. It just produces an output that warns that a hatching or filling problem might result because this situation has occurred. Note, a combination of the various ordering algorithms described can produce a more reliable ordering, especially by combining loop removal of the section with ordering previously described in the immediately prior section.

The actual method of compensating for cure width now that the vectors are ordered, is next described. Part of the process is used to minimize the possibility of the compensation causing crossovers of vectors. Crossovers can occur when vectors are short compared to the required compensation, and also when the angles between several consecutive vectors cause a crossover. The vector which offsets the vertex (offsetting vector) drops a line from its endpoint to each of the vectors that formed it. These lines are perpendicular to each of the forming vectors and their intersection points are required to be less than 1/2 the distance from the vertex to the end of each vector. If this is not the case, then the offsetting vector is shortened until the 1/2 point limit is not exceeded.

FIGS. 34a, b, and c are top views of vectors that can crossover if not handled properly. Another portion of the implemented process is that, on acute angles, the length of the offsetting vector is limited to a maximum of 2 laser beam widths so that complete loss of narrow features does not occur.

FIGS. 34d-k give a complete overview of the above described technique of cure compensation.

Figure 34l depicts the removal of vectors that change direction after being cure compensated.

The SLICE program accepts input data in the form of three dimensional triangles and creates output data consisting of line segments (vectors) to be beamed upon the surface of a photopolymerizing compound in a layer by layer manner. It is a goal of this process that it be accurate to within several thousandths of an inch (mils). Clearly, to achieve such accuracy to the true dimensions of the part being made, factors such as the radius of the laser beam must be taken into account.

Thus the purpose of cure compensation (previously termed "tangent following") is to correct for the radius of the laser beam when either inner or outer borders of a layer are traced. This problem is akin to those common in numerically controlled milling (NC), except that here, the distances are much smaller. Note that while the original part is defined in three dimensions, SLICE has reduced the problem to a two dimensional one. The corrections for the third dimension, the vertical or Z direction, are taken into account by the processing logic in SLICE.

It originally appeared that a scaling operation might be the solution--SLICE could simply shrink the outline (in the case of outer perimeter). But scaling will not be uniform on layers that do not have radial symmetry, and requires calculating a "center of inertia" for each outline. To many irregular outlines, scaling would induce a distortion that is much different than the desired cure compensation. Therefore an approach that adjusts each vertex would have to be taken.

For outer perimeters (borders), the compensation is essentially a path reduction by a factor related to the laser beam radius. For inner perimeters (holes, and inner surfaces of walls), the path the laser beam travels must be expanded.

The final algorithmic process developed is based upon vector algebra and trigonometry. Realizing that each pair of line segments comprising the border can be thought of as two vectors (rays) emanating from a common point (local origin), a model was developed using APL under MS-DOS.

FIGS. 35a and 35b are APL programs for such a model. Some of the various compensation cases that can arise are shown in the attached graphs FIGS. 36a through 36m. Note that it is assumed that the conversion from input triangles to endpoint-sorted vectors has already been performed satisfactorily.

In fact, this conversion is not always straight forward. The endpoint sort algorithm process will subsequently be discussed in greater detail. For an overview of the entire conversion process from input triangles to layered segments, reference is made to the previous discussion and to Figure 33.

The following discussion refers to FIGS. 36a-36m, which illustrate specific cure compensation cases. Due to the pitch of the dot matrix printer, the graphs are not in a 1 to 1 aspect ratio, although they do appear at 1 to 1 on the computer monitor. The Figures are plotted in nonspecific units. The origin is shown in the lower left of each graph, in which the X axis is horizontal, and the Y axis is vertical.

In order to exaggerate the effects of cure compensation, the laser beam radius (0.4) is quite large compared to the perimeters. One distortion that is clearly visible in all cases of the photopolymerization process is that sharp corners are rounded, because the laser beam spot is round itself.

In each graph, the circles represent laser beam spots at the vertices of the compensated perimeter. The lines connecting the centers of the circles indicates the beam path of the laser.

BASIC CURE COMPENSATION

An outer perimeter in the shape of a right triangle is considered in Fig. 36a. Its coordinates are plotted;' and they are (1,1) (4,1) (4,4).

Cure compensation is applied to these coordinates and they are moved inward; i.e. the outer perimeter is reduced in size. The amount of reduction can be visualized geometrically by inscribing a circle (the laser beam) at each vertex of the perimeter. The centers of these circles thus gives the new vertices of the compensated perimeter.

It can be seen that each such inscribed circle will be tangent to the two vectors sharing a common point; that point is the vertex to be compensated in the perimeter. Since the relationship is bitangential, it will cause the compensation to vary as the angle between the two vectors varies.

ACUTE ANGLE CASE

To illustrate this point, consider Fig. 36c in which is shown an acute angle at vertex (5,1). Note the significant displacement of the circle that is required to maintain the required bitangential condition. Thus, it is seen that for acute angles, there will be considerable compensation resulting in a foreshortening distortion of the perimeter.

The acute angle distortion should not necessarily be regarded as undesirable because 1) the distortion is relative to laser beam radius which is quite small to begin with, and 2) the feature that would have existed without the compensation may have been structurally weak, or 3) the uncompensated feature itself would be a distortion of the outer perimeter. This distortion is an outcome of the bitangential effect of inscribing the laser beam wholly within the original outer perimeter, and could be ameliorated by relaxing this condition, i.e. allowing a portion of the laser beam to exceed the actual outer perimeter.

OBLIQUE ANGLE CASE

An oblique angle does not induce a significant distortion. An example of this case is shown in FIG. 36d at vertex (1,1). Note that the inscribed circle near (1,1) does not touch point (1,1). Rather, it is tangent to the vectors sharing that vertex.

INSIDE ANGLE CASE

The same effect of oblique angle compensation is even more pronounced in the case of the "inside angles", i.e. angles greater than 180 degrees. In this case, the inscribed circle is tangent to the infinite projections of the two vectors. This angle is shown in Fig. 36e at vertex (3,3).

COLLINEAR VERTEX CASE

A vertex is collinear when the angle between the vectors is 180 degrees. In this case, the vertex is not a significant feature and can be dealt with by deleting it from the vertex list forming the perimeter. The collinear vertex is shown in FIG. 36f.

COINCIDENT POINT CASE

Two vertices that are coincident are also redundant. One of them is deleted from the vertex list of the perimeter. The angle is indeterminate until there is only one vertex at that coordinate. The coincident point is shown in FIG. 36g at vertex (4,1).

INVASIVE ANGLE CASE

When the angle is greater than 180 degrees, it is an "inside angle" and the circle must be inscribed along the projections of the vectors. An angle that is additionally greater than 270 degrees is termed an "invasive angle" because it cuts into the perimeter.

There is no significant distortion induced by this feature. However, the laser beam will overlap itself to an increasing degree as the angle approachs 360 degrees. At the boundary case of 0 degrees, the laser beam will trace inward and outward, with no effect on the perimeter at all. The invasive vertex is shown on FIG. 36h vertex (4,2).

COMPLEX POLYGON CASE

The complex perimeter will likely contain an assortment of the above enumerated cases. An additional possibility exists that cure compensation will move a perimeter segment to cross over an adjacent segment. Such is very nearly the case in FIG. 36i near vertex (1,1).

Such a case must be regarded as an ill defined part, but could be dealt with using more advanced techniques beyond the scope of the algorithm presented in this application.

WALLS

So far, only outer perimeters which are reduced have been considered. Inner perimeters are encountered as the boundaries of holes, or as the insides of walls. Inner perimeters must be compensated by expansion, as shown in FIG. 36j.

The distinction between inner and outer perimeters can be made in several ways. In this particular model, the convention is adopted that outer perimeters shall have their vertices ordered in a clockwise manner, and inner perimeters counterclockwise. Another mathematically sound method is to use a negative beam radius for inner perimeters. The type of a perimeter can additionally be determined by comparing the vector normals to a known orientation at the start; this is the method used in SLICE cure compensation.

ADJOINING OUTER PERIMETERS

Cure compensation may have some structural effects on a part. Consider a layer in a part in which there are three adjacent triangles that form a hole in the center as shown in FIG. 36k and 36e. The key structural point is that the triangles abut each other. After cure compensation, the triangles are reduced, since they are each outer perimeters, so that they no longer touch one another. This will affect the three dimensional structural qualities of the part.

It is not possible for a two-dimensional compensation algorithm such as that presented here to correct for these types of structural cases. This may be a topic for future research. Currently, these types of cases will require user intervention.

FIGS. 37a and 37b illustrate the mathematical basis and derivations for cure compensation.

When parts are built using stereolithography, resin is cured by exposing its surface with a laser that traces the appropriate pattern by use of many straight variable length line segments (vectors). These vectors serve different purposes: some are used to create skin, some to create boundaries, some to create internal structure (cross-hatch), etc. The vectors that can occur on a particular layer are divided into 14 types, called blocks. These fourteen blocks are significant for part building when using STYLE 1; if another style is used, the number of blocks and their types will probably change. The fourteen types are:

| Type | Label | Full name | Styles used on |
|---|---|---|---|
| 1 | LB | Layer boundary | 1, 2, 3, 4 |
| 2 | LH | Layer cross-hatch | 1, 2, 3, 4 |
| 3 | NFDB | Near-flat down-facing skin boundary | 1, 2, 3, 4 |
| 4 | NFDH | Near-flat down-facing skin cross-hatch | 1 |

(continued)

| Type | Label | Full name | Styles used on |
|---|---|---|---|
| 5 | NFDF | Near-flat down-facing skin fill | 1, 2, 3, 4 |
| 6 | NFUB | Near-flat up-facing skin boundary | 1, 2, 3, 4 |
| 7 | NFUH | Near-flat up-facing skin cross-hatch | 2 |
| 8 | NFUF | Near-flat up-facing skin fill | 1, 2, 3, 4 |
| 9 | FDB | Flat down-facing skin boundary | 1, 2, 3, 4 |
| 10 | FDH | Flat down-facing skin cross-hatch | 2 |
| 11 | FDF | Flat down-facing skin fill | 1, 2, 3, 4 |
| 12 | FUB | Flat up-facing skin boundary | 1, 2, 3, 4 |
| 13 | FUH | Flat up-facing skin cross-hatch | 2 |
| 14 | FUF | Flat up-facing skin fill | 1, 2, 3, 4 |

Each of the 5 boundaries could have corresponding hatch and fill vectors. The reason some of these hatch and fill blocks are not included in some styles are because they are redundant or at least unnecessary when the above blocks are used. All these vector blocks, along with the ones that aren't included, are discussed in more detail in the sections above that discuss part building styles.

To build good parts, it is not only required that the above vectors be drawn with certain curing requirements, but also that they be drawn in a particular order. The required drawing order is actually the order of the blocks in the list above. This drawing order is required to minimize curl, and/or to minimize birdnesting, and/or to insure that vectors that are drawn do not affect the curing of vectors that will be drawn afterwards, etc.

The easiest way to insure that vectors are drawn in the right order is to have SLICE output the blocks in the proper order. The above order is used for the SLICE output file with regard to each layer. The ordering of layers in the output file is done from lowest to highest. If a given object is not continuous in the vertical direction (the gaps will be filled in by other objects that will be built at the same time), SLICE will include layer header information for the missing layers in the output file. The layer header information is supplied for all layers. It is included as a fifteenth block which is labelled "L" followed by a number indicating the scale bit spacing in the vertical dimension from which the vector blocks were derived.

An example of one embodiment of a commercial system, provided by 3D Systems, Inc. of Valencia, California, embodying the present invention, is illustrated and described by the enclosed appendices, wherein Appendix A is a users manual and a systems manual describing the overall system for an early Model SLA-1 Beta Site Stereolithography System, including installation and operation, Appendix B is the first draft of the SLA-1 Software Manual together with a manual addendum for use with this earlier system, Appendix C is a listing of software version 2.62 for running an earlier stereolithography system, Appendix D is a Training Manual for a more recent version of the Model SLA-1 Stereolithography System, Appendix E is a list of non-3D Systems software vendors for a more recent version of the Model SLA-1 Stereolithography System, Appendix F is a listing of software version 3.03 for running a more recent stereolithography system, Appendix G is a "Slice" Flow Chart Implementing STYLE 1, Appendix H is a "Slice" Flow Chart Implementing STYLE 2, Appendix I is a Stereolithography CAD/CAM Interface Specification for enabling a suitable interface between CAD/CAM equipment and the Model SLA-1 Stereolithography System, Appendix J is a program listing for producing a quarter cylinder, and Appendix K is a listing of software version 3.20 for running an even more recent version of the stereolithography system.

A second working embodiment of a commercial stereolithography system provided by 3D Systems, Inc. will now be described. This embodiment is similar to the first embodiment described above.

The major feature of this embodiment is that the program used to convert the CAD/CAM data into vectors, which is known as SLICE, has been updated. In the first embodiment described above, the version of SLICE described is version 3.03. In the second commercial working embodiment, to be described in more detail below, the version of SLICE is version 3.20. For completeness, a software listing of SLICE version 3.20 has been added to the subject application as Appendix K, and, as indicated at the outset. Version 3.20 differs from version 3.03 primarily in the area of beam width compensation, which is a technique for making adjustments to the positioning of the vectors to account for the size of the beam width, which can range from 7-20 mils. If the width of the beam is not accounted for, the final cured part will be distorted from the original by as much as 1 full beam width, i.e. 7-20 mils. Version 3.03 does provide for beam width compensation, but version 3.20 provides several improvements in this area such as improvements in ordering vectors, recalculating segment normals, and combining overlapping vectors in such a way to improve the beam width compensation process.

Another feature, not present even in SLICE version 3.20, but to be added in future versions of SLICE is the ability to create border vectors directly on the slicing layers as opposed to 1 bit above as required by STYLE 1. This will have the benefit of simplifying the STYLE 3 and STYLE 4 algorithms (to make undersized parts). At present, these algorithms have not been implemented in SLICE version 3.20, but creating border vectors on the slicing layers will simplify the STYLE 3 and 4 algorithms to the extent that they can be much more easily implemented. This feature will be discussed in greater detail further on.

As discussed more fully in the body of this application, stereolithography is the process of creating a three-dimensional representation of an object by successively curing two-dimensional cross-sections (but with some finite thickness on the order of mils) on the surface of a liquid photopolymer, such that the cross-sections adhere to one another in a laminar buildup to reproduce the object.

A block diagram of the embodiment described herein is set forth in Figure 8. As indicated in the figure, the major components of the system include laser 1 optics, 2, dynamic mirrors 3, Z-stage elevator 4, SLICE computer 5, PROCESS computer 6, vat 7, elevator driver 8, and dynamic mirror driver 9. As indicated in the figure, the SLICE computer is electrically coupled to the PROCESS computer, which in turn is electrically coupled to the Z-stage elevator and the dynamic mirror through the elevator driver and dynamic mirror driver, respectively. When the system is in operation, the laser is continuously on and emitting a laser light beam. As indicated, the laser beam is directed through the optics, which first expands and then focuses the beam, and also directs the beam to the dynamic mirrors, which in turn, direct the beam to a specific location on the surface of a liquid photopolymer resin placed in the vat.

The SLICE computer is electrically coupled to a CAD/CAM system (not shown). CAD/CAM data descriptive of a three-dimensional object is created on the CAD/CAM system, and then transferred to the SLICE computer. The SLICE computer converts the CAD/CAM data into a database of vectors, which are used to direct the movement of the laser beam on the surface of the photopolymer in the vat. A vector consists of 2 endpoints and a direction, and the directed laser beam will move from one endpoint to another on the surface of the photopolymer in the direction indicted by the vector.

The PROCESS computer is electrically coupled to the SLICE computer. After the SLICE computer has converted the CAD/CAM data into vectors, the SLICE computer transfers the vectors to the PROCESS computer, after which the PROCESS computer can manipulate the data and then begin the photopolymerization process.

The.PROCESS computer is electrically coupled to the Z-stage elevator and to the dynamic mirrors, and controls the two simultaneously by means of the vector data. More specifically, for each two-dimensional cross-section, the PROCESS computer, by means of the dynamic mirrors, will direct the laser beam to move across the surface of the photopolymer according to the vectors associated with that two-dimensional cross-section. As a result, the surface of the photopolymer will cure to form a two-dimensional cross-section (of finite thickness relating to the layer thickness desired).

The laser beam will not move across the surface in a continuous fashion however. Instead, it will be directed to successively step a certain distance, and then wait a certain amount, which distance and amount are programmable, and hence controllable by a user. These values will be used by the PROCESS computer in controlling the dynamic mirrors. Specifically, the PROCESS computer will cause the dynamic mirrors to rotate by a particular angular increment so that the beam sweeps out the predetermined step size on the surface of the photopolymer. Then, the PROCESS computer will wait the predetermined amount before causing the dynamic mirrors to once again change position.

After a particular cross-section is created, the PROCESS computer directs the Z-stage elevator to dip a certain amount into the vat of photopolymer so that liquid photopolymer will spread over the surface of the cured cross-section in preparation for the curing of the next cross-section.

The thickness of a cured layer is controllable by the user, and in general, the PROCESS computer will direct the elevator to lower itself sufficiently in the vat so that enough liquid polymer to form a cured layer at the desired layer thickness will move over the already-cured layers.

However, because the photopolymers are, in general, of moderate viscosity, the elevator will initially generally dip the previously created layer below the surface of the photopolymer at greater than the layer thickness so that the polymer will flow over the part at a fast rate. Then, the part will be raised to the desired level so that the excess liquid polymer will flow off the part, and so that the remaining polymer will have the desired layer thickness.

A more detailed diagram of the optics 2 and dynamic mirrors 3 is shown in Figure 9. As indicated, optics 2 comprises 90-degree mirrors 201 and 203, which direct the laser beam through beam expander 202, and to the dynamic mirrors 3. The beam expander first expands and then focuses the laser beam. The expanding step is necessary to enable the beam to be focused to a smaller diameter during the focusing step than would otherwise be the case if the beam were left unexpanded.

The dynamic mirrors comprise an X-mirror, and a separate Y-mirror. The X-mirror is rotatable about an axis for directing the laser beam to span the surface of the liquid polymer in the X-direction. The Y-mirror is rotatable about an orthogonal axis for directing the laser beam to span the surface of the liquid polymer in the Y-direction. The degree of rotation of these mirrors is controlled by the PROCESS computer.

The dynamic mirrors are advantageously P/N E00-Z2173 XY0507 scanning mirrors manufactured by General Scanning, Inc. (Watertown, Massachusetts) coupled to a P/N EOO-DX2005 controller for the XY0507 scanning mirrors. The mirror driver is advantageously an I/O board manufactured by Tarnz Technologies (Los Angeles, California).

The Z-stage elevator advantageously comprises P/N 008-0324-3, a 14 inch linear table with 5 pitch, manufactured by Daedal (Harrison City, Pennsylvania) and available through Pacific Technical Products (Sylmar, California). The elevator driver also advantageously comprises P/N MC5000-20, a motor control and motor drive for the linear table, and a standard computer I/O board to interface between computer operated software and the motor control and drive.

The PROCESS computer is advantageously a Wyse 286, Model 2200, manufactured by Wyse Technology, San Jose, California, including a 40 MByte hard disc, and "AT" style keyboard, a monitor, graphics card, math coprocessor, and an Ethernet card, which card is manufactured by Excelan or Micom. The Wyse 286 is similar to an IBM AT, and is a 16 bit, 10 MHZ computer on which the MS-DOS operating system, version 3.21 (or earlier versions) from Wyse Technology is run. For file management assistance, Q-DOS II, version 2.00 from Gazelle Systems, Provo, Utah, is used. Additional software which is advantageously available on the PROCESS computer includes FTP Software, FTP Software PC/TCP File Transfer Program Version 1.16, or FTP Software PC/TCP Telnet Version 1.16, both available from MICOM-Interlan, Inc., Boxborough, Massachusetts. Additional software includes Ethernet Software from Exelan.

The SLICE computer is advantageously the NEC Power-mate 386 computer, a 32 bit microprocessor, manufactured by NEC Information Systems, Inc., Boxborough, Massachusetts, and available from Peripheral Systems, Inc., Van Nuys, California. The particular operating system is the 386/ix operating system, UNIX System V Release 1.0.4 80386. Additional software includes TCP Ethernet Support, Micom version. Both the UNIX operating system and the Ethernet support software are available from Interactive Systems Corporation, Santa Monica, California. Advantageously, the SLICE computer also contains an 85 megabyte hard disk.

A diagram of the software architecture of the stereolithography system is shown in Figure 33. The figure includes some of the components shown in Figure 8, and the identifying numerals for these components have been kept the same. As illustrated, the software is distributed between the SLICE computer and the PROCESS computer. Additional software is resident on, and executed by, the z-stage elevator driver 8 (labelled as "z-stage" in Fig. 33), and by the mirror driver 9 (labelled as "DX" in Fig. 33). Also shown in the figure is software which is resident on and executed by the CAD/CAM system, which system is external to the stereolithography system. This software is only described here for the purpose of providing a complete software overview, and is the responsibility of the CAD/CAM system.

As indicated, the software architecture comprises the following software programs, which programs are listed below along with their identifying numerals, and the computer on which the software is resident:

| Program | Resident Computer |
|---|---|
| CAD/SLA Interface Program 100 | CAD Computer |
| SLICE 3.03 (3.20 in the second embodiment) 101 | SLICE COMPUTER |
| SLICE (UI) 102 | SLICE Computer |
| MERGE 103 | PROCESS Computer |
| MATERIAL 104 | PROCESS Computer |
| PREPARE 105 | PROCESS Computer |
| BEAM 106 | PROCESS Computer |
| CALOUT 107 | PROCESS Computer |
| BUILD 108 | PROCESS Computer |
| STEREO 109 | PROCESS Computer |
| LASER 110 | PROCESS Computer |
| BASIC 111 | PROCESS Computer |
| CLIFF 112 | PROCESS Computer |

As indicated in the figure, each of the above programs executes in conjunction with one or more data bases or files. A summary of the functions performed by each of these programs will be provided below:

<u>CAD/SLA INTERFACE PROGRAM</u>

This program is resident on a CAD/CAM computer. The CAD system database, embodies a CAD/CAM modelling capability, enabling a user to specify or define a three-dimensional object. Once the design of the object is completed, this program outputs the Object.STL data file, containing data descriptive of the surface of a three-dimensional object.

The Object.STL file must be placed in a certain format in order for it to conform to the requirements of the software of the stereolithography system resident on the SLICE and PROCESS computers. The responsibility of placing the Object.STL file in the correct format lies outside the stereolithography system, and is in fact, the responsibility of the CAD system.

Although other representations are possible, as illustrated in FIG. 11, the surface of any three-dimensional object can be divided up into a series of triangles. The stereolithography system requires that the surface be defined in terms of triangles which meet two requirements: 1) the triangles must completely and singly span the surface; and 2) that the vertex of a triangles only meet adjacent triangles at their vertices, and not at the line segments connecting the vertices. These requirements result in computational efficiency.

The resolution with which the triangular description of the surface matches the actual surface depends on the number of triangles used to define the surface. The greater the number of triangles used, the finer the resolution. At present, the system allows a surface to be defined with up to 14,000 triangles.

In general, the triangle of a surface can be defined in terms of vectors. As discussed earlier in the application, a vector is a line segment having two endpoints and a direction. One endpoint is the tail, the other is the head, and the direction is from the tail endpoint to the head endpoint. As illustrated in FIG. 38, it requires three vectors to define the perimeter of a triangle. The three vectors required to define the triangle of FIG. 38 are denoted as vectors 300, 301, and 302, respectively. The tail points of vectors 300-302 are denoted as 304, 305, and 306 respectively, and the heads are denoted as 305, 306 and 304, respectively.

However, a surface triangle has a particular orientation with respect to the surface it is bounding, and a fourth vector known as the triangle normal vector is required to indicate this orientation. As illustrated in FIG. 38, the triangle normal is always directed away from the solid which the triangle bounds. The triangle normal of the triangle of FIG. 38 is denoted as 303.

A requirement of the Object.STL file is that the vectors of the triangle obey a certain relationship with respect to each other known as the right hand rule. This rule requires that the three vectors making up the surface of the triangle, 301-302, be oriented so that the head of one vector ends at the tail of another. In addition, the rule requires that when the vectors are oriented to define a counter-clockwise loop, that the triangle normal be pointed in the direction which the thumb of the right hand would point if the fingers of the right hand were curled in the counter-clockwise direction. This relationship is satisfied by the triangle of FIG. 38.

In this embodiment of the subject invention, the particular format chose for the Object.STL file is illustrated in FIG. 39. As illustrated, only the endpoints at the head of the four vectors are provided, first the endpoint of the triangle normal, followed by the endpoints of the vectors which span the perimeter. The endpoints of the heads are sufficient since the vectors are assumed to be lined up end to end, and the tail endpoints of one vector will be the head endpoint of another. In addition, the endpoints are assumed to be ordered according to the right hand rule previously described. Finally, only the endpoint of the triangle normal, which is assumed to have a unity length, is provided since it will alone contain enough information to define the orientation of the triangle with respect to the solid.

<u>SLICE 3.03 (SLICE 3.20)</u>

This program converts the object.STL file into a series of vectors for directing the movement of the laser beam across the surface of the photopolymer. A raster-based sweep of the laser across the surface of the photopolymer is also possible, but a vector-based approach is preferable. This is because, in a raster-based approach, the laser beam is required to sweep the entire area of the surface of the polymer, causing in some instances partial curing of unwanted areas. A vector-based approach provides better control. A raster-based approach is possible but it requires a rapid ability to keep the beam from curing unwanted areas, and also requires the ability to provide a high enough intensity image at the liquid surface.

To execute SLICE, a user first executes the related program SLICE (UI), which is a user interface program, for obtaining values of certain parameters to use in executing SLICE. SLICE (UI) will interact with the user to obtain values for these parameters, and output the values to the file Object.UII, indicated as 202 in Figure 33.

Figure 44 lists the parameters which SLICE (UI) prompts the user for. As discussed in the body of this application, SLICE takes the Object.STL file, and uses it to create vectors for each two-dimensional cross-section of the object which will be formed at the surface of the photopolymer.

At present, for each layer, SLICE creates 11 different types of vectors to define that cross section. These 11 vector types along with their method of creation and placement define what is known as STYLE 1. STYLE 1 is a particular method of processing 3 dimensional triangle surface data into 2 dimensional vector data so that when a part is built it will approximate the original CAD design in a consistent and accurate manner irregardless of the specific part geometry. STYLE 1 consistently over-sizes the XY dimensions of a part in as accurate a manner as possible when layering of a finite thickness is used to construct a part. STYLE 1 is discussed more deeply at another point in this disclosure. These vector types are listed below:

| Type | Label | Full Name |
|---|---|---|
| 1 | LB | Layer boundary |
| 2 | LH | Layer crosshatch |
| 3 | NFDB | Near-flat down-facing skin boundary |
| 4 | NFDH | Near-flat down-facing skin crosshatch |
| 5 | NFUB | Near-flat up-facing skin boundary |
| 6 | FB | Flat down-facing skin boundary |
| 7 | FDF | Flat down-facing skin fill |
| 8 | NFDF | Near-flat down-facing skin fill |
| 9 | NFUF | Near-flat up-facing skin fill |
| 10 | FUB | Flat up-facing skin boundary |
| 11 | FUF | Flat up-facing skin fill |

As discussed in more detail in the body of this application, the boundary vectors define the exterior boundaries of the cross-section, while the skin or hatch vectors define the interior part of the cross-section.

At present, the interior portion of a cross-section can either be a skin or a cross-hatch or both. The interior portion will contain skin if the cross-section represents an outer surface of the three-dimensional object, and will only contain hatch if the cross-section represents only an interior section of the object. These principles are illustrated in Figure 40, which illustrates a skinned cross-section representing the top of a cylinder (later hatch and later boundary also present but not shown), and a hatched cross-section representing an interior section of the cylinder.

As illustrated in the Figure, the interior of cross-section 307 representing the top of the cylinder is represented by a series of parallel lines. These are called skin vectors. The interior of cross-section 308 is represented by a series of criss-crossing parallel lines. These are called hatch vectors.

As discussed earlier, each vector has a direction and a length associated with it. Each vector represents the movement of the laser beam across the surface of the photopolymer which will cause curing of the photopolymer at the vector location. Skin vectors are spaced close to one another so that there will be no gaps between the cured lines which will result after the laser has traversed the vector. Gaps between the lines represent uncured polymer, which would drain from a cured cross-section. As a result, if the vectors had large spaces between them, the cured cross-section would not be a good representation of the top of the cylinder. As a result, skin vectors are generally placed close to one another.

Cross-hatch vectors, on the other hand, can be spaced apart from one another. This is because these vectors are used to create interior cross-sections to a part, and it does not matter whether liquid polymer can drain through gaps in the cured lines, since it will be trapped by the skinned areas anyway. It is only necessary to have close enough spacing to provide structural support inside the object.

Note that liquid polymer will remain inside of an object after all the cross-sections have been formed if skin fill is chosen appropriately. This liquid resin will be cured during the post-curing steps described in U.S. Patent Application Serial Nos. 183,016, 183,014, and 183,012, which were filed on April 18, 1988, and in their CIPS, respectively, Serial Nos. 268,429; 268,408: and 264,428, filed on November 28, 1988. This cured resin will provide additional structural support for the object.

Cross-sections 307 and 308 are shown in more detail in Figure 41, which makes the vector directions more clear. Note that the boundaries of each of these cross-sections will be defined in terms of vectors also, and this as well is indicated in the Figure.

Cross-section 307, for example, is comprised of border vectors 309 and skin vectors 310. Cross-section 308, on the other hand, is comprised of border vectors 311, and cross-hatch vectors 312 and 313. Cross-hatch vectors 312 represent vectors which are parallel to the Y direction, while cross-hatch vectors 313 represent vectors which are parallel to the X direction. In the terminology of the 11 vector-types listed above, vectors 311 are layer boundary (LB) vectors, vectors 312 and 313 are layer crosshatch (LH) vectors, vectors 309 are flat up-facing skin boundary (FUB) vectors, and vectors 310 are flat up-facing skin fill (FUF) vectors. (Strictly speaking, cross-section 307 also contains LB and LH vectors to provide structural support, but those have been omitted for the sake of clarity in this discussion.)

The rest of the vector types will be explained with reference to Figure 42. As illustrated, cross-section 309 is the bottom section of the object that is illustrated in the Figure, while cross-section 310 is the top-most portion of the object.

Cross-section 309 is illustrated in more detail in Figure 43a. In the terminology of the 11 vector types discussed above, the cross-section comprises flat down-facing skin boundary (FDB) vectors 311, and flat down-facing skill fill (FDF) vectors 312.

Cross-section 310 is illustrated in more detail in Figure 43b. Note that cross-section 310 represents a slanted portion of the object of Figure 42. The problem with representing a slanted surface is that it cannot be represented by one cross-section, but must, instead, be represented by a series of cross-sections which stacked together approximate the slanted surface. This is illustrated in Figure 42, which shows cross-section 310 as really being made up of cross-sections 310(A), 310(B), 310(C), 310(D), and 310(E).

The vector representation of these cross-sections is shown in Figure 43b. In the terminology of the 11 vector types, cross-section 310(A), for example, is comprised of near-flat up-facing skin boundary (NFUB) vectors 313(A), and near-flat up-facing skin fill (NFUF) vectors 314(A). The rest of the cross-sections 310(B), 310(C), 310(D), and 310 (E), are made up of the same vector types (the cross-sections also contain LB and LH vectors, but this is being de-emphasized for the purposes of explanation).

It should be emphasized that the vectors for each of the cross-sections 310(A)-310(E) will not be drawn at the same time. This is because these vectors will be associated with different cross-sections. Instead, the vectors will be drawn in the following order: 310(E), 310(D), 310(C), 310(B), and 310(A).

Near-flat down-facing skin boundary (NFDB) and near-flat down-facing skin fill (NFDF) vectors are analogous to NFUB and NFUF vectors, respectively, except that they pertain to down-facing areas instead of up-facing areas.

It turns out that skin vectors, besides their close spacing, have another difference with the hatch and boundary vectors. In the usual instance, the laser beam will expose the area of a hatch or boundary area sufficiently to create a cure depth of approximately 26 mil. This corresponds to dividing up an object into 20 mil cross-sections, and curing the layers so that they cure 6 mils into each other. The 6 mil curing results in the cross-sections being adhered to one another, and the vectors at which this adherence occurs are the hatch and boundary vectors from adjacent cross-sections.

The skin vectors, however, are in the usual instance, cured to a much lower depth, typically 5-20 mils. This is because the laser head is directed to move much faster over the areas represented by the skin vectors. As a result, there will be less cure depth. Different cure depths are possible because, cure depth is based on a quantity of light being absorbed and therefore the beam being attenuated as the light penetrates deeper into the resin. At some point the quantity of light becomes too low to initiate sufficient polymerization to convert the resin from its liquid state to a state of gelled plastic. This quantity of light is considered the critical exposure. Below the level of critical exposure, solid material is not formed thereby limiting the cure depth obtained from a given exposure of light. Exposure is proportional to the intensity of the beam and is inversely proportional to the velocity of travel of the beam. The reason skin vectors are given much lower exposure than hatch and boundary is because skin vectors (and therefore plastic created by them) are not required for adhering layers together.

Near-flat down-facing areas are represented by border vectors which surround skin vectors. Near-flat down-facing hatch vectors (NFDH) span near-flat down-facing skin boundaries analogous to LB and LH. Use of STYLE 1 requires creation of near-flat down-facing cross-hatch vectors, because near-flat down-facing fill is the only type that does not have any layer hatch to support it. Since skin is made relatively weak, it requires support to give it strength. NFDH is also required to give the near-flat down-facing skin area the proper depth (and uniformity) thereby securing proper dimensioning of the part. Other vectors types are, however possible.

SLICE (UI) enables a user to specify the parameters indicated in Figure 44a. As indicated, the following parameters can be varied:

Resolution
Layer thickness
X hatch spacing
Y hatch spacing
60/120 degree hatch spacing
X skin fill spacing
Y skin fill spacing
Minimum surface angle (MSA)
Minimum intersect angle (MIA)

Other parameters can also be specified but are not shown in the interface menu. The most important of these parameters are 1) the specification of which axis is to be considered the SLICE axis, in other words the vertical axis for part building, -X, -Y, -Z are the options with Z being the default axis. The other two axes form the layers XY, XZ, YZ, and 2) the specification as to what the effective beam width is and therefore what the 1/2 beam width is for beam width compensation.

The resolution is used to translate between the units used by the user on the CAD computer, in which units the Object.STL file is defined, and the units used by the SLICE and PROCESS computers to create the vector data. In Figure 40, for example, assuming the unit of measurement on the CAD system is inches, the specified resolution of 1000 indicates that 1000 SLICE units corresponds to one CAD unit. In other words, the SLICE unit is 1 mil.

The layer thickness is the thickness between successive cross-sections in the created part. This parameter is used to lower the elevator appropriately at successive stages of the curing process. Note that the cure depth need not correspond to the layer thickness. In fact, as indicated earlier, the cure depth can be 26 mils with a layer thickness of 20 mil, and a layer overlap of 6 mils. The layer thickness need not be the same for an entire part but can vary from layer to layer.

As indicated in the body of the application, hatch vectors can be oriented in the X-direction, the Y-direction, or both, and along lines at 60° to the X-axis and along lines at 120° to the X-axis (60/120 degree). The X hatch spacing, the Y hatch spacing, and the 60/120 degree hatch spacing specify the spacing between these vectors. In the example of Figure 40, the X, Y, and 60/120 degree hatch spacing respectively is 40, 40 and 0 mils, indicating that X and Y hatching is turned on, while 60/120 degree hatching is turned off.

Note that SLICE first creates the border vectors for a particular cross-section, and then generates the hatch or skin vectors to define the interior of the cross-section. The border vectors are created from the surface triangles used to define the surface of the object and their intersection with the particular cross-section being analyzed by SLICE. The hatch vectors are then created, one row at a time, which rows begin and end at a border vector spanning a cross-section. The hatch spacing values are used by SLICE in the process of generating the hatch vectors to successively space one row of hatch vectors from an adjacent row.

Skin vectors can be created in either the X or the Y direction. Simultaneous X and Y skin vectors, and 60/120 degree skin vectors are not generally used because of the distortion which results. A major source of distortion is due to the shrink that occurs when a vector is being drawn (fresh plastic being formed) which at the same time is attaching to already partially polymerized plastic. This is an especially dominant mode of distortion when long vectors are created adjacent to or on top of already existing long lines of plastic. The amount of shrink is proportional to the amount of polymerization, so at this stage, the greater the amount of polymerization that occurs on a layer the greater the shrink and the greater the likelihood of distortion. Therefore, if an entire layer is skinned by one type of vector then passed over again a second time for additional curing, the entire second pass is bonding newly created plastic to previously created plastic which can result in a great deal of distortion. However, it should also be noted that proper application of multiple passes on a single level whose net result is the desired cure depth can lead to less distortion under appropriate circumstances. Additionally the second skin type is generally not needed because the first skin entirely surfaces the part anyway. The X and Y skin fill spacing defines the spacing between the X and Y vectors respectively. As with the hatch vectors, these parameters are used by SLICE to generate the skin vectors from the border vectors.

As described in the body of the application, the MSA parameter is read by SLICE to detect the presence of a near-flat area, and the MIA parameter is also used by SLICE to generate hatch vectors which are as close as possible to being perpendicular to the border vectors, a requirement in some cases for lower distortion.

As indicated on p. 3.5-16 of the Training Manual attached as Appendix D, the correct MSA depends on the layer thickness chosen. The correct MSA for different layer thicknesses is as follows:

| Layer thickness | MSA |
|---|---|
| 5 mils | 40 |
| 10 mils | 50 |
| 15 mils | 55 |
| 20 mils | 60 |

The MSA values versus later thickness in the above table are only general recommendations. The above table gives reasonable values for MSA based on the need to entirely surface the object as it is being created, along with assumptions about beam focus. In this sense, the required MSA is machine dependent (being based on beam cure depth to cure width comparisons). There is an additional consideration in selecting MSA that is not considered in this table. Down-facing near-flat skin vectors are required to create not only good surfaces but also to form a portion of the parts superstructure. When this superstructure consideration is made, the MSA for all later thicknesses approaches 90° irregardless of beam cure properties.

The output of SLICE 3.20 is placed in the Object.SLI file. The Object.SLI file will consist of data describing the vectors associated with each cross-section. As indicated earlier, there are 11 different vector types, so that for each cross-section, there can in general be 11 different groups of data which correspond to the different vector types.

Figure 44b illustrates the format of the Object.SLI file. As indicated, the file is organized by a value of "L", which value represents a particular cross section. For each cross section, and for each vector type, the file contains the endpoints of vectors of that vector type. An example from Figure 44 is shown below:

| | | | | |
|---|---|---|---|---|
| L | 740 | | | |
| LB | 250 | 8750 | 8750 | 8750 |
| | 8750 | 8750 | 8750 | 250 |
| | 8750 | 250 | 250 | 250 |
| | 250 | 250 | 250 | 250 |

This example indicates that for a cross section 740 mils above an origin, the laser beam will draw 4 layer border vectors having the following endpoints:

(250,250) → (8750,8750)
(8750,8750) → (8750,250)
(8750,250) → (250,250)
(250,250) → (250,8750)

In other words, the laser beam will be directed to draw a box.

In summary, the output of SLICE is a file containing vectors for use in directing the laser beam to traverse the surface of a liquid polymer to cure a cross-section of an object, and the vectors in the output file are organized according to the cross-sections to which they pertain.

MERGE

The MERGE program merges Object.SLI files from one or more objects. This program enables different Object.STL files to be converted to vector data (i.e., "SLICED") independently of one another, and then merged before the laser is directed to traverse the vectors on the surface of the photopolymer. This enables the different .STL files to be converted using different parameters for each. In addition, because of limitations in the CAD system, it may be necessary to divide up a single object into many different subsections, convert each independently, and then merge them to recreate the single part.

Finally, a user may wish to create .STL files for objects that overlap in space, such as a teacup, and the handle of the teacup, which handle is partially embedded in the surface of the teacup. If the files were merged before SLICE, a fundamental requirement for .STL files will be broken: this is the requirement that the triangle of an .STL file completely surface an object. If this file were merged, some of the triangles would be inside the object.

MERGE creates the Object.V file, which contains the vectors from all the merged OBJECT.SLI files.

Object.V is first organized by cross-section, and within a cross-section, the file is organized by object, and within an object, the file is organized by vector type. For each cross-section, object, and vector type combination, the file lists the endpoints of all the vectors of that type.

The format of Object.V is illustrated in Figure 45. This file only contains the vectors for a single object. As indicated, the format is identical as that in Figure 44, except that the vector types have a "1" appended to them indicating they correspond to the first (and only) object. If other objects were involved, the file would contain a listing of all the vector types by cross-section associated with the second object, which vector types will be placed after all the vector types associated with the first object.

MERGE also creates the Object.L and object .R files, which are used to control, for each cross section, the speed with which the vectors are drawn, and manner in which the elevator dips the cross-sections into the liquid photopolymer after it has been cured in preparation for curing the next cross-section. Either the Object.L file, or the Object.R file, but not both, can be used to control these parameters.

The Object.L file enables a user to specify different curing parameters for each object, cross-section, vector type combination on a cross-section by cross-section basis. In addition, a user can specify different dipping parameters for a particular cross-section. Therefore, by way of example, for a merged file of 4 objects, with 11 vector types, the Object.L file enables a user to specify 44 different cure parameters for a given cross-section, and different dipping parameters for each cross-section. In other words, Object.L provides layer by layer control of the curing process.

The Object.R file is designed for those applications where the flexibility allowed by Object.L is not needed. Object.R, instead of providing layer by layer control, provides control on a range by range basis, where a range is defined as any number of cross-sections. (A cross-section is the same as a layer.)

The primary dipping parameters which can be specified in the Object.L file or (other parameters can exist for specialized equipment the Object.R file is are follows:

| Parameter | Interpretation |
|---|---|
| ZA | Acceleration |
| ZV | Maximum velocity |
| ZW | Wait |
| ZD | Distance |

These parameters are used to control the elevator after a particular cross-section is cured. ZA is the amount by which the PROCESS computer causes the elevator to accelerate, and ZV is the maximum velocity which the elevator will be allowed to achieve. It will maintain this velocity until the software determines that it is time to begin deceleration resulting in the elevator coming to rest at the desired position. ZA is specified in terms of rev/sec$^2$, and ZV is specified in terms of rev/sec. Since a 5 pitch elevator is used, and 5 revolutions = 1 inch, these numbers can be converted to more traditional values of inch/sec$^2$ or inches/sec. These values are sent by the PROCESS computer to the stepper motor which controls the elevator.

ZD is specified in millimeters, and specifies the distance the elevator is caused to initially dip into the photopolymer. This value will be much greater than the layer thickness, which is typically specified in terms of mils. After the initial dipping, the elevator will be directed to move back up. so that the surface of the cured photopolymer on the elevator will be 1 layer thickness below the surface of the photopolymer.

The value ZW is specified in seconds, and is the amount by which the PROCESS computer waits (including the time required to dip down and up) before beginning the curing process for the those layer. The value should be chosen to be sufficient to allow excess liquid photopolymer to run off through a process known as gravity leveling.

The most important curing parameters are as follows:

| Parameter | Interpretation |
|---|---|
| SP | Step period |
| SS | Step size |
| JD | Jump delay |

The value of SP will be defined in units of 10 microseconds, and is the amount of time the PROCESS computer causes the laser beam to wait after it has traversed a certain step size. The value of SS is in terms of angular movement of the dynamic mirrors, and represents the smallest increment of radial movement of the dynamic mirrors, and hence the smallest step increment of the laser beam on the surface of the photopolymer.

The unit of radial movement of the mirrors is defined in terms of bits, where 3556 bits represents movement of 1 inch. As a result, 1 bit represents approximately .3 mils of movement (near the center of the drawing field). In addition, the dynamic mirrors are each capable of movement up to 64K bits, so that together, the mirrors can cause the laser beam to traverse a two-dimensional area of 64K x 64K bits, which corresponds to a 40° angular displacement along each axis.

The value of SP represents the time it takes for the laser to first traverse the step defined by SS, plus the time the beam is directed to wait after traversing the step. In general, the travel time is very small, and the wait time will dominate.

The value of JD represents the amount by which the laser beam is directed to remain at the tail of a vector it has just jumped to.

Object.L and Object.R will be discussed further following a description of the program PREPARE.

PREPARE

PREPARE is a user interface which helps a user specify the cure and dipping parameters for the Object.R file. To specify parameters in the Object.L file, a standard word processor type line editor is used.

As indicated in FIG. 33, PREPARE takes as input the MATERIAL.LST, MATERIAL.MAT, POWER.LST, PREPARE.PRM, BUILD.PRM Object.L, and Object.R files.

A material file (indicated as MATERIAL.MAT in Figure 33) is a file that, for a given photopolymer, contains sample data relating the laser power and cure depth (and cure width) to various SS and SP values. It is a crucial file used in translating desired cure depth values into SP and SS values.

The MATERIAL.LST file specifies the last material file used. The material file, MATERIAL.MAT, contains data obtained from measurements of a cured polymer structure known as a banjotop. The banjotop is both machine and resin dependent. Eventually the material file will contain only information about a particular resin, whereas the machine dependent variable values will be obtained from beam profile measurements.

The banjotop is a 1 layer thick plastic part with 5 lines of different exposures running across a support frame, as illustrated in Figure 46. As indicated in the figure, banjotop 321 has 5 lines, 322 (A) - (E), running across its face. Each line represents cured polymer obtained by running the laser over the face of the banjotop at a given velocity (which is proportional to exposure). Moving from right to left, each line is given double the exposure of the previous line.

The purpose of the banjotop is to provide empirical measurements of the relationship between exposure and cure depth. Because the liquid photopolymer must absorb ultraviolet light during the curing process, cure depth will be logarithmical related to exposure. That is, if the exposure is multiplied by the factor X, the cure depth will increase by much less than a factor of X. Instead, the cure depth will increase logarithmical.

With the banjotop, each line is obtained by doubling the exposure given to the previous line. According to the logarithmic relationship, however, the cure depth should increase additionally by the same incremental value from layer to layer. In other words, the increment in cure depth from one successive line to the next should be the same.

In Figure 46, for example, banjotop 321 has five strings 322 drawn across it at different exposures. The exposure applied to string 322(B) is twice that applied to string 322(A), the exposure applied to string 322(C) is twice that applied to string 322(B), the exposure applied to string 322(D) is twice that applied to string 322(C), and the exposure applied to string 322(E) is twice that applied to string 322(D).

It turns out, however, that the cure depth between strings 322 does not maintain the same relationship as the exposure between strings. Instead, the cure depth varies by approximately four to six mils from one string to the next. In other words, the change in cure depth of string 322(B) compared to string 322(A), of string 322(C) compared to string 322(B), of string 322(D) compared to 322(C), of string 322(E) compared with string 322(D) are all approximately four to six mils. As mentioned earlier, the relationship is logarithmic, and a plot of log (exposure) vs. cure depth should yield a straight line. This is illustrated by curve 323 in Figure 47.

For convenience in some circumstances, cure width can be plotted as a function of log (exposure) and a useful relationship observed, as illustrated by curve 324 in Figure 47. However this relationship can be misleading since it is not based on exponential attenuation of the beam as is true with cure depth. Cure width is primarily based on beam profile.

The purpose of PREPARE is to enable a user to specify values of SS and SP that can be used in order to achieve a particular cure depth when building a part. Laser exposure is related to SS and SP as follows: for a given stereolithography machine and beam focus laser exposure is proportional to the following value:

$$\frac{\text{laser power (mW) x SP}}{\text{SS}}$$

For a different machine or beam focus, the degree of proportionality may change.

As indicated earlier, SS is an angular movement of the dynamic mirrors. The relationship between SS and the movement of the laser beam across the surface of the liquid photopolymer is illustrated in Figure 48. As shown in the Figure, dynamic mirrors 3 direct laser beam 326 to move to the position indicated as 329. It is assumed that the laser beam at position 326 is perpendicular to the surface of the photopolymer. The radial movement of the mirrors, indicated at 325 in the figure, is measured in terms of bits, and is the SS referenced to above. The radial movement of the laser beam causes the location at which the beam strikes the surface of photopolymer 328 to change. In the Figure, the beam originally strikes location 330 on the surface of the photopolymer, and is caused to move to location 331 by the radial movement of the mirrors. The distance travelled by the laser beam, indicated as 327 in the figure is related to the radial distance 325 as follows: distance 327 is approximately equal to radial distance 325 (measured in radians) multiplied by distance 326. The relationship is however only approximate.

This is because distance 326 multiplied by angular distance 325 actually measures the angular distance 332 which is travelled by the laser beam, not the linear distance 327. It turns out, however, that the two distances will be approximately the same when the perpendicular distance 326 between the dynamic mirrors and the surface of the photopolymer is large. In the particular embodiment described herein, the value of distance 326 is 27 inches.

As mentioned earlier, the value of SS for either the X or the Y dynamic mirrors can range from 0 to 64K bits. This also represents an angular movement of 0 to 40 degrees. As mentioned earlier, the working curve provides the ability for a user to determine what value of laser exposure will achieve a given cure depth or width. The other purpose of PREPARE is to provide the ability for the user to translate between the value of laser exposure required to achieve a certain cure depth and values of SS and SP, which values will be placed into the Object.R file.

The working curve described above, and the relationship between laser exposure and SS and SP is highly dependent on a particular machine, and beam focus. If either one of these changes, the relationship and working curve may change, and it may be necessary to obtain another working curve from a banjotop cured using the new machine or beam focus. In this instance, measurements from the new banjotop will be placed in another MATERIAL.MAT file, and the MATERIAL.LST file updated if appropriate with the name of the new MATERIAL.MAT file.

The working curve is also highly dependent on the particular beam focus, beam profile, and machine. The beam focus is determinative of the beam spot size, and depends on the optics 2 used (see Figure 8).

In general, the optics focus the beam to a width of between 7-20 mil at $1/e^2$ power level. The beam profile is highly dependent on the particular modes produced by the laser 1. As is known, the $TEM_{oo}$ mode is relatively gaussian, having no nodes or zeroes across its face, while other nodes, such as the $TEM_{10}$ mode, will have nodes or zeroes running across their face. Advantageously, the laser is multi-mode, since it will be too wasteful of input power to try to discriminate between modes. If the optics or the laser is changed, however, the working curve may have to be recalculated.

Finally, the working curve is highly dependent on the particular photopolymer used. If this changes, the working curve will have to be recalculated.

In the particular embodiment described herein, the value of SS for hatch and boundary vectors is advantageously 2, (approximately .6 mil) and for fill vectors, the value of SS is advantageously 16 (approximately 4.8 mil).

A value of 2 for SS corresponds to a step size of approximately .6 mil. As discussed earlier, the pattern of curing of the photopolymer will resemble a series of partially overlapping bullets. This is indicated in Figure 49. Since the beam diameter is approximately 7-20 mils, there will be a substantial overlap in the bullets formed during the curing process. In general, the larger the value of SS, the less overlap, and the more lumpy a cured line will appear. If a less lumpy line is desired, a smaller value of SS should be chosen.

Therefore, with the value of SS determined primarily by the vector type, the working curve will be used to translate between the desired cure depth and the value of SP. The embodiment described herein allows a value of SP between 10 and approximately 4,000.

Since SP is the most important parameter to be determined by the working curve, it is advantageous to use the banjotop to create a working curve that directly translates between SP and cure depth. This is the approach adopted in the particular embodiment described herein. Two banjotops are created, each having an SS of 2, and each having 5 lines associated with different values of SP. One banjotop is typically made with values of SP of 2560, 1280, 640, 320, and 160, and the second with values of SP of 160, 80, 40, 20, and 10. After the banjotops are created, the cure depths are measured, and the resulting data placed into a MATERIAL.MAT file. If the beam focus or shape, or material, or laser power, or stereolithography machine is changed, new banjotops must be created, and new working curves defined.

PREPARE also makes use of the POWER.LST file, indicated as 205 in Figure 33, which is used by PREPARE as the default laser power, since it was the last laser power used to recalibrate the working curves if a change in the laser output power associated with the stereolithography system is detected.

A HeCd laser is advantageously used in the embodiment described herein, which is specified as having an average 20 mW output power with a 2000 hours life. In practice, the output power may drop 1 mW per week, until after several months, the laser is at 10 mW, where it may remain for a time. After a time, the laser power will start to drop again. In many cases, the laser power can drop rapidly at first, i.e., from 25 to 20 mW in a couple of weeks.

The working curves will depend on the particular laser output power of the laser used to create the banjotops, and they must be recalibrated if the laser power changes. One way to recalibrate the working curves is to build a new banjotop every time a new part is to be made. This is inconvenient, and it has been found that it will be acceptable to simply measure the laser power every time a part is to be created, compare this with the laser power used to create the working curve, and then based on this comparison, recalibrate the working curve for any drop in laser power. This recalibration will be successful as long as the focus of the laser beam has not been changed. In practice, working curves are not recalibrated because they define legitimate relationships between cure depth and exposure, but the parameters to maintain a given exposure level are recalibrated due to a drop in laser power.

One problem that may occur is that the modes of the laser may change as it drops in power. In practice, however, it has been found that the recalibration based solely on laser power will still be reasonably successful as long as the laser power has been the only parameter changed. This will be the case even if the laser modes have changed. The POWER.LST file contains the last laser power value used. When a part is to be built, a new laser power is entered into PREPARE. This new laser power updates POWER.LST, and it is used along with a specific MATERIAL.MAT file to make determinations about required SPs for particular cure depths.

PREPARE.PRM and BUILD.PRM contain a number of default parameters. The main default parameters obtain a presently from PREPARE.PRM are the SS values for the hatch and boundary vectors on the one hand, and the ss values for the skin vectors on the other. PREPARE will obtain default values for various other parameters from the PREPARE.PRM file also.

BUILD.PRM contains a large number of default parameters used in the process of building parts. These parameters include a scaling factor to convert an object from SLICE units to mirror units that will allow the part to be produced with the desired size, offsetting parameters that will allow the object to be shifted from its original slice position to a mirror bit position, which will allow it to be built at a desired location on the elevator platform. BUILD.PRM can conceptually be looked at as being made up of 2 parameter files for the latest versions of software (3.2 and newer).

The first file is still called BUILD.PRM with the second file taking on the name of the object to built (OBJECT.PRM). The latest version of PREPARE (reads in the Object.PRM file if it exists), if not, it will read in the BUILD.PRM file, when changes are made they are made to the Object.PRM file. Older versions of prepare read and write to the BUILD.PRM file. PREPARE is capable of assisting the user in modifying the several parameters in BUILD.PRM mentioned above, along with a few others. Additional parameters in BUILD.PRM include laser control parameters for each vector block type and for each object along with a single set of dipping parameters for the part. But these values cannot be changed by PREPARE but instead by a standard word processor type or line type editor.

In summary, PREPARE enables a user to specify various cure and dipping parameters, will help compute the associated SS and SP values used to achieve a particular curing depth and width, range by range, will use new laser power A-D working curves to compute the new cure parameter and then write the curing parameters into appropriate parts of the Object.R file, and also allows editing of the Object.R file to change defaults and dipping parameters.

Figure 50a is a report produced by PREPARE showing the use of PREPARE to specify different curing parameters, i.e. cure depth or SP, etc. for each block type Wmin and Wmax on different cure sections. As indicated, two ranges are present. Range 1 consists of two 20 mil cross-sections, and Range 2 consists of thirteen 20 mil cross-sections. The curing parameters that can be specified for each range are cure depth or.Sp. Wmin and Wmax as seen in the Figure are respectively the width at 6 mils from the bottom of the a string with the displayed cure depth and the width at the top of a string with the displayed cure depth. Wmin and Wmax are shown for convenience only, specific editing capabilities for these parameters do not exist. It will be important for a user to specify values of Wmax and Wmin in those ranges or layers having near flat surfaces, since, as indicated in Figure 26(b), the calculation of the MSA used to detect the presence of near-flat surfaces depends on Wmin and Wmax. PREPARE does not assist one in determining MSA other than acting as a display for Wmin and Wmax. It must be remembered that specification of MSA is done before slicing but the information in PREPARE can be useful for future slices.

Cure widths are also important to specify in ranges and layers having skinned surfaces. This is because the spacing between skin vectors is advantageously 1-4 mils (while the spacing between hatch vectors is advantageously 30-100 mils), and depending on the beam width, there will be a substantial bit of overlap between adjacent skin vectors, which will affect the cure depth. With a cure width of 8 mils, for example, and a spacing of 4 mils, the laser will cure a given area twice. In other words, cure depth will be dependent on cure width in areas of closely spaced skin vectors. The cure depths and related SPS displayed in PREPARE do not consider overlap of vectors or changes in SS but these things can be dealt with manually as long as access to the needed information is displayed by PREPARE.

Figure 50b shows the contents of a MATERIAL.MAT file, as interpreted and displayed by PREPARE. As indicated, the file contains 5 data pairs corresponding to the 5 strings on a banjotop, with each pair consisting of a value of SP, and a value of LH (which stands for line height, and which is the same as cure depth). Also indicated is SLOPE, Y-intercept (LH), and closeness of fit data derived from a least squares fit of the data to the equation.

$$LH = SLOPE * LOG_{10} (Exposure) + (Intercept)$$

where exposure = (SP)

Figure 50c shows the contents of Object.R after it has been written into by PREPARE with various curing parameters. As indicated, all LB and LH vectors in the first range are to be drawn with an SS of 2, and an SP of 212. All LB and LH vectors in the second range are to be drawn with an SS of 2, and an SP of 58. The cure depth associated with these values of SP are respectively 35 mils and 26 mils, which can be determined by the use of the data specified in the displayed MATERIAL.MAT file, and the current laser power.

Finally, for the sake of completeness, Figure 50(D) shows the format of a portion of the Object.L file. The Object.L file is similar to the Object.R file, but it provides layer by layer control instead of range by range control. For each layer, object, and vector type combination, Object.L enables a user to specify different curing parameters. Therefore, for each such combination, Object.L provides for the entry of curing parameters for that combination.

BUILD

The function of BUILD is primarily to take the vectors and control file and to check to see if any additional parameters necessary to build a part are required to be added and then it send out the commands at appropriate times in order to build a part. BUILD will add the necessary parameters from a default file of parameters.

As indicated in Figure 33, BUILD combines data from the BUILD.PRM, Object.L or Object.R and Object.V files. For a given layer object, vector type combination, BUILD will check for necessary building parameters (such as curing parameters) in first the Object.R or Object.L files, and if not present, in the BUILD.PRM file. The last check will be in Object.PRM then BUILD.PRM if BUILD version 3.20 or above.

In general, BUILD.PRM enables a user to set default values for dipping parameters, part offset parameters, and part scaling parameters, along with part cure parameters.

The dipping parameters, ZA, ZV, ZD, and ZW, have already been explained.

The scaling parameters are as follows. The vectors in Object.V are defined in SLICE units, which depend on the CAD units and the desired resolution. For a CAD unit of one inch, and a resolution of 1000 for example, a SLICE unit will be 0.001 inches or 1 mil.

BUILD must convert the vectors into radial units for use in directing the dynamic mirrors to rotate a particular radial distance. As indicated earlier, the radial units used to control the dynamic mirrors are bits, where 3556 bits represent one inch of linear movement. Therefore, to make the conversion, BUILD must scale (that is multiply) all vectors by the scaling factor 3556/1000 = 3.556. It should be noted that slight errors in the scale factor (for a particular mirror to liquid distance) are automatically compensated for by geometric correction if the same scale factor is specified when building parts as was used when the system was calibrated.

BUILD must also develop commands from the above-described files for use in controlling the Z-stage elevator. The Z-stage elevator commands must be expressed in terms of revolutions of a pitch screw. This is because the elevator is caused to move up or down a certain amount by means of revolutions of the pitch screw. For a five-pitch elevator as used in the embodiment described herein, five revolutions of the pitch screw is equal to one inch of movement of the elevator in the z-direction. The elevator pitch parameter is simply a relationship between moving the elevator a particular distance along with the motor and the screw pitch characteristics.

BUILD also allows default exposure, i.e. SS and SP, values to be specified for each object and vector type combination.

BUILD also enables the user to specify certain offset values (defined in bits) which will be added to the X and Y coordinates of the endpoints of each vector. These offsets can be used to position the part center so it matches the center of the elevator platform, for example. In addition, BUILD contains default values for the area (defined in bits) within the scan range of the mirrors, which is the outline of the vat containing the photopolymer, which outline can be less than the mirror range. As indicated earlier, the mirrors may range from 0 to 64K in either the X or the Y direction, while the vat containing the photopolymer may extend only from 16,384 to 49,152 bits.

BUILD also enables the user to control riveting and multiply pass capabilities. Riveting is a technique whereby layer to layer adhesion is not required of cross hatch and boundary vectors. Layer to layer adhesion is achieved by means of curing the boundary and hatch to slightly less than layer thickness, i.e. 18 or 19 mils for a 20 mil layer, then giving extra cure to portions of cross hatch allowing these portions to bond the layers together. These portions of the hatch that are cured to the point of bonding are called rivets. Several commands exist to affect how rivets will be made. Additionally BUILD has commands that allow drawing of vectors and adhesion to be made by multiple passes over the same vector with the laser. This enables up to 7 passes to be made in order to achieve adhesion and final cure depth. Therefore adhesion doesn't need to be made between layers until the 2nd, 3rd or even 7th pass of the laser. This allows a large percentage of polymerization to occur before attachment to the previous layer thereby reducing distortion. This technique is called redraw and allows different exposure parameters on each pass and variable length of drawing before Redraw starts the next pass.

The format of BUILD.PRM is shown in Figure 51. As indicated, the file maintains default values for the elevator pitch parameter, for scaling between millimeters and revolutions, the scale factor for scaling between SLICE units and mirror bits, the location and dimensions of the vat area in bits, and variable for controlling the riveting process, variables for controlling the redraw process, and standard cure parameters on a block by block, object by object basis.

<u>STEREO</u>

STEREO performs a geometrical correction to the vector data in order to correct for an effect known as the pincushion. STEREO also makes corrections for other errors such as drift, mirrors not orthogonal, mirror rotation not at surface, etc.

The pincushion effect can be explained with reference to Figure 48. In correcting between SLICE units and bits (radial units used to drive the mirrors), a linear relationship was assumed. In other words, assuming a SLICE unit equals one mil, and assuming 3556 bits/inch all vector data is multiplied by the scale factor 3.556 by BUILD.

However, with reference to Figure 48, the relationship between the mirror's radial movement, indicated by 325 in the Figure, and linear beam movement, indicated as 327 in the Figure, will not be linear, and will in fact be more and more nonlinear the more the laser beam is directed away from its perpendicular position indicated by 326 in the Figure.

The assumed linear relationship will introduce a distortion into the curing of a cross-section called the pin cushion effect, which is illustrated in Figure 52. If the mirrors are commanded to direct the laser beam to draw the pattern shown in Figure 52a, in reality, the laser beam, as it traverses the surface of the photopolymer, will traverse the pattern shown in Figure 52b.

STEREO provides a means for correcting for the pin cushion effect through the use of a calibration plate.

The calibration plate is shown in Figure 53. It consists of a metal plate with pinholes spread in a grid, which pinholes are spaced 1/4" from one another.

During a set up step, before a part is built, the calibration plate is placed below the laser beam at the exact location that the surface of the photopolymer would be at during curing. In addition, the beam is initially directed to shine straight down, and perpendicularly strike the surface of the calibration plate, and the calibration plate is placed so that the laser beam strikes and passes through the center pinhole on the surface of the calibration plate, indicated as 333 in Figure 53. As indicated earlier, each mirror has a range of to 64K bits, so that the central location within the range for each mirror will be 32767 bits. Placed behind the calibration plate are sensing means for sensing the passage of laser light through a particular pinhole. The plate is also oriented so that the rows and columns of pinholes line up along the X and Y axes, as close as possible.

CALIBRATION operates as follows: After the passage of the laser light through pinhole 333 is detected, the beam is directed to move to the location indicated as 334 in Figure 53. Since this is 1/4" from location 333, which is 889 bits, the mirrors are directed to rotate 889 bits. However, as discussed earlier, the linear distance on the surface of the calibration plate will require less than 889 bits, of movement maybe 880 bits. Therefore, the laser light may not pass through the pinhole, and the calibration program causes the beam to move around in a spiral search pattern as indicated by 335 until the sensing means detects the passage of the laser light. The divergence between the expected and actual distance in bits at location 334 is then stored.

This process is then repeated for each of the pinholes on the calibration plate, to result in a table of divergences in both the X and Y directions associated with each of the pinholes. These values are then used by STEREO to make geometrical corrections to the vectors to correct for the pincushion effect. For example, a 1/4" vector pointing from 333 to 334 in Figure 53 would be corrected by subtracting 19 bits from the X value associated with the endpoint at 334, thereby changing a 1/4" length from 889 bits to only 880 bits.

In general, to exactly correct for geometrical errors would require that every point besides just the endpoints on a vector be corrected. If only the endpoints on a vector are corrected, some geometrical distortion will remain.

This can be illustrated with respect to Figure 54a. As indicated in the Figure, when vector 336 is drawn by the system, it will actually be drawn as 337 on the surface of the polymer. If only the endpoints of the vector were corrected, the resulting vector would appear as 338. As indicated, this vector will still be distorted.

However, to geometrically correct for every point in the interior of a vector would be time-consuming and probably unnecessary. It has been found, however, that a good compromise is to divide up each vector into small units called microvectors, and then geometrically correct the endpoints of each microvector. This is indicated in Figure 54b, which shows vector 336 divided up into microvectors indicated as 339(A)-339(G). The endpoints of each microvector are geometrically corrected, so that the placement of the corrected microvectors, as indicated in the Figure, will be a good approximation to the original vector. In the embodiment described herein, the microvectors are advantageously spaced at 512 bit increments (representing 256 steps of 2 mil increments) which represents spacing of approximately 1/8 inch.

Note that STEREO will incidentally correct for a number of other sources of distortion. These include distortion induced because the axis of rotation of the X and Y and mirrors are not directly at the surface of the mirrors, because the X and Y mirrors are not aligned exactly orthogonally to each other, and because of inherent absolute distortion in the mirrors. This last source of error can be explained with reference to Figure 48. The error is that even though the mirrors are directed to move a certain radial distance, indicated by 325 in the figure, they will in reality move radically more or less than this amount. Other sources of error will be present and corrected by the data, obtained from calibration plate, an aspect of the calibration plate is that the source of the error is irrelevant.

LASER

LASER is the program that directly controls the dynamic mirrors by means of the mirror driver, indicated as DX in Figure 33.

BASIC

In general, BASIC is a programming language. But here, we are concerned with running a BASIC program that generates vectors directly from equations describing the surface of an object, i.e. a cylinder, along with controlling the part building procedures as the BUILD program does. It creates a file called Object.DAT, which is a file of vectors that is sent out to be drawn.

CLIFF

CLIFF takes the object.DAT file and puts it in the same format as BUILD puts the Object.V file.

BEAM

BEAM is a program to measure the profile of the laser beam as it crosses a pinhole. In general, the pinhole is much smaller in diameter than the beam diameter, and BEAM causes the laser beam to sweep incrementally over the pinhole to build up the profile of the beam shape.

As indicated in Figure 55, beam 341 is caused to sweep over the pinhole 340 initially in the X-direction. At each increment, the intensity (power) of the beam is measured. After incrementing completely through the X-range the beam is stepped one increment in the Y-direction, and then re-incremented across the pinhole in the X-direction, and the intensity measured at each increment. This is repeated until the beam has been completely incremented in the Y-direction.

BEAM is an important program used to create the X-Y matrix used for geometrical correction by STEREO. There are two pinhole sensors located diagonally across the vat.

BEAM will sweep the beam across the pinholes on either side of the vat to obtain an accurate location of pinholes this data consisting of Intensity values and associated X, Y coordinates. BEAM then takes the weighted average of the X and Y positions, weighted by the intensity numbers, to compute a weighted average beam location value, which precisely measures the location of the center of the beam. This precise measurement is necessary to produce a precise X-Y table for drift correction.

Figure 57a shows the beam profile obtained by sweeping the laser beam across a pinhole. As indicated in the Figure, an incremental intensity value is obtained for each X and Y location of the beam as it sweeps across the pinhole. These numbers are plotted in Figure 57a.

Figure 57b is another report produced by BEAM. It shows the beam profile first along the X direction and then along the Y direction. This report is used to verify reasonable symmetry of the beam, and to show the beam width along the X and Y axis. This feature is very useful for bringing the beam to a good focus at the liquid/sensor level. One adjusts the beam expander (focusing device) until the most desireable focus is found by allowing the width display to update and indicate changes in focus at various beam expander positions. The plates shown in Figure 57b are obtained from the data shown in Figure 57a. Two adjacent rows or columns of data in Figure 57a are used to produce one of the values plotted in Figure 57b. For example, the data indicated by 346 in Figure 57a is used to compute the value indicated by 348 in Figure 57b, and the data indicated by 347 in Figure 57a, is used to compute the value indicated by 349 in Figure 57b.

BEAM also periodically directs the laser beam to sweep across both pinholes which are placed in known and fixed locations. The sweeping of these pinholes is performed even during the photo curing process to correct for drift correction, an error that occurs over time through drift in the mirrors. Since the location of the pinholes are fixed and known, the laser beam is directed to this location by the dynamic methods. If the passage of light through the pinhole is not detected, a spiral search for the hole is performed until the hole is found. The actual coordinates of the beam are then compared with the estimated components to compute a value which is used to correct for drift.

The data obtained by BEAM sweeping across the calibration plate and the two fixed pinholes is stored in the CALIB.DAT file. Note that BEAM also makes use of the BEAM.PRM file. The BEAM.PRM file is a parameter file which contains the last known positions of the two sensors and contains intensity calibration factors.

Note that if left uncorrected, the above sources of error can result in as much as 33 mils of error. With the corrections discussed above in place, it has been found that only about 4 mils of error due to the mirrors remain.

CALOUT

This program simply takes the X, Y correction data created by BEAM during the sweep of the calibration plate, reformats it, and places it in the STEREO.GEO file for use by STEREO as a lookup table in making geometrical corrections.

The above completes the description of the software architecture of the embodiment described herein. Next, the function of SLICE version 3.20, the program used to convert CAD/CAM data into vector data, will be described in detail.

DETAILED DESCRIPTION OF SLICE VERSION 3.20

A detailed flow chart of SLICE version 3.20 is included in Figure 58. As indicated, the first step is to specify certain input parameters required to drive the execution of SLICE version 3.20. This is indicated by step 400 in Figure 58. The following input parameters should be specified:

.STL file to be sliced
Scale (Res)

Fixed or variable z-spacing (Zs)
Hatch spacing in the X-direction (Hx)
Hatch spacing in the Y-direction (Hy)
Hatch spacing at 60/120 degrees (Ha)
Skin fill spacing in the X-direction (HFx)
Skin fill spacing in the Y-direction (HFy)
Minimum surface angle (MSA)
Minimum intersect angle (MIA)
Name of SLI file for output vectors

Most of these parameters are self-explanatory or are described in the body of the application. The scale is the desired resolution, and will be used to translate the CAD data, which is expressed in terms of CAD units, into vector data, which is expressed in terms of SLICE units. As discussed above, the system is presently capable of a maximum resolution in the X or Y directions of 3556 bits per inch, where each bit represents approximately .3 mil. If the CAD units are inches, then a scale value is 3556 provides maximum resolution for building parts. Higher scale values may be useful for other purposes such as ease of interpreting data. In this instance, scale can be any value of 3556 or larger.

The fixed or variable Z spacing enables a user to specify the slicing up of the CAD/CAM data into cross-sections of varying thickness. This is an important design parameter of the system, for it enables a user to specify a finer vertical (Z-direction) resolution in those regions of the object having the most detail, and less resolution in those regions where the finer detail is not needed.

In general, the layer thickness can range from 5 to 30 mils, with an average of 20 mils. A layer thickness of 5 mils is also common.

Although a 5 mil layer thickness will enable finer resolution, 5 mil layers are typically weak and susceptible to distortion because of curling. A 20 mil layer is much stronger and less susceptible to distortion, but is capable of less resolution.

These (5 mil) layers suffer from the additional problem that the dipping time for a particular thickness will increase with a decrease in layer thickness.. This is because at finer layer thicknesses, it will take more time for excess polymer to gravity level.

On the other hand, when the layer thickness is very thick, the curing time can increase to the point that it dominates the reduction of time gained by with the curing of a lesser number of cross-sections.

In sum, total curing time will be large at the extremes, i.e. at both high and low layer thicknesses. It has been found, in general, that a layer thickness of 10 mil will give the optimal building time.

The next step indicated in Figure 58 is step 401, wherein the triangle vertices of the .STL file, which are represented in CAD units, are multiplied by the scale value to convert to SLICE units, i.e. inches to mils.

Step 402 calls for integerizing or rounding the triangle vertices in the X, Y, and Z directions to take account of the physical limitations of the system. This step, although not strictly necessary, is performed to achieve computational efficiency. This aids computional efficiency because intergers can be manipulated much faster than floating point numbers.

In the X and Y directions, the highest resolution of the system is, as discussed earlier, 1 bit, which is approximately .3 mils. Therefore, the X and Y components of the triangle vertices are rounded to the nearest bit. This implies maximum X and Y resolution is 3556 bits/inch indicating that a scale factor of 3556 fits/inch or higher will yield best resolution. So generally, a scale or resolution factor of 5000 is used, if full resolution is desired. If full resolution is not necessary a scale factor of 1000 bits/inch is used.

In the Z-direction, the physical limitations of the system are defined by the chosen layer thickness. Therefore, the Z-components of each triangle vertex are rounded to the nearest cross-section as defined by the chosen layer thickness.

The rounding of the triangle vertices will introduce several distortions which will cause problems in the downstream portions of SLICE 3.20. As discussed in the body of the application, the major problems are the collapsing of certain triangle to single points or lines, or the flipping of certain triangles. The flipping of certain triangles will result in a portion of the surface of an object being covered simultaneously by more than one triangle, and will also result in the triangle normal vector flipping direction to point into the solid rather than away from the solid. In other words, the flipping of triangles causes two of the fundamental format rules for the .STL file to be broken. As will be seen, this will create many problems which must be detected and corrected in the remaining portions of SLICE 3.20.

In step 403, the collapsed triangles are removed from the .STL database. The purpose of removing collapsed triangles is that their presence will be problematic downstream during the generation of hatch and skin vectors. In addition, the collapsed triangles will not be necessary for the complete representation of the surface of the object. As will be seen, hatch and skin vectors are generated between border vectors, border vectors are created at or near the slicing layer, they are generated at the intersection of an XY plane with the triangles spanning the surface of an object.

If a collapsed triangle lies at the point of intersection, it will result in the generation of a redundant border vector which can confuse the generation of hatch and skin vectors. The removal of collapsed triangles can result in a triangle vertex touching an adjacent triangle at other than a vertex. This will not be a problem, however, as the vertex rule was only required before the rounding step to insure that no holes would be created in the surface during rounding, as could occur if the vertex rule were not obeyed. After the rounding step, there is no requirement that the rule be obeyed.

In step 405, the triangle normal vectors, which indicate the orientation of the triangles with respect to the surface they span, are recomputed to take account of any change in direction that may have occurred through the rounding process.

In the embodiment described herein, only the X and Y components of the triangle normals are recomputed, while only the magnitude of the Z-component is updated for use in comparing with the MSA to detect near-flat up or down-facing triangles. The direction of the Z-component is taken from the original .STL file data before rounding. The reason why this occurs is that at present, the Z-component of the triangle normals is not used in any downstream processing other than in the detection of near-flat triangles up- or down-facing categories for processing and flat triangles, while the X and Y components are used for the generation of hatch and fill vectors. In the current embodiment, the triangle normals are only used to create a directional vector (to be discussed later) for boundary vectors called a segment normal which points in the X and Y plane only. The magnitude of the Z-component must be recalculated because of the use of the triangle normal in detecting the presence of near-flat skins, but the original sign of the Z-component is used to divide triangles into up-facing or down-facing categories.

The next step, step 406, begins the process of categorizing the triangles as either up or down-facing near-flat triangles. As indicated in the body of the application, and as illustrated in Figure 59, which is reproduced from page 3.3-2 of the Training Manual attached as Appendix D, triangles can be categorized as near-flat triangles, steep triangles, and flat triangles. Steep triangles are triangles whose normals form angles with the vertical axis which are greater than the specified value for MSA, while it is the exact opposite for near-flat triangles, and flat triangles are triangles having normals which point in the Z-direction.

One importance of classifying triangles is that it allows the detection of near-flat areas which trigger the generation of near-flat skin vectors. If these vectors were not created, slanted areas of an object, which would be reproduced as a staircase of stacked cross-sections, would show exposed areas of cross-hatching. These areas should be covered by cured polymer, which polymer will result from the generation of near-flat skin vectors. The direction of these near-flat areas is performed by comparing the angle that the triangle normal makes with respect to the vertical axis, and if the difference is less than or equal to the MSA, classifies the triangle as a near-flat triangle. This comparison is discussed earlier in the body of the application (see Figures 26a and 26b, and associated discussion).

With the rounding of the triangle vertices SLICE 3.20 is ready to begin the generation of vectors from the triangles. This is indicted by step 407.

The process begins with the generation of layer boundary vectors, which is performed in step 408. As discussed earlier, the layer boundary vectors for a particular layer are created at the intersection of a horizontal slice with step and near-flat triangles, which intersection is 1 bit above a particular layer. The lines representing the points of intersection become the layer boundary vectors.

As discussed in the body of the application, the layer boundary vectors are created 1 bit above the slicing layer, since otherwise, the representation of the object would be distorted (see Figure 29a and associated discussion in the body of the application). Specifically, slicing 1 bit above the layer produces a part having the right vertical height between up-facing and down-facing areas. Another benefit of slicing 1 bit above the layer is that all triangle vertices (which have all been rounded to layers) will be avoided. As will be discussed further on, this will avoid certain problems in the generation of hatch or skin vectors, which would otherwise occur if the triangle vertices were on the slicing layer. Briefly, the problem would occur since the triangle vertices would confuse SLICE 3.20 regarding the presence of boundary vectors, which in turn, would confuse it regarding when to begin or stop the generation of hatch or skin vectors. Figures 23a and 23b and the related discussion provide additional detail regarding the generation of border vectors.

Step 408 also includes the substep of creating segment normals for the boundary vectors. Segment normals are related to boundary vectors in the same way that triangle normals are related to the surface triangles: the segment normals are simply meant to show the orientation of a boundary vector with respect to the interior part of the cross-section that it is spanning. In the embodiment described herein, segment normals always point away from the solid part of the cross-section that the boundary vectors are spanning

These principals are illustrated in Figure 59(b). As indicted, surface triangle 500 (which happens to be a steep triangle -- it could also have been a near-flat triangle) is sliced by plane 504, which is 1 bit above the slicing layer. The intersection results in the generation of boundary vector 503.

The surface triangle also has triangle normal 502 which indicates the orientation of the triangle with respect to the surface it is spanning. Similarly, the border vector has a segment normal 503, which indicates the orientation of the border vector with respect to the interior of the triangle, and hence the solid part of the cross-section of the solid it is spanning.

Note that the segment normals for the boundary vectors will be created from the triangle normals of the surface triangles from which the boundary vectors are derived. In fact, this is the approach taken by SLICE 3.20.

At present, SLICE version 3.20 does not keep track of all information about a segment normal, but only enough to be able to determine which quadrant the segment normal points toward. It turns out that the only information that is required is whether or not the segment normal has a positive or negative X-component, Y-component, and Z-component (for determining category of skin, i.e. up or down-facing). In other words, only six pieces of data are needed.

To create the segment normals for the boundary vectors, SLICE 3.20 will simply indicate the present or absence of X and y components only. It will not keep track of the Z-components; since by definition, all segment normals for the boundary vectors will be in the X-Y plane. SLICE 3.20 will extract the information about the X and Y components from the triangle normal, and use this to create attributes for the segment normal.

Steps 409 and 410 are designed to clean up the border vectors in preparation for the generation of skin and hatch vectors.

As indicated, in step 409, duplicate pairs of boundary vectors are eliminated. Duplicate boundary vectors can occur for several reasons. This step has little meaning for layer boundaries as it is currently implemented. As implemented only a portion of appropriate vectors will be removed. Presently, for duplicate vectors to be removed they must have matching endpoints, either head to head matching and tail to tail matching or head to tail and tail to head matching. Several situations can occur that result in duplicate pairs of boundaries, but for efficient removal a couple of extra steps need to be added to the present implementation. These steps include removal of sections of duplicate vectors that only overlap along part of their lengths, along with only one being removed if the overlapping vectors have similar segment normals, or if they have opposite normals both are removed. One way for duplicate boundaries to occur is when small features collapse creating a double surfaced region of triangles with opposite normals. This is a difficult situation to deal with, because a decision needs to be made as to whether boundaries should be retained or eliminated. Our preferred embodiment is that both boundaries should be removed. This situation is illustrated in Figure 60a. Figure 60a depicts a narrow slit (505) between two boxes 506, as designed on a CAD system. Figure 60b depicts the two boxes and the collapsed slit after scaling the CAD designed part for slicing. Figure 60c depicts two planes intersecting the part one at a slice later and the other 1 bit above that. Figure 60d depicts the boundaries and their segment normals as derived from the slice. Boundary 505a is actually two boundaries overlapping but with opposite normals. Proper elimination results in the boundaries shown in Figure 60E. Present implementation may or may not remove the vector depending whether or not endpoints matched.

Duplicate or redundant boundary vectors can also result from the flipping of triangles, which can occur during the rounding and integerizing process of step 402. When a surface triangle flips, there can be a portion of the object which will be covered by more than one surface triangle at the same time. During the step of generating boundary vectors, if this portion of the surface intersects an X-Y plane 1 bit above a slicing layer, then up to three or more overlapping boundary vectors can be generated. In step 408, the redundant vectors can be eliminated. Using the present implementation this elimination is unlikely to be successful.

This problem is illustrated in Figure 61. Figure 61a shows triangle 511 adjacent to triangle 512, which in turn is adjacent to triangles 513 and 514. Because of a rounding error, triangle 512 is caused to flip, and overlap triangle 511. Note that the overlapping of triangle 512 will also distort triangles 513 and 514, which are required to and will continue to abut triangle 512, even after it has flipped.

After flipping, the situation is as indicted in Figure 61b. If it is assumed that plane 515 represents an X-Y plane 1 bit above a slicing layer, then the generation of redundant boundary vectors will result.

The duplication of redundancy of boundary vectors is illustrated in Figure 61c. Vector 516 resulted from the intersection of plane 515 with triangle 511; vector 517 resulted from the intersection of plane 515 with triangle 512; vector 518 resulted from the intersection of plane 515 with triangle 513; and vector 519 resulted from the intersection of plane 515 with triangle 514.

Note that in Figure 6ic, the boundary vectors are indicated as having a particular direction. In the embodiment described herein, the particular direction will be defined in terms of the segment normals of the boundary vectors. The particular convention chosen is the "left hand rule," which means simply that the direction of a boundary vector will be such that when moving from the tail to the head of the vector, the segment normal will point off to the left.

As mentioned earlier, the segment normals will be obtained from the triangle normals for the boundary vectors. In Figure 61c, for example, vector 516 points to the left consistent with its segment normal pointing out of the plane of the paper. Vector 517, on the other hand, points to the right since its segment normal points into the paper. The segment normal points into the paper since it is derived from the triangle normal of triangle 512, which because of the flipping of the triangle, has also flipped direction. Vectors 518 and 519 continue to point to the left since, even though triangles 513 and 514 have become distorted, they have not flipped.

In step 409, redundant vectors such as vectors 518 and 519 along with redundant portions of 517 can be eliminated but they do not necessarily need to be eliminated since the matching algorithm used can properly interpret where hatch should be placed. On the other hand it would be nice if duplicate vectors are removed so that a double or triple exposure of boundaries won't be applied.

In step 410, point vectors will be eliminated. As discussed in the body of this application, point layer boundary vectors will not occur due to triangle vertices, since, as discussed in the body of this application, triangle vertices have been rounded to the slicing layer, and will never be 1 bit above it. There may be situations, however, when the X-Y plane will intersect a narrow portion of a surface triangle, which portion is so narrow, that the resultant border vector will be rounded to a single point. These point vectors will be eliminated in step 410.

In step 411, the border vectors will be ordered in such a way as to eliminate or minimize jumping of the laser beam especially across uncured liquid photopolymer.

The border vectors will be created in no particular order, and in fact will be created in the order in which the surface triangles are processed. This is illustrated in Figure 27a, which shows the boundary vectors ordered in the sequence in which they were created. Note that if the boundary vectors are left in this order, the laser beam will be caused to jump across areas of uncured polymer, which can cause unwanted curing.

To get around this problem, the border vectors will be reordered as indicted in Figure 27b, which shows the border vectors ordered according to how they will be drawn.

Step 412 merely signifies the completion of the generation of the layer boundaries, which comprise boundary vectors placed end to end which span across-section at the layer.

In addition, each boundary vector has an associated segment normal, and together, the boundary vectors and segment normals that span a layer should obey a convention known as the "left hand rule." According to this convention, if the vectors are placed end to end so that the tail of one abuts the head of the next vector, the vectors will form a clockwise loop if they are outer boundaries and a counter-clockwise loop if they are inner boundaries, and in travelling around the loop in the direction of the vectors, the segment normals should all point to the left. Outer boundaries enclose solid areas, while inner boundaries enclose hollow areas. This is indicted in Figure 62a.

Because of the flipping of triangles, however, there may be situations where a boundary vector and its associated segment normal point in the wrong direction. This is indicted in Figure 62b. In all instances, this problem would be eliminated in step 409 if properly applied. In these instances, the mis-directed boundary vectors and associated segment normals should not cause problems during the generation of hatch vectors. If however these considerations are applied to the various skin boundaries problems can occur.

In step 413, the boundary vectors minus the segment normals are stored for output to the .SLI file for layer n. The segment normals are not eliminated in this step, but are kept for further processing. They are simply not written out to the .SLI file since they are only used for processing internal to SLICE 3.20.

In step 419, the generation of hatch vectors takes place. As indicated in Figure 58, this step takes as input the HA, HY, HX, and MIA parameters, which together define the desired spacing and type of hatch vectors which will be generated.

HA, HY, HX are explained in the body of the application. If one of these values is zero, the associated hatch vector type will not be generated. MIA is used to generate hatch vectors which are as close as possible to a radial hatch. This is illustrated in Figures 24i and 24j and described in the associated text in the body of the application. A radial hatch is not presently allowed since it may result in hatch vectors on adjacent layers not being directly above one another. The benefit of having hatch vectors on adjacent layers above one another is that the cured polymer on the layers corresponding to the hatch vectors will adhere to one another if the hatch vectors are placed directly above each other, which will contribute to the strength of the cured part. With radial hatching, there is no guarantee that hatch vectors on adjacent layers will be above one another. The use of MIA results in achieving as close to a radial hatch as possible on a general part, while at the same time ensuring the hatch vectors on adjacent layers are above one another.

As indicated in the body of the application, the starting and stopping of the generation of hatch vectors will be done by detecting the presence or absence of boundary vectors along parallel hatch paths as illustrated in Figure 24.

Three methods have been considered for the generation of hatch vectors. These are discussed extensively in the body of the application. The first method, the "on/off" method, operates by detecting the presence of a boundary vector along a hatch path, and if hatch vectors are currently being generated, stops their generation. If they are not currently being generated, this first method begins their generation.

The problem with the first method is that it gets easily confused if it encounters an area along a hatch path where more than one border vector intersect or meet. This may occur if a hatch path simply goes through an area where the head of one border vector touches the tail of another border vector, or an area having duplicate or redundant overlapping border vectors. This occurs when a triangle segment common to two triangles has landed on a slicing layer, or because a triangle has flipped. This problem will manifest itself in the generation of spurious hatch vectors in areas meant to be hollow, or the absence of hatch vectors through areas meant to be solid.

The second method, the "priority on" method, analyzes the boundary vectors and their segment normals to make the decision whether or not to turn on or off the generation of hatch vectors. The segment normals of the boundary vectors should point in the direction away from the solid which the border vectors span (although, as indicted earlier, this relationship may not hold if a triangle has flipped),and the "primary on" method will always begin the generation of hatch vectors when it encounters a border vector having a segment normal indicating that the hatch path is about to travel through a solid region. If an area along a hatch path is encountered where more than one boundary vector intersects or overlaps, the method will continue or begin to generate hatch vectors if any segment normal from any of the boundary vectors indicates entry into a solid. As a result, the generation of hatch vectors will cease only when a boundary vector or vectors is or are encountered where there is no possibility of confusion, no segment normal indicates the entry into a solid.

This method still suffers from the generation of spurious hatch vectors. As a result, a third method, the "net summation" method has been developed.

According to this method, when points along a hatch patch are encountered, where one or more boundary vectors meet or intersect, the signs of segment normals for all the boundary vectors are summed, and a decision to either begin, or turn off, or continue as is the generation of hatch vectors is made based on the net summation.

The method works by comparing the direction of each segment normal with the direction of the hatching path to determine a sign for that normal "+" if the normal is in the same direction as the hatching direction, and "-" if the normal is in the opposite direction. Then, the signs for all the segment normals are summed. If the net sum is "+," hatch vector generation is turned off; if the net sum is "-," hatch generation is turned on; if the net sum is "0," hatch generation will continue as is.

A comparison of these three methods is provided in the body of the application as Figures 24a-24h, and the associated narrative. It has been found that the third method, the "net summation" method, is best for dealing with the intersection points of border vectors, and for dealing with duplicate or redundant border vectors caused by flipping triangles.

The operation of the third method will be explained with reference to Figure 63a. As indicted, layer boundary 520 spans a cross-section of an object, which layer boundary is comprised of layer boundary vectors and their associated segment normals. Also indicated are hatching paths 521(A)-521(C).

As indicated, hatching path 521(A) intersects point "1" of the boundary, indicated as 522(A), which is the intersection point of two boundary vectors. As indicated at 522(B), the net direction of the segment normals with respect to the hatching path direction is determined. Since the net direction is "0," hatch generation, initially off, will continue off. This is the proper decision as indicated.

Hatching path 521(B) intersects point "2" of the boundary, indicated as 523(A), which is the intersection point of two boundary vectors. As indicated at 523(B), the net direction of the segment normals with respect to the hatch path direction is negative, indicating that hatching should be turned on. The hatch path also intersects point "3" of the layer boundary, indicated as 524(A). As indicated at 524(B), the net direction of the segment normals is positive, indicated that hatch vector generation should be turned off. As illustrated, these are correct decisions.

Hatching path 521(C) intersects point "5," which is indicated as 525(A). As indicted at 525(B), the net direction of the segment normals at this point is "0," indicating that hatch generation should continue as is, which is to continue on. This is a correct decision.

The "net summation" method is also advantageous for dealing with the problem of flipping triangles. With flipping triangles, two situations will be encountered: situations where an area will be surfaced by three triangles, and situations where an area will be surfaced by two triangles. The surfacing of an area by three triangles is indicated by 526 in Figure 63b, which corresponds to area 528 also shown in that Figure. The surfacing of an area by two triangles is indicated by 527 in Figure 63b, which corresponds to 529, which shows the flipping of a triangle at the corner of a solid.

The point of overlap in 526 is indicted by 530. As indicated, if the hatching path direction is into the solid, the net summation of the direction of the segment normals will always be negative, signalling the turning on of hatch generation. If the hatching path direction is away from the solid into space, the net summation will be positive, signalling the turning off of hatch vector generation.

The point of overlap in 527 is illustrated by 531. As indicated, the point of overlap will be in an area of free space, and regardless of the incident direction of the hatching path at the point of overlap, the net direction of the segment normals will always be "0," and hatch generation will always continue as is, i.e. off, through the area of overlap.

In step 415, the hatch vectors will be ordered with the objective of minimizing the amount of time the laser beam will pass over uncured polymer, i.e. hollow areas, and maximizing the amount of time the laser beam is directed to pass over cured polymer, i.e. solid areas. The ordering of hatch vectors is illustrated in Figures 27c-27e, and discussed in the associated text in the body of the application.

In step 416, the hatch vectors are labelled held for output as LH vectors for layer n into the .SLI file.

Step 417 continues the generation of boundary vectors, this time from down-facing flat triangles. These are known as flat down-facing boundary vectors (FDB) unlike the case with layer boundary vectors, however, which were determined at 1 bit above the slicing layer, flat down-facing boundary vectors are determined right at the slicing level since flat triangles are only found right on a SLICE layer due to rounding of vertices.

A flat down-facing triangle will fit entirely within the plane of a slicing layer as indicated in Figure 64a, which shows flat down-facing triangle 533 within slicing layer 532. As a result, the FDB vectors will in fact be the triangle segments indicted as 534(A), 534(B) and 534(C) in the Figure.

In step 418, the segment normals for the FDB vectors are derived. Unlike the case with the LB vectors, however, the segment normals are not derived from the triangle normals, but will in fact be derived from the relative locations of the triangle vertices, which will be determinative of the direction of the segment normals. With reference to Figure 64a for example, the segment normal for segment 534(A) is determined by comparing its endpoints, 535(A) and 535(C), with the vertex 535(B). This comparison will indicate the orientation of the segment with respect to the interior of the triangle it is bordering, and will be used to generate a segment normal pointing away from the interior. A similar comparison will take place for segments 534(B) and 534(C), by comparing endpoints 535(B) and 535(C) with 535(A), and by comparing endpoints 535(A) and 535(B) with 535(C), respectively. The segment normals which form these comparisons are shown in Figure 64b, which shows segment normals 535(A), 535(B), and 535(C), corresponding to boundary vectors 534(A), 534(B), and 534(C), respectively. Note that the boundary vectors are also assigned a direction to conform to the left hand rule, i.e. according to which the segment normal always points off to the left as the vector is traversed from its tail to its head.

In step 419, duplicate FDB vectors are removed. This is a relatively simple process, and requires analyzing all of the down-facing flat triangles on a slicing layer, and eliminating all boundary vectors derived from segments that are common to two triangles. This is illustrated in Figure 64c, which shows triangles 536 and 537 sharing a common segment, which is two FDB vectors, one for triangle 536, the other for triangle 537. Both of these boundary vectors will be eliminated in step 419.

The remaining area enclosed by the remaining four FDB boundary vectors is indicated by 538 in Figure 64c. Note that duplicate boundary vectors are eliminated to simplify calculation of skin fill vectors, and reducing the number of skin vectors considerably since one hatch or fill vector is created each time a boundary is crossed even if the boundary indicates "continue as is."

In step 420, all point vectors will be removed. Point vectors can result from collapsing of triangles due to rounding on the slicing layers.

In step 421, the FDB vectors are reordered to minimize the passage of the laser beam over uncured photopolymer.

In step 422, the direction of segment normals can be recalculated to take account of triangles that may have flipped due to rounding distortions on the X-Y plane. As indicated earlier, this can occur when all vertices are rounded to the nearest bit.

The problem is illustrated in Figure 66. As indicated in Figure 65a, triangle 539 is caused to flip over into triangle 540 due to a rounding distortion. Both triangles are flat down-facing triangles, and the FDB vectors which will be generated will coincide with the triangle segments. In addition, the segment normals are as indicated.

In Figure 65b, the duplicate boundary vectors associated with segment 541 will be removed, and the situation indicted in Figure 66a will result. The direction of the boundary vectors which remain after the elimination of the duplicate boundary vectors is indicated.

As can be seen, there is a fundamental flaw in these boundary loops. The loop can not be traversed without encountering vectors that point in the wrong direction and normals that point the wrong way. The correction to this problem can be implemented in various ways ranging from simple checks that detect and solve the problem some of the time to more complex methods that solve the problem most of the time to more sophisticated methods that solve the problem all the time.

The situation has the potential for causing problems in the generation of skin vectors since skin fill is derived by the same algorithm as hatch vectors and therefore depends on segment normals to properly indicate solid regions, and also has the potential of causing problems with beam width compensation (this will be discussed later). Therefore, step 422 involves recalculating the direction of the segment normals based on detection of flipped triangles and reversal of these segments and normals if necessary, or simply majority of vectors in any loop are considered to have correct normals so minority of segment normals are reversed or by a other more sophisticated techniques. If this correction is made to Figure 66a, the situation in Figure 66b results.

Step 423 signals the completion of the generation of flat down-facing skin borders, which are comprised of a series of FDB vectors placed end to end, and conforming to the left hand rule.

Step 424 involves removing the segment normals, and saving the vectors for storage in the .SLI file with the FDB label.

In step 425, flat down-facing skin vectors are created from the FDB vectors in a manner closely analogous to the way hatch vectors are created from the LB vectors. The only differences are that the spacing between skin vectors is typically much less, and skin vectors are generally only created in the X or the Y direction, not both, and not at 60/120 degrees, as with hatch vectors.

In step 426, the skin vectors are ordered using the same algorithms as used to order the layer hatch vectors, the purpose of the algorithm being to minimize the passage of the beam over uncured polymer.

In step 427, the skin vectors are labelled with FDF, stored for output in the SLI file as FDF vectors for layer n.

As indicated in step 428, hatch vectors are not generated from the FDB vectors. This is because these vectors are redundant which to layer hatch vectors will already be created as from layer border vectors.

In step 429, flat up-facing triangles are Analyzed, and used to generate flat up-facing skin boundaries. The process of generating flat up-facing skin boundary vectors is entirely analogous to that for obtaining flat down-facing boundary vectors, except that the vectors for layer n are derived from triangles on layer n + 1. The reasons for this are that STYLE 1 (which is the style that is used to generate oversized parts, and which is the style which is currently implemented on SLICE version 3.20) generates layer border and layer hatch vectors 1 bit above a slicing layer, and 1 bit above an up-facing skin triangle will by definition be in open space. Thus, all flat up-facing boundary vectors will generate cured polymer which will be fully floating unless it is moved down 1 layer since it will not have any cured polymer from layer hatch or layer boundary vectors on which it can be supported.

This situation is illustrated in Figure 67. As indicated, layers n + 1, n and n-1, are respectively indicated as 543(A), 544(A), and 545(A). The corresponding cured polymer that will result for each layer is shown in Figure 67. As indicated, layer n + 1 will result in the generation of flat up-facing boundary and skin vectors, which when cured, yield the cured polymer indicated by 543(B). Layer n + 1 will not result in the generation of layer hatch and boundary vectors since those vectors will be obtained by slicing 1 bit above the layer, which is free space. Layers n and n-1, however, will result in the generation of layer hatch and border vectors, which will result in cured polymer 544(B) and 545(B), respectively.

Since skin fill vectors are cured at a shorter depth than the layer hatch and boundary vectors, the cured polymer resulting from those vectors, 543(B) in Figure 67, will be free floating unless the cured polymer is placed on layer n. This is accomplished by associating the skin boundary and fill vectors generated by slicing layer n + 1 with layer n.

Steps 430-436 pertaining to flat up-facing fill are exactly analogous to steps 418-427, respectively, and will not be discussed further. The only differences are that in step 436, the boundary vectors are labelled as FUB vectors before outputting to the .SLI file, and in step 439, the skin fill vectors are labelled as FUF vectors before outputting to the .SLI file. Also, as indicated in 440, hatch vectors (FUH vectors) will not be generated from the FUB vectors, since they will be redundant to LH vectors, which will already have been generated at layer n from the LB vectors.

In the above discussion, it has been tacitly assumed that the difference between flat up-facing and down-facing triangles is easily determined. This is normally a simple process, and is based on looking at the direction of the triangle normal: if it is pointing up in the Z-direction, a flat up-facing triangle is present, while if it is pointing down in the Z-direction, a flat down-facing triangle is present.

However, this process will become complicated in those situations where flipped triangles are present. This is because in these instances, a particular area on the surface of an object may be covered by up to three or more triangles, each having a triangle normal, and the process of detecting the presence of an up or down-facing skin will be more ambiguous than if a single triangle normal were involved. In this instance, as described in the body of the application, an algorithm analogous to the "net summation" algorithm can be used to compute the net direction of the triangle normals in the overlapping areas of the flipped triangle. If the net direction is up-facing, an up-facing flat triangle will be assumed, and step 429 and its progeny will be invoked. If the net direction is down-facing, a down-facing flat triangle is assumed, and step 417 and its progeny will be invoked, if the net normal is "0" then no skin will be created in that area. The present implementation is to not recalibrate the Z-components of normals after rounding and then deal with mis-directed segments and segment normals as necessary.

In step 441, near-flat down-facing trapezoid boundaries for layer n are formed from the intersection of near-flat down-facing triangles with slicing layers at levels n and n + 1.

This situation is illustrated in Figure 68, which shows a near-flat down-facing triangle intersecting slicing layers n and n + 1 at segments 546 and 547 respectively. Next, segment 547 is moved down to layer n to form segment 548 as indicated. Segments 546 and 548 are used to form the first two boundary vectors of the trapezoid. The next two boundary vectors which span the trapezoid, 549 and 550, respectively, are formed by simply connecting the end parts of segments 549 and 550.

In step 442, the segment normals for the segments surrounding the trapezoid are computed. As indicated in the body of the application, the direction of the segment normals are computed based on the relative position of the vertices of the trapezoid in a manner entirely analogous to the determination of the direction of segment normals associated with flat up or down-facing triangles. In other words, the positions of the endpoints of a segment are compared with the other vertices of the trapezoid, and the comparison used to determine the direction of the segment normals. The end result is displayed in Figure 69, which illustrates the segment normals and the associated trapezoid segments.

In step 443, duplicate vectors are removed. Duplicate vectors are defined as those vectors which form a common boundary between two adjacent trapezoids which have been generated from near-flat down-facing triangles. These will be removed for the same reasons as removal for duplicate boundaries from flat skin areas.

In step 444, point vectors will be removed. As before, these will be generated by a triangle vertex landing on a slicing layer, or by the collapse of short trapezoid boundaries when endpoints intergized, and will be removed to eliminate problems in the generation of hatch and fill vectors from the near-flat border vectors.

In step 445, the vectors will be reordered to minimize the passage of the laser beam over uncured polymer.

In step 446, the segment normals associated with the trapezoid segments will be recalculated to correct for the problem of flipping triangles, which can occur with near-flat triangles as with any other triangle. The problem will manifest itself by trapezoid segment normals pointing to the interior of the near-flat skin areas rather than the exterior. The segment normals can be recalculated in a similar manner to that for flat skin boundaries.

Step 447 signals the completion of the generation of near-flat down-facing borders which comprise a series of near-flat down-facing border vectors and their associated segment normals, which border vectors are placed end to end, and which border vectors obey the left hand rule with respect to their segment normals.

In step 448, the segment normals are removed, and the border vectors are labelled as NFDB vectors and stored for output to the .SLI file.

In step 449, the generation of near-flat down-facing skin fill vectors is performed. This process is performed using the near-flat down-facing skin border vectors from the skin/hatch vector generation algorithms discussed above.

In step 450, the skin vectors are ordered to minimize the passage over the uncured photopolymer using the algorithms described in the body of the application (which apply to the generation of the hatch and skin-vectors), and in step 451, the skin vectors are labelled as NFDF vectors, and stored for output to the .SLI file.

In step 452, near-flat down-facing hatch vectors are generated. It may seem anomalous that near-flat down-facing hatch vectors must be generated when in analogous situations discussed earlier, i.e. flat-up and down-facing skin vectors, flat-up and down-facing hatch vectors were not generated.

Near-flat down-facing skin vectors are different since they will always generate cured polymer which will be unsupported until supported by cured polymer generated by near-flat down-facing hatch vectors. Ever other type of skin vector, i.e. flat up- or down-facing skin vectors or even near-flat up-facing skin vectors, will generate cured photopolymer which will be supported by polymer cured from layer hatch and boundary vectors. This is illustrated in Figures 29f and 29g, and the associated text, in the body of the application.

Therefore, in step 452, the hatch vectors required to support the near-flat down-facing skin vectors are formed from the near-flat down-facing boundary vectors. The algorithms used are as discussed earlier.

In step 453, the hatch vectors are ordered to minimize the passage of the laser beam over uncured photopolymer, and in step 454, the hatch vectors are labelled as NFDH vectors, and stored for output to the .SLI file.

In step 455, near-flat up-facing boundary vectors are formed. These vectors are formed from one triangle at a time by first forming a trapezoid from the intersection of a near-flat up-facing triangles with slicing layers n + 1 and n. Then the segmented from the layer n + 1 intersection is moved down to layer n, and in conjunction with the other segments formed at the intersection with layer n is used to form a trapezoid on layer n.

This is illustrated in Figure 71, which shows a near-flat up-facing triangle intersecting layer n + 1 at segment 555, and layer n at segment 556. Segment 555 is then moved down to layer n, and the end parts of segments 557 and 556 are connected to form a trapezoid, along with two additional segments, 558 and 559, which together span the trapezoid.

In step 456, the segment normals are determined as before by comparing the relative positions of the endpoints of the segments, and in step 457, duplicate vectors forming a common side to adjacent trapezoids are eliminated. In step 458, point vectors due to triangle vertices, or collapsing of tiny border vectors due to rounding errors, are eliminated, and in step 459, the border vectors are limited to minimize the passage of the laser beam over uncured polymer. In step 460, the segment normals for the trapezoids are recalculated to correct for the problem of flipping triangles and the attendant problem of segment normals, and in step 461, the completion of the generation of a near-flat up-facing border is signalled. A near-flat up-facing border comprises a series of near-flat up-facing border vectors which are placed end to end, and which, in conjunction with their segment normals, satisfy the left hand rule.

In step 462, the segment normals are removed, the vectors are labelled as NFUB vectors, and then stored for output to the .SLI file.

In step 463, near-flat up-facing skin fill vectors are formed using the algorithms already discussed in conjunction with the NFUB vectors, and in step 464, the vectors are ordered for the reasons already discussed. In step 465, the skin fill vectors are labelled as NFUF vectors, and stored for output to the .SLI file.

In step 466, duplicate vectors are removed. Between block types, since all boundary hatch vectors are usually drawn with the same cure, and since a vector only needs to be drawn once to cure the proper amount of polymer, duplicates to vectors can be eliminated as being redundant. For example, the vectors of.type LB will be drawn first, followed by type LH boundary followed by type NFDB followed by the remaining 8 blocks this order of drawing the vector types was listed earlier in this application. Layer boundaries are placed in the .SLI file then before placing LH vectors into the .SLI file the LH vectors are compared to the LB vectors so that duplicates can be removed, then the remaining LH vectors are put into the .SLI file. Next NFDB vectors are compared to LB vectors, and LH vectors so that duplicates can be removed, then the remaining NFDB vectors are placed in the .SLI file. This procedure continues until all boundary and hatch vectors have been compared. Since skin fill vectors are usually given less cure than boundary and hatch they do not need to be drawn where they duplicate other skin vectors, boundary, or hatch vectors. So this elimination of vectors continues until all block types have been processed. With the final result being what goes into the .SLI file, in the right order of course, and in step 467, all data stored for output is stored in the .SLI file. Then, SLICE 3.20 moves back to step 407 to repeat the above-described process for the next layer. This will continue until all layers have been handled.

Figure 58 represents the process called STYLE 1 presently used by SLICE version 3.20 for building parts. The characteristic of this process, as described in the body of the application, and as illustrated in Figures 29h and 29i, is that it will build oversized parts, which can be sanded down to yield an accurate replica of the object.

Figure 72 represents another process called STYLE 2 for building oversized parts, not currently implemented in SLICE version 3.20, but which will be implemented in future versions of SLICE. This process is illustrated in Figures 30a-30j and discussed extensively in the associated text in the body of the application. However, its main differences with STYLE 1 will now be noted.

The first difference is that, as indicated in step 560 of Figure 72, layer hatch and boundary vectors are formed at 1 bit below a slicing layer as opposed to 1 bit above. The next difference is that, as indicated in step 561, down-facing flat triangles from layer n-1 are used to determine down-facing skin boundary and fill vectors for layer n. This is analogous to the creation of up-facing skin boundary and fill vectors at layer n+1 for layer n. Also, as indicated in step 562, the up-facing skin boundary and fill vectors for layer n in STYLE 2 are created at layer n.

Next, as indicted in step 563, near-flat down-facing border and skin fill vectors for layer n are created from the intersection of near-flat down-facing triangles with slicing layers n and n-1. This is in contrast to the situation in STYLE 1, where near-flat down-facing border and skin fill vectors were created from the intersection of near-flat down-facing triangles with slicing layers n and n+1. Another difference is that near-flat down-facing hatch vectors are not created in STYLE 2, while they were created in STYLE 1 to provide the necessary structural support for near-flat down-facing skin fill.

Also, as indicated in step 564, near-flat up-facing skin boundary and fill vectors for layer n are created from near-flat up-facing triangles intersecting layers n and n-1. This is in contrast to the creation of such vectors in STYLE 1 from near-flat up-facing triangles intersecting slicing layers n and n+1. Finally, as indicated in 565, near-flat up-facing hatch vectors will be generated from the near-flat up-facing border vectors. This is because in STYLE 2, unlike the situation in STYLE 1, the cured polymer from the near-flat up-facing skin boundary and fill vectors will be free floating unless hatch vectors are generated to provide structure. This is analogous to the situation in STYLE 1, where the polymer from the near-flat down-facing skin boundary and fill vectors would be left free floating unless hatch vectors were generated to provide structure.

Two additional styles, STYLES 3 and 4, are extensively discussed in the body of the application,and are also illustrated in Figures 31a-31j (STYLE 3), and in Figures 31k-31s (STYLE 4). These styles are useful for generating undersized parts, which must be filled in and cured with additional polymer in a subsequent processing step. STYLES 3 and 4 are not yet implemented in version 3.20 of SLICE, but are expected to be implemented in future versions.

Additional styles which are expected to be implemented in later versions of SLICE include the curing of a part having dimensions which are the average of the dimensions of an oversized part, as developed according to STYLES 1 and 2, and an undersized part, as developed according to styles 3 and 4. By taking the average, the part will be close in resolution to the object, and will require fewer if any post-processing sanding or filling steps. Moreover, any type of average can be taken, including but not limited to the geometric average, or arithmetic average. Parts produced according to this approach will be useful for certain high speed applications, where the time to perform the filling or sanding post-processing steps is not available, and where high precision is not important.

Another style which is expected to be available in future versions of SLICE is the use of a topological average to produce a part. In this approach, the purpose is to ensure that certain topological features of an object, i.e. a 1 mil gap between 2 blocks, or a 1 mil flagpole extending out of an object, are not lost, since such features might otherwise disappear during the stereolithography process due to rounding distortions. In those instances where certain of these topological features are necessary to reproduce in a part, this style contemplates a user being able to flag those features which must be reproduced in the final part.

A new layer border and hatch generation algorithm is expected to be implemented in future versions of SLICE. A key aspect of the algorithm is that layer boundary and hatch vectors will be generated exactly at the slicing layer, not 1 bit above as in STYLE 1, or 1 bit below, as in STYLE 2. The major advantage of this algorithm is that it will significantly ease the computational burden now required to implement STYLES 3 and 4, which burden is due to the requirement of taking intersections of areas encompassed by boundary vectors. Another benefit of this algorithm is that it will enable the detection of down-facing skin fill areas, so that full curing to 6 mil beyond the layer thickness, e.g. 26 mil, can be suppressed in these areas, and curing only to the layer thickness, e.g. 20 mil is allowed. In this instance, 6 mils of error will be eliminated.

As mentioned above, a significant benefit of generating layer border and hatch vectors at the slicing layer instead of 1 bit above or below is that it will enable flat down-facing skin fill to be generated at the correct cure thickness, e.g. 20 mil, instead of a cure thickness which is 6 mil beyond the desired cure thickness. This problem will occur because LB and LH vectors will be generated in flat down-facing skin areas, as well as areas without down-facing features. One reason why is that the LB vectors will be generated 1 bit above the slicing layer, while the FDB vectors will be generated right at the slicing layer, with the result that the LB and FDB vectors may not have the same endpoints. If they had the same endpoints, they could be recognized as duplicate vectors, and could be eliminated. The reason why the LB and LH vectors yield a cure depth of 6 mils beyond the layer thickness is that they are used to adhere adjacent cross-sections to one another, for which purpose 6 mils of extra cure depth is added. This problem is illustrated in Figure 73, which illustrates a flat down-facing area representing the bottom of a part. As indicated, the layer thickness should be 20 mil. However, cured polymer 567 results from undesired and inadequate LB (and hence LH) vectors which cause curing 6 mils beyond the 20 mil desired thickness. The elimination of the undersized LB (and LH) vectors would enable the proper cure depth, i.e. 20 mil, to be obtained as indicated at 568. STYLE 1 will generate FDH vectors for flat down-facing areas, but these vectors could be programmed to yield a 20 mil cure depth, so that eliminating the LB and LH vectors would have a beneficial impact.

The elimination of duplicate LB (and LH) vectors in flat down-facing areas can be illustrated using Figure 74, which illustrates the LB vectors, and the FDB vectors, associated with four different slicing layers of a part.

Regarding the first layer, the LB vectors are indicated as 569(A), while the FDB vectors are indicated as 569 (B). Since the LB and FDB vectors are generated at the same slice layer and completely duplicate one another, the LB vectors can be easily eliminated.

Regarding the second layer, there is no flat down-facing area to worry about.

Regarding the third layer, the LB vectors are indicated as 570(A), while the FDB vectors are indicated as 570 (B). As can be seen, the LB vectors and the FDB vectors will only be duplicated at segment 570(C), and the LB vectors for this segment can be eliminated.

In addition, the FDB vectors and their segment normals for the other 3 sides, 570(D)-570(F), will be copied to create new LB vectors for these three segments as indicated by 571 in Figure 74(B). The LB vectors are created in order to stop the generation of LH vectors in hollow region 573 in Figure 74(B). However, assuming the "net summation" hatching algorithm is in place for generating hatch vectors, since the segment normals are pointed into the solid region instead of out of the solid region, LH vectors will still be generated inside hollow area 573. Therefore, to get around this problem, the segment normals will be reversed as indicated by 572 in Figure 74(B). With this change in place, the generation of LH vectors inside region 573 will be suppressed.

With regards to layer 4, the LB vectors are indicated by 574(A), while the FDB vectors are indicated by 574 (B). The LB vectors associated with segments 574(C) and 574(F) will be removed the segments associated with 574 (D) and 574(E) will be copied into new LB vectors for these two segments. In addition, the segment normals associated with these two segments will be reversed, so that the generation of LH vectors in the flat down-facing area will be suppressed in a similar way to the suspension of those vectors in layer 3.

Another benefit of this algorithm is that it will significantly improve the computational efficiency of the STYLE 3. and 4 algorithms, and should facilitate their implementation, with the result that undersized parts can be more easily obtained. In addition, the generation of undersized parts as per STYLES 3 and 4 in conjunction with the generation of oversized parts as per STYLES 1 and 2 will enable the implementation of the averaging STYLES mentioned earlier.

STYLE 3 indicates that the layer boundaries for STYLE 3 (layer n) will surround the areas enclosed by the layer boundaries of STYLE 1 (layer n) minus the intersection of the areas enclosed by the layer boundaries of STYLE 1 (layer n) with the areas endorsed by up-facing near-flat boundaries from STYLE 1 (layer n).

Therefore, with respect to Figures 75a and 75b, the layer boundary associated with layer n is indicated as 576, which is 1 bit above the slicing layer. The up-facing near-flat boundaries are indicated as 575 and 577. The layer boundaries for STYLE 3, as called for by the above description, are the border vectors (577) for the area 579 but to obtain this from the three boundary loops requires a 2 dimensional area analysis to obtain the desired boundaries which is somewhat complex. If the layer boundary vectors and near-flat up-facing skin boundary vectors are generated at the same layer, 575 and 576 will be duplicates, and area 578 and 578(A) in Figure 75b will disappear. If duplicate vectors are removed this leaves only the area 579 and boundaries 577 remaining which are exactly the layer boundaries desired (with segment normals reversed). This will tremendously ease the computational burden required to implement STYLE 3 since the computation of the intersection called for by STYLE 3 can be implemented through simple vector addition and subtraction. Now, as indicated in Figure 75b, the intersection requires keeping track of more than one two-dimensional area, and cannot be computed using simple vector addition and subtraction.

BEAM WIDTH COMPENSATION

Beam width compensation will now be described. Beam width compensation had been implemented in previous versions of SLICE, but several improvements in the algorithm for beam width compensation are available in SLICE version 3.20.

The basic concept of beam width compensation is to adjust the border vectors of a solid inward to the solid by 1/2 of the beam width so that the final cured part will more closely resemble the original. If no compensation were made for beam width, the final cured part could be off by as much as a full beam width, i.e. 7-20 mils.

A simple adjustment of the boundary vectors by 1/2 of the beam width will, however, cause several other distortions. This section discusses several of these distortions, and the method of getting around them which have been adopted.

The first problem is the vertex problem, which will be illustrated with reference to Figure 76a.

As indicated in the Figure, the contour of an object, indicated at 583 in the Figure, forms a sharp vertex. Beam width compensation begins by moving vertex point 585 along axis 586 to 587 until the distance 581 and the distance 582 are approximately 1/2 beam width each. A problem with this approach is that the distance 580 may be several inches, which will give rise to a large distortion in the part.

One solution is to simply move the vertex closer to point 585, but this will result in distortion along the entire length of segments 583 and 584, this is the present implementation where we limit the distance 580 to less than or equal to two beam widths.

Another solution is illustrated in Figure 76b. This situation is simply to move the beam and cure the polymer from points 587 to 588 (and also to move the beam along path 589, and along path 590). This yields a much more accurate part, and is planned for implementation in the future.

A second problem is illustrated in Figure 77a. As indicated, the dotted line represents the change made to the boundary (solid line) for beam width compensation. As indicated by 591, this will result, in some instances, in a distortion around the point of a vertex. Besides the distortion, another problem is indicated in Figure 77(B), where the segment normal vectors associated with the area at the vertex have apparently reversed.

As indicated in Figure 77a, although initially all the segment normals on the border 593 point outwards, once the borders have been compensated, a situation can arise, as indicated in 591, where the segment normals vertex inward. Therefore, besides the distortion of the point, another problem is that the pointing of the segment normals will cause mis-generation of hatch vectors in the area surrounding 594. This is because the segment normals erroneously indicate that solid surrounds area 594.

In sum, the first major problem that occurs with beam width compensation is the extension of a hollow or the removal of solid at sharp points.

A second major problem with beam width compensation is the crossover problem; whereby vectors crossover each other forming sections of inside/out boundaries which can give trouble when attempting to hatch or fill between boundaries, but an additional problem exists that is whenever a crossover occurs it indicates the feature is too small to accurately draw, but in an attempt to still be as accurate as possible we should draw the boundaries with no gap between (either a gap from crossing over, or a gap from not offsetting far enough is less than the best possible representation) even to the extent of exposing it on one boundary. There have been two distinct types of crossover problems observed, type 1 shows a flipping of a vector (violation of left hand rule for vectors) whenever a crossover takes place, whereas type 2 crosses over but does not give a warning that a problem has occurred.

The type 2 vector crossover problem is illustrated in Figure 77c, whereby vector 595 is caused to crossover vector 597, and whereby vector 596 is also caused to crossover vector 597. As indicated in Figure 77b, the problem arises because compensation causes the area 594 to be formed with segment normals apparently reversed. Note that this occurred even though no flipping of segment normals took place.

The type 1 vector crossover problem is illustrated in Figures 78a-78d. Figures 78a-b illustrate the situation where beam width compensation works correctly. With respect to Figure 78a, 598 represents the layer boundary surrounding the solid of a part which has not been compensated for beam width, while 599 represents the layer boundary compensated for beam width. With respect to Figure 78b, 600 represents the passage of the laser beam along layer boundary 599, and as indicated, the compensation has yielded no distortion of the part.

In Figure 78c, on the other hand, a problem known as the crossover problem has occurred. As indicated in the Figure, 598 represents the layer boundary not yet offset, while 599 represents the offset layer boundary. Note that compensated for layer boundary 599 will be formed on a point by point basis.

First, it is assumed that the segments between endpoints 608 and 612, 612 and 611, and 611 and 610, all represent layer boundary vectors.

These vectors will be offset on an endpoint by endpoint basis. First, endpoint 608 will be moved 1/2 of the beam width along path 607 to form endpoint 601; next, endpoint 612 will be moved 1/2 beam width along path 605 to form endpoint 604; next, endpoint 611 will be moved 1/2 beam width along path 603 to form endpoint 602; and endpoint 610 is moved 1/2 beam width along path 609 to form endpoint 606. Thus, the offset for layer boundary consists of the layer border vectors 601 to 604, 604 to 602, and 602 to 606.

As a result of the compensation, border vectors 601-604, and 602-606 cross over at 613. In addition, the segment normals along the offset layer boundary no longer are consistent with the left hand rule. This is evident when considering that portion of the layer boundary which spans the area 614. As indicated, in moving clockwise around this area, (which was the original rotation of boundaries) the segment normals point into the area, and do not obey the left hand rule.

The crossover manifests itself as distortion in the final cured part. As indicated in Figure 78d, 615 represents the passage of the laser beam. As indicated, there will be significant distortion at the areas indicated by 616(A) and 616(B). This distortion is due to boundaries, if crosshatching was attempted chances are the situation would be worse.

The difference between the crossover problem illustrated in Figures 77 and 78 is that Figure 77 represents the crossover of type 2 vectors, while Figure 78 represents the crossover of type 1 vectors. In other words, Figure 78 illustrates the flipping of segment directions while Figure 77 does not. If all crossovers flipped segment directions it would be a relatively easy task to identify and correct.

The crossover in Figure 78 can be detected as follows. First, any two vectors if extended far enough will intersect at some point. With reference to Figure 78c, the intersection between vector 601-604, of vector 602-606, is determined by extending the 77 vectors if necessary. In this particular example, the vectors do not have to be extended, since they in fact already intersect at 613. Next, since the endpoints of each vector are known, the coordinates of the intersection point are compared with the endpoints of the vectors to determine whether the intersection point is situated between the endpoints of the vectors. If so, it is assumed that a crossover has occurred.

Once the crossover has been detected, there are several possible solutions. One solution is to block the migration of point 612 along with bisecting line 605, and to block the migration of point 611 along bisecting line 603 in Figure 78c to prevent a crossover. This can be accomplished by locating the midpoint of bisecting line 605, and preventing point 612 from moving beyond the midpoint. In addition, the midpoint of bisecting line 603 is determined, and point 611 will be prevented from moving beyond that midpoint.

The end result is indicated in Figure 78e. The problem that occurs with this solution is that there may be significant distortion along the lengths of boundary vectors 608-612, and 610-611. This is because the distance between these boundary vectors and the offset boundary vectors will no longer be 1/2 the beam width along the entire length of the boundary vectors. With respect to Figure 78e, although the distance between the points 601 and 608, and between 606 and 610, as by indicated 617 and 619 respectively, is still 1/2 the beam width, the distances 618 and 620 may be substantially less than 1/2 the beam width.

Another problem that may occur with this approach is that the proper migration of vector endpoints may be blocked even if there would have been no crossover. This situation is illustrated with respect to Figure 79.

As indicated in the Figure, beam width compensation begins by first moving endpoint 626 1/2 beam width along path 627 to point 623. Next, the algorithm attempts to move endpoint 624 along path 625 to point 621, where it is simultaneously 1/2 bean width from the local portion of the layer boundary. However, as indicated earlier, the above algorithm will prevent point 622 from moving beyond the midpoint of line segment 624-621, and this point ends up at 622. Moreover, this point is less than 1/2 the beam width from boundary vector 624-626, and so significant distortion along this path will be introduced. This in spite of the fact that the point could have been left at 621 with no crossover occurring.

A third problem is that the algorithm of blocking migration of the endpoints to the extent it is effective, is only effective in correcting for the crossover of type 1 vectors. It does not deal with the problem of crossover of type 2 vectors which is illustrated in Figures 77a-77c.

A suggested algorithm for handling the aforementioned problems will now be described.

The algorithm proceeds by sequentially offsetting the endpoints of each boundary vector that forms a loop, one endpoint at a time. After each endpoint is offset, the algorithm checks for crossover, and if present, the algorithm modifies the endpoints appropriately without adherence to a fixed rule based on blocking migration of the endpoints along a bisecting line.

The algorithm solves the problem of false positive detection of crossovers problem mentioned above with respect to Figure 79 since it is invoked only if an actual crossover is detected. In addition, as will be seen, the algorithm works even for type 2 crossed-over vectors.

As mentioned above, once a crossover is detected, the algorithm backs off on the migration of an endpoint to the extent necessary to prevent crossover. The algorithm is not limited to backing up an endpoint to the midway point at a bisecting line, as discussed above.

The operation of the algorithm can be explained with reference to Figure 80. With reference to Figure 80a, endpoint 608 of boundary vector 608-612 is offset by 1/2 beam width to point 601 and a crossover checked for. Since no crossover is present, the boundary vectors are now considered to be the vectors 601-612, 612-611, and 611-610. With reference to Figure 80b, endpoint 612 of vector 601-612 is now offset 1/2 beam width to point 604, and a crossover checked for. Since no crossover is detected, the boundary vectors are now considered to the vectors 601-604, 604-611, and 611-610. With reference to Figure 80c, endpoint 611 is next offset 1/2 beam width to point 602, and a crossover checked for. At this point, the boundary vectors are tentatively considered to be 601-604, 604-602, and 602-610.

As before, a crossover will be detected by computing the point of intersection on a pairwise basis between all boundary vectors in a loop, and then checking to see whether this point is an internal point, i.e. between the endpoints, for the vectors under consideration. In the example of Figure 80c, the following two pairwise comparisons of the vectors will be made: 601-604 with 604-602, and 601-604 with 602-610. At this stage of processing, the algorithm will detect a crossover during the latter pairwise comparison.

The next stage of processing is to decide to what extent to back off the movement of the vector endpoints in order to avoid the crossover. One approach, illustrated in Figure 81a, is simply to delete the portions of the vectors indicated by 614 to arrive at the boundary vector illustrated in Figure 81b. Alternatively, the area indicated by 614 could be collapsed into a single vector as indicated by 615 in Figure 81c. Other approaches to backing off endpoints to avoid crossover are possible.

The above illustrated the use of the algorithm in detecting and correcting the crossover of adjoining vectors. Next, the operation of the algorithm in detecting and correcting for crossover of type 2 vectors will be described.

With reference to Figure 82a, endpoint 617 is offset 1/2 beam width to 619, and crossover checked for. As before, a pairwise comparison and crossover check of all the boundary vectors in a loop will be performed. Since none is detected, the algorithm proceeds. Then, with reference to Figure 82b, endpoint 618 is moved to 621, and a pairwise crossover check performed. Since none is detected, the algorithm proceeds. Next, with reference to Figure 82c, endpoint 620 is moved to 623, and a pairwise crossover check is performed. Since none is detected, the algorithm proceeds.

With reference to Figure 82d, endpoint 622 is moved to 624, and a pairwise crossover check performed. Since none is detected, the algorithm proceeds.

With reference to Figure 82e endpoint 625 is moved to 626, and a pairwise crossover check performed. At this point, crossovers between vectors 624-626 and 619-621, and between vectors 626-627 and 619-621, are detected.

The next step in the algorithm is to determine how to back off the endpoints to prevent crossover. With reference to Figure 83a, one approach is to simply cut off the vectors in the circled area indicated by 628 in order to arrive at the boundary vectors indicated by Figure 83b.

An aspect of the algorithm is that the detection and correction of crossovers will depend on which endpoint of which vector is used to begin the sequence of offsetting steps. In Figure 83c, for example, the endpoint indicated by 629 was used to begin the offsetting process, and assuming the sequencing of endpoints proceeds counter-clockwise, a crossover was detected when endpoint 630 is moved to 631. At this point, one approach to backing off would consist of moving endpoint 631 closer to 630, and also moving endpoint 633 closer to 632 so that the situation illustrated in Figure 83d results.

Another approach to backing off, which will be independent of the endpoint where offsetting begins, is to complete offsetting even after a crossover has been detected until all endpoints of all boundary vectors in the loop have been offset, and to then make a decision as to the optimal way to back off.

<u>IMPLEMENTATION OF BEAM-WIDTH COMPENSATION</u>

At present, beam width compensation is implemented using beam width measurements taken from the banjotops. These measurements are input by a user, and used to determine the offsets of the boundary vectors. Required offset is manually specified as a parameter to SLICE.

An alternative implementation, which will be available in future versions of the system, is to estimate the appropriate offset adjustment by combining beam profile information with known and measured properties of the resin. This is known as automatic beam width compensation.

The appropriate offset adjustment will be derived from a prediction of the profile of a cured trace which prediction is obtained from beam intensity profile measurements and known properties of the resin. This is described in a patent application, pertaining to a method and apparatus for beam profiling; S.N. 268,816.

Alternatively, the beam width adjustment can still be determined from the banjotop measurements, with the banjotop measurements recalibrated using changes in the beam intensity profile since the banjotops were last run.

Beam width compensation is presently implemented in SLICE version 3.20. Several steps have been added to SLICE version 3.20 for beam width compensation, which steps are not reflected in Figures 58 and 72. These steps will now be described.

With reference to Figure 84, which is the STYLE 1 flowchart of SLICE, the step of performing beam width compensation will be performed on all the border vector types before the vector data is written out to the .SLI file, and before hatch and skin fill vectors are generated from the border vector data. Therefore, as indicated in Figure 84, beam width compensation steps 634-638 will be respectively added for layer boundary vectors, flat down-facing border vectors, flat up-facing border vectors, near-flat down-facing border vectors, and near-flat up-facing border vectors.

The beam width compensation substeps for each border vector type will be the same, which substeps are flow-charted in Figure 85. As indicated, in substep 639, the segment normals for the boundary vectors are recomputed if not already done so in previous processing steps. As indicated in Figure 84, the recalibration of segment normals is presently being performed for all but the boundary layer vectors. In the absence of beam width compensation, it is not necessary to recompute the segment normals for these vectors, since they are only being used to generate hatch and skin fill vectors, and any flips of segments normals will be corrected for by the "net summation" hatch or skin fill vector generation algorithm.

With beam width compensation, however, the segment normals are used in the offsetting substep (substep 641 in Figure 85) to determine in what direction the offset should be. Since the segment normals should point away from a solid, the offset is performed in the opposite direction to the segment normal. Therefore, it is now necessary to recompute segment normals for layer border vectors. For the other border vector types, this substep, indicated as optional in the Figures 58 and 72 flowcharts, is mandatory in Figures 84 and 85. As discussed earlier, segment normals may get reversed because of the flipping of triangles due to rounding. In this substep, they are corrected for by using the left hand rule, and by checking against the segment normals of other border vectors in the loop.

In substep 640, overlapping border vectors are combined, and point vectors are removed. This substep is performed because it allows small vectors to be attached to longer vectors thereby removing some of the improper offsetting that results from limiting endpoint offsetting when the only fear of crossover exists instead of basing offset limiting what this step really does is attempt to line up vectors that changed directions due to integration. In addition, this substep represents a significant departure of SLICE version 3.20 from past versions of SLICE. Since it lays the ground work for implementing the improved offsetting algorithm based on crossover detect.

Substeps 641-644 have already been discussed extensively. In substep 641, an endpoint of a boundary vector is offset in the direction opposite its segment normal, and the boundary vectors tentatively recomputed. In substep 642, a precise comparison of the boundary vectors in the loop is performed to detect a crossover. If a crossover is not detected, in substep 643, the changes to the boundary vectors are made permanent, and the process repeats with the next endpoint in the loop. If a crossover is detected, in substep 644, the endpoint last offset is backed up until the crossover is eliminated, the border vectors recomputed and the changes made permanent, and the process is repeated with the next endpoint in the loop.

WET SUPPORTS

Web supports are described in U. S. Patent Application S.N. 182,801. In addition, web supports are described in the Training Manual attached as Appendix D.

Web supports are presently being used to support a part while it is being created and possibly post-cured. Their primary advantage is that they provide good structural support parallel to the axis of the support, which is the axis along which the web is formed.

Another benefit of web supports is their ease of creation. At present, there are two ways to create web supports: 1) in the CAD/CAM system, wherein the web supports are defined each as individual miniature boxes, i.e. tall, long and narrow, and 2) by creating a box with internal cross-hatching below the part being cured. In this latter approach, the already implemented SLICE algorithms for generating hatch vectors could be used to generate the web supports. The box could be created in a separate .STL file, placed into its own .SLI file, then merged with the Object.SLI file after slicing. Specifically, a straight web could be created by hatching in the X or Y directions (not both). A criss-crossed web support could be implemented by hatching in the X and Y directions. A triangular web support could be implemented by hatching at 60/120 degrees and in either the X or the Y directions. In addition, the hatch spacing should be chosen to be 1/4" to 1" depending on the support needed.

A third benefit is that the platform of the z-stage elevator typically has holes in it, and web supports will not fall into the holes, unlike other types of supports, which can.

A fourth benefit is that web supports will be built on the platform at the time when the part is being built. Each layer of the part is cured by first curing its border vectors, followed by its hatch or skin fill vectors. In curing the polymer at the border, a problem called birdnesting may arise. Birdnesting is a distortion that occurs when cured polymer representing a border of a layer is cured and left free-floating in the resin. The distortion results through the delay in the drawing of hatch and skin fill vectors, which will provide structure to the border. By the time the hatch or skin fill vectors are drawn, the border may have moved due to movement of the liquid polymer in which it is floating. Birdnesting is discussed in more detail in related co-pending U. S. Patent Application S.N. 183,015.

By drawing web supports before part boundaries they help solve the birdnesting problem since they provide a support that the polymer created by drawing the border vectors can adhere to before the hatch and skin fill vectors are drawn. With other types of supports, i.e. post supports, the polymer drawn from the border vectors will typically surround and not adhere to the posts, so that birdnesting still will be a problem.

The new and improved stereolithographic method and apparatus has many advantages over currently used methods for producing plastic objects. The method avoids the need of producing tooling drawings and tooling. The designer can work directly with the computer and a stereolithographic device, and when he is satisfied with the design as displayed on the output screen of the computer, he can fabricate a part for direct examination information defining the object being specially processed to reduce cure and distortion, and increase resolution, strength and accuracy of reproduction. If the design has to be modified, it can be easily done through the computer, and then another part can be made to verify that the change was correct. If the design calls for several parts with interacting design parameters, the method becomes even more useful because all of the part designs can be quickly changed and made again so that the total assembly can be made and examined, repeatedly if necessary. Moreover, the data manipulation techniques of the present invention enable production of objects with reduced stress, curl and distortion, and increased resolution, strength accuracy, speed and economy of production, even for difficult and complex object shapes.

After the design is complete, part production can begin immediately, so that the weeks and months between design and production are avoided. Ultimate production rates and parts costs should be similar to current injection molding costs for short run production, with even lower labor costs than those associated with injection molding. Injection molding is economical only when large numbers.of identical parts are required. Stereolithography is particularly useful for short run production because the need for tooling is eliminated and production set-up time is minimal. Likewise, design changes and custom parts are easily provided using the technique. Because of the ease of making parts, stereolithography can allow plastic parts to be used in many places where metal or other material parts are now used. Moreover, it allows plastic models of objects to be quickly and economically provided, prior to the decision to make more expensive metal or other material parts.

While a variety of stereolithographic systems have been disclosed for the practice of the present invention, they all have in common the concept of drawing upon a substantially two-dimensional surface and extracting a three-dimensional object from that surface.

The present invention satisfies a long existing need in the art for a CAD/CAM-interfaceable system capable of rapidly, reliably, accurately and economically designing and fabricating three-dimensional plastic parts and the like.

It will be apparent from the foregoing that, while particular forms of the invention have been illustrated and described, various modifications can be made without departing from the scope of the invention as defined in the appended claims. Accordingly, it is not intended that the invention be limited, except as by the appended claims.

Please now refer to the attached annexes which form part of the description.

APPENDIX A

# SLA-1

# BETA SITE

# STEREOLITHOGRAPHY

# SYSTEM

CONFIDENTIAL LEGENDS ON THIS APPENDIX ARE TO BE CONSIDERED DELETED.

3D Systems Incorporated
12847 Arroyo Street
Sylmar, California 91342
(818) 898-1533 ● FAX (818) 361-5484

NOVEMBER 1987

systems, inc.

**NOT TO BE DISCLOSED**

THIS DOCUMENT CONTAINS CONFIDENTIAL INFORMATION RELATING TO STEREOLITHOGRAPHY PROCESSES AND EQUIPMENT WHICH ARE THE EXCLUSIVE PROPERTY OF 3D SYSTEMS, INC. THIS INFORMATION SHALL NOT BE DUPLICATED, USED OR DISCLOSED -- IN WHOLE OR IN PART -- FOR ANY PURPOSE OTHER THAN TRAINING AS AUTHORIZED IN WRITING BY 3D SYSTEMS, INC. ALL REASONABLE PRECAUTIONS SHALL BE TAKEN TO SURE COMPLIANCE WITH THESE CONDITIONS.

THE POSSESSION OF THIS DOCUMENT CONVEYS NO PROPERTY RIGHT OR LICENSE IN THE INFORMATION NOR IN ANY MATTER DISCLOSED THEREIN.

# SLA-1

# BETA SITE

# STEREOLITHOGRAPHY

# SYSTEM

# USER'S MANUAL


TABLE OF CONTENTS

INTRODUCTION

DESCRIPTION AND GENERAL INFORMATION

CONTROLS AND INDICATORS

OPERATING INSTRUCTIONS

TROUBLESHOOTING

OPERATOR MAINTENANCE INSTRUCTIONS



3D Systems Incorporated
12847 Arroyo Street
Sylmar, California 91342
(818) 898-1533 • FAX (818) 361-5484


NOVEMBER 1987

# Safety Precautions

**WARNING**
**INVISIBLE LASER RADIATION**

UV LASER RADIATION MAY DAMAGE EYE TISSUE. AVOID DIRECT EXPOSURE TO LASER BEAM. WEAR UV BLOCKING SAFETY GLASSES.

**WARNING**
**HIGH VOLTAGE**

HAZARDOUS VOLTAGES ARE ACCESSIBLE WITH MAINTENANCE PANELS REMOVED. FOLLOW SAFE WORK PRACTICES.

**WARNING**
**CHEMICAL HAZARDS**

UV CURABLE RESINS MAY CAUSE EYE AND SKIN BURNS. REPEATED OR PROLONGED SKIN CONTACT MAY CAUSE SENSITIZATION. VAPOR MAY BE HARMFUL.

Observe the following safety precautions when cleaning spilled resin or handling resin containers.

- Keep away from heat, sparks and flame. Protect from sunlight and fluorescent light. Closed containers may rupture/explode when exposed to extreme heat. Use National Fire Protection Association Class B extinguishers (carbon dioxide, dry chemical or foam).
- Use only with adequate ventilation. Avoid breathing vapors or spray mist.
- Wear safety glasses.
- Wear chemically resistant gloves and protective clothing. Wash thoroughly after handling and before eating, smoking or using toilet facilities.
- Wear an NIOSH/MSHA approved respirator or ensure adequate ventilation when sanding or cutting cured objects.

FIRST AID FOR CHEMICAL ACCIDENTS

**Skin Contact.** Wash thoroughly with soap and water. Remove contaminated clothing and shoes immediately. If skin is irritated, get medical attention. Wash clothing before reuse and discard contaminated shoes.

**Eye Contact.** Flush immediately with large amounts of water for 15 minutes and avoid sunlight, fluorescent light, or other ultraviolet light. Get medical attention.

**Inhalation.** Remove victim to fresh air. Give artificial respiration or cardio-pulminary resuscitation if required. If breathing is difficult, give oxygen. Get medical attention.

TABLE OF CONTENTS

| Section/Paragraph | Title | Page |
| --- | --- | --- |
| | INTRODUCTION | vi |

(continued)

TABLE OF CONTENTS


| Section/Paragraph | Title | Page |
|---|---|---|
| I | DESCRIPTION AND OPERATION | 1-1 |
| 1.1 | Purpose | 1-1 |
| 1.2 | Description | 1-1 |
| 1.2.1 | Stereolithography Process | 1-1 |
| 2.2 | Stereolithography System | 1-4 |
| 1.2.2.1 | Electronic Cabinet Assembly ..... | 1-8 |
| 1.2.2.2 | Optics Assembly | 1-8 |
| 1.2.2.3 | Chamber Assembly | 1-9 |
| 1.2.3 | Software | 1-10 |
| 1.3 | Performance Specification | 1-12 |
| | | |
| II | CONTROLS AND INDICATORS | 2-1 |
| 2.1 | Introduction | 2-1 |
| 2.2 | Control Panel | 2-1 |
| | | |
| III | OPERATING INSTRUCTIONS | 3-1 |
| 3.1 | Introduction | 3-1 |
| 3.2 | Materials and Equipment | 3-1 |
| 3.3 | CAD Design to SLA-1 Parts | 3-2 |
| 3.3.1 | How to Design CAD Parts for SLA-1 | 3-2 |
| 3.3.2 | Rules for Design of Parts | 3-2 |
| 3.3.3 | How to Design Support Files for SLA-1 | 3-3 |
| 3.4 | Rules for Design of Supports | 3-3 |
| 3.4 | Slice Operation | 3-3 |
| 3.4.1 | How to Slice Files | 3-3 |
| 3.4.2 | Rules for Slicing | 3-4 |
| 3.4.3 | How to Run User Interface | 3-4 |
| 3.5 | SLA-1 Operation | 3-7 |
| 3.5.1 | Turn-On Procedure | 3-7 |
| 3.5.2 | How to Transfer Files form Slice Computer to Process Computer | 3-7 |
| 3.5.3 | How to Insert Critical Volumes | 3-8 |
| 3.5.4 | How to Merge Sliced Files | 3-10 |
| 3.5.5 | How to Operate SLA-1 to Build Parts | 3-10 |
| 3.5.5.1 | Rules for Building SLA-1 Parts | 3-10 |
| 3.5.5.2 | How to Edit Part Control Files | 3-11 |
| 3.5.5.3 | How to Prepare Default Parameter Files | 3-13 |
| 3.5.5.4 | Operator's Checklist Before Starting a Part | 3-14 |
| 3.5.5.5 | How to Run Supervisor to Make a Part | 3-16 |
| 3.5.5.6 | Post Processing of SLA-1 Parts | 3-17 |
| 3.5.5.7 | Shutdown Procedures | 3-20 |
| 3.5.5.8 | How to Create and Use Working Curves | 3-20 |
| | | |
| IV | TROUBLESHOOTING | 4-1 |
| 4.1 | Introduction | 4-1 |
| 4.2 | Troubleshooting Procedures | 4-1 |
| | | |
| V | OPERATOR MAINTENANCE INSTRUCTIONS | 5-1 |
| 5.1 | Introduction | 5-1 |

(continued)

TABLE OF CONTENTS


| Section/Paragraph | Title | Page |
|---|---|---|
| 5.2 | Materials and Equipment | 5-1 |
| 5.3 | Resin Cleaning/Replenishment Procedures ..... | 5-2 |
| 5.3.1 | Cleanup of Small Resin Spills | 5-2 |
| 5.3.2 | Cleanup of Large Resin Spills | 5-3 |
| 5.3.3 | Vat Replenishment | 5-4 |
| 5.4 | Optics Cleaning | 5-4 |
| 5.4.1 . | Equipment Required | 5-4 |
| 5.4.2 | Care and Handling of Optics | 5-7 |
| 5.4.3 | Laser Brewster Windows | 5-7 |
| 5.4.4 | Laser Resinator Windows | 5-7 |
| 5.4.5 | 90 Degree Beam-Turning Mirrors | 5-7 |
| 5.4.6 | Beam Expander Lenses | 5-8 |
| 5.4.7 | Galvanometer-Driven Dynamic Mirrors | 5-10 |
| 5.4.8 | Laser Chamber Window | 5-11 |
| 5.5 | Replacement Procedures | 5-13 |
| 5.5.1 | Air Filter Replacement | 5-13 |
| 5.5.2 | Chamber Lamp | 5-13 |
| 5.5.3 | Control Panel Lamps | 5-15 |
| | GLOSSARY | G-1 |


LIST OF FIGURES


| Figure | Title | Page |
|---|---|---|
| 1-1 | Key Steps in the Stereolithography Process | 1-2 |
| 1-2 | Major Components of the Stereolithography System | 1-5 |
| 1-3 | Block Diagram of the Stereolithography System | 1-7 |
| 1-4 | Software Diagram of the Stereolithography System | 1-11 |
| 2-1 | Control Panel Switches and Indicators | 2-2 |
| 3-1 | Sample Part Log | 3-12 |
| 3-1 | Sample Working Curve | 3-22 |
| 5-1 | Recommended Optics Cleaning Technique | 5-5 |
| 5-2 | Air Filter Replacement | 5-14 |


LIST OF TABLES


| Figure | Title | Page |
|---|---|---|
| 1-1 | Beta SLA-1 Performance Specifications | 1-12 |
| 4-1 | Troubleshooting Procedures | 4-2 |
| 5-1 | Maintenance Materials and Equipment | 5-1 |

INTRODUCTION

SCOPE

This manual contains operation and maintenance procedures and information for the SLA-1 Beta Site Stereolithography System. The maintenance procedures are limited in scope to routine maintenance to be performed by the SLA-1 operator, such as filter replacement. Service and repairs not covered in this manual shall be performed by qualified technicians in accordance with the SLA-1 Service Manual.

ORGANIZATION

This manual is divided into five sections, as follows:

SECTION I. DESCRIPTION AND GENERAL INFORMATION - Physical and functional descriptions of the SLA-1 and a list of performance specifications.

SECTION II. CONTROLS AND INDICATORS - Description of each operator control and indicator.

SECTION III. OPERATING INSTRUCTIONS - Operating procedures and information.

SECTION IV. TROUBLESHOOTING - Diagnostic and correction procedures.

SECTION V. OPERATOR MAINTENANCE INSTRUCTIONS - Procedures for routine maintenance.

OTHER FEATURES OF INTEREST

Title Page Index. On the right side of the title page you will find a section index. The black markers printed to the right of the text are keyed to similar markers on the first page of each referenced section. To locate a section, flip through the manual until you find a marker printed in the same location as the title page marker.

Warning Pages. Following the title page you will find a summary of critical warnings. You may be seriously injured if these warnings are not explicitly followed. Carefully read all warnings and first aid instructions prior to operation or maintenance of the SLA-1.

REPORTING ERRORS AND RECOMMENDING IMPROVEMENTS

This manual was prepared for use by Beta Site users and maintenance personnel. It will be revised to incorporate recommended content and format changes. If you find any mistakes or if you have any recommendations for improving the procedures, please let us know by sending a copy of the marked-up page(s) to:

Attn: Chick Lewis
3D Systems Inc.
12847 Arroyo St.
Sylmar, California 91342
(818) 898-1533 • FAX (818) 361-5484

SECTION I

DESCRIPTION AND GENERAL INFORMATION

1.1 PURPOSE

The SLA-1 Stereolithography System produces three-dimensional parts directly from a CAD system. The formed objects, up to nine inches in any dimension, are made of photocurable plastic. They can be used in a wide variety of applications, including:

- Industrial Engineering
- Design Engineering

- Architectural Design
- Medical
- Scientific

1.2 DESCRIPTION

1.2.1 Stereolithography Process. Stereolithography is a three-dimensional printing process which uses a moving laser beam to build parts by solidifying successive layers of liquid plastic. This method enables a designer to create a design on a CAD system and build an accurate plastic model in a few hours. The stereolithographic process is composed of the following eight steps, as shown in Figure 1-1.

- Design solid model
- Prepare model for stereolithography
- Section model into triangles and reduce data for transmission
- Transmit data file to SLA-1 slice computer
- Slice triangle files horizontally
- Calculate vectors and add hatch and fill
- Form object
- Post processing

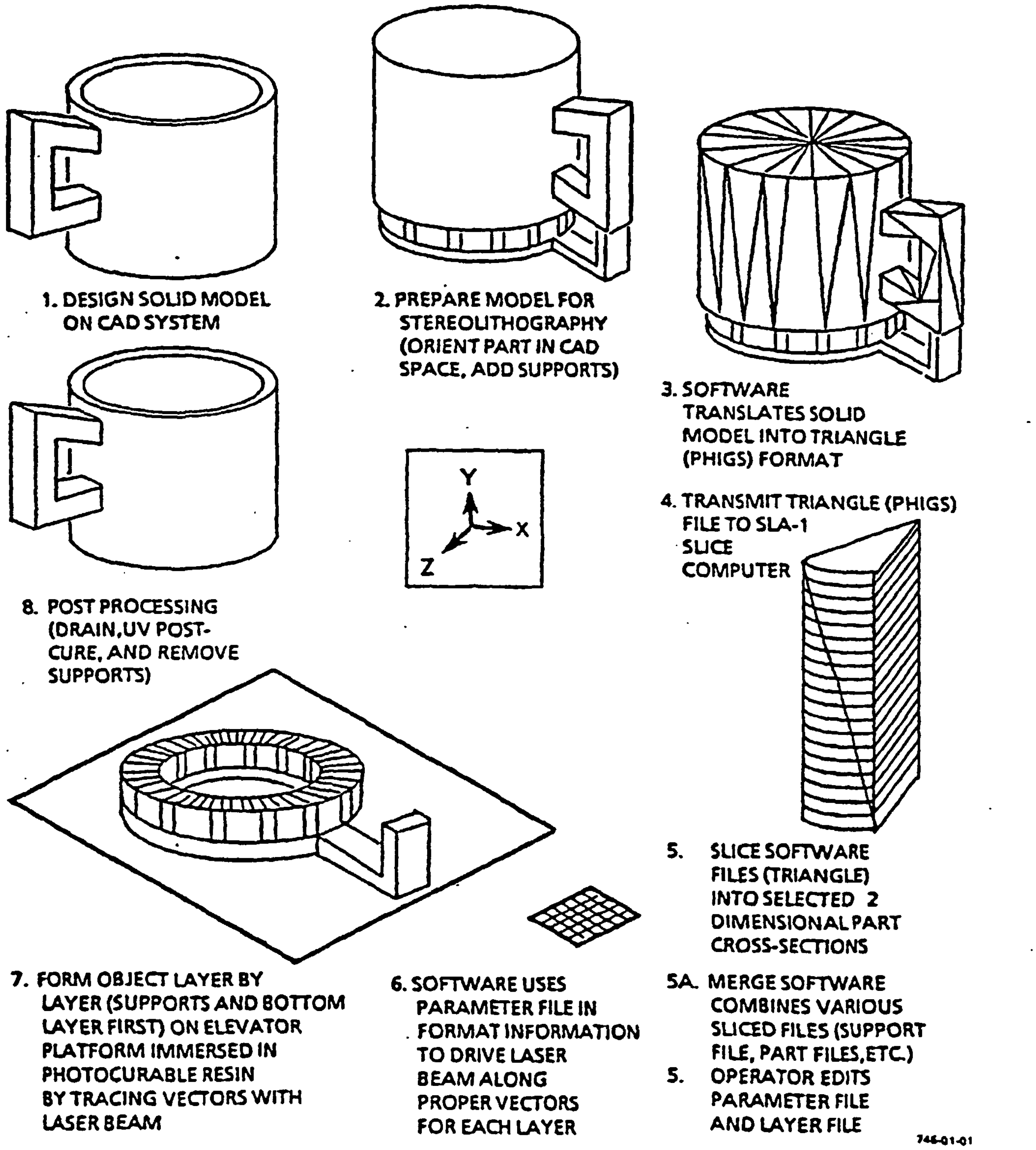


*Figure 1-1. Key Steps in the Stereolithography Process*

1. The solid model is designed in the normal way on the CAD system, without specific reference to the stereolithographic process. A copy of the model is made for stereolithographic processing.

2. Model preparation for stereolithography involves selecting the optimum orientation, adding supports, and selecting SLA-1 operating parameters. The optimum orientation will (1) enable the object to drain, (2) have the least number of unsupported surfaces, (3) optimize important surfaces, and (4) enable the object to fit in the resin vat. Supports must be added to secure unattached sections and for other purposes; a CAD library of supports can be prepared for this purpose. SLA-1 operating parameters include selection of the model scale and layer (slice) thickness.

3. The surface of the solid model is then divided into triangles. A triangle is the least complex polygon for vector calculations. The Beta SLA-1 capability is approaching 200,000 triangles, with further improvements planned for the production SLA-1. The more triangles formed, the better the surface resolution and hence the more accurate the formed object with repect to the CAD design.

4. Data points representing the triangle coordinates are then transmitted to the SLA-1 via Ethernet communication. The SLA-1 software slices the triangular sections horizontally (X-Y plane) at the selected layer thickness.

5. The SLA-1 next calculates the section boundary, hatch, and horizontal surface (skin) vectors. Hatch vectors consist of cross-hatching between the boundary vectors. Several styles are available. Skin vectors, which are traced at high speed and with a large overlap, form the outside horizontal surfaces of the object. Interior horizontal areas, those within top and bottom skins, are not filled in other than by cross-hatch vectors.

6. The SLA-1 forms the object one horizontal layer at a time by moving the ultraviolet beam of a helium-cadmium laser across the surface of a photocurable resin and solidifying the liquid where it strikes. Absorption in the resin prevents the laser light from penetrating deeply and allows a thin layer to be formed. Each layer is comprised of vectors which are drawn in the following order: border, hatch, and surface.

7. The first layer that is drawn adheres to a horizontal platform located just below the liquid surface. This platform is attached to an elevator which then lowers it vertically under computer control. After drawing a layer, the platform dips several millimeters into the liquid to coat the previous cured layer with fresh liquid, then rises up a smaller distance leaving a thin film of liquid from which the second layer will be formed. After a pause to allow the liquid surface to flatten out, the next layer is drawn. Since the resin has adhesive properties, the second layer becomes firmly attached to the first. This process is repeated until all the layers have been drawn and the entire three-dimensional object is formed. Normally, the bottom 0.25 inch or so of the object is a support structure on which the desired part is built. Resin that has not been exposed to light remains in the vat to be used for the next part. There is very little waste of material.

8. Post processing involves heating the formed object to remove excess resin, ultraviolet or heat curing to complete polymerization, and removing supports. Additional processing, including sanding and assembly into working models, may also be performed.

1.2.2 Stereolithography System. The SLA-1 is a self-contained system that interfaces directly with the user's CAD system. The SLA-1, as shown in Figure 1-2, consists of four major component groups: the slice computer terminal, the electronic cabinet assembly, the optics assembly, and the chamber assembly. A block diagram of the SLA-1 is shown in Figure 1-3.

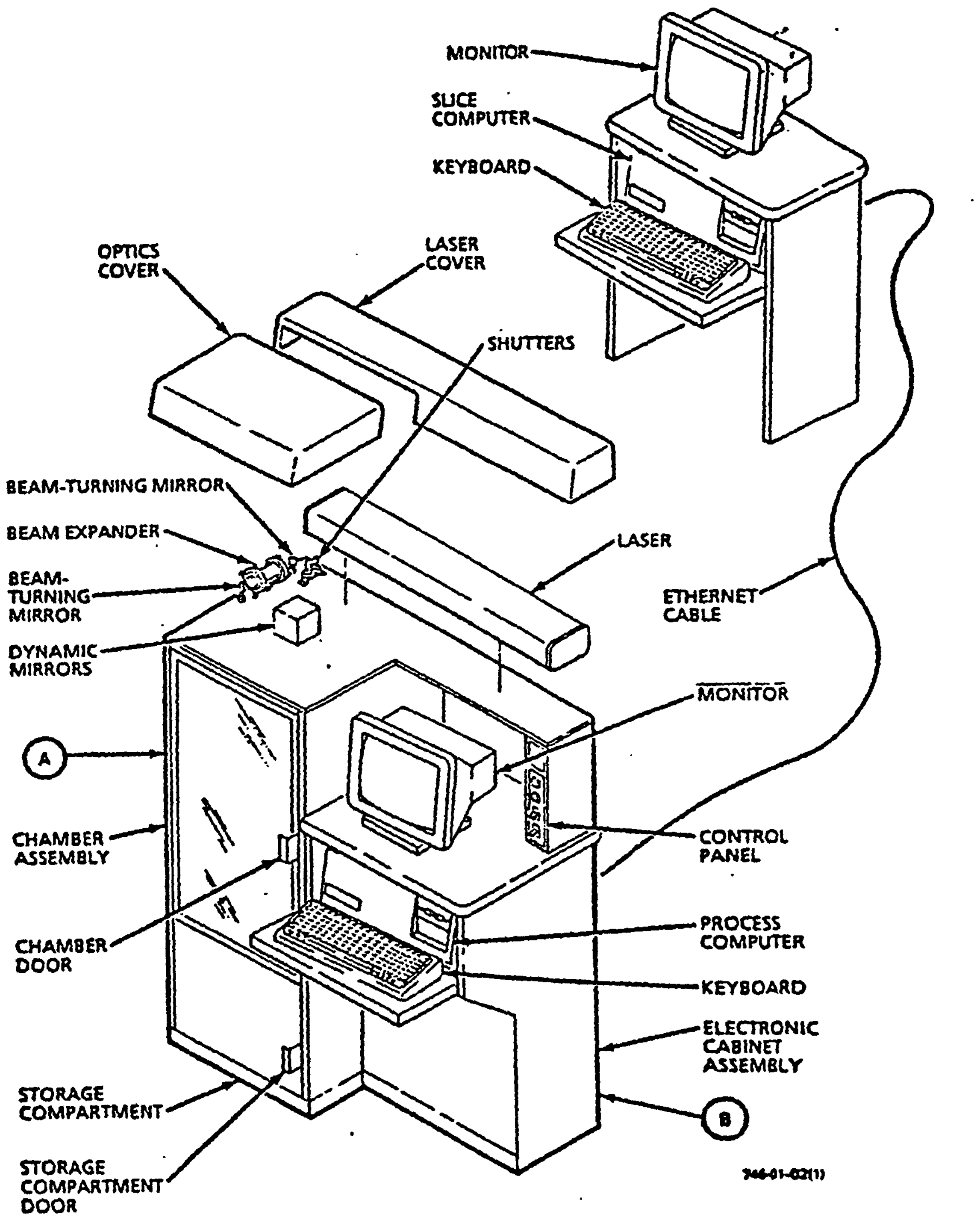


*Figure 1-2. Major Components of the Stereolithography System (Sheet 1 of 2)*

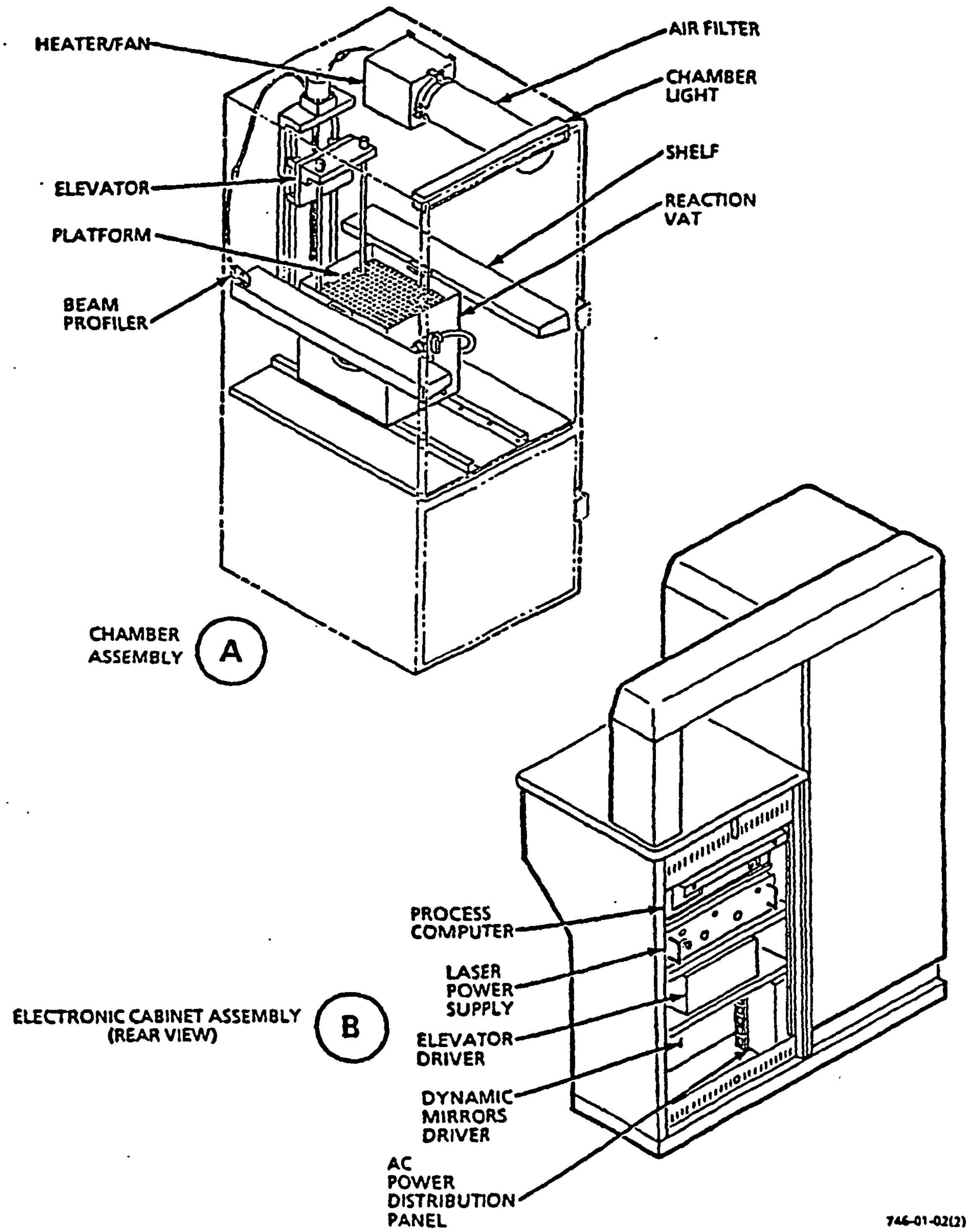


*Figure 1-2. Major Components of the Stereolithography System (Sheet 2 of 2)*

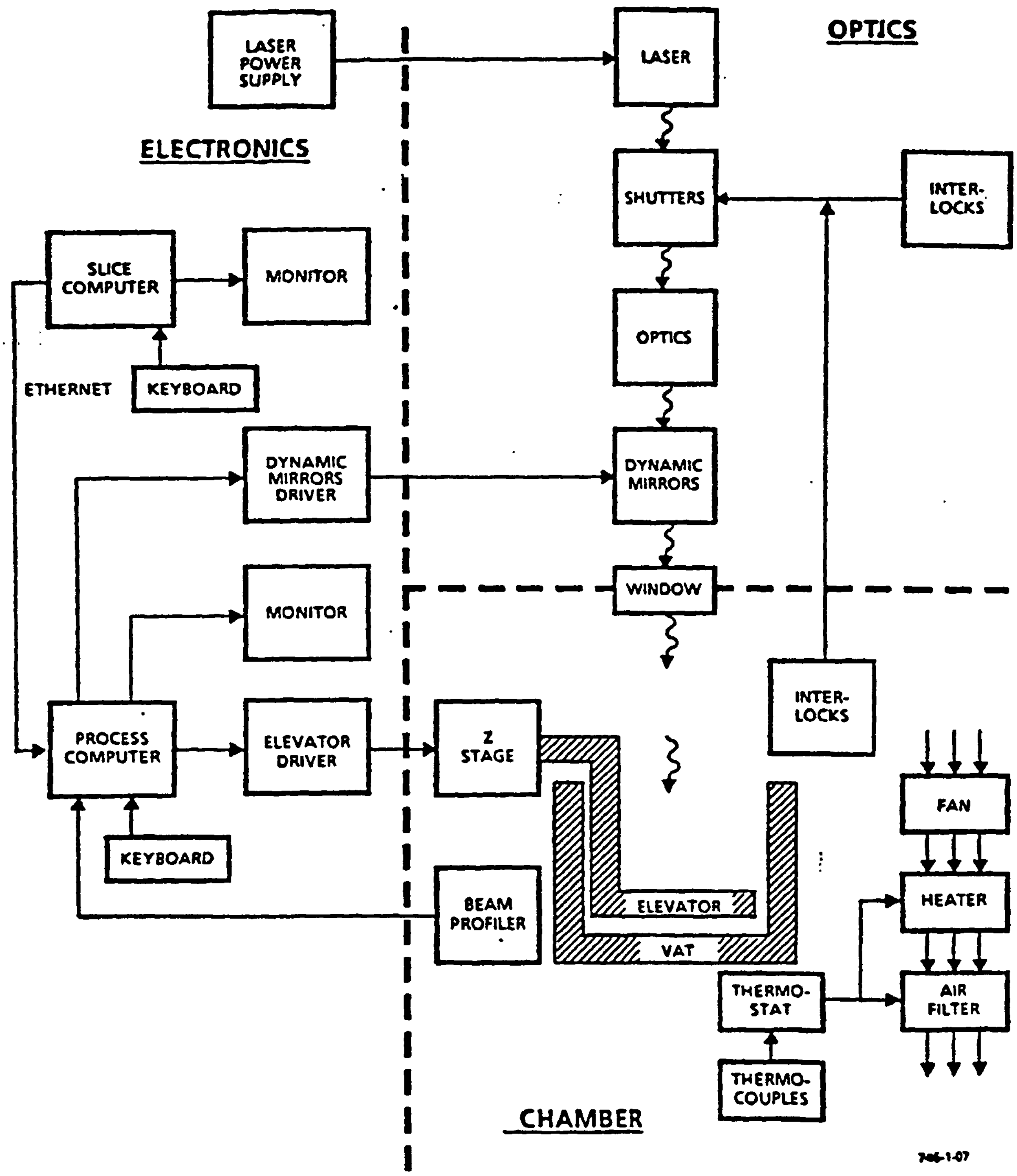


*Figure 1-3. Block Diagram of the Stereolithography System*

1.2.2.1 Electronic Cabinet Assembly. The electronic cabinet assembly includes the process computer (disc drive), keyboard, monitor, power supplies, ac power distribution panel, and control panel. The computer assembly includes plug-in circuit boards for control of the terminal, high-speed scanner mirrors, and vertical (Z-stage) elevator. Power supplies for the laser, dynamic mirrors, and elevator motor are mounted in the lower portion of the cabinet.

The control panel includes a power on switch/indicator, a chamber light switch/indicator, a laser on indicator, and a shutter open indicator.

Operation and maintenance parameters, including fault diagnostics and laser performance information, are displayed on the monitor. Operation is controlled by keyboard entries. Work surfaces around the key-board and disc drive are covered with formica for easy cleaning and long wear.

1.2.2.2 Optics Assembly. The helium cadmium (HeCd) laser and optical components are mounted on top of the electronic cabinet and chamber assembly. The laser and optics plate may be accessed for service by removing separate covers. For safety reasons, a special tool is required to unlock the cover fasteners and interlock switches are activated when the covers are removed. The interlocks activate a solenoid-controlled shutter to block the laser beam when either cover is removed.

An optics cleaning kit and interlock shorting tool are located under the optics cover. The cleaning kit includes cotton swabs, special cleaning tissues, and materials for cleaning the beam-turning mirrors and beam expander lenses. The interlock shorting tool is used to defeat the interlocks during servicing. This is necessary to enable optics alignment and servicing procedures which require operation of the laser with the optics and laser covers removed.

The shutter assembly, two 90° beam-turning mirrors, beam expander, scanning mirror assembly, and optical window are mounted on the optics plate. The rotary solenoid-actuated shutters are installed at the laser output and rotate to block the beam when a safety interlock is opened. The 90° beam-turning mirrors reflect the laser beam to the next optical component. The beam expander enlarges and focuses the laser beam on the liquid surface. The high speed scanning mirrors direct the laser beam to trace vectors on the resin surface. A quartz window between the optics enclosure and reaction chamber allows the laser beam to pass into the reaction chamber, but otherwise isolates the two regions.

1.2.2.3 Chamber Assembly. The chamber assembly contains an environmentally-controlled chamber, which houses a platform, reaction vat, elevator, and beam profiler.

The chamber in which the object is formed is designed for operator safety and to ensure uniform operating conditions. The chamber may be heated to approximately 40°C (104°F) and the air is circulated and filtered. An overhead light illuminates the reaction vat and work surfaces. An interlock on the glass access door activates a shutter to block the laser beam when opened.

The reaction vat is designed to minimize handling of the resin. It is installed in the chamber on guides which align it with the elevator and platform.

The part is formed on a platform attached to the vertical axis elevator, or Z-stage. The platform is immersed in the resin vat and is adjusted incrementally downward while the object is being formed. To remove the formed part, it is raised to a position above the vat. The platform is then disconnected from the elevator and removed from the chamber for post processing. Handling trays are provided to catch dripping resin.

The beam profiler is mounted to one side of the reaction vat at the focal length of the laser. The scanning mirror is periodically commanded to direct the laser beam onto the beam profiler, which measures the beam intensity profile. The data may be displayed on the terminal either as a profile with intensity contour lines or as a single number representing the overall (integrated) beam intensity. This information is used to determine whether the mirrors should be cleaned and aligned, whether the laser should be serviced, and what parameter values will yield vectors of the desired thickness and width.

1.2.3 Software. A software diagram of the SLA-1 is shown in Figure 1-4. There are three computers needed to control the stereolithographic apparatus, a CAD system, a slice computer, and a process computer. Any CAD system can be used to design a part in three-dimensional space. This is identified as the object file. In order to generate the part, supports must be added to prevent distortion. This is accomplished by adding the necessary supports to the CAD part design and creating a CAD support file. The resultant two or more CAD generated files are then physically inserted into the slice computer through Ethernet.

The stereolithography apparatus builds the part one layer at a time starting with the bottom layer. The slice computer breaks down the CAD part into individual horizontal slices. The slice computer also calculates where hatch vectors will be created. This is done to achieve maximum strength as each layer is constructed. The slice computer at the Beta Sites is a separate computer with its own keyboard and monitor. It is anticipated that in production models, the slice computer will be in the SLA-1 electronic cabinet and will share a common keyboard and monitor with the process computer. The operator can vary the thickness of each slice and change other parameters of each slice with the User Interface program. The slice computer uses the Xenix machine language and is connected to the SLA-1 process computer by an Ethernet data bus.

The sliced files are then transferred to the process computer through Ethernet. The process computer merges the sliced object and support files into a layer control file and a vector file. The operator then inserts the necessary controls needed to drive the stereolithography apparatus in the layer and parameter file. (The vector file is not usually edited.) The operator can strengthen a particular volume of the part by inserting rivets. This is accomplished by inserting the necessary parameters to the critical volume file prior to merging of the sliced files. The merge program integrates the object, support, and critical volume files and inserts the resultant data in the layer control file. The operator can edit the layer control file and change the default parameter file. The default parameter file contains the controls needed to operate the stereolithography apparatus to build the part. The process computer uses the MSDOS machine language and is directly connected to he stereolithography apparatus.

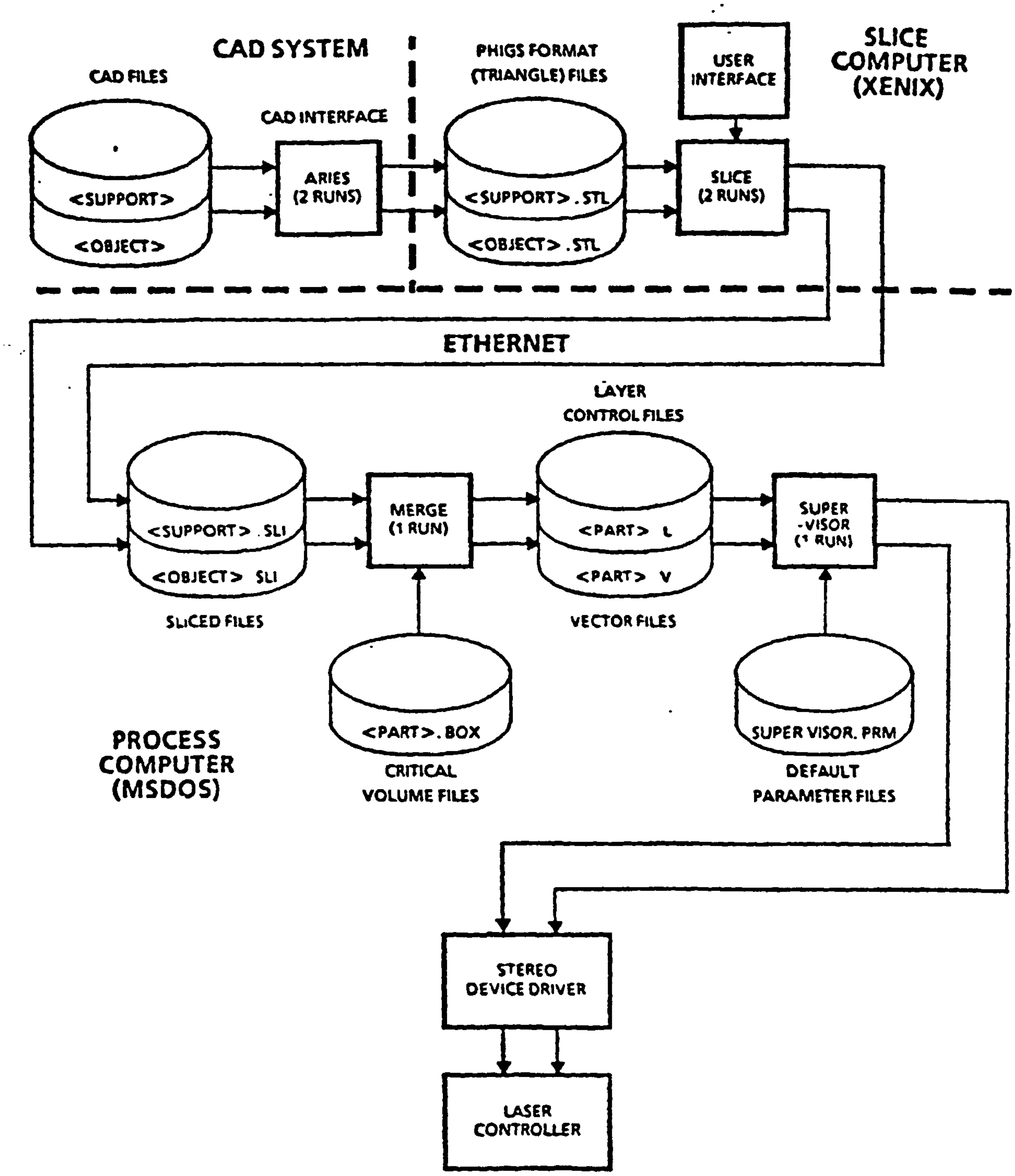


*Figure 1-4. Software Diagram of Stereolithography System*

1.3 PERFORMANCE SPECIFICATIONS

Beta SLA-1 performance specifications are listed in Table 1-1 for quick reference.

Table 1-1.

| *Beta SLA-1 Performance Specifications* | |
|---|---|
| Characteristic | Specification |
| Input Power | |
| Voltage and Frequency | 115 Vac, 60 Hz |
| Current Drain | 15 amperes |
| Functional Characteristics | |
| Laser Source | |
| Type | Helium Cadmium |
| Nominal Power | 10 mW at 325 nm |
| Warmup Time (to 90 percent power) | 15 minutes |
| Expected Tube Lifetime | 4000 hours (with 1000 hour service intervals) |
| Dielectric Beam-Turning Mirrors | |
| Nominal Reflectivity | >99 percent at 325 nm |
| Incident Angle Range | 0 to 45 degrees |
| Beam Expander | |
| Expansion Coefficient | 4 |
| Adjustable Axes | Y,Z (pitch and yaw) |
| Scanning Mirror | |
| Speed | |
| Minimum | 0.001 inch/sec (0.025 mm/sec) |
| Maximum | 20 inches/sec (51 cm/sec) |
| Drawing Area | |
| Width (X-axis) | 9 inches (23 cm) |
| Length (Y-axis) | 9 inches (23 cm) |
| Elevator (Z-stage) | |
| Maximum Travel | 14 inches (36 cm) |
| Minimum Step Size . | 0.001 inch (0.025 mm) |
| Load Capacity | 110 lbs (_ kg) |
| CAD Interface | Ethernet |
| Resin Characteristics | |
| Appearance and Odor | Clear amber liquid, mild odor |
| Vapor Density | Heavier than air |
| Specific Gravity ($H_2O$=1) | 1.18 |
| Flash Point | >200°F (93°C) |
| Extinguishing Media | National Fire Protection Association<br>Class B Extinguishers (carbon dioxide, dry chemical or foam) |
| Storage Temperature | +60°F to +80°F (+15°C to +26°C) |
| Physical Characteristics | |
| SLA-1 | |
| Dimensions (maximum) | |
| Height | 64 inches (163 cm) |
| Width | 49 inches (124 cm) |
| Depth | 27.5 inches (70 cm) |
| Shipping Weight | 600 lbs (_ kg) |
| Resin Vat | |
| Dimensions | |
| Height | 10 inches (25 cm) |
| Width | 9 inches (23 cm) |

Table 1-1. (continued)

| Beta SLA-1 Performance Specifications | |
|---|---|
| Characteristic | Specification |
| Depth | 9 inches (23 cm) |
| | |
| Operating Conditions | |
| Temperature | 50°F to 104°F (10°C to 40°C) |
| Relative Humidity | 0 to 90 percent |

SECTION II

CONTROLS AND INDICATORS

2.1 INTRODUCTION

This section describes the function of each SLA-1 operating control and indicator.

2.2 CONTROL PANEL

Control panel switches and status indicators are illustrated and described in Figure 2-1.

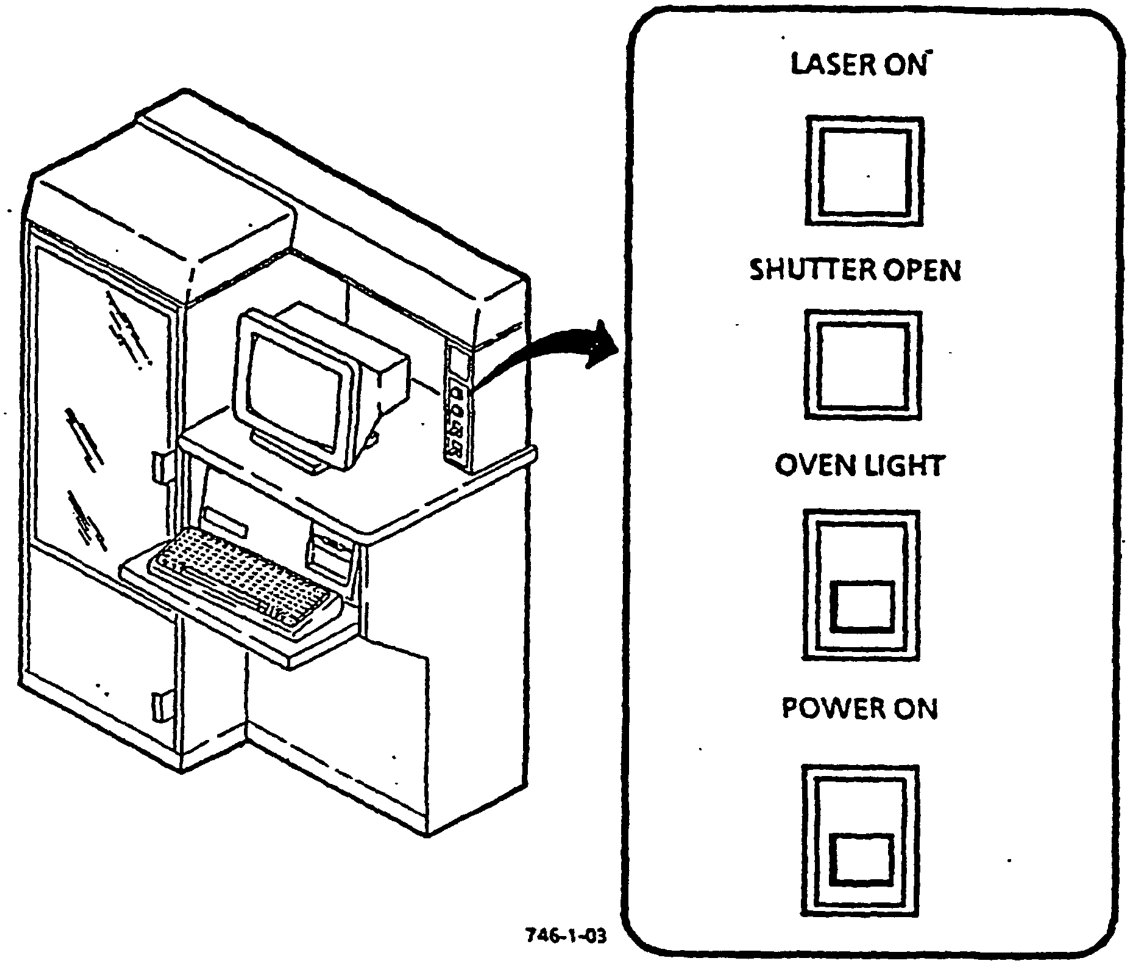


| Nomenclature | Function |
|---|---|
| LASER ON indicator | Blue lamp indicates that the laser is operating when illuminated. |
| SHUTTER OPEN indicator | Green lamp indicates that the laser shutter is open when illuminated. |
| OVEN LIGHT toggle switch/indicator | Turns the overhead reaction chamber light on and off. |
| POWER ON toggle switch/indicator | Controls primary power application to the laser, power supplies, reaction chamber, filter/heater, and process computer. |

*Figure 2-1. Control Panel Switches and Indicators*

SECTION III

OPERATING INSTRUCTIONS

3.1 INTRODUCTION

This section contains complete operating instructions for design and construction of model parts. Included are instructions for design of parts and supports on the CAD system, slicing of parts on the slice computer, and operation and control of the SLA-1 system to build parts. Also included are instructions for file transfer, insertion of critical volumes, merging of sliced files, editing of part control files, preparing default parameter files, running supervisor to build parts, post processing of parts, and use of working curves.

3.2 MATERIALS AND EQUIPMENT

Materials and equipment that would enhance the operation of the SLA-1 system are listed in Table 3-1. Equivalent items may be used.

Table 3-1.

| Operation Materials and Equipment | | |
|---|---|---|
| Nomenclature | Model/Part No. | Use |
| Printer, Computer | | Print out computer data permanent record file. |
| Microscope | | Make working curve measurements. |
| Oven, Heat | | Post cure green parts. |
| Oven, UV Flood | | Post cure green parts. |

3.3 CAD DESIGN FOR SLA-1 PARTS

3.3.1 How to Design CAD Parts for SLA-1. A part must initially be designed on a CAD system before it can be built on the SLA-1 system. This manual assumes that the operator knows how to design parts using a CAD system. In order to make the CAD design compatible with the SLA-1 system, the operator usually prepares two or more files on the CAD system, object files and support files. The object file is simply the CAD part. The support file is needed to add supporting structures to enable the part to keep its shape during construction on the SLA-1 system.

3.3.2 Rules for Design of Parts. In order to prepare the CAD design for the SLA-1 system, the operator should modify the CAD object file as follows:

a. Wall thicknesses should ideally be 0.020 to 0.150 inch.

b. Rotate CAD parts into an orientation which will:

1. Minimize trapped volumes as the part builds.

2. Take advantage of nice up-facing akin surfaces.

3. Minimize visibility of down-facing skin surfaces.

4. Make support design easy and optimum.

5. Make parts stable and strong as they are created.

c. Design parts so that horizontal gaps and holes are larger than desired by one laser linewidth.

d. All solid parts must completely enclose a volume. Single surfaces will confuse the crosshatch algorithms.

3.3.3 How to Design Support Files for SLA-1. Supporting structures consist of bases, posts, and webs which are needed to properly support the part and prevent the part from being distorted during construction on the SLA-1 system. The supports should be designed on the CAD system in a separate support file.

3.3.4 Rules for Design of Supports. The operator should create the CAD support file as follows:

a. Design a structure at the bottom of the CAD part which will rest on the elevator panel. This platform must have several horizontal legs which are at least 0.65 inch long (more than twice the diameter of the 1/4 inch holes in the platform).

b. Design supports to intersect every outside corner of a part, as these are major stress areas.

c. Arrange supports so that every unsupported down-facing border falls on a previously created support.

d. Space supports at a minimum distance apart for best stress resistance.

e. Design supports to have at least two layers of vertical overlap into the part for a strong attachment.

3.4 SLICE OPERATION

3.4.1 How to Slice Files. The slice computer (Wyse PC 386) automatically breaks down the object and support files into individual slices under user control. The user must choose the thickness of each slice and determine the shape and method of cross-hatching.

3.4.2 Rules for Slicing. The operator should slice the CAD object and support files as follows:

a. Up-facing skin surfaces should only be in one dimension (X or Y) and should have a 0.002 inch offset (high overlap). Exposure must be low.

b. Cross hatch should usually be as nearly perpendicular to part border as possible. Cross hatches parallel to part borders increase production time and may increase stress.

c. Slice support files without creating skin.

3.4.3 How to Run User Interface. This procedure shows how to operate the slice computer to use the User Interface program to insert slice parameters and run the Slice program. This procedure assumes that the CAD file has been installed in the slice computer. An asterisk (*) in front of a step indicates that this is an optional step that only needs to be performed if a common keyboard is being used to operate the slice computer and process computer.

a. Press ENTER - MAIN MENU is displayed.

*b. Select Data Transfer (Slice) and press ENTER - Data Transfer menu is displayed.

*c. Select TELNET, Terminal Utility and press ENTER.

d. In response to $ prompt, type UI (user interface) and press ENTER - SLICE USER INTERFACE Menu is displayed.

e. Select option 1 (DATABASE File Name).

f. In response to Enter Data File Name: prompt, type data file name followed by .stl (example - test.stl) and press ENTER.

g. In response to Type File Binary or ASCII (B,A): prompt, type b (binary) or a (ASCII) as applicable and press ENTER.

h. Select option 2 (Scale).

i. In response to Enter Scale Value: prompt, type (scale value per CAD dimension unit) and press ENTER. (If 1000 is selected, 1000.000 is inserted in the Value column, which is 1/1000 of one CAD dimension unit.) (Example - for a part CAD designed in inches, a scale of 1000 makes each slice scale unit 1 mil.)

j. Select option 3 (Z Spacing).

k. In response to Enter Fixed or Variable Spacing (F, V, or Q) value: prompt, type F (fixed) and press ENTER. Then type thickness in slice scale units (from option 2) (example - 20) and press ENTER. (To select variable thicknesses, refer to software manual.)

l. Select option 4 (X hatch spacing).

m. In response to Enter Hatch Spacing (hx) value: prompt, type X hatch spacing in slice scale units (example - 200 (5 hatches/inch)) and press ENTER.

NOTE

Do not use option 5 (Y hatch spacing) if option 6 (60/120 degree hatch spacing) is to be used.

n. Select option 5 (Y hatch spacing).

o. In response to Enter Hatch Spacing (hy) value: prompt, type Y hatch spacing in slice scale units (example - 200) and press ENTER.

p. Select option 6 (60/120 degree hatch spacing).

q. In response to Enter Hatch Spacing (60/120) value: prompt, type 60/120 hatch spacing in slice scale units (example - 20) and press ENTER.

r. Select option 7 (X Skin fill for near flat surfaces).

a. In response to Enter Skin fill for near flat surfaces (hfx) value: prompt, type X skin fill offset in slice scale units (example - 2) and press ENTER.

t. SELECT option 8 (Y Skin fill for near flat surfaces).

NOTE

If X skin fill is used, Y should not be used, and vice versa.

u In response to Enter Skin fill for near flat surfaces (hfy) value: prompt, type Y skin fill in mils (example - 2) and press ENTER.

v. Select option 9 (minimum Surface Angle for scanned facets).

w. In response to Enter a Minimum Surface Angle prompt, type desired angle in degrees from vertical (example - 60) and press ENTER.

x. Select option 10 (Minimum Hatch Intersect Angle).

y. In response to Enter a Minimum Intersect Angle value: prompt, type intersect angle in degrees (example - 20) and press ENTER.

z. Select option 11 (Segment Output File Name).

aa. In response to Enter Segment File Name: prompt, type desired output file name followed by .sli (slice) (example - test.sli) and press ENTER.

ab. After all slice parameters have been selected, select s (Save) and press ENTER. (This will save the parameters for future use and reference.)

ac. In response to "Press (Enter) to Continue" prompt, press ENTER. Then select d (DoSlice) and press ENTER.

ad. In response to Slice Version to use (Default XY)? prompt, press ENTER. (The program now slices the files using the inserted slice parameters.)

ae. After slicing is completed, DATA TRANSFER MENU is displayed.

af. Press Q (Quit) and ENTER. (The sliced files are now ready to be transferred to the process computer.)

3.5 SLA-1 OPERATION

3.5.1 Turn-On Procedure.

a. Set POWER ON switch to on (up). Verify that POWER ON indicator illuminates.

b. Set OVEN LIGHT switch to on (up). Verify that OVEN LIGHT indicator illuminates and that overhead light in reaction chamber illuminates.

NOTE

The SHUTTER OPEN and LASER ON indicators will illuminate during operation. The SHUTTER OPEN indicator will illuminate when the laser shutter is open and the LASER ON indicator will illuminate when the laser is operating.

c. The MAIN MENU will be displayed on the monitor as the process computer boots up. Select "Power on sequence" and press ENTER.

d. The POWER SEQUENCE menu will be displayed. Sequentially press function keys 1, 2, and 3 to power up the laser, mirror, and elevator drivers, and to open the laser shutters.

e. Wait at least 15 minutes for the laser to stabilize in power before beginning to create a part. Other functions (file preparation, data transfer, etc.) can be performed during laser warm-up.

3.5.2 How to Transfer Files from Slice Computer to Process Computer. This procedure shows how to transfer the sliced object and support files from the slice computer to the process computer (Wyse PC 286) in the SLA-1.

a. Press ENTER - MAIM MENU is displayed.

b. Select option 1 (Data Transfer).

c. In response to (data transfer) prompt, type 2 (FTP) (file transfer program) and press ENTER.

d. In response to (ftp) prompt, type OPEN and press ENTER.

e. In response to (to) prompt, type address of slice computer and press ENTER.

f. In response to Remote user prompt, type the name of your directory and press ENTER.

g. In response to Password prompt, type your password and press ENTER.

h. In response to (ftp) prompt, type GET and press ENTER.

i. In response to (remote-file) prompt, type name of desired file usually followed by .sli (example - test.sli) and press ENTER.

j. In response to (local-file test.sli is default) prompt, press ENTER (unless you want to change name). (The FTP routine will now transfer the file to the process computer. It will prompt when the transfer is complete.)

k. To exit from FTP, in response to ftp) prompt, type BYE and press ENTER. (The sliced files have now been transferred to the SLA-1 process computer.)

l. MAIN MENU is displayed after transfer is completed.

3.5.3 How to Insert Critical Volumes. This procedure shows how to set up critical volumes. These critical volumes can be used to insert rivets, which are multiple passes of the laser beam over crosshatch vectors to increase strength, or for other special treatment (This procedure can be skipped if the CAD part contains no critical volumes.)

a. On CAD computer, call up CAD display of the part.

b. Identify X, Y, and Z coordinates in CAD space for the four bottom corners of the rectangular solid (critical volume).

c. On process computer, select option 5 (Edit System Files) and press ENTER.

d. Select option to create a new file - Turbo Basic is displayed.

e. Use arrow keys to select Write to and press ENTER.

f. In response to New Name prompt, enter name of critical volume followed by .box (example - test.box) and press ENTER.

g. Use arrow keys to select Edit and press ENTER.

h. In response to C: Test .Box enter: prompt, insert the following: <type>, <base>, <height>, <x1>, <y1>, <x2>, <y2>, <x3>, <y3>, <x4>, <y4> (Be sure to insert commas between each item. Proper syntax is critical.) where:

<type> is "XV" to rivet cross-hatches in the enclosed area or "XI" to ignore cross-hatches
<base> is the base of the box relative to the slice scale
<height> is the height of the box
<x1, y1> is the first coordinate of the box
<x2, y2> is the second coordiante
<x3, y3> is the third coordinate
<x4, y4> is the fourth coordinate

i. Press Esc (escape) key.

J. Use arrow key to select File and press ENTER.

k. Use arrow key to select Save and press ENTER.

l. Use arrow key to select Quit and press ENTER. (The new <part> .box file has now been created to identify a critical volume.)

3.3.4 How to Merge Sliced Files. This procedure shows how to combine (merge) the object and support files into vector and layer control files.

a. Press ENTER - MAIN MENU is displayed.

b. Select option 2 (MERGE) and press ENTER.

c. In response to Slice File Names prompt, type names of files to be merged (include .SLI as part of the names) and press ENTER. (Be sure to include critical volume file, if applicable.)

d. In response to Output File Name prompt, type desired name of output file and press ENTER. (No ".XXX" ending is necessary.)

e. Press ENTER and wait for process computer to merge files (one slice at a time). (The program will prompt when it has completed the merge.)

3.5.5 How to Operate SLA-1 to Build Parts. These procedures show how to use the process computer to actually build a part in the reaction vat. Included are procedures for setting up the reaction vat, modifying the merged vector and control files, preparing the default parameter files, and running the part making (supervisor) program.

3.5.5.1. Rules for Building SLA-1 Parts. In order to prepare the SLA-1 to build a part, the operator.must perform the operator's checklist, edit the layer control (.L) file (SUPER .PRM), prepare the default parameter files, and run the supervisor programs as follows:

a. Set speed of first support layer three times slower than normal layer drawing speed. This overcures first layer to enable it to adhere firmly to elevator platform.

b. Set dip speeds low to avoid undue stresses to part in progress.

c. Use longer dip delays for:

1. Fragile layers.

2. Lowest layers of supports near platform.

3. After layers with large area skins.

4. In areas with large trapped volumes of resin.

5. For shallow dip depths (thin layer thicknesses).

d. Use single passes and choose exposure speeds from working curves which provide a 0.006 to 0.008 inch overcure into previously created layers.

e. Record important parameters and comments in a Part Log (example in figure 3-1). (The user is encouraged to create his own custom Part Log to his special requirements.) If a printer is available, print out important parameters for a permanent record.

3.5.5.2 How to Prepare Default Parameter Files. This procedure shows how to prepare the default parameter (.PRM) files to control the part building cess:

a. Press ENTER - MAIN MENU is displayed.

b. Select option 5 (Edit System Files) and press ENTER.

c. In response to Load File Name prompt, enter file names (insert SUPER.PRM only) and press ENTER.

d. Move arrow to Edit block and press ENTER. Values can now be inserted in default parameter (SUPER.

PRM) files. (Refer to software manual for definitions of codes.)

**SAMPLE PART LOG**

| Part No. | Date | Matl. | Temp. | Pgm Name | Relat Speed | Layer Thick | Laser Power | Expnd Setng | Line Width | Comments |
|---|---|---|---|---|---|---|---|---|---|---|
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |
| | | | | | | | | | | |

*Figure 3-1. Sample Part Log*

e. To quit editing files:

1. Press Esc key.

2. Use arrow key to select File and press ENTER.

3. Use arrow key to select Save and press ENTER.

4. Press Q key - MAIN MENU is displayed.

3.5.5.3 How to Edit Layer Control Files. This procedure shows how to modify the layer (.L) files to fine tune the part building process:

a. Press ENTER - MAIN MENU is displayed.

b. Select option 5 (Edit System Files) and press ENTER.

c. In response to Load File Name prompt, enter file names (insert .L files only; .V files are not usually edited) and press ENTER.

d. Move arrow to Edit block and press ENTER. Values can now be changed on layer (.L) files. (Refer to software manual for definition of codes.)

e. To quit editing files:

1. Press Ese key.

2. Use arrow key to select File and press ENTER.

3. Use arrow key to select Save and press ENTER.

4. Press Q key - MAIN MENU is displayed.

3.5.5.4 Operator's Checklist Before Starting a Part. This procedure shows how to set up the reaction vat, laser, and elevator, and how to monitor the part during construction.

a. Is correct resin in the vat? If not, insert proper resin in vat:

1. Open chamber door.

2. Drain out resin.

3. Clean vat thoroughtly.

4. Fill vat with correct resin.

5. Close chamber door.

6. Wait 1/2 hour for resin level to stabilize.

b. Is resin level adequate? If not, add resin in vat:

1. Open vat door.

2. Add resin as required.

3. Close vat door.

4. Wait 1/2 hour for resin level to stabilize.

c. Is elevator level correct? If not, set level as follows:

1. On process computer, press ENTER - main menu is displayed.

2. Select Utilities menu and press ENTER.

3. Select Z-Stage Mover and press ENTER.

4. To move elevator up, press ↑ (up) arrow and press any key to stop movement.

5. To move elevator down, press ↓ (down) arrow and press any key to stop movement.

CAUTION

Do not allow elevator to hit top bracket or side of vat. Mechanical damage can result.

6. Toggle up ↑ arrow until liquid resin level is just below holes in the elevator platform.

7. Toggle ↓ arrow until liquid resin is level with holes (dimples in surface visible).

d. (Optional) Is laser power properly adjusted? Check laser power as follows:

1. On process computer, press ENTER - main menu is displayed.

2. Select Utilities menu and press ENTER.

3. Select Beam/Profiler option and press ENTER.

4. The prompt Compute the Beam Profile and Measure its Intensity will be displayed while the laser is being focused on the beam profiler in the chamber.

5. The prompt Display Power will be displayed when the laser beam power has been computed and the laser is returned to its normal position.

e. Are all necessary files in the active directory? Check directory for correctly named vector, layer, and default parameter files as follows:

1. Type DIR, space, part name, and .*, and press ENTER to display vector (.V) and layer (.L) files.

2. Type DIR, space, *.prm, and press ENTER to display default parameter (.PRM) files.

f. Are all the values inserted in the vector, layer, and default parameter files correct and with proper syntax? Refer to software manual for definitions of codes and syntax.

g. Is the elevator driving subroutine initialized? Initialize elevator drive subroutine as follows:

1. On process computer, press ENTER - main menu is displayed.

2. Select Utilities menu and press ENTER.

3. Select Power On Sequence and press ENTER.

4. Function keys 1, 2, and 3 can be used to power the laser, driving electronics, and open the shutters.

3.5.5.5 How to Run Supervisor to Make a Part. Now that all of the preparatory work has been done, this procedure shows how to actually build a part.

a. On process computer, press ENTER - MAIN MENU is displayed.

b. Select option 4 (Supervisor) and press ENTER.

c. In response to Part Prefix prompt:, type name of part files and press ENTER. This causes on the laser to start tracing the first layer. Verify that SHUTTER OPEN and LASER ON indicators on operator control panel are illuminated.

d. Watch the first layers form.

1. Is the part centered on the elevator platform?

2. Do the first layers stick to the platform?

3. If not, abort the run and correct the problem.

3.5.5.6 Post Processing of SLA-1 Parts. This procedure shows how to remove the finished part from the vat, drain the part, cure and dry the part, and remove supports.

a. Updip and Preliminary Draining.

1. On process computer, press ENTER - main menu is displayed.

2. Select Utilities menu and press ENTER.

3. Select Z-Stage Mover and press ENTER.

4. Very slowly toggle ↑ arrow until elevator is raised to 1 inch above edge of reaction vat level. Do not raise part quickly or distortion could occur.

5. Wait approximately 15 minutes to allow excess resin to drip from part.

b. Part/Platform Removal.

1. Place a pad of absorptive material on the special drain tray.

2. Slip the drain tray under the elevator platform and rest it on the shelves on either side of the vat.

3. Toggle ↓ arrow on keyboard to lower the elevator platform until it is about 1/4 inch above the absorptive pad.

4. Twist one of the elevator shaft knobs one turn ccw. This will unscrew a threaded rod inside the elevator shaft from a threaded hole in one side of the elevator platform and partially release the platform.

5. Repeat step (d) with the opposite elevator shaft knob.

6. Repeat steps (d) and (e) alternately until the platform drops free from the shafts and falls a fraction of an inch.to rest on the absorptive pad.

7. Raise the elevator shafts, if necessary, with the ↑ arrow on keyboard.

8. Remove the drain tray, platform, and attached part from the vat chamber. Keep the platform horizontal if possible to avoid putting side stresses on the green (uncured) part.

c. Oven Draining.

1. Place elevator platform and part in an oven.

2. Set temperature to 80 to 90°C and wait 1 hour.

3. Carefully wipe off excess liquid resin which adheres to up and down-facing surfaces with cotton swabs.

d. Post Curing.

1. Place elevator platform and part in an ultraviolet flood oven.

2. Flood the part with ultraviolet light until it is dry and no longer tacky.

3. Use a fine-tooth saw and remove the part from the elevator platform by sawing through the bottom supports that attach the part to the platform. Protect the part from streses and inertial shocks during this procedure.

4. Clean all "sawdust" and fragments of support from the part before continuing.

5. Turn part upside down (or rest part on its side if this is not possible) and repeat steps 1 and 2.

e. Platform Replacement.

1. Scrape away any dry resin that is still sticking to elevator platform after removal of part. If may be necessary to tap out the treaded holes in the platform with a #10-32 tap.

2. Place the empty platform on the drain tray.

3. Place the drain tray in the SLA-1 vat chamber resting on the shelves and centered as well as possible over the vat.

4. Very slowly toggle ↓ arrow on keyboard to lower the elevator shafts until the threaded rods are very close to the platform. Avoid running the shafts into the platform or tray as this can ruin the threads on the shaft.

5. Adjust the tray and platform so that the threaded holes in the platform are exactly aligned beneath the threaded rods.

6. Slowly toggle ↓ arrow on keyboard until the threaded rods contact the threaded holes gently.

7. Twist one of the elevator shaft knobs one turn cw. This will rotate the threaded rod inside the elevator shaft and cause it to engage the threaded hole in the panel.

8. Repeat step 7 with the opposite elevator shaft knob.

9. Repeats steps 7 and 8 alternately until the platform is lifted off of the drain tray and is in firm contact with the bottom of the elevator shafts.

10. Snug up the elevator shaft knobs to secure the panel to the shafts. Do not overtighten as this can fracture the interior threaded rod.

11. Toggle the ↑ arrow on keyboard to raise the elevator.

12. Remove the drain tray.

f. Removing Supports and Finishing.

1. Carefully cut away supports with side cutting pliers.

2. Carefully smooth off rough surfaces with appropriate files.

3. Surface finish as required.

3.5.5.7 Shutdown Procedures.

a. Set OVEN LIGHT switch to off (down). Verify that OVEN LIGHT indicator extinguishes.

b. Set POWER ON switch to off (down). Verify that POWER ON and other indicators extinguish.

3.5.5.8 How to Create and Use Working Curves. The degree to which liquid plastic can be solidified is determined by three factors: (1) the type of resin used, (2) laser power, and (3) degree of laser focus. By creating a working curve, the operator can adjust the laser drawing speed to compensate for variations in these three factors. Therefore, a new working curve must be prepare each time a new batch of resin is used or there is a significant loss of laser power as shown on the Part Log. The working curve is then used to change the step period (laser drawing speed) and step size in the default parameter and layer control files.

a. Toggle ↓ arrow on keyboard to lower elevator platform to 1 inch below resin surface. The banjo part used to create working curves will be prepared free floating on the resin surface.

b. On process computer, press ENTER - main menu is displayed.

c. Select Utilities menu an press ENTER.

d. Select Banjo and press ENTER. Follow the menu to input the largest step period (SP) to be used. The SLA-1 will prepare the banjo part in the vat.

e. After banjo part is completed, drain and cure it (subparagraph 3.5.5.6).

f. Use a microscope and measure horizontal width of each string.

g. Cut banjo part sideways and use microscope to measure thickness (depth) of each string.

h. Plot height and width values on a working curve (sample in Figure 3-2) at the step periods chosen (example - 40, 80, 160, 320, and 640). The lowest step period will create the thinnest banjo string and the highest step period will create the thickest banjo string.

i. Another banjo can be created with different step periods to extend the range of the working curve.

j. Connect the five or more points to form both working curves.

k. The working curve can now be used to select the step period and step size for each slice.

l. Insert the chosen step period and step size into the default parameter files (paragraph 3.5.5.2).

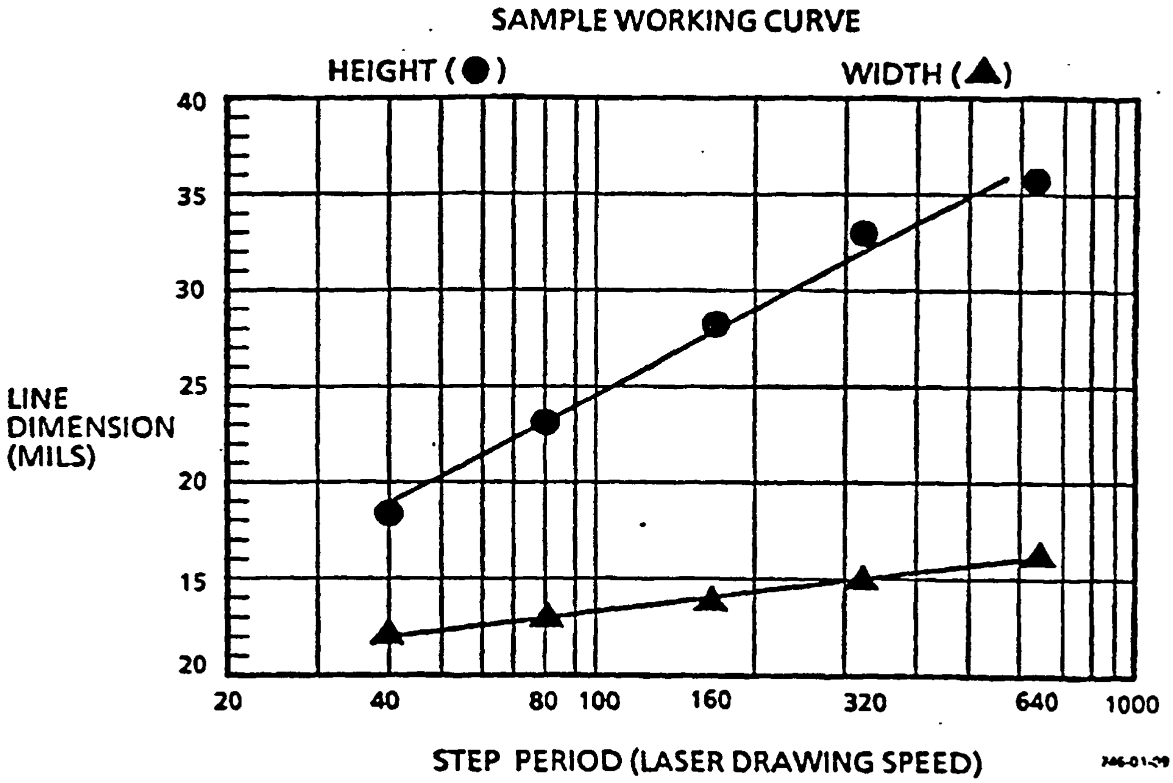


*Figure 3-2. Sample Working Curve*

SECTION IV

TROUBLESHOOTING

4.1 INTRODUCTION

This section contains troubleshooting procedures to identify and correct operation errors and selected hardware failures. Fault conditions not covered in this section shall be corrected by qualified maintenance technicians using the SLA-1 Service Manual.

4.2 TROUBLESHOOTING PROCEDURES

Beta SLA-1 troubleshooting procedures are listed in Table 4-1.

Table 4-1.

| *Troubleshooting Procedures* | | |
|---|---|---|
| Problem | Probable Cause | Remedy |
| | | |

SECTION V

OPERATOR MAINTENANCE INSTRUCTIONS

5.1 INTRODUCTION

This section contains procedures for routine maintenance to be performed by the SLA-1 operator. Included are procedures to clean up resin spills, add resin to vat, replace vat, replace air filter, and clean optical components. Maintenance requirements not covered in this section shall be performed by qualified technicians in accordance with SLA-1 Service Manual.

5.2 MATERIALS AND EQUIPMENT

Recommended maintenance materials and equipment are listed in Table 5-1. Equivalent items may be used.

Table 5-1.

| *Maintenance Materials and Equipment* | | |
|---|---|---|
| Nomenclature | Model/Part No. | Source |
| Gloves, chemical resistant | | Commercially available |
| Glasses, safety | | Commercially available |
| Towels, disposable | | Commercially available |
| Container, hazardous materials disposal | | Commercially available |
| Isopropanol | | Commercially available |

Table 5-1. (continued)

| Maintenance Materials and Equipment | | |
|---|---|---|
| Nomenclature | Model/Part No. | Source |
| Clothing, protective | | Commercially available |
| Respiratory equipment, NIOSH/MSHA approved | | Commercially available |
| Absorbing material (sawdust, clay, diatomaceous earth, or activated charcoal) | | Commercially available |
| Resin, UV curable | | Commercially available |
| Compressed air | | Commercially available |
| Methanol, reagent-grade | | Commercially available |
| Glass | | Commercially available |
| Lens tissue | | Commercially available |
| Hemostat (or clamping tweezers) | | Commercially available |
| Cotton swabs | | Commercially available |
| Filter, air | | Commercially available |
| Lamp, chamber | | Commercially available |
| Lamp, indicator | | Commercially available |

5.3 RESIN CLEANING/REPLENISHMENT PROCEDURES

5.3.1 Cleanup of Small Resin Spills.

**WARNING**

**UV CURABLE RESINS MAY CAUSE EYE AND SKIN BURNS. REPEATED OR PROLONGED SKIN CONTACT MAY CAUSE SENSITIZATION. VAPOR MAY BE HARMFUL.**

a. Read the safety precautions and first aid instructions at the front of this manual.

b. Put on chemically resistant gloves and safety glasses.

c. Remove the spilled resin using disposable towels.

d. Seal contaminated towels and other contaminatéd articles in a marked container suitable for the disposal of hazardous materials.

NOTE

Fully cured resins present no safety or health related hazards. An alter-native means of disposing lightly contaminated articles is to ultraviolet or heat-cure the affected areas and dispose of as nonhazardous waste.

e. Clean the spill area with isopropanol followed by a thorough washing with soap and water.

f. Remove gloves and seal in disposal container. Dispose of container in accordance with applicable hazardous waste laws and regulations.

g. Wash hands thoroughly with soap and water.

5.3.2 Cleanup of Large Resin Spills.

**WARNING**

**UV CURABLE RESINS MAY CAUSE EYE AND SKIN BURNS. REPEATED OR PROLONGED SKIN CONTACT MAY CAUSE SENSITIZATION. VAPOR MAY BE HARMFUL.**

a. Immediately isolate the spill area.

b. Read the safety precautions and first aid instructions at the front of this manual.

c. Put on protective clothing, chemically resistant gloves and safety glasses. If the spill area is not well ventilated, wear NIOSH/MSHA approved respiratory equipment.

d. Cover the spill with absorbing material such as sawdust, clay, diatomaceous earth, or activated charcoal.

e. When the absorbant is saturated, seal it in a marked container suitable for the disposal of hazardous materials.

f. Clean the spill area with isopropanol followed by a thorough washing with soap and water.

g. Wipe resin off protective clothing with clean disposable towels.

i. Remove protective clothing in the following order: boots, gloves and suit. After removing gloves, use disposable cloths to protect hands.

j. Place contaminated articles in the disposal container. Dispose of container in accordance with applicable hazardous waste laws and regulations.

k. Shower with soap and cool water.

5.3.3 Vat Replenishment. The reaction vat contains spillways on both sides to handle resin overflow. The overflowed resin then flows through the overflow tubes, through the drain valve, and settles in the collection bottle. Do not reuse resin after an overflow. If resin level in vat is low, replenish as follows:

a. Open chamber door.

b. Slowly pour new resin into vat. Make sure that new resin is the same type as the resin in the vat. The part will not build properly if different resins are mixed in the vat.

c. Wait 1/2 hour for resin level to settle before resuming operation.

d. Close chamber door.

5.4 OPTICS CLEANING (Figure 5-1)

The SLA-1 optics must be cleaned when there is obvious contamination (fingerprints, dust, haze) of the optical surfaces, or when the laser power measured at the resin surface is less than the power measured at the laser by more than a few milliwatts. If laser power loss is present, the optical alignment should be checked. If the system is aligned as well as possible and still there is a significant difference in power from the laser to the resin surface, optics cleaning is required.

5.4.1 Equipment Required.

a. A source of clean, compressed air designed for optics cleaning.

b. A small amount of clean reagent-grade methanol in a glass (not plastic) bottle.

c. A supply of clean lens tissue. (Conventional face tissues leave lint on optical surfaces and are not recommended. Industrial wiping tissues are designed to be abrasive, and should be strictly avoided.)

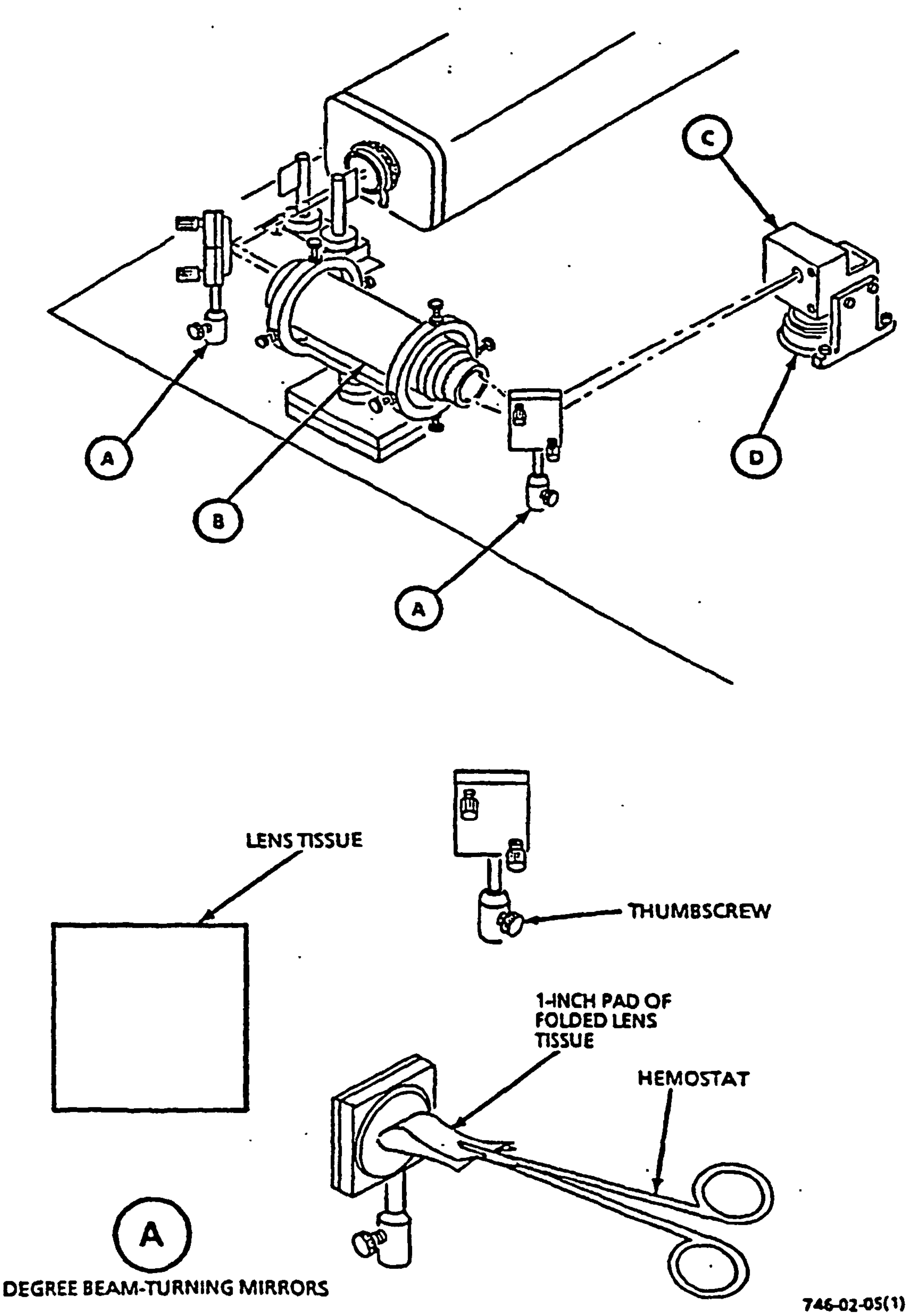


*Figure 5-1. Recommended Optics Cleaning Technique (Sheet 1 of 2)*

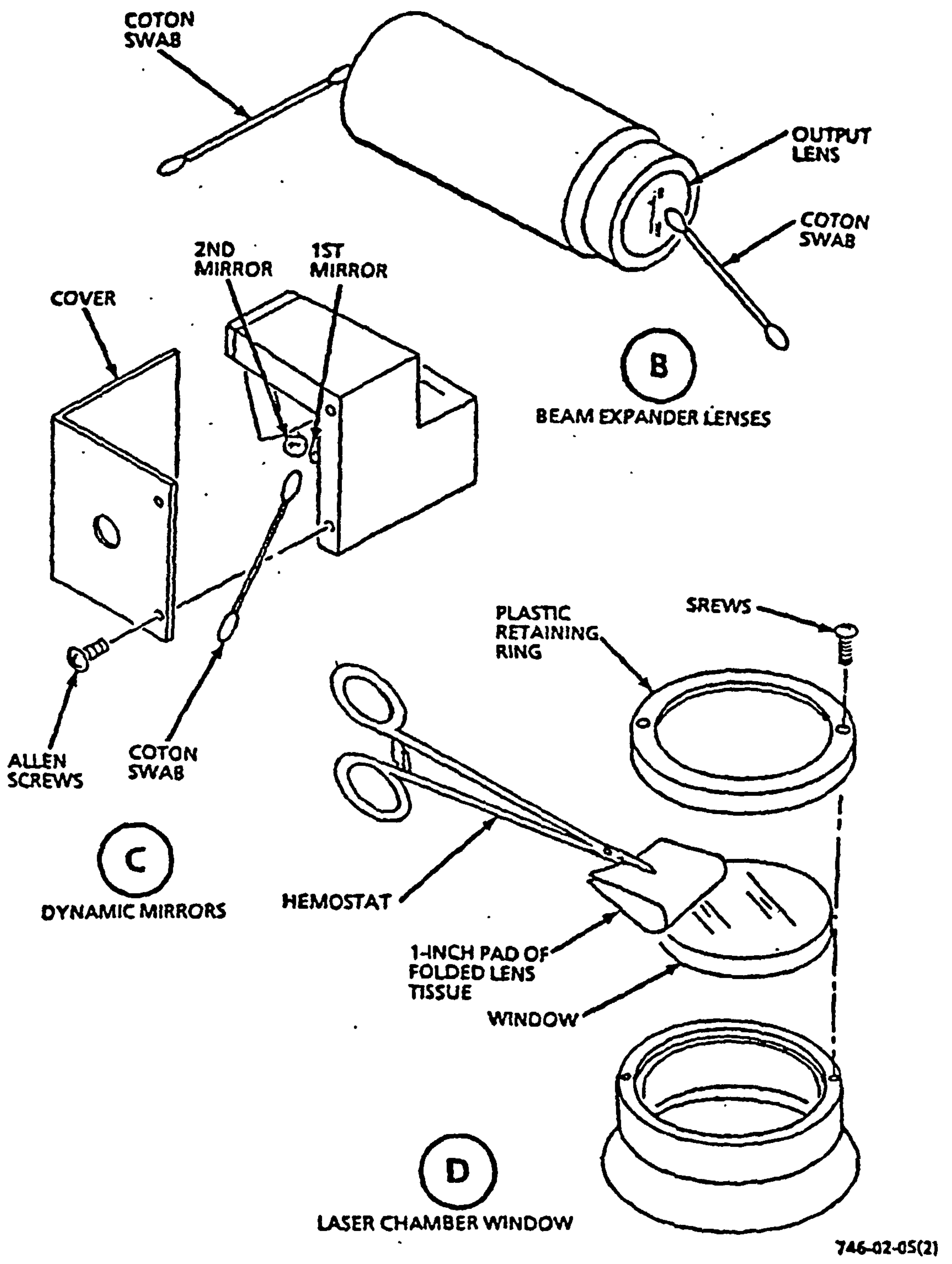


*Figure 5-1. Recommended Optics Cleaning Technique (Sheet 2 of 2)*

d. A hemostat or pair of clamping tweezers.

e. A supply of special cotton swabs designed for optics cleaning. (These have a wooden stick with the cotton heads attached without glue. Plastic "sticks" and glue can be dissolved by the methanol and their residue contaminates the optical surfaces.)

f. Freshly scrubbed, clean, dry hands.

5.4.2 Care and Handling of Optics. All of the optics in the SLA-1 are coated with precise dielectric coatings, either to avoid unwanted reflections from the surfaces of the transmissive optics or to achieve efficient reflections from the mirrors. These coatings are fragile and easy to damage. Even faint fingerprints will damage the coatings, so extreme care must be taken to never touch the optical surfaces with fingers or with anything except carefully handled lens tissue or special cotton swabs. The optics must be handled only by the edges of any of the optics, or by the uncoated backs of the reflective optics.

5.4.3 Laser Brewster Windows. Refer to HeCd Laser Service Manual to clean laser brewster windows.

5.4.4 Laser Resinator Mirrors. Refer to HeCd Laser Service Manual to clean laser resinator mirrors.

5.4.5 90 Degree Beam-Turning Mirrors. (Figure 5-1A) The beam-turning mirrors can be removed and cleaned after their protective covers/shields have been removed. Turn the thumbscrew locking the mirror mount post into the post-holder ccw and gently lift the post and mirror mount of the post-holder. If desired, the mirrors and their immediate black-anodized holders can be separated from the mount by loosening the thumbscrew which retains the mirror holder to the mirror mount.

a. Carefully remove dust and lint from the mirror surface using clean compressed air. If using an aerosol "duster", be certain that the can is always held upright or aerosol propellant will be sprayed onto and contaminate the optical surface.

b. Wash hands thoroughly and fold a new sheet of lens tissue in halves repeatedly to achieve a "pad" of lens tissue about 1-inch square, and several thicknesses of tissue thick. Grasp this pad along one edge with a hemostat or locking tweezers.

c. Apply a few drops of reagent-grade methanol to the pad and shake off any excess.

d. Apply the side of the pad to one edge of the surface of the mirror. Carefully draw the pad across the surface one time only using some pressure on the hemostat. Allow the "tail" of the pad to follow the leading edge of the pad and drag across the optical surface. Immediately discard this piece of lens tissue.

e. Allow the small film of methanol remaining on the optic to evaporate naturally. Do not wipe or blow on the optic to assist evaporation.

f. Carefully examine the optic by looking at a glancing reflection of a bright area. If the optic still is not clean, choose a new sheet of lens tissue and repeat steps b through f until satisfactory results are achieved.

g. If it is desired to clean the beam expander lenses as well, do not replace the 90 degree beam-turning mirrors and mounts until the lenses have been cleaned as explained below.

5.4.6 Beam Expander Lenses. (Figure 5-1B) Do not remove the lenses from the beam expander mount. The mount is difficult to realign and should not be removed.

a. In order to clean the beam expander optics in place, the 90 degree beam-turning mirrors and mounts should be removed as explained above and carefully set aside.

b. Apply a few drops of reagent grade methanol to an unused special cotton swab and shake or flick off any excess.

c. To clean the input expanding (small) lens:

1. Carefully insert the soft tip of the swab into the input aperture until the surface of the lens is encountered. Use slight pressure and rotate the swab as it contacts the lens. Remove the swab and immediately discard it.

2. Repeat steps b and c.1 with a new, much "drier" swab from which almost all of the methanol has been shaken out.

3. Repeat step c.1 with a new, completely dry cotton swab.

d. To clean the output converging (large) lens:

1. Apply a few drops of reagent grade methanol to an unused special cotton swab and shake or flick off any excess.

2. Use soft pressure with the soft tip of the swab. and begin in the center of the lens. Wipe the lens with an expanding spiral pattern until the outer edge is wiped once. Immediately discard the swab.

3. Repeat step d.2 with a new, much "drier" swab from which almost all of the methanol has been shaken out.

4. Repeat step d.1 with a new, completely dry cotton swab.

5. Now carefully examine the lens by looking at a reflection of a bright area. If the lens still is not clean, choose a new special cotton swab and repeat steps d.1 through d.5 until satisfactory results are achieved.

e. Check the cleaning job by viewing the expanded beam.

1. Replace the input 90 degree beam-turning mirror.

2. Put on UV blocking glasses or goggles.

3. Defeat the interlock shutter by using the interlock-defeat jumper and realign the turning mirror so that the laser beam passes directly through the center of the beam expander.

4. Place a fluorescing piece of paper in front of the output lens and watch the expanded beam image carefully while adjusting the input turning mirror slightly to move the beam around through the beam expander. Any discontinuities in the beam pattern which do not move with the beam as it moves are likely to be caused by blemishes on the beam expander optics. If any are observed, repeat paragraph 5.3.5.6 entirely.

f. Replace the output beam-turning mirror and mount it in the post holder.

5.4.7 Galvanometer-Driven Dynamic Mirrors. (Figure 5-1C)

CAUTION

The galvanometer-driven dynamic mirrors are very light, thin, carefully balanced, and fragile. Breaking a dynamic mirror is easy to do and will involve a major replacement of the dynamic mirror system, and realignment of the SLA-1 optics. Therefore, be especially careful and gentle when cleaning the dynamic mirrors.

a. Remove the protective cover from the dynamic mirrors by loosening the two machine screws which attach it to the dynamic mirror bracket. Be certain not to confuse them with the machine screws which mount the entire dynamic mirror bracket. Do not remove the dynamic mirror bracket from its mount, nor the mount from the optical plate. Detaching and remounting the dynamic mirrors could necessitate a major optical realignment, and is not recommended.

b. Apply a few drops of reagent grade methanol to an unused special cotton swab and shake or flick off any excess.

c. Hold the stick of the swab between the fingers and carefully bring the side of the swab into contact with one end of the front surface of one of the dynamic mirrors.

d. Use gentle pressure and wipe the swab along the long axis of the mirror once while rotating the swab in the opposite direction. Immediately discard the swab.

e. Allow the small film of methanol remaining on the optic to evaporate naturally. Do not wipe or blow on the optic to assist evaporation.

f. Repeat steps c through e for the other dynamic mirror.

g. Now carefully examine the optics by looking at a glancing reflection of a bright area. If the optics still are not clean, choose a new cotton swab, and repeat steps c through g until satisfactory results are achieved.

5.4.8 Laser Chamber Window. (Figure 5-1D)

a. Open chamber door.

b. Remove two screws from inside chamber and remove window mount.

c. Remove two screws and remove plastic retaining ring from window mount.

d. Wash hands thoroughly, touch only the edges of the window, and remove the window from the mount.

e. Carefully remove dust and lint from the surface using clean compressed air. If using an aerosol "duster", be certain that the can is always held upright or aerosol propellant will be sprayed onto and contaminate the optical surface.

f. Fold a new sheet of lens tissue in halves repeatedly to achieve a "pad" of lens tissue about 1-inch square, and several thicknesses of tissue thick. Grasp this pad along one edge with the hemostat or locking tweezers.

g. Apply a few drops of reagent grade methanol to the pad and shake off any excess.

h. Now apply the side of the pad to new edge of the surface of the window as shown in. Carefully draw the pad across the surface one time only using some pressure on the thermostat. Allow the "tail" of the pad to follow the leading edge of the pad and drag across the optical surface. This will clean one section of the surface of the large window. Immediately discard this piece of lens tissue.

i. Use a new pile of lens tissue each time and repeat steps d through f until the entire surface has been cleaned.

j. Allow the small film of methanol remaining on the window to evaporate naturally. Do not wipe or blow on the window to assist evaporation.

k. Carefully examine the window by looking at a glancing reflection of a bright area. If the window still is not clean, choose a new sheet of lens tissue and repeat steps d through i until satisfactory results are achieved.

l. Repeat steps d through i to clean the other side of the window.

m. Carefully replace the window in the mount.

n. Install plastic retaining ring on window mount and secure with two screws.

o. Install window mount in chamber window aperture and secure with two screws.

p. Close chamber door.

5.5 REPLACEMENT PROCEDURES

5.5.1 Air Filter Replacement. (Figure 5-2) Replace the air filter every 6 months.

a. Open chamber door.

b. Place lit on vat.

c. Remove two screws and pull air filter with clamp attached straight out from chamber.

d. Install new air filter in chamber and secure with two screws.

e. Remove lid from vat.

f. Close chamber.

5.5.2 Chamber Lamp.

a. Set OVEN LAMP switch to off.

b. Open chamber door.

c. Grasp chamber lamp at both ends and pull straight down to disengage lamp.

d. Install new lamp by pushing both ends to engage the prongs.

e. Close chamber door.

f. Set OVEN LAMP switch to on. Verity that chamber lamp is illuminated.

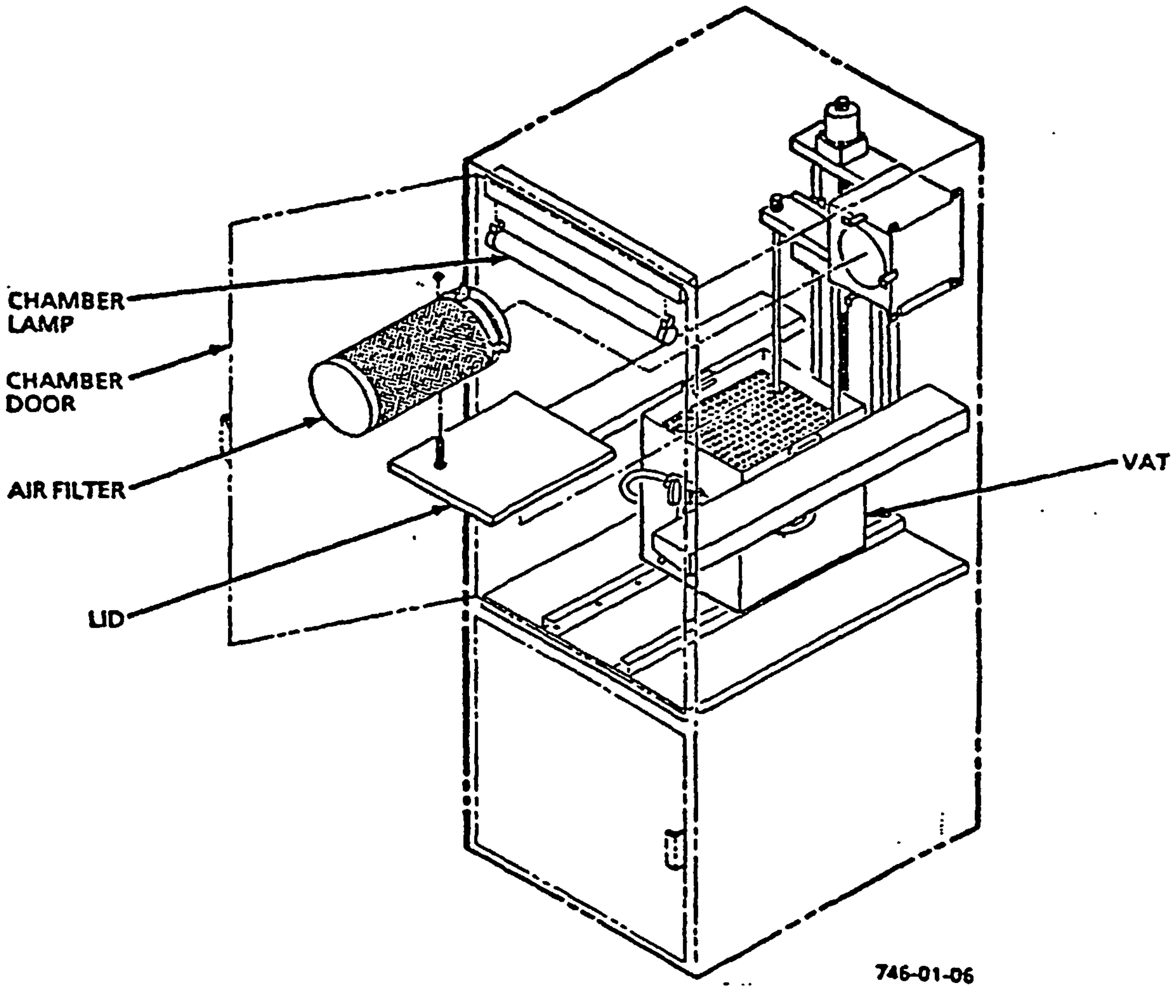


*Figure 5-2. Air Filter Replacement*

5.5.3 Control Panel Lamps.

a. Place a small flat blade screwdriver on bottom of plastic lens and push up to disengage lens.

b. Grasp plastic tab with screwdriver and pry lamp forward to remove.

c. Install new lamp in plastic tab.

d. Install plastic lens. Verify that lamp illuminates during normal operating sequence.

GLOSSARY

The following terms are used in the stereolithography process:

| | |
|---|---|
| 60/120 ANGLE HATCH | This is a type of crosshatching pattern which supplements the standard X and Y hatching. See software manual. |
| BANJO | This is a part which when built and measured provides line height and line width data for the working curve. |
| BASES (SUPPORTS) | These are the structures generated by the CAD which provide structural support to the actual part when being built. (See webs). |
| BEAM PROFILE | This is the spatial distribution of laser beam energy. |
| BORDER (BOUNDARY) | The border is a block of vectors defining the walls of a sliced layer of a part. |
| CAD | Computer aided design. |
| CENTERING | This is a SLICE routine which automatically centers the part in space. This can only be done if the part is defined by only one STL file. See software manual. |
| CLIFF | This is a software program which is used primarily in BASIC programming. It can also be used to move mirrors using direct commands from the DOS shell by transmitting data to STEREO. |
| CRITICAL AREA | This is an area within the part which has coordinates defined in a text file prior to merging. The area can have special attributes such as riveting. See software manual. |
| CROSSHATCH | This is a general interior vector type providing structural integrity to walls. The pattern used is defined during slicing. See software manual. |
| CURL | This is an effect sometimes encountered during part creation which can cause part inaccuracy. |
| DIP ACCELERATION | This is a part-building variable which defines the speed. of elevator dipping. It can be modified on a layer by layer basis if needed. |
| DIP DELAY | This is a part-building variable defining the delay between the start of a dip routine and the start of next layer calculations (and laser movement). It can be modified on a layer by layer basis. |
| DIP DEPTH | This a part-building variable which defines the distance the elevator moves downward during a dipping sequence. |
| DIP SPEED | This is a part-building variable which defines the maximum speed that the elevator attains. |
| DRAWING SPEED | Laser drawing speed is defined by the Supervisor variables Step Period and Step Size. It is varied depending on layer thickness, type of resin, and laser power. The drawing speed to be used is typically generated by use of the working curve. |
| DYNAMIC MIRRORS | These are the galvanometer vector scanning mirrors which are controlled by SLA-1 software. Laser beam movement is defined by the rotation of these mirrors. |
| ELEVATOR | The elevator is the vertically moving device to which the elevator platform and part are attached. |

| | |
|---|---|
| ETHERNET | This is file transfer software system. It allows for easy movement of large files. |
| FOOTPRINT | This is the bottom of the supports which adheres directly to the elevator platform. |
| GREEN PART | This is the laser cured part which has not undergone final post curing. |
| HATCH SPACING | This is the distance between crosshatching which is defined during slicing (see crosshatch). |
| HeCd | Helium Cadmium. |
| L FILE | This is a merge generated control file which contains all the layer by layer vector block identification information, Individual layer parameters can be modified in the L file. |
| LASER | This is the laser controller software. If is also a device which provides the light energy required to polymerize the liquid photopolymer. |
| LAYER THICKNESS | This is the layer to layer dipping distance. It can be either one value for the whole part or changed many times throughout the part (see variable layer thickness). |
| LEVELING | This is the time and temperature-dependent process where the resin settles to a flat surface after being distributed by dipping. The time allowed for leveling is defined by the dip delay variable. |
| LINE HEIGHT | This the vertical thickness of a laser cured plastic line. It is variable depending on drawing speed and laser power/focus. |
| LINE WIDTH | This is the width of a laser cured plastic line. It is variable depending on drawing speed and laser power/focus. |
| MERGE | This is a software program which takes the individual sliced files for a part and combines them. It generates the L and V files which Supervisor uses to make the part. |
| MIA | This is the minimum intersect angle and is used during slicing to delete hatch vectors which run parallel to layer boundaries. See software manual. |
| MODULUS | This is a physical attribute of a material which defines it's overall toughness. |
| MONOMER | This is a chemical species which is generally low in molecular weight and is used as a building block for preparing polymers. |
| MSA | This is the minimum surface angle and is used during slicing. See software manual. |
| MSHA | Mine Safety and Health Administration. |
| NIOSH | National Institute for Occuptational Safety and Health. |
| PHIGS FORMAT | This is the software program that defines the CAD surfaces by using triangles. |
| PHOTOINITIATOR | This is a chemical which transforms the laser energy into chemical energy and initiates the polymerization process. |
| PHOTOPOLYMER | This is a polymer which is formed using light as the energy source. |
| POST CURE | This is the process used to cure a green part. The post cure can be either ultraviolet light induced or thermal induced. |

| | |
|---|---|
| POT LIFE | This is the useful life expectancy of a pot of chemical and depends on the chemical stability and other factors. |
| PRIMARY RADICAL | This is the initial radical species formed when laser light is absorbed by the photoinitiator. The primary radicals initiate the polymerization process. |
| RADIAL CROSSHATCH | This is a specific type of crosshatch which generally provides the best overall strength and support (see crosshatch). |
| RADIOMETER | This is a device which allows for the measurement of the laser output power. |
| RESIN | This is the liquid photopolymer. |
| RIVET | This is a part making process which can be used in critical areas which may be prone to stress related inaccuracies. |
| SCALE FACTOR | This is a Supervisor variable which can be used to scale the XY space either larger or smaller. It does not affect the vertical dimension. |
| SENSITIZATION | This is an allergic response that some individual may obtain after repeated skin contract with a given chemical. |
| SKIN (SKIN FILL) | This is the coating of a horizontal (flat) or near horizontal (flat) area of the part. |
| SLA | Stereo-lithography Apparatus |
| SLICE | This is the software that transforms the three-dimensional CAD designed part into a series of two-dimensional layers (slices). |
| SMALLEY | This is a stress relieving (decoupling) structure designed on the CAD. |
| STEP PERIOD | This is a Supervisor variable which helps to define the laser drawing speed. Increasing the step period slows the speed (increases the plastic line height and width). |
| STEREO | This is a memory resident portion of the laser controller software. |
| STL FILE | This is the PHIGS format CAD file used as input for slicing. |
| SUPERVISOR | This is the software which supervises all the passing of variables and data to drive the mirrors and move the Z stage up and down during part building. |
| SILE STRENGTH | This is an attribute of a material which defines the energy required to stretch it. |
| TRAPPED VOLUMES | These are areas of the part from which resin cannot drain during dipping. |
| USER INTERFACE | This is the menu driven software which is used to control and run slicing programs. |
| .V FILE | This is a merge generated file which contains all the layer by layer vector information. See software manual. |
| VARIABLE LAYER THICKNESS | This is the process tool which allows use of differing dipping depths and layer thicknesses in order to achieve improved strength or accuracy. It is controlled within Slice. |
| WEB | This is a type of support structure designed by the CAD designer which can provide additional strength or support as needed. |

| | |
|---|---|
| WORKING CURVE | This is the plotted line height and line width data provided from Banjotop. It is used in with laser power to obtain drawing speed information. |

**NOT TO BE DISCLOSED**

THIS DOCUMENT CONTAINS CONFIDENTIAL INFORMATION RELATING TO STEREOLITHOGRAPHY PROCESSES AND EQUIPMENT WHICH ARE THE EXCLUSIVE PROPERTY OF 3D SYSTEMS, INC. THIS INFORMATION SHALL NOT BE DUPLICATED, USED OR DISCLOSED -- IN WHOLE OR IN PART -- FOR ANY PURPOSE OTHER THAN TRAINING AS AUTHORIZED IN WRITING BY 3D SYSTEMS, INC. ALL REASONABLE PRECAUTIONS SHALL BE TAKEN TO ENSURE COMPLIANCE WITH THESE CONDITIONS.

THE POSSESSION OF THIS DOCUMENT CONVEYS NO PROPERTY RIGHT OR LICENSE IN THE INFORMATION NOR IN ANY MATTER DISCLOSED THEREIN.

# SLA-1

# BETA SITE

# STEREOLITHOGRAPHY

# SYSTEM

# SERVICE MANUAL

TABLE OF CONTENTS
INTRODUCTION
TROUBLESHOOTING
COMPONENT REPLACEMENT
ALIGNMENT
SPARE PARTS LISTS
WIRING DIAGRAM

3D Systems Incorporated
12847 Arroyo Street
Sylmar, California 91342
(818) 898-1533 • FAX (818) 361-5484

NOVEMBER 1987

# Safety Precautions

**WARNING**
**INVISIBLE LASER RADIATION**

UV LASER RADIATION MAY DAMAGE EYE TISSUE. AVOID DIRECT EXPOSURE TO LASER BEAM. WEAR UV BLOCKING SAFETY GLASSES.

**WARNING**
**HIGH VOLTAGE**

HAZARDOUS VOLTAGES ARE ACCESSIBLE WITH MAINTENANCE PANELS REMOVED. FOLLOW SAFE WORK PRACTICES.

**WARNING**
**CHEMICAL HAZARDS**

UV CURABLE RESINS MAY CAUSE EYE AND SKIN BURNS. REPEATED OR PROLONGED SKIN CONTACT MAY CAUSE SENSITIZATION. VAPOR MAY BE HARMFUL.

Observe the following safety precautions when cleaning spilled resin or handling resin containers.

- Keep away from heat, sparks and flame. Protect from sunlight and fluorescent light. Closed containers may rupture/explode when exposed to extreme heat. Use National Fire Protection Association Class B extinguishers (carbon dioxide, dry chemical or foam).
- Use only with adequate ventilation. Avoid breathing vapors or spray mist.
- Wear safety glasses.
- Wear chemically resistant gloves and protective clothing. Wash thoroughly after handling and before eating, smoking or using toilet facilities.
- Wear an NIOSH/MSHA approved respirator or ensure adequate ventilation when sanding or cutting cured objects.

FIRST AID FOR CHEMICAL ACCIDENTS

**Skin Contact.** Wash thoroughly with soap and water. Remove contaminated clothing and shoes immediately. If skin is irritated, get medical attention. Wash clothing before reuse and discard contaminated shoes.

**Eye Contact.** Flush immediately with large amounts of water for 15 minutes and avoid sunlight, flourescent light, or other ultraviolet light. Get medical attention.

**Inhalation.** Remove victim to fresh air. Give artificial respiration or cardio-pulminary resuscitation if required. If breathing is difficult, give oxygen. Get medical attention.

TABLE OF CONTENTS

| Section/Paragraph | Title | Page |
|---|---|---|
| | INTRODUCTION | v |

(continued)

TABLE OF CONTENTS


| Section/Paragraph | Title | Page |
|---|---|---|
| I | TROUBLESHOOTING | 1-1 |
| 1.1 | Introduction | 1-1 |
| 1.2 | How to Use this Section | 1-1 |
| 1.3 | Test Points | 1-3 |
| | COMPONENT REPLACEMENT | 2-1 |
| 2.1 | Introduction | 2-1 |
| 2.2 | Tools | 2-1 |
| 2.3 | Sice Computer | 2-2 |
| 2.3.1 | Monitor | 2-2 |
| 2.3.2 | Keyboard | 2-2 |
| 2.3.3 | Slice Computer | 2-4 |
| 2.4 | Electronic Cabinet Assembly | 2-4 |
| 2.4.1 | Monitor | 2-4 |
| 2.4.2 | Keyboard | 2-7 |
| 2.4.3 . | Process Computer | 2-7 |
| 2.4.4 | Laser Power Supply | 2-8 |
| 2.4.5 2.4.6 | Elevator Driver AC Power Distribution Panel | 2-9 2-10 |
| 2.4.7 | Dynamic Mirrors Driver | 2-11 |
| 2.5 | Optics Assembly | 2-12 |
| 2.5.1 | Laser | 2-12 |
| 2.5.2 | Shutters | 2-15 |
| 2.5.3 | Beam-Turning Mirrors | 2-15 |
| 2.5.4 | Beam Expander | 2-16 |
| 2.5.5 | Dynamic Mirrors | 2-16 |
| 2.5.6 | Interlock Switches | 2-17 |
| 2.5.6.1 | Laser Cover | 2-17 |
| 2.5.6.2 | Optics Cover | 2-18 |
| 2.6 | Chamber Assembly | 2-18 |
| 2.6.1 2.6.2 | Heater/Fan Reaction Vat | 2-18 2-20 |
| 2.6.3 | Elevator | 2-21 |
| 2.6.4 | Platform | 2-21 |
| 2.6.5 | Beam Profiler | 2-22 |
| II | ALIGNMENT | 3-1 |
| 3.1 | Introduction | 3-1 |
| 3.2 | Tools and Equipment | 3-1 |
| 3.3 | Laser Resonator | 3-2 |
| 3.4 | Optics | 3-4 |
| 3.5 | Chamber | 3-7 |
| 3.5.1 | Vertical Alignment of Elevator | 3-7 |
| 3.5.2 | Horizontal Alignment of Optics Plate | 3-9 |
| IV | SPARE PARTS LIST | 4-1 |
| 4.1 | Introduction | 4-1 |
| 4.2 | To to Use this Section | 4-1 |
| 4.3 | Manufacturer's Names and Addresses | 4-2 |

(continued)


| TABLE OF CONTENTS | | |
|---|---|---|
| Section/Paragraph | Title | Page |
| V | WIRE LIST AND DIAGRAM | 5-1 |
| 5.1 | Introduction | 5-1 |
| 5.2 | Wire List and Diagram Diagram | 5-1 |

| LIST OF FIGURES | | |
|---|---|---|
| Figure | Title | Page |
| 2-1 | Slice Computer Components | 2-3 |
| 2-2 | Electronic Cabinet Components | 2-5 |
| 2-3 | Optics Components | 2-13 |
| 2-4 | Chamber Components | 2-19 |
| 3-1 | Laser Resonator Alignment | 3-3 |
| 3-2 | Optics Alignment | 3-5 |
| 3-3 | Chamber Alignment | 3-8 |
| 4-1 | SLA-1 Stereolithrography System | 4-3 |
| 4-2 | Electronic Cabinet Assembly | 4-5 |
| 4-3 | Optics Assembly | 4-7 |
| 4-4 | Chamber Assembly | 4-9 |
| 5-1 | SLA-1 Wiring Diagram | 5-2 |

| LIST OF TABLES | | |
|---|---|---|
| Figure | Title | Page |
| 1-1 | Fault Indication Chart | 1-1 |
| 2-1 | Replacement Tools | 2-1 |
| 3-1 | Alignment Toools and Equipment | 3-1 |
| 4-1 | Vendor Names and Addresses | 4-2 |


INTRODUCTION

SCOPE

This manual contains service and corrective maintenance procedures for the SLA-1 Beta Site Stereolithography System. This manual is to be used by qualified maintenance technicians to identify and replace defective components. Refer to the SLA-1 User's Manual for operation and routine maintenance procedures.

EANIZATION

This manual is divided into five sections, as follows:

SECTION I. TROUBLESHOOTING - Diagnostic and corrective procedures.

SECTION II. COMPONENT REPLACEMENT - Component removal and installation procedures.

SECTION III. ALIGNMENT - Alignment of laser, optics, and chamber.

SECTION IV. SPARE PARTS LISTS - Exploded view illustrations and lists of authorized spare parts.

SECTION V. WIRING DIAGRAM - Wiring diagram to aid in troubleshooting and continuity tests.

OTHER FEATURES OF INTEREST

**Title Page Index.** On the right side of the title page you will find a section index. The black markers printed to the right of the text are keyed to similar markers on the first page of each referenced section. To locate a section, flip through the manual until you find a marker printed in the same location as the title page marker.

**Warning Pages.** Following the title page you will find a summary of critical warnings. You may be seriously injured if these warnings are not explicitly followed. Carefully read all warnings and first aid instructions prior to performance of operation or maintenance instructions.

REPORTING ERRORS AND RECOMMENDING IMPROVEMENTS

This manual was prepared for use by Beta Site maintenance personnel. It will be revised to incorporate recommended content and format changes. If you find any mistakes, or if you have any recommendations for improving the procedures, please let us know by sending a copy of the marked-up page(s) to:

Atten: Chick Lewis
3D Systems Inc.
12847 Arroyo St.
Sylmar, California 91342
(818) 898-1533 • FAX (818) 361-5484

SECTION I

TROUBLESHOOTING

1.1 INTRODUCTION

This section contains troubleshooting procedures to identify and correct selected hardware failures. Troubleshooting procedures for operation errors are covered in the SLA-1 User's Manual.

1.2 HOW TO USE THIS SECTION

a. Perform the appropriate troubleshooting procedure referenced in Table 1-1 in accordance with the following special instructions.

**WARNING**

**HAZARDOUS VOLTAGES ARE ACCESSIBLE WITH MAINTENANCE PANELS REMOVED. FOLLOW SAFE WORK PRACTICES.**

1. The troubleshooting procedures are presented in flow diagram format. Use of the diagrams is described in Figure 1-1.

2. Test point illustrations are provided following the flow diagrams (paragraph 1.3).

b. Repeat the test portion of the flow diagrams after any part is replaced.

| Table 1-1. Fault Indication Chart | |
|---|---|
| Fault Indication | Troubleshooting Procedure (Figure No.) |
| | |

SECTION II

COMPONENT REPLACEMENT

2.1 INTRODUCTION

This section contains procedures to replace defective components. Each procedure is self-contained and is supported by an illustration keyed to the procedure in sequence of disassembly. Use the troubleshooting procedures in Section I to determine which components are defective.

WARNING

HAZARDOUS VOLTAGES ARE ACCESSIBLE WITH MAINTENANCE PANELS REMOVED. FOLLOW SAFE WORK PRACTICES.

2.2 TOOLS

Recommended replacement tools are listed in Table 2-1. Equivalent items may be used.

Table 2-1.

| Replacement Tools | | |
|---|---|---|
| Nomenclature | Part No. | Source |
| Screwdriver, flat blade, small | | Commercialy available |
| Wrench set, allen | | Commercialy available |
| Soldering iron, small | | Commercialy available |

2.3 SLICE COMPUTER (Figure 2-1)

2.3.1 Monitor.

a. Set power switch (1) on rear of monitor (2) to off.

b. Disconnect power cable (3) from monitor.

c. Use a small flat blade screwdriver to remove two connector screws and disconnect signal cable (4) from monitor.

d. Remove monitor.

e. Install new monitor.

f. Connect signal cable (4) to monitor and use a small flat blade screwdriver and install two connector screws.

g. Connect power cable (3) to monitor.

h. Set power switch (1) on rear of monitor to on.

2.3.2 Keyboard.

a. Set keyboard lockout keylock switch (5) on slice computer (6) to off.

b. Disconnect signal cable (7) from keyboard (8). The cable is terminated with a telephone jack.

c. Remove keyboard.

d. Install new keyboard.

e. Connect signal cable (7) to keyboard.

f. Set keyboard lockout keylock switch (5) on slice computer (6) to on.

LEGEND:

1. POWER SWITCH
2. MONITOR
3. POWER CABLE
4. SIGNAL CABLE
5. LOCKOUT SWITCH
6. SLICE COMPUTER
7. SIGNAL CABLE
8. KEYBOARD
9. DISKETTE
10. DISK DRIVE
11. POWER SWITCH
12 POWER CABLE (2 EA)
13. SIGNAL CABLE

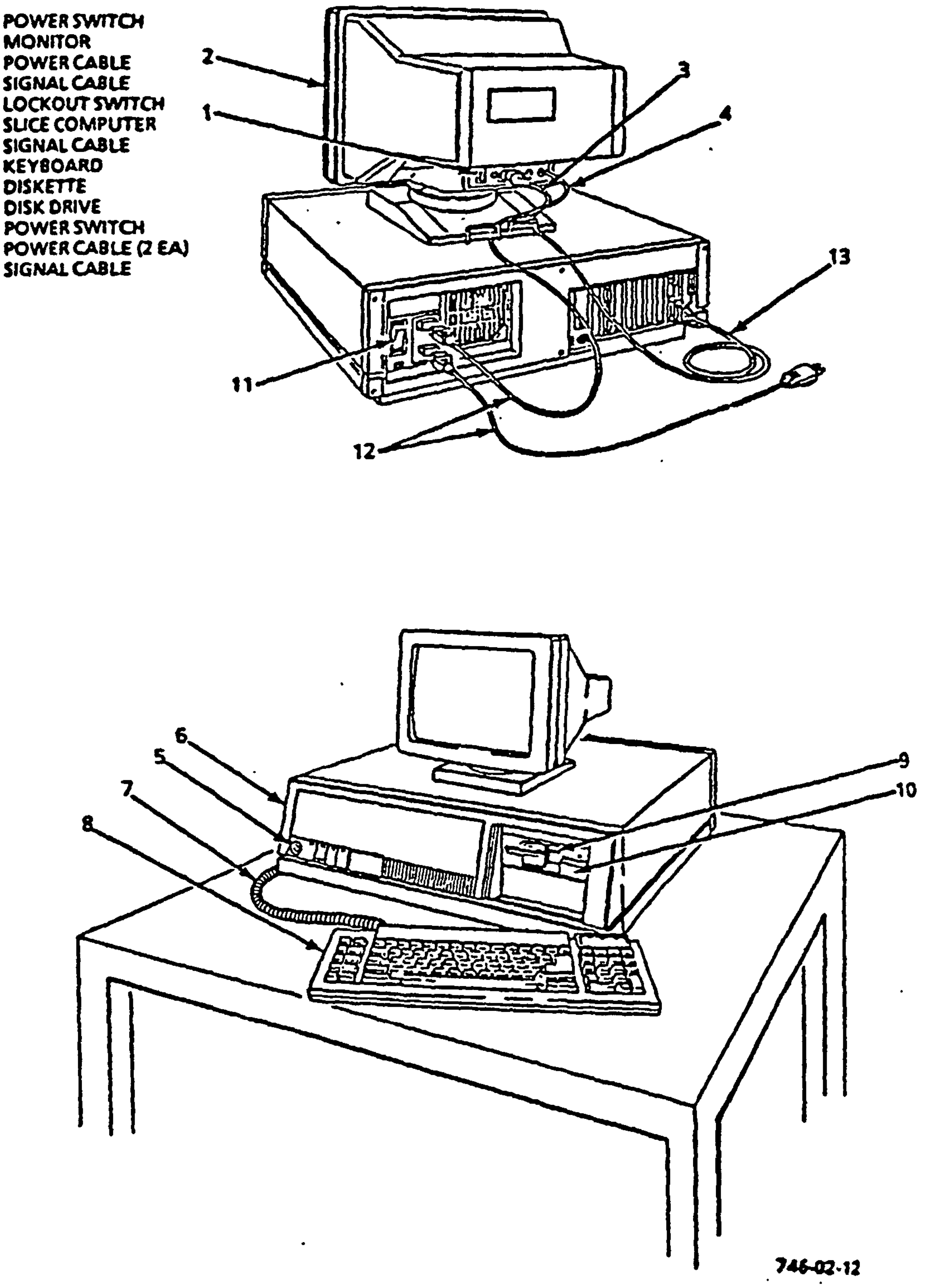


*Figure 2-1. Slice Computer Components*

2.3.3 Slice Computer.

CAUTION

Store the diskette in a safe place for protection.

a. Remove diskette (9) (if present) from disk drive (10).

b. Set keyboard lookout keylock switch (5) to off.

c. Set power switch (11) on rear panel to off.

d. Disconnect two power cables (12) (monitor power and ac input power) from rear panel.

e. Disconnect signal cable (7) (keyboard) from front panel.

f. Disconnect one signal cable (13) (monitor) and one coaxial cable (14) (Ethernet) from rear panel.

g. Remove slice computer (6).

h. Install new slice computer.

i. Connect signal cable (7) to front panel.

j. Connect one signal cable (13) and one coaxial cable (14) to rear panel.

k. Connect two power cables (12) to rear panel.

l. Set power switch (11) on rear panel to on.

m. Set keyboard lockout keylock switch (5) to on.

n. Install diskette (9) (if required) into disk drive (10).

2.4 ELECTRONIC CABINET ASSEMBLY (Figure 2-2)

2.4.1 Monitor.

a. Remove two screws (1) and remove cable access panel (2).

b. Set power switch (3) on rear of monitor (4) to off.

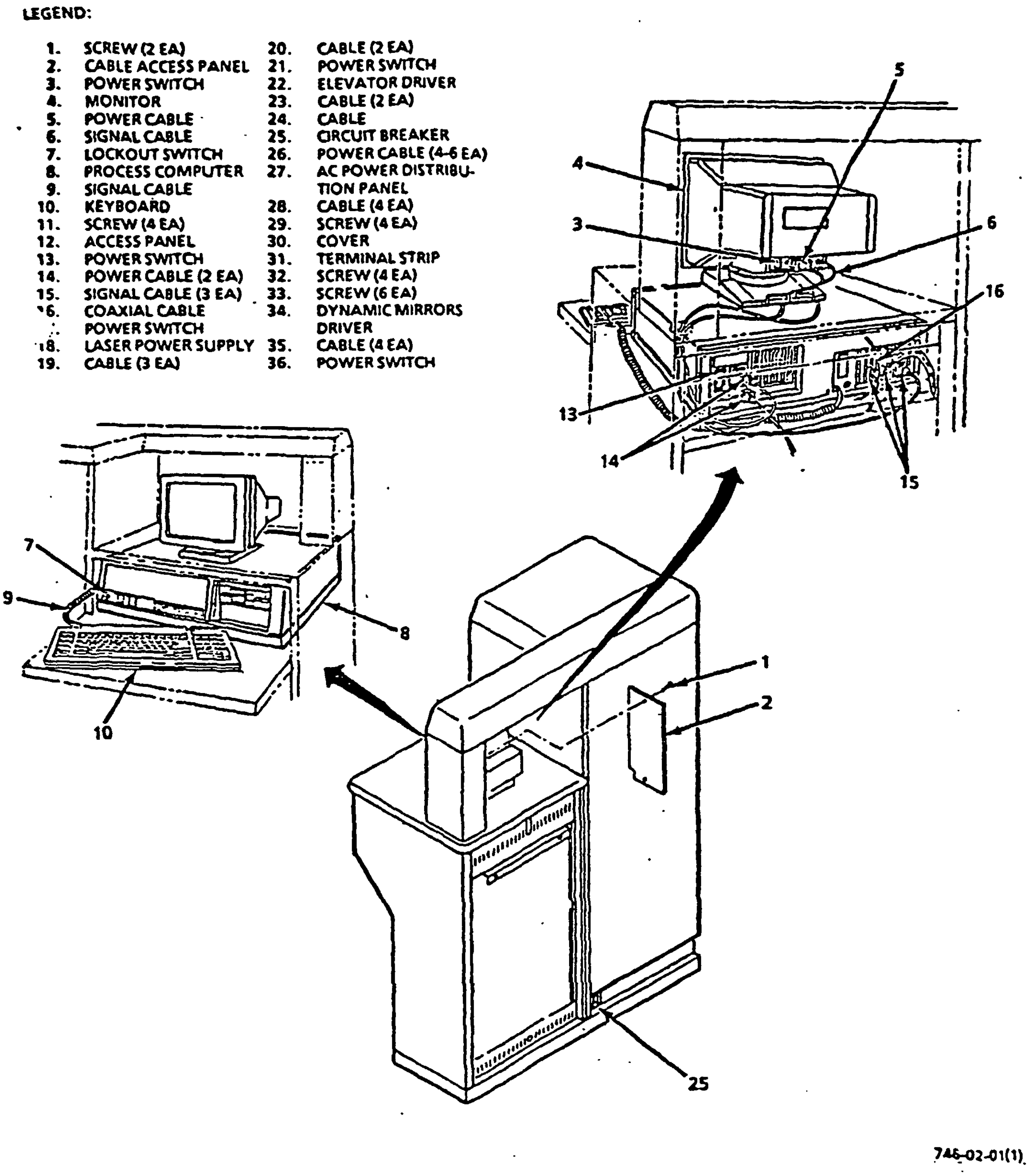


*Figure 2-2. Electronic Cabinet Components (Sheet 1 of 2)*

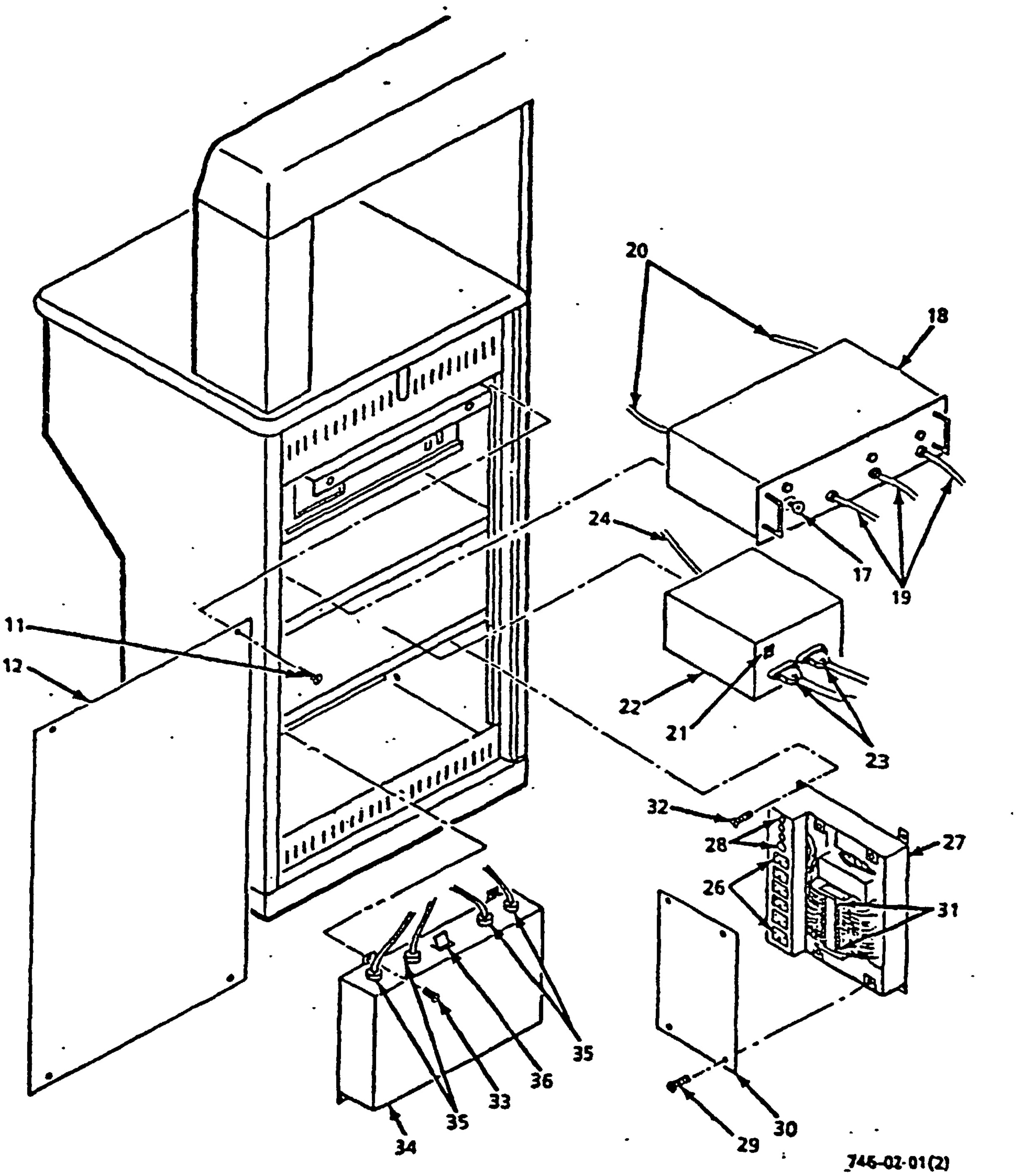


*Figure 2-2. Electronic Cabinet Components (Sheet 2 of 2)*

c. Disconnect power cable (5) from monitor.

d. Use a small flat blade screwdriver to remove two connector screws and disconnect signal cable (6) from monitor.

e. Remove monitor.

f. Install new monitor.

g. Connect signal cable (6) to monitor and use a small flat blade screwdriver to install two connector screws.

h. Connect power cable (5) to monitor.

i. Set power switch (3) on rear of monitor to on.

j. Install cable access panel (2) and secure with two screws (1).

2.4.2 Keyboard.

a. Set keyboard lockout keylock switch (7) on process computer (8) to off.

b. Disconnect signal cable (9) from keyboard (10). The cable is terminated with a telephone jack.

c. Remove keyboard.

d. Install new keyboard.

e. Connect signal cable (9) to keyboard.

f. Set keyboard lockout keylock switch (7) on process computer (8) to on.

2.4.3 Process Computer.

a. Remove four screws (11) and remove access panel (12) from rear of electronic cabinet assembly.

b. Set keyboard lockout keylock switch (7) to off.

c. Set power switch (13) on rear panel to off.

d. Disconnect two power cables (14) (monitor power and ac input power) from rear panel.

e. Disconnect three signal cables (15) (keyboard, elevator driver, and dynamic mirrors driver) and one coaxial cable (16) (Ethernet) from rear panel.

f. Push process computer (8) out through front panel and remove.
Push new process computer through front panel.

h. Connect three signal cables (15) and one coaxial cable (16) to rear panel.

i. Connect two power cables (14) to rear panel.

j. Set power switch (12) on rear panel to on.

k. Set keyboard lockout keylock switch (7) to on.

l. Install access panel (12) on rear of cabinet and secure with two screws (11).

2.4.4 Laser Power Supply.

**WARNING**

**IF THE HIGH VOLTAGE CONNECTORS ARE DISCONNECTED BEFORE POWER SWITCH IS TURNED OFF, HIGH-VOLTAGE ARCING WILL RESULT.**

a. Remove four screws (11) and remove access panel (12) from rear of electronic cabinet assembly.

b. Set keylock POWER switch (17) on laser power supply (18) to off. Verify that POWER ON and two DISCHARGE ON indicators are extinguished.

c. Disconnect three cables (19) from unit.

d. Grasp laser power supply by two handles and slide out of cabinet just enough to gain access to two cables (20) on rear of unit.

e. Disconnect two cables (20) from rear of unit.

f. Remove laser power supply from cabinet.

g. Install new laser power supply (18) into cabinet Just far enough to connect cables.

h. Connect two cables (20) to rear of unit.

i. Push laser power supply completely into cabinet.

j. Connect three cables (19) to unit.

k. Set keylock POWER switch (17) to on. Verify that POWER ON and two DISCHARGE ON indicators are illuminated.

l. Install access panel (12) on rear of cabinet and secure with four screws (11).

2.4.5 Elevator Driver.

a. Remove four screws (11) and remove access panel (12) from rear of electronic cabinet assembly.

b. Set power switch (21) on elevator driver (22) to OFF.

c. Loosen two screws from each connector and disconnect two cables (23) from unit.

d. Slide elevator driver out of cabinet just enough to gain access to cable (24) on rear of unit.

e. Disconnect cable (24) from rear of unit.

f. Remove elevator driver from cabinet.

g. Install new elevator driver (22) into cabinet just enough to connect cable.

h. Connect cable (24) to rear of unit.

i. Push elevator driver completely into cabinet.

j. Connect two cables (23) to unit and secure with two screws at each connector.

k. Set power switch (21) to on.

l. Install access panel (12) on rear of cabinet and secure with four screws (11).

2.4.6 AC Power Distribution Panel.

a. Turn off main circuit breaker (25) on bottom rear of electronic cabinet assembly.

b. Remove four screws (11) and remove access panel (12) from rear of electronic cabinet assembly.

c. Disconnect power cables (26) from connectors J1 through J6 on ac power distribution panel (27). Four to six cables will be present.

d. Disconnect cables (28) from Molex connectors J7 through J10 on unit.

e. Remove four screws (29) and remove terminal board access cover (30).

f. Disconnect wires from terminal strip (31) nearest rear of cabinet. Wires are marked and must be disconnected from terminals 1, 2, 3, 6, 9, 10, 11, and 12.

g. Remove four screws (32) (two top and two bottom) and remove ac power distribution panel from cabinet.

h. Install new ac power distribution panel (27) in cabinet and secure with four screws (32).

i. Remove four screws (29) and remove terminal board access cover (30).

j. Connect wires to terminal strip (31) nearest rear of cabinet. Connect wires to terminals 1, 2, 3, 6, 9, 10, 11, and 12 as marked.

k. Install terminal board access cover (30) and secure with four screws (29).

l. Connect cables (28) to Molex connectors J7 through J10.

m. Connect power cables (26) to connectors J1 through J6 as required.

n. Install access panel (12) on rear of cabinet and secure with four screws (11).

o. Turn on main circuit breaker (25).

2.4.7 Dynamic Mirrors Driver.

a. Remove ac power distribution panel (paragraph 2.4.6, steps a through g).

b. Remove six screws (33) (two top and four bottom) from dynamic mirrors driver (34) and tilt unit down to gain access to cables.

c. Remove four cables (35).

d. Remove dynamic mirrors driver from cabinet.

e. Install new dynamic mirrors driver (34) in cabinet.

f. Tilt unit downward and install four cables (35).

g. Place unit flush against cabinet and install six screws (33) (two top and four bottom).

h. Set power switch (36) to on.

i. Install ac power distribution panel (paragraph 2.4.6, steps h through o).

2.5 OPTICS ASSEMBLY (Figure 2-3)

2.5.1 Laser.

a. Set keylock POWER switch (17) on laser power supply (18) to off. Verify that POWER ON and two DISCHARGE ON indicators are extinguished.

b. Turn two allen screws (1) ccw to release (one on each end) and remove laser cover (2).

e. Remove four screws (11, Fig. 2-2) and remove access panel (12) from rear of electronic cabinet assembly.

d. Disconnect three cables (19) from laser power supply.

e. Remove two screws (1) and remove cable access panel (2).

f. Pull three cables up through cable access hole.

g. Remove four cap screws (3, Fig. 2-3) from laser (4) (two front and two back).

h. Loosen allen screw (5) and remove interlock switch (6) from rear of laser.

i. Lift laser and remove from cabinet.

j. Install new laser (4) on cabinet and secure with four cap screws (3).

k. Install interlock switch (6) on rear of laser and tighten allen screw (5).

l. Push three cables (19, Fig. 2-2) through cable access hole to laser power supply (18).

m. Install cable access panel (2) on cabinet and secure with two screws (1).

LEGEND:

1. SCREW (2 EA)
2. LASER COVER
3. SCREW (4 EA)
4. LASER
5. SCREW
6. INTERLOCK SWITCH
7. SCREW (2 EA)
8. OPTICS COVER
9. SHUTTERS
10. SCREW (2 EA)
11 THUMBSCREW
12. BEAM-TURNING MIRROR
13. SCREW (4 EA)
14. BEAM EXPANDER
15. SCREW (2 EA)
16. DYNAMIC MIRRORS
17. SCREW (2 EA)
18. INTERLOCK SWITCH
19. SCREW (2 EA)
20. INTERLOCK SWITCH (2 EA)

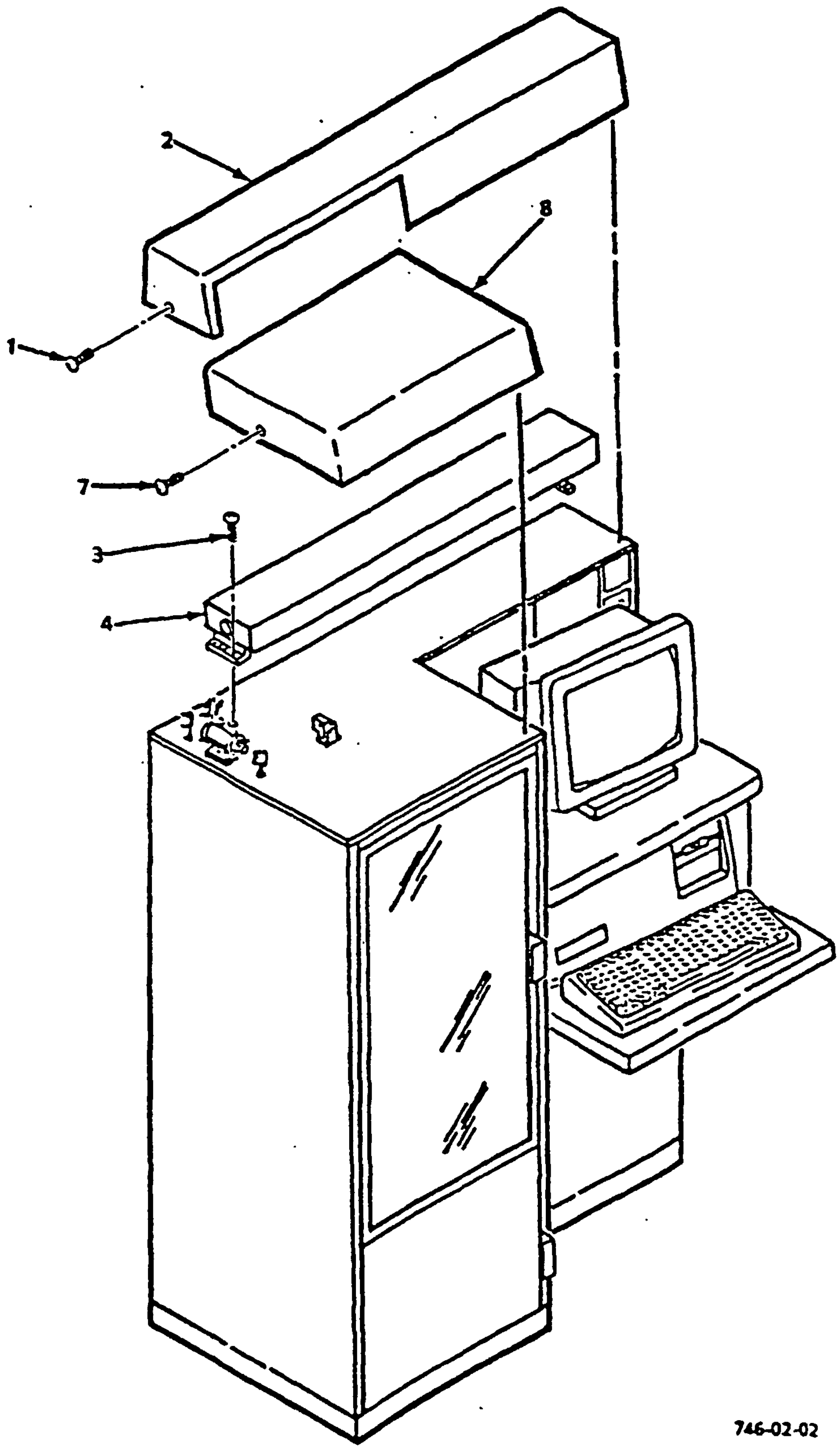


*Figure 2-3. Optics Components (Sheet 1 of 2)*

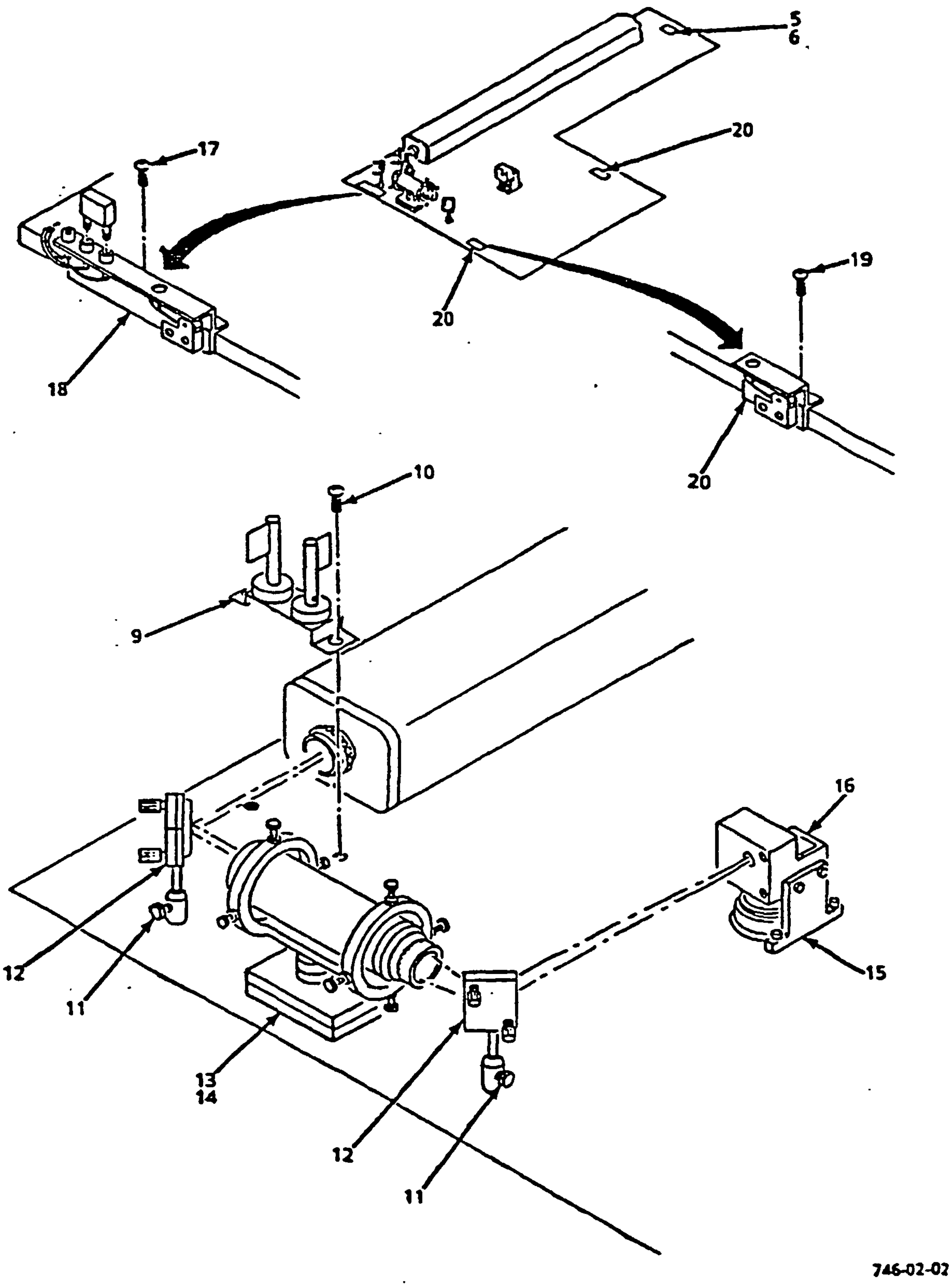


*Figure 2-3. Optics Components (Sheet 2 of 2)*

n. Connect three cables (19) to laser power supply.

o. Set keylock POWER switch (17) on laser power supply to onverify that POWER ON and two DISCHARGE ON indicators are illuminated.

p. Install access panel (12) on rear of cabinet and secure with four screws (11).

q. Align laser mirrors (paragraph 3.3).

r. Install laser cover (2, Fig. 2-3) and turn two allen screws (1) cw to latch.

2.5.2 Shutters.

a. Turn two allen screws (7) ccw to release (one on each end) and remove optics cover (8).

c. Tag and unsolder wires from shutters (9).

d. Remove two allen screws (10) and remove shutters.

e. Solder wires to new shutters (9).

f. Install shutters and secure with two allen screws (10),

g. Install optics cover (8) and turn two allen screws (7) cw to latch.

2.5.3 Beam-Turning Mirrors.

a. Turn two allen screws (7) ccw to release (one on each end) and remove optics cover (8).

b. Loosen thumbscrew (11) and lift beam-turning mirror (12) straight up.

c. Install new beam-turning mirror (12) and tighten thumbscrew (11).

d. Align beam-turning mirrors (paragraph 3.4).

e. Install optics cover (8) and turn two allen screws (7) cw to latch.

2.5.4 Beam-Expander.

a. Turn two allen screws (7) ccw to release (one on each end) and remove optics cover (8).

b. Remove four allen screws (13) and lift beam expander (14) straight up.

c. Install new beam expander (14) and secure with four allen screws (13).

d. Install optics cover (8) and turn two allen screws (7) cw to latch.

2.5.5 Dynamic Mirrors.

a. Turn two allen screws (7) ccw to release (one at each end) and remove optics cover (8).

b. Remove four screws (11, Fig. 2-2) and remove access panel (12) from rear of electronic cabinet assembly.

c. Set power switch (35) on dynamic mirrors driver (33) to off.

d. Disconnect two outer cables (34) from dynamic mirrors driver.

e. Remove two screws (1) and remove cable access panel (2).

f. Pull two cables (34) up through cable access hole.

g. Remove two allen screws (15, Fig. 2-3) and lift dynamic mirrors (16) straight up from cabinet.

h. Install new dynamic mirrors (16) on cabinet and secure with two allen screws (15).

i. Push two cables (34, Fig. 2-2) through cable access hole to dynamic mirrors driver (33).

j. Install cable access panel (2) on cabinet and secure with two screws (1).

k. Connect two cables to dynamic mirrors driver.

l. Set power switch (35) on dynamic mirrors driver to on.

m. Install access panel (12) on rear of cabinet and secure with four screws (11).

n. Align beam-turning mirrors (paragraph 3.4).

o. Install optics cover (8, Fig. 2-3) and turn two allen screws (7) cw to latch.

2.5.6 Interlock Switches.

2.5.6.1 Laser Cover.

a. Turn two allen screws (1) ccw to release (one at each end) and remove laser cover (2).

b. Loosen one allen screw (5) and lift interlock switch (6) from rear of laser (4).

c. Tag and unsolder wires from switch.

d. Loosen two allen screws (17) and lift dual interlock switch (18) from cabinet.

e. Tag and unsolder wires from switch.

f. Solder wires to new interlock switch (6).

g. Install switch on rear of laser (4) and tighten one allen screw (5).

h. Solder wires to new dual interlock switch (18).

i. Install switch on cabinet and tighten two allen screws (17).

j. Install laser cover (2) and turn two allen screws (1) cw to latch.

2.5.6.2 Optics Cover.

a. Turn two allen screws (7) ccw to release (one at each end) and remove optics cover (8).

b. Loosen two allen screws (19) (one for each switch) and lift interlock switch (20) from cabinet.

c. Tag and unsolder wires from switches.

d. Solder wires to new interlock switches (20).

e. Install switches on cabinet and tighten two allen screws (19) (one for each switch).

f. Install optics cover (8) and turn two allen screws (7) cw to latch.

2.6 CHAMBER ASSEMBLY (Figure 2-4)

2.6.1 Heater/Fan.

a. Open chamber door (1).

b. Remove air filter (paragraph 2.6.1, steps a and b).

c. Set main circuit breaker on bottom rear of electronic cabinet assembly to off.

LEGEND:

1. CHAMBER DOOR
2. SCREW (2 EA)
3. BOTTOM COVER
4. HEATER/FAN
5. TERMINAL STRIP
6. SCREW (4 EA)
7. SIDE SHELF (2 EA)
8. KNOB (2 EA)
9. PLATFORM ROD (2 EA)
10. REACTION VAT
11. LID
12. LATCH (4 EA)
13. DRAIN VALVE
14. COLLECTION BOTTLE
15. SIDE HANDLE (2 EA)
16. SCREW (2 EA)
17. PLATFORM
18. CABLE
19. SCREW
20. CABLE CLAMP
21. SCREW (4 EA)
22. ELEVATOR
23. CHAMBER CABLE

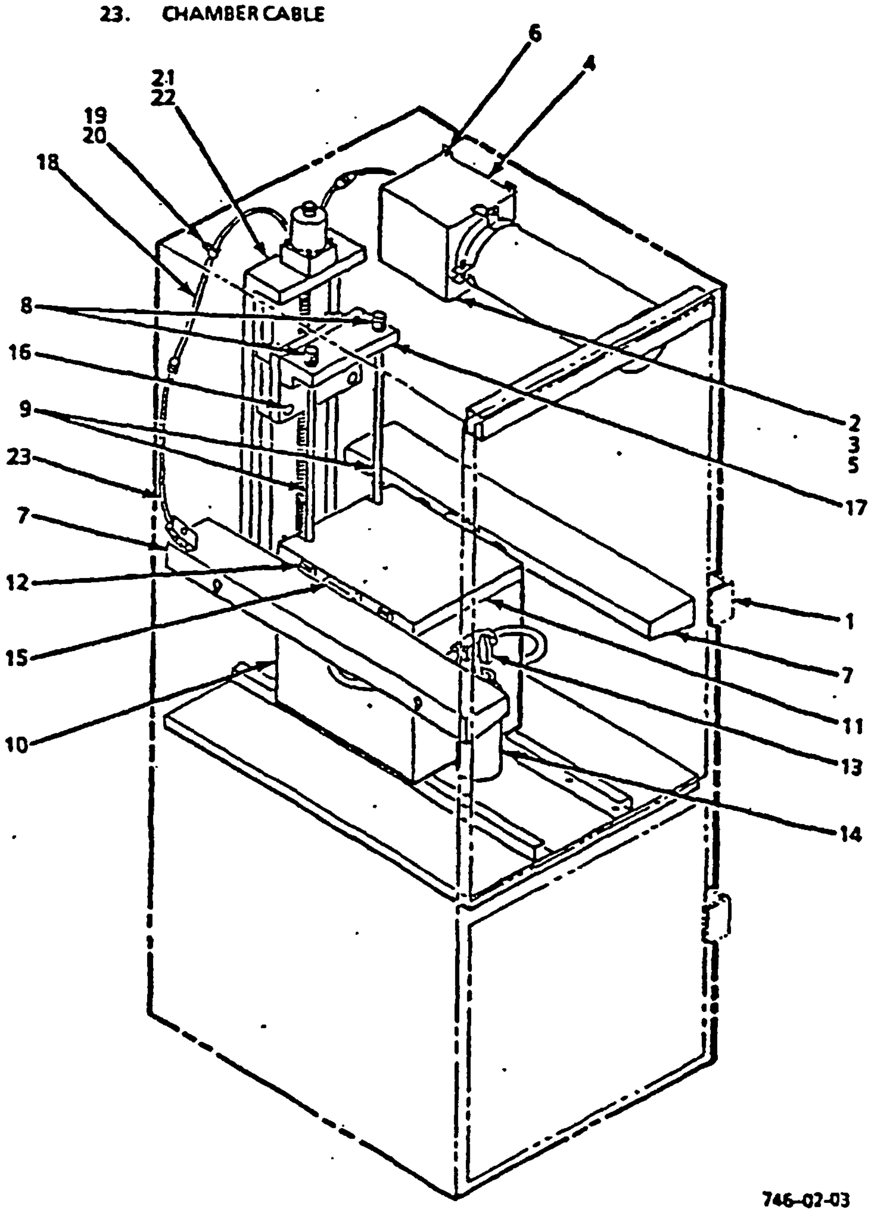


*Figure 2-4. Chamber Components*

d. Remove four screws (2) and remove bottom cover (3) on heater/fan (4).

e. Disconnect three wires from terminal strip (5). The wires are marked.

f. Remove four screws (6) and remove heater/fan (4) from chamber.

h. Install new heater/fan (4) in chamber and secure with four screws (6).

g. Remove four screws (2) and remove bottom cover (3) from new heater/fan.

i. Connect three wires as marked to terminal strip (5).

j. Install bottom cover (3) on heater/fan and secure with four screws (2).

k. Set main circuit breaker on electronic cabinet assembly to on.

l. Install air filter (paragraph 2.6.1, steps c and d).

m. Close chamber door (1). Verify that fan is turning.

2.6.2 Reaction Vat.

a. Open chamber door (1).

b. Remove two side shelves (7) by lifting shelves to disengage from attaching screws.

c. Unscrew two knobs (8) to disengage platform rods (9) from vat (10).

d. Install lid (11) on vat and secure four latches (12).

e. Turn off drain valve (13) and remove collection bottle (14).

f. Grasp vat by two side handles (15) and slide out of chamber.

g. Clean resin from platform rods (9) (refer to User's Manual).

h. Slide new vat (10) into chamber.

i. Remove lid (11) from vat by releasing four snap fasteners.

j. Screw two knobs (8) to engage platform rods (9) to vat.

k. Place collection bottle (14) under valve (13) and turn on drain valve.

l. Fill vat with resin (refer to User's Manual).

m. Installl two side shelves (7).

n. Close chamber door (1).

2.5.3 Platform.

a. Open chamber door (1).

b. Remove two screws (16).

c. Unscrew two knobs (8) to disengage platform rods (9) from vat (10) and lift platform (17) straight out of chamber.

d. Install new platform (17) in chamber and screw two knobs (8) to engage platform rods (9) to vat (10).

e. Install two screws (16).

f. Close chamber door (2).

2.6.4 Elevator.

a. Open chamber door (1).

b. Disconnect cable (18) from left side of chamber.

c. Remove one screw (19) and remove cable clamp (20).

d. Remove platform (paragraph 2.6.3, steps a through c).

e. Remove four allen screws (21) and pull elevator (22) and cable straight out of chamber.

f. Install new elevator (22) in chamber and secure with four allen screws (21).

g. Install platform (paragraph 2.6.3, steps d through f).

h. Install cable clamp (20) on cable (18) and secure to cable and clamp to chamber with one screw (19).

i. Connect elevator cable (18) to chamber cable (23).

j. Close chamber door (1).

2.6.6 Beam Profiler. It is extremely difficult to remove the beam profiler in the Beta Site systems. Therefore, it is recommended that this unit not removed. The SLA-1 can still operate even though the beam profiler is defective.

SECTION III

ALIGNMENT

3.1 INTRODUCTION

This section contains procedures to align the laser, optics, and chamber. These procedures must be performed when the optics or laser is replaced, or when these items become misaligned through normal wear.

3.2 TOOLS AND EQUIPMENT

Recommended alignment tools and equipment are listed in Table 3-1. Equivalent items may be used.

Table 3-1.

| Alignment Tools and Equipment | | |
|---|---|---|
| Nomenclature | Model/Part No. | Source |
| Ball driver, allen (2 ea) | | Commercialy available |
| Power meter, laser | | Liconix |
| T-square | | Commercialy available |
| Caliper | | Commercialy available |
| Tape, scotch | | Commercialy available |
| Thumb bob | | Commercialy available |
| Alignment tool, vertical | | 3D Systems |
| Level, precision | | Commercialy available |
| Wrench set, allen | | Commercialy available |

Table 3-1. (continued)

| Alignment Tools and Equipment | | |
|---|---|---|
| Nomenclature | Model/Part No. | Source |
| | | |

3.3 LASER RESONATOR (Figure 3-1)

This is a very touchy alignment which should only be performed when laser power or beam shape has deteriorated. Two allen ball drivers (5/64 inch) and a laser power meter are required to perform this procedure.

a. Remove optics cover and laser cover.

b. Remove two screws and remove shutter assembly.

c. Place laser power meter to interrupt laser beam.

d. Insert one ball driver in upper rear laser adjustment hole and second ball driver in upper front laser adjustment hole.

e. Observe laser power meter and detune (turn 1/10 turn ccw) rear laser mirror adjustment.

f. Tune front laser mirror adjustment to maximize power. Adjust in small increments only.

g. Detune rear laser mirror (turn 1/10 turn cw) adjustment and repeat step f.

h. Repeat steps e and f several times until maximum power is obtained.

i. Place a card in front of the laser power meter and note shape of laser beam. The beam should be relatively round. If not, repeat steps e through h several times for a round beam shape at maximum power.

j. Carefully remove both ball drivers and remove card.

k. Insert one ball driver in lower rear laser adjustment hole and second ball driver in lower front laser adjustment hole.

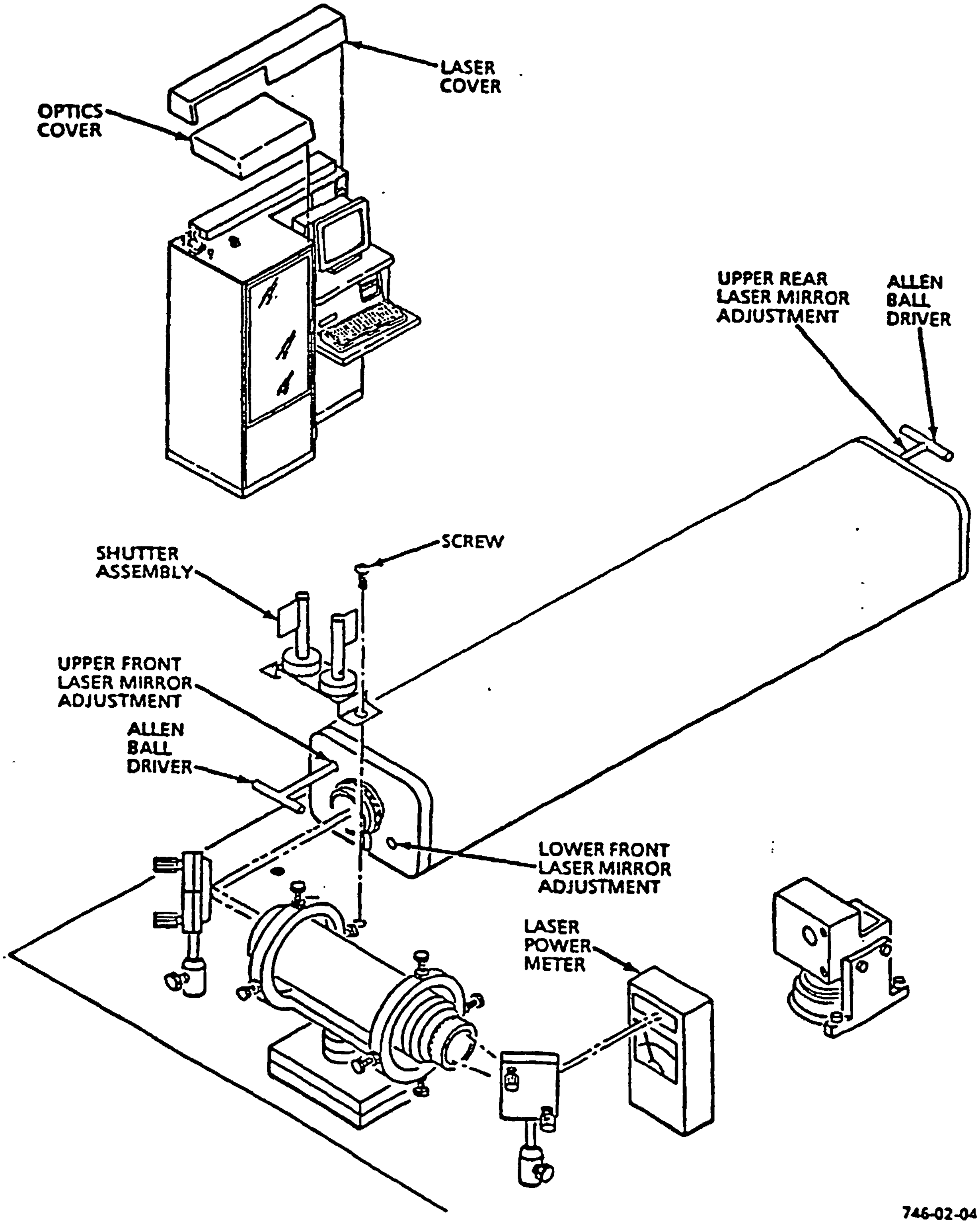


*Figure 3-1. Laser Resonator Alignment*

l. Repeat steps e through i several times until a round beam shape at maximum power is obtained.

m. Repeat upper and lower laser mirror adjustment several times to optimize laser power and beam shape.

n. Carefully remove both ball drivers and remove card.

o. Remove laser power meter.

p. Install shutter assembly and secure with two screws.

q. Install optics cover and laser cover.

3.4 OPTICS (Figure 3-2)

WARNING

UV LASER RADIATION MAY DAMAGE EYE TISSUE. AVOID DIRECT EXPOSURE TO LASER BEAM. WEAR SAFETY GLASSES.

CAUTION

Fingerprints may damage optics coatings. Clean hands thoroughly and strictly avoid touching optical surfaces.

a. Remove optics cover.

b. Loosen two adjustment screws (front and rear) and slide beam expander out and remove.

c. Adjust two each adjustment screws on two beam-turning mirrors and adjust mirrors so that laser beam strikes center of both mirrors and center window of dynamic window.

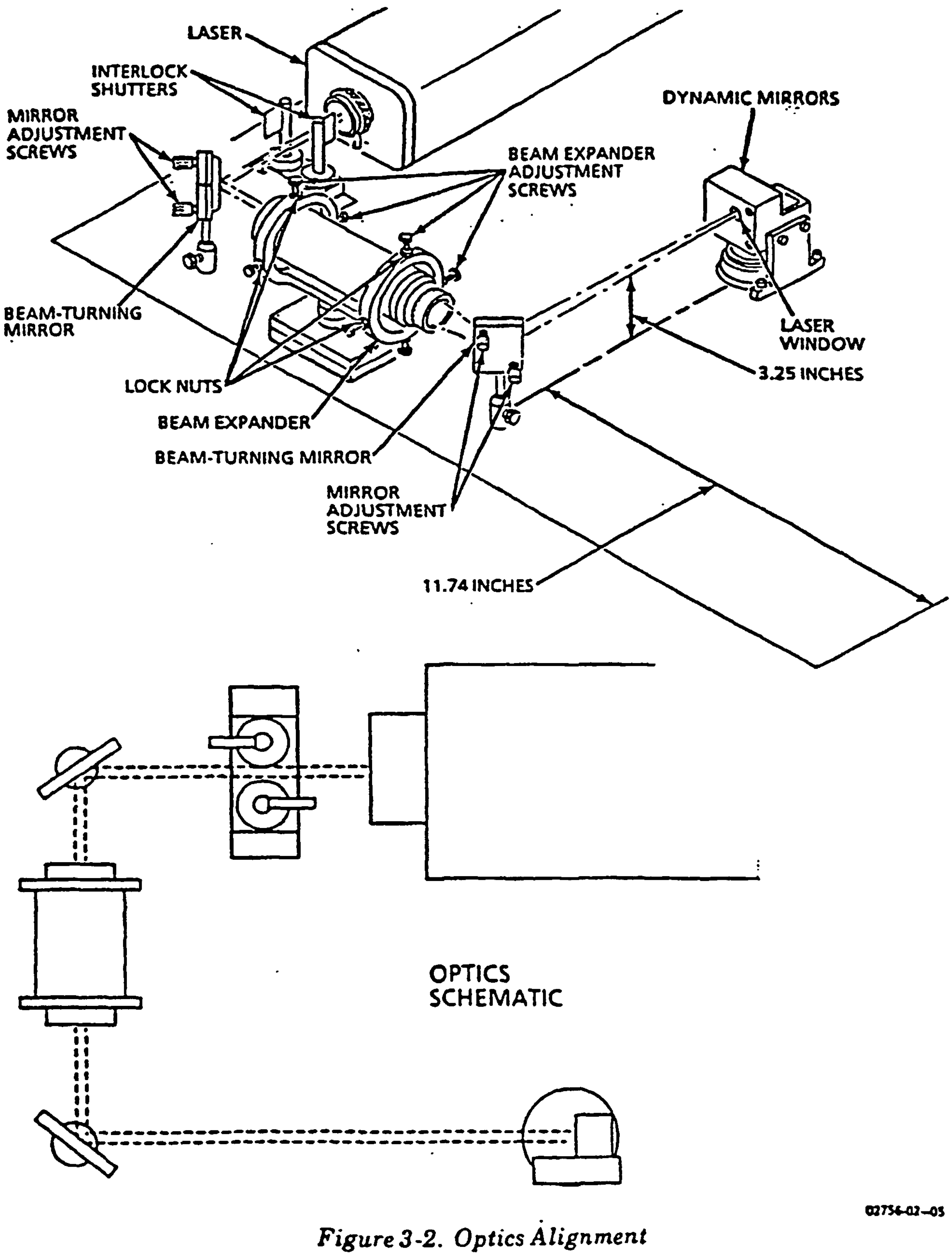


*Figure 3-2. Optics Alignment*

d. Use a T-square to check that beam path between second beam turning mirror and dynamic mirror is exactly 3.25 inch above optic plate along entire beam path. Use a set of calipers to take measurements.

e. Adjust two adjustment screws on second beam-turning mirror to achieve correct value.

f. Use a 12-inch set of calipers to check that beam path between second beam-turning mirror and dynamic mirror is exactly 11.74 inch from beam path to front edge of optic plate along entire beam path.

g. Adjust two adjustment screws on second beam-turning mirror to achieve correct value.

h. Repeat steps d through g several times for optimim vertical and horizontal alignment.

i. Put transparent scotch tape over input and exit apertures of beam expander. Make sure that tape does not contact lenses.

j. Install beam expander.

k. Adjust beam expander adjustment screws so that laser beam is centered as close as possible at input and exit apertures. Do not adjust any mirrors, only the beam expander. The position of the beam as it strikes the second beam-turning mirror and dynamic mirror should not change after installation of beam expander.

l. Tighten lock nuts on beam expender adjustment screws.

m. Remove scotch tape from beam expander apertures.

n. Install optics cover.

3.5 CHAMBER (Figure 3-3)

3.5.1 Vertical Alignment of Elevator. The perfect alignment of the elevator axis with the Vertical is critical for building of accurate stereolithographic parts. Any off-vertical alignment of components will result in a vertical skew of every part built with the SLA-1.

a. Remove reaction vat and platform (Section II).

b. On bottom of cabinet, raise up floor adjustment foot number 4 to balance cabinet on three feet.

c. Remove two allen screws and remove optic cover.

d. Open chamber door.

e. Remove two inside screws and lower optic window mount from inside chamber.

f. Suspend a plumb bob from center of optic window aperture.

g. Adjust height of string until top of plumb bob exactly touches floor of chamber.

h. Place a sheet of paper on bottom of chamber and mark plumb bob position exactly.

i. Install vertical alignment tool and place string against vertical string groove.

j. Run elevator up and down while observing plumb bob for lateral movement.

k. If plumb bob moves off from spot marked in step g, adjust chamber floor adjustment cabinet feet (1, 2, and 3) for best vertical - alignment.

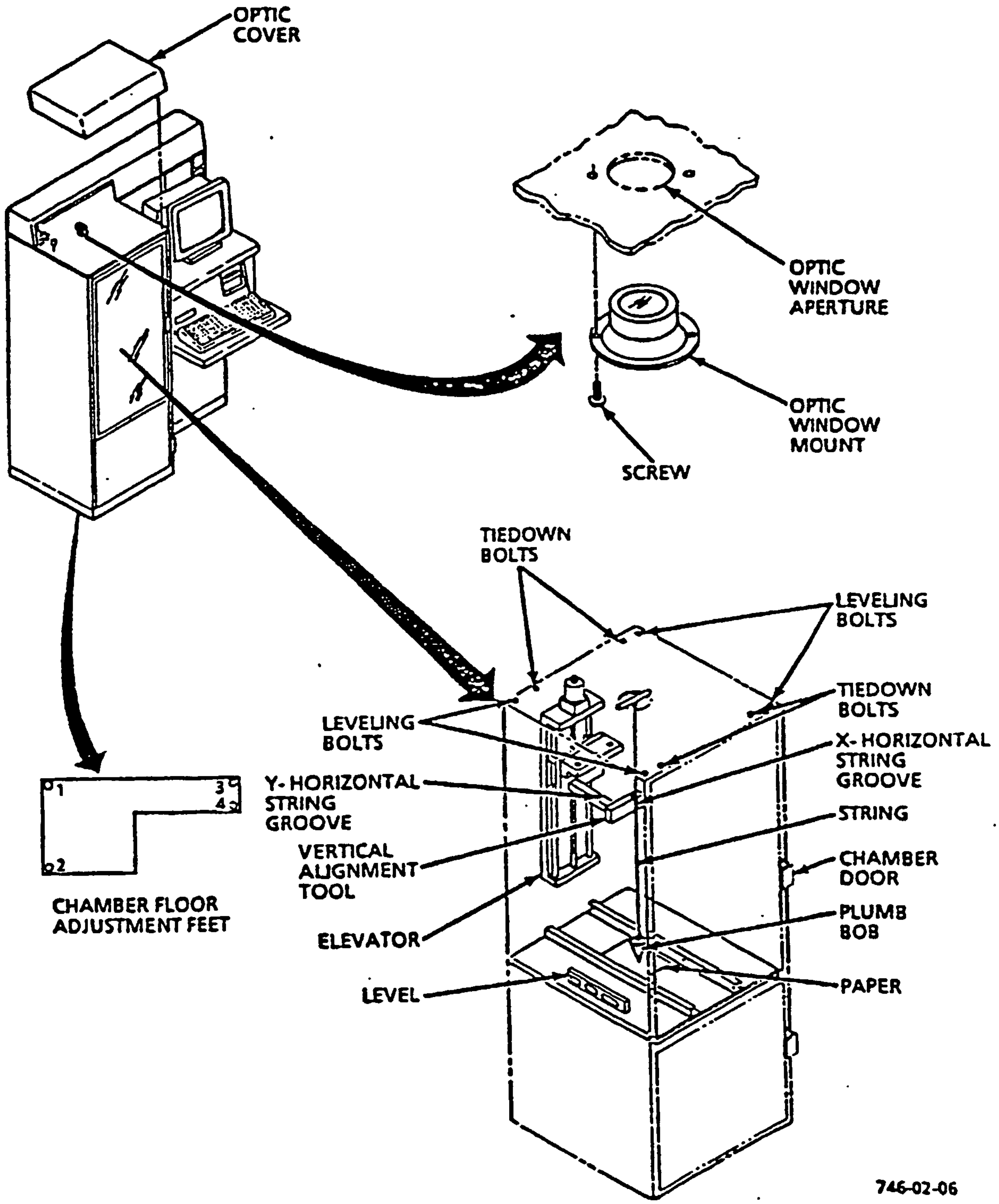


*Figure 3-3. Chamber Alignment*

l. Place string against horizontal string groove and mark plumb bob position.

m. Repeat steps j and k.

n. Repeat steps i through m several times until optimum leveling is achieved.

o. Lower foot number 4 to floor level. (Be careful not to upset leveling.)

p. Remove vertical alignment tool and plumb bob.

q. Install optic window mount by installing two screws inside chamber.

r. Close chamber door.

s. Install platform and reaction vat (Section II).

3.5.2 Horizontal Alignment of Optics Plate. Do not use the adjustable feet of the SLA-1 for horizontal alignment. This will upset the vertical alignment of the elevator.

a. Loosen four tiedown bolts on optic plate.

b. Place a precision level on optics plate.

c. Adjust four levelling bolts for optimum horizontal level at all points of the optics plate.

d. Tighten tiedown bolts.

SECTION IV

SPARE PARTS LISTS

4.1 INTRODUCTION

This section contains an exploded view illustration and listing of each authorized spare part.

4.2 HOW TO USE THIS SECTION

a. Locate the defective part or assembly in which the part is located in Figure 4-1. Note the index number.

NOTE

The SLA-1 is arranged into three major assemblies or component groups: the electronic cabinet assembly, the optics assembly, and the chamber assembly. These assemblies and components are illustrated and listed in Figure 4-1. Subassemblies and detail parts are listed in parts lists 4-2 through 4-4.

b. Locate the index number in the parts list for Figure 4-1 and note the part number, nomenclature and source for replaceable parts, or the figure number in which the replaceable parts are listed. Assemblies containing replaceable parts are listed for reference purposes only and are identified by the abbreviation REF in the Units Per Assy column.

c. Repeat steps a and b to locate subassemblies and detail parts in the referenced parts list.

d. Order replacement parts from the listed manufacturer in accordance with the instructions in paragraph 4.3.

4.3 MANUFACTURER'S NAMES AND ADDRESSES

SLA component manufacturers are listed in Table 4-1. When ordering spare parts, specify the part number, nomenclature, and quantity required. Always inform your 3-D Systems project engineer first if problems arise. He will usually be able to arrange to acquire the necessary parts. The manufacturers of SLA-1 components and subassemblies are listed for convenience.

Table 4-1.

| Vendor Names and Addresses | |
|---|---|
| Manufacturer | Address and Telephone |
| 3D Systems, Inc. | 12847 Arroyo St.<br>Sylmar, CA 91342<br>(818) 898-1533<br>FAX (818) 361-5484 |
| General Scanning, Inc. | 500 Arsenal St.<br>Watertown, MA 02272<br>(617) 924-1010 |
| Liconix | 1390 Borregas Ave.<br>Sunnyvale, CA 94089<br>(408) 734-4331<br>TWX 910-379-6475 |
| Newport Corp. | 18235 Mount Baldy Circle<br>Fountain Valley, CA 92728-8020<br>(714) 963-9811 |
| Wyse Technology | 3571 North First St.<br>San Jose, CA 95134<br>(408) 433-1026 |

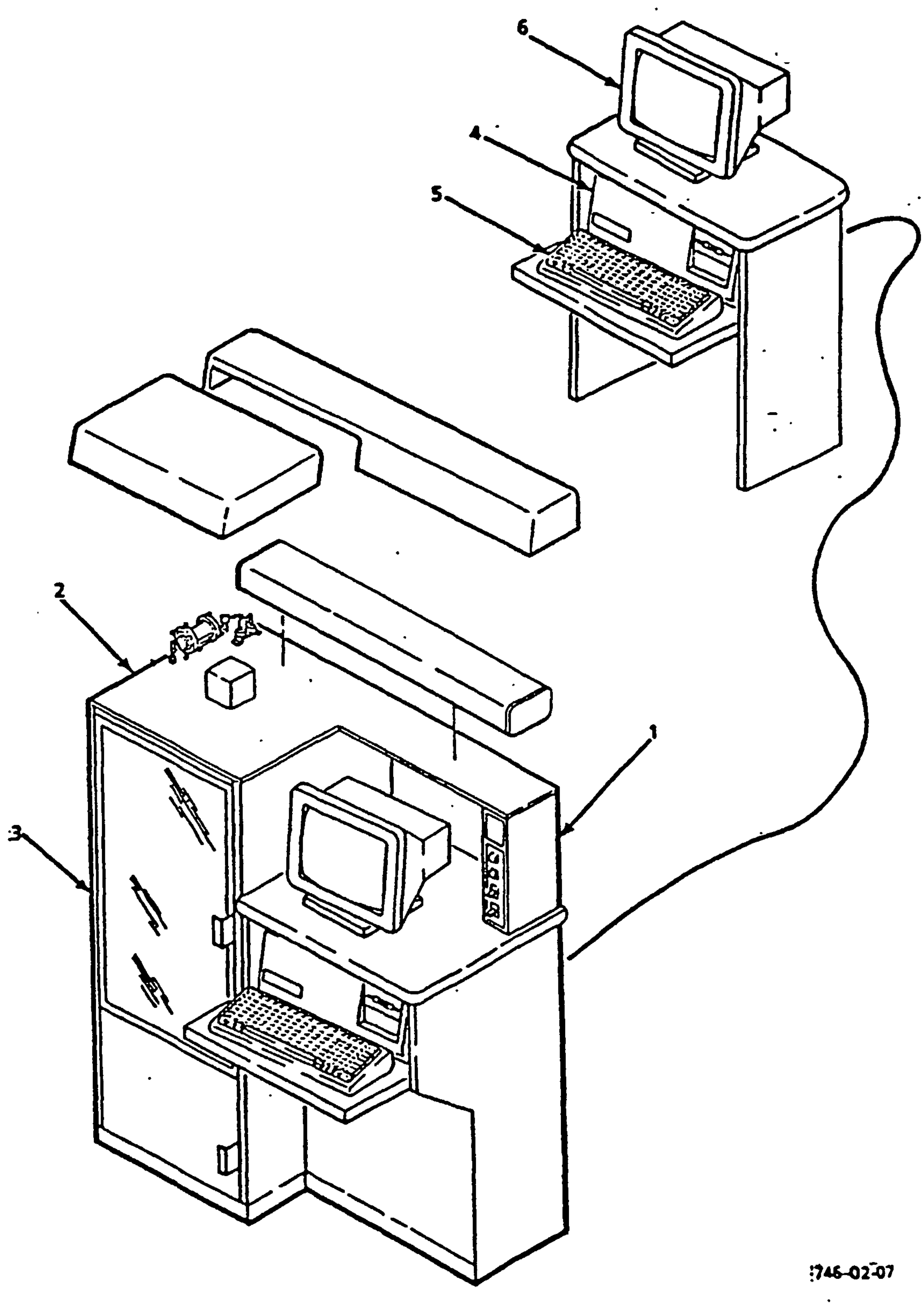


*Figure 4-1. SLA-1 Stereolithography System*

| Figure & Index Number | Part Number | Description 1 2 3 | Units Per Assy | Manufacturer |
|---|---|---|---|---|
| 4-1 | | SLA-1 STEREOLITHOGRAPHY SYSTEM, Beta Site | | |
| 1 | 16135 | • CABINET ASSY, Electronic (See Figure 4-2 for detail parts) | 1 | 3D Systems |
| 2 | 424ONB | • OPTICS ASSY (See Figure 4-3 for detail parts) | 1 | 3D Systems |
| 3 | | • CHAMBER ASSY (See Figure 4-4 for detail parts) | 1 | 3D Systems |
| 4 | PC 386 | • COMPUTER ASSY, Slice | | Wyse |
| 5 | | • KEYBOARD | | Wyse |
| 6 | | • MONITOR | | Wyse |

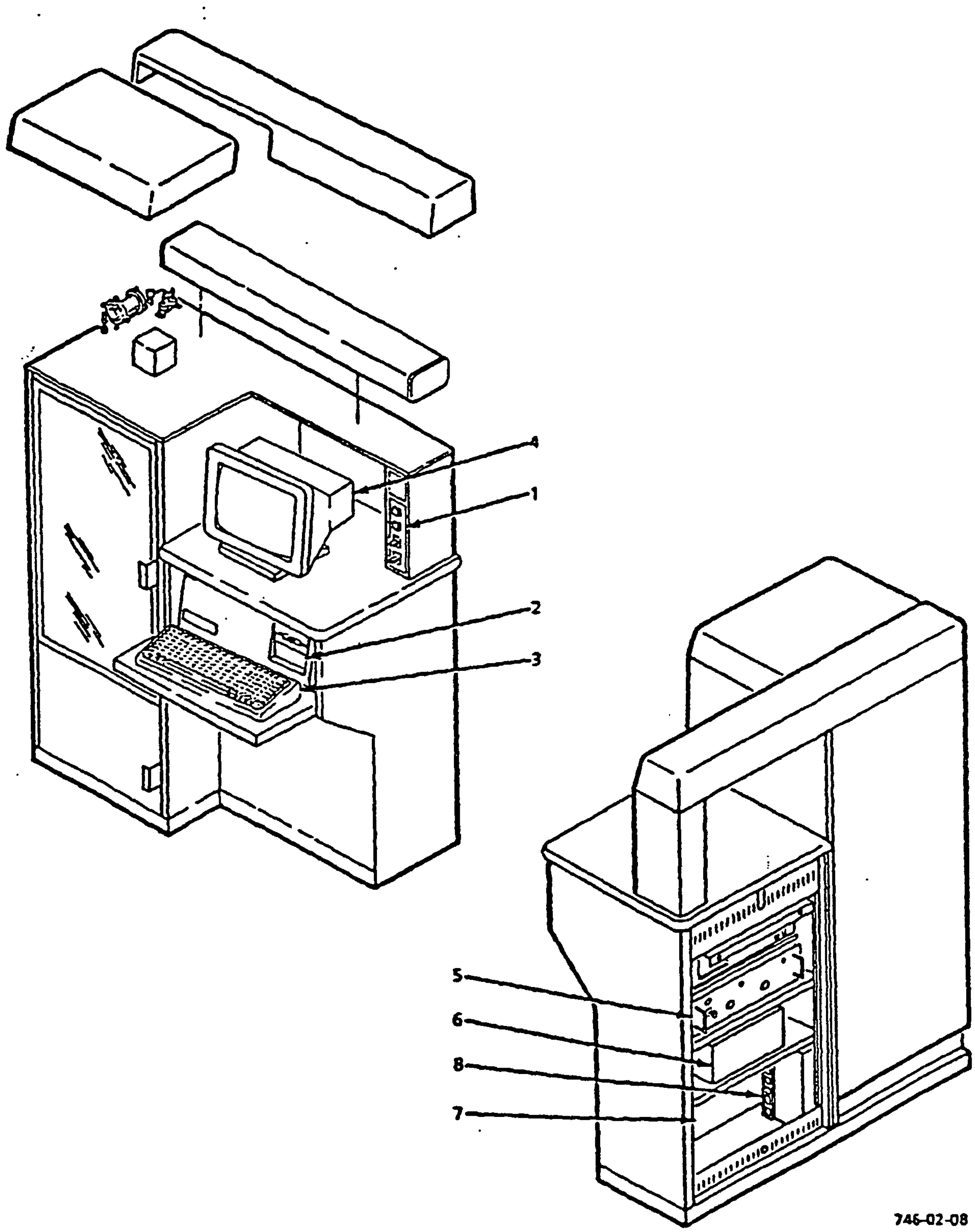


*Figure 4-2. Electronic Cabinet Assembly*

| Figure & Index Number | Part Number | Description 1 2 3 | Units Per Assy | Manufacturer |
|---|---|---|---|---|
| 4-2 | | CABINET ASSY, Electronic (See Figure 4-1 for next higher assembly) | REF | |
| 1 | 16180 | • PANEL ASSY, Control | 1 | 3D Systems |

(continued)

| Figure & Index Number | Part Number | Description 1 2 3 | Units Per Assy | Manufacturer |
|---|---|---|---|---|
| 2 | PC 286 | • COMPUTER ASSY, Process | 1 | Wyse |
| 3 | | • KEYBOARD | 1 | Wyse |
| 4 | | • MONITOR | 1 | Wsyse |
| 5 | 16033 | • POWER SUPPLY, Laser | 1 | 3D Systems |
| 6 | 16032 | • DRIVER, Elevator | 1 | 3D Systems |
| 7 | | • DRIVER, Dynamic Mirrors | 1 | 3D Systems |
| 8 | 16130 | • PANEL, AC Power Distribution | 1 | 3D Systems |

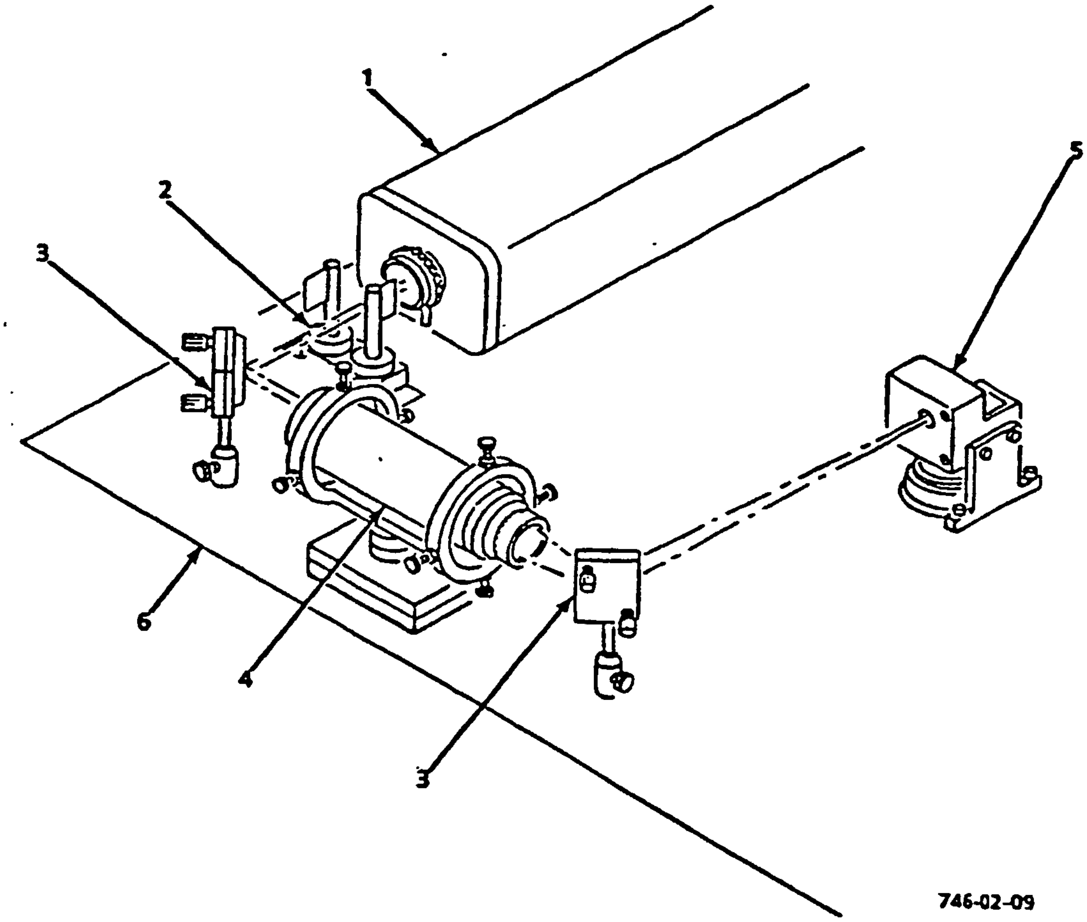


*Figure 4-3. Optics Assembly*

| Figure & Index Number | Part Number | Description 1 2 3 | Units Per Assy | Manufacturer |
|---|---|---|---|---|
| 4-3 | | OPTIC ASSY (See Figure 4-1 for next higher assembly) | REF | |
| 1 | | • LASER ASSY | 1 | Liconix |
| 2 | 16160 | • SHUTTER ASSY | 1 | 3D Systems |
| 3 | | • MIRROR ASSY, Beam Turning | 2 | Newport Corp. |
| 4 | D10493(4X) | • BEAM EXPANDER | 1 | 3D Systems |
| 5 | Z2173 | • MIRROR ASSY, Dynamic | 1 | General Scanning |
| 6 | 16175 | • PLATE ASSY, Optics | 1 | 3D Systems |

(continued)

| Figure & Index Number | Part Number | Description 1 2 3 | Units Per Assy | Manufacturer |
|---|---|---|---|---|
| | | | | |

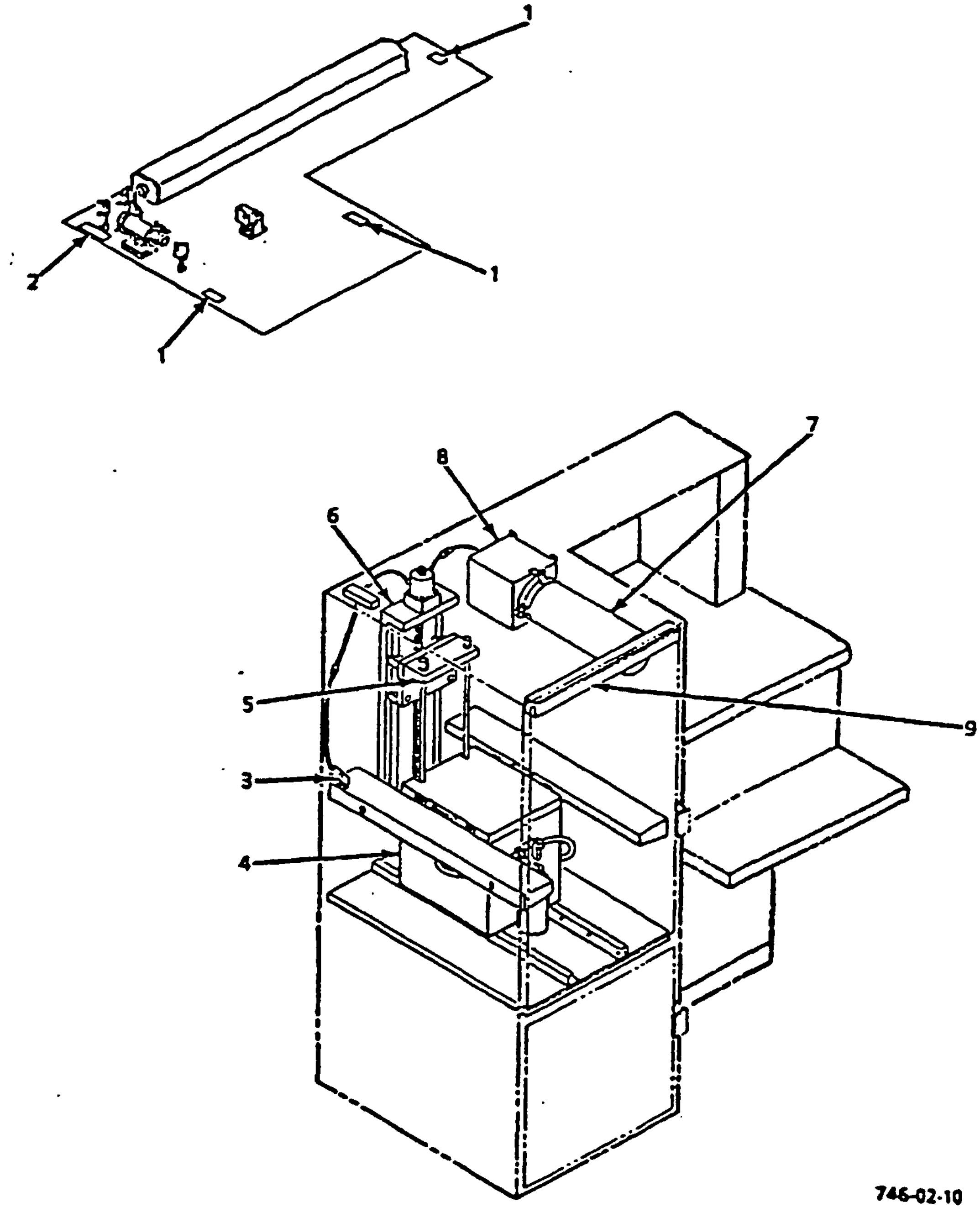


*Figure 4-4. Chamber Assembly*

| Figure & Index Number | Part Number | Description 1 2 3 | Units Per Assy | Manufacturer |
|---|---|---|---|---|
| 4-4 | | CHAMBER ASSY (See Figure 4-1 for next higher assembly) | REF | |
| 1 | 16175 | • SWITCH ASSY, Interlock | 3 | 3D Systems |

(continued)

| Figure & Index Number | Part Number | Description 1 2 3 | Units Per Assy | Manufacturer |
|---|---|---|---|---|
| 2 | 16170 | • DEFEAT ASSY, Interlock | 1 | 3D Systems |
| 3 | | • PROFILER ASSY, Beam | 1 | 3D Systems |
| 4 | 16115 | • VAT ASSY | 1 | 3D Systems |
| 5 | | • ELEVATOR ASSY, Z-Stage | 1 | 3D Systems |
| 6 | | • PLATFORM ASSY | 1 | 3D Systems |
| 7 | 16125 | • FILTER ASSY, Air | 1 | 3D Systems |
| 8 | | • HEATER/FAN ASSY | 1 | 3D Systems |
| 9 | | • LIGHT | 1 | 3D Systems |

SECTION V

WIRING DIAGRAM

5.1 INTRODUCTION

This section contains a wiring diagram to aid in troubleshooting and continuity tests.

5.2 WIRE LIST AND DIAGRAM

All SLA-1 cables and interconnections between components and assemblies are shown in the wiring diagram (Figure 5-1).

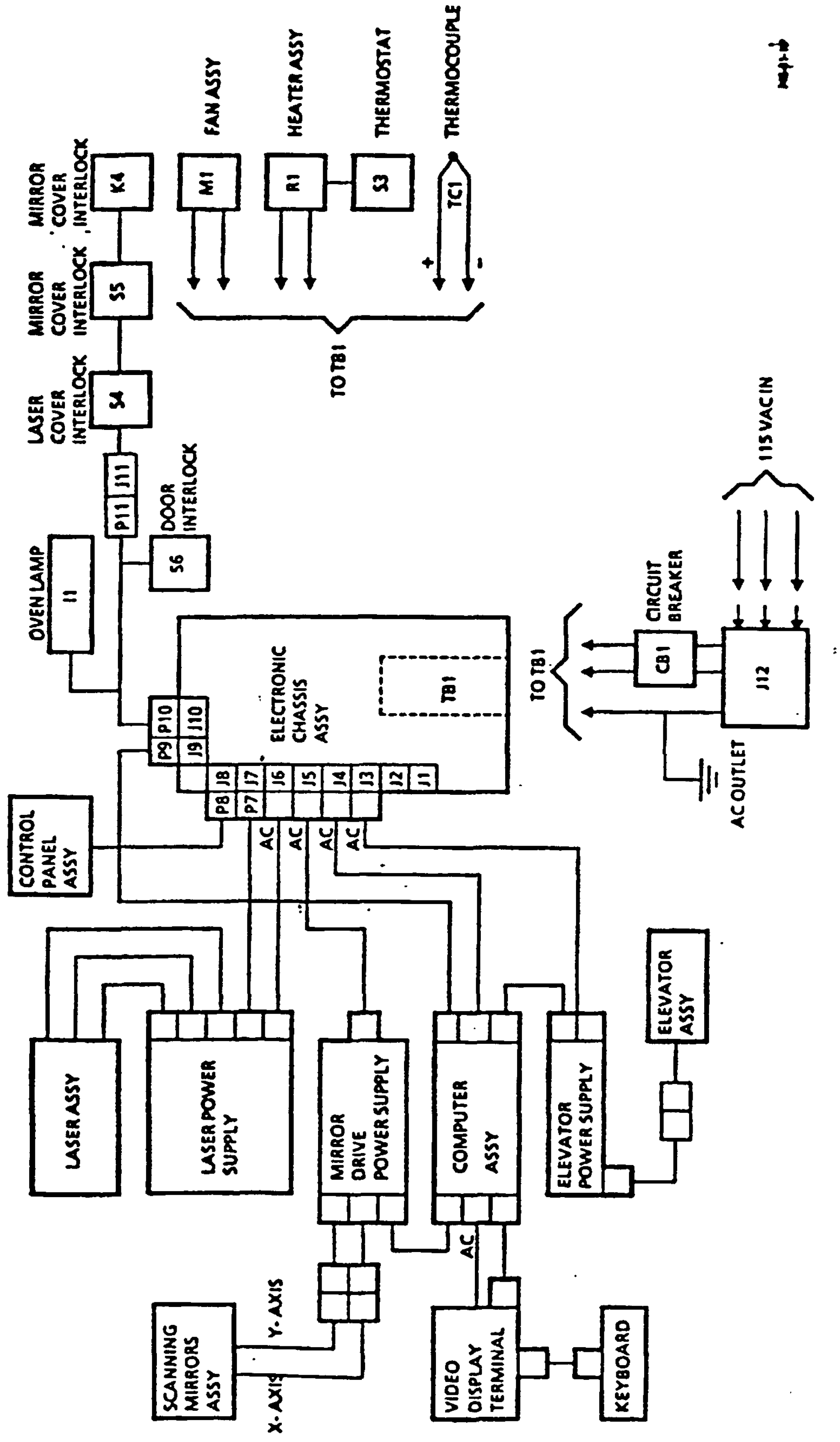


*Figure 6-1. SLA-1 Wiring Diagram*

APPENDIX B

# 3D Systems, Inc.

## SLA-1 Software Manual

## Beta Release, First Draft

October. 1987

3D Systems, Inc.
12847 Arroyo Street
Sylmar, CA 91342
(818) 898 - 1533
(818) 361 - 5484 FAX

3D Systems SLA-1 Software Manual
Beta Release, First Draft
October, 1987

TABLE OF CONTENTS


| | | |
|---|---|---|
| 1.0 | Introduction | 3 |
| 1.1 | System Overview | 3 |
| 1.2 | Major Part-Making Components | 5 |
| 1.3 | Utilities | 7 |

(continued)

TABLE OF CONTENTS


| | | |
|---|---|---|
| 2.0 | Getting Started | 8 |
| 2.1 | Getting Around on the Slice Computer | 8 |
| 2.1.1 | Making a User Account | 8 |
| 2.1.2 | Disk Usage Maintenance | 9 |
| 2.2 | Getting Around on the Process Computer | 10 |
| 2.2.1 | Disk Usage Maintenance | 10 |
| 3.0 | SLICE and the User Interface | 12 |
| 3.1 | The TELNET Communications Program | 12 |
| 3.2 | SLICE Overview | 13 |
| 3.3 | SLICE Features and Capabilities | 16 |
| 3.4 | SLICE Command Line Parameters | 18 |
| 3.5 | The SLICE User Interface | 20 |
| 3.5.1 | UI Overview | 20 |
| 3.5.2 | UI Main Command Menu | 21 |
| 3.5.3 | UI Alter Options Menu | 22 |
| 3.5.4 | UI Extra Parameters Screen | 24 |
| 4.0 | The Parser | 25 |
| 4.1 | The FTP File-Transfer Program | 25 |
| 4.2 | Operating The Parser | 25 |
| 4.3 | The Parser's Options | 27 |
| 4.4 | Critical Areas | 28 |
| 5.0 | The Supervisor | 29 |
| 5.1 | The Steps To Take Before Running the Supervisor | 29 |
| 5.1.1 | Getting the Step Periods | 29 |
| 5.1.2 | Editing the Supervisor's Default Parameters File | 30 |
| 5.1.3 | Editing the Layer Control File | 31 |
| 5.2 | Operating the Supervisor | 32 |
| 5.3 | The Supervisor's Options | 33 |
| 5.4 | The Supervisor's Keyboard Commands | 34 |
| 5.5 | Using Rivets | 35 |
| 6.0 | Other Programs | 37 |
| 6.1 | FRONT, Simple Front End to Laser Controller | 37 |
| 6.2 | CLIFF, Control Laser Instrument From File | 38 |
| 6.3 | STEREO, The Stereolithography Device Driver | 40 |
| 6.3.1 | STEREO Command Set | 40 |
| 6.3.2 | STEREO Options | 42 |
| 7.0 | File Formats | 45 |
| 7.1 | SLICE's Input File (*.STL) Format | 45 |
| 7.2 | SLICE's Output File (*.SLI) Format | 48 |
| 7.3 | The Parser's Output File (*.P and *.L) Format | 49 |
| 7.4 | Critical Area File (*.BOX) Format | 51 |
| 7.5 | Supervisor Default Parameters File (SUPER.PRM) Format | 52 |
| 7.6 | The STEREO.DEF Driver Default File Format | 54 |
| 7.7 | The STEREO.GEO Geometric Correction File Format | 55 |

| | | |
|---|---|---|
| Appendix A | SLA-1 Software System Chart | 56 |
| Appendix B | The STEREO Command Set | 57 |
| Appendix C | Stereolithography Software Glossary | 58 |
| Appendix D | Editor Commands | 61 |


1.0 Introduction

Welcome to the world of Stereolithography. By now, you know what Stereolithography is all about, and you have seen an SLA-1 machine. The job of this manual is to introduce you to the software that makes a SLA machine work.

First, let's quickly review the Stereolithography process. A three-dimensional part is designed on a CAD system, and transferred to a Slice Computer where the part is transformed into a series of two-dimensional layers. From that computer, the two-dimensional part is moved over to the Process Computer in the SLA machine. It is the job of that computer to make the part.

The manual follows the Stereolithography process. First, you will receive a brief introduction to all the important software programs. Then you will be shown how the Slice Computer works, how the Process Computer Works, and how to pass files to them.

1.1 System Overview

By System, we mean the Stereolithography Software System. And it is a system. It encompasses two operating systems - MSDOS and XENIX - and over a dozen programs, each important to some aspect of the Stereolithography process.

At last count, we figure there are nine levels of software. Each level can be viewed as a black box and having a unique task:

```
            +-----------------------------------+
            ¦ Level 8   3-D PART CAD DESIGN     ¦
            +-----------------------------------+
                              ¦
                              V
   +----------------------------------------------------+
   ¦ Level 7   TRANSFER 3-D FILE TO SLICE COMPUTER       ¦
   +----------------------------------------------------+
                              ¦
                              V
      +---------------------------------------------+
      ¦ Level 6   SLICE 3-D PART INTO 2-D LAYERS     ¦
      +---------------------------------------------+
                              ¦
                              V
  +------------------------------------------------------+
  ¦ Level 5   TRANSFER 2-D FILE TO PROCESS COMPUTER       ¦
  +------------------------------------------------------+
                              ¦
                              V
            +------------------------------------+
            ¦ Level 4   COMBINE SLICED FILES      ¦
            +------------------------------------+
```

```
                     |
                     V
+-----------------------------------+
|  Level 3   PART-MAKING SUPERVISOR  |
+-----------------------------------+
                     |
                     V
  +-------------------------------+
  |  Level 2   LASER DEVICE DRIVER |
  +-------------------------------+
                     |
                     V
+---------------------------------------+
|  Level 1   LOW-LEVEL LASER CONTROLLER |
+---------------------------------------+
```

The responsibilities of providing these services are spread out am gst three computers -- one that you already use for CAD work, our 80386-based Slice Computer, and out 80286-based Part-Making Computer:

```
+------------- YOUR CAD SYTEM COMPUTER ------------+
|                                                  |
|  Level 8   3-D PART CAD DESIGN                   |
|                                                  |
+--------------------------------------------------+
+---------------- SLICE COMPUTER -----------------+
|                                                  |
|  Level 7   TRANSFER 3-D FILE TO SLICE COMPUTER   |
|                                                  |
|  Level 6   SLICE 3-D PART INTO 2-D LAYERS        |
|                                                  |
+--------------------------------------------------+
+--------------- PROCESS COMPUTER ----------------+
|                                                  |
|  Level 5   TRANSFER 2-D FILE TO PROCESS COMPUTER |
|                                                  |
|  Level 4   COMBINE SLICED FILES                  |
|                                                  |
|  Level 3   PART-MAKING SUPERVISOR                |
|                                                  |
|  Level 2   LASER DEVICE DRIVER                   |
|                                                  |
|  Level 1   LOW-LEVEL LASER CONTROLLER            |
|                                                  |
+--------------------------------------------------+
```

1.2 Major Part-Making Components

The Slice Computer

The 80386-based Slice Computer contains XENIX, a full-bore multi-tasking Operating System which allows many users to simultaneously sign-on, transfer CAD files, and slice them. On this computer you will be introduced to some system management programs and some Stereolithography software.

The Slice Computer contains the Slice Program (SLICE) and its convenient User Interface Program (UI). SLICE is the program that takes a 3-D database and transforms it into a 2-D one suitable for part-making. Since SLICE conforms to the Unix philosophy of how programs work (which by the way is not so intuitive), we have developed UI which is an convenient menu-driven front-end to SLICE.

You will use UI to input the parameters you want SLICE to see and then run SLICE through UI. Generally, unless you need to do some disk or system maintenance, you will not need to leave UI until you sign-off.

```
+---------------- SLICE COMPUTER ----------------+
|                                                 |
|  Level 7   TRANSFER 3-D FILE TO SLICE COMPUTER  |
|                                                 |
|  Level 6   SLICE 3-D PART INTO 2-D LAYERS       |
|            - UI     User-Interface Program      |
|            - SLICE  Part Slicing Program        |
|                                                 |
+-------------------------------------------------+
```

The Process Computer

The Process Computer has many programs. Rather than instruct you how to call up each program from DOS, we instead have developed a menu program which you can use instead. The menu program leads you to each of the major part-making programs, the utility programs, and provides some disk management functions.

The SLA machine operator will tap into the Slice Computer and pull out the 2-dimensional database of the part he next wishes to make. This is accomplished using Ethernet software programs TELNET and FTP. TELNET temporarily makes the Process Computer into a computer terminal so that you can sign-into the Slice computer and run the User Interface program. You can then use FTP to transfer the 2-D databases (okay, we'll start calling them sliced files) files over to the Process Computer.

Once a sliced file is on the Process Computer, it may need to be combined with other sliced files, such as those containing a base for the part. The Parser, PARSE, does this job and also makes a special layer control file which you can edit to fine-tune the part-making process.

After running the Parser, you will proceed to the Supervisor. SUPER, which is the one program in charge of making a part. The Supervisor controls the motion of the laser beam and the Z-stage elevator, dipping and pausing for each layer.

Actually, The Supervisor's job is to "pass along" laser movement information to some rather sophisticated memory-resident software. The Supervisor talks to STEREO, a special Stereolithography Device Driver we created that knows about such SLA-specific things as special ways to draw and geometric correction which causes the laser beam to map linearly onto the vat's surface. STEREO, in turn, talks to LASER, the low-level layer controller, which is constantly running, moving the laser beam one discrete step every so often.

We told you a bit more than you probably needed to know, but we want you to get a good understanding of the system. The STEREO Device Driver has a set of commands that control how the laser moves on any given layer. Sometimes you want the laser to behave differently at some point during the part-making process. So, we gave the Supervisor the capability of passing along to STEREO commands that you have placed in certain files.

We want you to be aware that you are learning the commands of a common device driver, a driver that many different programs can use. Once you learn the STEREO Command Set, you will be in pretty good shape to quickly adapt to other programs.

```
+---------------- PROCESS COMPUTER ---------------+
|                                                  |
|  Level 5   TRANSFER 2-D FILE TO PROCESS COMPUTER |
|            - TELNET   Terminal Emulation Program |
|            - FTP      File Transfer Utility      |
|                                                  |
|  Level 4   PARSE SLICED FILES                    |
|            - PARSE    The Parser                 |
|                                                  |
|  Level 3   PART-MAKING SUPERVISOR                |
|            - SUPER    The Supervisor             |
|                                                  |
|  Level 2   LASER DEVICE DRIVER                   |
|            - STEREO   System Resource            |
|                                                  |
|  Level 1   LOW-LEVEL LASER CONTROLLER            |
|            - LASER    System Resource            |
|                                                  |
+--------------------------------------------------+
```

1.3 Utilities

In addition to the major components, there are a variety of utility programs that aid the part-making process.

There is the power on-off sequencer (POWER) that enables you to safely turn on and off various elements of the SLA machine with appropriate directions.

And there is the Calibrator (CALIB) that is run not-so-often to calibrate the Vat Surface (the "Field") to make the SLA machine geometrically correct. Special hardware is necessary in order to use this program.

The Profiler (PROFILE) that analyzes the laser beam, and it is run often, perhaps once a day. It makes note of the current shape and intensity of the beam. The results of its analysis is retained in a special file that other programs can read.

The Get Step Periods program (GETSP) is one such program. It eliminates the need for you to be a chemist by reading the Profiler's data and enabling you to determine an appropriate Step Period (laser speed) for making a particular part. It knows the working curves for different materials, and it will select an appropriate Step Period for your forthcoming part-making sessions.

ZSTAGE gives you control over the Z-Stage, the vertical elevator that the part sits on. ZSTAGE is used to set the elevator just before a part is make, and it is also used to bring a part up out of the vat.

```
+----------------------------------+
| POWER     Power On/Off Sequencer |
| CALIB     Field Calibrator       |
| PROFILE   Beam Profiler          |
| GETSP     Determine Step Periods |
| ZSTAGE    Z-Stage Controller     |
+----------------------------------+
```

**Utility Programs**

2.0 Getting Started

In this chapter, we assume you have installed your Slice and Process Computer Systems according the Installation Manual and have verified their proper operation. This chapter takes you at that point to help you get started using these two computer for the part-making process.

2.1 Getting Around on the Slice Computer

Each person performing slicing should have his or her own XENIX account on the Slice Computer. Once an account has been created, the owner can sign on.

2.1.1 Making a User Account

Sign onto the sysadm account by typing 'sysadm' at the login prompt and press Enter. Enter the password, which is '3dsys'. Note that the password isn't displayed as its typed in. And the case of the letters is important; type them in lower case.
The sysadm account is a special Xenix account that automatically takes you to a menu-driven system administration program. From this menu you can create and remove user accounts, and perform a varietry of other system tasks. If you want to know more information about the sysadm function than what is presented here, please refer to the appropriate Xenix documentation.
Take a few moments to look over the screen. Select the User Maintenance options by pressing 'U'. Do not press Enter.
Select MakeUser by pressing 'M'. Do not press Enter. Answer 'y' (and Enter) to 'detailed instructions?'. Next time you can answer 'n' because you will be familiar with the make-user process.
Enter the new user's login name. This should be short and in all lower case letters. We simply use people's first names and an occasional first letter of their last name. Make up your own rule, but be consistent. It will make system management easier.
Answer 'y' to 'Do you wish to use the next available user id?' query. Let the system assign the id number. You will rarely have to refer to it.
Answer 'y' to 'Do you want to use the default group? query. This will assign the standard group 'group'.
Assign a password that is at least 5 characters in length. You will have to enter it again as a safety precaution against typos. If you don't care about security, just make the password the same for all users. This way, you can hop around the various user accounts and pick up the sliced file.
Select the Standard (Bourne) Shell, item 1. Enter a comment if you want. Generally, you will enter the user's full name (with upper and lower case letters) here.
Review the account infomation. If you are satisfied, answer 'n' to 'Do you want to change anything? prompt. The computer will take a few moments to create the user.
You have finished adding a user to the Slice Computer. That user can now sign-in and do slicing.
If you want to remove a user, you can select the Remove User option. You will have to delete all of the user's files before you can delete him from the computer system.
Play around with the sysadm menu system. Don't do anything that looks irreversible or serious until you have read up on it.

2.1.2 Disk Usage Maintenance

Depending on the size of your part files, you will need to take time to make periodic maintenance. This means you should erase or archive old part files to make way for new ones.
When you sign-in, the computer will tell you how much disk space is taken up by your files. The number shown is the number of 512 byte blocks (1/2 K). Check this number to make sure you aren't taking up more disk space than you thought. Make sure your disk usage doesn't get out of hand.
If you are in the User Interface, use option Q to quit and return to Xenix. There you can use the rm command to remove files:

rm sli0045.st1 will erase the single file sli0045.stl
rm gbox03* will erase all files whose name begin with 'gbox03'

You can also use cp to copy and mv to move files around. Refer to the Xenix Documentation for more information.
If you feel you need more information about the Xenix Operating System, we recommend the following books:

* Understanding XENIX: A Conceptual Guide
  Que Corporation

* Working with XENIX Systems

Scott, Foresman, and Company

- * XENIX at Work
  Microsoft Press

- * Inside XENIX
  The Waite Group

- * XENIX Tutor
  XENIX Training on DOS PCs

SCO, our Xenix supplier sell these books to end-users. Contact them at (408) 425 - 7222.

2.2 Getting Around on the Process Computer

The Process Computer is your typical AT-compatible MSDOS Computer System. If you don't know the first thing about MSDOS, don't worry. All you have to do is turn the computer on; it does the rest. You will enter a Menu Program from which you can get to all the essential part-making programs.

2.2.1 Disk Usage Maintenance

As with the Slice Computer, you will need to watch your disk usage on the Process Computer. The Process Computer contains 40 Megabytes, of which about 2 Megabytes are taken up by MSDOS and the Stereolithography Software.

Unless you have created your own directories for the sliced files, you will be in the \WORK directory. Periodically, go to the DOS Menu and select item 1 to get the disk usage stats. You will see something like:

| | |
|---|---|
| 21344256 | bytes total disk space |
| 49152 | bytes in 2 hidden files |
| 45056 | bytes in 22 directories |
| 6254592 | bytes in 391 user files |
| 20480 | bytes in bad sectors |
| 74976 | bytes available on disk |
| | |
| 655360 | bytes total memory |
| 598128 | bytes free |

Watch the 'bytes available on disk'. This system has more than 14 Megabytes (14,000,000) left so there is no immediate danger of running our of disk space. Depending on the sizes of the part files, you should get concerned when this number drops below a few Megabytes.

Once you realize that you need to some housecleaning, or "diskcleaning" in this case, select item 3 in the DOS Menu. This will take you to a program called QuickDos II (QD2) where you can do such disk-related things as copying files, moving files, and deleting files.

To delete files, use the arrow keys to move up and down the directory listing shown. Press the Space Bar to tag a file. A white arrow should appear at the left of the file name. Keep doing this until all the files you want to delete have been tagged. To untag a file, move back to the file and press the Space Bar again. The white arrow should disappear.

Press 'E' (no Enter) to erase. QuickDos will show you the file you have selected on a different screen. Press Alt-E (hold the Alt key down while pressing 'E') to begin the erase procedure. If you see something you don't like, press Esc to abort.

QD2 performs a variety of other useful disk management tasks. Refer to its documentation for more information.

3.0 SLICE and the User Interface

To use SLICE and the User Interface, you can sign-on to the Slice Computer either directly via its keyboard, or from the Process Computer over the Ethernet communications link. Section 3.1 describes how to use the Ethernet TELNET terminal program.

Once you are signed-in, there are two ways to tell SLICE what you want done. One is to work directly from the Xenix Operating System where you must specify all the options on one line. The other is to use UI, the Slice User Interface Program, where you can specify the options through a set of menus. Both techniques are described below. We have found most people prefer using the User Interface.

3.1 The TELNET Communications Program

The TELNET Program allows you to connect up to the Slice Computer from the Process Computer and run the User Interface and SLICE programs.

From the Process Computer Main Menu, select item 1, Data Transfer. You will be placed in the XFER program are presented with the following options:

| | | |
|---|---|---|
| 1. | TELNET, | Terminal Utility |
| 2. | FTP, | File Transfer Program |
| Q. | Quit | |

If you don't what to communicate just yet, press Q to quit and return to the main menu. Otherwise, select item 1, TELNET.

TELNET should run and connect the computer you are currently on (the Process Computer) up to the Slice Computer. If both computers are functioning and are properly linked together, you should see the Xenix Login message appear. At this point the Process Computer is like the Slice Computer's main console. You can now sign-in and run SLICE or the User Interface.

Eventually, you will have to sign-off. Get out of whatever program you may be in (the DEL key may do that) and type:

exit

You should then be logged off the Slice Computer and returned to the Process Computer's main menu.

3.2 SLICE Overview

This quick overview will give you a brief description of SLICE methodology.

SLICE's mission is to read in a solid model whose surfaces were tessellated into triangular facets, and then to calculate output that is suitable for the laser control system to polymerize the model in layers, working from the bottom up.

While we are discussing SLICE ,it is important to realize that these next questions touch upon deep topics. The areas of numerical analysis, analytical geometry, computer graphics, and computer architecture, are among those that are relevant to SLICE. The discussion below is by no means a thorough treatment of these topics, but rather a starting point to provoke thought.

Why use layers?

The UV catalyzed polymerization process usually takes place at or near the monomer-substrate surface, so an approach akin to assembling a loaf of bread by gluing the slices back together is taken by the laser process. SLICE "slices" the original model mathemtically which the laser then puts back together.

The laser must trace the outline of each slice and sweep across ("hatching") the interior of each slice. In addition, the end-slices of the bread loaf, and the near flat ones are traced more finely, called "filling" in SLICE parlance.

Therefore the object to be produced must be reduced to cross-sections. This is the heart of the problem--to do the cross-sectioning and hatching/filling efficiently and correctly.

Why use triangles?

There are many ways to represent solids, such as constructive-solid-geometry, parametric representation (based upon a variety of fundamental curves such as bicubic patches), and boundary representation (called b-rep in the literature). B-rep is the most popular and often the most efficient for a general class of objects (e.g. not wings or boat hulls).

The boundary representation method generally involves describing a solid model in terms of its surfaces which are approximated by polygons. The smaller the polygons the better the b-rep model represents the actual object. Some solid model analysis problems (such as tolerance checking) originate right here-because we stray away from reality once we take the first step of interpolating polygons. We can discuss this further in a future section.

How the model is actually produced, whether by volumes of revolution, extrusion, projection, cross-sectioning (in reverse of SLICE), etc., does not (at present) concern us here. But the end result is a model that must have integrity. Polygons must be planar, and adjacent polygons must indeed abut one another, for example.

The triangle is a very nice surface b-rep polygon to work with for several reasons: non-degenerate triangles always define a single plane in 3-space, (as two points define a line in 2-space, and 4 points define a hypercube in 4-space, etc.). A degenerate triangle is one in which one or more of the points have the same coordinates. Triangles are also the simplest entity with which to perform computations, as compared to trapezoids, hence they proliferate in many popular CAD and solid modelling systems.

Why have variable z-spacing?

Let us use our food example again. If we are slicing a loaf of bread that is geometrically uninteresting, say a loaf of Roman Meal, it is wasteful to slice at every millimeter; centimeters will do. If we are slicing a dome shaped French Bagette, for example, but want a reasonably accurate model, some slices should be thinner than others.

Those slices that have more detail and that have smaller slope should be smaller. This is a little like the resultion problem above, but now we will vary the grid size DYNAMICALLY as we move through the model. Secondly, this approximation corrects for limitations in the laser process, not for a mathematical loss of accuracy as in the integer problem.

The limitation in the laser process is caused by the fact that beam shoots at approximately a normal angle to the substrate surface. Angled surfaces are therefore built up in a stair-stepping method. The side of each step is a slice, and its angle is given by the angle of the laser beam relative to the substrate liquid surface.

The second limitation is that areas that are nearly flat must be treated as if they were completely flat. Completely flat regions are skin-filled, which is essentially a very fine cross-hatching. Near flat regions must be skin-filled lest gaps and/or warpage occur in the completed part. Additional structural features may have to be built in order to compensate for properties inherent in the polymer.

There are other effects relevant to the part-making process, but they are not covered here. There is for example, a correction necessary for the spherical projection of the laser beam onto the flat surface of the substrate liquid, which is done in a post-SLICE laser output phase.

The thickness of slices must vary then to: 1) obtain a sufficient level of detail, and 2) provide sufficient polymerization / structural strength in areas that have small slope.

Why are triangles classified?

Recall that the input consists only of triangles. Each slice will intersect some of the triangles.

Triangles are classified by their slope relative to the x-y plane in SLICE: flat (slope=0), near-flat (slope<human-determined subjective criteria), and "scan" triangles (slope is large).

The line segments that are calculated by slicing through triangles are treated differently depending on the triangle they came from. These resulting intersections of slices with triangles form outlines of slices, called "borders", and provide information needed to do the cross-hatching and skin-filling.

Why have output blocks?

Output blocks in Slice's output files identify the type of two-point vectors which follow. Special action can then be taken by the Supervisor on some of these blocks to strengthen the part and prevent warpage.

3.3 SLICE Blocks

SLICE takes the 3-D object database and classifies the facets as flat, near-flat, or scanned. When SLICE gets around to producing 2-D output, it organizes the layer vectors into various block.

SLICE block identifiers follow the following mnemonic rule. Not all combinations are valid.

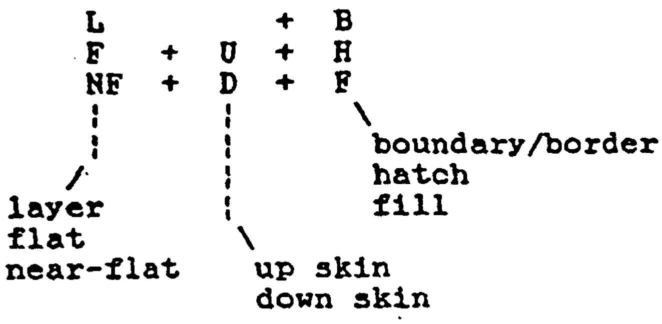


| New Block Mnemonic | Description |
|---|---|
| LB | Layer Border |
| LH | Layer Hatch |
| FUF | Flat Up skin Fill |
| NFUB | Near-Flat Up skin Border |
| NFUF | Near-Flat Up skin Fill |
| FDF | Flat Down skin Fill |
| NFDB | Near-Flat Down skin Border |
| NFDH | Near-Flat Down skin Hatch |
| NFDF | Near-Flat Down skin Fill |

The above list is shown in kind of a triangle-type order which is different fromt the order SLICE outputs the data. SLICE outputs the way the part is to be built:

* borders first
* then hatches
* then down fills
* then up fills

SLICE outputs the blocks in the following order:

| | | |
|---|---|---|
| 1. | L | Layer identifier, no vectors |
| 2. | LB | Layer Border |
| 3. | LH | Layer Hatch |
| 4. | NFDB | Near-Flat Down skin Border |
| 5. | NFDH | Near-Flat Down skin Hatch |
| 6. | NFUB | Near-Flat Up skin Border |
| 7. | FDF | Flat Down skin Fill |
| 8. | NFDF | Near-Flat Down skin Fill |
| 9. | NFUF | Near-Flat Up skin Fill |
| 10. | FUF | Flat Up skin Fill |

The L block isn't one really. It is followed by the interal Z-layer number, must like the old Z block. However, unlike the old Z which has the complete boundary for that layer, the L has no vectors.

3.4 SLICE Command Line Parameters

To activate SLICE the hard way, you will need to type out a XENIX command line with the form:

SLICE < input_fille <options>

where SLICE is the current SLICE program (e.g. 'slice20b') input_file is the name of the STL input file <options> represent any combination of the following SLICE program options:

- scale <scale_value>
  Used to specify a real number scale value that will be used to scale the input file coordinates. The default scale value is 1.

- sf <segment output file>
  Used to specify an output file for z plane intersection segments. The default is to not generate a segment output file.

- zs <z spacing value>
  Used to indicate the constant z spacing of the output cross-sections.

- hy <hatch spacing value>
  Used to set spacing of hatch lines parallel to the Y-axis.

- hx <hatch spacing value>
  Used to set spacing of hatch lines parallel to the X-axis.

- <hatch spacing value>
  Used to set spacing of 60 degree angle hatch lines.

- hfy <hatch spacing value>
  Sets spacing of hatch lines parallel to the Y-axis on flat surfaces.

- hfx <hatch spacing value>
  Sets spacing of hatch lines parallel to the X-axis on flat surfaces.

- zsf <z spacing control file>
  Used to specify the file containing variable Z-spacing information.

- c Centering option.
  Centers object coordinates around 32768, 32768.

- nsc No section codes option.
  Suppresses section codes in the output file.

- msa Minimum surface angle option.
  Indicates minimum surface angle for scanned facets. Legal values are between 0 and 90 degrees.

- mia Minimum intersect angle option.
  Indicates minimum intersect angle for hatch lines. Legal values are between 0 and 90 degrees.

- b Binary input option.
  Indicates that the input file is in binary format.

- d Display option.
  Causes the program to display cross-sections on the screen as they are generated.

- h Help option.
  Causes the program to print a help similar to this list of options and then stop.

- b Binary input option.
  Indicates that the input file is in binary attributed format.

- aries ARIES attributed binary input option.
  Use when binary file is ARIES and attributed.

- disk Disk option.
  Causes the program save intermediate information on disk rather than in memory.

- x or -y Slice Axis option.
  Use the x-axis or y-axis as the slice axis, not the standard z-axis.

SLICE can be executed directly as a standard Xenix program. However, we have a developed a special User-Interface program for SLICE, described below.

3.5 The SLICE User Interface

We have developed a special User Interface program to SLICE that runs under XENIX. It is a much easier way to run SLICE compared to typing command lines. UI, as the User Interface is called, can be run remotely through Ethernet.

UI, the SLICE User Interface, presents menus and allows the user to easily select and define the various SLICE options for a particular STL Slice Input File. The options for different STL files are remembered in special setup files with the same file name prefix, but with the extension ".UII" (UI Information).

UI also allows the user to define a special variable Z-spacing file (with the extension ".UIZ.") that is used by SLICE to generate different-spaced layers for different sections of a part.

3.5.1 UI Overview

The complex nature of using SLICE especially on a Unix-based system prompted the development of the User Interface (UI) program. It is a simple easy-to-use front end for the Stereolithographer where, by selecting items off a menu, he can enter the Slice options for his latest part. A key feature of UI it that it supports variable Z-spacing, a difficult feature of SLICE to use outside of UI.

UI allows a SLICE user to change options and invoke the SLICE program. SLICE then slices the specified 3D object into 2D layers using the UI options.

UI can be invoked from any process Unix or Xenix account. It is assumed that such a system has already been created with the necessary software. It is recommended that each individual needing to use UI and SLICE be given their own account.

The command syntax for the UI command is:

ui <option_file_name>

where <option_file_name> is the name you wish to refer to the new set of options. If you wish, it can be related somehow to the part name. If <option_file_name> is omitted, the last option file name will be used and its option file loaded.

3.5.2 UI Main Command Menu

The User Interface's Main Command Menu is shown below:

```
---------------------------------------------------------------
                  - SLICE USER INTERFACE -
                        Version 2.10


     Current Object:  test
 Database File Name:  test.stl
   Extra Parameters:  -aries -x

  Alter   - Alter standard options
  Extra   - Set extra parameters

  Load    - Load a different object's options
  Save    - Save current object's options
  Write   - Save current option's under different object name
  Copy    - Copy another object's options into current object

  DoSlice - Do slicing with current options
  Quit    - Exit UI (Use SAVE to save options first)

 Which Command? _
---------------------------------------------------------------
```

The UI commands behave as follows:

Alter - Go to the Options Menu so that the Slice Options can be changed.

Extra - Go to the Extra Parameters Screen so that non-standard Slice options can be specified.

Load - Loads a different set of options into UI. The previous objects options (if any) are not automatically saved. Using Load is equivalent to quitting UI and rerunning it with the new object's name.

Save - Saves the current option data into the current object file. Stays in the main menu.

Write - Same as Save, but allows you to specify a different file in which to store the option data. The new name becomes your current object file name.

Copy - Copies the options of a different object into the current object's options. The Copy command saves having to reenter options where options for a new object are being defined but the options are similar to those for some past object. By Copying those old options in and making minor adjustments, you are off and running SLICE quickly.

DoSlice - Go Do Slicing with the current options. DoSlice allows you to specify what version of Slice you wish to use.

Quit - quits UI. Does not Save. Returns to back to the Unix or Xenix command level.

3.5.3 UI Alter Options Menu

All the numbered options in the UI program are parameters to the SLICE program. All the lettered options are used for UI control. Most of the SLICE options are self-explanatory.

```
: ----------------------------------------------------------------
                    - SLICE USER INTERFACE -
                         Version 2.10

    Current Object: test

Option   Description                                    Value
------   -----------                                    -----
 (1)     DATABASE File Name                             test.stl
 (2)     Scale                                          1.000
 (3)     Z Spacing                                      10.000 Fixed
 (4)     X hatch spacing                                0
 (5)     Y hatch spacing                                0
 (6)     60/120 degree hatch spacing                    0
 (7)     X Skin fill for near flat surfaces             0
 (8)     Y Skin fill for near flat surfaces             0
 (9)     Minimum Surface Angle for scanned facets       0
 (10)    Minimum Hatch Intersect Angle                  0
 (11)    Segment Output File Name                       test.sli
 (12)    Centering                                      Off
 (Q)     Quit, return to Main Menu

Alter which Option? _
----------------------------------------------------------------

(1) DATABASE File name sets the name of the file that contains
the three-dimensional CAD database for the object.  An.extension
of ".stl" is assumed.

(11) Segment Output File Name is the name of the file that SLICE
will output to.  An extension of ".sli" is assumed.

(3) Z Spacing is one of two types, Variable or Fixed.  Fixed is
where just one value for all spacing, while Variable allows many.
When Fixed is selected, UI just asks for the one Z spacing value.
When Variable is selected, UI displays a new screen and allows
you to edit the Variable Z-Spacing Table.
```

While adding and deleting values to and from the variable Z-spacing table, you will use the following commands:

| | | |
|---|---|---|
| A | level setting | Add new level and spacing value to table |
| D | level | Delete level from table |
| S | | Save table, return to main menu |
| Q | | Quit, return to main menu. don't save table |
| H | | print a Help message similar to this |

A adds a new level and spacing value. Both of these numbers will be multiplied by scale as they are sent out to SLICE. In other words, they are in the original CAD units -- inches, feet, whatever. Also, the indicated spacing begins at the indicated level. The first entry goes from that level to just before the level indicated by the second entry, and so on. The new spacing and hence the new dip depth will be used after the vectors for the indicated layer are drawn.

D deletes a level. S saves the table and returns you back to UI's main menu. Q skips the save, just returning you to the main menu. Any entries you made will be lost. H prints out a convenient help message.

If after you create a Variable Z-spacing table, you go back to Fixed spacing, then return to Variable spacing, the original Z-Spacing Table is restored.

The Save command in the Variable Z-spacing section does not save the table to disk. You must also use the Save or Write command in the main menu to make any changes permanent.

3.5.4 UI Extra Parameters Screen

Supplying Extra Parameters is a convenient way for us to support non-standard Slice commands without having to create confusing menus. You may never need to enter any extra parameters. This is a just-in-case feature.
Below is a copy of the Extra Parameters screen:

```
-----------------------------------------------------------------------
Extra Parameters allows you to specify non-standard slice options
for inclusion in the slice command line.  What parameters are valid
is based on the version of Slice you will use.

The following parameters have been known to exist:

  -x        part's height is in the x-axis
  -y        part's height is in the y-axis
  -aries    use the non-standard Aries CAD System input file format

Current Extra Parameters are:
-aries -x

Enter new Extra Parameters or just press Enter to keep old:
-----------------------------------------------------------------------
```

4.0 The Parser

The Parser takes sliced files and prepares them for the Supervisor. PARSE's name comes from the fact that it parses out the slice block identifiers and stores them is a special layer control file. This file you can later edit to fine tune the part-making process.
PARSE also combines multiple slice files together, such as a part and an appropriate base, and generates just one large vector file for the Supervisor.

4.1 The FTP File-Transfer Program

You can use the FTP File Transfer Program to move a sliced file over from the Slice Computer to the Process Computer. Go to the XFER program by selecting item 1 in the Main Menu. There, select item 2, for FTP.
FTP will prompt you for the Remote User Name. Type in the name of your user account. Then it will prompt you for your password. Type than it. If FTP can sign onto the Slice Computer, i will display the prompt:

FTP>

At this point, there are a variety of commands you can use. We will focus on just five of them here -- mdir, ldir, get, put, and bye.
You can use 'mdir' to get a directory listing of the Slice Computer, and 'ldir' to get a directory listing of the Process Computer.
Use 'mdir' to see the contents of your Slice Computer directory. Is the file you want to send over there? If it is, make sure you are going to store it in the right place on the Process Computer by using 'ldir'.
If everything looks right, use 'get' to move over the file:

get <filename>

where <filename> is the name of the file you want to copy over. The original file on the Slice Computer will not be disturbed. Use 'ldir' again to make sure the file came over.
In a similar manner, you can use 'put' to copy a file from the Process Computer over to the Slice Computer.
That's it. Use 'bye' to end FTP. FTP will sign-on the Slice Computer and return you back to the Process Computer's main menu.

4.2 Operating The Parser

When PARSE is brought up, it display the following heading:

```
------------------------------------------------------
  PARSE, Slice Files Combine and Parse Program
  3D Systems Laser Stereolithography System
  Version 2.30  by 3D Systems  October 1987
------------------------------------------------------
```

Slice File Names: _

At this point, type in all the names of the SLICE files (no more than 10 at a time), separated by spaces, to combine into a single part. The output files generated will be used by SUPER, the pervisor, to build a part on the Stereolithography apparatus.

After pressing Enter, PARSE will prompt with:

Output File Name: _

Here, just give the prefix; do not add any extensions (like *.DAT). PARSE will make two output files <part>.L and <part>.P, where <part> is the name you input here. <part>.L will be a short file contain layer information, and <part>.P will be the combined vector file of all the SLICE input files.

Then, PARSE will ask for three numbers:

Slice scale factor? _
Slice -zs layer spacing? _
Layer thickness in mm (20 mil = 0.508mm)? _

In the near future, PARSE will obtain this information directly from SLICE, but for now, you have to repeat it. Please do not delight too much in being able to "fudge" the part by inputting different numbers from what SLICE was told as this capability will soon vanish. PARSE will pass this information along to SUPER.

PARSE then begins it run:

```
Starting parsing ... Hit Ctrl-Break to abort.

7800: L1 LB1 LH1 NFDB1 NFDH1 FDF1 NFDF1 L2 LB2
7810: L1 LB1 LH1 L2 LB2 NFUB2 NFUF2 FUF2
  :    :    :
```

If you press Ctrl-Break at any point before PARSE has finished, you will abort the parse procedure. Incomplete <part>.L and <part>.P files will be left on your disk so that you can look at the intermediate results. If you don't want these files, delete them to conserve disk space.

The '7800', '7810' numbers shown above are references to the L blocks being read in from the SLI file. The number itself is from after the line in the SLI file that begins with an L. The letter-number combinations that follow show the block-type and input file number that PARSE is currently working on -- NFUB2 means that PARSE is working on the Near-Flat Up-Facing Skin Border for the indicated layer from the second input file.

When PARSE is done, it returns control back to Menu program, at which point you can either edit its files or run the Supervisor.

PARSE maintains increasing layer numbers. It will automatically resolve the condition where the input files may start and stop on different layers by juggling the input from the various input files. PARSE can handle up to 10 input files per run.

For a given input file name in the 'Slice File Names' prompt, one add one or more of the following options:

| | |
|---|---|
| /Z<offset> | offset Z-layer numbers |
| /N<set of ZXYISABJHVCFGKCD> | no, don't use blocks indicated |
| /O<set of ZXYISABJHVCFGKCD> | only use blocks indicated |

/Z allows you to offset the Z-layer values for that input file. This is useful when you need to align two previously non-aligned CAD objects such as posts and the major part. /Z-100 will reduce the apparent Z-layer values for that file by 100. The actual physical shift is related to the SLICE scale factor.

/N and /O allow you to select which blocks to exclude or include, respectively. /N LH,NFDH will eliminate all section cross hatching, and /O LB,NFDB,NFUB will only allow the border blocks through. "N" stands for "No" and "0" stands for "Only". By the way, it isn't wise to use both /N and /O together since they are mutually exclusive. No matter what you type, PARSE will always include the L-block.

4.3 The Parser's Options

PARSE accepts a command line whose format mimics the input queries discussed above. This allows PARSE to be run from a *.BAT batch file without user intervention. The format is:

PARSE <filel> <file2> ... /OUTFILE<output file prefix>
/SCALE<scale>/ZSPC<Z-spacing>/THICK<thickness>

/OUTFILE specifies the output file prefix, /SCALE and /ZSPC the SLICE scale and Z-layer spacing, and /THICK the layer thickness. You cannot use these options from the Menu program.

As indicated before, specifying the scale, Z-spacing, and the thickness is temporary and will soon be eliminated. If the Command Line is incomplete, PARSE will prompt for the missing information.

4.4 Critical Areas

PARSE supports critical areas, where the Supervisor can be instructed to perform or not to perform something within the confines of a box. For a given part with a file name prefix of <part>, PARSE attempts to read the <part>.BOX file. If it doesn't see the file, it simply prints out a warning message and continues. Otherwise, it reads in the file and analyzes it while parsing.

Two types of critical areas are supported: Cross-Hatching with Rivets (XV) and Ignore Cross-Hatching (XI). That is, all the cross-hatch vectors within the critical area confines will either become rivets (multi-pass draws for strength) or be ignored.

See Section 7.4 for the format of the *.BOX file. See Section 5 for a discussion on rivets.

5.0 The Supervisor

The Supervisor supervises the part-making process. It reads the vectors from a file, sending them to the laser controller, modifying them according to the layer control file.

The Supervisor runs for as long as it taskes to make a part. It sends the packets of vectors to the STEREO driver, and it controls the Z-Stage, moving it down and back up for a dip after each layer.

The Supervisor reads three files. SUPER.PRM contains the default laser controller parameters for each block. The <filename>.L part layer control file contains your override laser controller Parameters. The <filename>.P part file contains all the vectors from all the files combined together by the Parser.

The Supervisor knows about each type of block and which number PARSE File it came from. For any block from any file, you can tell the Supervisor to alter certain laser controller parameters such as step size, and step period.

5.1 The Steps To Take Before Running the Supervisor

Run the Beam Profiler and the GetSP programs if necessary. Adjust the Z-Stage using the Z-Stage Controller program.
(More)

5.1.1 Getting the Step Periods

You should run the GETSP program each time you use a new material or after you have run the Beam Profiler. GETSP will ask you for the desired lineheight (in mils) and make an estimate of what Step Period you should use for your next part.

GETSP will ask you if it should update the SUPER.PRM Default Paamters File for you. If you answer 'y', then the next part will be made with the calculated step period. You can still override the new step period in the *.L Layer Control File for certain block if you desire.

5.1.2 Editing the Supervisor's Default Parameters File

Here's an example of the new SOPER.PRM file:

```
!
!  Supervisor Parameter File
!  Version 2.21
!
!  last altered: 9/28/87
!        reason: to test new SUPER Default Option line in this file
!


!
!  Default SUPER Options
!
!  place options together inside of quotes;  use "" if no options
!  /NEGZ required for some prototype units
!
"/NEGZ"

!
!  General Parameters
!
800     Elevator board base address
50      Elevator pitch parm, 100 for alphas, 50 for betas
1.0     XY-only scale factor; does not affect Z-axis
0       X-coordinate offset
0       Y-coordinate offset
750     Max number of vectors to send to Stereo

!
!  - Block defaults -
!
!  Each time the Supervisor starts a block, the respective default
!  string below is sent to the Stereo driver.  Z,X... are the block
!  types (Z-Boundary, X-Cross-Hatch, etc.) and they are followed
!  by the parse input file number (e.g. 1 may be for post vectors
!  and 2 for object vectors).  Although only defaults for 2 Slice
!  files are set for here, up to 10 files are supported.
!
#TOP,"BX 8500;BY 34300"          ! laser beam begin (home) position

LB1,"RD 1;RS 300;RC 1;           ! redraw delay, size, count
        SP 25;                   ! step period
        JD 0;                    ! jump delay
        SS 2"                    ! step size
NFDB1,"RD 1;RS 300;RC 1;SP 25;JD 0;SS 2"
LH1,"RC 1;SP 25;JD 0;SS 2;
        VC 5;                    ! rivet count
        VR 99;                   ! rivet reduction amount
        VP 11,12,13,14,15"       ! rivet step periods
NFDH1,"RC 1;SP 25;JD 0; SS 2;VC 5;VR 99;VP 11,12,13,14,15"
FDF1,"RC 1;SP 25;JD 0;SS 16"
```

```
NFDF1,"RC 1;SP 25;JD 0;SS 16"
NFUF1,"RC 1;SP 50;JD 0;SS 16"
FUF1,"RC 1;SP 10;JD 0;SS 16"

LB2,"RD 1;RS 300;RC 1;SP 25;JD 0;SS 2"
NFDB2,"RD 1;RS 300;RC 1;SP 25;JD 0;SS 2"
LH2,"RC 1;SP 25;JD 0;SS 2;VC 5;VR 99;VP 11,12,13,14,15"
NFDH2,"RC 1;SP 25;JD 0; SS 2;VC 5;VR 99;VP 11,12,13,14,15"
FDF2,"RC 1;SP 25;JD 0;SS 16"
NFDF2,"RC 1;SP 25;JD 0;SS 16"
NFUF2,"RC 1;SP 50;JD 0;SS 16"
FUF2,"RC 1;SP 10;JD 0;SS 16"

#BTM,"ZW 10;                ! Z-axis wait time in seconds
      ZD 5;                 ! Z-axis dip depth in mm
      ZV 0.8;               ! Z-axis velocity parameter
      ZA 0.1"               ! Z-axis acceleration parameter
```

Blank lines and lines starting with ! are ignored. Text after a ! is also ignored. The first few lines contain fixed Supervisor parameters that can only be affected by changing the numbers here. The rest of the file contains the default settings for the various blocks.

The L1 line contains the default laser control commands sent to STEREO laser driver whenever a L block from (PARSE input) file 1 is encountered.

These default command strings are by no-means fixed. Feel free to change them any way you like, even just to experiment. You can even eliminate all the defaults if they confuse you and start defining them over again.

5.1.3 Editing the Layer Control File

To edit a file, select item 5 from the Main Menu and tell the Editor what file you want to edit. Layer Control Files always have a ".L" extension.

The *.L file (* means any set of file name characters) can contain overrides for any block. Say that we have a FDF1 (Flat Down-Skin Fill from file 1) block. The Supervisor first sends the FDF1 line from its SUPER.PRM file to STEREO:

RC 1;SP 25;JD 0;SS 2

Then, the FDF1 override line from the *.L is sent to STEREO:

SP 10;JD 10

Because the later commands override the earlier ones, the combined effect is:

RC1;SS 2;SP 10;JD 10

SUPER gives you two levels of control, one in SUPER.PRM, and one in the part's control file. You may want to make special directories for different classes of parts that use different SUPER.PRM files.

NOTE: Future releases of the Supervisor may require alterations to the SUPER.PRM files. Whenever possible, a SUPER.PRM convert file will be supplied.

We recommend modifying only the *.L Layer Control files and leaving the *.P vector files alone. Use the PARSE /Z, /N and /O options to shift layers and exclude certain blocks.

Since both PARSE and SUPER ignore lines that begin with an exclamation point, you can insert comments in the data files:

! temporarily reduce step period to test material XQ45 7800,FUF1,"SP5"

5.2 Operating the Supervisor

SUPER is the name of the Version 2 Part-Making Supervisor. Version 1's Supervisor was called SUPV and should no longer be used.

When SUPER is brought up, it displays the title:

```
---------------------------------------------
  SUPER, Part Making Supervisor
  3D Systems Laser Stereolithography System
  Version 2.30  by 3D Systems  October 1987
---------------------------------------------
```

Part Prefix: _

Enter the prefix of the part's file name. SUPER will automatically assume the Layer Control File is the prefix plus ".L" and the vector file is the prefix plus ".P".

SUPER runs much like PARSE in that it display the current Z-layer number and the block name as it runs:

```
7800: L1 LB1 LH1 NFDB1 NFDH1 FDF1 NFDF1 L2 LB2
Waiting... Dipping... Relaxing...0
7810: L1 LB1 LH1 L2 LB2 NFUB2 NFUF2 FUF2
Waiting... Dipping... Relaxing...19
  :     :     :
```

SUPER tells you when its waiting for the laser controller to idle, when its dipping the elevator, and when its relaxing (delaying). The time to the next layer is displayed after "Relaxing".

Z-stage control

Through the Layer Control File (*.L) and its own SUPER.PRM file, SUPER allows the Stereolithographer to pass along commands to STEREO to control such items as laser beam home position, draw speed, and step size. SUPER has the most flexibility because it doesn't look at the STEREO commands. It just passes the "strings" along to STEREO at the appropriate time.

That control over the XY-laser motion has now been extended to the Z-stage. Four new commands have been added that allow the Stereolithographer to vary various Z-stage parameters:

| | |
|---|---|
| ZW delay | set the Z-stage wait time (after dipping) |
| ZD depth | set the Z-stage dip depth (in mm) |
| ZV velocity | set the Z-stage velocity parameter |
| ZA accel | set the Z-stage acceleration parameter |

These commands can be intermixed with STEREO commands in any way, as in:

1800,FUF, "SP 10,10;RC 2;ZW 10;ZD 5;RV 250"

This Control Layer File entry sets a new Z-stage wait time and dip depth in the midst of setting new Redraw parameters. The SP and RC commands are passed to STEREO, SUPER analyzes itself the ZW and ZD commands, then the RV command is passed to STEREO. Note that quotes are still required around the whole command string.

5.3 The Supervisor's Options

Like PARSE, SUPER has run-time options that can be appended to the part file name:

| | |
|---|---|
| | show stuff |
| /LOFF | laser off |
| /ZOFF | Z-table off |

Running SUPER with the /S option will show all the commands SUPER sends to both the Laser Controller (STEREO) and the Z-Table Controller.

/LOFF supresses laser control and /ZOFF supresses Z-table elevator control. Neither /LOFF or /ZOFF affects the output of commands caused by /S. /LOFF and /ZOFF should be used when running the Supervisor without the appropriate control boards installed in the computer.

Negative Z-stage control has also been added to SUPER. "Negative Z-Stage" refers to when the Z-stage works backwards from the default. All the old Beta will require Negative Z-stage control, since positive Z-stage control is defined as proper operation for the new Production Betas. Following "SUPER" or the input file name with "/NEGZ" will cause the Supervisor the use Negative Z-stage control.

Two more Z-stage related options have been added to SUPER. /START defines at what layer to begin processing, and /STOP defines at what layer to end processing. SUPER will skip past all the beginning layers to the one indicated by /START and end processing just after the layer indicated by /STOP. The layer numbers that follow /START and /STOP are the internal SLICE Z-layer numbers. The following set of options will cause the Supervisor to only process layers 1200 to 1450:

box0035/START 1200/STOP 1450

The following set of options will cause the Supervisor to start processing layers beginning at 2000:

SUPER box0038/START 2000

The spaces after /START and /STOP are not necessary, nor is the case of the letters significant.

5.4 The Supervisor's Keyboard Commands

While the Supervisor is relaxing and counting down the wait period, you can now take one of four actions.

1. You can wait for the wait period to expire, at which point SUPER will begin processing the next layer.

2. You can press P to pause. When the wait period expires, SUPER will wait for a keystroke before continuing. The countdown continues, but the time left is followed by "-P". You can press P again to cancel the pause.

3. You can press C to continue. The rest of the current wait period is skipped, and SUPER begins processing the next layer immediately.

4. You can press S to skip. SUPER aborts the current wait period and asks you what layer you which to skip to. Enter the internal Z layer number and press Enter. SUPER will scan for and resume processing on that layer. If it doesn't find that layer, SUPER will end.

5.5 Using Rivets

The laser controller supports the "rivets", where the middle section of certain vectors are redrawn to help strengthen the plastic part being made. Rivets are a special implementation utilizing the laser controller's redraw mode.

Rivets work as follows:

The redraw pass count is set to 1 using the RC command. The number of redraw passes for the rivets is set with the VC command, and the rivet reduction amount (the amount to chop off of both ends of the rivet vector) is set with the VR command. Then the various step periods for the passes are set using the SP command.

The STEREO Driver processes JX,JY and NX,NY commands as before. (Section 6.3 discusses the STEREO Command Set.) When it encounters a VX,VY sequence, it constructs a rivet on this vector. Internally, this works as follows:

| | |
|---|---|
| 1. | STEREO sets the step periods to the VP0 (riVet Period #0) value. |
| 2. | STEREO sets up the full vector to be drawn. |
| 3. | STEREO sets the redraw pass count to the VC value, the multi-pass step period to VP1, VP2, etc., then sets the reduced vector to be drawn and redrawn. |
| 4. | STEREO then restores the original redraw count and the orginal step periods. |
| 5. | STEREO continues processing... |

The most consistent laser motion occurs with the standard redraw pass count set to 1. The standard redraw mode could be on while rivets are being processed; the standard redraw pass count could be, say, 2, while the rivet redraw pass count could be, say, 6. However, the rivet redraw will truncate the distance of redraw sections just before the rivet, and that may have an effect on rivet performance.

Rivet Implementation

Several STEREO commands support rivets. These commands all begin with 'V' (not 'R', as it is already used for "Redraw"). The code that is responsible for "making rivets" uses a combination of vector moves, jumps, and vector redraws.

| | | |
|---|---|---|
| VC 1-10 | riVet pass Count | (# passes) |
| VP 5-6553,.. | riVet step Periods | (10 us) |
| VR 0-65535 | riVet Reduction amount | (distance) |
| VX 0-65535 | riVet end X position | (position) |
| VY 0-65535 | riVet end Y position | (position) |

where:

| | |
|---|---|
| 10 us | is the # of 10s of microseconds resolution = 0.84 us (from 1.19 MHz clock) |
| position | is the absolute position in the field |
| distance | is the absolute distance in step size units |
| # passes | is the number of redraw passes |

Like the SP command, the VP command has multiple arguments. Each of up to ten passes of rivet redraw can have its own step period. The VP command can have 1 to 10 arguments, each a step period for a pass:

VP vp0,vp1,vp2,vp3...

where vp0 is the step period for rivet redraw pass 0 (the full vector draw), vp1 is the step period for redraw pass 1 (the first pass of the rivet), and so on. The VP command is stuffed into the Background Command Queue FOR EACH RIVET, so try to limit the number of rivet redraw passes.

6.0 Other Programs

This chapter discusses some ancillary programs that you may never use. We feel that we should document them anyway just-in-case.
FRONT, CLIFF, and STEREO are documented in this chapter. FRONT is a FRONT end interface to the low-level laser controller, CLIFF is a program that reads STEREO commands from either the keyboard or a file and sends them to STEREO. STEREO is the Stereolithography Device Driver mentioned many times before; its full command set is documented here.

6.1 FRONT, Simple Front End to Laser Controller

FRONT is primarily a debugging tool used in developing the low-level laser controller.
To run FRONT, just type "FRONT" at a DOS prompt. FRONT doesn't care if the laser controller has been loaded or not.
FRONT displays a menu screen that looks like this:

| 3D Systems Laser Controller Simple Front End Version 2.30 by Tarnz Technologies October, 1987 | | | |
|---|---|---|---|
| A. | Laser Installed Check | 50. | Get Software Interrupt Number |
| 0. | Open Laser Channel | 51. | Get Background Interval Time |
| 1. | Close Laser Channel | 52. | Get Laser Control Word |
| 20. | Add Vector to Command Queue | 61. | Set Background Interval Time |
| 21. | Add Open Shutter Command | 62. | Set Laser Control Word |
| 22. | Add Close Shutter Command | 70. | Execute |
| 23. | Add Change Time Base Command | 71. | Execute and Clear |
| 24. | Add Pause Command | 72. | Clear |
| 3. | Reset Command Queue | X. | Exit |
| 4. | Get Command Queue Size | | |

For the most part, FRONT is self-explanatory. You simple enter the number of the option that interests you at the "FRONT>" prompt and press Enter. FRONT will then ask you for any arguments the option might have. In the case of status options, FRONT will print out the status in a suitable format. If any errors are returned by the low-level laser controller, FRONT will print them out.

6.2 CLIFF, Control Laser Instrument From File

CLIFF stands for "Control Laser Instrument From File" and that is exactly what it does. It reads commands from a text file or optionally from the keyboard and sends them to STEREO Driver.

3D Systems personnel have found it useful to write simple BASIC programs and use CLIFF from the middle of them using the SHELL statement. Their approach to developing laser controlling programs is similar to this procedure:

| | |
|---|---|
| 1. | Understand what it is to be accomplished |
| 2. | Develop the Basic algorithms and write the code, temporarily displaying intermediate results to the screen for debugging purposes |
| 3. | Make a text file filled with STEREO commands |
| 4. | Invoke CLIFF by using Basic's SHELL statement |
| 5. | See if an error was generated - if the file CLIFF.ERR exists, it contains the error description |
| 6. | Dip object being built and process next layer |

Somewhere in the BASIC program, the Basic statement

SHELL "CLIFF <data file with commands>/T/W"

can be found. This is the statement that temporarily suspends execution of the Basic program, executes the string as though it were an MSDOS command, then returns control back to the Basic program at the next statement.

Ordinarily when CLIFF is run, it will display a title, identifying itself and informing you about its version number. The /T option makes CLIFF transparent and forces CLIFF to not output anything to the video screen. This allows the controlling Basic program to assume complete control over the screen.

Ordinarily, CLIFF will end when it translate the last command from the data file. The /W option forces CLIFF, after reading and translating the commands in the text file, to wait until the background task idles before quitting and returning to.the BASIC program.

The DOS command line syntax for CLIFF is:

CLIFF <datafile>/options

where <datafile> is the name of the data file containing the laser control information, and /options are any number of user-selectable options:

| | |
|---|---|
| /S | show laser control information |
| /W | wait for laser idle at end |
| /T | transparency mode (no CLIFF text) |

CLIFF can perform the wait-for-idle function (/W option) without having any data file or commands to execute. CLIFF /W and CLIFF /W/T (transparent) will make CLIFF wait for the background task to idle.

<datafile> can be replaced by a sequence of direct commands by preceding the commands with a ', ", or @ character. A semicolon can be used to separate commands. As many commands as will fit on one line can be specified. In the following example, the block mode is turned on and the laser beam moved:

CLIFF MD BL +; JX 1000; JY 2000; NX 4000; NY 5000; EC

If CLIFF is called up with no arguments, it will prompt with

Enter file name: _

at which point the operator should enter the name of the data file containing CLIFF-compatible commands. Direct commands can be entered here if preceded by a special character as described above.

When CLIFF is executed, it erases the CLIFF.ERR file in the currently directory if it exists. Any errors encountered during the processing of the data file will be stored in the CLIFF.ERR file as well as displayed on the screen. This feature allows for the operator to review more that a screenful of error messages, and it allows programs that called CLIFF to see what errors occured.

CLIFF reads a file, line by line, and sends the output to the STEREO device driver. Any errors indicated by STEREO are reported.

6.3 The Stereolithography Device Driver

STEREO is a memory-resident driver specially designed for Sterolithography. Its command set is intended to be somewhat compatible with General Scanning's DG Series Electronic Packages for Laser Control.

STEREO installs itself in the computer's memory when the Process Computer powers up and stays there. Any program can come along and call on STEREO to provide laser controller services.

6.3.1 STEREO Commands

STEREO understands the following commands:

| | | | |
|---|---|---|---|
| BX | 0-65535 | Beginning X position | (position) |
| BY | 0-65535 | Beginning Y position | (position) |
| JX | 0-65535 | Jump to new X position | (position) |
| JY | 0-65535 | Jump to new Y position | (position) |
| NX | 0-65535 | Next X position | (position) |
| NY | 0-65535 | Next Y position | (position) |
| SS | 1-65535 | Step Size | (rel incr) |
| SP | 5-6553,.. | multi-pass Step Periods | (10 us) |
| SD | 0-65535 | Scanning Delay | (step periods) |
| JS | 1-65535 | Jump Size | (rel incr) |
| JD | 0-65535 | Jump Delay | (step periods) |
| LO | 0-65535 | Laser On delay | (10 us) |
| LF | 0-65535 | Laser Off delay | (10 us) |
| NS | | eNter Sequence mode | - |
| AB | | Enter Absolute mode | - |
| EX | | Execute | - |
| EC | | Execute and Clear | - |
| CL | | Clear table | - |
| MD | AS -/+ | set Auto-Shutter mode | (off/on) |
| MD | BL -/+ | set BLock mode | (off/on) |
| MD | PA -/+ | set Pos Ack mode | (off/on) |
| SR | | Soft Reset | |
| HR | | Hard Reset | |
| RC | 1-10 | Redraw pass Count | (# passes) |
| RD | 0-65535 | Redraw Delay | (step periods) |
| RS | 0-65535 | Redraw Size | (distance) |
| VC | 1-10 | riVet pass Count | (# passes) |
| VP | 5-6553,.. | riVet step Periods | (10 us) |
| VR | 0-65535 | riVet Reduction amount | (distance) |
| VX | 0-65535 | riVet end X position | (position) |
| VY | 0-65535 | riVet end Y position | (position) |
| WI | 0-32767 | Wait for Idle | (delay) |

where:

| | |
|---|---|
| 10 us | is the # of 10s of microseconds resolution = 0.84 us (from 1.19 MHz clock) |
| position | is the absolute position in the field range in 0 to 65535 |
| distance | is the absolute distance in step size units |
| rel incr | is the relative # of position increments |
| # passes | is the number of redraw passes |
| step periods | is the time to cover that # of steps programmed by SP command (= tick counts) |
| delay | delay value in milliseconds (may be faster on faster computers) |

In the above list, following each two-character command is the range of numbers allowed as arguments to the command. All numbers are in unsigned decimal.

BX and BY set the laser beam's home position. This is the position in the field that the laser beam will be place at when there is no part-making activity.

JX and JY move the laser beam to a new location quickly. No polymerization takes place.

The Jump is conditioned by JS and LD. JS defines the Jump Size, the number of field units to jump at one time. This is usually a large number, like 10000. JD sets the number of step period delays once the jump movement have been completed. This lets the mechanical mirrors settle.

NX and NY move the laser beam to a new location slowly. Polymerization does take place.

The slow laser beam movement is controlled by SS, SP, and SD. SP defines the Step Period, the time for each discrete laser step. SS defines the Step Size, the number of units in the field to move each step period. SD is the delay once the laser beam reaches its destination.

LO and LF set the Laser On and Laser Off delays going into and out of the idle mode. These are delays for the homing and unhomeing of the laser beam.

NS and AB are accepted but not acted upon. They are provided simply for General Scanning compatibility.

On the SLA-1, we usually use MD AS -, MD BL +, and MD PA -. MD BL + turns on the block mode, where laser controller commands are queue up and then let go with the EX or EC command. This technique prevents unnecessary idle times.

EX causes then lase set of commands to be executed. Another EX will cause the same set of commands to be executed again. EC executes, but then clears out the commands. CL clears out the command without executing. With the block mode on, nNo commands will be interpreted unless EX or EC is used.

SR and HR reset the low-level laser controller. HR is the most useful since it stops all current activity and empties out all the previous commands. HR can be used at the beginning of programs.

RC, RD, and RS control the Redraw parameters. Redraw is where the laser controller makes multiple passes over the same vectors. RC defines the pass count, RD the delay before starting a pass, and RS the size of the redraw. Every RS potion of the vectors will be redrawn if RC is greater than 1.

VC, VP, VR, VX, and VY control the Rivet feature. Discussed in more detail in Section 5.5, rivets are where the interiors of a vectors are redrawn. VC defines the number of redraw passes, VP the multiple step periods, one for each pass, and VR the amount to chop off of both end of the vector. Zero and negative length vectors are not redrawn. To tell STEREO a vector is a rivet, use VX and VY instead of NX and NY.

WI waits for idle. WI's parameter is some delay so that the low-level laser controller will have time to synchronize with STEREO. Typically, WI 1000 will work just fine.

The SP (and VP) command has multiple arguments. Each of up to ten passes of redraw can have its own step period. The SP command can have 1 to 10 arguments, each a step period for a pass:

SP sp0,sp1,sp2,sp3...

where sp0 is the step period for redraw pass 0 (the original vector move), sp1 is the step period for redraw pass 1, and so on.

The command line with invokes STEREO and causes it to be installed in memory takes the form:

STEREO [/options]

where /options are any number of user-selectable options:

| | |
|---|---|
| /NV | no constant vector velocity |
| /NG | no geometric correction |
| /NC | no version check at install time |

STEREO can only be installed once after the computer has been powered up. If different options are required, the computer system will have to be completely rebooted.

Geometric correction is automatically invoked. If geometric correction is not desired, the option /NG should be specified in the command line. Geometric correction occurs on the endpoints of any vector STEREO passes to the low-level laser controller.

6.3.2 STEREO Options

LASER and STEREO are installed automatically when the Process Computer starts up. LASER contains the low-level laser controller and has no options. STEREO, on the other hand, has options. For the most part, these options are of little interest, but are documented for the sake of completeness.

Axes Control

Because we have SLA units with axes going in different dirrections, we installed Axes Control into the STEREO driver. When STEREO is brought up, either by the user typing or from an AUTOEXEC.BAT file, the following options can be use to set the axes:

| | |
|---|---|
| /X+<br>/X- | X-axis is positive. This is the current default.<br>X-axis is negative. Using this flips the direction of the X-axis. |
| /Y+<br>/Y- | Y-axis is positive. This is the current default.<br>Y-axis is negative. Using this flips the direction of the Y-axis. |
| /SWAPXY | swaps the X and Y coordinates BEFORE any other axis or geometric correction operation. Swapping is not ordinarily done. |

Here's a sample DOS command line that installs STEREO with the X-axis direction changed. Note that STEREO must not have already been installed.

STEREO/X-

STEREO reports to you the axes orientation it is going to use when it installs itself. Check this and make sure you got what you asked for.

Geometric Correction

Geometric Correction has been installed in STEREO. Geometric Correction now not only corrects for the pincushion distortion, but also for the imprecisions of each individual SLA unit.

We call the current correction technique Table-Interpolation Geometric Correction because the correction is done after performing look-ups in a special table. This table maps the linear XY coordinate system in a distored one that ends up cancelling the real SLA unit's distortion. The look-up table is stored in a file generated by CALIB, the SLA machine calibration program. STEREO's /NG option will cancel Geometric Correction.

The look-up table has 65 by 65 entries, one entry for each 1024 steps across the X and Y axes plus the end. Remember each axis has a resolution of 65536 steps. The table is stored in the ASCII file STEREO.GEO (see Section 6.7), which is read when STEREO installs itself. If STEREO can't find STEREO.GEO or if it detects some problem with it, it will display an appropriate message.

Each SLA machine will have a different STEREO.GEO based on the results of its calibration. One machine's Geometric Correction will not be the same as that for any other in maintaing the desired mil-accuracy. (The other machine will still run; the parts it makes may seem strange, however.) Think about recalibrating if you move around STEREO.GEO files.

7.0 File Formats

This chapter describes the various Stereolithography file formats. Of these, the ones you will become the most familar with are the Layer Control File (*.L) and the SUPER.PRM Default Parameters File.

7.1 SLICE's Input File (*.STL) Format

A CAD program must be able to produce a file with the specific format described below. Usually this file is quite large is size (several hundred thousand bytes) and is transferred over a high-speed data link such as Ethernet to the 386-based Stereolithography Computer. Transfers of smaller-size files using RS-232 and floppy diskettes are also possible but not recommended.

The SLICE Input Format loosely follows a graphics standard called PHIGS (Programmers Hierarchical Interactive Graphics Standard), and improves on it in several ways. First, all the numeric data can be compressed into binary form, greatly reducing the size of storage files and reducing the data transfer time to the Stereolithography Computer. Second, support of special part-building attributes allow certain features to be "attached" to facets and passed all the way down the pike to the Part-Making Supervisor.

Files being submitted to SLICE should has the extension ".STL", that is, the names of the files should end in ".STL". When SLICE is run and no extension is supplied, SLICE will automatically assumes a ".STL" extension. Older files that has a ".DAT" extension in their file name should either be renamed or have their file names specified completely in SLICE's command line (see Section 2.1).

The files can be stored in either ASCII or Binary. We recommend using the ASCII format while developing STL-file-making software and then switching to the binary format for release. Older versions of SLICE, pre-SLICE17 do not support the binary format.

An example of an ASCII STL file follows. It defines a simple tetrahedron.

```
solid Solid_Tetra.2
  facet normal -1 0 0
    outer loop
      vertex 0 0 0
      vertex 0 0 1
      vertex 0 1 0
    endloop
  endfacet
  facet normal 0 -1 0
    outer loop
      vertex 0 0 0
      vertex 1 0 0
      vertex 0 1 0
      attribute 16
    endloop
  endfacet
  facet normal 0 0 -1
    outer loop
      vertex 0 0 0
      vertex 0 1 0
      vertex 1 1 0
      attribute 16
      attribute 9
      attribute 22
    endloop
  endfacet
    :       :
endsolid Solid_Tetra.2
```

The important structure for an ASCII STL file is its use of words to identify the type of numeric data. The facet normal and vertex information can be in floating point - numbers like 332382912 and 1.3045E+3 are acceptable.

The vertices should follow the right-hand rule. The normal vector should have a magnitude of 1.

We assume a word is 16 bits and is equal to two bytes. The precise format for a Binary STL file is:

```
(top of file)
80 bytes - general information
           contains part names, comments, etc.

 2 words - number of facet records
           each facet record defines one triangle

First facet record:
 6 words - Normal Vector
            2 words - i coordinate
            2 words - j
            2 words - k
18 words - Triangle Vertices
            2 words - x1 )
            2 words - y1 )-first vertex
            2 words - z1 )
            2 words - x2    )
            2 words - y2    )-second vertex
            2 words - z2    )
            2 words - x3       )
            2 words - y3       )-third vertex
            2 words - z3       )
 1 word  - Number of Attributes
            < special attribute formats >
            This word should be set to zero
    :       :       :
```

The STL Binary Format is similar in structure to the ASCII format. One facet record follows another, and each facet record defines a normal, three triangle vertices, and optionally some attributes. Since we don't as yet support attributes, the attribute count word should be set to zero.

The binary format for the number of facet records and for each number of attributes is just an unsigned integer. The normal and triangle vertices are in four-byte 8087 real format, with a 3 byte mantissa and a 1 byte exponent.

7.2 SLICE's Output File (*.SLI) Format

SLICE produces one output file for each input file. By default, each output file has the extension ".SLI". The current format for the output file is as follows:

```
!
!  optional comments
!
L <layer1>                      L-block (mandatory)
LB                              non-L blocks are only present when
 <X1> <Y1> <X2> <Y2>              they have vectors
 <X1> <Y1> <X2> <Y2>
 <X1> <Y1> <X2> <Y2>              LB   - Layer Border
 <X1> <Y1> <X2> <Y2>
    :    :
Lh                                LH   - Layer Hatch
 <X1> <Y1> <X2> <Y2>
    :    :
NFDB                              NFDB - Near-Flat Down-skin Border
 <X1> <Y1> <X2> <Y2>
    :    :
NFDH                              NFDH - Near-Flat Down-skin Hatch
 <X1> <Y1> <X2> <Y2>
    :    :
NFUB                              NFUB - Near-Flat Up-skin Border
 <X1> <Y1> <X2> <Y2>
    :    :
FDF                               FUF  - Flat Down-skin Fill
 <X1> <Y1> <X2> <Y2>
    :    :
NFDF                              NFDF - Near-Flat Down-skin Fill
 <X1> <Y1> <X2> <Y2>
    :    :
NFUF                              NFUF - Near-Flat Up-skin Fill
 <X1> <Y1> <X2> <Y2>
    :    :
FUF                               FUF  - Flat Up-skin Fill
 <X1> <Y1> <X2> <Y2>
    :    :
L <layer2>                      second Z-layer of file
    :    :                        (format repeats)
    :    :
```

where <X1> <Y1> <X2> <Y2> are the two coorinates of a vector in X-Y space, four ASCII numbers
<X1> <Y1> is the start of the vector
<X2> <Y2> is the end of the vector

7.3 The Parser's Output File (*.P and *.L) Format

For a given set of input files, PARSE will produce one *.L file (* represents any set of DOS filename characters) and one *.P file. The *.L file is small and contains layer information, and the *.P file contains the combined vectors.

The *.P file is similar in appearance to the original *.SLI files but differs in three ways.

First, the *.P file is the result of combining all the input files together to form a single vector file for the Supervisor. PARSE had juggled the input files so that all the layers are in ascending order - just the way the Supervisor expects them.

Second, if told to do so, PARSE has selectively included or excluded certain types of blocks, so the vectors for the excluded blocks will not appear in the *.P file.

Third, PARSE has tacked on a file and layer identifier to each block header in the *.P file. Whereas the input line was just:

LH

PARSE may output to the *.P file:

LH2,7800

indicating that the block came from the second input file and belongs on layer 7800.

The *.P files can get quite long, so editing them might require a editor that can go beyond 64K of characters.

Smaller files of coarse can be easily edited by virtually any editor.

The *.L files are the most interesting. For each block output to the *.P file, a corresponding single-line entry was made to the *.L file. In addition, a #TOP and a #BTM line-entry wad made for each layer - the #TOP just above and the #BTM just below the layer's other block entries. Here's a sample: -

7800: L1 LB1 LH1 NFDB1 NFDH1 FDF1 NFDF1 L2 LB2
Waiting... Dipping... Relaxing...0
7810: L1 LB1 LH1 L2 LB2 NFUB2 NFUF2 FUF2

```
* 1000,50,.508
7800,#TOP
7800,L1
7800,LB1
7800,LH1
7800,NFDB1,"SP 3;RC 1"
7800,NFDH1
7800,FDF1
7800,NFDF1
7800,L2
7800,LB2
7800,#BTM
7810,#TOP
7810,L1
7810,LB1
7810,LH1
7810,L2
7810,LB2
7810,NFUB2
7810,NFUF2
7810,FUF2
7810,#BTM
   :
```

The first line contains the scale, Z-spacing, and layer thickness as told to PARSE. These values are picked up later by the Supervisor.

Note that each line starts with the layer number, followed by the block type. Any line can be followed by:

,"<override commands>"

which contains override commands. The override command is the last STEREO command string sent to the STEREO device driver before drawing the block's vectors, and it can override previously set laser control defaults. Line 7800,NFDB1 above contains such a line. PARSE does not ever make any override commands - only the operator can do that. The override feature is discussed in more detail in Section 5.1.

7.4 Critical Area File (*.BOX) Format

Version 2.04 supports critical areas, where the Supervisor can be instructed to perform or not to perform something within the confines of a box. For a given part with a file name prefix of <part>, PARSE attempts to read the <part>.BOX file. If it doesn't see the file, it simply prints out a warning message and continues. Otherwise, it reads in the file and analyzes it while parsing.

The Format for the *.BOX file is:

```
<type>,<base>,<height>,<x1>,<y1>,<x2>,<y2>,<x3>,<y3>,<x4>,<y4>
   :       :       :       :
```

where:

| | |
|---|---|
| <type> | is 'XV' to rivet cross-hatches in the enclosed area or 'XI' to ignore cross-hatches |
| <base> | is the base of the box relative to the scale |
| <height> | is the height of the box |
| <x1>,<y1> | is the first coordinate of the box |
| <x2>,<y2> | is the second coordinate |
| <x3>,<y3> | is the third coordinate |
| <x4>,<y4> | is the fourth coordinate |

If the CAD image was drawn in mils (1000ths of inches) and the scale factor is 1000, then:

```
XV,8.0,0.3,1,1,1,-1,-1,-1,-1,1
XI,7.90,0.2,2,2,2,-0.5,-3,-2,-1,3.1
```

defines two boxes, one 3/10 and one 2/10 inches high. The first box tells where cross-hatching with rivets will occur, and the second box tells where no cross-hatching will occur. All the coordinates are expressed in inches.

The current box algorithm supports only lines on the X and Y-axes. Only rectangles can be specified. Don't specify diamonds or near-triangles. If you need to isolate a precise area, use a set of rectangles that nearly approximate it.

7.5 Supervisor Default Parameters File (SUPER.PRM) Format

Blank lines and lines starting with ! are ignored. The first few lines contain fixed Supervisor parameters that can only be affected by changing the numbers there. The rest of the file contains the default settings for the various blocks.

```
!
!  Supervisor Parameter File
!  Version 2.30
!
!  last altered: 9/28/87
!        reason: to test new SUPER Default Option line in this file
!

!
!  Default SUPER Options
!
!  place options together inside of quotes;  use "" if no options
!  /NEGZ required for some prototype units
!
""

!
!  General Parameters
!
800     Elevator board base address
50      Elevator pitch parm, 100 for alphas, 50 for betas
1.0     XY-only scale factor: does not affect Z-axis
0       X-coordinate offset
0       Y-coordinate offset
750     Max number of vectors to send to Stereo

!
!  - Block defaults -
!
!  Each time the Supervisor starts a block, the respective default
!  string below is sent to the Stereo driver.  Z,X... are the block
!  types (Z-Boundary, X-Cross-Hatch, etc.) and they are followed
!  by the parse input file number (e.g. 1 may be for post vectors
!  and 2 for object vectors).  Although only defaults for 2 Slice
!  files are set for here, up to 10 files are supported.
!
#TOP,"BX 8500;BY 34300"          ! laser beam begin (home) position

LB1,"RD 1;RS 300;RC 1;           ! redraw delay, size, count
       SP 25;                    ! step period
       JD 0;                     ! jump delay
       SS 2"                     ! step size
NFDB1,"RD 1;RS 300;RC 1;SP 25;JD 0;SS 2"
LH1,"RC 1;SP 25;JD 0;SS 2;
       VC 5;                     ! rivet count
       VR 99;                    ! rivet reduction amount
```

```
        VP 11,12,13,14,15"      ! rivet step periods
NFDH1,"RC 1;SP 25;JD 0; SS 2;VC 5;VR 99;VP 11,12,13,14,15"
FDF1,"RC 1;SP 25;JD 0;SS 16"
NFDF1,"RC 1;SP 25;JD 0;SS 16"
NFUF1,"RC 1;SP 50;JD 0;SS 16"
FUF1,"RC 1;SP 10;JD 0;SS 16"

LB2,"RD 1;RS 300;RC 1;SP 25;JD 0;SS 2"
NFDB2,"RD 1;RS 300;RC 1;SP 25;JD 0;SS 2"
LH2,"RC 1;SP 25;JD 0;SS 2;VC 5;VR 99;VP 11,12,13,14,15"
NFDH2,"RC 1;SP 25;JD 0; SS 2;VC 5;VR 99;VP 11,12,13,14,15"
FDF2,"RC 1;SP 25;JD 0;SS 16"
NFDF2,"RC 1;SP 25;JD 0;SS 16"
NFUF2,"RC 1;SP 50;JD 0;SS 16"
FUF2,"RC 1;SP 10;JD 0;SS 16"

#BTM,"ZW 10;                    ! Z-axis wait time in seconds
        ZD 5;                   ! Z-axis dip depth in mm
        ZV 0.8;                 ! Z-axis velocity parameter
        ZA 0.1"                 ! Z-axis acceleration parameter
```

The file lets the STEREO commands be intermixed with the special Supervisor Z-ztage commands. Command strings can be broken up into several lines, and comments (beginning with an !) can be at the end of any line.

7.6 The STEREO.DEF Driver Default File Format

Below is a copy of the STEREO.DEF file supplied with the system. These are the default values loaded by STEREO when it is installed. You may never need to change any of these values in this file. In fact, the Supervisor always resets these parameters using the appropriate lines from the SUPER.PRM and *.L files.

```
!
!  STEREO Device Driver Initial Set-up
!
2       [SS] Step Size
1190    [SP] Step Periods
[illegible]     [SD] Scan Delay
65535   [JS] Jump Size
100     [JD] Jump Delay
0       [LO] Laser On Delay
0       [LF] Laser Off Delay
1       [RC] Redraw Pass Count
0       [RD] Redraw Delay
200     [RS] Redraw Size
2       [VC] Rivet Pass Count
1190    [VP] Rivet Step Periods
100     [VR] Rivet Reduction Amount
```

7.7 The STEREO.GEO Geometric Correction File Format

The geometric correction look-up table has 65 by 65 entries, one entry for each 1024 steps across the X and Y axes plus the end. Remember each axis has a resolution of 65536 steps. The table is stored in the ASCII file STEREO. GEO in the \3DSYS directory, which is read when STEREO installs itself. If STEREO can't find STEREO.GEO or if it detects some problem with it, it will display an appropriate message.

So, the format for the look-up table is as follows:

```
!
!  Comment Lines (optional)

65,65,2           ! 65 by 65 by 2 coordinates
102.34,134.56     ! correction for (0,0)
101.23,123.45     ! correction for (0,1024)
    :       :     :
102.41,144.33     ! correction for (0,65536)
98.767,102.22     ! correction for (1024,0)
96.352,100.034    ! correction for (1024,1024)
    :       :     :
```

Note that even though we are mapping onto an integer-system, the correction table can have floating-point numbers. The first non-coment line must contain "65,65,2" as that is the only geometric correction format currently supported by STEREO.

Each SLA machine will have a different STEREO.GEO based on the results of its calibration. One machine's Geometric Correction will not be the same as that for any other in maintaing the desired mil-accuracy. DO NOT COPY STEREO.GEO FILES FROM ONE SLA MACHINE TO ANOTHER.

Appendix A - SLA-1 Software System Chart

| - Process Computer - | - Slice Computer - |
|---|---|
| **Start-Up Installation** | |
| MSDOS | XENIX |
| TCP | TCP |
| LASER | |
| STEREO | |
| **Menu Programs** | |
| MENU | |
| **System Functions** | |
| CHKDSK | SYSADM |
| DIR | |
| DOS | |
| QD2 | |
| **Slicing Programs** | |
| | UI |
| | SLICE |
| **Part-Making Programs** | |
| PARSE | |
| SUPER | |
| GRAPH | |
| **Utility Programs** | |
| POWER | |
| GETSP | |
| ZSTAGE | |
| CALIB | |
| PROFILE | |
| **Communication Programs** | |
| TELNET | TELNET |
| FTP | FTP |

Appendix B - The STEREO Command Set

STEREO Command Set is intended to be somewhat compatible with General Scanning's DG Series Electronic Packages for Laser Control.

STEREO understands the following commands:

| | | | |
|---|---|---|---|
| BX | 0-65535 | Beginning X position | (position) |
| BY | 0-65535 | Beginning Y position | (position) |

(continued)

| | | | |
|---|---|---|---|
| JX | 0-65535 | Jump to new X position | (position) |
| JY | 0-65535 | Jump to new Y position | (position) |
| NX | 0-65535 | Next X position | (position) |
| NY | 0-65535 | Next Y position | (position) |
| SS | 1-65535 | Step Size | (rel incr) |
| SP | 5-6553,.. | multi-pass Step Periods | (10 us) |
| SD | 0-65535 | Scanning Delay | (step periods) |
| JS | 1-65535 | Jump Size | (rel incr) |
| JD | 0-65535 | Jump Delay | (step periods) |
| LO | 0-65535 | Laser On delay | (10 us) |
| LF | 0-65535 | Laser Off delay | (10 us) |
| NS | | eNter Sequence mode | - |
| AB | | Enter Absolute mode | - |
| EX | | Execute | - |
| EC | | Execute and Clear | - |
| CL | | Clear table | - |
| MD | AS -/+ | set Auto-Shutter mode | (off/on) |
| MD | BL -/+ | set BLock mode | (off/on) |
| MD | PA -/+ | set Pos Ack mode | (off/on) |
| SR | | Soft Reset | |
| HR | | Hard Reset | |
| RC | 1-10 | Redraw pass Count | (# passes) |
| RD | 0-65535 | Redraw Delay | (step periods) |
| RS | 0-65535 | Redraw Size | (distance) |
| VC | 1-10 | riVet pass Count | (# passes) |
| VP | 5-6553,.. | riVet step Periods | (10 us) |
| VR | 0-65535 | riVet Reduction amount | (distance) |
| VX | 0-65535 | riVet end X position | (position) |
| VY | 0-65535 | riVet end Y position | (position) |
| WI | 0-32767 | Wait for Idle | (delay) |

where:

| | |
|---|---|
| 10 us | is the # of 10s of microseconds resolution = 0.84 us (from 1.19 MHz clock) |
| position | is the absolute position in the field range in 0 to 65535 |
| distance | is the absolute distance in step size units |
| rel incr | is the relative # of position increments |
| # passes | is the number of redraw passes |
| step periods | is the time to cover that # of steps programmed by SP command (= tick counts) |
| delay | delay value in milliseconds (may be faster on faster computers) |

Section 6.3.1 discusses these commands in more detail.

Appendix C - Stereolithography Software Glossary.

Below, we present a sofware glossary of terms you may have encountered in this documentation or may hear in the future:

Please take a few minutes to review these terms.

80286 - the 16-bit microprocessor in the Process Computer.

80386 - the 32-bit microprocessor in the Slice Computer.

block - a set of vectors in a file

critical area - an area where vectors will be treated special

cross-hatching - supporting cross-vectors between the inside and outside walls of a part

Ethernet - a high-speed intra-computer communications system Jointly developed by Digital, Intel and Xerox

field - the surface of the vat that the laser beam can reach

filling - the process by which part surfaces are made

geometric correction - adjusting the laser beam for the pincushion effect

home position - the field location that the beam jumps to when there is no part-making activity

laser controller - the software "underneath" the Supervisor that controls the laser's motion

jump - the quick, non-polymerization moving of the laser beam

jump delay - the delay after a jump allowing the mirrors to settle

mirrors - those which rotate to position the laser beam anywhere in the field

MSDOS - the standard Disk Operating System for the Process Computer

multi-tasking - where many people can use the same computer simultaneously

pincushion effect - the inherent distortion of a pin-point source being directed onto a flat surface

process - the act of making a part

Process Computer - the computer in the SLA machine that is used to make parts; MSDOS-based

redrawing - making multiple passes of the laser beam over the same vector to induce strength

rivets - an intelligent method of redrawing where the extra passes are made over a smaller area

segment - two-coordinate, four-point describing a line

shutters - barriers of the laser beam

slicing - the act of preparing a 3D part for Stereolithography by transforming it into 2D layers

Slice Computer - the computer away from the SLA machine that is use to slice parts; XENIX-based

step - a discrete movement of the laser beam

step period - the period during which one step is made

step size - the number of field units for a step

unix - an advanced multi-tasking operating system developed at Bell Labs in the 70's

XENIX - a unix-like Operating System provided on the Slice Computer

Z-stage - the vectical elevator parts rest on

Appendix D - Editor Commands

The Editor Commands are similar to those of Word-Star, a popular Word Processing System, and to those found in the Borland International family of products.

| Basic Cursor Movement Commands | |
|---|---|
| character left | Ctrl-S or Left |
| character right | Ctrl-D or Right |
| word left | Ctrl-A |
| word right | Ctrl-F |
| line up | Ctrl-E or Up |
| line down | Ctrl-X or Down |
| scroll up | Ctrl-W |
| scroll down | Ctrl-Z |
| page up | Ctrl-R or PgUp |
| page down | Ctrl-C or PgDn |

| Quick Cursor Movement Commands | |
|---|---|
| beginnning of line | Ctrl-Q S or Home |
| end of line | Ctrl-Q D or End |
| top of window | Ctrl-Q E |
| bottom of window | Ctrl-Q X |
| top of file | Ctrl-Q R |
| bottom of file | Ctrl-Q C |
| beginning of block | Ctrl-Q B |
| end of block | Ctrl-Q K |
| last cursor position | Ctrl-Q P |

| Insert and Delete Commands | |
|---|---|
| insert mode on/off | Ctrl-V or Ins |
| insert line | Ctrl-N |
| delete line | Ctrl-Y |
| delete to end of line | Ctrl-Q Y |
| delete character to left of cursor | Ctrl-H or Backspace |
| delete character under cursor | Ctrl-G or Del |
| delete word right of cursor | Ctrl-T |

| Block Commands | |
|---|---|
| mark block-begin | Ctrl-K B |
| mark block-end | Ctrl-K K |
| mark single word | Ctrl-K T |
| copy block | Ctrl-K C |
| delete block | Ctrl-K Y |
| hide/display block | Ctrl-K H |
| move block | Ctrl-K V |
| read block from disk | Ctrl-K R |
| write block to disk | Ctrl-K W |

| Miscellaneous Commands | |
|---|---|
| find | Ctrl-Q F |
| find and replace | Ctrl-Q A |
| repeat last find | Ctrl-L |
| abort operation | Ctrl-U |
| restore line | Ctrl-Q L |
| quit edit | Ctrl-K D |

3D Systems Software Manual Addendum #1

SLICE REVEALED TO EVERYBODY

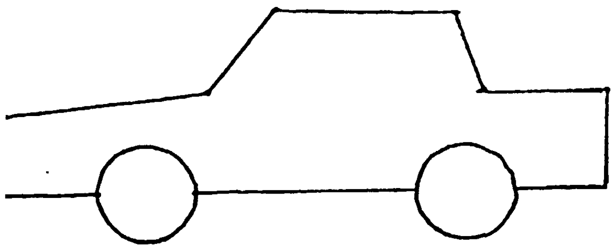

GENERIC AMERICAN AUTOMOBILE, CIRCA 1973
SIDE VIEW (NO DETAIL)

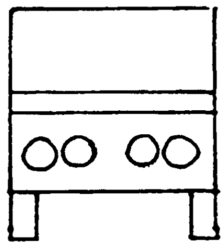

FRONT VIEW (NO DETAIL)

THE GEOMETRIC MODEL SLICE WOULD GET AS INPUT: (NO TIRES)

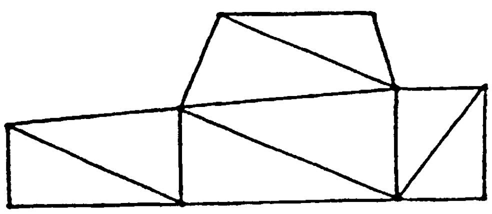

SIDE

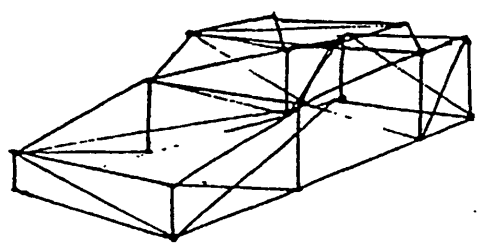

(IT'S ALL TRIANGES)

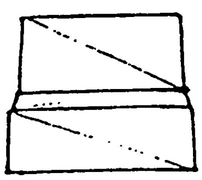

FRONT (NO TIRES)

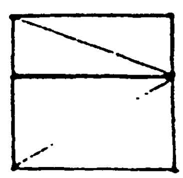

BACK

EXPLODED VIEW

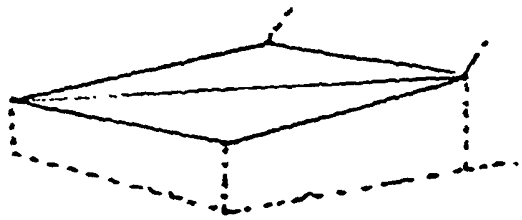

THE HOOD
(2 TRIANGES —
THEY ARE "NEAR FLAT")

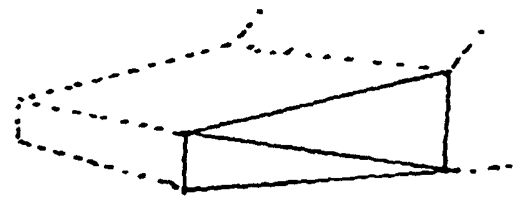

THE FENDER
(2 TRIANGES —
THEY ARE "SCAN"
TRIANGES)

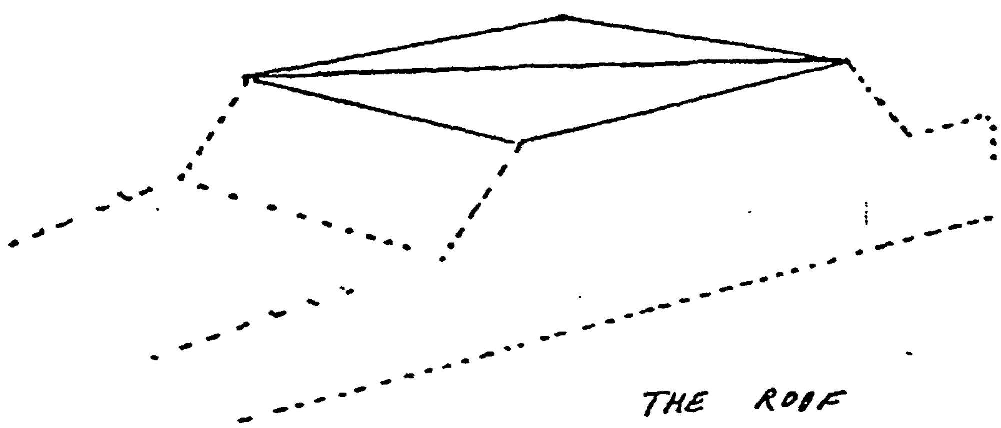

THE ROOF
(2 TRIANGLES —
THEY ARE "FLAT")

ALL THE OTHER TRIANGLES THAT COMPRISE THE CAR MODEL MUST BELONG TO ONE OF THESE TYPES, FLAT, NEAR-FLAT, OR SCAN.

SLICE ORDERS THE TRIANGLES BY TYPE AND HEIGHT

THE FLAT TRIANGLES

HIGHEST

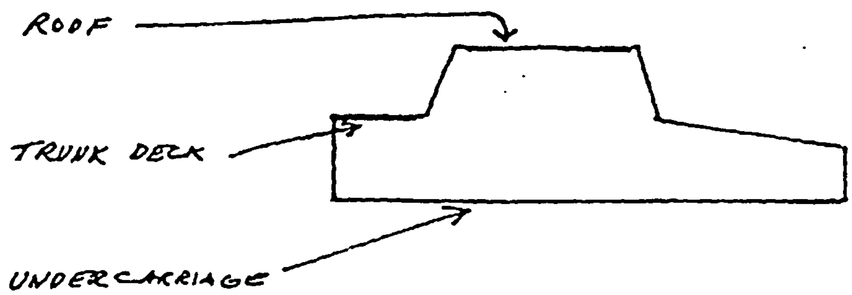


LOWEST

THE NEAR-FLAT TRIANGLES

HIGHEST

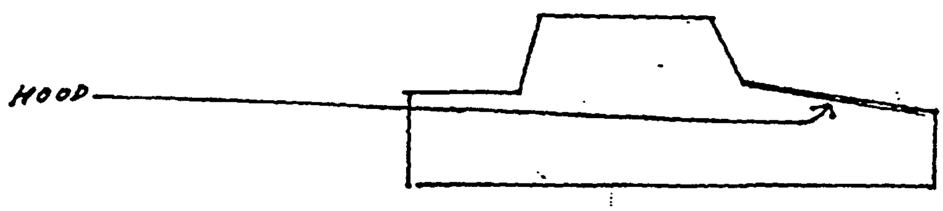


LOWEST

... AND THE SCAN TRIANGLES ARE ORDERED BY THEIR LOWEST CORNER

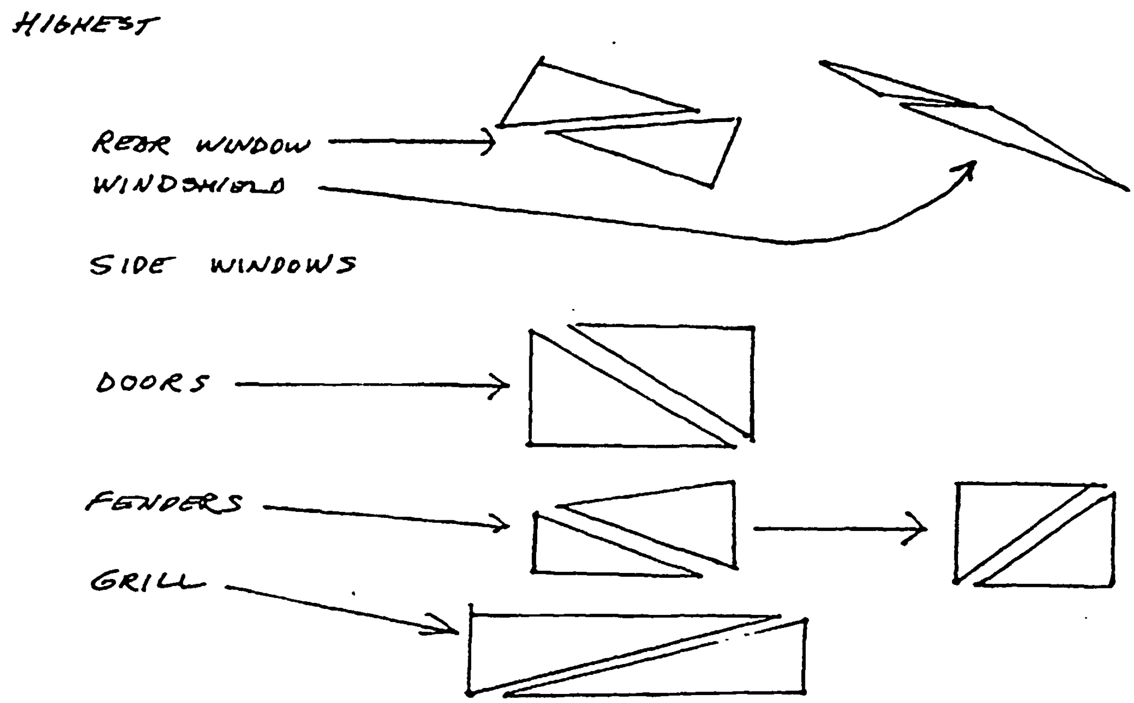


(ACTUALLY, DOORS, FENDERS, AND GRILL TRIANGLES COULD HAVE THE SAME LOWEST CORNER, BUT WE SHOW THEM HERE FOR CLARITY).

LOWEST

NOW, WE WANT TO PROVIDE THE LASER CONTROLLER SO IT CAN MAKE AN OBJECT LIKE THIS . . .

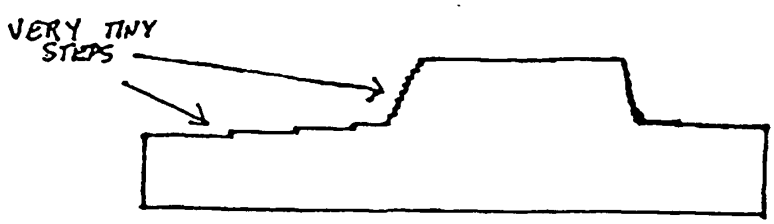


AS IF WE HAD TO SLICE THE CAR AND STACK THE SLICES.

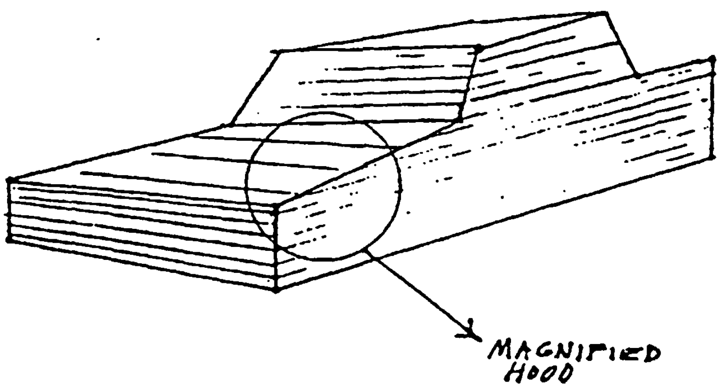


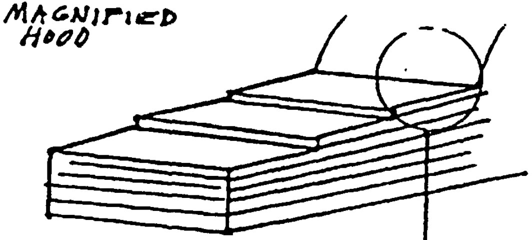

THE NEAR-FLAT TRIANGLES AND FLAT TRIANGLE CAN BE "SKIN-FILLED"

FILLING IS A VERY FINE CROSS HATCHING BY THE LASER TO MAKE THE SURFACE SMOOTH

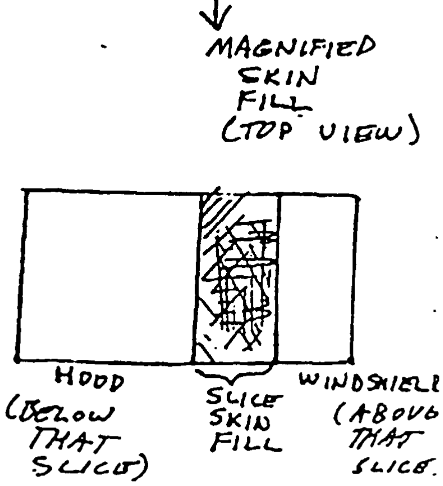

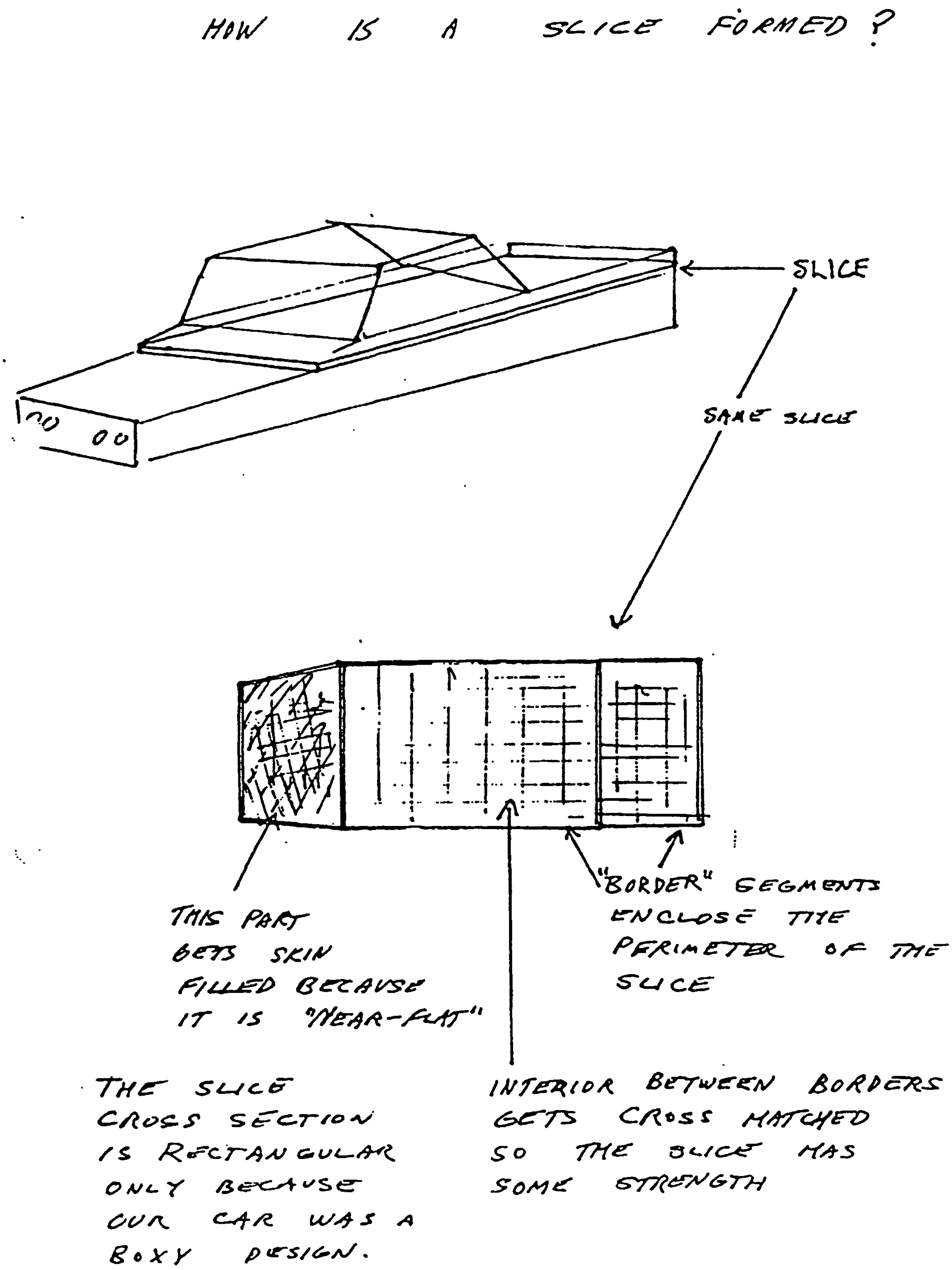
HOW IS A SLICE FORMED?
SLICE
SAME SLICE
THIS PART GETS SKIN FILLED BECAUSE IT IS "NEAR-FLAT"
"BORDER" SEGMENTS ENCLOSE THE PERIMETER OF THE SLICE
THE SLICE CROSS SECTION IS RECTANGULAR ONLY BECAUSE OUR CAR WAS A BOXY DESIGN.
INTERIOR BETWEEN BORDERS GETS CROSS HATCHED SO THE SLICE HAS SOME STRENGTH

FOR THE NEAR-FLAT TRIANGLES SLICE MAKES TRAPEZOIDS:

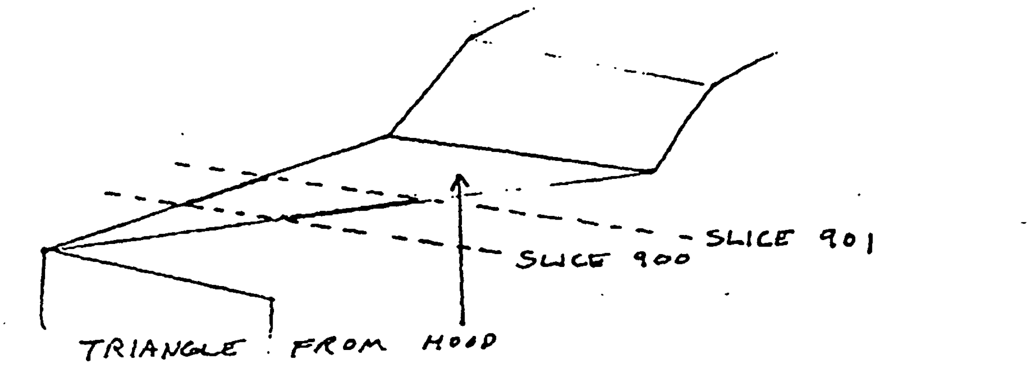


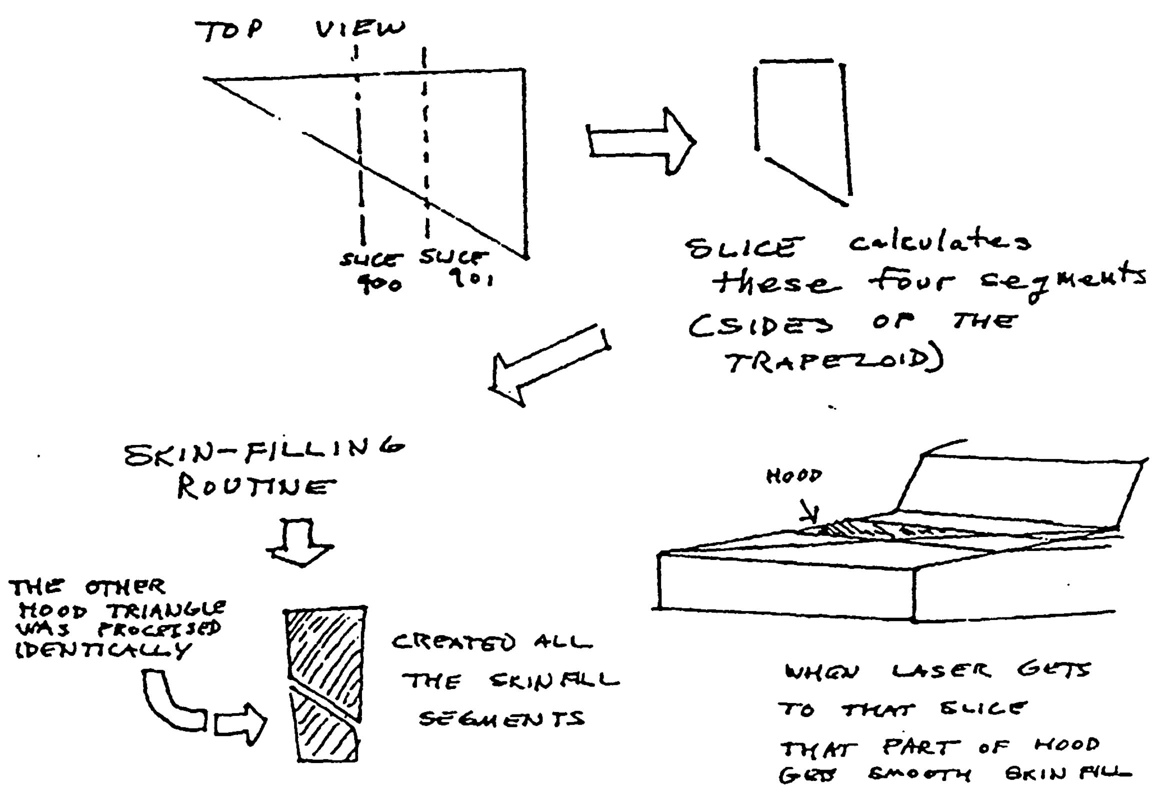

FLAT TRIANGLES ARE CROSS HATCHED AND SKIN FILLED TOO — BUT THERE IS NO NEED TO MAKE TRAPEZOIDS BETWEEN SLICES:

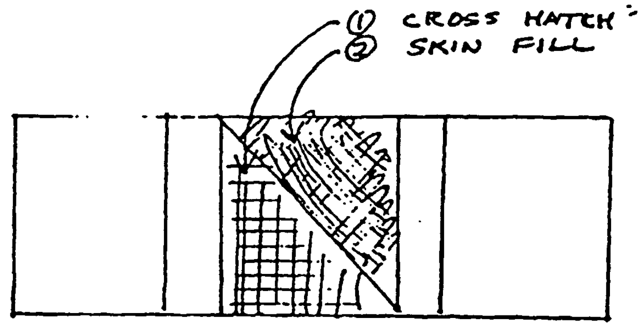


ROOF TRIANGLES (FLAT)

TOP VIEW OF CAR

SCAN TRIANGLES ONLY GENERATE BORDERS: (WHICH ARE THEN CROSS HATCHED) BORDERS ENCLOSE AN AREA THAT IS CROSS HATCHED.

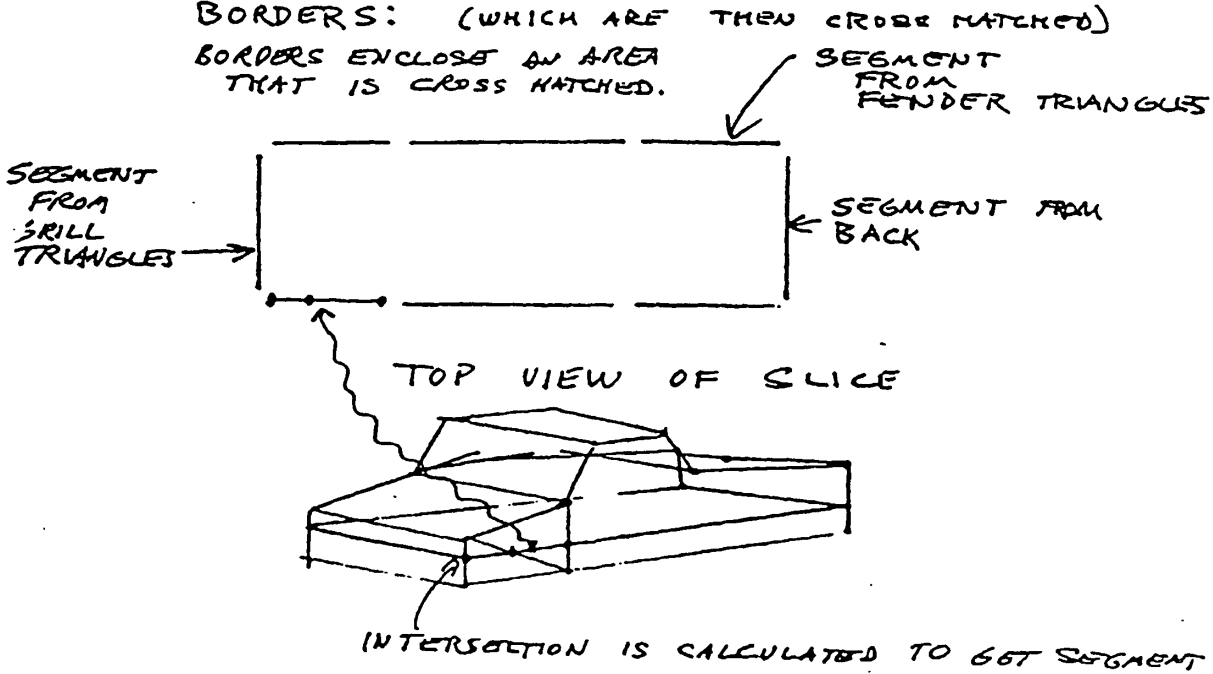

FLAT TRIANGLES ARE CROSS HATCHED AND SKIN FILLED TOO — BUT THERE IS NO NEED TO MAKE TRAPEZOIDS BETWEEN SLICES:

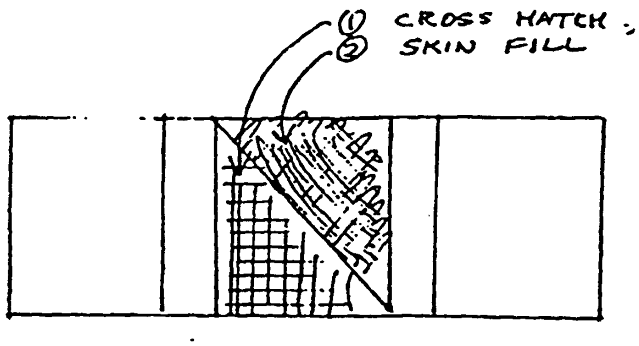


ROOF TRIANGLES (FLAT)

TOP VIEW OF CAR

SCAN TRIANGLES ONLY GENERATE BORDERS: (WHICH ARE THEN CROSS HATCHED)

BORDERS ENCLOSE AN AREA THAT IS CROSS HATCHED.

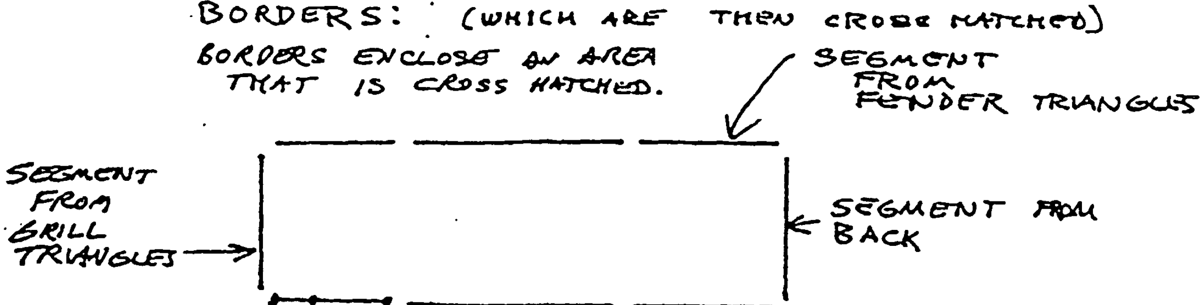


TOP VIEW OF SLICE

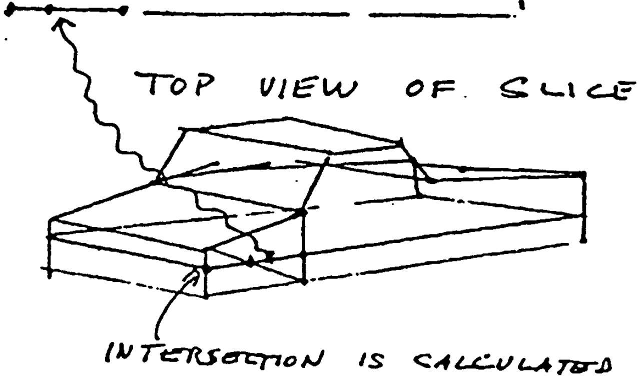

INTERSECTION IS CALCULATED TO GET

APPENDIX D

systems, inc.

# TRAINING MANUAL

# SLA-1

REVISION 3.0

APRIL 1988

TABLE OF CONTENTS


| | | | |
|---|---|---|---|
| | INTRODUCTION | | ii |
| | TRAINING PROGRAM SCHEDULE | | iv |
| 1.0 | OVERVIEW | | |
| | 1.1 | The StereoLithographic Process | 1-2 |
| | 1.2 | StereoLithographic Systems | 1-5 |
| 2.0 | SAFETY | | |
| | 2.1 | Laser Safety | 2-1 |
| | 2.2 | Chemical Safety | 2-5 |
| 3.0 | STEREOLITHOGRAPHY -- FROM START TO FINISH | | |
| | 3.1 | CAD Design | 3.1-1 |
| | 3.2 | Orient & Support | 3.2-1 |
| | 3.3 | CAD Interface | 3.3-1 |
| | 3.4 | Slice Computer | 3.4-1 |
| | 3.5 | Slice | 3.5-1 |
| | 3.6 | Control Computer | 3.6-1 |
| | 3.7 | Utilities | 3.7-1 |
| | 3.8 | Network | 3.8-1 |
| | 3.9 | Merge | 3.9-1 |
| | 3.10 | View | 3.10-1 |
| | 3.11 | Prepare | 3.11-1 |
| | 3.12 | Build | 3.12-1 |
| | 3.13 | Post Process | 3.13-1 |
| | 3.14 | Checklist | 3.14-1 |
| 4.0 | PROBLEM SOLVING TECHNIQUES | | |
| | 4.1 | Limitations of StereoLithography | 4-1 |
| | 4.2 | Part Building Problems and Remedies | 4-2 |
| 5.0 | ADDITIONAL READING | | |
| | 5.1 | Laser Theory | 5.1-1 |
| | 5.2 | The Chemistry of StereoLithography | 5.2-1 |
| | 5.3 | Bullets, Banjotops and Working Curves | 5.3-1 |
| | Glossary | | G.1 |


## INTRODUCTION

### *Purpose and Scope*

This training manual presents information needed to build StereoLithographic parts. It is divided into five sections, each describing a different aspect of StereoLithography.

***Section 1.0*** Provides an overview description of the StereoLithographic process and hardware and software systems.

***Section 2.0*** Discusses laser and chemical safety.

***Section 3.0*** Provides detailed part building information and procedures in thirteen subsections arranged in the same order that parts are built. The subsections are further divided into basic and intermediate chapters, where applicable.

***Section 4.0*** Discusses the limitations of StereoLithography and provides remedies for common part building problems.

***Section 5.0*** Provides background laser, chemistry and working curve information.

A training schedule and glossary of StereoLithographic terms are also provided. These sections are printed on colored paper for quick reference.

The SLA-1 Training Program is a five day course. The first two days intersperse classroom discussion of basic part building procedures with operation of the SLA-1 to build a simple part. The next three days cover intermediate topics, including use of the SLA-1 to build progressively more complex parts. By the end of the week, you should be able to operate the SLA-1 to build a wide variety of parts directly from CAD data.

***Abbreviations***

| | |
|---|---|
| **CAD** | Computer Aided Design |
| **CFM** | Cubic Feet per Minute |
| **DOS** | Disk Operating System |
| **MIA** | Minimum hatch Intersect Angle |
| **MSA** | Minimum Surface Angle for scanned facets |
| **MSDS** | Material Safety Data Sheet |
| **NIOSH** | National Institute for Occupational Safety and Health |
| **PCA** | Post Curing Apparatus . |
| **RHR** | Right-Hand Rule |
| **SLA** | StereoLithography Apparatus |
| **UV** | Ultraviolet |

***Symbols***

| | |
|---|---|
| ^ | space |
| ENTER ↵ | enter key |
| | control/break keys |

***File Type Extensions***

| | | | |
|---|---|---|---|
| **.BAT** | Batch File | **.R** | Range File |
| **.EXE** | Executable File | **.SLI** | Slice File |
| **.L** | Layer File | **.STL** | CAD StereoLithography File |
| **.MAT** | Material File | **.UII** | Slice Options File |
| **.PRM** | Parameter File | **.V** | Vector File |

***Terms***

| | |
|---|---|
| **Part** | combined object and supports |
| **Object** | CAD model (may be a group of detail parts) |
| **Support** | supporting structure on which the object is built |

**TRAINING PROGRAM SCHEDULE**

| | |
|---|---|
| ***Day One*** | Class Introduction<br>Training Schedule<br>Overview<br>Safety<br>***Lab 1 - Building Part 1***<br>StereoLithography - - From Start to Finish<br>CAD Design<br>Orient & Support<br>CAD Interface<br>Slice Computer<br>Slice - Basic<br>***Lab 2 - Slice*** |
| ***Day TWO*** | StereoLithography -- From Start to Finish (Cont'd)<br>**Control Computer**<br>Utilities - Basic<br>***Lab 2 - Utilities***<br>Network - Basic<br>***Lab 2 - Network***<br>Merge<br>***Lab 2 - Merge***<br>Prepare - Basic<br>***Lab 2 - Prepare***<br>Build - Basic<br>***Lab 2 - Build***<br>Post Process<br>***Lab 2 - Post Process***<br>Checklist |
| ***Day Three*** | StereoLithography - - From Start to Finish (Cont'd)<br>Slice - Intermediate<br>***Lab 3 - Slice*** -<br>Utilities - Intermediate<br>***Lab 3 - Utilities***<br>Network<br>***Lab 3 - Network***<br>View<br>***Lab 3 - View***<br>Prepare - intermediate<br>***Lab 3 - Prepare*** |

(continued)

| | |
|---|---|
| | Build - Intermediate<br>***Lab 3 - Build*** |
| ***Day Four*** | Bullets, Banjotops & Working Curves<br>Material Files<br>***Lab 4 - Building Part 4***<br>Group Discussion |
| ***Day Five*** | Problem Solving Techniques<br>Part Building Problems & Remedies<br>Student Part Discussion<br>Installation<br>Customer Support<br>Class Evaluation<br>Closing Remarks |

**SECTION 1.0**

**OVERVIEW**

StereoLithography is a three-dimensional printing process which produces accurate copies of CAD solid or surface models directly from CAD data. The process uses a moving laser beam, directed by computer, to print or draw cross-sections of the model onto the surface of photo-curable liquid plastic. A cross-section is drawn, lowered by an elevator one layer deep into a vat of the liquid plastic, and another cross-section is drawn directly on top of the first. Because of the nature of the liquid plastic, each layer adheres to the last. This process is repeated, layer by layer, to form the three-dimensional StereoLithographic part from the bottom up.
StereoLithography produces models in much less time than conventional tooling methods. Parts that take days, weeks or months to prototype with present methods can be made in a matter of hours with StereoLithography.
StereoLithography can be used in a wide variety of applications, including:

- Design Engineering
  - Automotive
  - Aerospace
  - Commercial
  - Medical
- Manufacturing Engineering
- Architectural Design
- Scientific Uses

**1.1 THE STEREOLITHOGRAPHIC PROCESS**

The StereoLithographic Process is composed of nine major steps performed on three hardware systems.

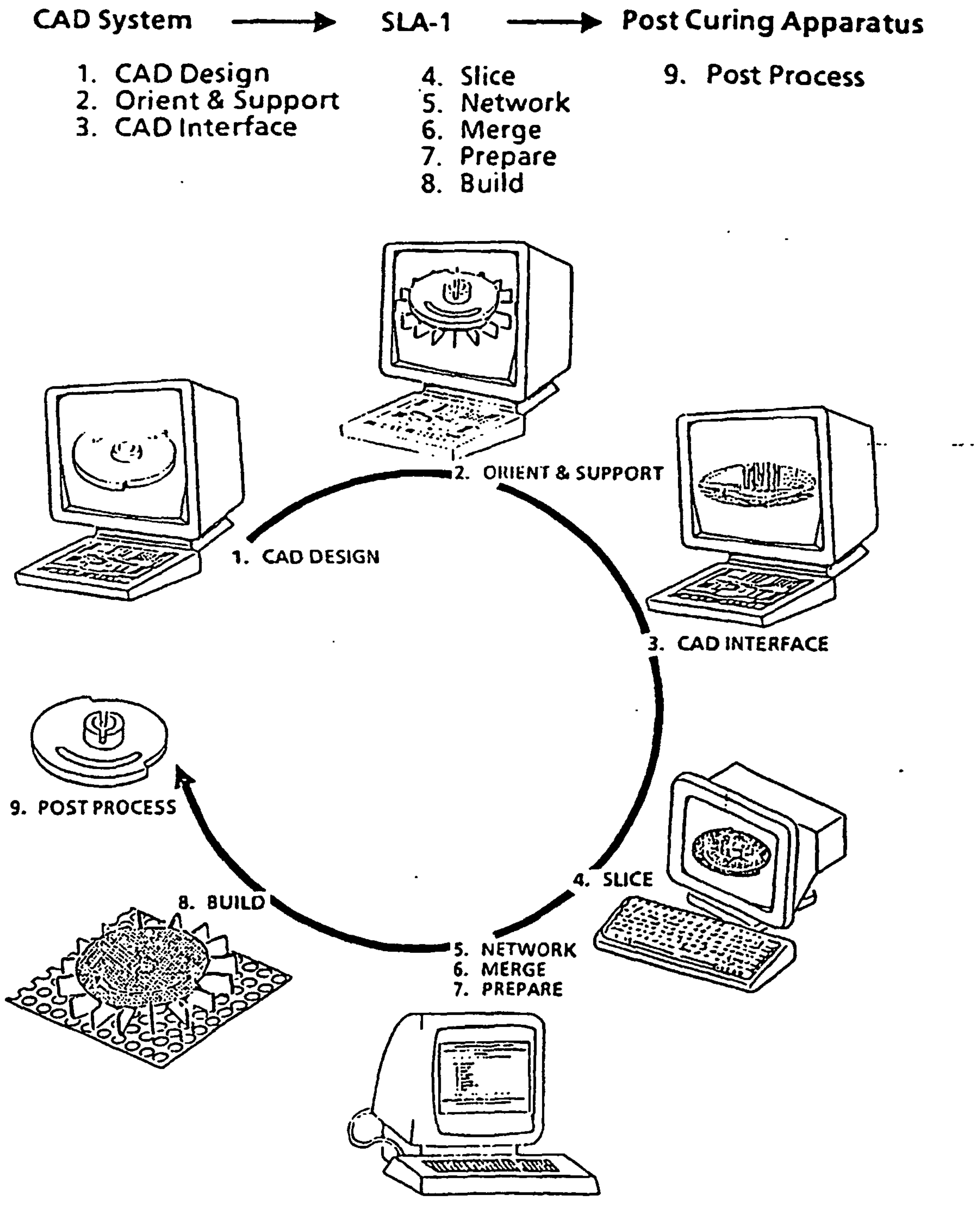


*The StereoLithographic Process*

***CAD System***

***CAD Design (Step 1)***

The part is designed as a solid or surface model on the CAD system without specific reference to Stereo-Lithography.

*Orient & Support (Step 2)*

The CAD model is oriented in 3D space (within the CAD system) for StereoLithography. A base, or support, is designed to attach and support the part while it is being built.

*CAD Interface (Step 3)*

The CAD model is processed through an interface to generate files formatted for Stereolithography. These . STL files are generic representations of all surfaces in the CAD design. The interfaces are supplied by CAD vendors.

*StereoLithography Apparatus*

*Slice (Step 4)*

The StereoLithography (.STL) files representing three-dimensional objects are cross-sectioned on the Slice Computer to create layers of user defined thickness.

*Network (Step 5)*

The sliced files are transmitted from the Slice Computer to the Control Computer via Ethernet or floppy disk.

*Merge (Step 6)*

The sliced files for a part (i.e., all files for the supports and the part itself) are combined and reformatted to drive the SLA-1.

*Prepare (Step 7)*

Part-building parameters are specified by the user as required by the part's geometry and end use.

*Build (Step 8)*

The part is built one layer at a time by moving a focused laser beam across the surface of photo-curable resin, solidifying the liquid where it strikes.

The first (lowest) layer adheres to a horizontal platform located just below the surface of the resin. The platform is attached to an elevator which then lowers it under computer control. After drawing a layer, the platform dips into the liquid, leaving a thin film from which the second layer will be formed. The next layer is drawn after a pause to allow the liquid surface to level. Since the resin has adhesive properties, the second layer becomes firmly attached to the first.

This process is repeated until all layers have been drawn to form the three-dimensional object. Resin that has not been exposed to the laser beam remains in the vat to be used for the next part. There is very little waste of material.

*Post Curing Apparatus*

*Post Process (Step 9)*

The part is drained to remove excess resin, ultraviolet cured to complete the polymerization process, and supports are removed. Optional finishing, such as sanding, assembly into working models and painting, may also be performed.

1.2 STEREOLITHOGRAPHIC SYSTEMS

- StereoLithography Apparatus
- Post Curing Apparatus

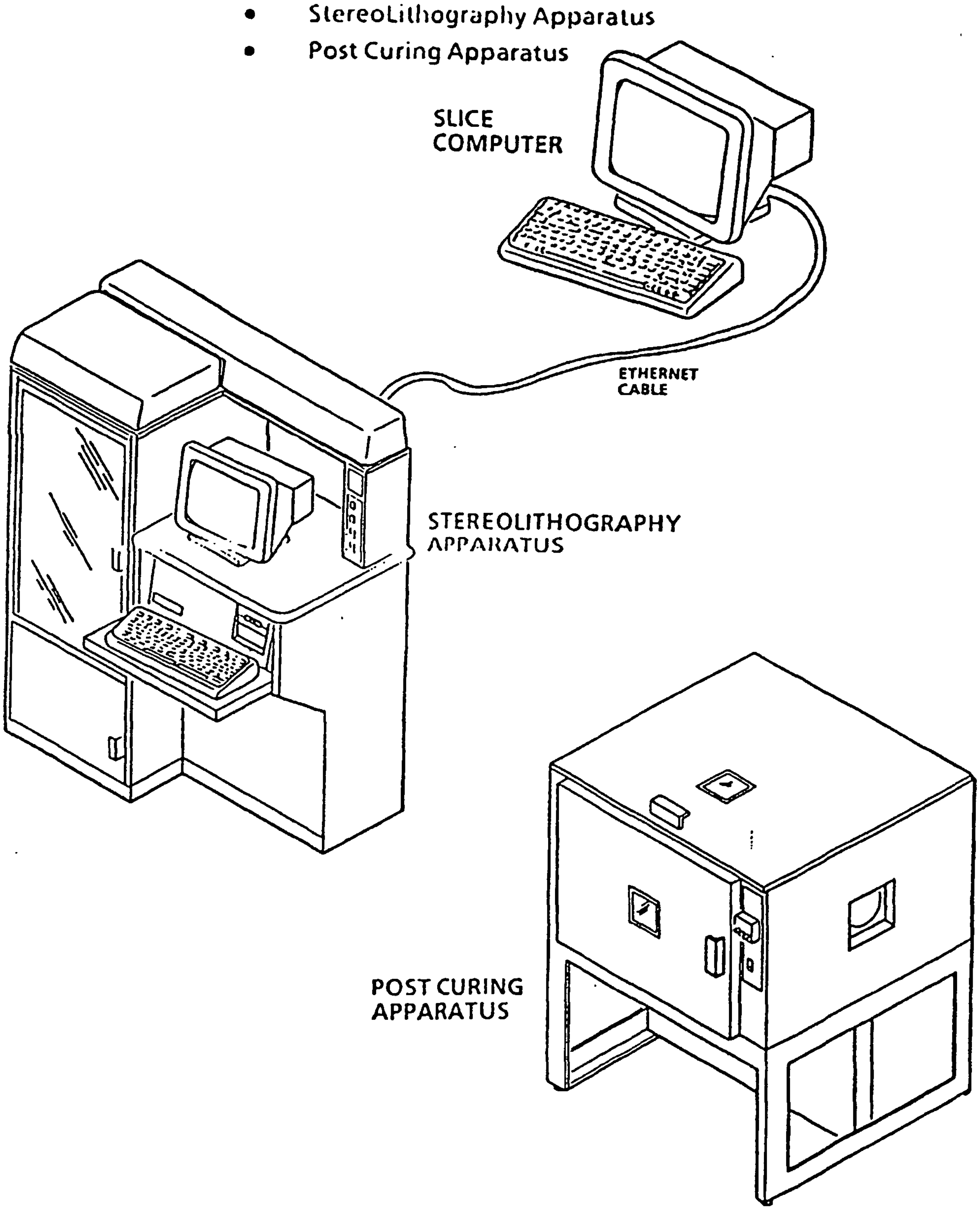


*The SLA-1 and Post Curing Apparatus*

***StereoLithography Apparatus***

The major components of the SLA-1 are:

- Control Computer
- Laser and Optical System
- Process Chamber
- Control Panel
- Slice Computer

***Control Computer***

All StereoLithography process steps from Network through Build are run on the Control Computer. Programs and operating parameters are selected from menus for ease of operation.

- MSDOS based 286 Computer (single-user, single task)
- Monochrome Terminal
- 40 Megabyte Hard Disk
- 36 to 38 Megabytes Available Disk Space
- Ethernet Interface

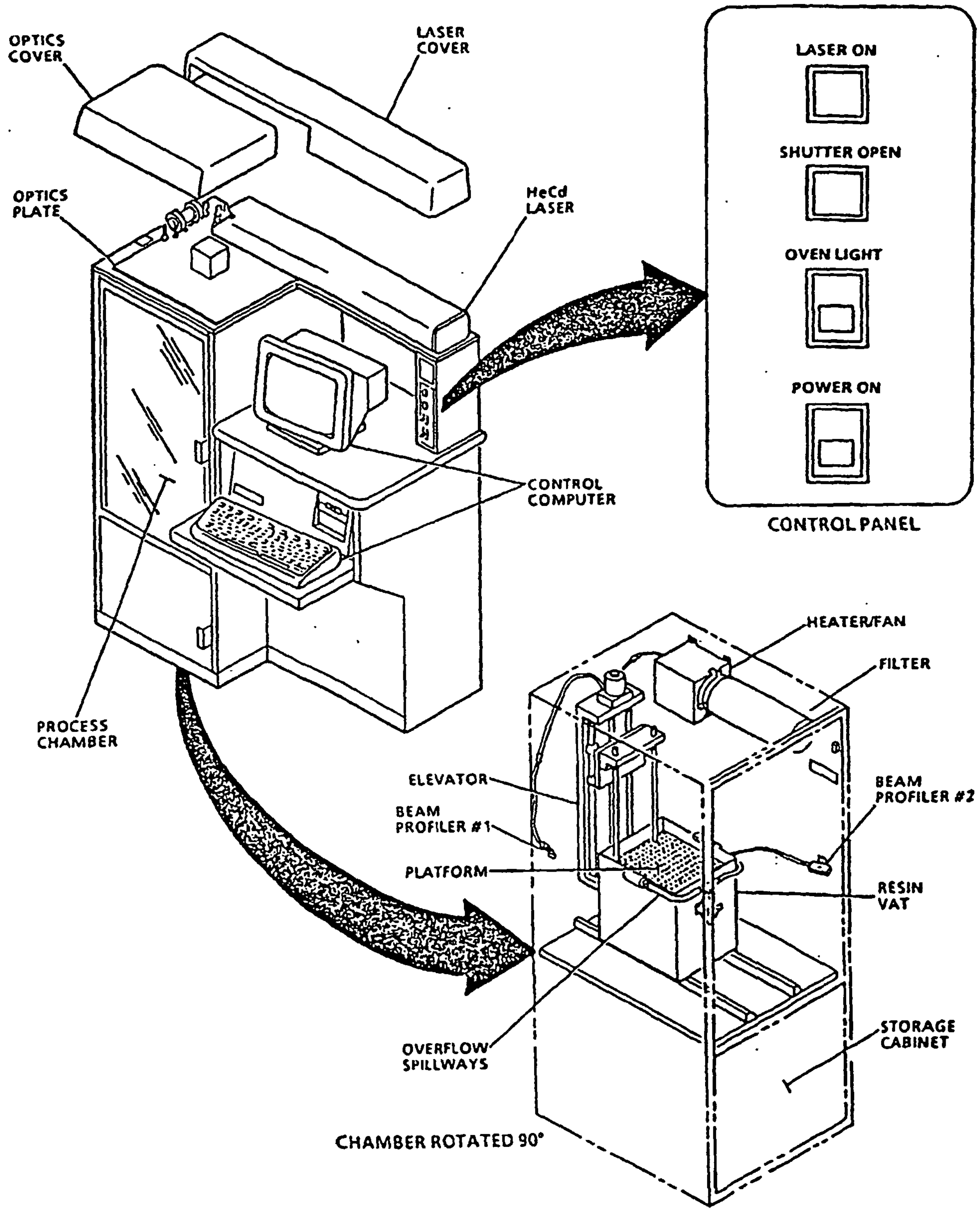


*Major Components of the SLA-1*

***Laser and Optical System***

The SLA-1 laser and optical system is mounted directly over the process chamber. These components generate and direct the laser beam under computer control onto the surface of the liquid resin.

The SLA-1 uses a helium-cadmium (HeCd), multimode ultraviolet laser. The laser beam power varies, and is nominally 15 milliwatts at a wavelength of 325 nanometers.

As shown below, the SLA-1 optical system is composed of a shutter assembly, two 90-degree beam-turning mirrors, a beam expander, and X-Y dynamic mirrors mounted on an optics plate. A 2-inch diameter precision optical window allows the laser beam to enter the process chamber while isolating optical components from the chamber environment.

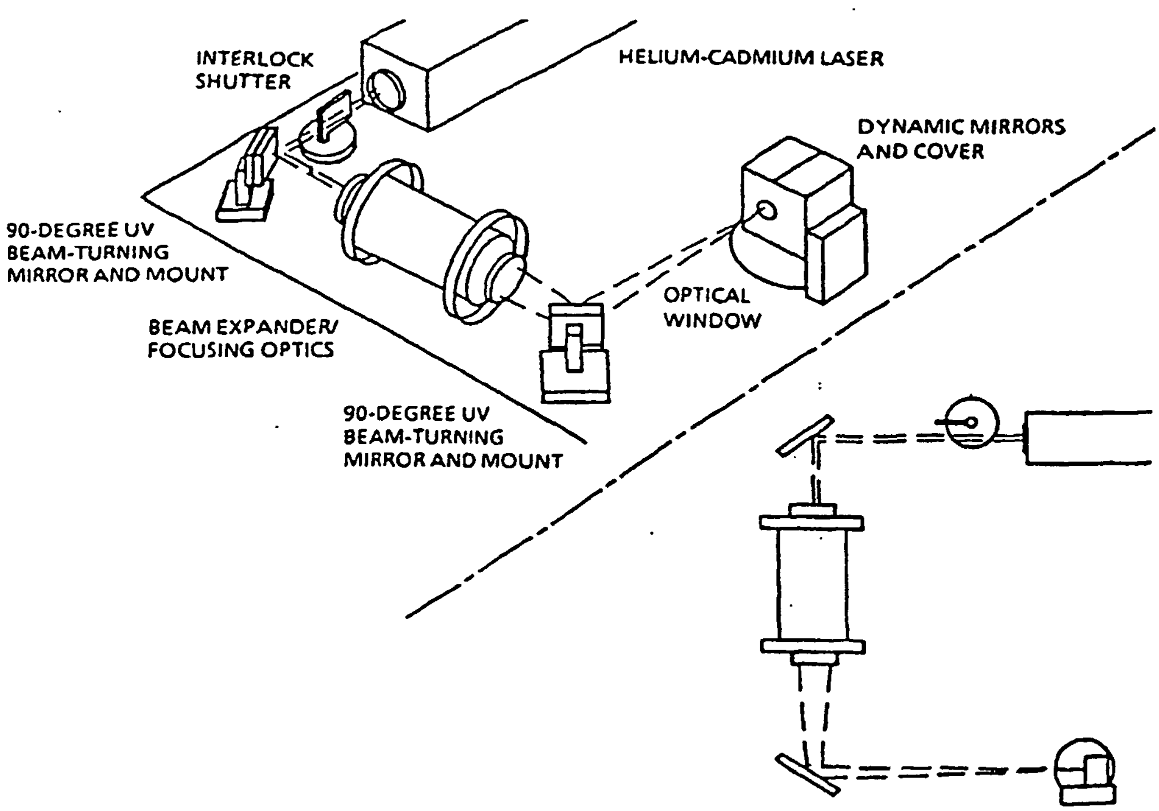


*The SLA-1 Laser and Optical System*

The solenoid-artuated shutter operates to block the laser beam when an interlock switch is activated. Interlock switches monitor removal of the laser and optics covers and opening of the process chamber door.

The 90-degree beam-turning mirrors are specially coated for high reflectivity at 325 nanometers while transmitting most other wavelengths. The first turning mirror reflects the beam from the laser to the inlet aperture of the beam expander. The second mirror reflects the laser beam from the outlet beam expander aperture to the dynamic mirrors.

Unmodified laser beams diverge slightly over distance. A highly focused beam is desired for StereoLithography because it has higher power density and can therefore cure plastic at a greater depth or at a faster rate. The beam expander expands the divergent laser beam to four times its inlet diameter, then focuses it so that the beam converges to a small spot on the surface of the resin.

The high-speed dynamic mirrors deflect the laser beam under computer control to trace vectors on the surface of the resin. Like the beam-turning mirrors, the dynamic mirrors are highly reflective at 325 nanometers and transmit most other wavelengths.

***Process Chamber***

The environmentally-controlled process chamber houses an elevator and platform, resin vat and beam profilers. This is where StereoLithographic parts are created.

The chamber is designed for operator safety and to ensure uniform operating conditions. Air is circulated and filtered through active charcoal. An overhead light illuminates the resin vat and work surfaces. An interlock on the access door activates a shutter to block the laser beam when the door is opened. The clear acrylic door blocks ultraviolet light for safe viewing by operators.

The elevator raises and lowers the part under computer control. The platform supports the part while it is being built.

The resin vat is 9 inches in every dimension. It is installed in the chamber on guides which align it with the elevator and platform. An overflow system channels excess resin to a removable container to maintain a constant liquid level.

Two beam profilers are mounted in the process chamber, one on either side of the resin vat. The beam profilers measure laser power and intensity under computer control.

***Control Panel***

The SLA-1 control panel includes:

| | |
|---|---|
| ***POWER ON switch*** | switches primary power to the laser, power supplies, process chamber and control computer. |
| ***OVEN LIGHT switch*** | turns the overhead light in the process chamber on and off. |
| ***LASER ON indicator*** | indicates that the laser is on when lit. |
| ***SHUTTER ON indicator*** | indicates that the shutter is open when lit. |

***Slice Computer***

The Slice Computer is used to cross-section .STL files to create .SLI files.

- UNIX based 386 Computer (multi-user, multi-task)
- Monochrome Terminal
- 70 Megabyte Hard Disk
- _ Megabyte Available Disk Space
- Ethernet Interface

***Post Curing Apparatus***

The Post Curing Apparatus (PCA) is used to cure parts produced by the SLA-1. This is done by exposing parts to ultraviolet radiation in an enclosed, vented chamber. The PCA can hold parts measuring 12 inches in every dimension. Its major components include:

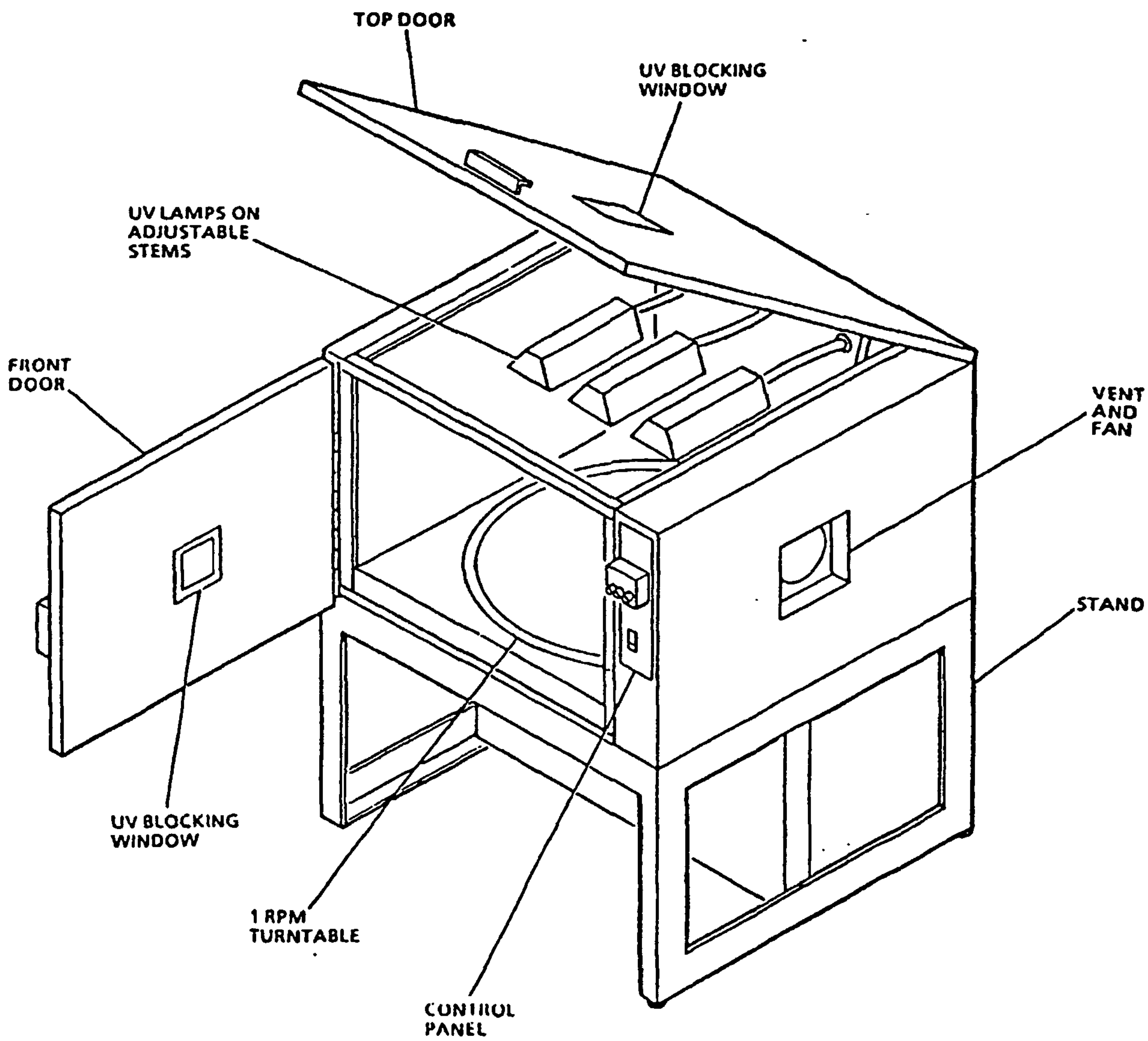


- three 400 Watt metal-halide UV lamps, with reflectors, which can be positioned in the chamber for optimum curing. The lamps have a rated service life of 750 hours.
- a one revolution per minute turntable which rotates the part for uniform curing.
- two doors, one at the front and one at the top, for loading and unloading parts. Both doors are interlocked to turn off the UV lamps and turntable when they are opened, and have UV blocking windows to allow safe viewing of the parts.
- a 240 CFM (Cubic Feet per Minute) cooling and vent fan.
- a control panel with power switch and timer.

**SECTION 2.0**

**SAFETY**

**2.1 LASER SAFETY**

***Safety Features***

The SLA-1 is designed as a Class 1 Laser Device, which means that in normal operation the laser beam is completely confined. Other SLA-1 laser safety features include:

- Interlocks on the laser and optics covers and process chamber door which actuate a shutter to block the laser beam when the interlock circuit is activated.
- Control panel lamps which indicate whether the laser is on and whether or not an interlock circuit is activated.

***Warning and Safety Information Labels***

The following laser safety labels are affixed to the SLA-1. Their locations are shown in the following figure.

***ID/Certification Labels***

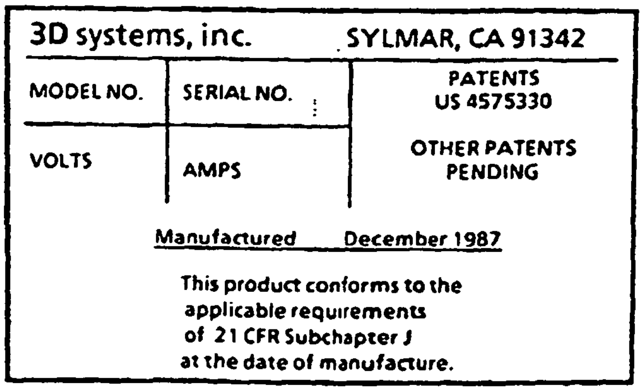


Two ID/certification labels certify conformance to CFR laser safety requirements and provide power and identification data.

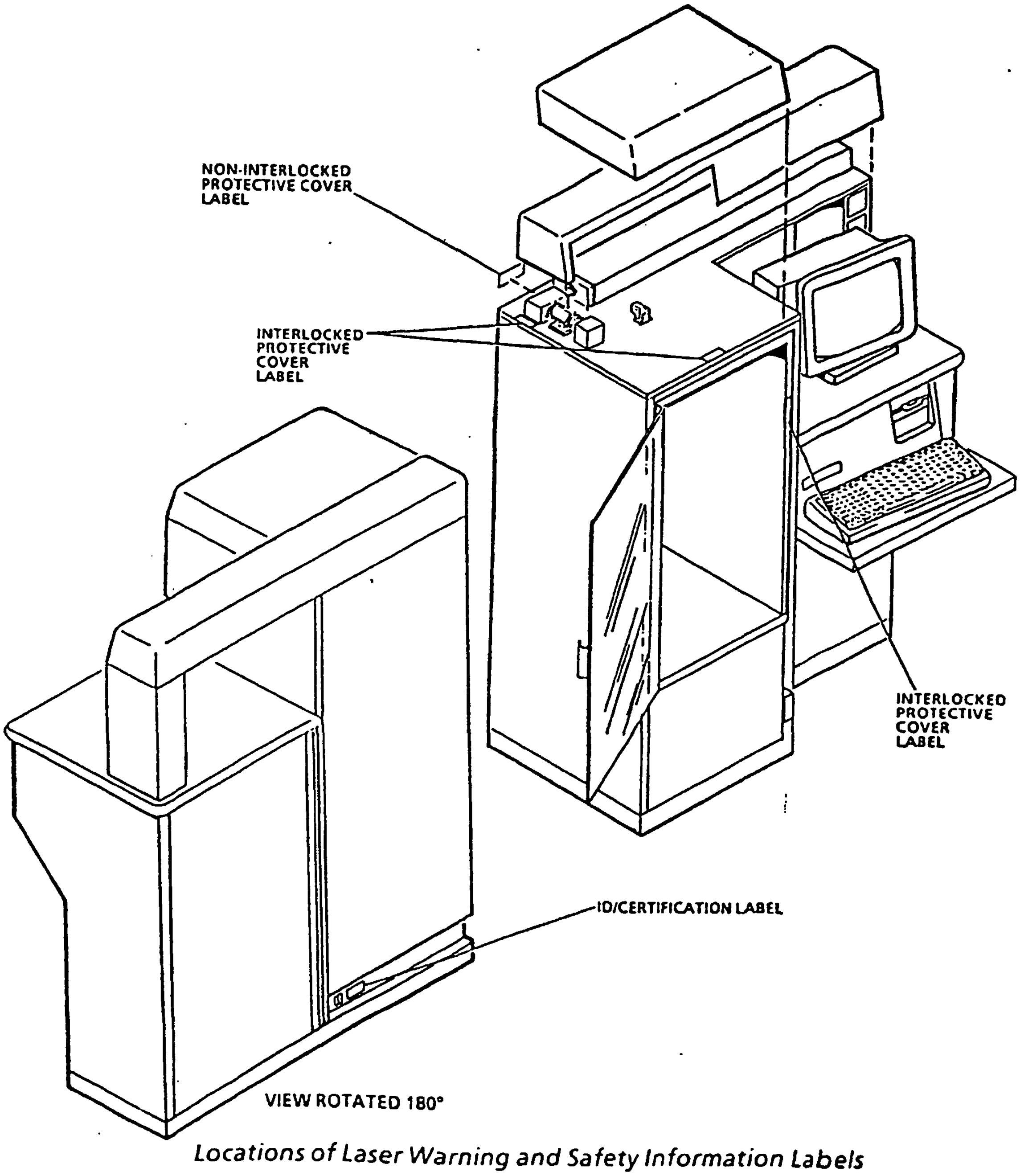


*Locations of Laser Warning and Safety Information Labels*

*Interlocked Protective Cover Labels*

**DANGER**

**Invisible laser radiation when open and interlock defeated.**

AVOID DIRECT EXPOSURE TO BEAM

Three interlocked protective cover labels are affixed near the three interlock switches. The labels conform to the requirements for Defeatable Interlocks, Class IIIb.

***Non-Interlocked Protective Cover Label***

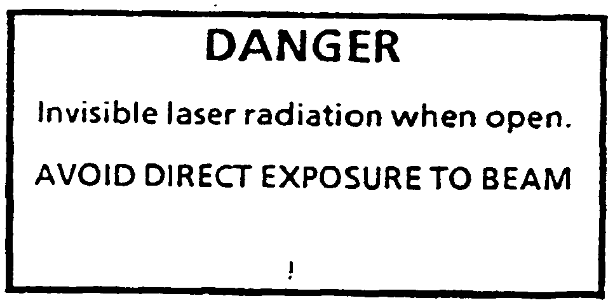


One non-interlocked protective cover label is affixed to the shutter protective housing so as to be visible when the laser cover is removed. The label conforms to the requirements for Non-Interlocked, Class IIIb.

*Safety Precautions*

| |
|---|
| **WARNING** |
| **LASER SAFETY PRECAUTIONS** |

USE OF CONTROLS OR ADJUSTMENTS, OR PERFORMANCE OF PROCEDURES OTHER THAN THOSE SPECIFIED HEREIN, MAY RESULT IN HAZARDOUS INVISIBLE LASER RADIATION EXPOSURE.

DURING NORMAL USE AND MAINTENANCE OF THE SLA-1, NO LASER RADIATION IS ACCESSIBLE TO THE USER. HOWEVER, IF THE INTERLOCKS ARE DEFEATED FOR ANY REASON (INCLUDING PERFORMANCE OF SERVICE PROCEDURES COVERED IN THE SLA-1 SERVICE MANUAL), HELIUM CADMIUM LASER POWER UP TO 100 mW AT 325 nm COULD BE ACCESSIBLE.

IF THE INTERLOCKS ARE DEFEATED FOR PERFORMANCE OF SERVICE PROCEDURES EXPLAINED IN THE SLA-1 SERVICE MANUAL, WEAR UV BLOCKING SAFETY GLASSES AND AVOID DIRECT EXPOSURE TO THE LASER BEAM.

NEVER STARE DIRECTLY INTO THE LASER BEAM OR INTO A REFLECTION FROM A MIRROR-LIKE SURFACE.

**2.2 CHEMICAL SAFETY**

*Safety Guidelines*

The photopolymers used in StereoLithography may contain multi-functional acrylates which can be hazardous if handled improperly. Personnel working with chemicals should obtain and consult guidelines in the MSDS (Material Safety Data Sheet). Safety guidelines for the Desolite SLR 800 resin are summarized below.

**WARNING**

**CHEMICAL HAZARDS**

**UV CURABLE RESINS MAY CAUSE EYE AND SKIN BURNS. REPEATED OR PROLONGED SKIN CONTACT MAY CAUSE SENSITIZATION. RESIN VAPOR MAY BE HARMFUL.**

- Wear safety glasses with side shields when handling resins.
- Wear chemically resistant gloves and protective clothing when handling resins. Wash thoroughly after handling and before eating, smoking or using toilet facilities.
- Use only with adequate ventilation. Avoid breathing vapors or spray mist.
- Keep away from heat, sparks and flame. Protect from sunlight and fluorescent light. Closed containers may rupture or explode when exposed to extreme heat. Use National Fire Protection Association Class B Extinguishers (carbon dioxide, dry chemical or foam).
- Wear an NIOSH approved respirator or ensure adequate ventilation when sanding and cutting cured parts.
- Dispose of chemicals properly. Do not reuse empty containers.

***First Aid Guidelines***

***Skin Contact*** Wash thoroughly with soap and water. Remove contaminated clothing and shoes immediately. If skin is irritated, get medical attention. Wash clothing before reuse. Discard contaminated leather shoes or other apparel.

***Eye Contact*** Flush immediately with large amounts of water for 15 minutes and avoid sunlight, fluorescent light and other UV light. Get medical attention.

***Inhalation*** Remove victim to fresh air. Give artificial respiration or CPR as required. If breathing is difficult, give oxygen. Get medical attention.

**SECTION 3.0**

**STEREOLITHOGRAPHY -- FROM START TO FINISH**

This section is divided into thirteen subsections covering in detail the process for making a StereoLithographic part. Each subsection includes a basic chapter introducing beginning commands and procedures and, in some subsections, an intermediate chapter with procedures for building more complex parts.

| | | | |
|---|---|---|---|
| 3.1 | CAD Design | 3.8 | Network |
| 3.2 | Orient & Support | 3.9 | Merge |
| 3.3 | CAD Interface | 3.10 | View |
| 3.4 | Slice Computer | 3.11 | Prepare |
| 3.5 | Slice | 3.12 | Build |
| 3.6 | Control Computer | 3.13 | Post Process |

(continued)

| | | | |
|---|---|---|---|
| 3.7 | Utilities | | |

The same part is used as an example in the basic chapters of each subsection. Students will build this part, shown below, during the first two days of training, and then study the intermediate topics and build more complex parts. A checklist for making parts is provided at the back of this section.

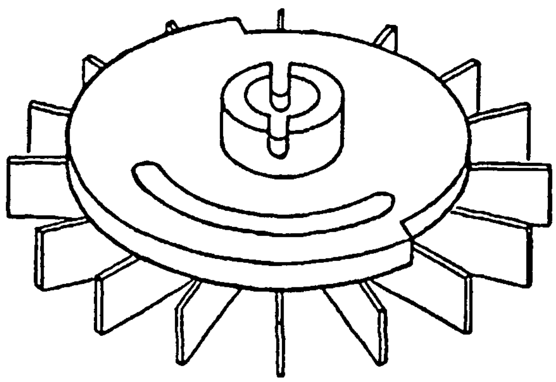

**3.1 CAD DESIGN**

***Surfaces***

The object must be represented as closed surfaces which unambiguously define an enclosed volume. That is, model data must specify what is inside the solid material of the object and what is not. This is required so that all horizontal cross-sections consist of closed curves which completely separate the inside and outside of the object.

***CAD Resolution***

When generating objects with curved surfaces (e.g., spheres, cylinders), keep in mind that curved surfaces are approximated by a large number of polygons or facets. The larger the number, the more closely the surface is approximated, resulting in a smoother curve on the finished part. However, a larger number of polygons or facets also increases the slicing time and resultant file size. As a rule, use the lowest acceptable resolution.

***Wall Thickness***

The minimum recommended wall thickness for curved objects is 0.020 inch. Walls thinner than 0.020 inch are achievable only under special circumstances. The absolute minimum wall thickness is twice the width of the laser beam.

**3.2 ORIENT & SUPPORT**

***Orienting CAD Models***

A CAD part must reside entirely in the positive X Y Z quadrant for Stereo-Lithography. It should then be oriented to:

- **minimize the distance between the part and the CAD origin.**
- **minimize the height of the support structure.** The part should be at least 0.25 inch above the platform for efficient draining. However, supports that are too tall take longer to build and may distort as the weight of the part increases while it is being built.
- **minimize the height of the object.** This reduces the number of layers to be built, thereby reducing the run time.

- **optimize part draining.**
- **minimize the number of slanted or sloping surfaces.** These surfaces are constructed of overlapping layers so that the surface has a "stair-step" appearance, with the thickness of each layer being the height of the step.
- **ensure that smooth or aesthetically important surfaces are either oriented vertically or upward-facing and horizontal.** (Vertical and upward-facing horizontal surfaces are smoother than downward-facing surfaces.)
- **minimize the volume of liquid entrapped as the part is built.** Entrapped liquid slows the part building process by requiring more time for the liquid resin to settle and level to a uniform height after the part is dipped.
- **Ensure that important circular cross-sections are drawn in the X-Y plane.** Higher resolution can be achieved in the X-Y plane.
- **Ensure that the part fits in the resin vat.** If the part is too large, it may be sectioned, built in several runs, then reassembled during post processing.

The importance of each of these factors is determined by your objectives in making the part.

***Supports***

Stereolithographic objects are built on supports rather than directly on the elevator platform. The main reasons for using supports are to:

- **separate the object from the platform.** This ensures that:
  - -- they are easily separated during post processing.
  - -- the first object layer is of uniform thickness, even if the platform is warped or improperly installed.
  - -- resin can drain quickly through the platform. This reduces the time required to build the part, since the surface of the resin levels faster after the part is dipped. Additionally, excess resin drains faster from the completed part to reduce post processing time.
- **anchor the part firmly to the platform or other part sections.**
- **prevent curling or damage during dipping.**

***Common Types of Supports***

| | |
|---|---|
| ***Straight Webs*** | are very thin rectangles or fins, generally less than 0.002 inch thick. Straight web supports must be defined by a volume, not single surfaces. |
| ***Cross Webs*** | are made from two straight webs which intersect at right angles. Cross web supports are stronger than straight webs. |
| ***Circular Webs*** | are hollow tubes strongly bonded to the object. Circular webs can support more weight than straight and cross web supports. However, they require more triangles, and thus use more memory. |
| ***Triangular Webs*** | are composed of three straight webs to form a triangle. These supports may be used in conjunction with straight webs which intersect the vertices. Triangular web supports are stronger than all other types of web supports. |

***Example 1***

Near the bottom of the solid sphere, layer border vectors consist of circles whose diameters increase rapidly with each successive layer. Until other vectors are drawn, many of the layer borders would float freely on the surface of the liquid. Air currents or convection currents in the liquid could cause them to drift out of position.

Adding supports which extend to the equator of the sphere, as shown, would solve this problem. Note that above the equator the layer borders are formed directly on the crosshatch vectors of the previous layer, and as such are firmly anchored without the need for further support.

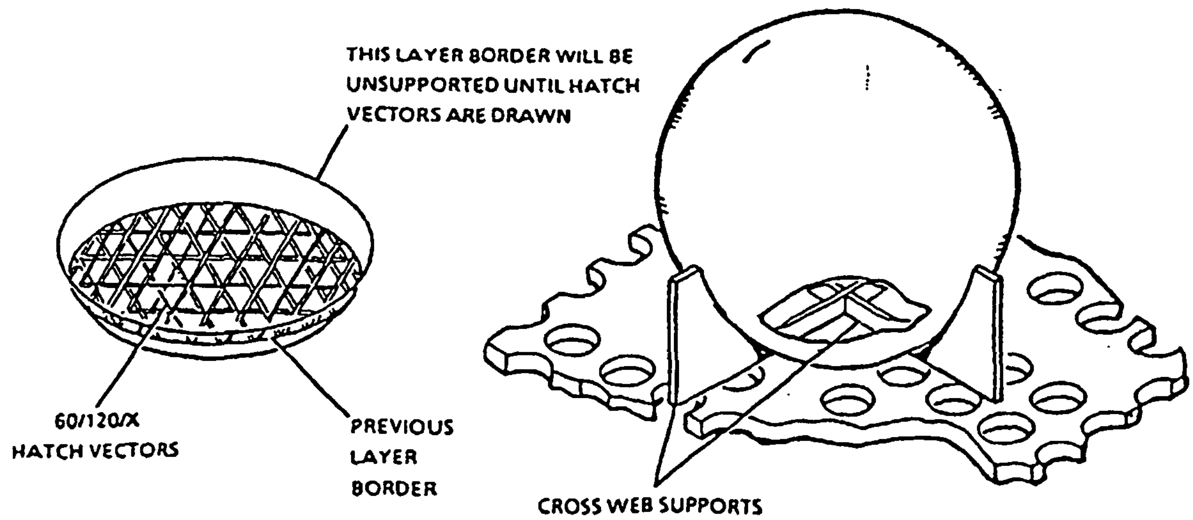


*Supports anchor layer borders in place until crosshatch vectors are drawn*

***Example 2***

The first layer of the cantilevered beam may be permanently deformed by static resistance of the liquid when the part is dipped. In addition, the layer could curl upward when the next layer is formed. Both of these problems are solved by adding supports.

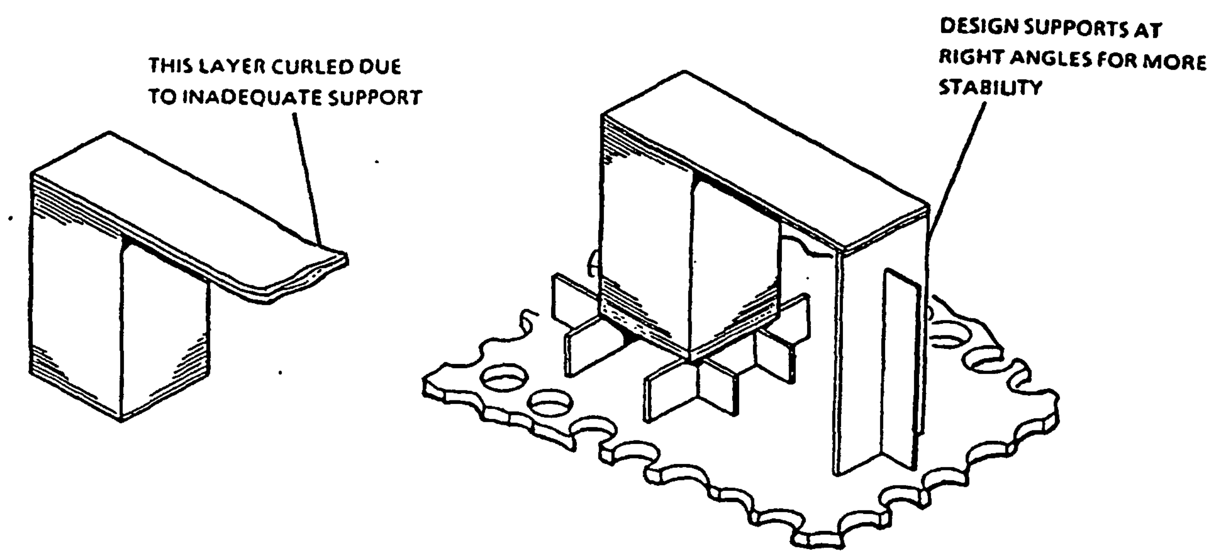


*Supports prevent deformation and curl of cantilevered beams and similar structures*

***Example 3***

The first layer of the teacup handle would be completely unattached when formed and would drift when the part is dipped. The support provides a surface, anchored to the elevator platform or to the body of the teacup, on which the handle can be built.

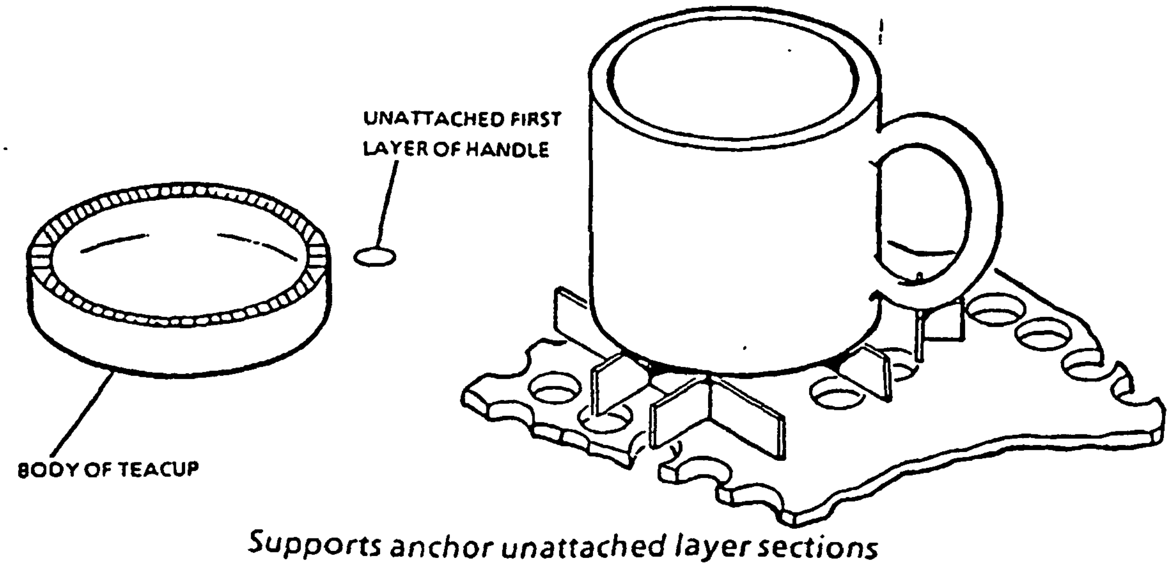


Supports anchor unattached layer sections

***Building Supports***

NOTES:

- Supports must be completely contained in positive CAD space.
- Bottom supports should overlap the bottom layers of the object by approximately 0.040 to 0.060 inch (typically 2 to 3 layers). This ensures a strong bond between the supports and object.
- Side supports should also overlap the object to provide a stronger support structure.

Generally, supports are designed together as a single CAD file separate from the object file. They are positioned relative to the object after it is designed and oriented for StereoLithography. (The object and support files are merged and drawn as a single file later in the StereoLithographic process.) A library of supports resident on the CAD system could reduce the need for designing unique supports for each object. In any case, supports should be designed and attached to the object in accordance with the following guidelines.

***Placement*** Supports should be located as needed to provide a rigid foundation on which the object can be built. This includes supporting corners and edges. Supports should also be added to anchor or strengthen other surfaces, as discussed in the preceding examples.
If possible, avoid placing supports on surfaces that for aesthetic or functional reasons need to be smooth. After the part is post-cured and the supports are removed, ridges will normally remain on the surface of the part. (The ridges can, however, be cut and sanded or ground away.) Supports can be attached to a strong section of the object, as well as to the elevator platform.

***Spacing*** Supports typically are spaced 0.1 to 0.8 inch apart In general terms, space supports at sufficiently close intervals so that no appreciable sag or curl occurs; however, drawing too many supports will slow the part building process.

***Orientation*** Use cross web supports to prevent layer skewing. If straight web supports for a part are aligned parallel to one another, as shown below, the weight of the part could cause the webs to sag sideways while the part is being built. Subsequent layers would then be offset slightly (skewed) with respect to the previous layers.

***Height*** Hold parts at least 0.25 inch above the elevator platform to ensure optimum liquid draining and leveling. To inhibit bending or sagging and to minimize drawing time, supports should be no taller than required. If a tall support is needed, a cross, circular or triangular web should be used for additional strength.

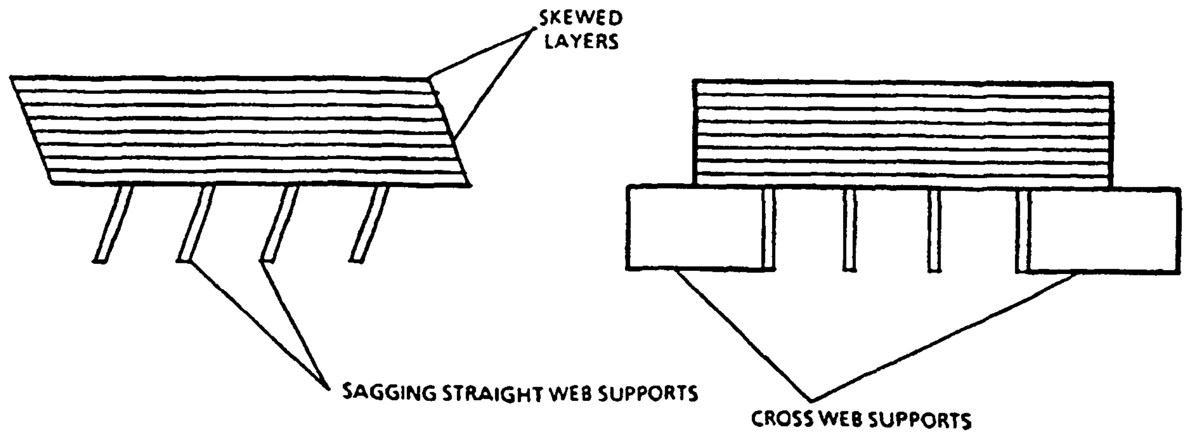


Cross web supports prevent layer skewing

***Width*** Supports must be at least 0.65 inch wide where they contact the platform or they may droop or fall through the platform drain holes. However, to minimize drawing time, supports should be only as wide as necessary. Diagonal supports beginning and ending on the part should be designed as buttresses, as shown below, and should not extend into the corner of the part where they will be hard to remove.

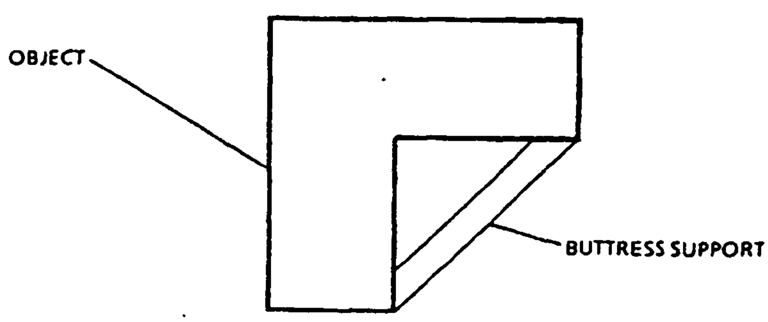


Diagonal supports should not extend into interior corners from which they will be difficult to remove

***Thickness*** Supports should be designed with minimum thickness (web supports should be 1 mil thick). Since the thickness of lines drawn with the laser is usually 10 to 20 mils, the actual support will be considerably thicker than the CAD design. Supports designed as single surfaces with no CAD volume are not allowed.

***Attachment*** To ensure that the object attaches securely to the supports, design supports to overlap the object vertically by 0.040 to 0.060 inch (typically 2 to 3 layers).

### 3.3 CAD INTERFACE

#### *Tessellation Theory*

Many CAD and solid modeling systems represent surfaces of parts as a set of triangles. Triangles are the simplest polygon for computations and, if enough are used, can closely approximate all surfaces.

The easiest geometric shape to represent, other than a triangle, is a rectangle. The most difficult is a curve. As shown below, a rectangle can be created by two back-to-back triangles. Curved surfaces, on the other hand, can be closely approximated only by a large number of triangles. The SLA-1 can process up to 14,000 triangles per Stereolithography (.STL) file to produce very accurate circles and other curved surfaces.

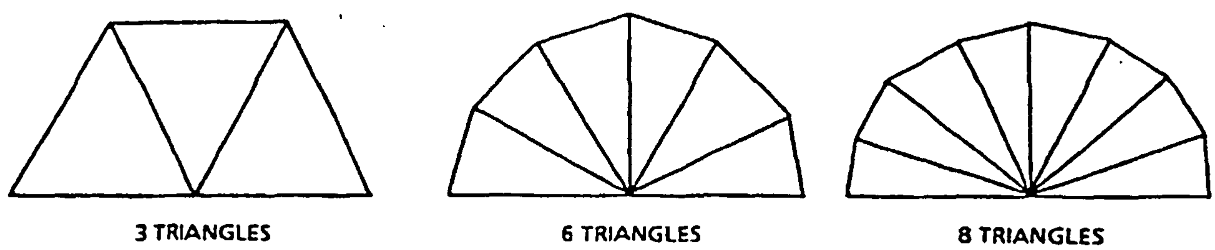


APPROXIMATING CURVED SURFACES

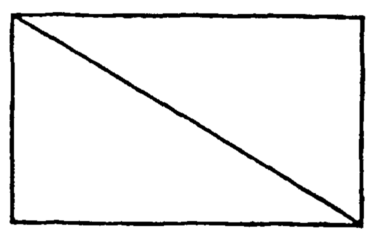

APPROXIMATING A RECTANGULAR SURFACE

*Curved surfaces require many triangles to approximate while rectangles are fully described by only two*

#### *Classifying Triangles*

As shown below, CAD triangles are classified for StereoLithography as flat (horizontal), near-flat and steep (vertical or near-vertical). The roof of the simplified automobile is composed of flat triangles. The hood and trunk are made up of near-flat triangles. The front, sides and back are steep triangles.

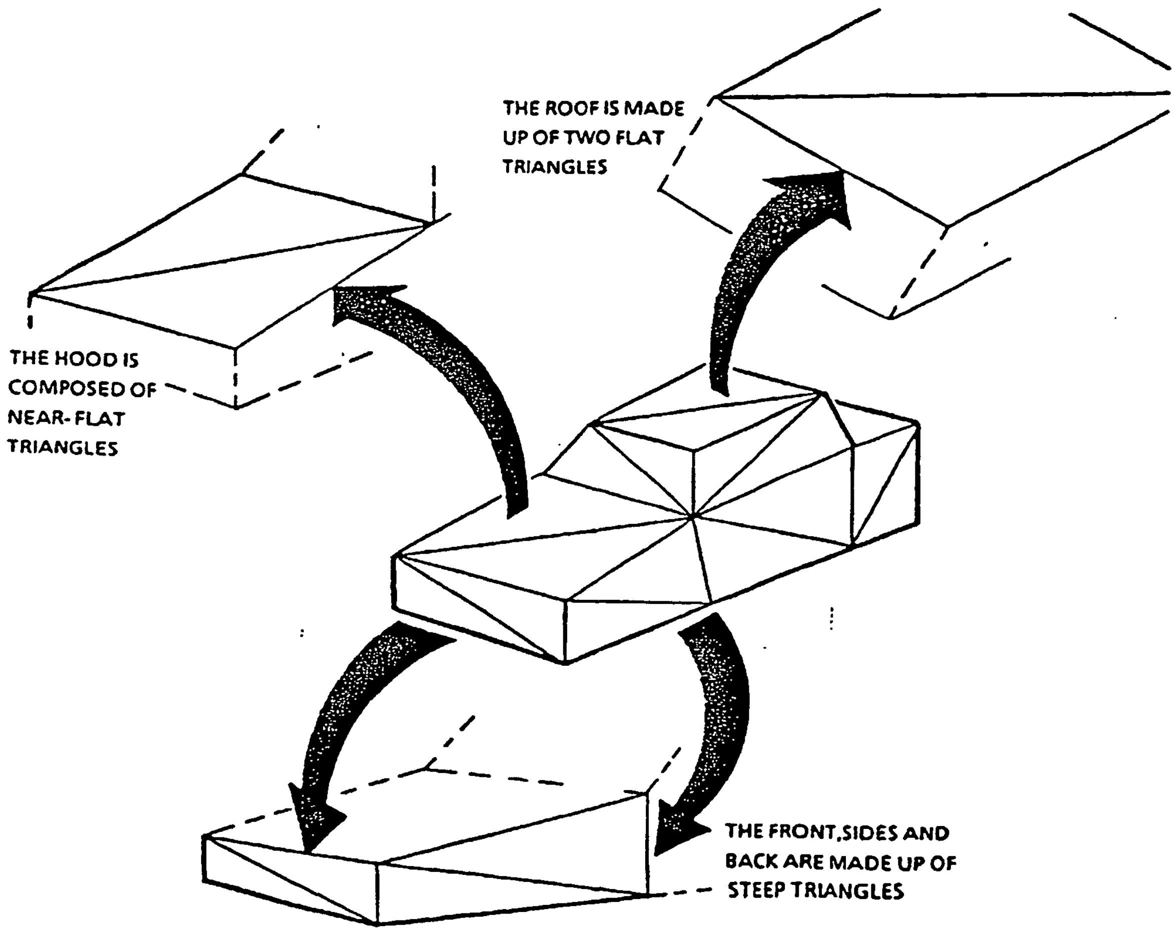


Any CAD object can be completely described by flat, near-flat and steep triangles

### *The .STL Format File*

The .STL file required as input to SLICE is composed of triangular facets with outward facing (away from solid) unit normals. This format specifies the X, Y and Z coordinates of each vertex and the unit normal for each triangle. Interfaces used to generate .STL files are supplied by CAD vendors.

The .STL file can be in either ASCII or binary format. Binary is preferred for space and performance considerations. ASCII is used at times because it allows easy debugging of interfaces.

## 3.4 SLICE COMPUTER

### *Overview*

Stereolithographic files are input to the Slice Computer and cross-sectioned using the program SLICE. The sliced files are then moved to the Control Computer for further processing. All files are transferred between the computers either via Ethernet or floppy disk.

*Using UNIX*

UNIX is a multi-task, multi-user operating system. All commands are entered in lowercase letters. The Slice Computer runs a Bourne shell.

## Getting Started

| | |
|---|---|
| ***Login*** | Enter your user ID at the login prompt. |
| | login: **train** [ENTER ↵] |
| ***Password*** | Enter your password. It will not print on the screen. |
| | Password: [ENTER ↵] |
| ***UNIX Prompt*** | At the UNIX prompt, enter UNIX commands or run SLICE. |
| | Welcome to the UNIX Operating System<br>$ |
| ***dosget*** | Use *dosget* to copy files from a DOS formatted floppy disk to the working directory. Specify -a for ASCII files or -b for binary files. |
| | **$dosget ∧-a∧a:filename∧. [ENTER ↵]** |
| NOTE: | The Slice Computer does not prompt for file type (ASCII or binary). The default is ASCII. |

## Copying Files and Logoff

***dosput*** Use *dosput* to copy files from the working directory to a DOS formatted floppy disk.

$dosput^-a^filename^a: [ENTER ↵]

***Logoff*** Logoff UNIX

$exit [ENTER ↵]

***Abort*** Use the [ENTER ↵] or Del keys to abort SLICE.

*UNIX Commands*

UNIX is a powerful operating system with many commands and command options. However, most functions required in everyday operation can be accomplished using only the commands listed here. Consult your UNIX documentation for more information.

***cat*** Use *cat* to print files to the screen. For example, to print a file *newfile.ext,* enter:

$cat^newfile.ext [ENTER ↵]

***cd*** Use *cd* (change directory) to move from one directory to another. For example, to move from the home directory to another called *newdir,* enter:

$cd^newdir [ENTER ↵]

To return to the home directory:

$cd [ENTER ↵]

***cp*** Use *cp* (copy) to make a copy of a file. For example, to create a file called *newfile* that is an exact duplicate of existing file *oldfile* in your current directory, enter:

$cp^oldfile^newfile [ENTER ↵]

| | |
|---|---|
| *df* | Displays the number of free disk blocks.<br><br>$df [ENTER↵] |
| *du* | Summarizes disk usage.<br><br>$du [ENTER↵] |
| *ls* | Use *ls* (list) to list in alphabetical order the files and subdirectories in a directory. If the directory is empty, UNIX will redisplay the $ prompt.<br><br>$ls [ENTER↵]<br><br>*ls* accepts a filename or directory name as an argument. If you use a filename, the file will be listed if it is in the directory.<br><br>$ls^filename [ENTER↵]<br><br>If you specify a directory, all files in the directory will be listed.<br><br>Several options are available for use with the *ls* command. The most useful is:<br><br>$ls^-l Lists the mode, number of links, owner, group, size and time of last modification for each file in the directory. |
| *mv* | Use *mv* (move) when you would like to change the name of a file or directory without making a copy of its contents. For example, to rename *newfile* to *oldfile*, enter:<br><br>$mv^newfile^oldfile [ENTER↵] |
| *pwd* | Use *pwd* to print the contents of the current working directory to the screen.<br><br>$pwd [ENTER↵] |

*rm* Use *rm* (remove) to delete a file from a directory. For example, to remove *newfile* from the current directory, enter:

$rm∧newfile ENTER↵

*who am i* Use *who am i* to list the current user's name.

$who∧am∧i ENTER↵

### 3.5 SLICE

***Overview***

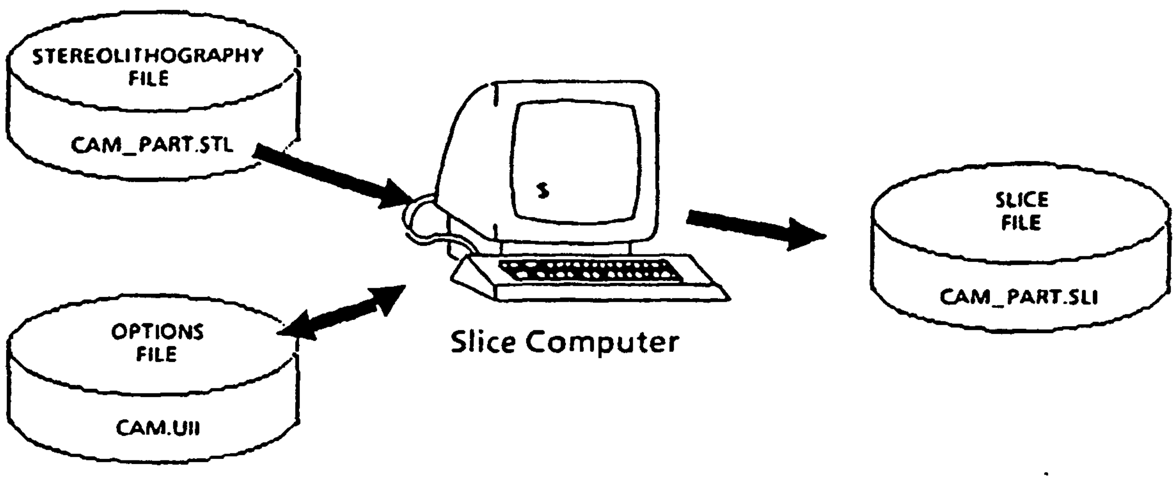


SLICE cross-sections three-dimensional StereoLithography (.STL) files and generates Slice (.SLI) files consisting of cross-sections in the X-Y plane layered one on top of another to create a three-dimensional object.

***General Information***

Logon UNIX directly at the Slice Computer or remotely at the Control Computer via REMOTE USER. Execute SLICE at the UNIX prompt ($).

The next step is to alter standard options and enter extra parameters, as needed. These options control slicing and have a strong impact on part building later in the StereoLithographic process. They can be saved to disk in an options file (.UII) to be used for later runs of the same or similar parts.

The final step is to slice the .STL file, in accordance with the Slice options, to create a Slice (.SLI) file.

***Layer Borders, Crosshatches and Skin Fill***

| | |
|---|---|
| ***Layer Borders*** | Layer border vectors define surface boundaries. |
| ***Crosshatches*** | Crosshatch vectors are created internally by SLICE to partially solidify and strengthen the liquid area between layer borders (walls). The spacing between crosshatches and the type used are selected prior to running SLICE. |
| ***Skin Fill*** | Horizontal (top and bottom) surfaces are covered with a series of closely spaced parallel vectors which form a type of skin. The layers between the skins are generally cross-hatched for added strength. |

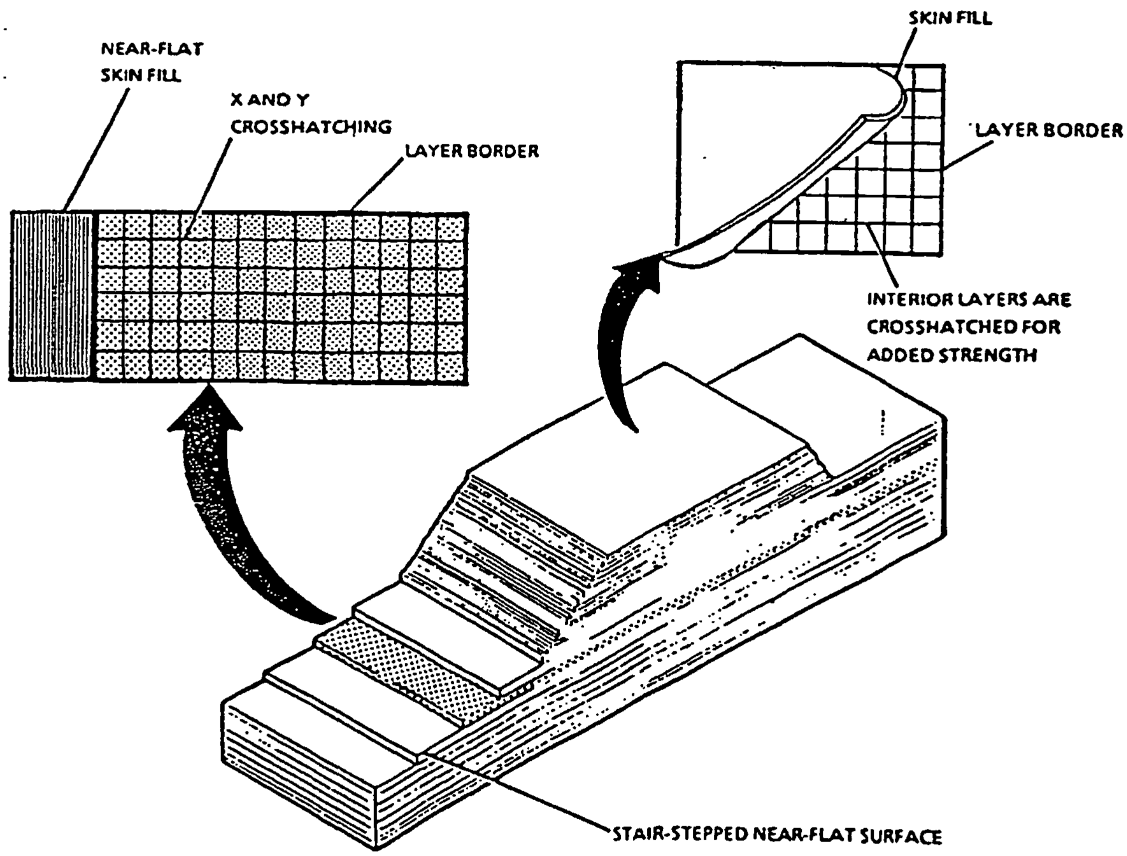


*The type of triangle sliced determines whether the area between the layer borders is crosshatched or skin filled*

***Layer Thickness***

Layer thickness is a SLICE parameter which allows users to choose and vary layer thicknesses, thus determining the vertical resolution of the part.

Use thinner layers is to improve accuracy and resolution in the vertical (Z) axis. Vertical dimension accuracy and resolution are limited to one layer thickness.

Sloping (near-flat) surfaces are approximated with smaller horizontal and vertical surfaces which appear as stair-steps. The chosen layer thickness determines the height of each step. Gaps between layer borders are skin filled. Other areas may be crosshatched, if necessary. Decreasing the layer thickness in near-flat regions results in smoother surfaces, since the height of each step is reduced.

Thicker layers can be used to strengthen parts and in some cases reduce the time required to build parts. However, the laser must trace at a slower rate over the resin surface to draw thicker layers, so the time saved by drawing thicker and thus fewer layers is partially offset by the reduced drawing speed.

***Vector Blocks***

SLICE creates vector blocks for a variety of two-point vectors. The block identifiers follow the mnemonic rule shown below.

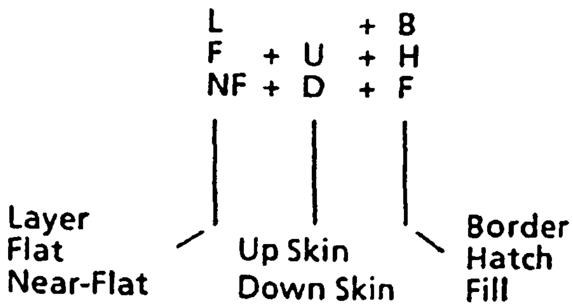


| Block Mnemonic | Description |
|---|---|
| LB | Layer Border |
| LH | Layer Hatch |
| FUB | Flat Up Border |
| FUF | Flat Up skin Fill |
| FDB | Flat Down Border |
| FDF | Flat Down skin Fill |
| NFUB | Near-Flat Up skin Border |
| NFUF | Near-Flat Up skin Fill |
| NFDB | Near-Flat Down skin Border |
| NFDH | Near-Flat Down skin Hatch |
| NFDF | Near-Flat Down skin Fill |

***Slice Resolution***

Slice resolution translates .STL files from CAD space to Slice space by specifying the number of slice units contained in each CAD unit.

Slice Resolution = # of slice units/CAD unit

***Slice Main Menu***

```
SLICE MAIN MENU

Current Object: cam_part
Database File Name: cam_part.stl, binary format
Extra Parameters:

Alter    -- Alter Standard Options
Extra    -- Set extra parameters

Load     -- Load a different object's options
Save     -- Save current object's options
Write    -- Save current object's options under different name
Copy     -- Copy another object's options into current object

DoSlice  -- Do slicing with current options
Quit     -- Exit (use SAVE to save options first)

Which Command?
```

***Alter*** Alters standard slicing parameters.

***Extra*** Selects extra parameters not listed on the Alter Menu. These extra parameters currently specify the vertical axis for part building.

***(default)*** slice part along Z-axis

***-X*** slice part along X-axis

***-Y*** slice part along Y-axis

***Save*** Saves the options displayed on the screen, variable layer thickness table and extra parameters in the current options file.

***DoSlice*** Runs SLICE using the current options.

***Quit*** Quits SLICE. QUIT does not save the options file (use SAVE first).

***Alter Menu***

```
SLICE ALTER MENU

Current Object: CAM_PART

Option  Description                                  CAD Units   Slice Units

 (1)  DATABASE File Name                             cam_part.stl (binary)
 (2)  Resolution                                     1000.000
 (3)  Layer thickness                                0.010 Fixed   10
 (4)  X hatch spacing                                0.000         0
 (5)  Y hatch spacing                                0.000         0
 (6)  60/120 degree hatch spacing                    0.050         50
 (7)  X skin fill spacing                            0.003         3
 (8)  Y skin fill spacing                            0.000         0
 (9)  Minimum Surface Angle for Scanned Facets       50
 (10) Minimum Hatch Intersect Angle                  0
 (11) Segment Output File Name                       cam_part.sli
 (Q)  Quit, return to Main Menu

Alter Which Option?
```

***DATABASE File Name*** Specifies the .STL file to be sliced and whether the file is ASCII or binary. Enter the filename only; the .SLI extension is assumed.

***Resolution*** Divides the CAD unit into smaller slice units, in essence creating a three-dimensional grid. Thus, if the CAD model was designed in inches, and slice resolution was set to 1000, each inch of the part would be divided into 1000 slice units, each 0.001 inch long.
NOTES:

•larger resolution values distort triangles less and reduce the possibility of crosshatching errors.

•All files comprising a single part (all support and object files) should be sliced with the same resolution.

•The largest X, Y or Z coordinate of the CAD model determines the maximum acceptable value for slice resolution.
(highest coordinate) * slice res.< 65,535

•Use round numbers (i.e., 1000, 2000, 5000 etc.).

***Layer Thickness*** Defines the vertical slice thickness in CAD units. (Layer thickness is displayed later in both CAD units and slice units, but is entered in CAD units.)
Layer thickness may be fixed for an entire file (i.e., all layers assigned the same layer thickness) or varied (groups of layers having different layer thicknesses). Typical values range from 0.002 inch to 0.030 inch.

| Type | Thickness |
|---|---|
| Fine | 0.005 inch |
| Medium | 0.010 inch |
| Coarse | 0.020 inch |

For example, if you want a part designed in inches to be built of layers 0.01 inch thick, enter .01. The layer thickness in slice units will be displayed on the screen automatically under the SLICE UNITS heading.
The maximum number of layers which can be used is 16384 (this corresponds to 0.0005 inch thick layers on an 8.0 inch part).

***Hatch Spacing*** Options (4), (5) and (6) specify the perpendicular distance, in CAD units, between adjacent hatch vectors drawn parallel to the X axis, parallel to the Y axis, or 60 and 120 degrees from the X axis, respectively.
NOTES:

•Typical hatch spacing values are 0.05 to 0.10 inch.

•Use zero for web supports. (Web supports are designed as two back-to-back vertical surfaces and thus do.not need crosshatches.) A zero means no crosshatches are generated.

•X and Y crosshatches are commonly used together to form a grid of squares.

•X and 60/120 crosshatches are most often used since they produce a more rigid structure than X and Y crosshatches alone.

***Fill Spacing*** Options (7) and (8) specify the perpendicular distance, in CAD units, between skin vectors drawn parallel to the X or Y axis, respectively.
NOTES:

•Typical fill spacing values are 0.001 to 0.004 inch.

•Never use both X and Y fill at the same time as this tends to stress and deform surfaces.

•Use zero for supports.

***Output Filename*** is the filename that will be assigned to the slice output file.

***Quit*** Returns control to the Slice Main Menu.

*Procedures (Lab 2 - Slice)*

## Before You Start

- Transfer .STL files to the Slice Computer
- Logon UNIX

**Step 1)** At the UNIX prompt, execute SLICE and enter the object filename.

$slice^cam_part [ENTER ↵]

**Step 2)**

| SLICE MAIN MENU |
|---|
| Current Object: cam part<br>Database File Name: cam .part.stl, binary format<br>Extra Parameters:<br><br>Alter – Alter Standard Options<br>Extra – Set extra parameters<br><br>Load – Load a different object's options<br>Save – Save current object's options<br>Write – Save current option's options under different name<br>Copy – Copy another object's options into current object<br><br>DoSlice – Do slicing with current options<br>Quit – Exit (use SAVE to save options first)<br><br>Which Command? |

At the Slice Main Menu, press A to alter standard options.

*Step 3)*

| SLICE ALTER MENU | | | |
|---|---|---|---|
| Current Object: CAM_PART | | | |
| Option | Description | CAD Units | Slice Units |
| (1) | DATABASE File Name | cam part.stl (binary) | |
| (2) | Resolution | 1000.000 | |
| (3) | Layer thickness | 0.010 Fixed | 10 |
| (4) | X hatch spacing | 0.000 | 0 |
| (5) | Y hatch spacing | 0.000 | 0 |
| (6) | 60/120 degree hatch spacing | 0.050 | 50 |
| (7) | X skin fill spacing | 0.003 | 3 |
| (8) | Y skin fill spacing | 0.000 | 0 |
| (9) | Minimum Surface Angle for Scanned Facets | 50 | |
| (10) | Minimum Hatch Intersect Angle | 0 | |
| (11) | Segment Output File Name | cam_part.sli | |
| (Q) | Quit, return to Main Menu | | |
| Alter Which Option? | | | |

At the Alter Menu, update or verify the following options.

| | | |
|---|---|---|
| (1) | DATABASE FIlename | cam_part ascii |
| (2) | Resolution | 5000 |
| (3) | Layer thickness | fixed .010 |
| (4) | X hatch spacing | .050 |
| (6) | 60/120 degree hatch spacing | .050 |
| (7) | X skin fill spacing | .003 |
| (9) | Minimum Surface Angle for scanned facets | 50 |

Press Q to return to Slice Main Menu.

*Step 4)* Press E to set extra parameters and enter -y.

*Step 5)* Press S to save options file as cam_part .UII.

*Step 6)*

| SLICE MAIN MENU |
|---|
| Current Object: cam part<br>Database File Name: cam part.stl, ascii format<br>Extra Parameters: -Y<br><br>Alter -- Alter Standard Options<br>Extra -- Set extra parameters<br><br>Load -- Load a different object's options<br>Save -- Save current object's options<br>Write -- Save current option's options under different name<br>Copy -- Copy another object's options into current object<br><br>DoSlice -- Do slicing with current options<br>Quit -- Exit (use SAVE to save options first)<br><br>Which Command? |

At the Slice Main Menu, press D to slice the cam_part file.

*Step 7)*

**3D SYSTEMS SLICE PROGRAM**

| | |
|---|---|
| Resolution value | 5000 000 |
| X hatch spacing | 250 |
| Y hatch spacing | 0 |
| Flat X fill spacing | 15 |
| Flat Y fill spacing | 0 |
| 60/120 degree angle hatch spacing | 250 |
| Min Surface Angle | 50 |
| Min Intersect Angle | 0 |
| Input file format | ascii |
| centering | off |
| segment output file | cam part.sli |
| layer thickness | 50 |

Start Time: Tue Mar 22 07:59:59 1988
End Time: Tue Mar 22 08:01:26 1988
SLICE COMPLETED

Press <Enter> to continue . . .

When SLICE is finished, press ENTER ↵ to return to the Slice Main Menu.

*Step 8)* At the Slice Main Menu, press A to alter standard options for the supports file (cam_base).

*Step 9)* At the Alter Menu, update the following options.

| | | |
|---|---|---|
| (1) | DATABASE Filename | **cam_base, ascii** |
| (2) | Resolution | **5000** |
| (3) | Layer Thickness | **fixed, .010** |

Set hatch, skin fill and MSA values (options 4 thru 9) to zero.

*Step 10)* Press E and set extra parameters to -y.

*Step 11)* Press S to save options file as cam_base.UII.

*Step 12)* At the Slice Main Menu, press D to slice cam_base file.

*Step 13)* At the Slice Main Menu, press Q to quit SLICE. This will return you to the UNIX prompt.

## INTERMEDIATE TOPICS

### *Slice Main Menu*

```
SLICE MAIN MENU

Current Object: cam_part
Database File Name: cam_part.stl, ascii format
Extra Parameters:

Alter    -- Alter Standard Options
Extra    -- Set extra parameters

Load     -- Load a different object's options
Save     -- Save current object's options
Write    -- Save current option's options under different name
Copy     -- Copy another object's options into current object

DoSlice  -- Do slicing with current options
Quit     -- Exit (use SAVE to save options first)

Which Command?
```

***Load*** Loads another file. The options previously listed on the screen are not automatically saved (you must use the SAVE command). Using LOAD is equivalent to quitting SLICE and re-entering a new file to Slice.

***Write*** Writes the options into another object's options file.

***Copy*** Copies options from a previously saved object's options file into the current options file. COPY saves having to re-enter options which are similar to those entered during an earlier run.

***Alter Menu***

***Variable Layer Thickness***

**SLICE ALTER MENU**

Current Object: CAM_PART

| Option | Description | CAD Units | Slice Units |
|---|---|---|---|
| (1) | DATABASE File Name | cam_part.stl(ascii) | |
| (2) | Resolution | 5000.000 | |
| (3) | Layer thickness | 0.010 Fixed | 50 |
| (4) | X hatch spacing | 0.050 | 250 |
| (5) | Y hatch spacing | 0.000 | 0 |
| (6) | 60/120 degree hatch spacing | 0.050 | 250 |
| (7) | X skin fill spacing | 0.003 | 15 |
| (8) | Y skin fill spacing | 0.000 | 0 |
| (9) | Minimum Surface Angle for Scanned Facets | 50 | |
| (10) | Minimum Hatch Intersect Angle | 0 | |
| (11) | Segment Output File Name | cam_part.sli | |
| (Q) | Quit, return to Main Menu | | |

Alter Which Option?

Variable layer thickness allows sets of layers (ranges) in the file to be created in which layer thickness can be individually specified.

Thinner layers are commonly used to:

- minimize the stair-step appearance of sloping surfaces
- improve accuracy of critical vertical dimensions and details

Thicker layers are occasionally used to strengthen unsupported regions or to produce stronger, rigid layers.

***Layer Thickness Commands***

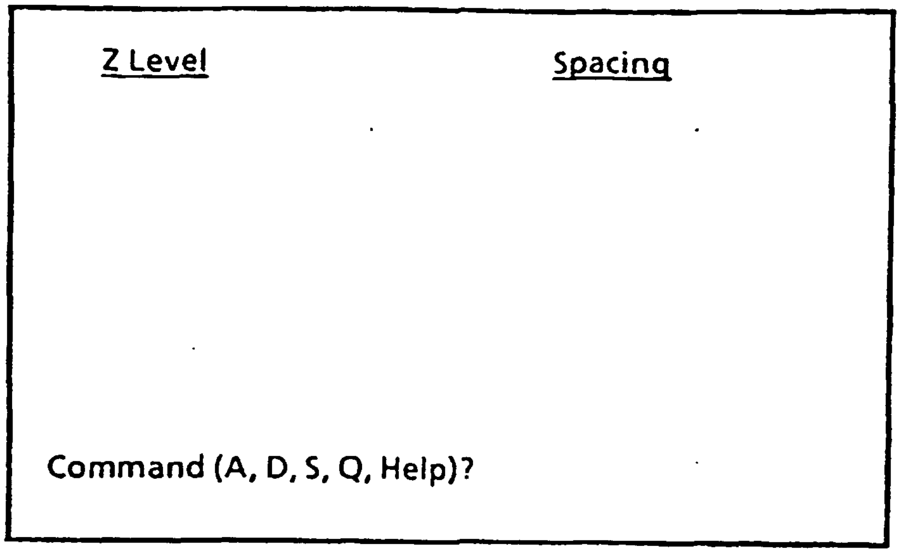


***A*** Adds a new Z Level to the table. The Z Level specifies the vertical dimension to begin slicing at the specified thickness. The starting dimension and thickness are both entered in CAD units. Slicing will continue at this spacing until another Z Level is defined. The first (lowest) Z level must start at or lower than the bottom of the object to be sliced.

***D*** Deletes a Z Level from the table.

***S*** Saves the table and returns control to the Alter Menu:

***Q*** Returns to the Alter Menu without saving the table.

***H*** Prints a help message similar to this listing.

***MSA***

SLICE parameter MSA (Minimum Surface Angle for scanned facets) defines the angle at which a triangle classification changes from near-flat to steep. As shown below, near-flat triangles are at an angle greater than zero (horizontal), but less than or equal to the MSA. Steep triangles are at an angle greater than the MSA, but less than or equal to 90 degrees.

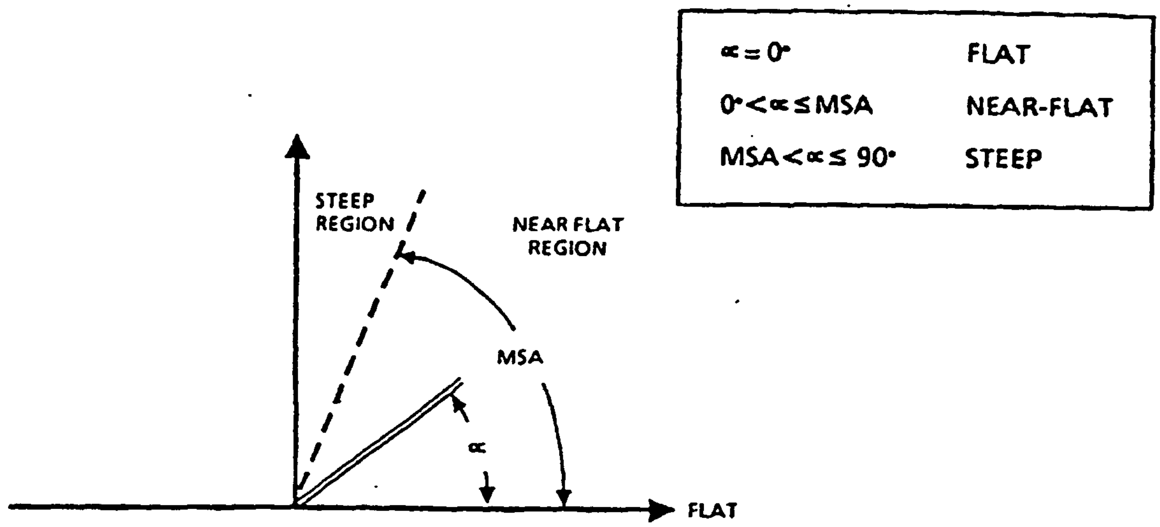


*The angle at which a triangle classification changes from near-flat to steep is defined by SLICE parameter MSA*

NOTES:

- Triangles inclined at less than the MSA are classified as near-flat. For these triangles, SLICE generates near-flat skin to fill gaps between layer borders on adjacent layers. Too large an MSA will cause SLICE to generate more skin vectors than necessary, increasing the run time and file size. Too small an MSA will cause gaps in the finished part resulting in liquid draining out of the object's walls.

- The correct MSA depends on the layer thickness used. Recommended values are:

| LayerThickness | MSA |
|---|---|
| 0.005 | 40 |
| 0.010 | 50 |
| 0.015 | 55 |
| 0.020 | 60 |

- Use zero for web supports.

***MIA***

Allows removal of specific hatch vectors which may cause part building problems. This is an advanced option -- consult a 3D Systems Applications Engineer.

*Procedures (Lab 3-Slice)*

*Variable Layer Thickness*

***Step 1)***

**SLICE ALTER MENU**

Current Object: SPIKE_P

| Option | Description | CAD Units | Slice Units |
|---|---|---|---|
| (1) | DATABASE File Name | cam_part.stl (binary) | |
| (2) | Resolution | 5000.000 | |
| (3) | Layer Thickness | 0.010 Fixed | 50 |
| (4) | X hatch spacing | 0.050 | 250 |
| (5) | Y hatch spacing | 0.000 | 0 |
| (6) | 60/120 degree hatch spacing | 0.050 | 250 |
| (7) | X skin fill spacing | 0.003 | 15 |
| (8) | Y skin fill spacing | 0.000 | 0 |
| (9) | Minimum Surface Angle for Scanned Facets | 50 | |
| (10) | Minimum Hatch Intersect Angle | 0 | |
| (11) | Segment Output File Name | cam_part.sli | |
| (Q) | Quit, return to Main Menu | | |

Alter Which Option?

At the Alter Menu, press 3 to select LAYER THICKNESS.

***Step 2)***

| Z Level | Spacing |
|---|---|

Command (A, D, S, Q, Help)?

Press V to select variable thickness.

***Step 3)*** Add or delete Z Levels as needed.

Command? A^1.00^.010 [ENTER ↵]

Command? A^2.60^.005 [ENTER ↵]

NOTE: The first Z Level must start at or below the bottom of the part.

***Step 4)***

| Z Level | Spacing |
|---|---|
| 1.000 .................. | .010 |
| 2.600 .................. | .005 |

Command (A, D, S, Q, Help)?

Press S to save Layer Thickness table.

***Step 5)*** Press Q to return to Alter Menu.

***Step 6)*** Alter other standard options, as required.

⋮

| | | |
|---|---|---|
| (4) | X hatch spacing | .050 |
| (9) | MSA | 55 |

***Step 7)*** Press E and set extra parameters to -y.

***Step 8)*** Press S to save options file as spike_p.UII.

***Step 9)*** At the Slice Main Menu, press D to slice spike_p file.

***Step 10)*** Repeat to set parameters and slice spike_b file.

### 3.6 CONTROL COMPUTER

***Overview***

All Stereo Lithographic process steps from MERGE through BUILD are run on the Control Computer. This encompasses all functions from transmitting and merging slice files,through controlling the elevator and dynamic mirrors to build the part.

Programs and operating parameters are selected from menus for ease of operation. The top-down hierarchy begins at the Main Menu, and continues through submenus, data entry screens, and status/information screens. Select options from menus by pressing the option number on the keyboard, or use the up and down arrow keys on the numeric keypad to position the pointer, then press [ENTER ↵]

The SLA-1 menu hierarchy is illustrated in the following figures. Note that each menu includes an exit or quit option to return to a next-higher menu. The exit option from the Main Menu takes you out of the SLA-1 operating system and into MSDOS.

# *The SLA-1 Menu System*

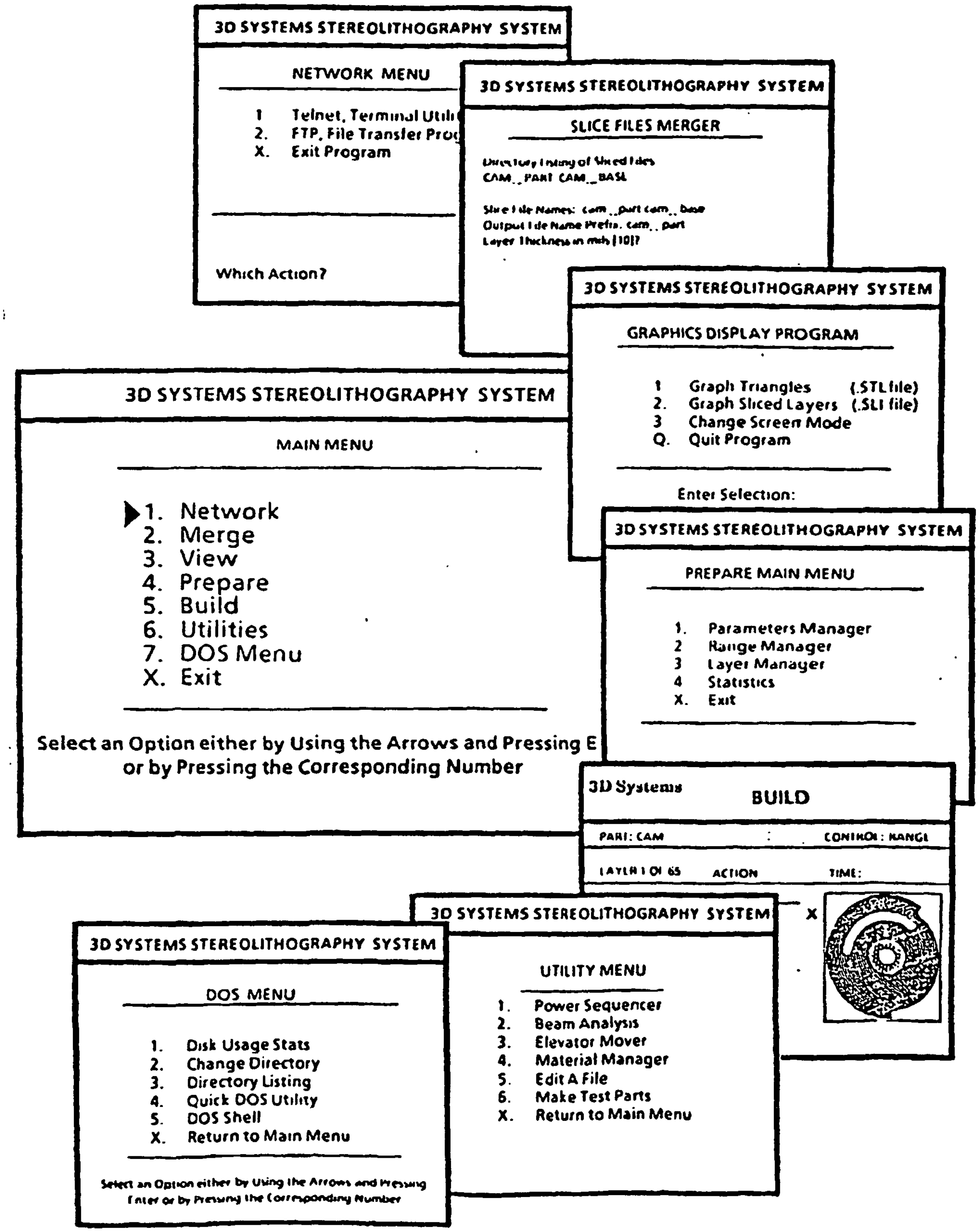

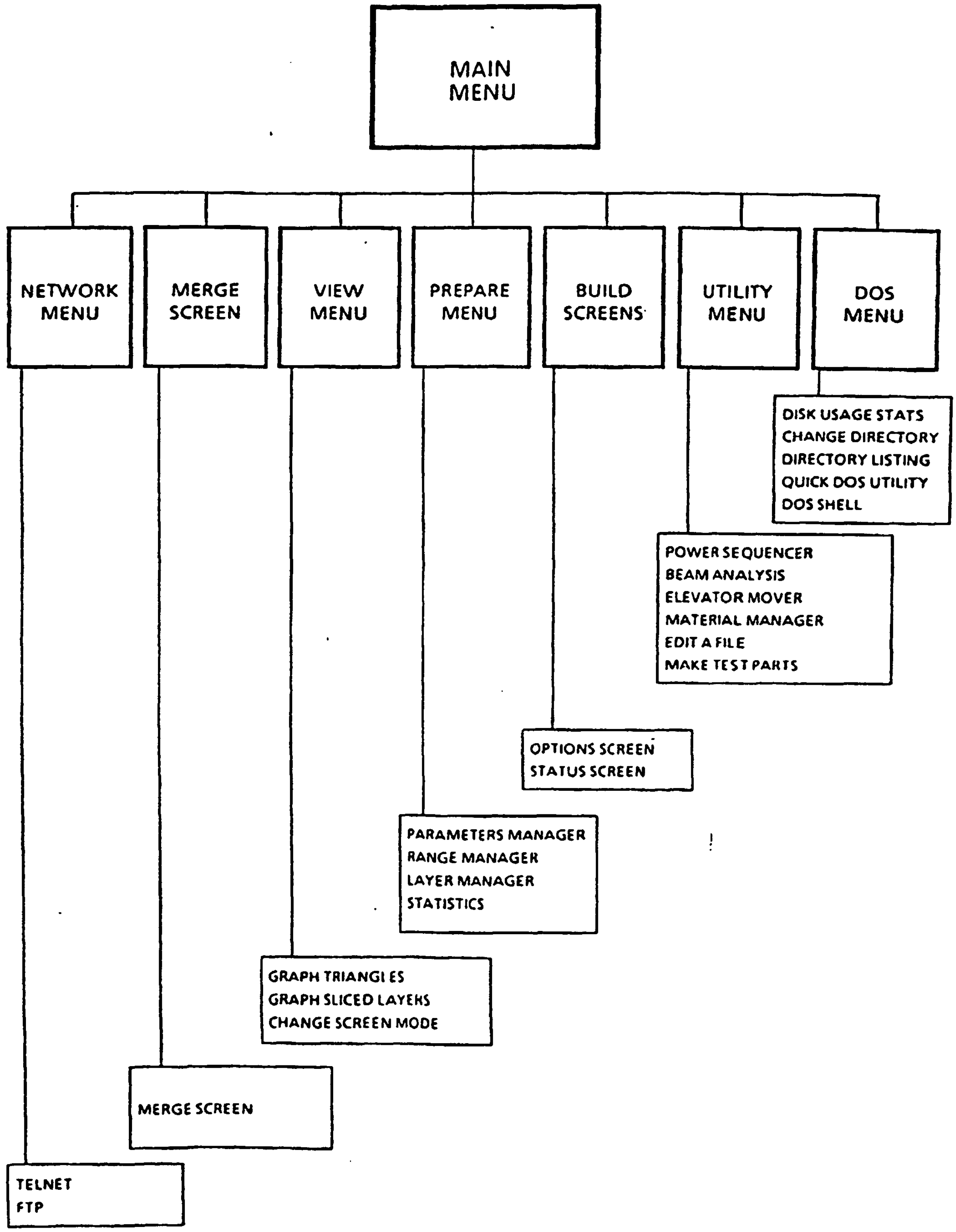


***Commonly Used MSDOS Commands***

The Control Computer operates under the single-user, single-task MSDOS operating system. The MSDOS prompt is based on the default disk drive. Filenames are limited to eight characters with a maximum of three characters for the extension (e.g., .SLI).

MSDOS is a powerful operating system, with many commands to choose from. However, most functions required in everyday operation of the SLA-1 can be accomplished using the few commands summarized below.

| | |
|---|---|
| *Cd* | changes directories<br><br>cd^directory [ENTER ↵] |
| *Copy* | copies files.<br><br>The following example copies one file to another file in the same directory on the same disk, but with a different filename. Both files then contain the same data, but have different names.<br><br>copy^test 1.ext^test2.ext [ENTER ↵]<br><br>You can also copy the file to a floppy disk. For example, to copy TEST1.EXT from the current directory to disk drive A:<br><br>copy^ test1.ext^ a: [ENTER ↵] |
| *Delete* | deletes files.<br><br>The following example deletes file TEST1.EXT from the current directory.<br><br>del^test1.ext [ENTER ↵] |

To delete several files with either a common filename or filename extension, type the command with an asterisk (•) for the common name. For example, the command

del^test 1.• [ENTER ↵]

deletes all files with the filename TEST1, followed by any extension, in the current directory. The command

del^•.ext [ENTER ↵]

deletes all files with the extension EXT. Use these *global* commands with care.

***Directory*** lists files and subdirectories in a directory.

The following example lists all files in the current directory

dir [ENTER ↵]

The next example lists all files named FILE1, regardless of extension, in the current directory.

dir^file1.• [ENTER ↵]

The next example lists all files with extension .EXT, regardless of filename.

dir^.ext [ENTER ↵]

***Help*** displays a list of the available MSDOS commands, or the complete syntax and a short description of a specific command. This command may not be available on all systems.

To list all commands

help [ENTER ↵]

To print the complete syntax and a short description of COPY to the screen.

help^copy [ENTER ↵]

***Rename*** Renames a file.

For example, the following command renames file TEST1 with the name TEST.

rename^test1^test [ENTER ↵]

After renaming, a file named TEST1 is no longer in the directory, but the same file exists under the name TEST.

### 3.7 UTILITIES

***Overview***

Utility menu options are used throughout the part-building process. Their functions include:

- Turning on and off SLA-1 hardware
- Measuring laser beam intensity and focus
- Moving the elevator platform before and after building a part
- Entering cure depth and linewidth data measured from banjotops
- Editing text files
- Making test parts

*Utility Menu*

3D SYSTEMS STEREOLITHOGRAPHY SYSTEM

UTILITY MENU

1. Power Sequencer
2. Beam Analysis
3. Elevator Mover
4. Material Manager
5. Edit A File
6. Make Test Parts

X. Return to Main Menu

*Power Sequencer*

POWER SEQUENCER MENU

1. Turn Laser and Mirror Driver On
2. Turn Elevator On
3. Open Shutter
4. Turn Laser and Mirror Driver Off
5. Turn Elevator Off
6. Close Shutter

X. Exit

Please Make a Selection

Laser On Shutter Open Door Closed Elevator On

Turns on and off the laser, dynamic mirrors and elevator drivers, and opens and closes the laser shutter, directly from the Control Computer keyboard. The current status of each component is listed at the bottom of the screen.

***Beam Analysis***

**BEAM ANALYSIS MENU**

1. Display Profile
2. Beam Power/Profile History
3. Position Check
4. Beam Power
5. Beam Focus
6. Move Beam
7. Find Pinholes
8. Calibrate System

T. Toggle Between Screen Modes

X. Exit - Return to Main Menu

Measures laser beam intensity and focus, and enables Field Engineers to maintain and calibrate the laser.

***Beam Power*** points the laser beam at two beam profilers mounted in the Process Chamber and then calculates the average laser power. The current laser power is needed when Prepare Menu option MATERIAL MANAGER is run to calculate cure depths.

***Elevator Mover***

**ELEVATOR STOP**

| | |
|---|---|
| UP ARROW | move elevator up |
| DOWN ARROW | move elevator down |
| SPACE BAR | stop elevator motion |
| D | move a specified distance |
| T | toggle parameter display |
| Q or X | exit to utility menu |

Elevator Mover enables positioning of the elevator platform using up and down arrow keys on the Control Computer numeric keypad. Press the space bar to stop elevator motion.

D moves the elevator platform a specified distance in inches. Positive values move the platform downward, negative up.

T toggles parameter information displayed at the bottom of the screen on and off.

*Procedures (Lab 2 - Utilities)*

*Power Sequencer*

*Step 1)*

UTILITY MENU

1. Power Sequencer
2. Beam Analysis
3. Elevator Mover
4. Material Manager
5. Edit A File
6. Make Test Parts

X. Return to Main Menu

At the Utility Menu, press **1** to select POWER SEQUENCER.

*Step 2)*

POWER SEQUENCER MENU

1. Turn Laser and Mirror Driver On
2. Turn Elevator On
3. Open Shutter
4. Turn Laser and Mirror Driver Off
5. Turn Elevator Off
6. Close Shutter

X. Exit

Please Make a Selection

Laser On    Shutter Open    Door Closed    Elevator On

At the Power Sequencer Menu, press the appropriate number key. The status display at the bottom of the screen will automatically update.

*Beam Analysis*

***Step 1)***

UTILITY MENU

1. Power Sequencer
2. Beam Analysis
3. Elevator Mover
4. Material Manager
5. Edit A File
6. Make Test Parts
X. Return to Main Menu

At the Utility Menu, press 2 to select BEAM ANALYSIS.

***Step 2)***

BEAM ANALYSIS MENU

1. Display Profile
2. Beam Power/Profile History
3. Position Check
4. Beam Power
5. Beam Focus
6. Move Beam
7. Find Pinholes
8. Calibrate System
T. Toggle Between Screen Modes
X. Exit - Return to Main Menu

At the Beam Analysis Menu, press 1 to select DISPLAY PROFILE or 4 to select BEAM POWER.

*Step 3)*

*Display Profile*

Review profile then press ENTER↵ to return to Beam Analysis Menu.

*Beam Power*

Sensor #1 8.08 mW Averaged Reading (7.99 mW Unfiltered)
Sensor #2 7.73 mW Averaged Reading (7.65 mW Unfiltered)
Press 1 - 3 to select sensor #, Q to Quit

After power readings settle, write down average and press Q to return to Beam Analysis Menu.

*Elevator Mover*

***Step 1)***

UTILITY MENU

1. Power Sequencer
2. Beam Analysis
3. Elevator Mover
4. Material Manager
5. Edit A File
6. Make Test Parts
X. Return to Main Menu

At the Utility Menu, press 3 to select ELEVATOR MOVER.

*Step 2)*

| | |
|---|---|
| ELEVATOR STOP | |
| UP ARROW | move elevator up |
| DOWN ARROW | move elevator down |
| SPACE BAR | stop elevator motion |
| D | move a specified distance |
| T | toggle parameter display |
| Q or X | exit to utility menu |

Press the up and down arrow keys on the numeric keypad to raise and lower the elevator platform

*and*

Press the space bar to stop elevator motion,

*or*

Press D to specify a distance (in inches) for the elevator to move (positive values lower the elevator).

**INTERMEDIATE TOPICS**

***General Information***

***Edit a File***

EDIT A FILE is used to edit text files.

***Make Test Parts***

MAKE TEST PARTS is used to build banjotops.

***Material Manager***

MATERIAL MANAGER

1. Load Material Data
2. View Material Data
3. Input New Material Data
4. Layer Thickness Information

Q. Quit

Option:

***Load Material Data*** lists material (.MAT) files and prompts for the file to be loaded.

***View Material Data*** displays material data on the screen.

***Input New Material Data*** inputs material data measured from banjotops. These data include:

•Step Period (SP) values .

•The lineheight of each banjotop string

•The minimum and maximum linewidth measurement from each banjotop string

INPUT NEW MATERIAL DATA then calculates a working curve and displays the slope and Y-intercept of the curve on the screen.
NOTE:
Refer to subsection 5.3 for further discussion of banjotops, working curves and related topics.

*Procedures (Lab 3 - Utilities)*

*Material Manager*

***Step 1)***

UTILITY MENU

1. Power Sequencer
2. Beam Analysis
3. Elevator Mover
4. Material Manager
5. Edit A File
6. Make Test Parts

X. Return to Main Menu

At the Utility Menu, press **4** to select MATERIAL MANAGER.

***Step 2)***

MATERIAL MANAGER

1. Load Material Data
2. View Material Data
3. Input New Material Data
4. Layer Thickness Information

Q. Quit

Option:

At the Material Manager Menu, press the appropriate option number.

*Step 3)*

*Load Material Data*

Available Material Files:

TEST.MAT
31498240 Bytes free

Name of data file to read:

Enter the material (.MAT) filename.

Name of data file to read: test.mat ENTER↵

Data from Material File: test.mat

Material Test Laser Power Reading: 10.50

3 Material Data Pairs

| | | | | |
|---|---|---|---|---|
| 1 | SP = | LH = | WMIN = | WMAX = |
| 2 | SP = | LH = | WMIN = | WMAX = |
| 3 | SP = | LH = | WMIN = | WMAX = |

| | | | |
|---|---|---|---|
| LH: | Slope = | Y-Intercept = | R-Value = |
| WMIN: | Slope = | Y-Intercept = | R-Value = |
| WMAX: | Slope = | Y-Intercept = | R-Value = |

Press Enter to Continue...

Review material data then press ENTER↵

*Input New Material Data*

| |
|---|
| INPUT MATERIAL DATA<br><br>Name of Material Data File: |

NOTE: Run Utility Menu option MAKE TEST PARTS to create banjotops, then measure the banjotop strings to generate data for the material file.

Enter material data filename. Include .MAT suffix.

Name of Material Data File: test.mat [ENTER↵]

| |
|---|
| INPUT MATERIAL DATA<br><br>Name of Material Data File: test.mat<br><br>Enter Material Test Laser Power Reading (mW): |

Enter average laser power reading from BEAM POWER.

Enter Material Test Laser Power Reading (mW): ____ [ENTER↵]

INPUT MATERIAL DATA

Name of Material Data File: test.mat

Enter Material Test Laser Power Reading (mW): ____

How Many Step Period/Line Height Data Pairs?

Enter number of data pairs measured from banjotop.

How Many Step Period/Line Height Data Pairs? 3 ENTER↵

INPUT MATERIAL DATA

Name of Material Data File: test.mat

Enter Material Test Laser Power Reading (mW): ____

How Many Step Period/Line Height Data Pairs? 3

| | | | |
|---|---|---|---|
| Data Pair 1 SP = | LH = | WMIN = | WMAX = |
| Data Pair 2 SP = | LH = | WMIN = | WMAX = |
| Data Pair 3 SP = | LH = | WMIN = | WMAX = |

Enter Step Period (SP), Line Height (LH) and minimum and maximum linewidth (WMIN, WMAX) data measured from banjotops. If WMIN and WMAX data were not measured, enter zeroes.

Data from Material File: TEST.MAT

Material Test Laser Power Reading: ___

3 Material Data Pairs

| | | | | |
|---|---|---|---|---|
| 1 | SP = | LH = | WMIN = | WMAX = |
| 2 | SP = | LH = | WMIN = | WMAX = |
| 3 | SP = | LH = | WMIN = | WMAX = |

| | | | |
|---|---|---|---|
| LH: | Slope = | Y-Intercept = | R-Value = |
| WMIN: | Slope = | Y-Intercept = | R-Value = |
| WMAX: | Slope = | Y-Intercept = | R-Value = |

Press Enter to Continue . . .

Review data for accuracy, then press ENTER ↵

## 3.8 NETWORK

*Overview*

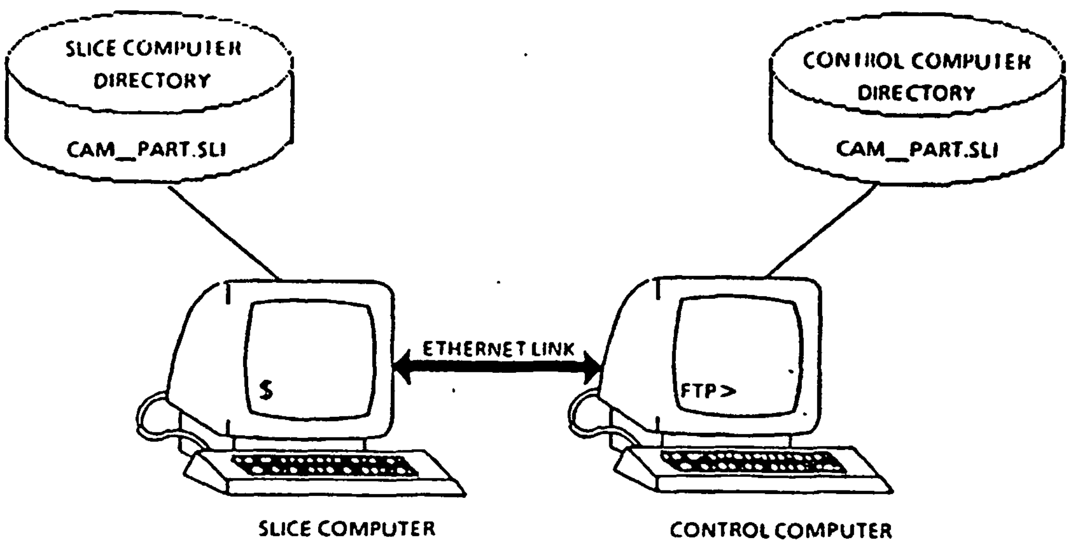


NETWORK transfers files via Ethernet between the Control and Slice Computers, and enables remote operation of the Slice Computer from the Control Computer keyboard.

***Network Menu***

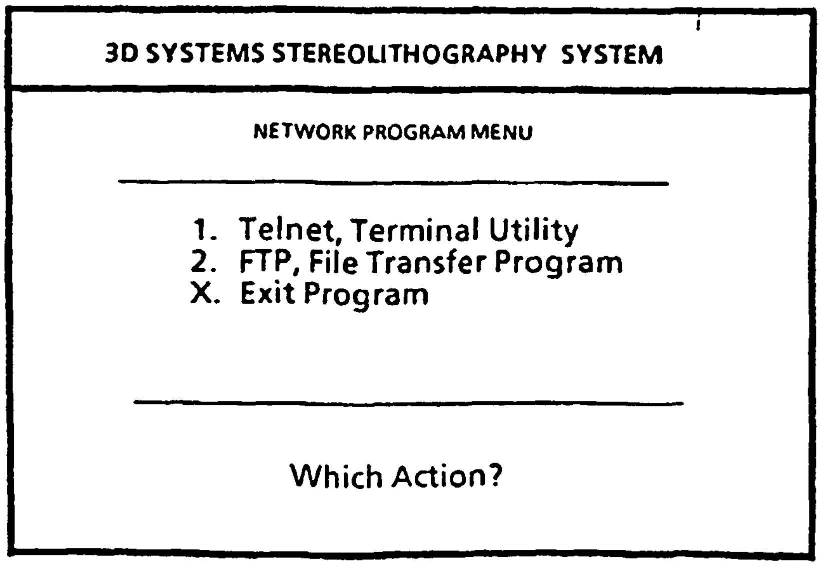


***File Transfer Program***

Copies a file in the Slice Computer directory and moves it into the Control Computer working directory, or vice versa. FTP is generally used to transfer .SLI files to the Control Computer. Several commands are available. The prompt is:

FTP >

***File Transfer Commands***

**get** moves a copy of a file from the Slice Computer to the working directory in the Control Computer. The file is copied, and thus remains in the Slice Computer directory after the transfer is completed.

***mget*** similar to *get*, except multiple files can be transferred at the same time.

***put*** moves a copy of a file from the working directory in the Control Computer to the Slice Computer. The file is copied, and thus remains in the Control Computer directory after the transfer is completed.

***mput*** similar to *put*, except multiple files can be transferred at the same time. ,

***dir*** lists all files in the Slice Computer directory. Press **CNTRL-S** to pause the listing and **CNTRL-Q** to restart the listing.

***ldir*** lists all files in the Control Computer working directory.

***bye*** exits FTP and returns to the Main Menu.

***help*** lists and describes all available commands.

*Procedures (Lab 2 - Network)*

*Step 1)*

3D SYSTEMS STEREOLITHOGRAPHY SYSTEM

MAIN MENU

1. Network
2. Merge
3. View
4. Prepare
5. Build
6. Utilities
7. DOS Menu
X. Exit

Select an Option either by Using the Arrows and Pressing Enter or by Pressing the Corresponding Number

At the Main Menu, select NETWORK.

1 *or* locate pointer ENTER ↵

*Step 2)*

3D SYSTEMS NETWORK PROGRAM

1. Telnet, Terminal Utility
2. FTP, File Transfer Program
X. Exit Program

Which Action?

At the Network Menu, press 2 to select FTP.

*Step 3)* At the prompt, enter your remote user name.

Remote User Name: train [ENTER ↵]

*Step 4)* At the prompt, enter your password. It will not be displayed on the screen.

Remote Password: [ENTER ↵]

*Step 5)* At the ftp> prompt, enter the appropriate command.

ftp>ascii [ENTER ↵]
ftp>get^cam_part.sli [ENTER ↵]
ftp>mget^cam_part.sli^cam_base.sli [ENTER ↵]
ftp>dir [ENTER ↵]
ftp>ldir [ENTER ↵]
ftp>bye [ENTER ↵]

NOTES:

- You must specify the format of file to be transferred (ASCII or binary). Slice files are in ASCII format, .STL files in ASCII or binary. The default is ASCII.
- Files transferred from UNIX (Slice Computer) to MSDOS (Control Computer) must comply with DOS filename rules. That is, the filename is limited in length to eight characters, and the extension is limited to three characters.

**INTERMEDIATE TOPICS**

***Terminal Utility***

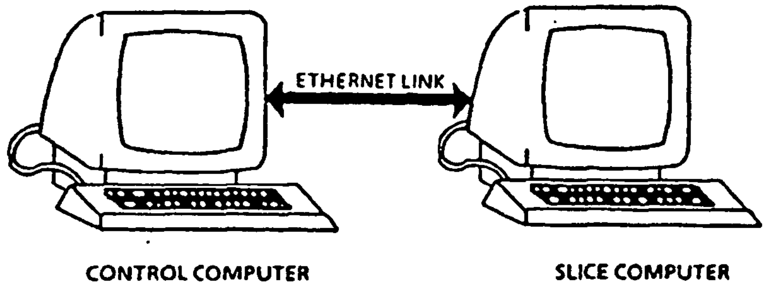


TERMINAL UTILITY enables users to logon the Slice Computer from the Control Computer keyboard and remotely operate SLICE and other programs. This option is infrequently used, since the Control Computer is generally being used to build parts.

*Procedures (Lab 3 - Network)*

***Step 1)***

| 3D SYSTEMS STEREOLITHOGRAPHY SYSTEM |
|---|
| MAIN MENU |
| ▶1. Network<br>2. Merge<br>3. View<br>4. Prepare<br>5. Build<br>6. Utilities<br>7. DOS Menu<br>X. Exit |
| Select an Option either by Using the Arrows and Pressing Enter or by Pressing the Corresponding Number |

At the Main Menu, select NETWORK.

1 *or* locate pointer [ENTER ↵]

***Step 2)***

| |
|---|
| 3D SYSTEMS NETWORK PROGRAM |
| 1. Telnet, Terminal Utility<br>2. FTP, File Transfer Program<br>X. Exit Program |
| Which Action? |

At the Network Menu, press **1** to select TELNET.

***Step 3)*** At the prompt, enter your remote user name.

Login: train [ENTER ↵]

***Step 4)*** **At the prompt, enter your password. It will not be displayed on the screen.**

**Password: ENTER↵**

***Step 5)*** **At the UNIX prompt, enter commands as needed.**

**UNIX System V Release 1.0.4 80386**

**$**

***Step 6)*** **When finished, exit TELNET.**

**$exit ENTER↵**

**3.9 MERGE**

***Overview***

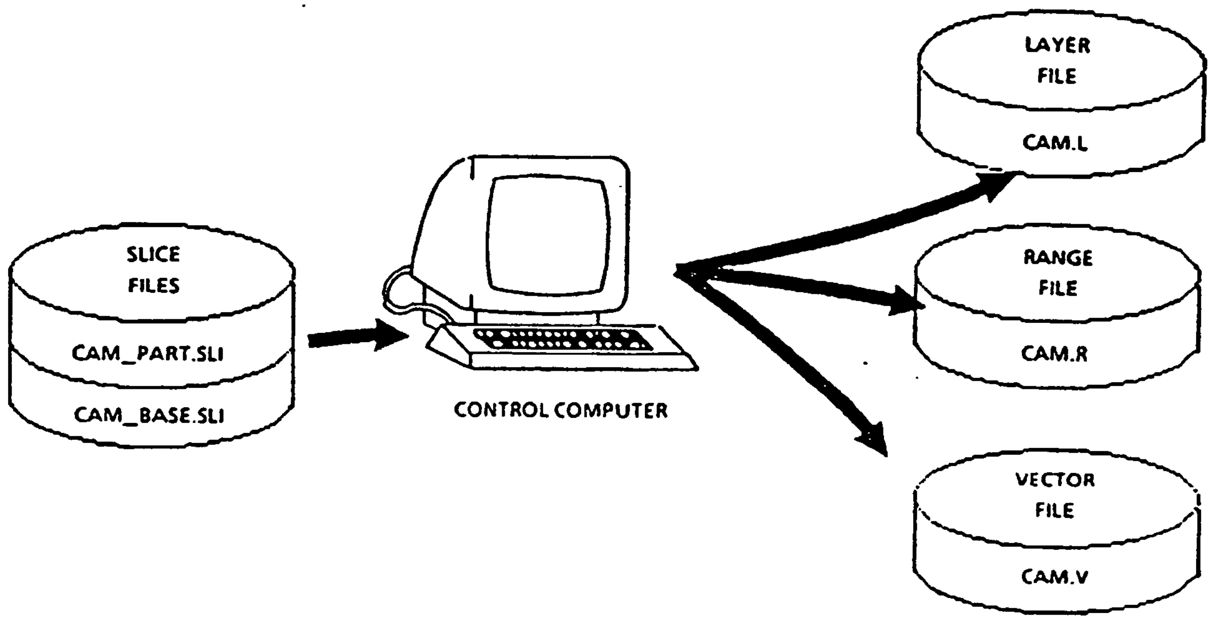


MERGE combines all Slice files for a part (support and object files) and generates Layer (.L), Vector (.V) and Range (.R) files.

***Layer (file.L) File*** defines the types of vector blocks in each layer.

***Vector (file.V) File*** contains vector data used by BUILD to draw each layer.

***Range (file.R) File*** specifies ranges, drawing parameters and dipping parameters for BUILD. It is this file which may be modified using Prepare options to add part building parameters.

***Merge Information Screen***

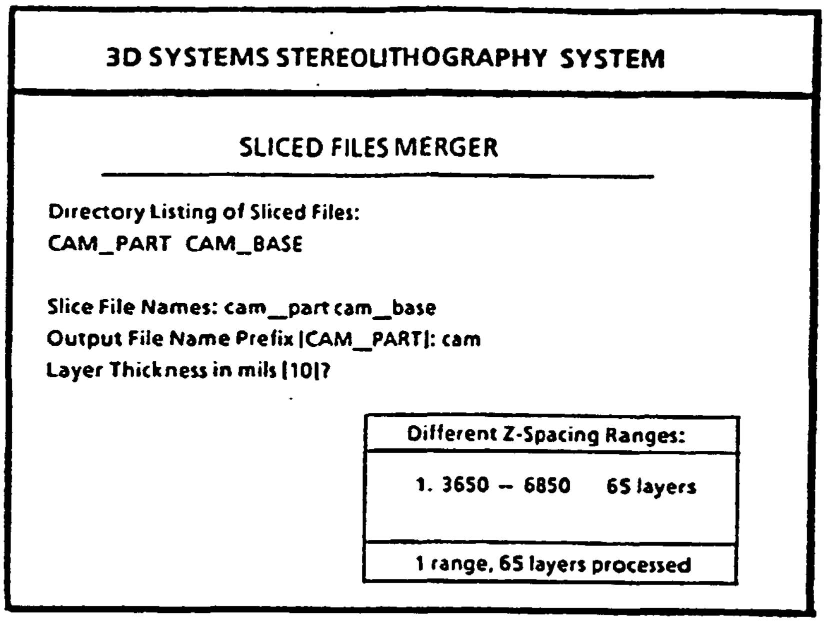


The MERGE information screen is used to enter file information. It displays the following status information as MERGE is running.

- Starting and ending Z Level values for each layer thickness range.
- The Z Level currently being merged.
- At completion of the run, the total number of ranges processed and the number of merged layers in each range.

***Procedures (Lab 2 - Merge)***

***Before you Start***

Run Network Menu option FTP to transfer all required Slice files to the Control Computer working directory.

***Step 1)***

**3D SYSTEMS STEREOLITHOGRAPHY SYSTEM**

**MAIN MENU**

1. Network
▶2. Merge
3. View
4. Prepare
5. Build
6. Utilities
7. DOS Menu
X. Exit

**Select an Option either by Using the Arrows and Pressing Enter or by Pressing the Corresponding Number**

At the Main Menu, select MERGE.

2 *or* locate pointer [ENTER↵]

***Step 2)*** Enter the files to be merged.

Slice File Names: cam_part∧cam_base [ENTER↵]

***Step 3)*** Enter a filename for the layer, vector and range files, or press [ENTER↵] to select the default filename.

Output File Name Prefix [CAM_PART]:cam [ENTER↵]

***Step 4*** At the prompt, press [ENTER↵] to select the default layer thickness.

Layer thickness in mils [10]? [ENTER↵]

***Step 5)***

Directory Listing of Sliced Files:

CAM_PART CAM_BASE

Slice File Names: cam_part cam_base
Output File Name Prefix [CAM_PART]:cam
Layer Thickness in mils [10] ?

Different Z-Spacing Ranges:

1. 3650 -- 6850 65 layers

1 range, 65 layers processed

Watch the screen to determine when MERGE is completed.

NOTE: Slice files with revisions earlier than 3.0 may prompt for Z-spacing.

**INTERMEDIATE TOPICS**

***Merge Options***

**/Z** adjusts the vertical position of one file relative to another. This option is used to align objects vertically. Enter the offset in slice units following the file to be adjusted.
Slice File Names: **cam_partʌcam_base/Z100**

**/X** adjusts the X direction position of one file relative to another.

**/Y** adjusts the Y direction position of one file relative to another.

### 3.10 VIEW

***Overview***

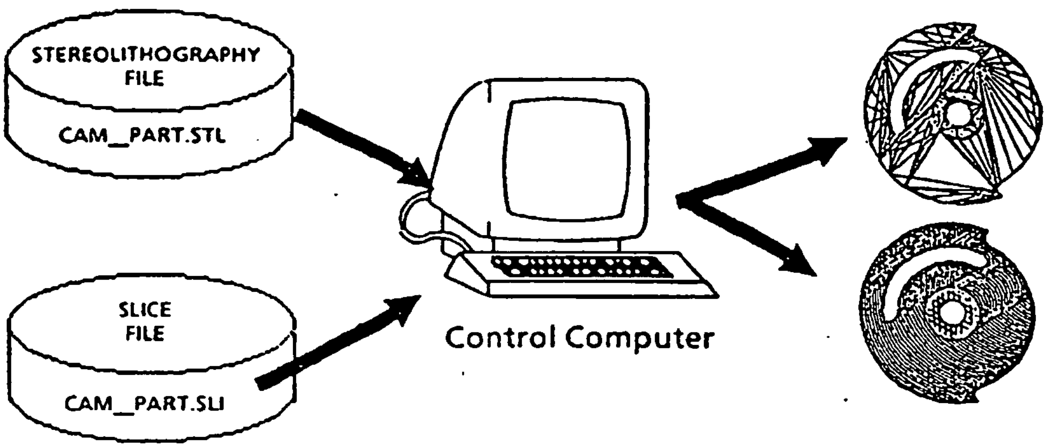


VIEW displays StereoLithography (.STL) and Slice (.SLI) files on the Control Computer screen. It is used primarily to:

- evaluate the need for variable layer thicknesses
- determine whether all vector blocks are needed
- study layers and part features
- check slice files

***View Menu***

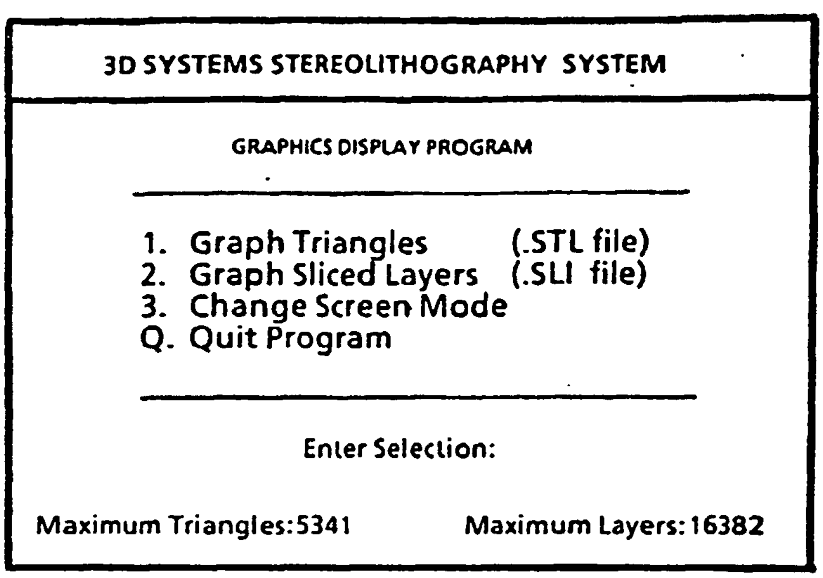

***Graph Triangles***

| | |
|---|---|
| ***New File*** | specifies a new file to be graphed. The .STL files in the working directory are listed when the GRAPH TRIANGLES option is selected. |
| ***Graph*** | graphs the file. |
| ***Rotation*** | specifies the number of degrees rotation for the X, Y and Z axes following the Right-Hand Rule (RHR) convention. For example, to show an isometric view of the part, rotate the X axis 30 degrees, the Y axis 15 degrees, and the Z axis 0 degrees. |
| ***Axis*** | specifies the axis to be oriented vertically when the file is graphed. |
| ***ESC*** | (ESC key) escapes the GRAPH TRIANGLES function back to the View Menu. |
| ***Window Mode*** | Advanced Topic. |
| ***Select Range*** | Advanced Topic. |

***Graph Sliced Layers***

| | |
|---|---|
| ***New File*** | specifies a new file to be graphed. The SLI files in the working directory are listed when the GRAPH SUCED LAYERS option is selected. |
| ***Layer Select*** | lists the vector blocks in each layer in the file. This parameter is used to select slice layers which have vectors of interest. The minimum and maximum X and Y coordinates for the selected layer, in slice units, and the mnemonics for all vector blocks in the layer, are displayed when a layer is selected. |
| ***Blocks*** | specifies vector blocks to be displayed when the part is graphed. Using the toggle feature, selected blocks may be omitted from the next graph of the file. |
| ***Graph*** | graphs the file. |
| ***ESC*** | (ESC key) escapes the slice file display function back to the View Menu. |
| ***Windowing*** | Advanced Topic. |

***Change Screen Mode***

Allocates available disk space between StereoLithography and Slice Files. In most cases, the defaults will not have to be changed. However, if a very large .STL file is to be graphed, increase the triangles allocation (to a maximum of 10,921). If a very large .SLI file is to be graphed, increase the layers allocation (to a maximum of 16,382). If both types of files are being graphed, apportion disk space appropriately.

***Procedures (Lab 3 - View)***

***Before You Start***

To display an .STL file:

- Generate the file in either ASCII or binary format.
- Transfer the file to the Control Computer working directory using a floppy disk or DATA TRANSFER.

To display an .SLI file:

- Run SLICE if the file has not been generated.
- Transfer the .SLI file to the Control Computer working directory using a floppy disk or DATA TRANSFER.

***Change Screen Mode***

*Step 1)*

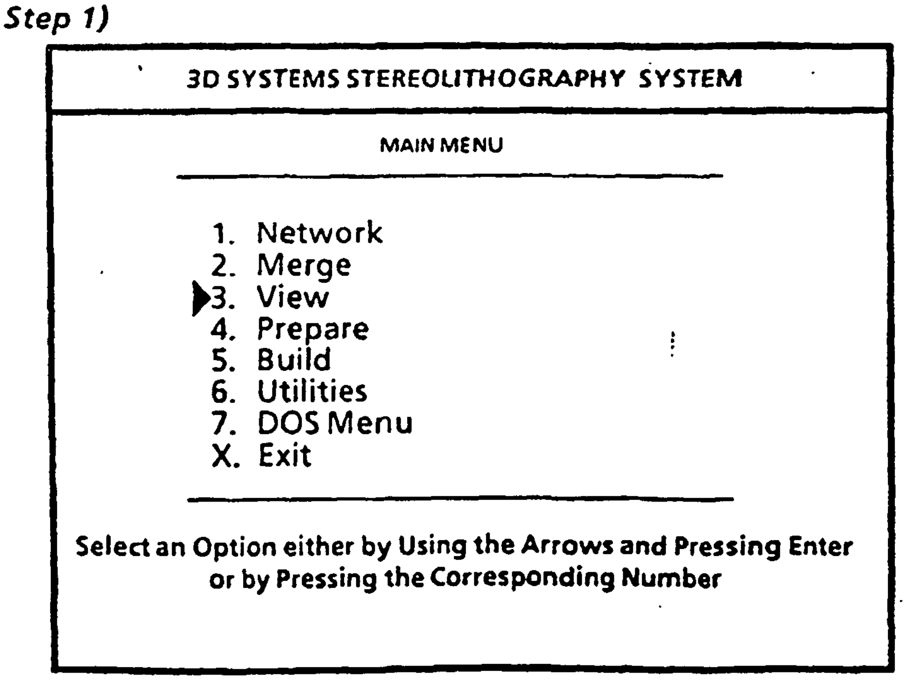


At the Main Menu, select VIEW.

3 *or* locate pointer ENTER ↵

*Step 2)*

```
3D SYSTEMS GRAPHICS DISPLAY PROGRAM

1. Graph Triangles        (.STL file)
2. Graph Sliced Layers    (.SLI file)
3. Change Screen Mode
Q. Quit Program

Enter selection:

Maximum Triangles: 5341     Maximum Layers: 16382
```

Review the disk space allocation shown at the bottom of the screen to determine if memory must be reallocated between the files. In most cases, the defaults will not have to be changed.

*Step 3)* If you need to change the allocation, press 3 to select CHANGE SCREEN MODE, then enter the appropriate number of slice layers at the prompt.

*Viewing StereoLithography Files*

*Step 1)* At the Main Menu, select VIEW.

3 *or* locate pointer [ENTER ↵]

*Step 2)* At the View Menu, press 1 to select GRAPH TRIANGLES.

*Step 3)* At the prompt, enter the StereoLithography filename.

Enter File Name: cam_part [ENTER ↵]

*Step 4)* At the prompt, enter the file type (ASCII or binary).

File "CAM.PART.STL"selected.
Type ASCII or Binary (A,B)?A [ENTER↵]

*Step 5)*

TRIANGLE FILE CONTROL FUNCTIONS

| | |
|---|---|
| Triangle Filename: CAM.PART.STL | Triangle Filetype: ASCII |
| Total Triangles: 484 | |
| File X Min: 3.61324143 | File X Max: 5.26136637 |
| File Y Min: 0.96399999 | File Y Max: 1.37500000 |
| File Z Min: 3.66136622 | File Z Max: 5.38452482 |
| Total Selected: 484 | |
| Selected Min: 3.66136622 | Selected Max: 5.38452482 |
| Sel. X Min: 3.61324143 | Sel. X Max: 5.26136637 |
| Sel. Y Min: 0.96399999 | Sel. Y Max: 1.37500000 |
| Sel. Z Min: 3.66136622 | Sel. Z Max: 5.38452482 |

X Y Z Axis Rotation: 0 0 0
Windowing by File

Slice Axis is Z

| Select: | | | | | | |
|---|---|---|---|---|---|---|
| | N | new file | W | windowing mode | S | select range |
| | A | slice axis | R | rotate | G | graph |

*Step 6)* To rotate the display axes, press R then enter the number of degrees rotation for the X, Y and Z axes at the prompt.

X Y Z Axis Rotation: $15_\wedge 10_\wedge 0$ [ENTER↵]

The screen will automatically update to show the selected rotation of each axis.

*Step 7)* To toggle between display modes, press **W.**

*Step 8)* To change the display axis, press **A** then enter the display axis at the prompt.

New Axis: **X** ENTER↵

The screen will automatically rescan the file and update the screen to show the selected display axis.

*Step 9)* To specify a new file to be graphed, press **N** then enter the filename at the prompt.

Enter File Name: **cam_base** ENTER↵

*Step 10)* To graph the file, press **G.**

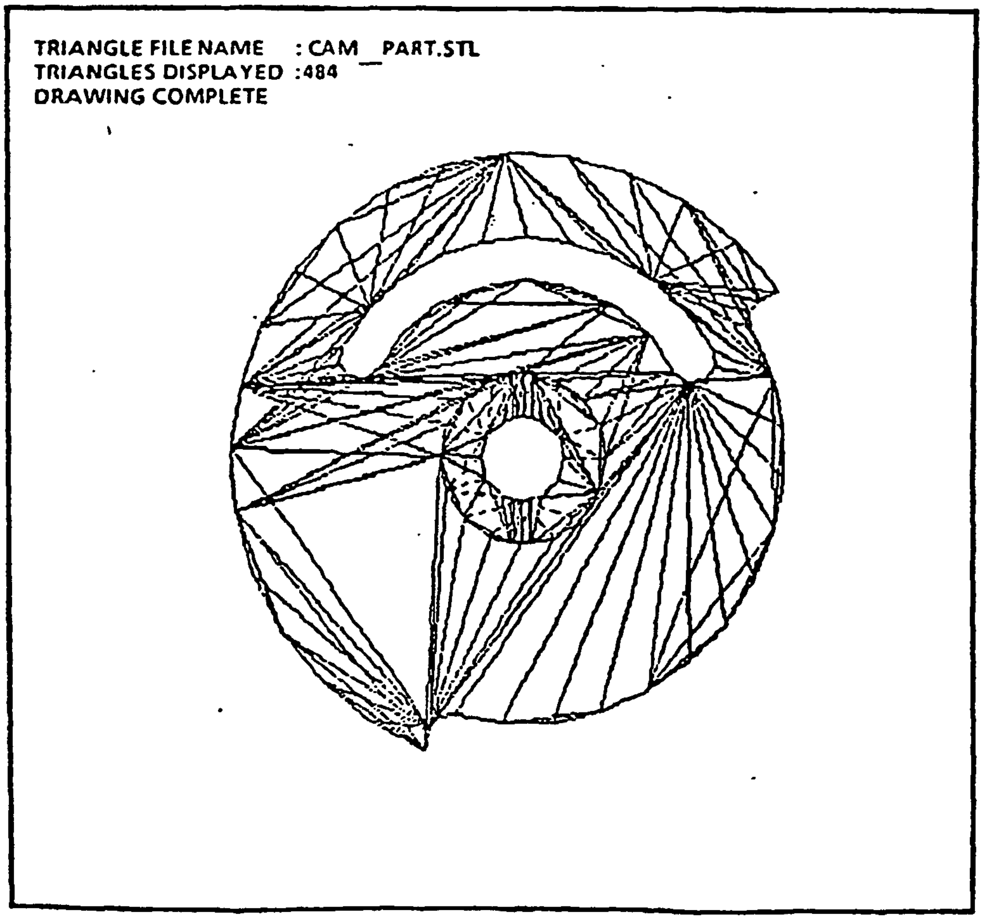

*Viewing Sliced Files*

***Step 1)*** At the Main Menu, select VIEW.

3 *or* locate pointer [ENTER↵]

***Step 2)*** At the View Menu, press 2 to select GRAPH SLICED FILES.

***Step 3)*** At the prompt, enter the Slice filename.

Enter File Name: cam_part [ENTER↵]

***Step 4)***

SLICE FILE CONTROL FUNCTIONS

| | |
|---|---|
| Slice Filename: CAM_PART.SLI | |
| Layer Start: 4800 | Layer End: 6850 |
| File X Min: 18066 | File X Max: 26307 |
| File Y Min: 18307 | File Y Max: 26923 |
| Selected Layer: 4800 | |
| Layer X Min: 21250 | Layer X Max: 23750 |
| Layer Y Min: 21250 | Layer Y Max: 23750 |
| Windowing by File | |
| Layer Blocks: | Display Blocks: |
| L B H | L B H |
| FU B H F | FU B H F |
| FD B H F | FD B H F |
| NFU B H F | NFU B H F |
| NFD B H F | NFD B H F |

Select: N new file L layer select G graph
W Windowing mode B block select

*Step 5)* To select a specific layer to be graphed, press L and enter the layer number at the prompt. Press **PgDn** to move forward through the list and **PgUp** to move backward.

Enter Layer Number: **5000** [ENTER ↵]

The screen will automatically update to show the vector block mnemonics and minimum and maximum dimensions of the layer in slice units.

*Step 6)* To select a vector block in the layer to be "toggled" on or off, press B then enter the block type at the prompt.

Enter Block Type to Toggle: fuh [ENTER ↵]

The selected vector block will be toggled on and off until a new layer is selected or a new file is loaded.

*Step 7)* To toggle between display modes, press W.

*Step 8)* To graph the slice file, press G.

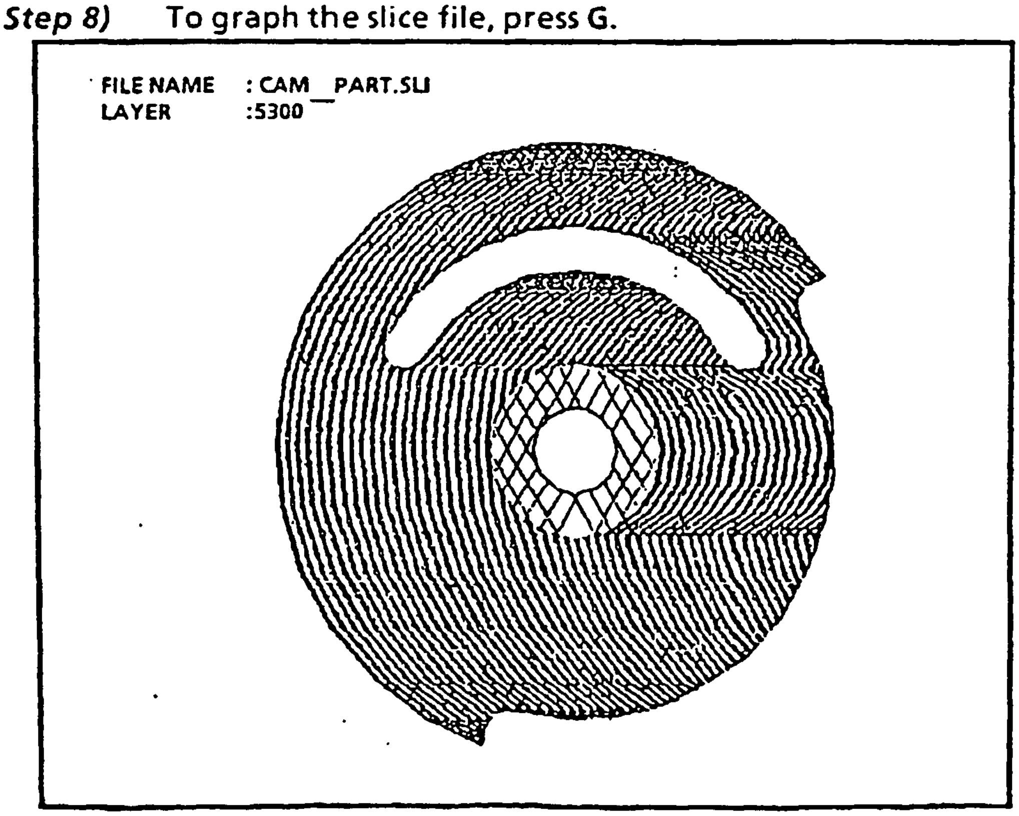

## 3.11 PREPARE

***Overview***

Prepare Menu options are used to specify part building parameters such as laser drawing speed and elevator dipping times, as well as to edit the Range (.R) file.

***Part Building Guidelines***

***Layer Overlap***

Good adhesion between layers is normally attained by giving each layer a 0.006 inch overcure (i.e., the cure depth used for 0.020 inch thick layers is 0.026 inch).

***Dip Delay***

The amount of time required for the surface of the resin to level and settle after a part is dipped is dependent on the geometry of the part and many other factors.

***Common Part Building Parameters***

***SS*** (Step Size) The SLA-1 only appears to draw vectors in continuous motion. The dynamic mirrors actually move the beam in discrete steps followed by short delays. Step size is the size of the move in mirror bits.
In general, step size for borders and crosshatches is set to 2 (the minimum allowable). Step size for skin fill vectors is typically set to 16.

***SP*** (Step Period) is the length of the delay following each laser step. The larger the SP, the slower the laser drawing speed, and thus the greater the depth of cured plastic.

***ZW*** specifies the *leveling* time for the resin surface to settle and level after dipping. Generally, ZW is set to between 30 and 60 seconds for supports. Set ZW to 45 to 180 seconds for normal part building.

***Ranges***

A range is a group of one or more horizontal slice layers defined by lower and upper dimensions entered in CAD units or slice units. A range is created whenever a part building parameter value needs to be specified for a group of layers.

For example, if a dip delay of 30 seconds is required for support layers, and 60 seconds will be used for all remaining layers, two ranges have to be defined. The first would contain the layers of the part with a ZW of 30, the second all layers with a delay of 60.

Another example where ranges are often used is in varying layer cure depths. A range comprised of the first few support layers would be created with larger cure depths than those specified for the rest of the layers.

Prepare Menu options are used to create the necessary ranges.

***Prepare Main Menu***

3D SYSTEMS STEREOLITHOGRAPHY SYSTEM

PREPARE MAIN MENU

1. Parameters Manager
2. Range Manager
3. Layer Manager
4. Statistics

X. Exit

Which Option?

***Parameters Manager Menu***

Parameters Manager is used to add or modify part building parameters.

| | | |
|---|---|---|
| 1. | Z-Pitch .............................. | 100 |
| 2. | XY-only Scale .......................... | 3.556 |
| 3. | Maximum Vector Count................ | 5000 |
| 4. | Minimum Viewport Coordinates ........ | (15000,15000) |
| 5. | Maximum Viewport Coordinates......... | (45000, 45000) |
| 6. | Multiple Part Positioning ................ | (15520, 15000) |
| 7. | Build Options Line: /X-/Y- | |
| U. | Update BUILD parameters on disk | |
| X. | Exit | |

***Z-Pitch***

This parameter controls scaling of the part in the vertical dimension.

***XY-Only Scale Factor***

XY-only scale factor converts a distance in slice units into movement of the laser beam on the surface of the resin.

A characteristic of the dynamic mirrors is that the laser beam will move 1 inch on the resin surface for every 3556 mirror bits sent to the mirror drivers (or 140 bits for every mm). Since 3556 is an inconvenient number to use for slice resolution, a conversion factor is used.

For example, if you slice a CAD file designed in inches with a resolution of 1000, every inch of the object will be represented by 1000 slice units, instead of 3556. Therefore, every vector in the .V file will be too short, by a factor 1000/3556 = .3556, and if it were used without modification, the final part would be too small. BUILD multiplies all vector coordinates in the .V file by the XY-only scale factor. Therefore, this parameter should be set to 3556/1000 = 3.556 to rescale the vectors to their proper lengths. In general, the formula is:

XY-Only Scale = 3556 mirror bits/# slice units per inch

Note that you can also resize your part using XY-only scale factor. For example, to increase the horizontal dimensions of the part described above by 10 percent, use a scale factor of

$$3.556 * 1.10 = 3.912$$

To reduce the horizontal dimensions by 50 percent, use

$$3.556 * 0.50 = 1.778$$

***Maximum Vector Count***

This parameter specifies the maximum number of vectors to be loaded into the dynamic mirrors buffer before they begin moving to build the part.

***Minimum/Maximum Viewport Coordinates***

BUILD viewport coordinates specify the minimum and maximum coordinates (in mirror bits) of the window display of the vat shown on the BUILD status screen. The coordinate limits are (0,0) and (65535,65535).

For example, if you would like to view the cam while it is being built, use viewport coordinates:

NOTE: The cam is approximately 1 inch in diameter.

$$(X_{min},Y_{min}) = \text{vat center - 1/2 part width}$$

$$= 32767 - 0.5 * 3556$$

$$= 30989$$

$$(X_{max},Y_{max}) = \text{vat center + 1/2 part width}$$

$$= 32767 + 0.5 * 3556$$

$$= 34545$$

Note that since the coordinates calculated for the X-Y offsets are for the center of the part, you must subtract enough mirror bits from the offsets to display the entire part. You must add a similar number, at least equal to one-half the part width, to the maximum offsets.

To show the entire 9 inch by 9 inch working surface, enter:

$$(X_{min},Y_{min}) = 32767 - 4.5 * 3556$$

$$= 16765$$

$$(X_{max},Y_{max}) = 32767 + 4.5 * 3556$$

$$= 48769$$

*Multiple Part Positioning*

These parameters are used to both position the part on the elevator platform and to make multiple parts in the same BUILD run.

To calculate the coordinates needed to position a part in the center of the resin vat, you need to know:

- The coordinates of the center of the part in CAD space.
- The coordinates of the center of the vat, which are about (32767,32767). If necessary, exact coordinates can be obtained.

For example, if the part X-Y center is (2.3 inch, 4.1 inch), and the center of the vat is (32767, 32767), then

**X-offset** = vat center - (CAD center ∗ 3556)
= 32767 - (2.3 ∗ 3556)
= 24588

**Y-offset** = vat center - (CAD center ∗ 3556)
= 32767 - (4.1 ∗ 3556)
= 18187

Multiple part positioning coordinates can also be used to make multiple copies of the part in the same run. For example, if you want to make four copies of the part used in the above example, you would calculate four sets of coordinates (X1/Y1, X2/Y2, X3/Y3 and X4/Y4) representing the center of each of the four parts.

If you want all four copies of the part clustered about the center of the resin vat and separated from each other by two inches in both the X and Y directions, calculate the coordinates for the vat center first, as in the previous example, then add and subtract mirror bits equal to half the distance desired between each part.

Separation = 2 inches /2 = 3556 bits

$X1 = X_c + 3556 = 24588 + 3556 = 28144$
$Y1 = Y_c + 3556 = 18187 + 3556 = 21743$

$X2 = X_c - 3556 = 21032$
$Y2 = Y_c - 3556 = 14631$

$X3 = X_c + 3556 = 28144$
$Y3 = Y_c - 3556 = 14631$

$X4 = X_c - 3556 = 21032$
$Y4 = Y_c + 3556 = 21743$

*Build Options Line*

These parameters define the orientation of the BUILD viewport.

***Update Build Parameters* On *Disk***

This command saves all other PARAMETERS MANAGER entries to disk in the build.prm file.

*Range Manager Menu*

RANGE MANAGER
Prepare
working on file CAM.R

| Range | Z-Start | Z-End | Z-Space | CAO-Start | CAD-End | CAO-Space | Count |
|---|---|---|---|---|---|---|---|
| 1 | 3650 | 6850 | 50 | 0.730 | 1.370 | 0.010 | 65 |

Press:

| | | |
|---|---|---|
| A add range | D delete range | E edit range |
| V verify blocks | R make a report | C calc SPs |
| X exit | S save changes on disk | |

RANGE MANAGER is used to:

- add or delete ranges
- calculate step periods (laser drawing speed)
- edit ranges to modify dip delays
- save the Range (.R) file

The RANGE MANAGER Menu lists:

- The Range (.R) filename
- Range numbers assigned when ranges are added.
- Starting and ending range dimensions in both CAD units and slice units. In the screen shown, the slice resolution is 5000, so CAD dimensions 0.73 inch (bottom of the part) and 1.37 inches (top of the part) correspond to slice units 3650 and 6850.
- Layer thickness in both CAD units and slice units.
- Total number of layers in each range.
- Commands used to modify and save the .R file.

***Range Manager Commands***

***A*** adds a range to a temporary range file; the .R file is not changed until the SAVE command is used. The starting range layer can be entered in either slice units or CAD units. The break point is the first layer of the range.

***D*** deletes a range from the screen. If there is more than one range left, the range will be combined into the next higher range if one exists (for example, data from deleted range 2 will be incorporated into range 3; if there is no range 3, the data will be incorporated into range 1).

***E*** lists (for editing) each vector block in a specified range. This command is primarily used to add dipping parameters to ranges.

```
                    Layer Range Blocks
                  working on file CAM.R
RANGE #1
Z-LEVELS:  FROM  3650   TO  6850   BY  50
CAD Units: FROM  0.730  TO  1.370  BY  0.010

Block #  Block ID  Block Command
  1      #TOP
  2      L2
  3      LB2
  4      #BTM
  5      L1
--------------------------------------------
--- MORE BLOCKS ---
Enter F to go forward.
Enter number of block to edit, just Return to stop:
```

***V*** verifies through the Layer (.L) file that only the vector blocks contained in each range are listed for editing in the temporary .R file. It is these blocks which are edited to control step periods, step sizes and other part building parameters. The vector blocks and ranges are not written to the .R file on disk until the file is saved using the S command.

***R*** displays the vector blocks in each range on the screen or prints a hard-copy via the optional printer port.

PREPARE Report for CAM.R

| Range | Z-Start | Z-End | Z-Space | CAD-Start | CAD-End | CAD-Space | Count |
|---|---|---|---|---|---|---|---|
| 1 | 3650 | 6850 | 50 | 0.730 | 1.370 | 0.010 | 65 |

| | | | |
|---|---|---|---|
| Block | 1 | Type | #TOP |
| Block | 2 | Type | L2 |
| Block | 3 | Type | LB2 |
| Block | 4 | Type | #BTM |
| Block | 5 | Type | L1 |
| Block | 6 | Type | LB1 |
| Block | 7 | Type | LH1 |
| Block | 8 | Type | FDB1 |
| Block | 9 | Type | FDF1 |

Press Enter to continue . . .

***X*** exits RANGE MANAGER and returns to the Prepare Main Menu. The .R file is not saved using this command.

***S*** saves the .R file permanently on disk, including all information entered using RANGE MANAGER.

***C*** calculates step periods and enters cure depth/step period information into the temporary range file. CALC SP commands are:

RANGE – CALC SP
Prepare
working on file CAM.R

Laser Power Reading: 12 mW
using working curve data from material file: TEST.MAT

| Range | Z-Start | Z-End | Z-Space | Depth | Est SP | W Min | W Max |
|---|---|---|---|---|---|---|---|
| 1 | 3650 | 6850 | 50 | 50 | 4000 | 0.0 | 0.0 |

Press:

R read material data
P change power rating
V view material data
X exit
S save new range commands
E edit cure depth/step period
Q quit program

***R*** to read lineheight and width data from a material data (.MAT) file. The .MAT files in the working directory are listed on the screen for convenience.

***P*** to change the laser power reading shown on the screen to the latest reading measured by utility BEAM ANALYSIS.

***E*** to edit the cure depth and estimated step period values shown on the screen.

***V*** to display material data from a material data (.MAT) file.

***Q*** to quit the CALC SP function and return to the Main Menu. No changes entered using Prepare Menu options are saved.

***S*** adds SP and SS laser drawing parameters to appropriate vector blocks in the temporary range file. The parameters can be added to all vector blocks in the file, to only border and hatch blocks, or only to fill blocks. In addition, you can choose to update only specific merge-sets. (A merge-set is comprised of vector blocks from only one of the Slice files input to MERGE. Merge-sets are delineated by the number appended to each vector block (i.e., LB2)). Note that this update command does not update the .R file, only the temporary range file. Use the Range Manager Menu SAVE command to save the .R file to disk.

```
Update Range Commands

Block Groups:

0. L  LB  LH  FUF  NFUB  NFUF  FDF  NFDB  NFDH  NFDF  FUB  FDB
1. LB  LH  NFDB  NFDH  NFUB  FUB   FDB
2. FUF  NFUF  FDF NFDF

Use which block group [1]?

Update which merge-sets [all]?
```

***X*** exits CALC SP to the Range Manager Menu.

*Procedures (Lab 2 - Prepare)*

*Parameters Manager*

*Step 1)* At the Main Menu, press **4** to select PREPARE.

*Step 2)* At the prompt, enter the part file name prefix.

Part Prefix: cam [ENTER↵]

*Step 3)*

PREPARE MAIN MENU

1. Parameters Manager
2. Range Manager
3. Layer Manager
4. Statistics
X. Exit

Which Option?

At the Prepare Main Menu, press **1** to select PARAMETERS MANAGER.

*Step 4)* Set XY-only scale factor to .7112 (3556/5000).

*Step 5)* Set X offset to 17000 (32767 - (4.5•3556)).

*Step 6)* Set Y offset to 17000.

*Step 7)* (Optional) To make two parts, set
($X_1$, $Y_1$) to (15000, 15000) and
($X_2$, $Y_2$) to (15000, 25000).

*Step 8)* Set viewport coordinates to:
$X_{min}$, $Y_{min}$ = 5000, 5000
$X_{max}$, $Y_{max}$ = 35000, 35000.

*Step 9* Press U to update file to disk.

***Range Manager***

***Before You Start***

Run utility BEAM ANALYSIS to measure current laser power. Record average of sensor 1 and 2 readings.

***Step 1)***

PREPARE MAIN MENU

1. Parameters Manager
2. Range Manager
3. Layer Manager
4. Statistics
X. Exit

Which Option?

At the Prepare Main Menu, press 2 to select RANGE MANAGER.

***Adding Ranges***

***Step 1)***

RANGE MANAGER
Prepare
working on file CAM.R

| Range | Z-Start | Z-End | Z-Space | CAD-Start | CAD-End | CAD-Space | Count |
|---|---|---|---|---|---|---|---|
| 1 | 3650 | 6850 | 50 | 0.730 | 1.370 | 0.010 | 65 |

Press:

A add range   D delete range   E edit range
V verify blocks   R make a report   C calc SPs
X exit   S save changes on disk

At the Range Manager Menu, press A to add range.

*Step 2)* Press Z to add range dimensions in slice units, or C to enter dimensions in CAD units.

Adding Range
Press Z to enter Z-Layer ... Number: Z [ENTER↵]

*Step 3)* Enter start of range in slice units.

Enter break point, in Z-Layer units: 3750 [ENTER↵]

*Step 4)*

RANGE MANAGER
Prepare
working on file CAM.R

| Range | Z-Start | Z-End | Z-Space | CAD-Start | CAD-End | CAD-Space | Count |
|---|---|---|---|---|---|---|---|
| 1 | 3650 | 3700 | 50 | 0.730 | 0.740 | 0.010 | 2 |
| 2 | 3750 | 6850 | 50 | 0.750 | 1.370 | 0.010 | 63 |

Press:

| | | |
|---|---|---|
| A add range | D delete range | E edit range |
| V verify blocks | R make a report | C calc SPs |
| X exit | S save changes on disk | |

Check screen to verify that range was added properly.

*Step 5)* Add another range starting at 4950.

*Step 6)* Add a fourth range starting at 6000.

*Deleting Ranges*

*Step 1)*

RANGE MANAGER
Prepare
working on file CAM.R

| Range | Z-Start | Z-End | Z-Space | CAD-Start | CAD-End | CAD-Space | Count |
|---|---|---|---|---|---|---|---|
| 1 | 3650 | 3700 | 50 | 0.730 | 0.740 | 0.010 | 2 |
| 2 | 3750 | 4900 | 50 | 0.750 | 0.980 | 0.010 | 24 |
| 3 | 4950 | 5950 | 50 | 0.990 | 1.190 | 0.010 | 21 |
| 4 | 6000 | 6850 | 50 | 1.200 | 1.370 | 0.010 | 18 |

Press:

A add range   D delete range   E edit range
V verify blocks   R make a report   C calc SPs
X exit   S save changes on disk

At the Range Manager Menu, press D to delete range.

*Step 2)* Enter the range number to be deleted.

Delete what range: 3 [ENTER ↵]

*Step 3)*

RANGE MANAGER
Prepare
working on file CAM.R

| Range | Z-Start | Z-End | Z-Space | CAD-Start | CAD-End | CAD-Space | Count |
|---|---|---|---|---|---|---|---|
| 1 | 3650 | 3700 | 50 | 0.730 | 0.740 | 0.010 | 2 |
| 2 | 3750 | 4900 | 50 | 0.750 | 0.980 | 0.010 | 24 |
| 3 | 4950 | 6850 | 50 | 0.990 | 1.370 | 0.010 | 39 |

Press:

A add range   D delete range   E edit range
V verify blocks   R make a report   C calc SPs
X exit   S save changes on disk

Check screen to ensure that range was deleted.

*Verifying Ranges*

***Step 1)***

RANGE MANAGER
Prepare
working on file CAM.R

| Range | Z-Start | Z-End | Z-Space | CAD-Start | CAD-End | CAD-Space | Count |
|---|---|---|---|---|---|---|---|
| 1 | 3650 | 3700 | 50 | 0.730 | 0.740 | 0.010 | 2 |
| 2 | 3750 | 4900 | 50 | 0.750 | 0.980 | 0.010 | 24 |
| 3 | 4950 | 6850 | 50 | 0.990 | 1.370 | 0.010 | 39 |

Press:

| | | |
|---|---|---|
| A add range | D delete range | E edit range |
| V verify blocks | R make a report | C calc SPs |
| X exit | S save changes on disk | |

At the Range Manager Menu, press V to verify blocks.

***Step 2)*** Enter y at the caution message.

Verifying will . . . . commands. Continue? y ENTER↵

*Reporting*

***Step 1)***

RANGE MANAGER
Prepare
working on file CAM.R

| Range | Z-Start | Z-End | Z-Space | CAD-Start | CAD-End | CAD-Space | Count |
|---|---|---|---|---|---|---|---|
| 1 | 3650 | 3700 | 50 | 0.730 | 0.740 | 0.010 | 2 |
| 2 | 3750 | 4900 | 50 | 0.750 | 0.980 | 0.010 | 24 |
| 3 | 4950 | 6850 | 50 | 0.990 | 1.370 | 0.010 | 39 |

Press:

A add range  D delete range  E edit range
V verify blocks  R make a report  C calc SPs
X exit  S save changes on disk

At the Range Manager Menu, press R for report.

***Step 2)*** Press V to view report on screen, or P to print report on printer. The report will not be shown on the screen if the printer option is selected.

***Step 3)***

PREPARE Report for CAM.R

| Range | Z-Start | Z-End | Z-Space | CAD-Start | CAD-End | CAD-Space | Count |
|---|---|---|---|---|---|---|---|
| 1 | 3650 | 3700 | 50 | 0.730 | 0.740 | 0.010 | 2 |

Block 1 Type #TOP
Block 2 Type L2
Block 3 Type LB2
Block 4 Type #BTM

Press Enter to continue . . .

Press ENTER↵ to continue.

*Calculating Step Periods*

***Step 1)***

RANGE MANAGER
Prepare
working on file CAM.R

| Range | Z-Start | Z-End | Z-Space | CAD-Start | CAD-End | CAD-Space | Count |
|---|---|---|---|---|---|---|---|
| 1 | 3650 | 3700 | 50 | 0.730 | 0.740 | 0.010 | 2 |
| 2 | 3750 | 4900 | 50 | 0.750 | 0.980 | 0.010 | 24 |
| 3 | 4950 | 6850 | 50 | 0.990 | 1.370 | 0.010 | 39 |

Press:

| | | |
|---|---|---|
| A add range | D delete range | E edit range |
| V verify blocks | R make a report | C calc SPs |
| X exit | S save changes on disk | |

At the Range Manager Menu, press C to calculate step periods.

*Step 2)*

RANGE – CALC SP
Prepare
working on file CAM.R

Laser Power Reading: 12 mW
using working curve data from material file: TEST.MAT

| Range | Z-Start | Z-End | Z-Space | Depth | Est SP | W Min | W Max |
|---|---|---|---|---|---|---|---|
| 1 | 3650 | 3700 | 50 | 50 | 4000 | 0.0 | 0.0 |
| 2 | 3750 | 4900 | 50 | 50 | 4000 | 0.0 | 0.0 |
| 3 | 4950 | 6850 | 50 | 50 | 4000 | 0.0 | 0.0 |

Press:

R read material data
P change power rating
V view material data
X exit
S save new range commands
E edit cure depth/step period
Q quit program

At the CALC SP Menu, press P to change laser power reading.

*Step 3)* Enter average laser power from BEAM ANALYSIS.

Enter new laser power reading (mW): ____ [ENTER ↵]

*Step 4)* At the CALC SP Menu, press E to edit cure depth/step period data.

*Step 5)* Enter the cure depth necessary to adhere "roast" the first range (containing the first two layers of the supports) to the platform by entering C followed by the range number and new cure depth.

c1,35 [ENTER ↵]

NOTE: The cure depth selected should be at least 6 mils greater than the layer thickness for adequate bonding between layers. The cure depth for the first few layers of supports should be deeper for strong bonding to the platform. In this case, the required cure depth is 35 mils.

*Step 6)* Enter cure depths of 16 for all layer borders and hatches in ranges 2 and 3.

C2,16 [ENTER ↵]

C3,16 [ENTER ↵]

*Step 7)*

```
RANGE -- CALC SP
Prepare
working on file CAM.R

Laser Power Reading:
using working curve data from material file:   TEST.MAT

Range  Z-Start  Z-End  Z-Space  Depth  Est SP  W Min  W Max
  1    3650     3700   50       35     640     15.7   0.0
  2    3750     4900   50       16     20      10.8   0.0
  3    4950     6850   50       16     20      10.8   0.0

Press:

 R read material data          S save new range commands
 C change power rating         E edit cure depth/step period
 V view material data          Q quit program
 X exit
```

At the CALC SP Menu, verify the changes.

*Step 8)* At the CALC SP Menu, press S to save ranges.

*Step 9)*

```
Update Range Commands

Block Groups:

0. L  LB  LH  FUF  NFUB NFUF  FDF  NFDB  NFDH NFDF  FUB  FDB
1. LB  LH  NFDB  NFDH NFUB  FUB  FDB
2. FUF  NFUF  FDF NFDF

Use which block group [1]?

Update which merge-sets [all]?
```

Specify which vector block group to update, or press [ENTER ↵] to select the default group shown in the brackets.

Use which block group [1]?

*Step 10)* Specify the merge set(s) to be updated, or press ENTER↵ to select the default shown in the brackets.

Update which merge-sets [all]? ENTER↵

*Step 11)* Begin editing skin cure depths by pressing E then entering a cure depth of 26 mils (this is 6 mils greater than the selected 20 mil layer thickness).

C2,26 ENTER↵

*Step 12)* Divide the resultant step period (90) in half, then press E and enter that value for the skin fill SP in ranges 2 and 3.

S2,45 ENTER↵
S3,45 ENTER↵

*Step 13)* Press S to save the file.

*Step 14)* At the prompt, specify update of skin fill blocks (block group 2).

Use which block group [1] ? 2 ENTER↵

*Step 15)* At the prompt, press ENTER↵ to update all merge sets.

Update which merge sets [all] ? ENTER↵

*Step 16)* At the CALC SP Menu, press X to exit the CALC SP function.

*Step 17)* At the Range Manager Menu, press E to edit a range to add dip delays.

*Step 18).* At the prompt, enter 1 to edit range 1.

Edit what range? 1 ENTER↵

*Step 19)* At the prompt, add a dip delay of 30 seconds to the #BTM record.

Enter commands for #BTM: ZW^30 [ENTER ↵]

*Step 20)* Edit range 2 to add a 30 second dip delay.

*Step 21)* Edit range 3 to add a 120 second dip delay.

*Step 22)*

RANGE MANAGER
Prepare
working on file CAM.R

| Range | Z-Start | Z-End | Z-Space | CAD-Start | CAD-End | CAD-Space | Count |
|---|---|---|---|---|---|---|---|
| 1 | 3650 | 3700 | 50 | 0.730 | 0.740 | 0.010 | 2 |
| 2 | 3750 | 4900 | 50 | 0.750 | 0.980 | 0.010 | 24 |
| 3 | 4950 | 6850 | 50 | 0.990 | 1.370 | 0.010 | 39 |

Press:

| | | |
|---|---|---|
| A add range | D delete range | E edit range |
| V verify blocks | R make a report | C calc SPs |
| X exit | S save changes on disk | |

At the Range Manager Menu, press S to save the .R file to disk.

## INTERMEDIATE TOPICS

### *Layer Manager Menu*

LAYER MANAGER
Prepare
working on file CAM.L

| Range | Z-Start | Z-End | Z-Space | Count |
|---|---|---|---|---|
| 1 | 3650 | 3700 | 50 | 2 |
| 2 | 3750 | 4900 | 50 | 24 |
| 3 | 4950 | 6850 | 50 | 39 |

Press:

F find blocks    E edit layer file    U update disk
X exit    Q quit program

LAYER MANAGER is used primarily to find specific vector blocks in the .L file. Its other capabilities, edit and update, are advanced features.

The LAYER MANAGER screen shown above lists:

- The .L filename
- The number of ranges specified in the .R file.
- Starting and ending range dimensions in slice units.
- Layer thickness in slice units.
- The total number of layers in the range.
- Operating commands.

### *Layer Manager Commands*

***F*** finds specific vector blocks in the .L file and lists the layer numbers.
For example, if you would like to determine where merge-set 3 starts in Z space, press F to find blocks then enter L3 and ALL at the prompts.
LAYER MANAGER will list all slice layers containing vector block L3 on the screen. This is fast and convenient, when compared to exiting the Prepare Menu and running VIEW to locate particular vector blocks.

*Statistics*

```
Statistics for part CAM:

Directory of C: \WORK

    CAM   L      5043    2-16-88    4:52P
    CAM   R       677    2-16-88    4:54P
    CAM   V    480980    2-16-88    4:52P

        3 FILES     8667136 bytes free


 Press Enter to Continue:
```

STATISTICS lists layer, range and vector file information, including:

- file sizes in bytes
- Date and time files were created
- free disk space

*Procedures (Lab 3 - Prepare)*

*Statistics*

*Step 1)*

PREPARE MAIN MENU

1. Parameters Manager
2. Range Manager
3. Layer Manager
4. Statistics
X. Exit

Which Option?

At the Prepare Main Menu, press **4** to select STATISTICS.

*Step 2)*

Statistics for part CAM:

Directory of C: \WORK

| | | | | |
|---|---|---|---|---|
| CAM | L | 5043 | 2-16-88 | 4:52P |
| CAM | R | 677 | 2-16-88 | 4:54P |
| CAM | V | 480980 | 2-16-88 | 4:52P |

3 FILES 8667136 bytes free

Press Enter to Continue:

Press ENTER↵ to continue.

**3.12 BUILD**

*Overview*

BUILD supervises the part-making process by reading the Vector (.V) and . Range (.R) files and sending appropriate commands and parameters to the dynamic mirrors and elevator driver. This includes:

- deflecting the laser beam to trace vectors on the surface of the resin vat
- controlling the speed of the laser pass to ensure appropriate cure depths
- controlling the dipping sequence between layers (dip, raise, and level)

***BUILD Options Screen***

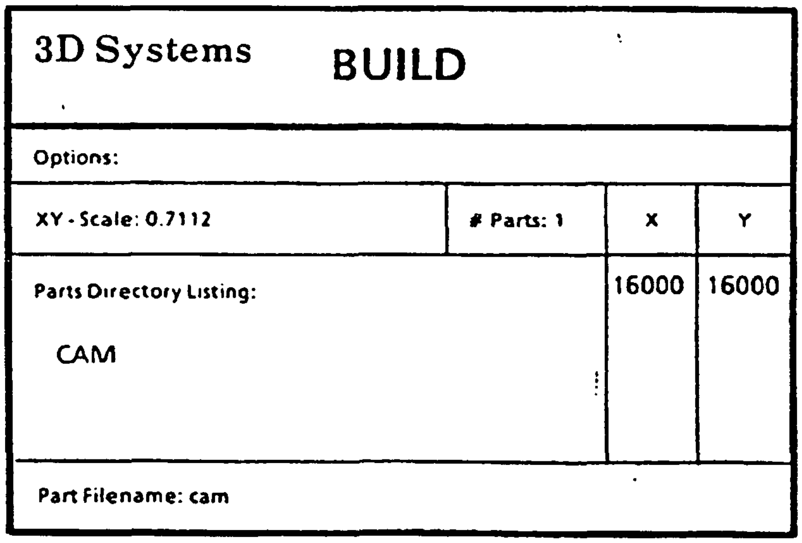


This screen is used to enter the part filename and to display part building information.

| | |
|---|---|
| **Options** | see Intermediate Topics or Prepare Menu option PARAMETERS MANAGER |
| **XY-Scale** | lists the XY-only scale factor |
| **# Parts** | shows the number of duplicate parts to be built |
| **X,Y** | lists the multiple part positioning coordinates |
| **Parts Directory Listing** | lists the files in the working directory |
| **Part Filename** | specifies the part to be built |

***BUILD Status Screen***

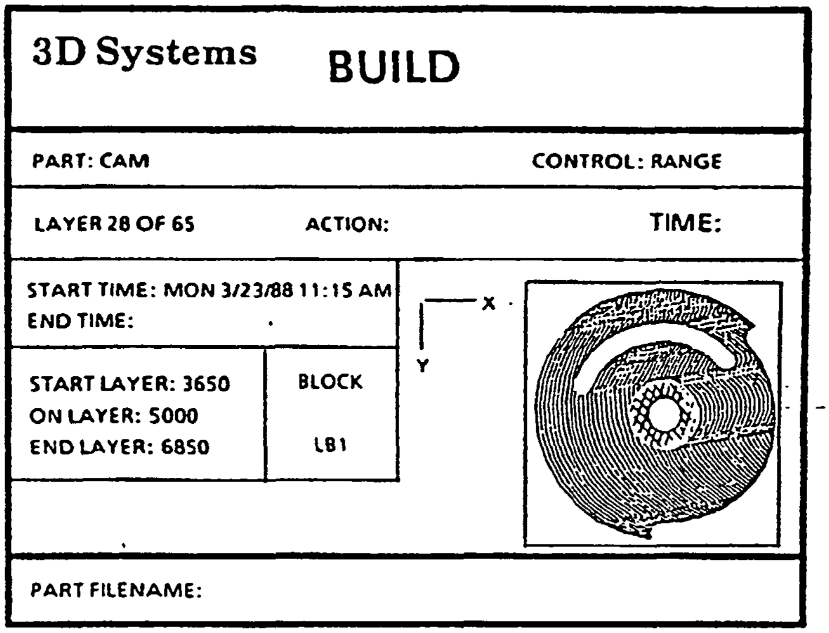


This screen displays current status information while the part is being built.

| | |
|---|---|
| **Part** | shows the name of the part being built |
| **Control** | specifies range control (default) |
| **Action** | lists the current BUILD action<br>Loading if data for laser beam positioning are being loaded into the buffer.<br>Leveling if BUILD is dipping or waiting for resin to settle and level following dipping.<br>Drawing if vectors are being traced on the surface of the resin vat.<br>Analysing if BUILD is analysing or correcting laser mirror drift. |
| **Time** | lists the number of seconds remaining in the dip delay. |
| **Start/End Times** | lists BUILD starting and ending times and dates. |
| **Start/On/End Layer** | lists starting and ending part layer numbers, and the layer currently being drawn. |
| **Block** | lists the mnemonic of the vector block currently being processed. |
| **Viewport** | shows a top view of the resin vat and part cross-section. Vectors are traced on the screen as they are drawn on the surface of the resin. |

***Procedures (Lab 2 - Build)***

***Before You Start***

- Position the elevator platform slightly below the surface of the resin using ELEVATOR MOVER.
- Open the resin spillway valve on the front of the vat to allow resin displaced by the platform support rods to flow into the overflow container.

- Raise the elevator until the top surface of the platform is slightly above the resin level.
- Close the door to the process chamber.
- Verify that the LASER ON and SHUTTER OPEN indicators are on. Use POWER SEQUENCER to turn on the laser or close the shutter, as required.

***Step 1)***

**3D SYSTEMS STEREOLITHOGRAPHY SYSTEM**

**MAIN MENU**

1. Network
2. Merge
3. View
4. Prepare
5. Build
6. Utilities
7. DOS Menu
X. Exit

**Select an Option either by Using the Arrows and Pressing Enter or by Pressing the Corresponding Number**

At the Main Menu, select BUILD.

5 *or* locate pointer ENTER ↵

*Step 2)*

| 3D Systems BUILD | | | |
|---|---|---|---|
| Options: | | | |
| XY - Scale: 0.7112 | # Parts: 1 | X | Y |
| Parts Directory Listing:<br>CAM | | 16000 | 16000 |
| Part Filename: | | | |

Enter the part filename from the files listed.

Part Filename: cam ENTER↵

*Step 3)*

| 3D Systems BUILD | | | |
|---|---|---|---|
| PART: CAM | | CONTROL: RANGE | |
| LAYER 1 OF 65 | ACTION: DRAWING | TIME: | |
| START TIME: MON 3/23/88 11:15 AM<br>END TIME: | | X<br>Y | 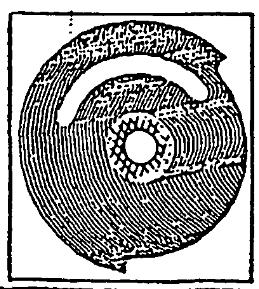 |
| START LAYER: 3650<br>ON LAYER: 3650<br>END LAYER: 6850 | BLOCK<br>LB2 | | |

Check the status screen and part periodically to verify:

- That the first few layers adhere to the elevator platform
- That the part is centered in the resin vat
- That layers with different layer thickness values adhere to one another

Abort BUILD, by pressing , if there are part making problems. This will return you to the Main Menu.

**INTERMEDIATE TOPICS**

***Keyboard Commands***

During the *leveling* action, BUILD accepts three keyboard commands.

**P** pauses BUILD until any other key is pressed. The leveling time will continue to count down to zero. A pause message is displayed in the command line at the bottom of the screen.

**C** continues the part building process by overriding the remaining leveling time period and immediately starting the next layer.

**S** skips to a specified Z level. The first layer at or above that Z level will be drawn. This command works only in the direction from lower to higher Z levels.

***Command Line Options***

**/LOFF** turns off the dynamic mirrors driver. This option is used in conjunction with /ZOFF to run BUILD without making a part.

**/ZOFF** turns off the elevator driver. This option is used in conjunction with /LOFF to run BUILD without making a part

**/START** specifies a starting Z level for part building. All lower layers are skipped. Use /START to start building in the middle of a part.

For example, to start building the sample part at Z level 5000, enter:

Part Filename: cam/start∧5000 [ENTER ↵]

**/STOP** specifies an ending Z level for part building. All upper layers are skipped.

Use this option, in conjunction with /START, to build a cross-section of the part. For example, to build all layers between Z levels 5000 and 5500, enter:

Part Filename: cam/start^5000/stop^5500 [ENTER ↵]

The elevator will not dip after the last layer is drawn.

The /LOFF and /ZOFF commands are commonly used with /START and /STOP to check if the part fits in the viewport.

For example, enter:

Part Filename: cam/zoff/loff/start^5000/stop^5050 [ENTER ↵]

The mirrors will not draw the layer and the elevator will not move. If the part is displayed on the viewport properly, restart BUILD with no command line options to build the part. Otherwise, edit the viewport coordinates using PARAMETERS MANAGER.

### 3.13 POST PROCESS

#### *Overview*

Post process involves curing and finishing *green* StereoLithographic parts. Green parts are composed of semi-hard plastic and liquid with the exact composition dependent on several factors, including the resin being used and the type of crosshatching selected.

The major post process steps are:

- Draining excess resin into the resin vat.
- Wicking to remove resin from corners and other part details.
- UV Curing to solidify uncured portions of the part.
- Removing supports
- Optional finishing: sanding, sandblasting, painting.

***General Information***

***Draining***

Drains liquid resin from the part back into the resin vat. Draining times generally range from 30 minutes to 24 hours. Note, however, that longer exposure to air will weaken the part structure and may inhibit UV curing. Thermal ovens do speed up the process, but may adversely affect the dimensional accuracy of the part.
Use care when tilting and otherwise handling *green* parts. Layers can peel or deform readily before UV curing.

***Wicking***

Removes excess liquid trapped in corners and around small details of the part.

***UV Curing***

Finishes the polymerization process to produce a hard plastic part. Test for surface tackiness to ensure complete curing.
The general procedure is to cure all exposed surfaces while the part is attached to the platform, then remove the platform and cure all remaining surfaces.

***In Air***

This is the most common curing method. Cure parts within 12 hours of exposure to air to maintain structural soundness. The disadvantages to air curing are that parts may yellow and distort due to excess heating.

***In Water***

Curing times can be reduced dramatically by immersing parts in water, since water does not absorb UV light and acts as a "heat sink" to cool the part and minimize heat distortion. Remove all air bubbles, since they may cause blistering. Short, rapid curing sessions (i.e., 5 minutes) work best.

***Removing Supports***

Remove supports from the part by clipping or sanding.

*Procedures (Lab 2 - Post Process)*

*Draining*

*Step 1)*

**3D SYSTEMS STEREOLITHOGRAPHY SYSTEM**

**MAIN MENU**

1. Network
2. Merge
3. View
4. Prepare
5. Build
6. Utilities
7. DOS Menu
X. Exit

Select an Option either by Using the Arrows and Pressing Enter or by Pressing the Corresponding Number

At the Main Menu, select Utilities option.

6 *or* locate pointer ENTER ↵

*Step 2)*

**3D SYSTEMS STEREOLITHOGRAPHY SYSTEM**

**UTILITY MENU**

1. Power Sequencer
2. Beam Analysis
3. Elevator Mover
4. Material Manager
5. Edit A File
6. Make Test Parts
X. Return to Main Menu

At the Utility Menu, press **3** to select ELEVATOR MOVER.

***Step 3)*** **Using the up arrow key on the numeric keyboard, slowly raise the elevator 3 inches. (Go slow to avoid distorting the part.)**

***Step 4)*** **Wait about 30 minutes for excess resin to drain into resin vat.**

***Part and Platform Removal From Chamber***

***Step 1)*** Place a drain pad in the drain tray.

***Step* 2)** Place the drain tray on top of the resin vat and below the elevator platform.
**CAUTION:** DO NOT RUN THE ELEVATOR INTO THE DRAIN TRAY WHEN REMOVING THE PLATFORM FROM THE ELEVATOR RODS. THIS MAY DAMAGE THE ELEVATOR.

***Step 3)*** Toggle the down arrow key to lower the elevator platform until it is about ¼ inch above the drain pad.

***Step 4)*** Alternately turn the elevator shaft knobs one turn CCW. This will unscrew the threaded end of the shafts from the platform. Repeat this step until the platform drops free from the shafts onto the drain pad.

***Step 5*)** Toggle the up arrow key to raise the elevator shafts, as necessary for removal of the drain tray and platform.

***Step 6*)** Remove the drain tray and elevator platform with attached part from the process chamber. Hold the platform level to avoid damaging the part.

***Wicking***

***Step 1)*** Place the drain tray and elevator platform with attached part on a work surface.

***Step 2)*** Using swabs, gently remove excess resin from corners, details and other areas that did not drain fully. Wait and repeat as necessary.

***Post Curing***

**WARNING: Wear gloves at all times.**

***Step 1)*** Place the drain tray and elevator platform with attached part in the PCA.
**WARNING: Do not put drain pads or any other flammable material in the PCA.**

***Step 2)*** Post cure the part until all surfaces exposed to the UV lamps are no longer tacky. Use short cure periods (5 to 10 minutes).

***Step 3)*** Using a fine tooth saw, carefully cut the supports near where they attach to the platform.

***Step 4)*** Clean the part to remove sawdust and fragments before continuing. Properly dispose of residue.

***Step 5)*** Turn the part upside down (or rest it on its side) as needed to expose uncured surfaces to the UV lamps in the PCA.

***Step 6)*** Post cure the part until all surfaces are no longertacky. This may take several separate runs.

***Platform Replacement***

***Step 1)*** Scrape resin residue from the platform. Tap out threaded holes in platform with a # 10-32 tap.

***Step 2)*** Hold the platform under the elevator rods so that threaded holes in the platform line up with the threaded ends of the rods.

***Step 3)*** Alternately turn the shaft knobs CW one turn. Repeat this step until the platform is securely installed on the elevator shafts.

*Removing Supports and Finishing*

***Step 1)*** Carefully cut away supports with files, grinding tools, side cutting pliers or other appropriate tools.

***Step 2)*** Smooth surfaces using files.

***Step 3)*** Sand, sandblast and paint part as required.

***Operating the PCA***

***Step 1)***

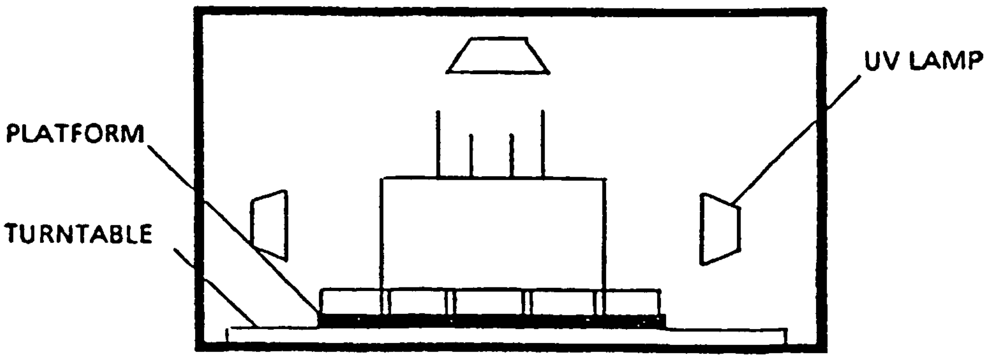


Place part, still attached to platform, in center of oven. Orient lamps for even exposure (as close to 90 degrees as possible) of the greatest number of surfaces.

***Step 2)*** Set timer to 10 to 20 minutes.

***Step 3)*** After time expires, set MAIN POWER switch to OFF.

***Step 4*)** Remove part and platform from oven and separate part from platform. Use care to avoid distorting uncured surfaces.

***Step 5)***

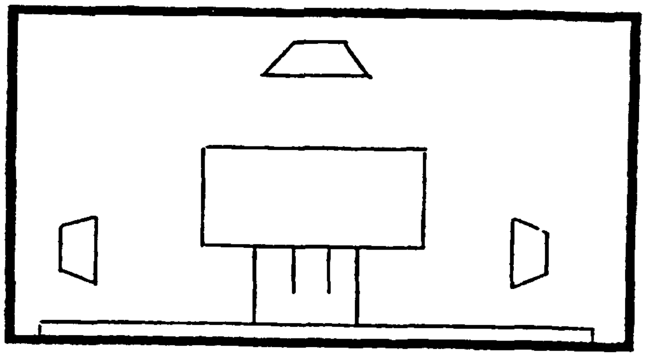

Reorient part on turntable to expose most of the remaining surfaces.

***Step 6*)** Repeat steps 2 and 3.

***Step 7)***

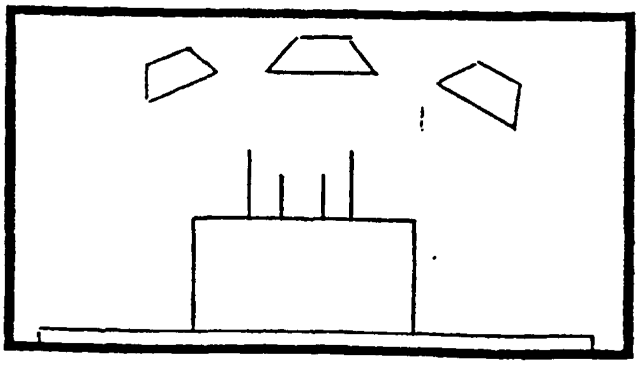

Reorient part and lamps to best position to cure all remaining surfaces. This may take several runs.

**3.14 PART BUILDING CHECKLIST**

***Scope***

This checklist is a step-by-step guide to building StereoLithographic parts. The starting point is a CAD design made without reference to StereoLithography. All required hardware and software systems are assumed to be installed and operational.

***Checklist***

**1. CAD Design**

_ Verify that objects define enclosed volume

_ Select required CAD resolution

**2. Orient Part**

_ Position part entirely in positive CAD space, as close _ to origin as possible

- Optimize orientation to:
  - Enable part to fit in resin vat
  - Minimize number of unsupported surfaces
  - Maximize vertical and up facing horizontal surfaces
  - Minimize slanted or sloping surfaces
  - Optimize draining
  - Minimize volume of entrapped liquid

**3. Design and Orient Supports**

- Design Supports
  - Placement
  - Spacing :
  - Orientation
  - Height
  - Width
  - Thickness
- Overlap Supports 2 to 3 Layers into Object

**4. CAD Interface**

- Create StereoLithography files
- Transfer .STL files to Slice Computer

**5. Slice**

- Alter standard options
  - DATABASE Filename
  - Resolution
  - Layer Thickness
  - Hatch Spacing
  - Skin Fill Spacing

Minimum Surface Angle for Scanned Facets

Minimum Hatch Intersect Angle

Output File Name

_ Specify extra parameters

_ Save options file

_ DoSlice to slice file

_ Repeat to slice all object and support files

6. Transfer Slice Files to Control Computer

_ Select NETWORK From Main Menu

_ Run FTP

_ GET or MGET Files

_ Check Control Computer working directory to _ verify transfer

7. Merge

_ Select MERGE from Main Menu

_ Enter input and output filenames

_ Record filenames and sequence entered

_ Check MERGE screen to verify complete Run

8. Measure Laser Power

_ Select UTILITIES from Main Menu

_ Run BEAM ANALYSIS

_ Record average power from both sensor readings

9. Parameters Manager

_ Calculate and enter X-Y only scale factor

_ Calculate and enter minimum/maximum viewport courdinates

_ Calculate and enter multiple part positioning coordinates

10. Prepare Range File

_ Add ranges

_ Verify blocks

_ Edit cure depths to calculate step periods

_ Edit dipping parameters

_ Save range file

11. Check System

_ Top off vat with resin

_ Open overflow valve

_ Check indicators for laser and shutter status

_ Position elevator platform using ELEVATOR MOVER

12. Build Part

_ Select BUILD from Main Menu

_ Check first few layers for adherence to platform and proper location in vat

13. Post Process

_ Raise part and drain excess resin into vat

_ Remove remaining resin by wicking

_ UV cure part on platform

_ Finish curing and separate part from platform

_ Remove supports from part

_ (Optional) refinishing

_ Clean and reinstall platform

14. (Optional) View StereoLithography and Slice Files

_ If viewing .STL File, transfer file using FTP.

- Select VIEW from Main Menu
- Input filenames and specify viewing parameters

## SECTION 4.0

## PROBLEM SOLVING TECHNIQUES

### 4.1 LIMITATIONS OF STEREOLITHOGRAPHY

***File Size***

- The maximum StereoLithography (.STL) file size is limited to approximately 14.000 triangles.
- The total size for all MERGE input files is limited to about one-half the available space on the Control Computer hard disk. Use DOS Menu option DISK USAGE STATS to display available hard disk space.
- The maximum size of BUILD working files -- Vector (.V), Range (.R), Layer (.L) and BUILD.PRM - is limited by available space on the Control Computer hard disk.

***Part Building Limitations***

- The formed part (object and supports) is limited to 9 inches in any dimension. You can, however, build sections of a large part in several runs, then reassemble it during post processing.
- Parts must be attached to the platform (they cannot be built in free space). Potential free floating sections must also be supported to hold them in place when the part is dipped.
- The maximum (recommended) cure depth is 0.036 inch. This is because working curves used to equate cure depth to step period do not extend past 36 mils. This in effect limits the maximum layer thickness to 0.030 inch.
- Vertical and up-facing horizontal skins are smoother than down-facing skins. You can minimize the impact of this limitation by orienting the part so that aesthetically important surfaces are oriented vertically or upward facing.
- Vertical resolution is limited to one layer thickness. This limitation can be minimized by using variable layer thickness to specify thinner surfaces in areas where vertical resolution and dimensions are important. You can also orient the part to change the vertical dimension (e.g., from Z to X or Y).
- The maximum theoretical slice resolution is 65,535 bits.
- The laser beam positioning accuracy is limited to 2 mils anywhere in the working field.
- The maximum number of files that can be merged and built in one run is 10.
- With standard defaults, the Step Period (SP) parameter cannot be less than 10. The default value can, however, be modified using Prepare Menu options.
- The resolution achievable on the final part is limited by the resolution of the CAD model used to create the .STL file.
- The (Desolite SLR 800) resin is brittle after post curing.

### 4.2 Part Building Problems and Remedies

Common part building problems are summarized in the following table along with remedial actions. This list does not include hardware and software faults covered by troubleshooting procedures in the SLA-1 Users Manual.

| PROCESS STEP | PROBLEM | REMEDY |
|---|---|---|
| **CAD Design** | CAD model not an enclosed volume. StereoLithography file will not slice. | Redesign the model so that horizontal cross-sections consist of closed curves which completely separate the inside and outside of the part. |
| **Orient & Support** | All Objects not in positive CAD space. Stereo-Lithography file will not slice. | Translate object into positive XYZ space. Position as close to origin as possible. |
| | Liquid resin entrapped when part is built. This slows part building. | Reorient part so that it drains as it is built. If this is not possible, section the part, build the sections separately, then reassemble it during post processing. Another alternative is to add drain and "chimney" holes in surfaces as necessary. |
| | Supports droop or fall through the holes in the platform. | Redesign supports to be at least 0.65 inch wide where they contact the platform. |
| | The object did not attach adequately to the supports. | Redesign the supports so they overlap the part vertically by two to three layer thicknesses (typically 40 to 60 mils). The object and support layers in this overlap region must have the same or evenly divisible layer thicknesses. |
| | Layers skew so that the part is built with a vertical slant. | Add cross, circular or triangular web supports. |
| **Orient & Support (Cont'd)** | Part layers sag or curl. | Add more supports. The supports are generally spaced 0.1 to 0.8 inch apart. |
| | Sections of the part drift when the part is dipped. | Add supports to anchor drifting sections. |
| **Slice** | File sliced along wrong axis. Object is built directly on platform. | Rerun slice and change the slice vertical axis (extra parameter) to match the vertical CAD axis. |
| | Wrong units used for layer thickness (inches instead of mils). | Rerun SLICE with correct layer thickness. |
| | Slice resolution too low. Triangles collapse resulting in part deformation. | Rerun SLICE with higher resolution. |
| | Near-flat surfaces are too rough ("stair-step" appearance). | Rerun SLICE with thinner layers in near-flat regions or sand finished part. |

(continued)

| PROCESS STEP | PROBLEM | REMEDY |
|---|---|---|
| | The part has gaps in near-flat surfaces. | Rerun SLICE and increase the MSA (minimum surface angle for scanned facets). Too large an MSA will, however, cause SLICE to generate more skin vectors than necessary, thereby increasing the run time and file size. |
| **Network & Merge** | Insufficient disk space. | Delete or archive obsolete/old files. |
| **Prepare** | Layers separate or curl due to inadequate inter-layer bonding. | Check first to see whether the current laser power was used when CALC SP was run. If not, run utility B EAM ANALYSIS to measure the laser power, then rerun RANGE MANAGER option CALC SPS to recalculate step periods. If the current laser power was used, rerun CALC SPs to ensure a 6 mil excess cure depth. |
| **Prepare (Cont'd)** | The first layer of the supports did not adhere to the platform. | Increase its step period to three times the value recommended using RANGE MANAGER option CALC SPs, and/or adjust the starting elevator platform height. |
| | Horizontal surfaces bulge upward. | Increase the dip delay (parameter ZW) using RANGE MANAGER, or increase the height of the supports so that the part is suspended at least 0.25 inch above the platform. Surfaces tend to bulge when new layers are built on excess resin that has not had enough time to flow over the edges of the part. |
| | The final part is not the same size as the CAD model. | Correct the XY-only scale factor using PARAMETERS MANAGER, then rerun BUILD. |
| | The part is not shown, or is only partially shown, on the BUILD viewport. | Enter new viewport coordinates using PARAMETERS MANAGER , then rerun BUILD. |

**SECTION 5.0**

**ADDITIONAL READING**

5.1 Laser Theory
5.2 The Chemistry of StereoLithography
5.3 Bullets, Banjotops and Working Curves

## 5.1 LASER THEORY

### *The SLA-1 Laser*

The SLA-1 uses a helium-cadmium, multimode ultraviolet laser to draw vectors on photo-curable resin, thereby forming hard plastic parts. The laser beam power varies and is nominally 15 milliwatts at a wavelength of 325 nanometers.

Ultraviolet light is invisible to the human eye, but almost everything, including the resin, fluoresces when struck by UV light of the intensity supplied by the SLA-1 laser. Thus, it is easy to see the laser beam where it strikes a surface. This is especially useful when aligning the optics, and also enables you to watch the laser draw on the surface of the resin.

As shown below, the SLA-1 laser consists of a U-shaped glass plasma discharge tube with an electrode at both ends and an optical window at either end of the straight section. The plasma tube is filled with helium gas at low pressure and has an attached reservoir of solid cadmium.

The cadmium reservoir is heated to vaporize cadmium which mixes with the helium gas. A high voltage potential applied across the plasma tube electrodes ionizes this gaseous mixture to create an electric field. Free electrons, accelerated by the electric field, strike and transfer energy to the cadmium atoms. This energy causes the cadmium atoms to enter an unstable, excited energy state.

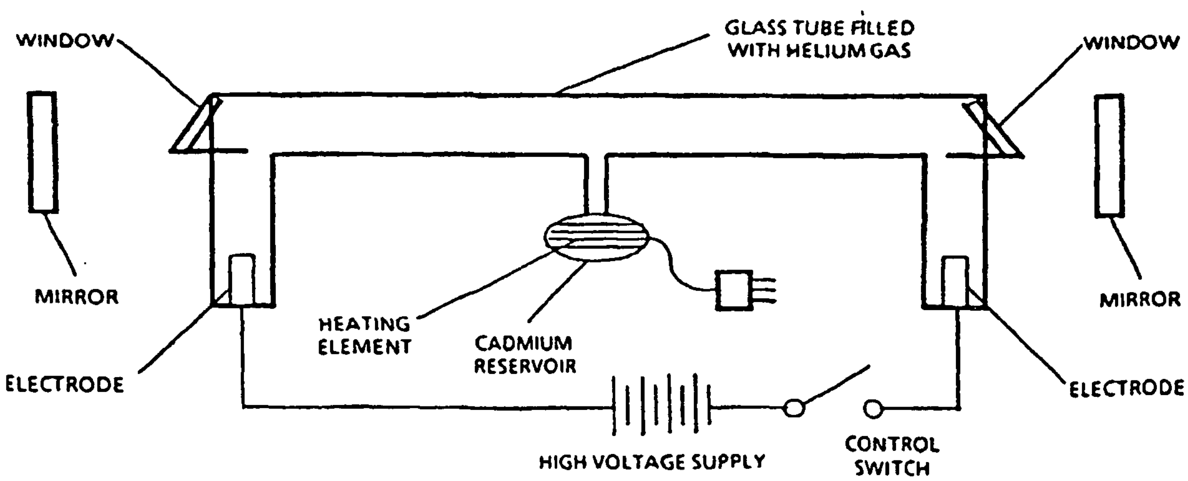


*A simplifed schematic of the SLA-1 He-Cd laser*

The excited atoms spontaneously give up their excess energy and return to an unexited, stable state. The excess energy is often emitted in the form of photons (discrete units of light energy), at precise wavelengths characteristic of cadmium.

The device described thus far is a weak plasma discharge lamp, not a laser. To make a laser, we add special, perfectly aligned parallel mirrors to either end of the plasma tube. These mirrors define an "optical resonator" and are designed to reflect photons at one of the characteristic wavelengths of cadmium (325 nanometers), while transmitting all others.

The resonator mirrors reflect the small percentage of photons which are travelling parallel to the axis of the resonator back through the plasma tube. When one of the reflected photons strikes an already excited cadmium atom, it stimulates the atom to release its excess energy in the form of another photon - a photon that is identical to the reflected photon in wavelength, phase and direction of travel.

Since the first photon is not used up by this interaction, both of the identical photons will now travel through the plasma tube, reflecting back and forth between the mirrors, creating even more identical photons.

The resonator mirror located at the output end of the lasertransmits a few percent of these "coherent" photons while reflecting the rest. It is these transmitted photons which the SLA-1 uses to cure StereoLithography resins.

### *Laser Modes*

The SLA-1 laser lases simultaneously in a number of distinct Transverse Electromagnetic Modes (TEMs).

TEMs are the product of the electromagnetic field in the plasma discharge tube. The field forms various standing wave patterns dependent on the precise alignment of the optical resonator mirrors and the physical dimensions of the plasma tube. If the optical resonator is properly aligned, the laser will lase simultaneously in any or all of the wave patterns to create the TEMs.

TEMs are classified by the number of dark lines (nodes) evident in a cross-section of the laser beam. For example, a beam cross-section with no dark lines is classified as mode TEM00. A beam with one vertical line is a TEM01, and a beam with three horizontal and two vertical lines is a TEM32. To achieve maximum power intensity, the resonator mirrors must be aligned to enable the laser to lase in many modes at once. In this case, the mode pattern would be a combination of the patterns of each individual TEM.

The mode pattern generally drifts as the laser and optics age, resulting in a power drop and asymmetric beamshape. Adjustment of the resonator mirrors can, in many cases, improve the mode structure to increase laser intensity. At some point, however, the maximum laser power attainable will not enable the drawing of StereoLithography parts in a timely manner (the lower the laser intensity the slower the process), and the laser will have to be replaced.

## 5.2 THE CHEMISTRY OF STEREOLITHOGRAPHY

### *Introduction*

StereoLithography is made possible by a process called photopolymerization in which a liquid resin monomer is converted to a solid polymer upon exposure to ultraviolet light. The degree to which polymerization occurs, and thus the solidity of the material, is dependent on the total light energy absorbed.

The polymerization of liquid resins is not a new technology, having been used in such applications as ultraviolet inks, coatings, varnishes, and printed circuits for more than twenty years. The use of lasers as the light energy source is, however, a more recent innovation that has been used to date primarily in basic academic research programs. The StereoLithography process developed by 3D Systems, Inc. is an entirely new application.

### *Photopolymers*

The photopolymers used in StereoLithography are composed of two basic materials. The first is a photoinitiator which absorbs the laser energy and forms reactive radical species which initiate the polymerization process. The photopolymers also contain acrylic functionalized monomers and oligomers which polymerize upon exposure to a free radical source.

Certain polymers contain thermoset materials which are sensitive to heat, and thus allow thermal curing of the finished part. Totally UV curable polymers do not appreciably polymerize when heated after being cured by the laser, but in the liquid form can polymerize uncontrollably when overheated.

The preceeding discussion of photopolymers, and the following discussion of the photopolymerization process, provide only a basic overview as needed to better understand StereoLithography. Detailed information on both topics can be found in the following reference: UV Curing, Volumes I and II: Editor S. Peter Pappas, Science and Technology Marketing Corp., Norwalk Connecticut (1980).

### *The Photopolymerzation Process*

The sequence of events in the photopolymerization process is as follows.

### *Photoinitiators*

Photoinitiator molecules (PI) absorb UV light from the laser and are converted to an excited state (the singlet state $^1PI^*$). This short-lived, high energy species quickly relaxes to a lower energy excited state (the triplet state $^3PI^*$).

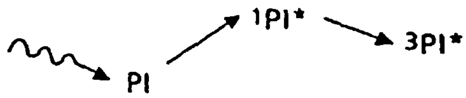

### *Primary Radicals*

The excited $^3PI^*$ molecules catalyze formation of one or more (generally one) species called primary radicals (R•), with the formation reaction and number dependent on the photoinitiator used.

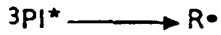

### *Polymer Chain*

The primary radical reacts with an acrylic monomer (M) to form a new radical species (RM•). This starts a chain propagation process (polymerization) in which the reaction is repeated over and over again to form a polymer chain.

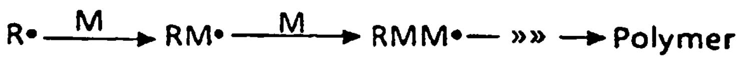


### *Solidification*

The polymer quickly increases in molecular weight until it is evident as a solid. The reaction will immediately stop if the light energy is removed. The reaction will slow down and eventually stop as the available monomer concentration decreases.

The overall dimensions of the solid polymer formed when a UV laser is focused on the surface of a photopolymer are controlled by the intensity of the laser beam and the period of exposure. A longer exposure or increased laser energy will increase the depth and width of the solid region.

### *Physical Properties of Photopolymers*

The physical properties of Desolite SLR 800, both as a liquid and as a solid, are summarized below.

| LIQUID PROPERTIES | |
|---|---|
| Viscosity (Brookfield cps at 25°C) | 1350 centipoise |
| Solids (Reactive Material) | > 99 percent |
| Volatility | Low |

| SOLID (POST CURE) PROPERTIES | |
|---|---|
| Extractables (using MEK solvent) | <5 percent |
| Tensile Modulus | 140 kpsi |
| Tensile Strength | 6.7 kpsi |
| Tensile Elongation at Break | ~7 percent |

Plastic parts prepared using SLR 800 resin tend to be somewhat brittle after UV post curing. Even so, post cured parts can be sanded, sandblasted and drilled using sufficient care.

Surfaces of completed parts can be smoothed to a glass-like finish by sanding followed by application and UV curing of a thin layer of diluted resin (a 1:1 mixture of resin and MEK -- Methyl Ethyl Ketone). Defects in parts (e. g., cracks, chips and holes) can usually be eliminated by using a similar resin/UV curing technique.

Finished parts have shown adhesion properties typical of acrylics, thus allowing the use of standard epoxy glues to join parts together. One of the best glues found thus far is the resin itself, with curing by UV.

### *Viscosity*

As shown below, a relatively small change in temperature will cause a large change in the viscosity of the liquid resin, with the viscosity decreasing as the temperature increases and vice versa. Higher temperatures, and thus reduced viscosity, will result in a thinner liquid that would settle faster during dipping and drain faster during post processing.

This seems like an attractive option, except that higher process temperatures may decrease the structural integrity of the part while it is being built and may cause uncontrolled polymerization of the liquid resin.

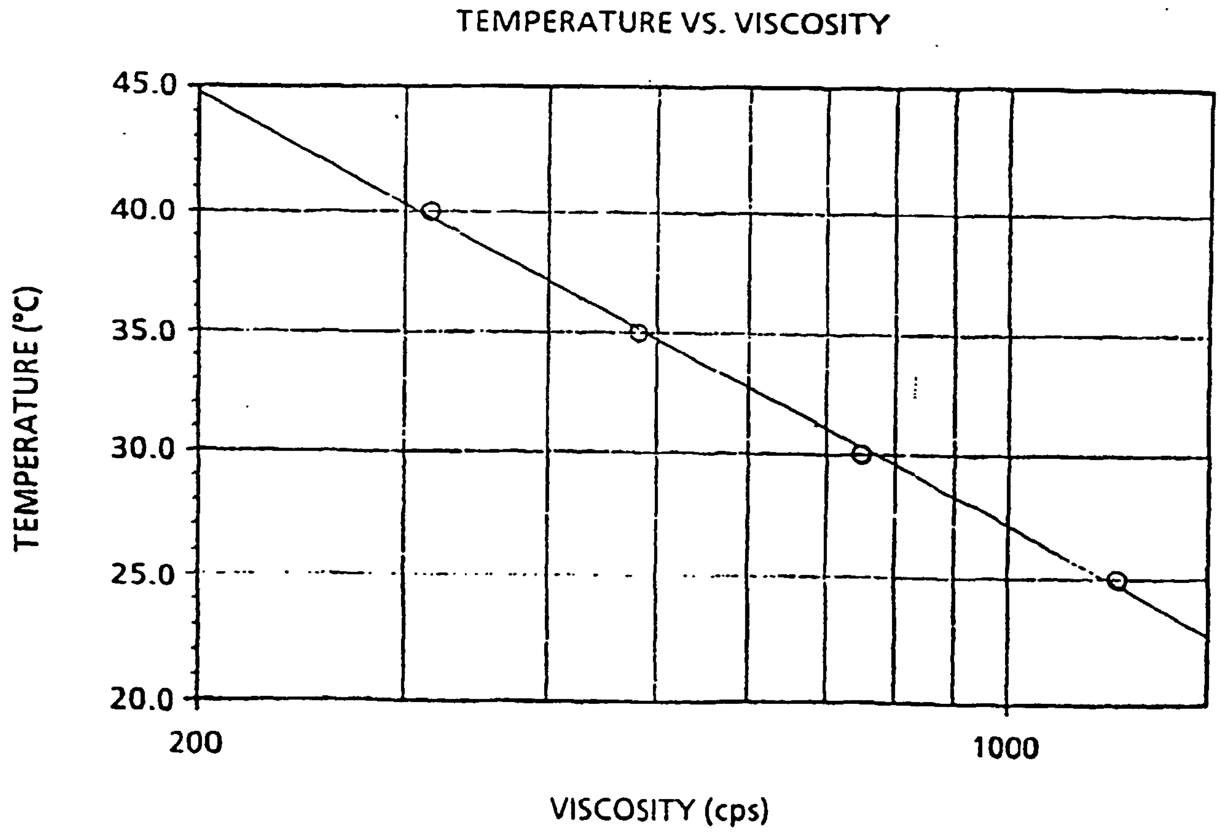


*A small change in temperature causes a large change in viscosity.*

**5.3 BULLETS, BANJ OTO PS AN D**

**WORKING CURVES**

***Bullets***

An ultraviolet laser beam focused on the surface of a photopolymer will solidify or cure a small, bullet-shaped volume of liquid. This characteristic can be explained as follows.

The intensity profile of a laser beam, as shown below where the larger values indicate higher intensity, varies from point to point with a maximum near the center of the beam. The liquid can be thought of as consisting of very thin horizontal sheets, each of which will absorb a fraction (for example -- 1/2) of the laser light and transmit the rest to the next lower sheet. If the laser beam strikes the liquid vertically for one second, and during this time X units of light strike the top sheet, then X/2 units will be absorbed by that sheet and the remaining X/2 transmitted to a point in the second sheet, X/4 to a point in the third, and so on. Since the more light absorbed the more

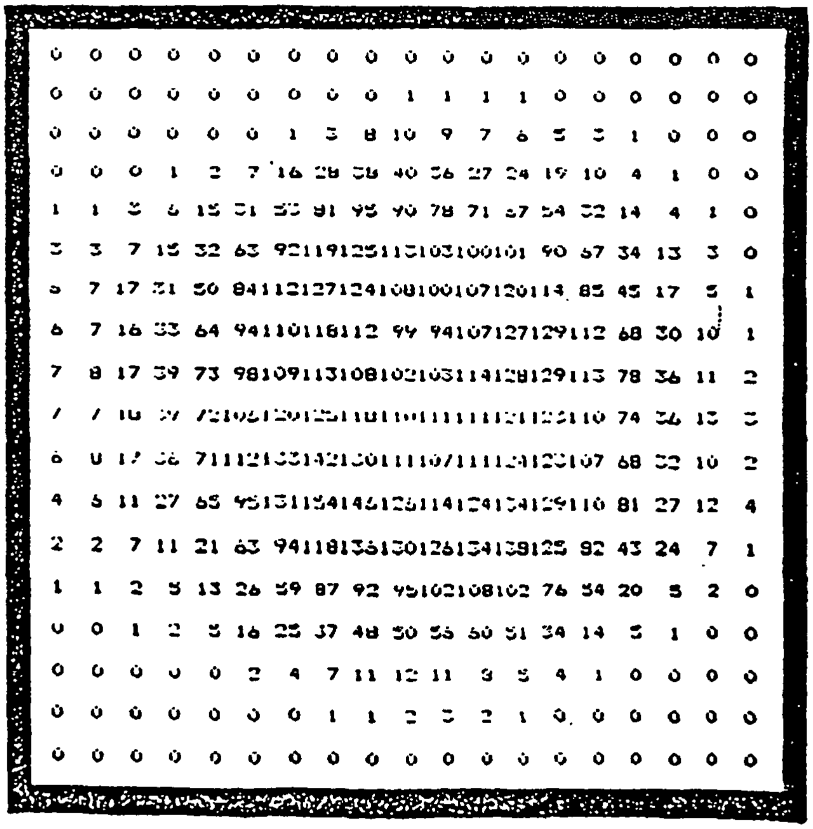

*An intensity profile showing a maximum near the center of the beam.*

polymerization, the top sheet will be the most solid, the second one less so, and so on until a sheet has absorbed so little energy that it is no more solid than the surrounding liquid. If the solid plastic is pulled from the liquid, this last sheet will remain behind, since its bonding force to the solid plastic is no greater than that to the liquid below.

The depth of the cured plastic will vary as X is increased or decreased, and will also vary across the width of the laser beam since the beam front is not uniform (as shown by the intensity profile). Thus, the center of the beam will cure to the greatest depth because it is the area of highest intensity, and the surrounding areas will cure to lesser depths. The maximum solid depth achieved (after post-curing) is known as the cure depth.

A second factor also plays a role in the development of the bullet shape. Since the refractive index of solid plastic is slightly higher than that of the liquid, the laser light will be refracted inward to varying degrees as the liquid changes to solid. At certain angles, light may be reflected as well from the interface. This characteristic, illustrated below, tends to give the bullet a narrower shape than if beam intensity was the only consideration.

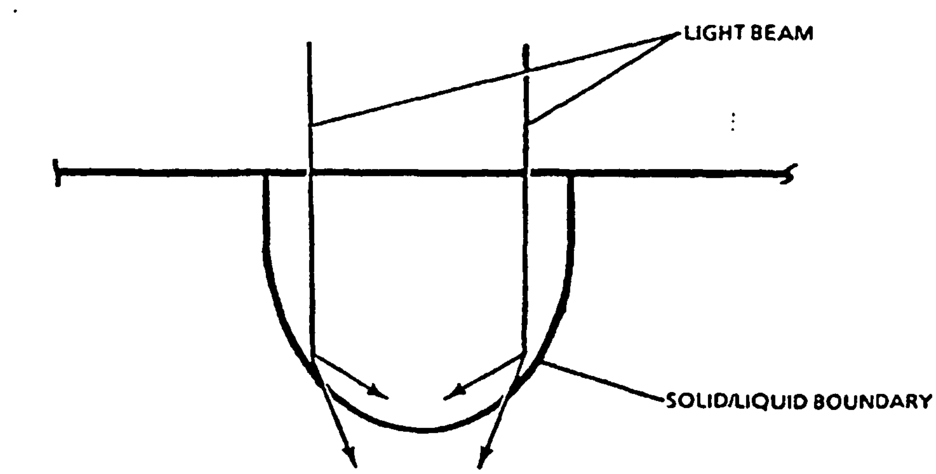


*The change in refractive index of the resin as it transforms from liquid to solid enhances the bullet shape*

***Step Periods***

Bullets are the building blocks of StereoLithography, for the overlap of successive bullets forms lines and the overlap of lines forms surfaces. As discussed earlier, the shape of the bullets is determined largely by the beam profile and optical effects. It follows that their overall dimensions should be determined by how much laser energy enters the liquid; this quantity is known as exposure. Exposure is proportional to the product of laser intensity and step period, an operating parameter that specifies the number of 10-microsecond increments between movements of the laser when forming a line. Thus, step period is a measure of the time the laser is focused on a particular location and the brief transit time required to move to the next location. In practice, the laser intensity is not adjusted, and exposure is controlled by choice of step period value.

Measurements taken of actual bullets produced by the SLA-1 show that in addition to varying the dimensions of the bullets, large step period values (a range of 5 to 4000 is available) will also affect the shape of the bullets. Sample bullet shapes and relative dimensions at various step period values are shown below.

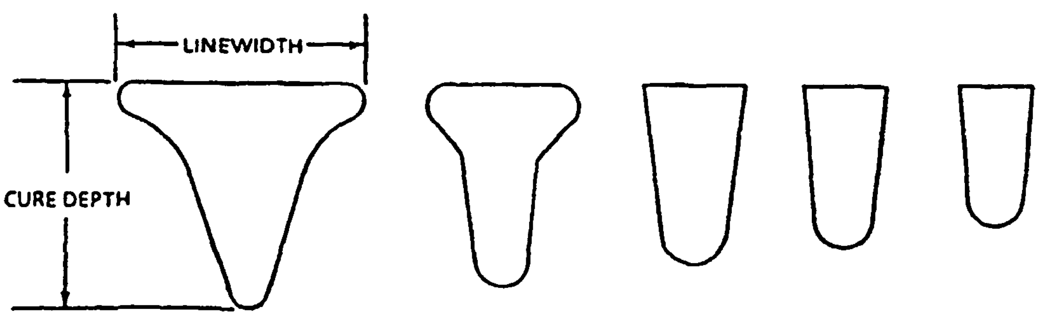


*Step period values determine the overall dimensions of bullets and also affect bullet shape*

***Step Size***

As shown below, bullets overlap to form lines. The distance that the laser moves between forming bullets is a parameter known as step size. If the step size is less than or equal to the maximum diameter of the bullets (i.e., measured across the top of the bullet), the bullets will overlap and a continuous line will be formed. Depending on the step size selected, many points in the liquid along the path of the drawn line will be exposed for more than one step period. These points, as shown m in the lower figure, will be more heavily cured than surrounding points.

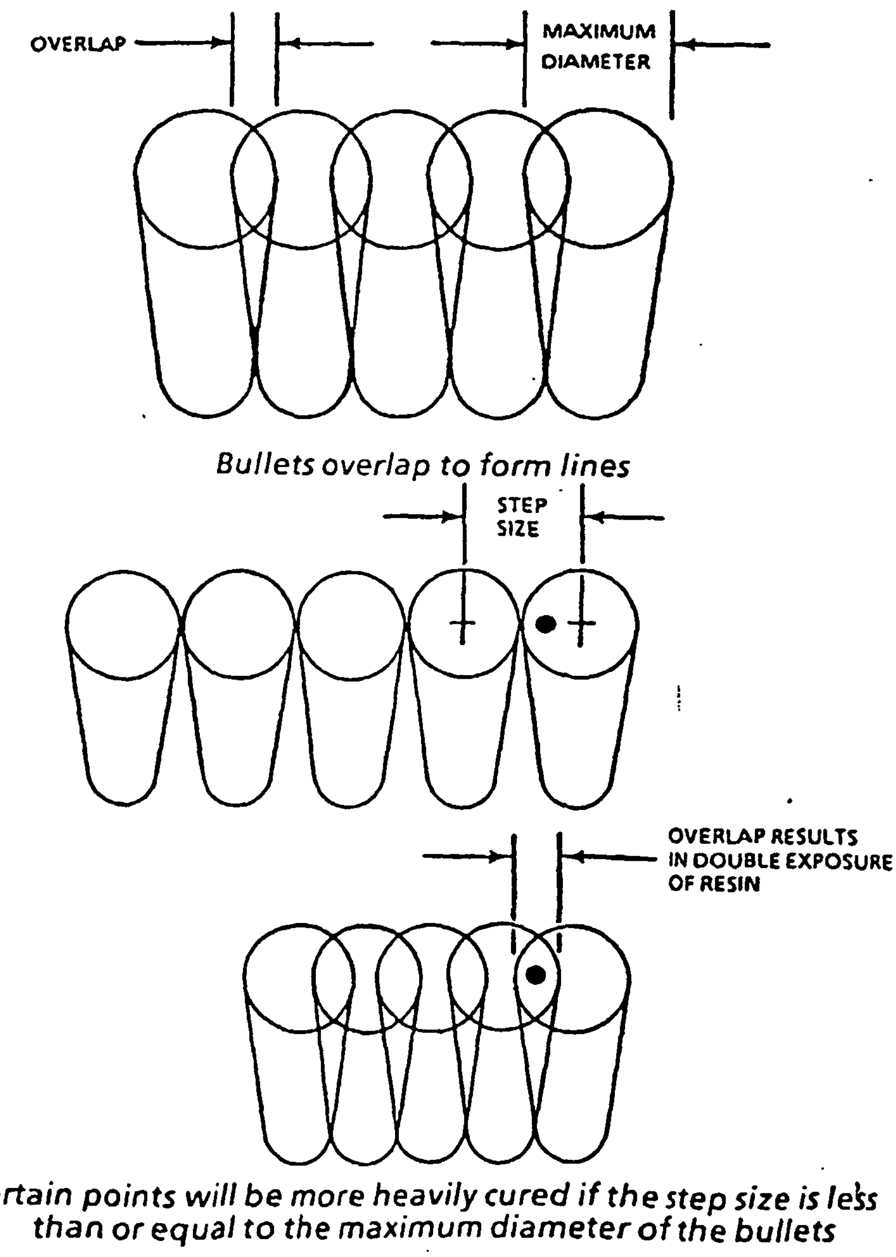


Bullets overlap to form lines

Certain points will be more heavily cured if the step size is less than or equal to the maximum diameter of the bullets

***Bonding and Overlap***

The thickness of a line is the cumulative cure depth of the bullets from which it is formed. When lines in successive layers are intended to adhere or bond to one another, the thickness of the upper line must be greaterthan the separation (slice thickness) between the layers, so that the layers overlap vertically.

Layer-to-layer bonding occurs because while the top layer is being formed, the lower layer is near enough to the surface to absorb light and cure further. Thus, chemical bonds are formed between the lower layer and the freshly-formed top layer.

Strong layer-to-layer bonding and therefore sufficient overlap are needed to build strong parts. Equally important, too large an overlap may cause a layer to curl. An overlap of 6 to 8 mils typically gives good results with layer thicknesses between 5 and 30 mils.

### *Working Curves*

To obtain an appropriate overlap, you will need to know which step period values will produce which cure depths. You will also need to know the width of lines produced at different step period values, especially when building a thin vertical wall or when trying to determine the angle at which a sloping (near-flat) surface will need skin fill in order to avoid gaps. Working curves provide this information.

#### *Working Curves Defined*

A working curve is a graph that shows lineheight (cure depth) and linewidth as functions of the step period value. As shown in in the figure, these relationships are not linear, but logarithmic. That is, if the step period is multiplied by a value X, the resulting lineheight or width is not X times as large, but considerably less.

The working curve demonstrates that when the logarithm of the step period is plotted versus lineheight or width, the points will fall more or less on a straight line. Therefore, a line can be fitto the pointsto obtain a linear equation which approximately relates lineheight or width to the step period value.

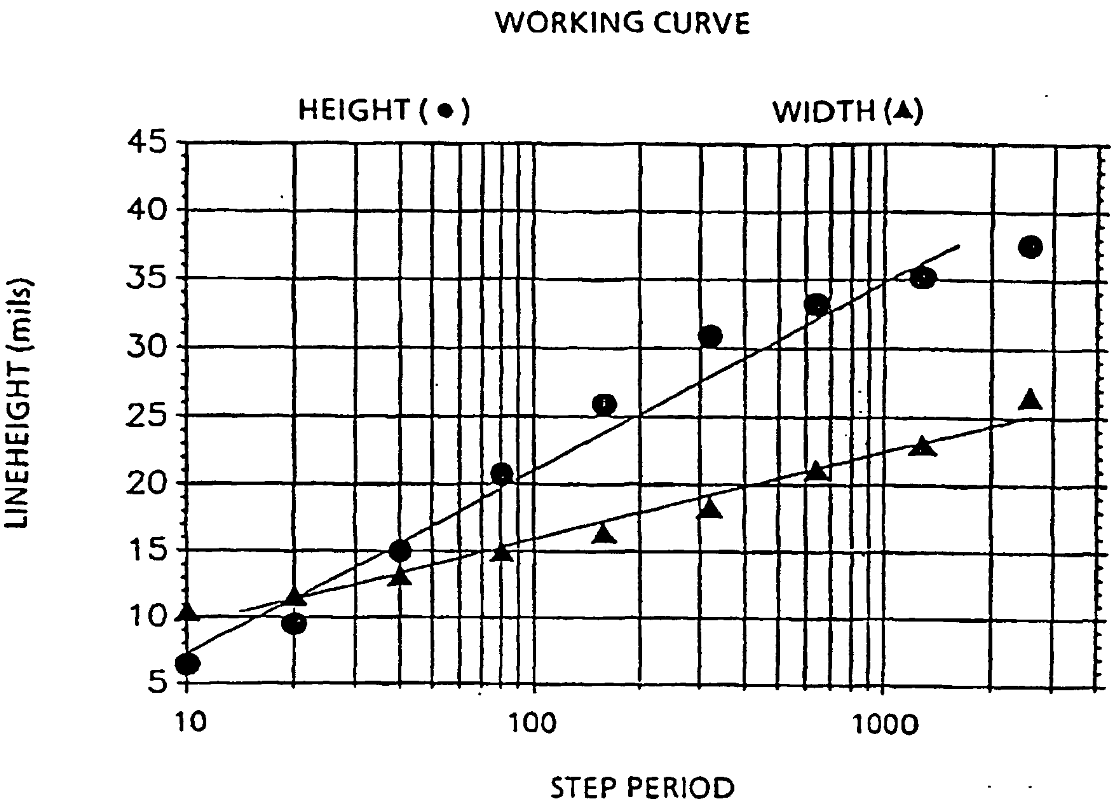


*A working curve is a graph that shows lineheight and linewidth as a function of Step Period*

#### *Variables That Affect Working Curves*

Several variables affect the slope and intersect points of working curves. Different resins have different sensitivities to the ultraviolet light of the laser. Laser power also varies from one SLA to another, and even from day-today in the same SLA. Finally, the degree to which the laser is focused on the liquid surface (i.e., whether the optics are properly aligned and if they are clean) can affect working curves.

***Obtaining Data For Working Curves***

Lineheight and width data at various step period values, for the specific resin and laser in use, are obtained by creating and measuring a small, single-layer part known as a banjotop. Banjotops are created on the surface of the liquid and do not attach to the elevator platform. As shown in the next figure, a banjotop has five strings (lines) formed using different step periods and a fixed step size of 2.

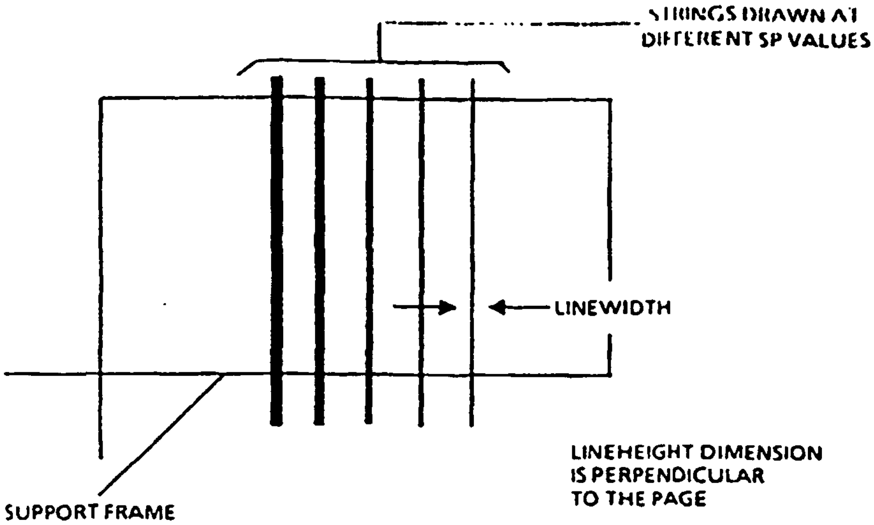


*Banjotops have five strings formed using different step periods and a fixed step size*

After the banjotop is drained and post-cured, the string heights and widths are measured. Two banjotops are generally made, with one common step period, in order to evaluate a wide range of step periods. The SLA-1 allows step periods from 5 to 4000. One banjotop is typically made with step periods of 2560, 1280, 640, 320 and 160, and the second with step periods of 160, 80, 40, 20 and 10.

***Measuring Banjotop Strings***

Draw banjotops using Utility Menu option MAKE TEST PART. Measuring banjotop string height and width as follows.

***Step 1)*** Place the banjotop with top surface facing upward on the stage of a measuring microscope or other non-contact measuring device.

***Step 2)*** Orient the first string to be measured perpendicular to the axis of stage movement and with the center of the string near the center of the visual field.

***Step 3)*** Move the stage to center the crosshairs along one edge of the string. Note that the stage should always be moved to the position where measurements are taken from one direction only in orderto minimize the effect of backlash in the positioning screw.

***Step 4)*** Zero the counter that measures stage movement or record the stage position.

***Step 5)*** Move the stage until the crosshairs are centered on the opposite edge of the string and record the value. If the stage is moved too far, reverse it past the correct position and try again.

***Step 6)*** Repeat steps 2 through 5 to measure the width of the remaining strings. Compile all linewidth data in a table relative to step period value.

***Step 7)*** Clamp the first banjotop short edge up and repeat steps 2 through 5 to measure the line height. Cut away each string after it is measured to reveal the next string.

***Step 8)*** Repeat step 7 for each remaining string. Compile all lineheight data in a table relative to step period value.

***Sample Working Curve Calculations***

Data measured from banjotops are entered using the Utility Menu MATERIAL MANAGER. It will then fit a line to the data points using the method of least squares and calculate the slope and Y-intercept of each line.

Equations can be written in terms of lineheight or width relative to step period using the slope and Y-intercept from the working curve. These equations are:

(1) Height = slope log SP + Y intercept
or
$SP = 10^{((\text{height - Y intercept})/\text{slope})}$

(2) Width = slope log SP + Y intercept
or
$SP = 10^{((\text{width - Y intercept})/\text{slope})}$

As an example of how such equations are used by MATERIAL MANAGER, let us find the correct step period for a layer thickness of 20 mils. Keep in mind that a cure depth of 26 mils is required to ensure adequate adhesion between layers. We'll use a slope for the height curve of 13.76 and a Y-intercept of -6.50. Using the second form of equation (1), the proper step period is:

$$SP = 10^{((26.00 + 6.50)/13.76)}$$

$$= 10^{2.36}$$

$$= 230$$

We can calculate the linewidth at a step period of 230 using the first form of equation (2). Assuming a slope for the width curve of 6.52 and Y-intercept 2.91, the linewidth is:

$$\text{Width} = 6.52 \log 230 + 2.91$$

$$= 6.52\ (2.36) + 2.91$$

$$= 18.3 \text{ mils}$$

Linewidths are of particular interest when designing near-flat surfaces, where you need to know the surface angle at which skin will be needed to fill gaps between the layer borders.

Another situation in which linewidths are of particular interest is when step periods are calculated for skin vectors. Skin vectors are spaced 1 to 4 mils apart and overlap a great deal. (For example, if a skin fill spacing of 2 mils is used, within the width of an 8 mil wide line there would be four overlapping exposures.) Thus, if the desired skin thickness is to be obtained, the step period value that would be used for a single line of this thickness must be reduced by the ratio of the linewidth to fill vector spacing. In our example, this would be 8/2 = 4 for a 2 mil spacing.

***Re-Calibrating Working Curves***

Normally, a working curve is made only once to characterize the laser and optics with the resin type. However, variations in laser power require that the current power be measured before a part is made. Prepare Menu option RANGE MANAGER is used to update the step period values in the .R Range file when the laser power has changed.

**GLOSSARY**

| TERM | DEFINITION | REFERENCE |
| --- | --- | --- |
| 60/120 Hatch Vector | Crosshatch vectors drawn 60 and 120 degrees from the X axis. | 3.5 |
| BANJOTOP | A floating, single-layer part with five strings (lines), each drawn at a different step period value. Banjotops provide cure depth and linewidth data for working cu rves. | 5.3 |
| BEAM ANALYSIS | A Utilities Menu option which focuses the laser beam on beam profilers mounted in the process chamber to measure laser power and intensity. | 3.7 |
| BEAM EXPANDER | The lens assembly mounted on the optics plate which expands the laser beam, enabling it to be focused so that the beam converges to a small, high energy spot on the surface of the resin. | 1.2 |
| BEAM PROFILE | A pattern of numbers or dots representing the spatial distribution of laser beam energy. Beam profiles are used to determine whether the laser should be adjusted or replaced, or whether the optics should be cleaned. | 3.7 |
| BEAM PROFILER | A device (radiometer) which measures laser power and intensity. Two beam profilers are mounted on either side of the vat in the process chamber. | 1.2 |
| BEAM-TURNING MIRRORS | Specially-coated mirrors mounted on the optics plate which reflect 325 nm ultraviolet light and transmit all other wavelengths. Beam-turning mirrors reflect the laser beam from the laser outlet to the inlet aperture of the beam expander, and then from the beam expander outlet aperture to the dynamic mirrors. | 1.2 |
| BUILD | A Main Menu option which supervises the building of StereoLithographic parts and controls the dynamic mirrors and elevator. | 3.12 |
| BULLET | The characteristic shape of the solid plastic created by a stationary laser beam on the surface of photo-curable resin. | 5.3 |
| CAD | Computer-Aided Design | |
| CAD RESOLUTION | The internal approximation of surfaces within a CAD system. | 3.1 |
| CIRCULAR WEB SUPPORT | A hollow tube structure which can support large, heavy parts. | 3.2 |

(continued)

| TERM | DEFINITION | REFERENCE |
|---|---|---|
| CONTROL COMPUTER | The computer mounted in the SLA-1 cabinet which controls the building of StereoLithographic parts. | 1.2 |
| CROSS WEB SUPPORT | Two straight web supports which intersect at right angles. | 3.2 |
| CROSSHATCH | A vector created during slicing which is drawn between layer borders to strengthen part surfaces. The crosshatch type and spacing are user specified. | 3.5 |
| CURE DEPTH | The thickness or depth of a cured line of resin. The cure depth of any line is determined by the step period and step size values used to draw the line. | 5.3 |
| CURL | A characteristic type of deformation (curling of layers). | 3.2 |
| DIP DELAY | A part-building parameter which defines the time between the start of a dip and the first laser movement to draw the next layer. The dip delay allows the resin surface to level. | 3.11 |
| DRAWING SPEED | The speed at which the laser traces over the surface of the resin to form solid plastic lines and surfaces. The laser drawing speed varies depending on the layer thickness specified and laser power. | 5.3 |
| DYNAMIC MIRRORS | Galvanometer-controlled scanning mirrors which direct the laser beam to any point on the surface of the resin. | 1.2 |
| EDIT A FILE | A Utility Menu option used to modify text files. | 3.7 |
| ELEVATOR | The hardware component that raises and lowers the platform and part in the vertical (Z) axis. | 1.2 |
| ELEVATOR MOVER | A Utilities Menu option used to position the elevator platform using the up and down arrow keys on the Control Computer numeric keypad. | 3.7 |
| ELEVATOR PLATFORM | The perforated aluminum base which attaches to the elevator and supports parts being built by the SLA-1. | 1.2 |
| ENTRAPPED VOLUME | A volume in the part from which the liquid resin cannot drain during dipping. | 3.2 |

(continued)

| TERM | DEFINITION | REFERENCE |
|---|---|---|
| ETHERNET | A high-speed, inter-computer communications system jointly developed by Digital, Intel and Xerox. Ethernet is used to transfer files between the Slice and Control Computers. | 1.2 |
| EXPOSURE | The product of laser intensity and step period. | 5.3 |
| FILL | Overlapping parallel vectors which comprise the horizontal surfaces (skins) of StereoLithographic parts. | 3.5 |
| FLAT TRIANGLE | A horizontal StereoLithography (.STL) file triangle. | 3.3 |
| FTP (FILE TRANSFER PROGRAM) | A Network Menu option which moves files between the Slice and Control Computers. | 3.8 |
| GREEN PART | A StereoLithography part prior to UV post-curing. | 3.13 |
| HATCH SPACING | A SLICE parameter which specifies the perpendicular spacing, in CAD units, between crosshatches. | 3.5 |
| LASER | The device which generates the light energy required to polymerize photocurable resin. The SLA-1 Helium-Cadmium laser has a nominal power of 15 mW at a wavelength of 325 nanometers. | 5.1 |
| LAYER (.L) FILE | A MERGE output file which defines the types of vector blocks in each layer of the part. | 3.9 |
| LAYER BORDER (LB) VECTOR | A vector which defines the perimeter of a layer. Crosshatch and fill vectors are drawn between layer borders where needed. | 3.5 |
| LAYER MANAGER | A Prepare Menu option used to find vector blocks in a particular range or in the entire Layer (.L) file. | 3.11 |
| LAYER THICKNESS | The depth of a cured layer of plastic and the SLICE parameter used to specify fixed or variable layer thickness. Layer thickness may be varied for one layer or a group of layers, or set at one value for the entire part. | 3.5 |
| LEVELING | The process whereby the surface of the resin settles and levels after a part is dipped. The time allowed for leveling is defined by the ZW (dip delay) part building parameter. | 3.12 |

(continued)

| TERM | DEFINITION | REFERENCE |
|---|---|---|
| LINE | A line of cured plastic generated by overlapping bullets. | 5.3 |
| LINEHEIGHT | The depth of a laser-cured resin line. Lineheight is a variable dependent on exposure and is controlled by selection of step period. | 5.3 |
| LINEWIDTH | The horizontal width of a laser-cured resin line. Linewidth is a variable dependent on exposure. | 5.3 |
| MATERIAL (.MAT) FILE | A file containing cure depth and linewidth data measured from banjotops. | 3.7 |
| MAKE TEST PARTS | A Utilities Menu option used to create banjotops. | 3.7 |
| MATERIAL MANAGER | A Utilities Menu option used to input new material data from banjotops. | 3.7 |
| MERGE | A Main Menu option which combines all object and support Slice (.SLI) files to create Layer (. L), Range (.R) and Vector (.V) files. | 3.9 |
| MIA (MINIMUM HATCH INTERSECT ANGLE) | A SLICE parameter which defines the minimum angle allowed between a crosshatch and a layer border vector. | 3.5 |
| MONOMER | A low molecular weight chemical species which is a building block of polymers. | 5.2 |
| MSA (MINIMUM SURFACE ANGLE) | A SLICE parameter which defines the angle from the horizontal below which a triangle is classified as near-flat rather than steep. Near-flat triangles may have skin fill but steep triangles cannot. | 3.5 |
| MSDS | Material Safety Data Sheet | 2.1 |
| MSDOS | The operating system used in the Control Computer (MicroSoft Disk Operating System). | 3.6 |
| MULTIPLE PART POSITIONING COORDINATES | Build parameters used to position the part on the platform and/or to make multiple parts in the same BUILD run. | 3.11 |
| NEAR-FLAT TRIANGLE | A StereoLithography (.STL) file triangle at an angle greater than zero and lessthan or equal to the MSA. | 3.5 |

(continued)

| TERM | DEFINITION | REFERENCE |
|---|---|---|
| OPTICAL WINDOW | The quartz window just below the dynamic mirrors which allows laser light to enter the process chamber while isolating the optics plate from the chamber environment. | 1.2 |
| OPTICS PLATE | The aluminum plate above the process chamber which supports the laser and optical components in precise alignment. | 1.2 |
| PARAMETERS MANAGER | A Prepare Menu option used to edit the .R file to add part building parameters. | 3.11 |
| PCA | Post Curing Apparatus | 1.2 |
| PHOTOINITATOR | A chemical in photopolymers which tranforms the laser energy into chemical energy and initiates the photopolymerization (solidification) process. | 5.2 |
| PHOTOPOLYMER | A chemical substance composed of photoinitiators, monomers and oligomers which polymerizes when exposed to light energy. | 5.2 |
| PHOTOPOLYMERIZATION | The process whereby tight energy converts a monomer or oligomer substance into a polymer. | 5.2 |
| POST CURING APPARATUS | An ultraviolet device used to cure green StereoLithographic parts. | 1.2 |
| POST PROCESS | The process to cure and finish StereoLithographic parts. | 3.13 |
| POWER SEQUENCER | A Utilities Menu option which is used to turn SLA-1 hardware on and off directly from the Control Computer keyboard. | 3.7 |
| PREPARE | A Main Menu option used to specifiy part building parameters and to edit the Range (.R) file. | 3.11 |
| PROCESS CHAMBER | The chamber in which the resin vat, elevator and beam profilers are mounted. | 1.2 |
| RANGE | A set of one or more horizontal slice layers defined by upper and lower dimensions either in CAD units or slice units. A new range must be created anytime a part building parameter value changes. | 3.11 |
| RANGE (.R) FILE | A MERGE output file which is used to specify part building parameters by range. | 3.9 |

(continued)

| TERM | DEFINITION | REFERENCE |
|---|---|---|
| RANGE MANAGER | A Prepare Menu option which is used to add or delete ranges, calculate step periods, edit ranges to modify dip delays, and update the Range (.R) file. | 3.11 |
| REMOTE USER | A Network Menu option used to remotely operate the Slice Computer from the Control Computer keyboard. | 3.8 |
| RESIN | Another name for the photopolymer chemical used in StereoLithography. | |
| RESIN VAT | The container of resin in which the object is formed. | 1.2 |
| SENSITIZATION | An allergic response to the photo-curable resins generally resulting from repeated skin contact. | 2.2 |
| SHUTTERS | Solenoid-actuated vanes which block the laser beam when an interlock switch is activated. | 1.2 |
| SKIN (SKIN FILL) | Thin, overlapping lines drawn to fill in or create horizontal surfaces. | 3.5 |
| SLA | StereoLithography Apparatus | |
| SLICE | A program run on the Slice Computer which cross-sections the StereoLithography (.STL) file and generates vector data. | 3.5 |
| SLICE (.SLI) FILE | The SLICE output file which contains vector data used to build the part. | 3.5 |
| SLICE COMPUTER | The computer used to run SLICE. The Slice Computer operates under UNIX and is linked to the Control Computer via Ethernet. | 3.4 |
| SLICE RESOLUTION | A SLICE parameter which specifies the number of slice units assigned to each CAD unit of measure. | 3.5 |
| STEEP TRIANGLE | A vertical or near-vertical StereoLithography (. STL) file triangle. | 3.3 |
| STEP PERIOD | A part building parameter which defines the length of the delay following each laser step. | 3.11 |
| STEP SIZE | A part building parameter which defines the size of the step, in mirror bits, that the laser makes between forming bullets of cured plastic. | 3.11 |

(continued)

| TERM | DEFINITION | REFERENCE |
|---|---|---|
| STEREOLITHOGRAPHY | A three-dimensional printing or drawing process that forms plastic objects by solidifying successive layers of photocurable resin. | |
| STEREOLITHOGRAPHY (.STL) FILE | The tessellated CAD file input to SLICE. | 3.3 |
| STRAIGHT WEB SUPPORT | A thin rectangle or fin structure defined by a minimum of six surfaces. | 3.2 |
| SUPPORTS | Structures designed on the CAD system to support the object above the elevator platform, provide a rigid foundation on which the part may be built, and attach and support layer sections. Supports may be processed in a separate file until combined with the object files by MERGE. | 3.2 |
| TEM | Transverse Electromagnetic Mode | 5.1 |
| TESSELLATE | The representation of CAD surfaces by triangles or other polygons. | 3.3 |
| TRIANGULAR WEB SUPPORT | A triangular shaped support structure. | 3.2 |
| UNIX | A multi-tasking, multi-user operating system used in Slice Computer. | 3.4 |
| VECTOR | A directed line segment represented by starting and ending coordinates. | 3.5 |
| VECTOR (.V) FILE | A MERGE output file which contains layer-by-layer vector data for all merged files. | 3.9 |
| VECTOR BLOCK | A set of like vectors (i.e., layer borders, crosshatches or fill). | 3.5 |
| VIEW | A Main Menu option used to display StereoLithography (.STL) and Slice (.SLI) files on the Control Computer screen. | 3.10 |
| VIEWPORT COORDINATES | Minimum and maximum coordinates which define, in mirror bits, the dimensions of the viewport in the BUILD status screen. | 3.11 |
| WEB | A style of support recommended for use in StereoLithography because of its ease of creation and removal. | 3.2 |

(continued)

| TERM | DEFINITION | REFERENCE |
|---|---|---|
| WORKING CURVE | A plot (of line height and linewidth versus step period at a particular laser power) which characterizes the SLA-1 laser and optics with a particular resin to define part building parameters. The data used to make working curves are taken from banjotops. | 5.3 |
| XY-ONLY SCALE FACTOR | A part-building parameter which converts vector data from slice units to mirror bits. The X-Y only scale factor can be used to cross-section the part smaller or larger in the X and Y dimensions. It does not affect the vertical (Z) dimension. | 3.11 |

APPENDIX G

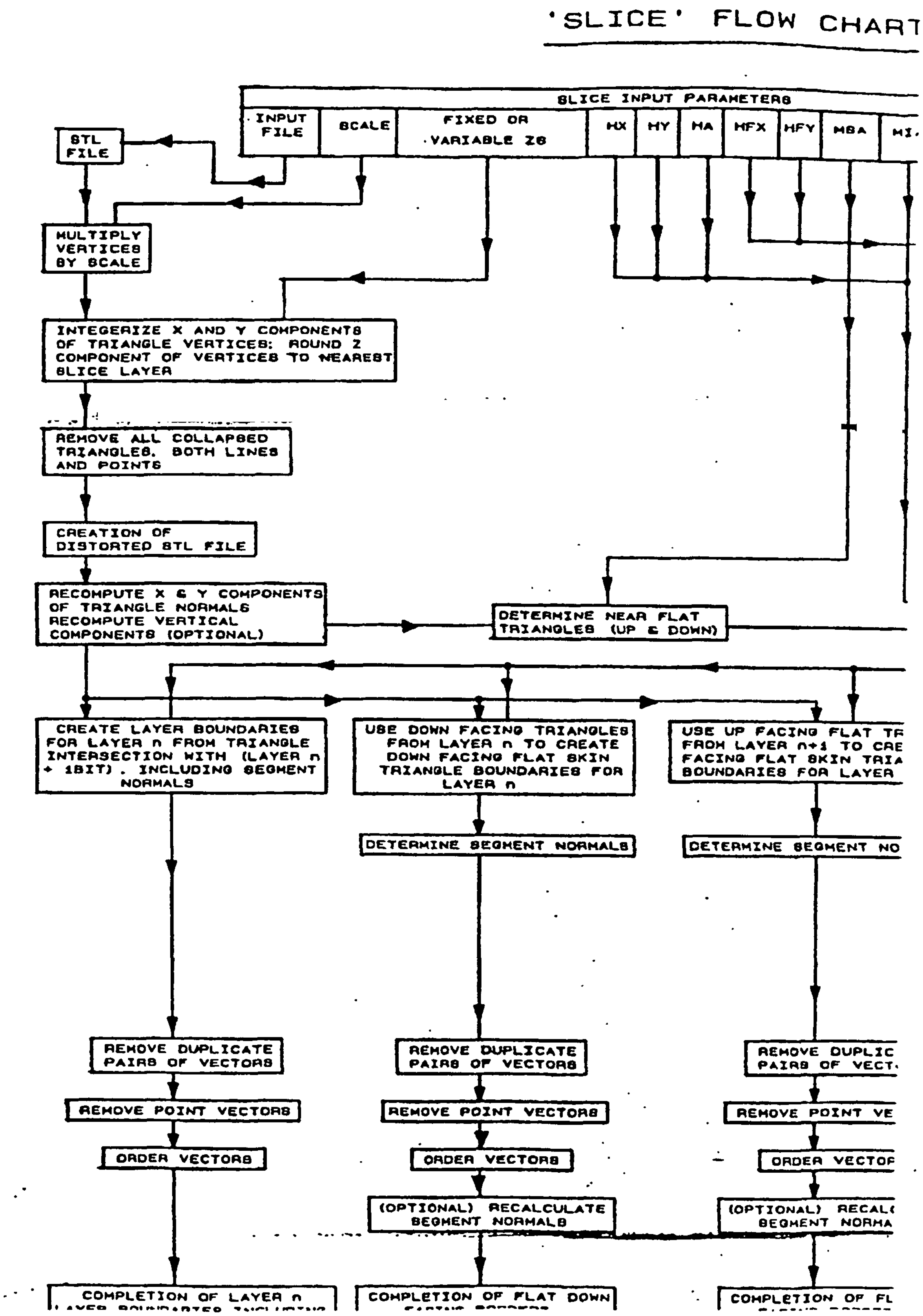
'SLICE' FLOW CHART
SLICE INPUT PARAMETERS
INPUT FILE
SCALE
FIXED OR VARIABLE ZS
HX
HY
HA
HFX
HFY
HSA
STL FILE
MULTIPLY VERTICES BY SCALE
INTEGERIZE X AND Y COMPONENTS OF TRIANGLE VERTICES: ROUND Z COMPONENT OF VERTICES TO NEAREST SLICE LAYER
REMOVE ALL COLLAPSED TRIANGLES. BOTH LINES AND POINTS
CREATION OF DISTORTED STL FILE
RECOMPUTE X & Y COMPONENTS OF TRIANGLE NORMALS RECOMPUTE VERTICAL COMPONENTS (OPTIONAL)
DETERMINE NEAR FLAT TRIANGLES (UP & DOWN)
CREATE LAYER BOUNDARIES FOR LAYER n FROM TRIANGLE INTERSECTION WITH (LAYER n + 1BIT). INCLUDING SEGMENT NORMALS
USE DOWN FACING TRIANGLES FROM LAYER n TO CREATE DOWN FACING FLAT SKIN TRIANGLE BOUNDARIES FOR LAYER n
DETERMINE SEGMENT NORMALS
REMOVE DUPLICATE PAIRS OF VECTORS
REMOVE POINT VECTORS
ORDER VECTORS
(OPTIONAL) RECALCULATE SEGMENT NORMALS
COMPLETION OF LAYER n
COMPLETION OF FLAT DOWN

IMPLEMENTING STYLE 1

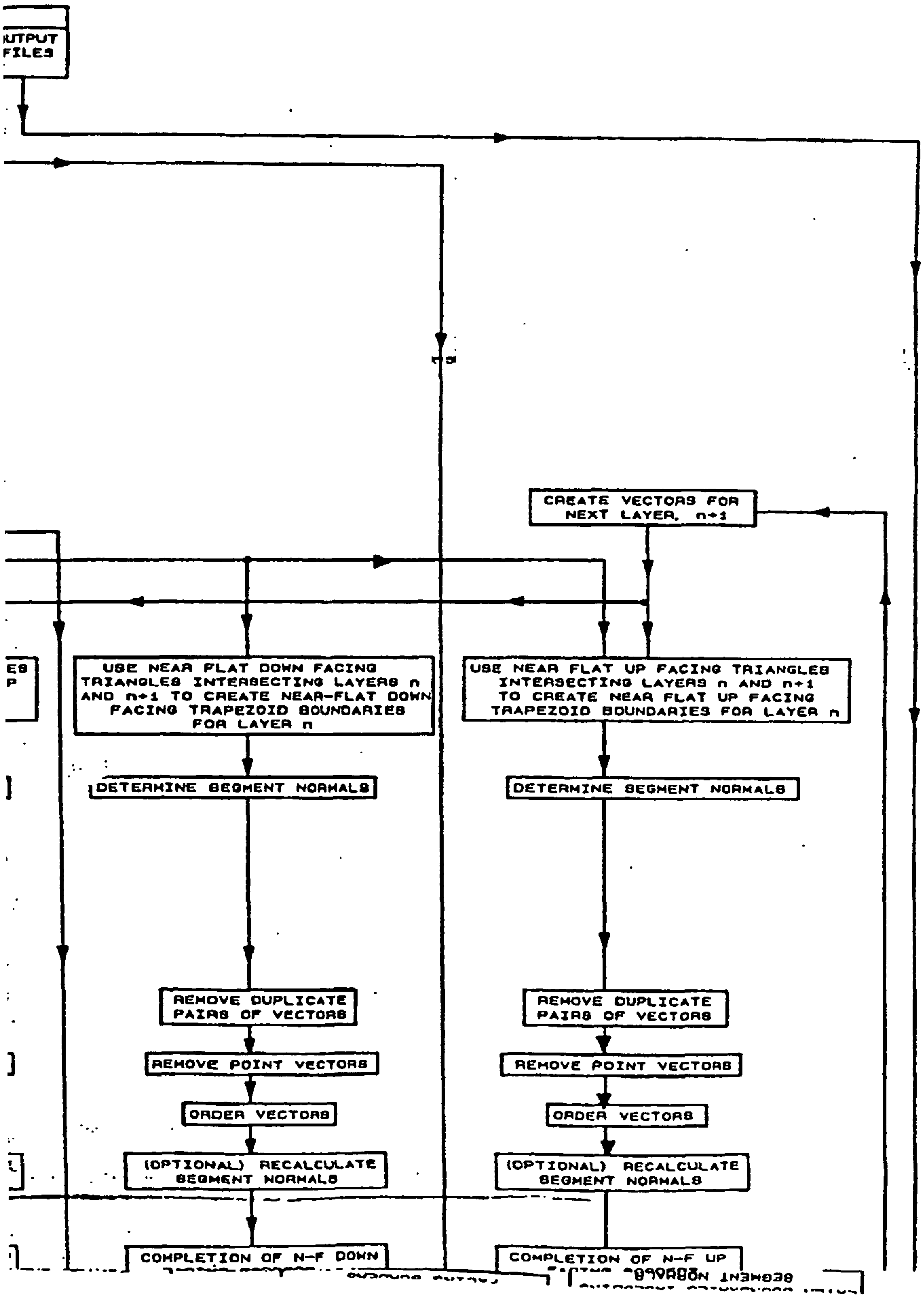

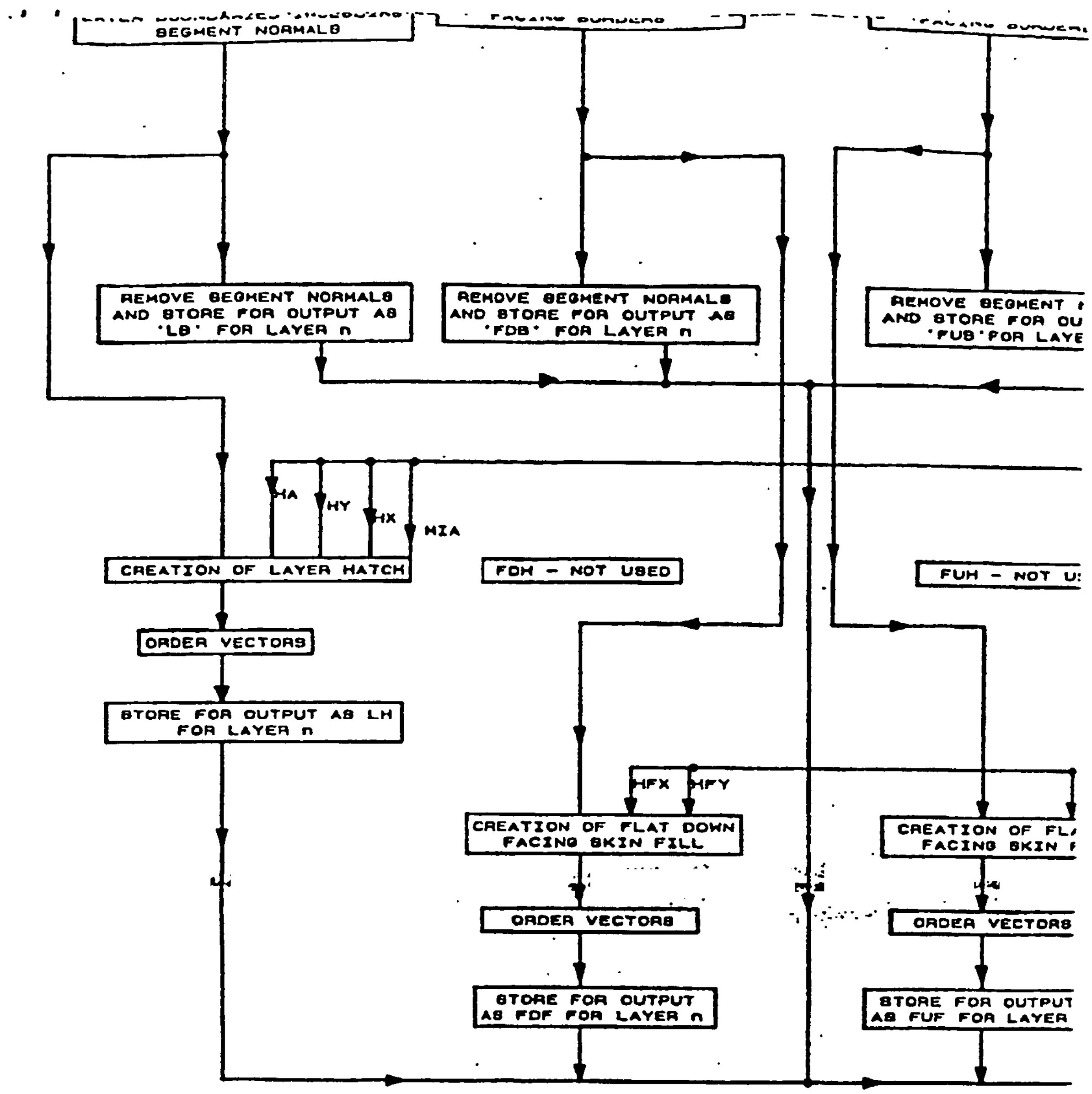
SEGMENT NORMALS
REMOVE SEGMENT NORMALS AND STORE FOR OUTPUT AS 'LB' FOR LAYER n
REMOVE SEGMENT NORMALS AND STORE FOR OUTPUT AS 'FDB' FOR LAYER n
REMOVE SEGMENT AND STORE FOR OU 'FUB' FOR LAYE
HA
HY
HX
HIA
CREATION OF LAYER HATCH
FDH - NOT USED
FUH - NOT U
ORDER VECTORS
STORE FOR OUTPUT AS LH FOR LAYER n
HFX
HFY
CREATION OF FLAT DOWN FACING SKIN FILL
CREATION OF FL FACING SKIN
ORDER VECTORS
ORDER VECTORS
STORE FOR OUTPUT AS FDF FOR LAYER n
STORE FOR OUTPUT AS FUF FOR LAYER

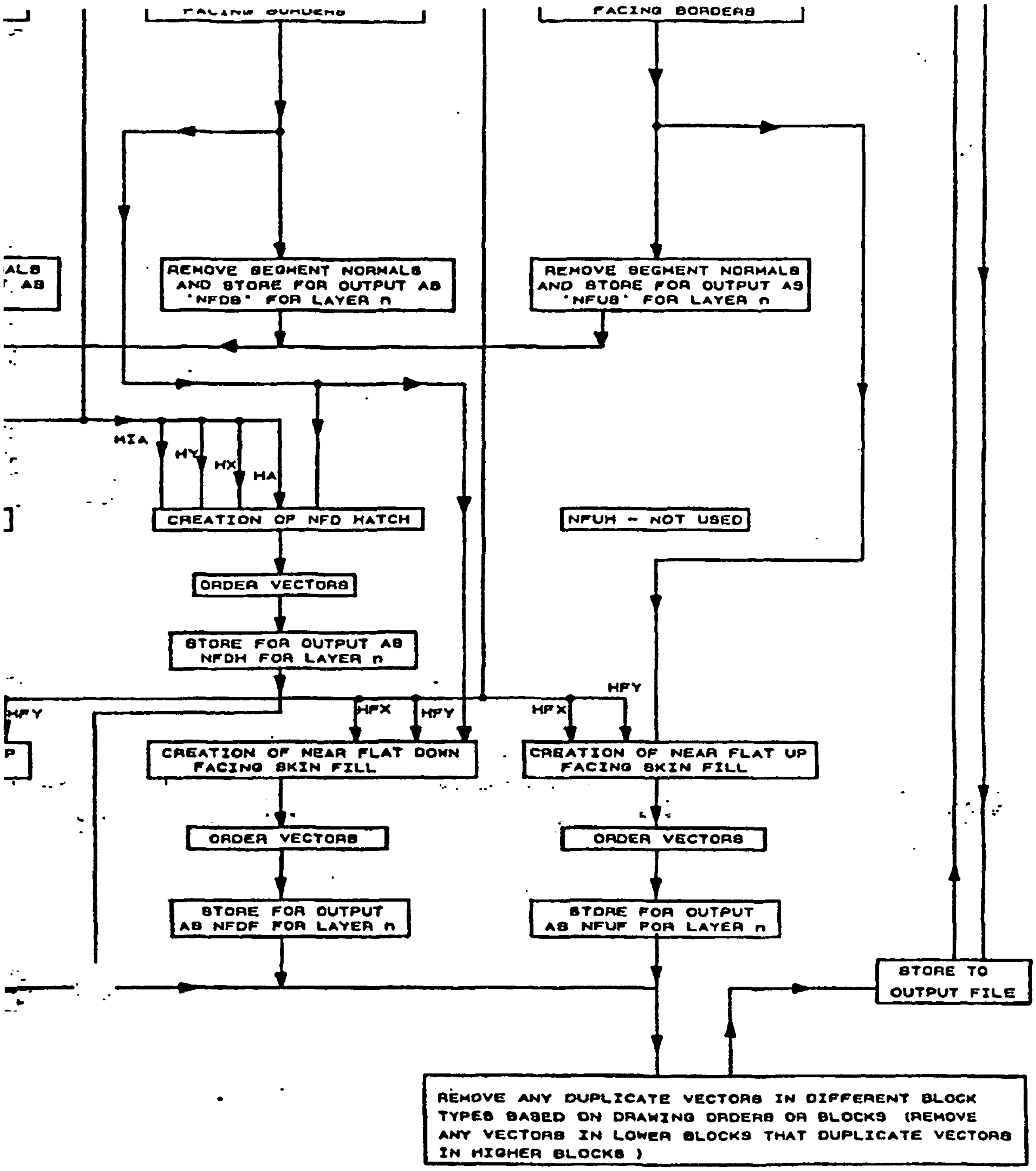
FACING BORDERS
REMOVE SEGMENT NORMALS AND STORE FOR OUTPUT AS 'NFDS' FOR LAYER n
REMOVE SEGMENT NORMALS AND STORE FOR OUTPUT AS 'NFUS' FOR LAYER n
HIA
HY
HX
HA
CREATION OF NFD HATCH
NFUH - NOT USED
ORDER VECTORS
STORE FOR OUTPUT AS NFDH FOR LAYER n
HFY
HFX
HFY
HFX
HFY
CREATION OF NEAR FLAT DOWN FACING SKIN FILL
CREATION OF NEAR FLAT UP FACING SKIN FILL
ORDER VECTORS
ORDER VECTORS
STORE FOR OUTPUT AS NFDF FOR LAYER n
STORE FOR OUTPUT AS NFUF FOR LAYER n
STORE TO OUTPUT FILE
REMOVE ANY DUPLICATE VECTORS IN DIFFERENT BLOCK TYPES BASED ON DRAWING ORDERS OR BLOCKS (REMOVE ANY VECTORS IN LOWER BLOCKS THAT DUPLICATE VECTORS IN HIGHER BLOCKS )

APPENDIX H

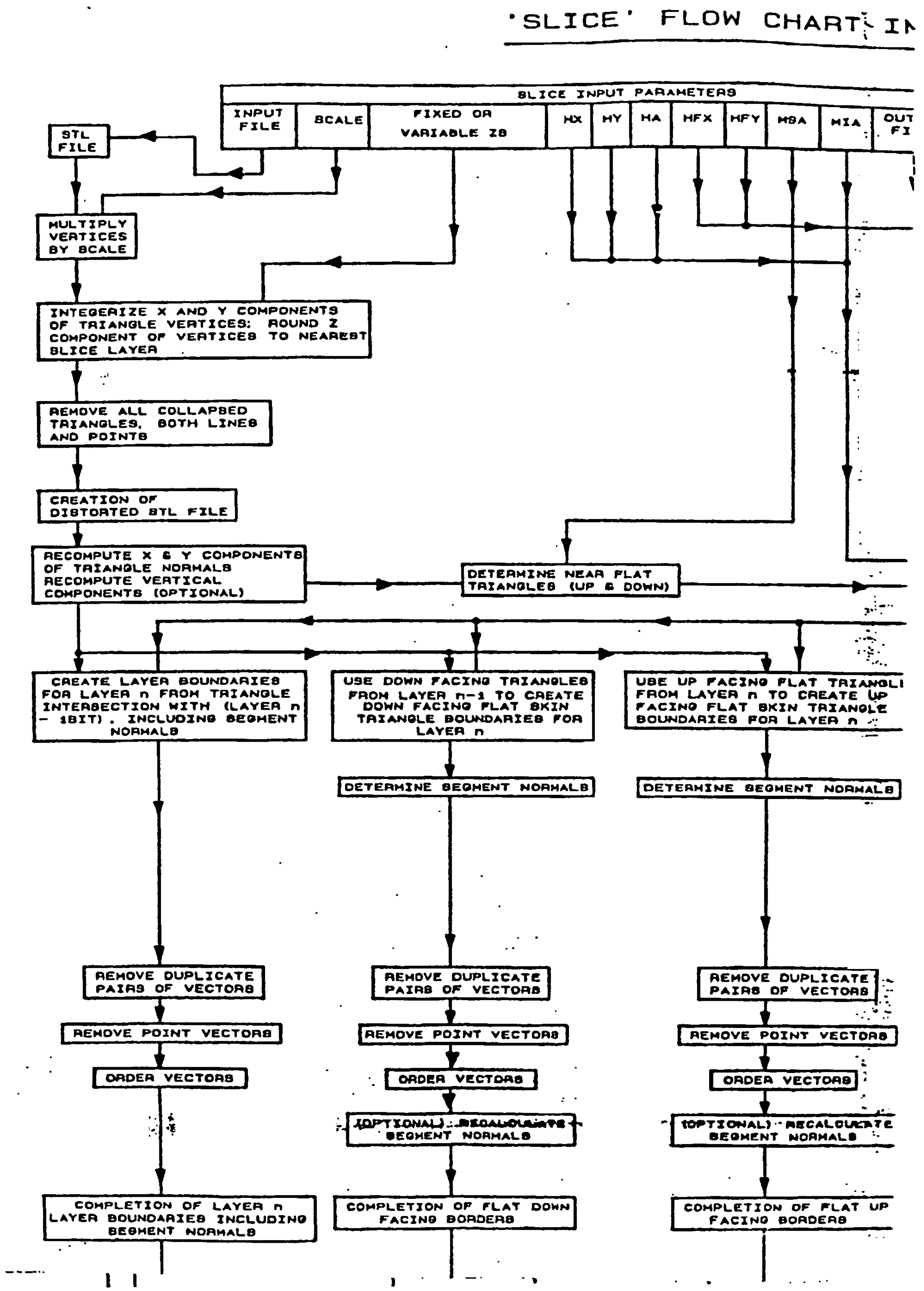
'SLICE' FLOW CHART
SLICE INPUT PARAMETERS
INPUT FILE
SCALE
FIXED OR VARIABLE ZS
HX
HY
HA
HFX
HFY
HSA
HIA
STL FILE
MULTIPLY VERTICES BY SCALE
INTEGERIZE X AND Y COMPONENTS OF TRIANGLE VERTICES: ROUND Z COMPONENT OF VERTICES TO NEAREST SLICE LAYER
REMOVE ALL COLLAPSED TRIANGLES, BOTH LINES AND POINTS
CREATION OF DISTORTED STL FILE
RECOMPUTE X & Y COMPONENTS OF TRIANGLE NORMALS RECOMPUTE VERTICAL COMPONENTS (OPTIONAL)
DETERMINE NEAR FLAT TRIANGLES (UP & DOWN)
CREATE LAYER BOUNDARIES FOR LAYER n FROM TRIANGLE INTERSECTION WITH (LAYER n - 1BIT). INCLUDING SEGMENT NORMALS
USE DOWN FACING TRIANGLES FROM LAYER n-1 TO CREATE DOWN FACING FLAT SKIN TRIANGLE BOUNDARIES FOR LAYER n
USE UP FACING FLAT TRIANGLES FROM LAYER n TO CREATE UP FACING FLAT SKIN TRIANGLE BOUNDARIES FOR LAYER n
DETERMINE SEGMENT NORMALS
DETERMINE SEGMENT NORMALS
REMOVE DUPLICATE PAIRS OF VECTORS
REMOVE DUPLICATE PAIRS OF VECTORS
REMOVE DUPLICATE PAIRS OF VECTORS
REMOVE POINT VECTORS
REMOVE POINT VECTORS
REMOVE POINT VECTORS
ORDER VECTORS
ORDER VECTORS
ORDER VECTORS
(OPTIONAL) RECALCULATE SEGMENT NORMALS
(OPTIONAL) RECALCULATE SEGMENT NORMALS
COMPLETION OF LAYER n LAYER BOUNDARIES INCLUDING SEGMENT NORMALS
COMPLETION OF FLAT DOWN FACING BORDERS
COMPLETION OF FLAT UP FACING BORDERS

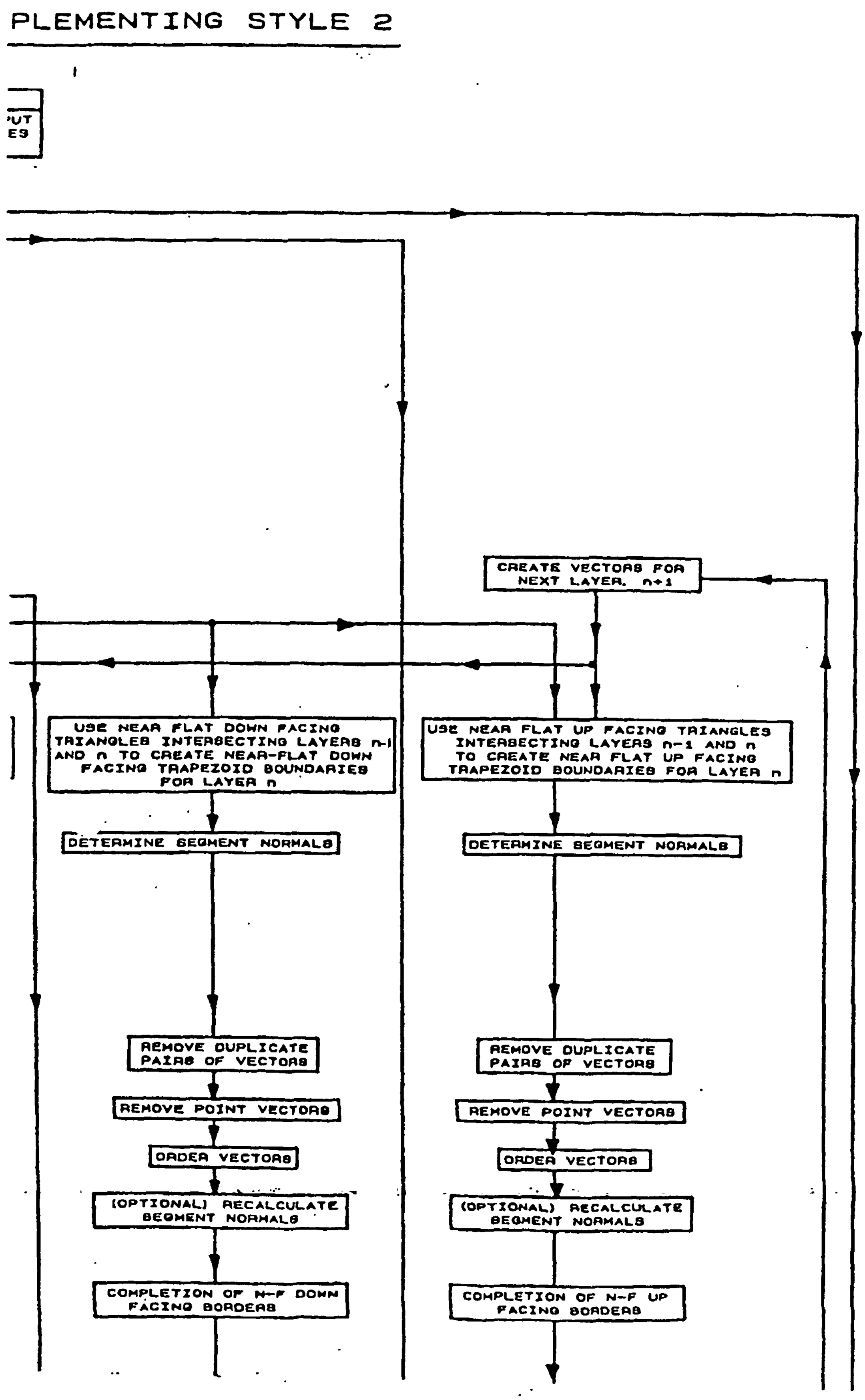
PLEMENTING STYLE 2
'UT
ES
CREATE VECTORS FOR NEXT LAYER, n+1
USE NEAR FLAT DOWN FACING TRIANGLES INTERSECTING LAYERS n-1 AND n TO CREATE NEAR-FLAT DOWN FACING TRAPEZOID BOUNDARIES FOR LAYER n
USE NEAR FLAT UP FACING TRIANGLES INTERSECTING LAYERS n-1 AND n TO CREATE NEAR FLAT UP FACING TRAPEZOID BOUNDARIES FOR LAYER n
DETERMINE SEGMENT NORMALS
DETERMINE SEGMENT NORMALS
REMOVE DUPLICATE PAIRS OF VECTORS
REMOVE DUPLICATE PAIRS OF VECTORS
REMOVE POINT VECTORS
REMOVE POINT VECTORS
ORDER VECTORS
ORDER VECTORS
(OPTIONAL) RECALCULATE SEGMENT NORMALS
(OPTIONAL) RECALCULATE SEGMENT NORMALS
COMPLETION OF N-F DOWN FACING BORDERS
COMPLETION OF N-F UP FACING BORDERS

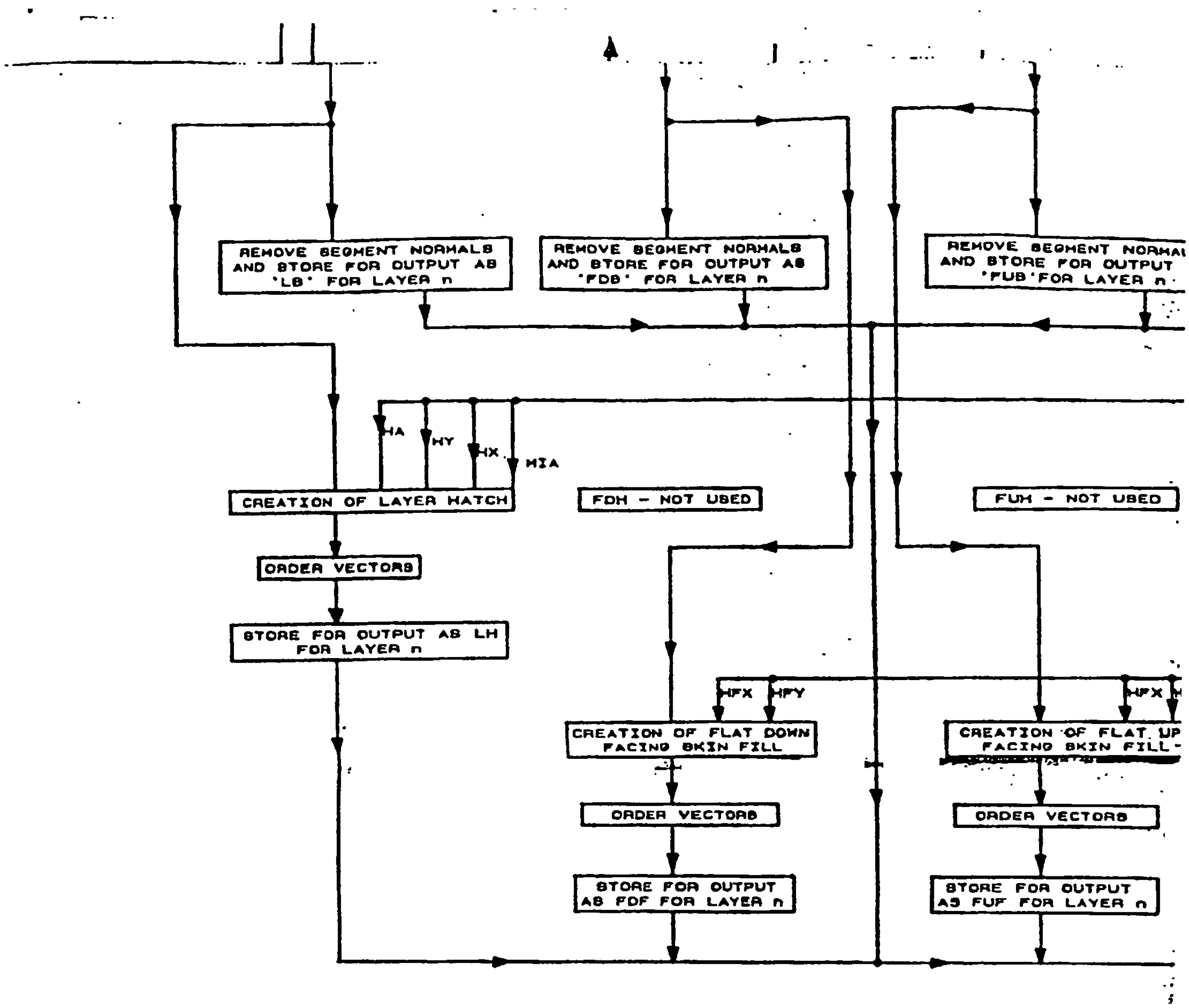
REMOVE SEGMENT NORMALS AND STORE FOR OUTPUT AS 'LB' FOR LAYER n
REMOVE SEGMENT NORMALS AND STORE FOR OUTPUT AS 'FDB' FOR LAYER n
REMOVE SEGMENT NORMAL AND STORE FOR OUTPUT 'FUB' FOR LAYER n
HA
HY
HX
HIA
CREATION OF LAYER HATCH
FDH - NOT USED
FUH - NOT USED
ORDER VECTORS
STORE FOR OUTPUT AS LH FOR LAYER n
HFX
HFY
CREATION OF FLAT DOWN FACING SKIN FILL
CREATION OF FLAT UP FACING SKIN FILL
ORDER VECTORS
ORDER VECTORS
STORE FOR OUTPUT AS FDF FOR LAYER n
STORE FOR OUTPUT AS FUF FOR LAYER n

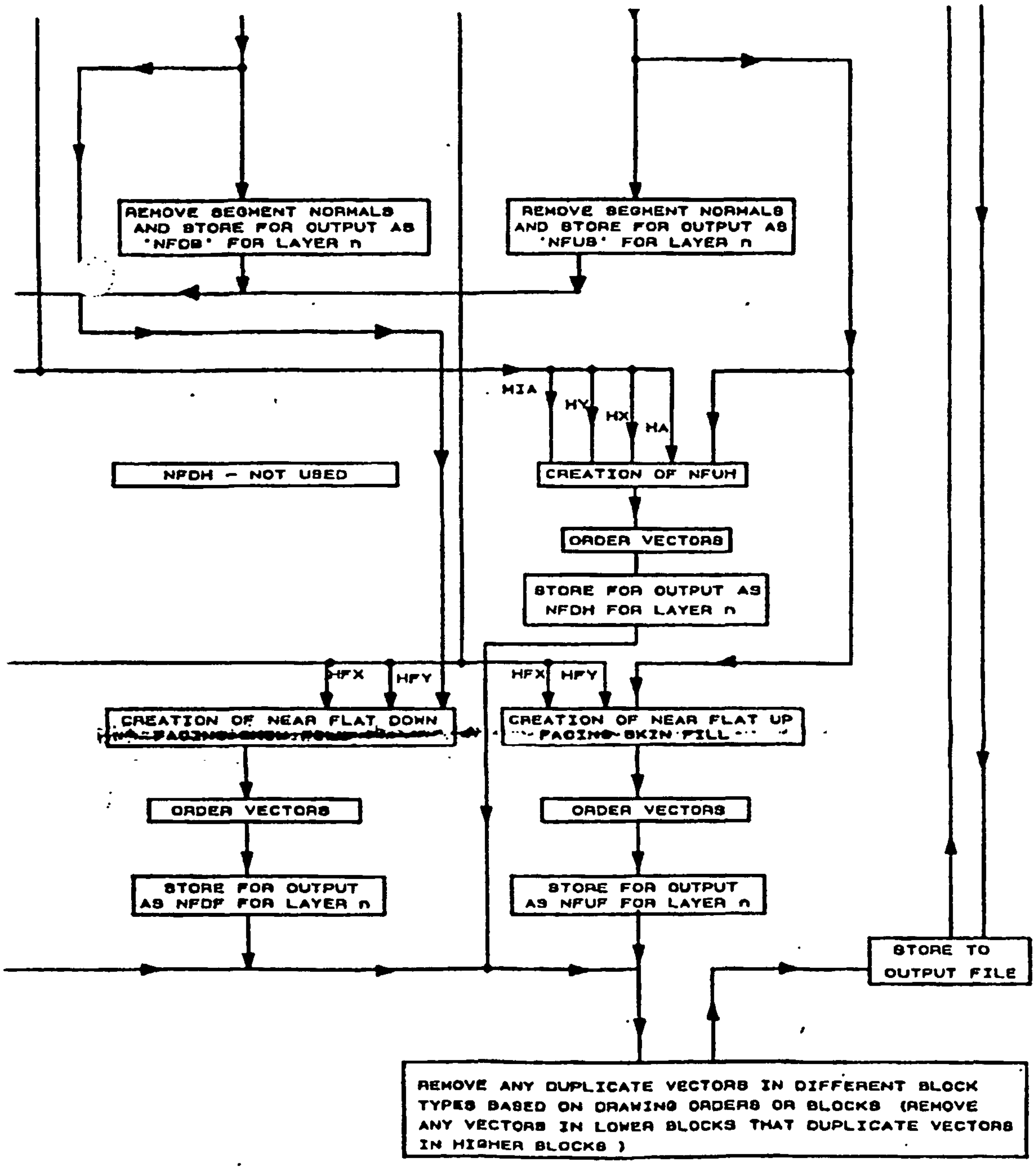


APPENDIX I

**3D SYSTEMS, INC.**

**STEREOLITHOGRAPHY INTERFACE**

1. STEREOLITHOGRAPHY APPARATUS (SLA) OVERVIEW

2. LASER CONTROLLER OVERVIEW

3. TEST PART SPECIFICATION

## 3D SYSTEMS, INC.

## SLA OVERVIEW

3D Systems' StereoLithography Apparatus (SLA) is a new CAP (Computer-aided Prototyping) product allowing a design engineer to quickly construct a three dimensional model designed and stored on a CAD/CAM/CAE system. The SLA, in conjunction with the designer's workstation, allows a convenient, easily installed, and truly integrated CAD/CAM/CAE environment.

An overview of the procedure necessary to produce a part with the SLA is presented in Figure 1.

### 1. Model Entry

To manufacture a part with the SLA, a designer first uses the system to input a model of the part.

### 2. Supporting Structures

Typically this part requires a wall thickness of approximately 0.1" and a support structure to ensure an accurate transfer of the CAD model to the plastic building material. This support structure may be added by the CAD designer or, in the the near future, by the SLA user.

### 3. Attribute Definition

Additionally, the model as input into the CAD system, may have surface and structural features which need special attention during construction. At first, the design engineer is required to manually flag these areas or to modify the part design. As our software matures, more and more of these special cases are expected to be incorporated into the SLA controller.

To flag an area requiring special attention, the CAD designer identifies a volume which encloses a potential structural problem. Areas on the surface of the model may also be highlighted. These areas are now assigned attributes which are passed along to the SLA software for further processing.

### 4. Facet Representation of the Model

The model must now be translated from the internal format used by the CAD system to a planar faceted representation, or, in the near future, an IGES wire frame representation. However, the faceted representation is the only format currently supported by 3D Systems.

This data structure loosely follows a graphics standard called PHIGS (Programmers Hierarchical Interactive Graphics Standard). Figure 2 illustrates the format of this relatively verbose standard. The following paragraphs briefly outline the details of our facet representation. Further details are forthcoming.

#### Facet Normal

Included with each facet is a unit normal which is required to point away from the surface of the solid. For example, given a sphere with a wall thickness of 0.1", (typical for fabrication) the facets that describe the inner surface or wall would have their normals pointing inward, correspondingly, those on the outer surface, outward.

#### Order of Facet Data

Additionally, the vertices of the triangles should be ordered such that they give the direction of the triangle's normal according to the right hand rule. Note that the normal is specified first, followed by the three triangle vertices, followed by the facet attributes.

#### Precision

Internally, the normal's i, j, and k components and the nine vertex coordinates are represented as 32 bit single precision floating point numbers, each with an eight bit exponent and a 24 bit mantissa. This translates into a floating point value with a mantissa of just under eight significant digits, thus giving an upper limit to the usable precision of the PHIGS standard.

Condensed Binary Format

Because the number of facets is expected to exceed 100,000 for more exacting surface finish requirements, a compact form of the facet data will be implemented. This condensed data file requires the normal components and the vertex coordinates to be in a binary floating point format compatible with the Intel 80287 math coprocessor (See figure 3).

This format uses three 32 bit values to specify the normal, a total of nine 32 bit values to specify the triangle vertices, and a 16 bit unsigned integer for the attributes, for a total of 50 bytes per triangular facet.

Facet Attributes

Referring back to step 3 regarding attributes, note that the model attributes identified by the designer are passed along to the SLA system at the facet level. For a large model, several hundred attributes are expected to completely define the model to the SLA software.

Communication to the SLA

The physical transfer of the faceted data and associated attributes from the CAD system to the SLA is made over a high speed data link. In-house the transfer is made over an Excellan Ethernet data link. This data could be transferred over a 19.2 Kbaud RS232 data link or even on floppy disks, but because of the large amounts of data to be transferred, a high speed data link is preferred.

5. Slicing the Model

This faceted data file, which now resides on the SLA, is used as input to a slicing program. The slices or layers of the model typically include crosshatching to strengthen the model walls, skins to surface the model, and special groups of building vectors to accommodate problem areas identified by the facet attributes.

6. Building the Model

The sliced model is now transferred to the SLA supervisor. This program is responsible for actually building the model. By sending the sliced data to the mirrors which direct the SLA's laser, and by controlling the SLA elevator, the supervisor is able to build up the CAD model one layer at a time. Other functions of the supervisor include characterizing the SLA laser, matching the laser speed to the photosensitive properties of the plastic, and coordinating the construction of the more difficult attribute flagged areas.

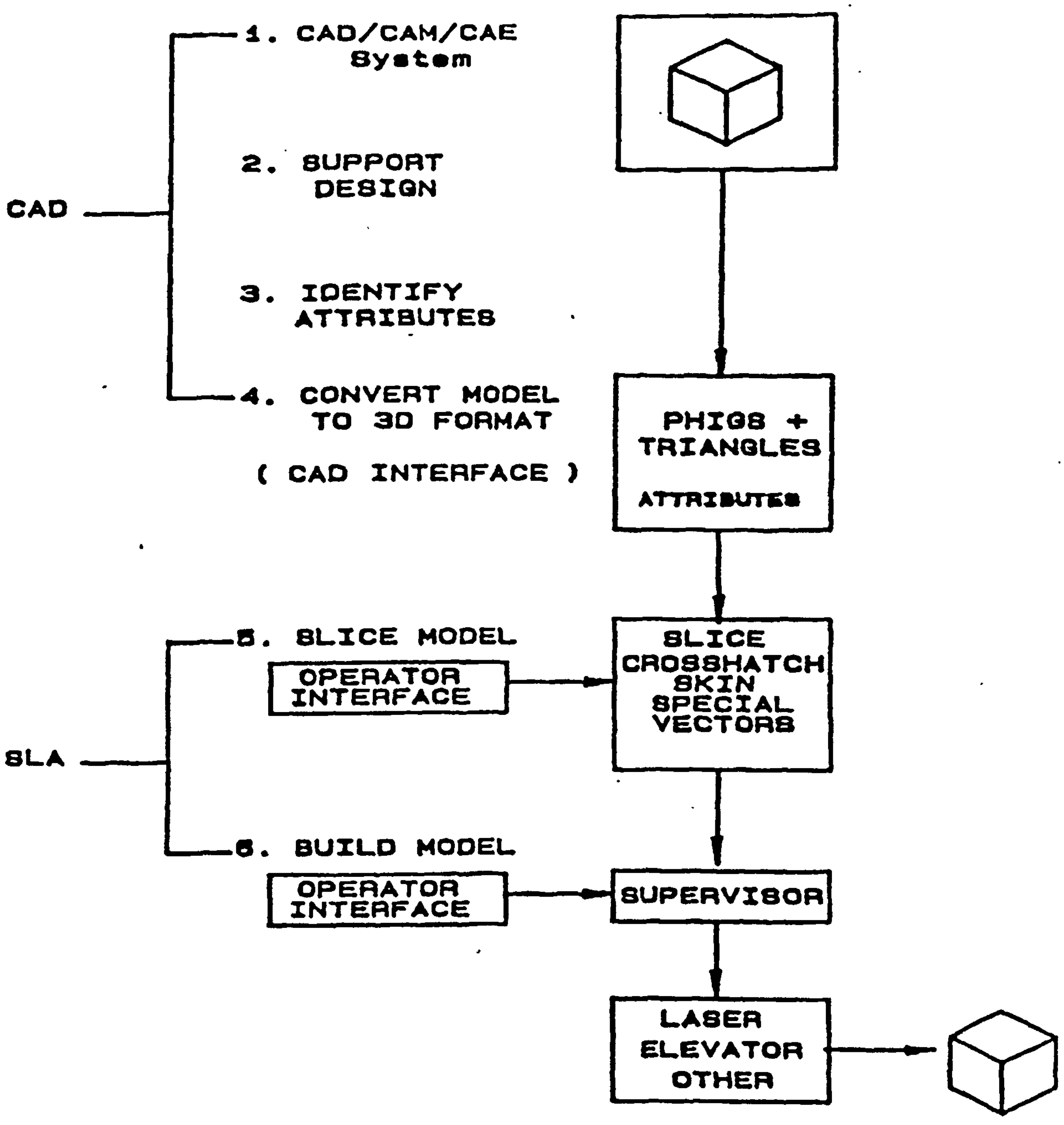
CAD
1. CAD/CAM/CAE System
2. SUPPORT DESIGN
3. IDENTIFY ATTRIBUTES
4. CONVERT MODEL TO 3D FORMAT
( CAD INTERFACE )
PHIGS + TRIANGLES
ATTRIBUTES
SLA
5. SLICE MODEL
OPERATOR INTERFACE
SLICE CROSSHATCH SKIN SPECIAL VECTORS
6. BUILD MODEL
OPERATOR INTERFACE
SUPERVISOR
LASER ELEVATOR OTHER

Figure 1

A Overview

```
solid Solid_Tetra.2
  facet normal -1 0 0
    outer loop
      vertex 0 0 0
      vertex 0 0 1
      vertex 0 1 0
    endloop
  endfacet
  facet normal 0 -1 0
    outer loop
      vertex 0 0 0
      vertex 1 0 0
      vertex 0 1 0
      attribute
    endloop
  ffacet
  facet normal 0 0 -1
    outer loop
      vertex 0 0 0
      vertex 0 1 0
      vertex 1 0 0
      attribute a12
      attribute c4
    endloop
  endfacet
  facet normal n1 n2 n3
    outer loop
      vertex 1 0 0
      vertex 0 1 0
      vertex 0 0 1
      attribute a12
    endloop
  endfacet
endsolid Solid_Tetra.2
```

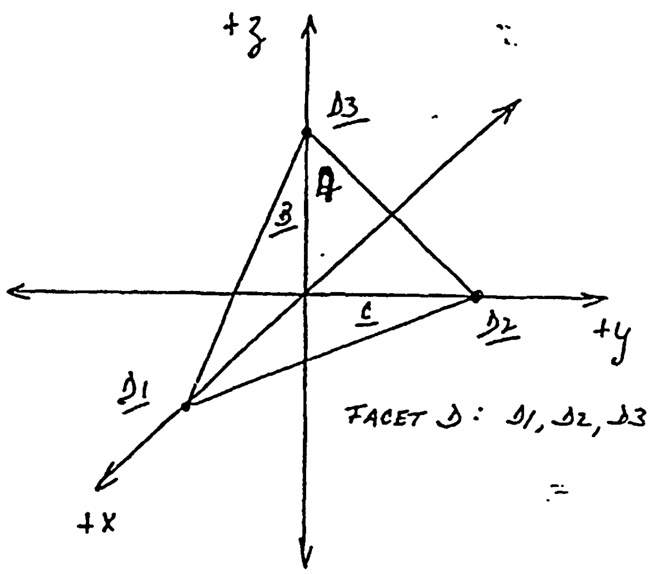


Note: ASCII floating point notation is typically expected for normal and vertex coordinate values, eg "6.58537e-10".

Figure 2

Table 2. 80287 Datatype Representation In Memory

| Data Formats | Range | Precision | Most Significant Byte = HIGHEST ADDRESSED BYTE (7 0 \| 7 0 \| 7 0 \| 7 0 \| 7 0 \| 7 0 \| 7 0 \| 7 0 \| 7 0 \| 7) |
|---|---|---|---|
| Word Integer | $10^4$ | 16 Bits | (TWO'S COMPLEMENT) 15 … 0 |
| Short Integer | $10^9$ | 32 Bits | (TWO'S COMPLEMENT) 31 … 0 |
| Long Integer | $10^{19}$ | 64 Bits | (TWO'S COMPLEMENT) 63 … 0 |
| Packed BCD | $10^{18}$ | 18 Digits | S \| X \| MAGNITUDE $d_{17}, d_{16}, d_{15}, d_{14}, d_{13}, d_{12}, d_{11}, d_{10}, d_9, d_8, d_7, d_6, d_5, d_4, d_3, d_2, d_1$; 79 72 |
| Short Real | $10^{\pm38}$ | 24 Bits | S \| BIASED EXPONENT \| SIGNIFICAND; 31 23 ($\iota$) 0 |
| Long Real | $10^{\pm308}$ | 53 Bits | S \| BIASED EXPONENT \| SIGNIFICAND; 63 52 ($\iota$) 0 |
| Temporary Real | $10^{\pm4932}$ | 64 Bits | S \| BIASED EXPONENT \| I \| SIGNIFICAND; 79 64 63 ($\iota$) |

NOTES:
(1) S = Sign bit (0 = positive, 1 = negative)
(2) $d_n$ = Decimal digit (two per byte)
(3) X = Bits have no significance; 8087 ignores when loading, zeros when storing.
(4) $\iota$ = Position of implicit binary point
(5) I = Integer bit of significand; stored in temporary real, implicit in short and long real
(6) Exponent Bias (normalized values):
- Short Real: 127 (7FH)
- Long Real: 1023 (3FFH)
- Temporary Real: 16383 (3FFFH)

(7) Packed BCD: $(-1)^S(D_{17}\ldots D_0)$
(8) Real: $(-1)^S(2^{E-BIAS})(F_0 F_1\ldots)$

instructions operating on the top one or two stack elements, or as a fixed register set, with instructions operating on explicitly designated registers.

Table 6 lists the 80287's instructions by class. No special programming tools are necessary to use the 80287 since all new instructions and data types are directly supported by the iAPX 286 assembler and appropriate high level languages. All iAPX 86/88 development tools which support the 8087 can also be used to develop software for the iAPX 286/20 in real address mode.

Table 3 gives the execution times of some typical numeric instructions.

4-59

210920-003

Figure 3

3D SYSTEMS, INC.

LASER CONTROLLER OVERVIEW

A CAD program must be able to produce a file with the specific format described below. Ususally this file is quite large in size (several hundred thousand bytes) and is transferred over a high-speed data link such as Ethernet to the 386-based Stereolithography Computer. Transfers of smaller-size files using RS-232 and floppy diskettes are also possible but not recommended.

The SLICE Input Format loosely follows a graphics standard called PHIGS (Programmers Hierarchical Interactive Graphics Standard), and improves on it in several ways. First, all the numeric data can be compressed into binary form, greatly reducing the size of storage files and reducing the data transfer time to the Stereolithography computer. Second, support of special part-building attributes allow certain features to be "attached" to facets and passed all the way down the pike to the Part-Making Supervisor. SLICE does not support negative or 0 values of verticies information.

Files being submitted to SLICE should have the extension ".STL" that is, the name of the files should end in ".STL".

The files can be stored in either ASCII or Binary. We recommend using the ASCII format while developing STL-file-making software and then switching to the binary format for release.

An example of an ASCII STL file follows. It defines a simple tetrahedron.

```
solid Solid_Tetra.2
  facet normal -1 0 0
    outer loop
      vertex 0 0 0
      vertex 0 0 1
      vertex 0 1 0
    endloop
  endfacet
  facet normal 0 -1 0
    outer loop
      vertex 0 0 0
      vertex 1 0 0
      vertex 0 1 0
    endloop
  endfacet
  facet normal 0 0 -1
    outer loop
      vertex 0 0 0
      vertex 0 1 0
      vertex 1 1 0
      attribute 16
      attribute 9
      attribute 22
    endloop
  endfacet
    :     :
endsolid Solid_Tetra.2
```

The important structure for an ASCII STL file which is different from the binary structure is its use of words to identify the type of numeric data. The facet normal and vertex information can be in floating point - numbers like 43.332382912 and 1.3045E+3 are acceptable. Negative and 0 numbers are not accepted for verticies information. If the numbers are in scientific rotation, only E or e for exponent is supported (please do not use D for exponent). Facet normal must be a unit vector. There must be at least one space between two data fields.

We assume a word is 16 bits and is equal to two bytes. The precise format for a binary STL file is:

```
(top of file)
80 bytes - general information
           contains part names, comments, etc.

4 bytes
2 words - number of facet records
          each facet record defines one triangle

First facet record:
6 words - Normal Vector
          2 words - i coordinate
          2 words - j
          2 words - k
18 words- Triangle Vertices
          2 words - x1    )
          2 words - y1    ) - First vertex
          2 words - z1    )
          2 words - x2      )
          2 words - y2      ) - Second vertex
          2 words - z2      )
          2 words - x3        )
          2 words - y3        )
          2 words - z3        )
1 word -  Number of Attributes
          < special attribute >
          This word should be set to zero
    :      :       :
```

The STL Binary Format is similar in structure to the ASCII format. One facet record follows another, and each facet record consists of a unit normal, three triangle vertices, and optionally some attributes. Since we don't as yet support attributes, the attribute count word should be set to zero.

The binary format for the number of facet records and for each number of attributes is just an unsigned integer. The normal and triangle vertices are in four-byte 8087 real format, with a 3 byte mantissa and a 1 byte exponent.

TEST0017.STL

```
solid Solid_Box.6
  facet normal 0 1 2.63415e-09
    outer loop
      vertex 3 1.4 4
      vertex 4 1.4 4
      vertex 4 1.4 3
    endloop
  endfacet
  facet normal 0 1 2.63415e-09
    outer loop
      vertex 4 1.4 3
      vertex 3 1.4 3
      vertex 3 1.4 4
    endloop
  endfacet
  facet normal -6.58537e-09 0 1
    outer loop
      vertex 4 1.4 4
      vertex 3 1.4 4
      vertex 3 1 4
    endloop
  endfacet
  facet normal -6.58537e-09 0 1
    outer loop
      vertex 3 1 4
      vertex 4 1 4
      vertex 4 1.4 4
    endloop
  endfacet
  facet normal 1 4.03548e-08 0
    outer loop
      vertex 4 1 4
      vertex 4 1 3
      vertex 4 1.4 3
    endloop
  endfacet
  facet normal 1 4.03548e-08 0
    outer loop
      vertex 4 1.4 3
      vertex 4 1.4 4
      vertex 4 1 4
    endloop
  endfacet
  facet normal -6.58537e-09 0 -1
    outer loop
      vertex 3 1 3
      vertex 3 1.4 3
      vertex 4 1.4 3
    endloop
  endfacet
  facet normal -6.58537e-09 0 -1
    outer loop
      vertex 4 1.4 3
      vertex 4 1 3
      vertex 3 1 3
    endloop
  endfacet
  facet normal -1 4.03548e-08 0
```

```
        vertex 3 1 3
        vertex 3 1.4 3
        vertex 4 1.4 3
      endloop
    endfacet
    facet normal -6.58537e-09 0 -1
      outer loop
        vertex 4 1.4 3
        vertex 4 1 3
        vertex 3 1 3
      endloop
    endfacet
    facet normal -1 4.03548e-08 0
      outer loop
        vertex 3 1.4 3
        vertex 3 1 3
        vertex 3 1 4
      endloop
    endfacet
    facet normal -1 4.03548e-08 0
      outer loop
        vertex 3 1 4
        vertex 3 1.4 4
        vertex 3 1.4 3
      endloop
    endfacet
    facet normal 0 -1 2.63415e-09
      outer loop
        vertex 4 1 3
        vertex 4 1 4
        vertex 3 1 4
      endloop
    endfacet
    facet normal 0 -1 2.63415e-09
      outer loop
        vertex 3 1 4
        vertex 3 1 3
        vertex 4 1 3
      endloop
    endfacet
endsolid Solid_Box.6
```

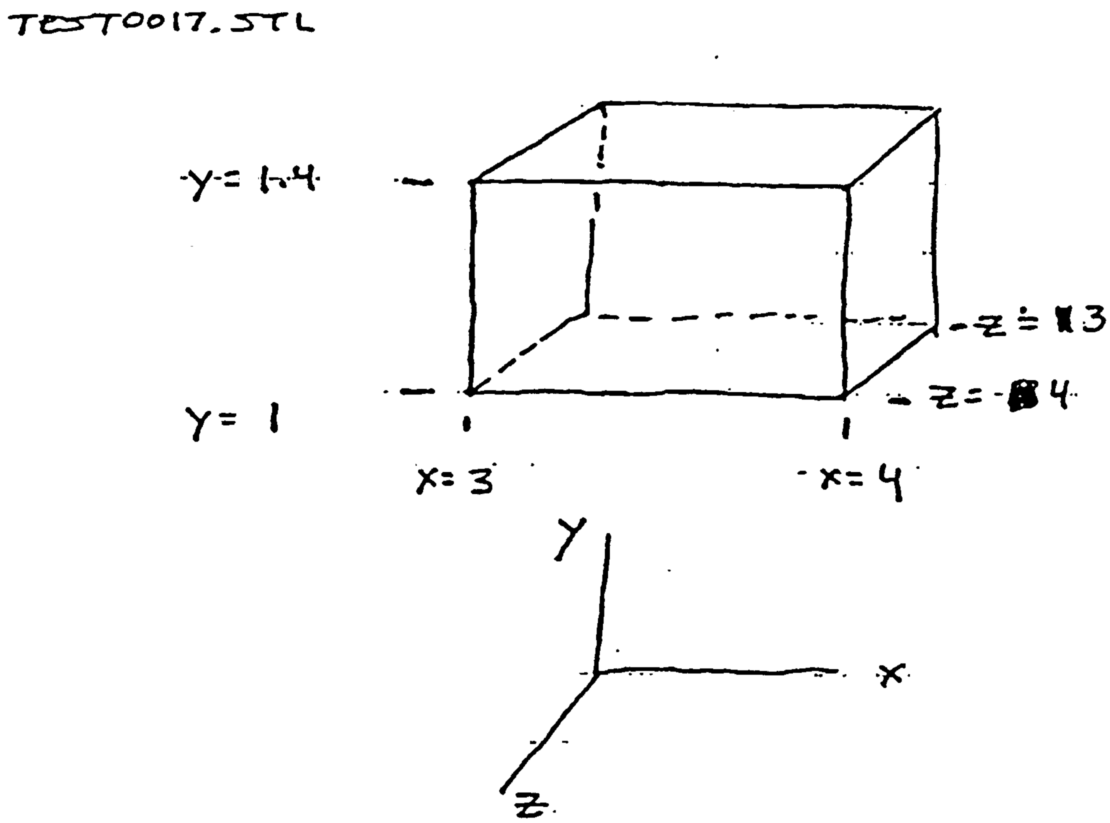
TEST0017.STL
Y= 1.4
Y= 1
X= 3
X= 4
Z= 3
Z= 4
Y
X
Z

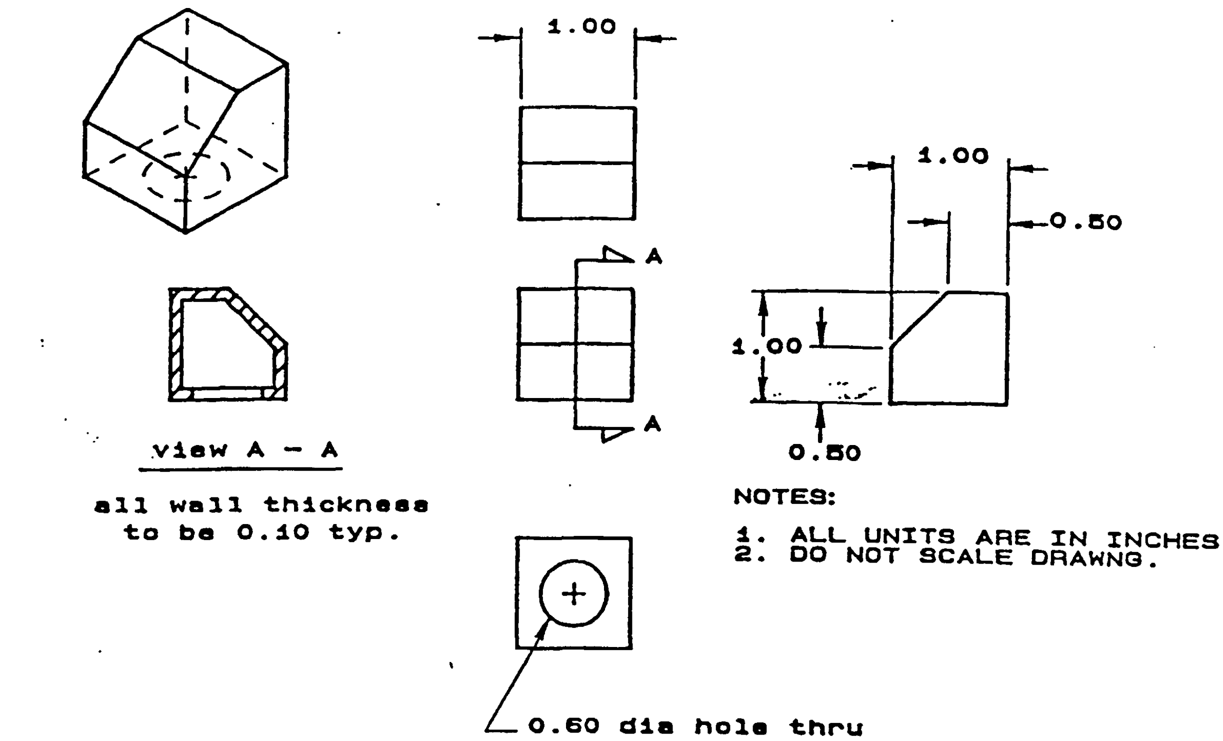

1.00
A
A
1.00
0.50
1.00
0.50
view A - A
all wall thickness
to be 0.10 typ.
NOTES:
1. ALL UNITS ARE IN INCHES
2. DO NOT SCALE DRAWNG.
0.60 dia hole thru


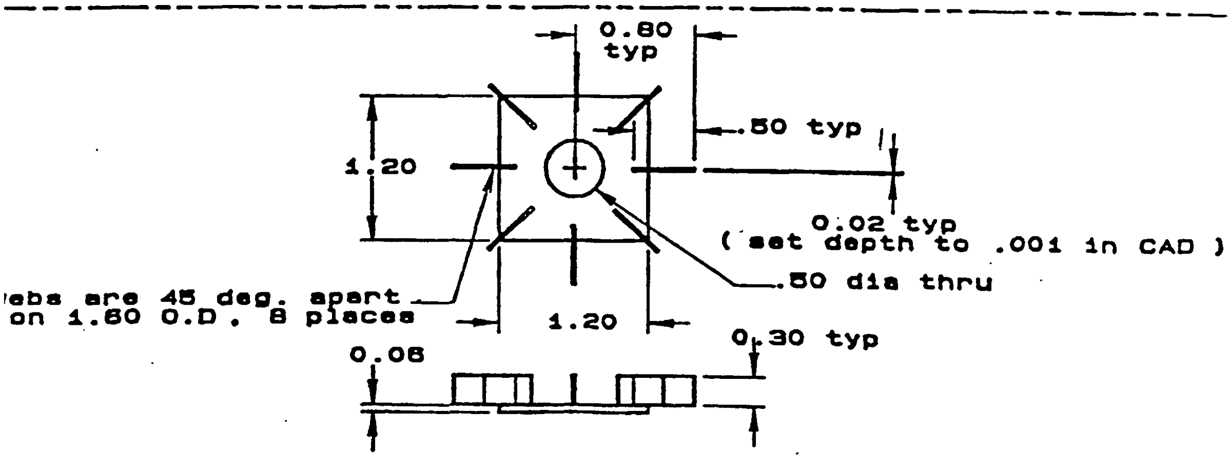

0.80
typ
.50 typ
1.20
0.02 typ
( set depth to .001 in CAD )
.50 dia thru
'ebs are 45 deg. apart
on 1.60 O.D. 8 places
1.20
0.06
0.30 typ

SPATIAL ORIENTATION OF TESTBOX

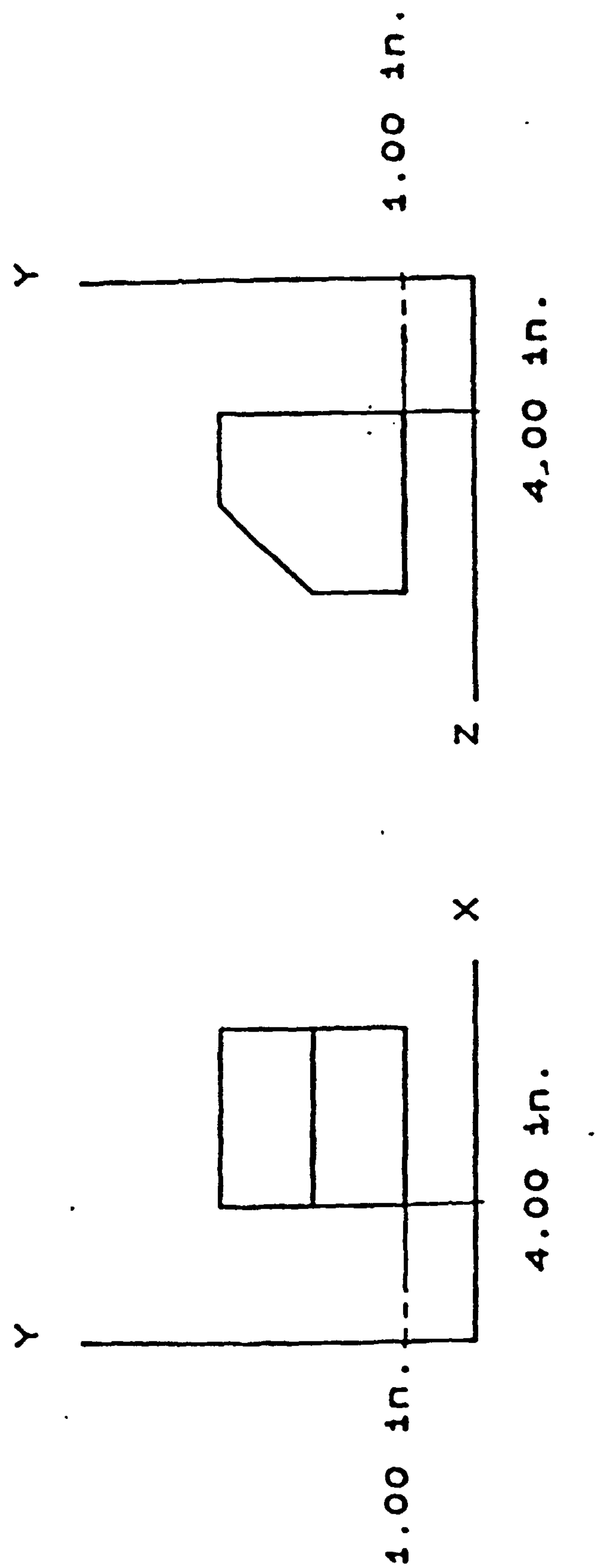

## Claims

1. A method of forming a three-dimensional object (30) layer-by-layer by selectively exposing a solidifiable fluid medium (22) to a beam of prescribed stimulation (27) capable of solidifying the medium whereby the object is built of a succession of superimposed laminae (30a, 30b, 30c) wherein the selected pattern for each layer (23) is obtained by processing stored data (20) defining a desired configuration of the object (30), **characterised in that** said data processing step comprises

   providing a surface shape set of data defining the surface shape of the object (30) to be formed,

   manipulating the surface shape set of data to produce layer data relating to each of successive layers in the formation of the object, and

   forming each of said successive layers (23) by scanning the fluid medium (22) with said beam of prescribed stimulation (27) in a vector fashion in accordance with the layer data for the layer, wherein

   the production of layer data for each layer includes the determination of the existence of different regions of a prescribed plurality of region types for scanning the layer in dependence upon the determined region types.

2. A method as claimed in Claim 1 in which the layer data includes data defining different types of vector scanning to be applied to different types of region.

3. A method as claimed in Claim 1 or 2 in which the vector scanning of a layer is performed on the determined region types in a predetermined order.

4. A method as claimed in Claim 3 in which said plurality of different region types have a prescribed hierarchical ranking for the order in which regions are vector scanned.

5. A method as claimed in any preceding claim in which said determined plurality of region type includes at least one group of two or more related region types, one of which is related to defining a boundary and the other of which is related to an area within the boundary related region type.

6. A method as claimed in any one of Claims 1 to 4 in which said plurality of region type include the group consisting of: layer cross-hatch, near-flat down-facing skin cross-hatch, near-flat down-facing skin fill, near-flat up-facing skin cross-hatch, near-flat up-facing skin fill, flat down-facing skin cross-hatch, flat down-facing skin fill, flat up-facing skin cross-hatch, and flat up-facing skin fill.

7. A method as claimed in Claim 5 in which the other of which region types are selected from the group consisting of: layer cross-hatch, near-flat down-facing skin cross-hatch, near-flat down-facing skin fill, near-flat up-facing skin cross-hatch, near-flat up-facing skin fill, flat down-facing skin cross-hatch, flat down-facing skin fill, flat up-facing skin cross-hatch, and flat up-facing skin fill.

8. A method as claimed in any preceding claim in which the layer data includes data relating to use-specifiable parameters.

9. A method as claimed in Claim 8 wherein the user-specifiable parameters include a curing parameter and/or a dipping parameter.

10. A method as claimed in any preceding claim wherein the surface shape data includes data defining the object surfaces in terms of polygon vertices.

11. A method as claimed in Claim 10 wherein the manipulation of the surface data to produce layer data includes rounding the polygon vertices to the nearest layer.

12. A method as claimed in Claim 10 or 11 in which the polygon vertices of the surface shape data are defined in the direction normal to successive layers with a scale bit resolution that is less than the interval between a pair of adjacent layers of said successive layers.

13. A method as claimed in Claim 12 in which the slicing of the surface shape data to obtain the layer data is performed at one scale bit of the resolution above each layer.

14. A method as claimed in any preceding claim in which said surface shape data is derived from CAD/CAM data relating to the object to be formed.

**15.** Apparatus for forming a three-dimensional object (30) from stored data (20) defining a desired configuration of the object layer-by-layer by selectively exposing a solidifiable medium (22) to a beam of prescribed stimulation (27) capable of solidifying the medium comprising
a container for the fluid medium (22),
means for scanning a beam of the prescribed stimulation over a working surface of the fluid medium; and
a computer-system programmed to control the formation of the object in accordance with a surface shape set of data defining the surface shape of the object to be formed,
the apparatus including a data processing means for generating from the stored data (20) the pattern of stimulation applied to each fluid layer, **characterised in that** said data processing means (21) comprises means for manipulating the surface shape set of data to produce layer data relating to each of successive layers in the formation of the object, and

forming each of said successive layers by scanning the fluid medium with said beam of prescribed stimulation in a vector fashion in accordance with the layer data for the layer, wherein

the production of layer data for each layer includes the determination of the existence of different regions of a prescribe plurality of region type for scanning the layer in dependence upon the determined region types.

## Patentansprüche

**1.** Verfahren zum Bilden eines dreidimensionalen Objekts (30) Schicht um Schicht durch selektives Aussetzen eines verfestigbaren flüssigen Mediums (22) einem Strahl einer vorbestimmten Stimulation (27), der geeignet ist, dass Medium zu verfestigen, wobei das Objekt aufgebaut wird aus einer Aufeinanderfolge von übereinander liegenden Lagen (30a, 30b, 30c), wobei des ausgewählte Muster für jede Schicht (23) erhalten, wird durch Verarbeiten von gespeicherten Daten (20), die eine gewünschte Konfiguration des Objekts (30) definieren, **dadurch gekennzeichnet, dass** der Datenverarbeitungsschritt umfasst
Bereitstellen eines Datensatzes für eine Oberflächenform, der die Oberflächenform des Objekts (30), das geformt werden soll, definiert,
Manipulieren des Datensatzes der Oberflächenform, um Schichtdaten zu erzeugen, die sich auf aufeinander folgende Schichten bei der Bildung des Objekts beziehen; und
Bilden jeder der aufeinander folgenden Schichten (23) durch Scannen des flüssigen Mediums (22) mit dem Strahl der vorgeschriebenen Stimulation (27) in einer Vektor-Weise in Übereinstimmung mit den Schichtdaten für die Schicht; wobei
die Erzeugung von Schichtdaten für jede Schicht umfasst die Bestimmung der Existenz von unterschiedlichen Regionen einer vorgeschriebenen Mehrzahl von Regionentypen, um die Schicht in Abhängigkeit von den bestimmten Regionentypen zu Scannen.

**2.** Verfahren gemäß Anspruch 1, wobei die Schichtdaten Daten umfassen, die unterschiedliche Typen des Vektorscannens definieren, die an unterschiedlichen Regionentypen angewandt werden sollen.

**3.** Verfahren gemäß Anspruch 1 oder 2, wobei das Vektorscannen einer Schicht durchgeführt wird an den bestimmten Regionentypen in einer vorbestimmten Reihenfolge.

**4.** Verfahren gemäß Anspruch 3, wobei die Mehrzahl von unterschiedlichen Regionentypen ein vorgeschriebenes hierarchisches Ranking haben, für die Reihenfolge, in der die Regionen vektorgescannt werden.

**5.** Verfahren gemäß einem der vorherigen Ansprüche, wobei die vorbestimmte Mehrzahl von Regionentypen umfasst mindestens eine Gruppe von zwei oder mehr in Beziehung stehenden Regionentypen, wovon eine in Beziehung steht, um eine Grenze zu definieren und die andere davon in Beziehung steht zu einem Gebiet innerhalb des auf die Grenze bezogenen Regionentyps.

**6.** Verfahren gemäß einem der Ansprüche 1 bis 4, wobei die Mehrzahl von Regionentypen umfasst die Gruppe bestehend aus: Schichtschraffur, nahezu flache nach unten zeigende Hautschraffur, nahezu flache nach unten zeigende Hautfüllung, nahezu flache nach oben zeigende Hautschraffur, nahezu flache nach oben zeigende Hautfüllung, flache nach unten zeigende Hautschraffur, flache nach unten zeigende Hautfüllung, flache nach oben zeigende Hautschraffur und flache nach oben zeigende Hautfüllung.

**7.** Verfahren gemäß Anspruch 5, wobei die andere der Regionentypen ausgewählt wird aus der Gruppe bestehend aus: Lagenschraffur, nahezu flache, nach unten zeigende Hautschraffur, nahezu flache nach unten zeigende Hautfüllung, nahezu flache nach oben zeigende Hautschraffur, nahezu flache nach oben zeigende Hautfüllung, flache nach unten zeigende Hautschraffur, flache nach unten zeigende Hautfüllung, flache nach oben zeigende Hautschraffur und flache nach oben zeigende Hautfüllung.

**8.** Verfahren gemäß einem der vorhergehenden Ansprüche, wobei die Schichtdaten Daten umfassen, die auf verwendungsspezifische Parameter bezogen sind.

**9.** Verfahren gemäß Anspruch 8, wobei die verwenderspezifischen Parameter einen Anshärteparameter und/oder einen Eintauchparameter umfassen.

**10.** Verfahren gemäß einem der vorherigen Ansprüche, wobei die Oberflächenformdaten Daten umfassen, die die Objektoberflächen in Form von Polygoneckpunkten definieren.

**11.** Verfahren gemäß Anspruch 10, wobei die Manipulation der Oberflächendaten, um Schichtdaten zu erzeugen, das Abrunden der Polygoneckpunkte zu der nächsten Schicht umfasst.

**12.** Verfahren gemäß Anspruch 10 oder 11, wobei die Polygoneckpunkte der Oberflächenformdaten definiert sind in der Richtung normal zu den aufeinander folgenden Schichten mit einer Skalierungs-Bit-Auflösung, welche geringer ist als das Intervall zwischen einem Paar von benachbarten Schichten von den aufeinander folgenden Schichten.

**13.** Verfahren gemäß Anspruch 12, wobei das In-Scheiben-Sohneiden der Oberflächenformdaten, um die Schichtdaten zu erhalten, durchgeführt wird bei einem Skalierungs-Bit der Auflösung oberhalb jeder Schicht.

**14.** Verfahren gemäß einem der vorherigen Ansprüche, wobei die Oberflächenformdaten von CAD/CAM-Daten gewonnen werden, die sich auf das zu formende Objekt beziehen.

**15.** Vorrichtung zum Bilden eines dreidimensionalen Objekts (30) von gespeicherten Daten (20), die eine gewünschte Konfiguration des Objekts Schicht für Schicht definieren durch solektives Aussetzen eines verfestigbaren Mediums (22) einem Strahl einer vorgeschriebenen Stimulation (27), die geeignet ist, das Medium auszuhärten, umfassend:

einen Behälter für das flüssige Medium (22);

Mittel zum Scannen eines Strahls der vorgeschriebenen Stimulation über eine Arbeitsoberfläche des flüssigen Mediums; und

ein Computersystem, das programmiert ist, die Bildung des Objekts zu steuern, in Übereinstimmung mit einem Datensatz der Oberflächenform, der die Oberflächenform des zu formenden Objekts definiert;

wobei die Vorrichtung ein Datenverarbeitungsmittel umfasst, zum Erzeugen des Musters der Stimulation, die auf jede flüssige Schicht angewandt wird, aus den gespeicherten Daten (20), **dadurch gekennzeichnet, dass** das Datenverarbeitungsmittel (21) Mittel umfasst zum Manipulieren des Datensatzes der Oberflächenform, um Schichtdaten zu erzeugen, die sich auf jede der aufeinander folgenden Schichten bei der Bildung des Objekts bezieht, und
Bilden jeder der aufeinander folgenden Schichten durch Scannen des flüssigen Mediums mit dem Strahl der vorgeschriebenen Stimulation in einer Vektor-Weise in Übereinstimmung mit den Schichtdaten für die Schicht; wobei die Erzeugung der Schichtdaten für jede Schicht die Bestimmung der Existenz von unterschiedlichen Regionen von einer vorbestimmten Mehrzahl von Regionentypen umfasst, um die Schicht in Abhängigkeit von den bestimmten Regionentypen zu scannen.

## Revendications

**1.** Procédé de formation d'un objet tridimensionnel (30) couche par couche en exposant sélectivement un support de fluide solidifiable (22) à un faisceau de stimulation prescrite (27) capable de solidifier le support par lequel l'objet est constitué d'une succession de feuillets superposés (30a, 30b, 30c), dans lequel le motif sélectionné pour chaque couche (23) est obtenu en traitant des données mémorisées (20) définissant une configuration voulue de l'objet (30), **caractérisé en ce que** ladite étape de traitement de données comporte les étapes consistant à :

fournir un ensemble de données de forme de surface définissant la forme de surface de l'objet (30) à former,
manipuler l'ensemble de données de forme de surface pour produire des données de couches concernant chacune des couches successives dans la formation de l'objet, et
former chacune desdites couches successives (23) en balayant le support de fluide (22) par ledit faisceau de stimulation prescrite (27) d'une manière vectorielle conformément aux données de couches relatives à la couche, dans lequel
la production de données de couches pour chaque couche inclut la détermination de l'existence de différentes régions d'une pluralité prescrite de types de régions pour balayer la couche en fonction des types de régions déterminés.

**2.** Procédé selon la revendication 1, dans lequel les données de couches incluent des données définissant différents types de balayage vectoriel à appliquer à différents types de régions.

**3.** Procédé selon la revendication 1 ou 2, dans lequel le balayage vectoriel d'une couche est effectué sur les types de régions déterminés suivant un ordre prédéterminé.

**4.** Procédé selon la revendication 3, dans lequel ladite pluralité de différents types de régions ont un rang hiérarchique prescrit pour l'ordre suivant lequel les régions sont soumises à un balayage vectoriel.

**5.** Procédé selon l'une quelconque des revendications précédentes, dans lequel ladite pluralité déterminée de types de régions inclut au moins un groupe de deux ou plus de deux types de régions concernés, dont l'un se rapporte à la définition d'une frontière et l'autre se rapporte à une zone dans le type de région relatif à une frontière.

**6.** Procédé selon l'une quelconque des revendications 1 à 4, dans lequel ladite pluralité de types de régions inclut le groupe constitué d'une hachure croisée de couche, une hachure croisée pelliculaire tournée vers le bas presque plate, une charge pelliculaire tournée vers le bas presque plate, une hachure croisée pelliculaire tournée vers le haut presque plate, une charge pelliculaire tournée vers le haut presque plate, une hachure croisée pelliculaire tournée vers le bas plate, une charge pelliculaire tournée vers le bas plate, une hachure croisée pelliculaire tournée vers le haut plate, et une charge pelliculaire tournée vers le haut plate.

**7.** Procédé selon la revendication 5, dans lequel les autres types de régions sont sélectionnés parmi le groupe constitué d'une hachure croisée de couche, une hachure croisée pelliculaire tournée vers le bas presque plate, une charge pelliculaire tournée vers le bas presque plate, une hachure croisée pelliculaire tournée vers le haut presque plate, une charge pelliculaire tournée vers le haut presque plate, une hachure croisée pelliculaire tournée vers le bas plate, une charge pelliculaire tournée vers le bas plate, une hachure croisée pelliculaire tournée vers le haut plate, et une charge pelliculaire tournée vers le haut plate.

**8.** Procédé selon l'une quelconque des revendications précédentes, dans lequel les données de couches incluent des données concernant des paramètres spécifiables par l'utilisateur.

**9.** Procédé selon la revendication 8, dans lequel les paramètres spécifiables par l'utilisateur incluent un paramètre de durcissement et/ou un paramètre d'immersion.

**10.** Procédé selon l'une quelconque des revendications précédentes, dans lequel les données de forme de surface incluent des données définissant les surfaces d'objet en termes de sommets de polygone.

**11.** Procédé selon la revendication 10, dans lequel la manipulation des données de surface pour produire des données de couches inclut l'arrondissement des sommets de polygone jusqu'à la couche la plus proche.

**12.** Procédé selon la revendication 10 ou 11, dans lequel les sommets de polygone des données de forme de surface sont définis dans la direction normale à des couches successives à une résolution d'échelle binaire qui est plus petite que l'intervalle entre une paire de couches adjacentes desdites couches successives.

**13.** Procédé selon la revendication 12, dans lequel le découpage des données de forme de surface pour obtenir les données de couches est effectué à un seul bit d'échelle de la résolution au-dessus de chaque couche.

**14.** Procédé selon l'une quelconque des revendications précédentes, dans lequel lesdites données de forme de surface sont dérivées à partir de données de conception et fabrication assistées par ordinateur (CAD/CAM) relatives à l'objet à former.

**15.** Dispositif pour former un objet tridimensionnel (30) à partir de données mémorisées (20) définissant une configuration voulue de l'objet couche par couche en exposant sélectivement un support solidifiable (22) à un faisceau de stimulation prescrite (27) capable de solidifier le support, comportant :

un conteneur pour le support de fluide (22),
des moyens pour balayer un faisceau de la stimulation prescrite sur une surface de travail du support de fluide, et
un système informatique programmé pour commander la formation de l'objet conformément à un ensemble de données de forme de surface définissant la forme de surface de l'objet à former,
le dispositif incluant des moyens de traitement de données pour générer à partir des données mémorisées (20) le motif de stimulation appliqué à chaque couche de fluide,

**caractérisé en ce que** lesdits moyens de traitement de données (21) comportent des moyens pour manipuler l'ensemble de données de forme de surface pour produire des données de couches concernant chacune des couches successives dans la formation de l'objet, et

former chacune desdites couches successives en balayant le support de fluide par ledit faisceau de stimulation prescrite d'une manière vectorielle conformément aux données de couches relatives à la couche, dans lequel

la production de données de couches pour chaque couche inclut la détermination de l'existence de différentes régions d'une pluralité prescrite de types de régions pour balayer la couche en fonction des types de régions déterminés.

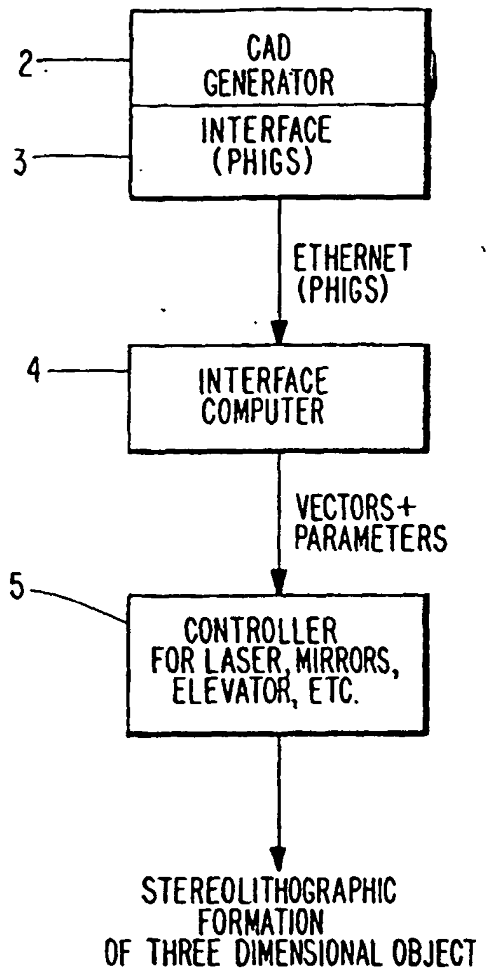
2
CAD GENERATOR
3
INTERFACE (PHIGS)
ETHERNET (PHIGS)
4
INTERFACE COMPUTER
VECTORS+ PARAMETERS
5
CONTROLLER FOR LASER, MIRRORS, ELEVATOR, ETC.
STEREOLITHOGRAPHIC FORMATION OF THREE DIMENSIONAL OBJECT

FIG. 1.

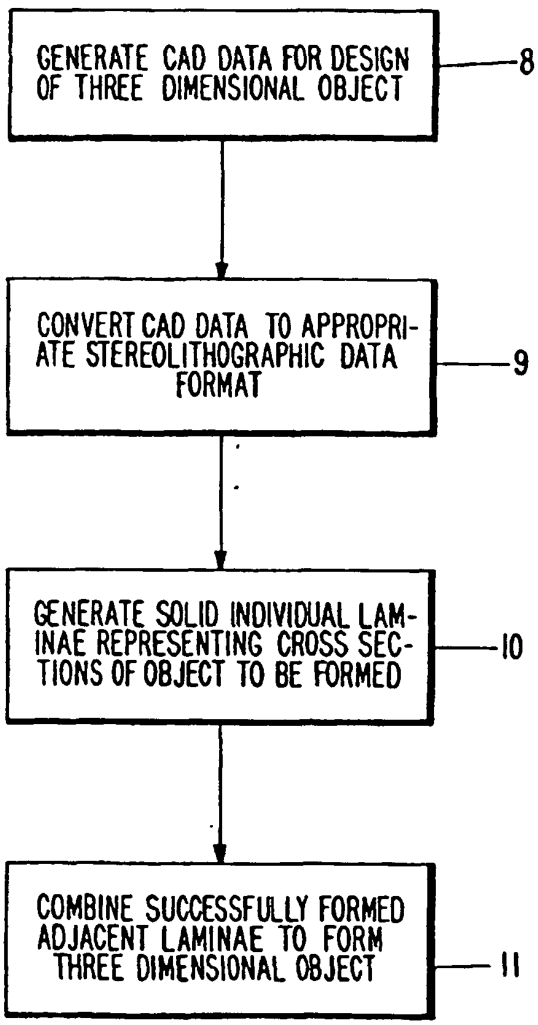
GENERATE CAD DATA FOR DESIGN OF THREE DIMENSIONAL OBJECT
8
CONVERT CAD DATA TO APPROPRIATE STEREOLITHOGRAPHIC DATA FORMAT
9
GENERATE SOLID INDIVIDUAL LAMINAE REPRESENTING CROSS SECTIONS OF OBJECT TO BE FORMED
10
COMBINE SUCCESSFULLY FORMED ADJACENT LAMINAE TO FORM THREE DIMENSIONAL OBJECT
11

FIG. 2.

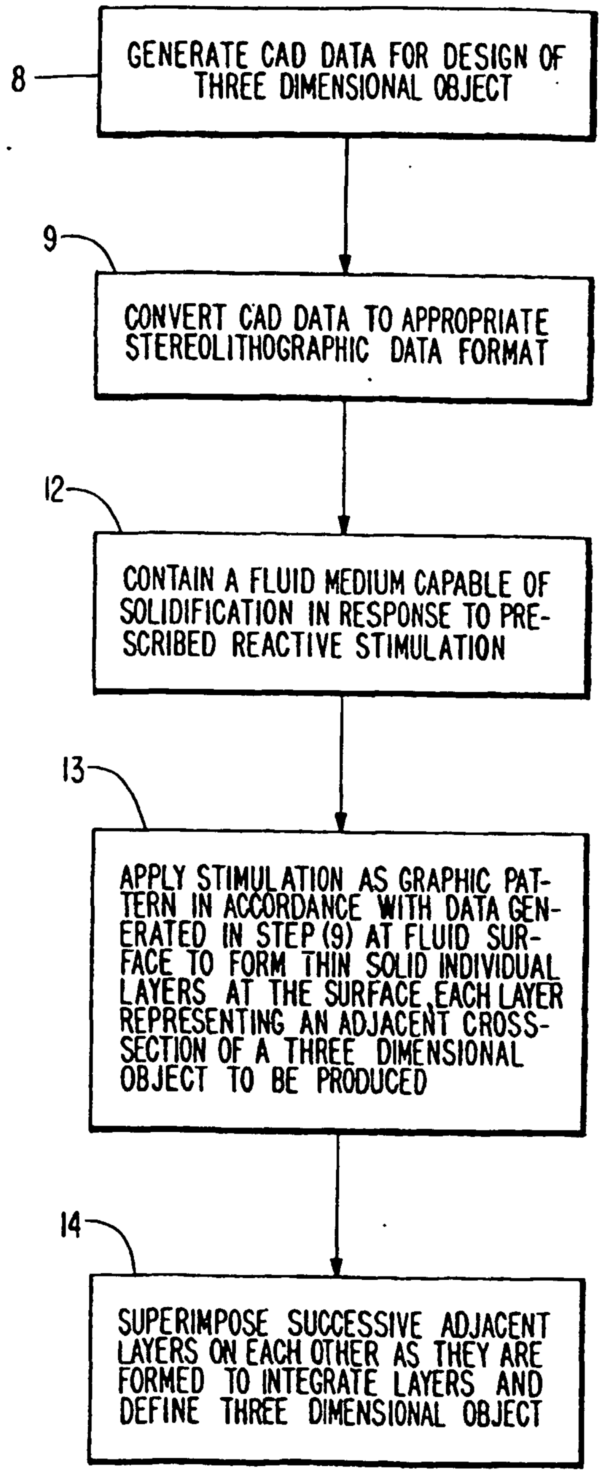
8
GENERATE CAD DATA FOR DESIGN OF THREE DIMENSIONAL OBJECT
9
CONVERT CAD DATA TO APPROPRIATE STEREOLITHOGRAPHIC DATA FORMAT
12
CONTAIN A FLUID MEDIUM CAPABLE OF SOLIDIFICATION IN RESPONSE TO PRESCRIBED REACTIVE STIMULATION
13
APPLY STIMULATION AS GRAPHIC PATTERN IN ACCORDANCE WITH DATA GENERATED IN STEP (9) AT FLUID SURFACE TO FORM THIN SOLID INDIVIDUAL LAYERS AT THE SURFACE, EACH LAYER REPRESENTING AN ADJACENT CROSS-SECTION OF A THREE DIMENSIONAL OBJECT TO BE PRODUCED
14
SUPERIMPOSE SUCCESSIVE ADJACENT LAYERS ON EACH OTHER AS THEY ARE FORMED TO INTEGRATE LAYERS AND DEFINE THREE DIMENSIONAL OBJECT

FIG. 3.

FIG. 4.

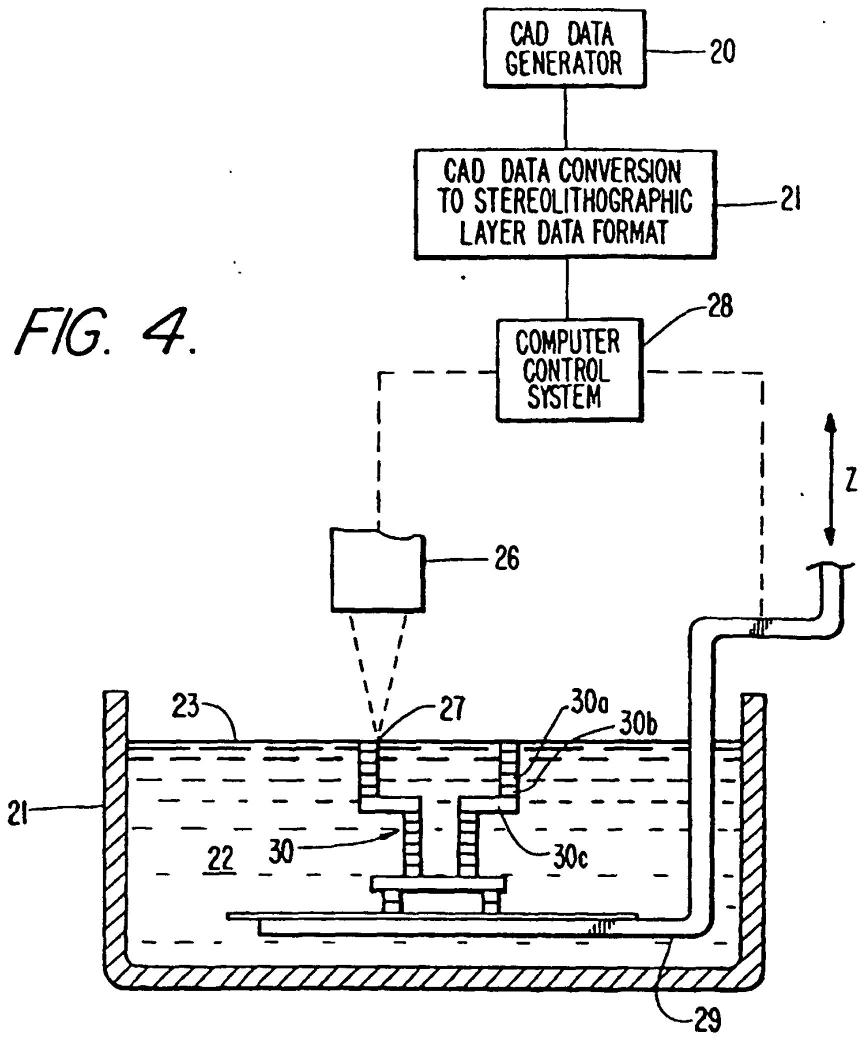
CAD DATA GENERATOR
20
CAD DATA CONVERSION TO STEREOLITHOGRAPHIC LAYER DATA FORMAT
21
COMPUTER CONTROL SYSTEM
28
Z
26
23
27
30a
30b
21
22
30
30c
29

FIG. 5.

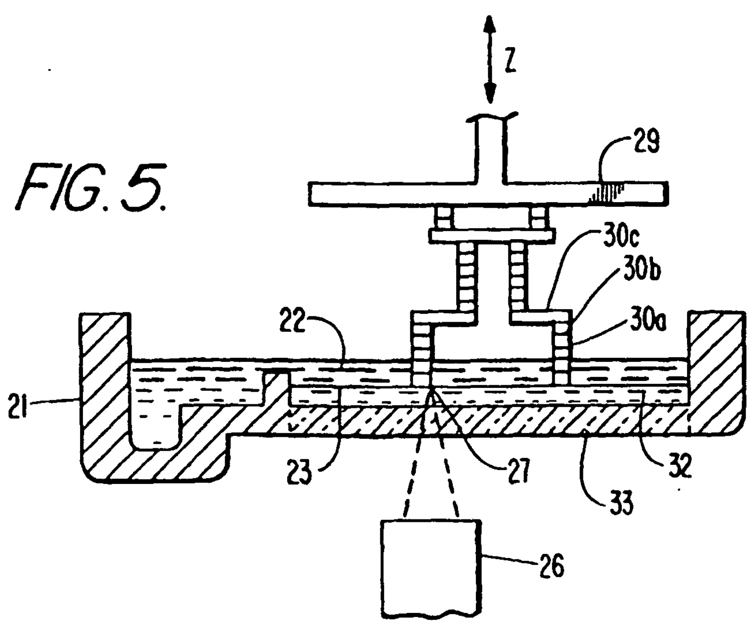
Z
29
30c
30b
22
30a
21
23
27
32
33
26

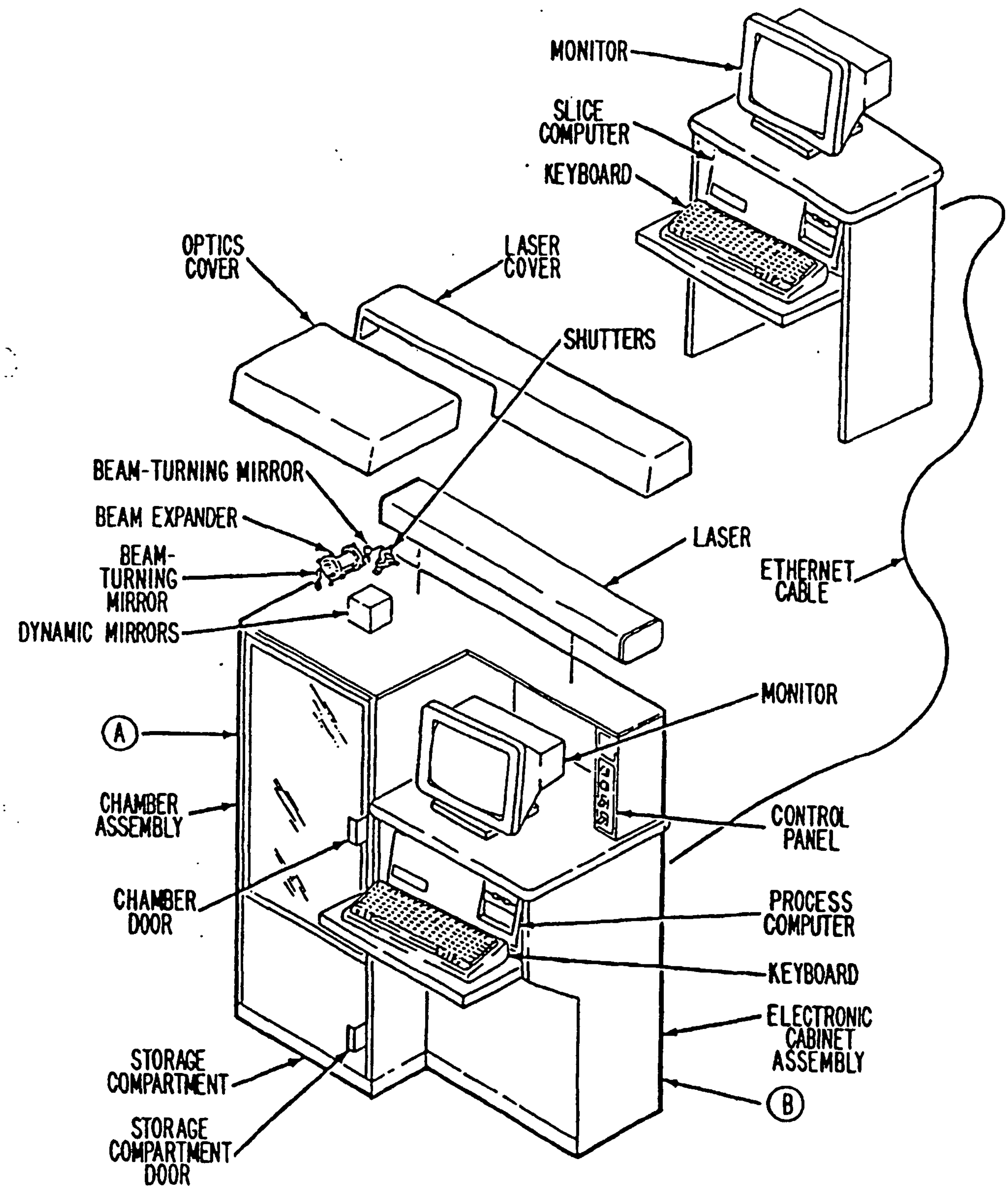


MAJOR COMPONENTS OF THE STEREOLITHOGRAPHY SYSTEM

*FIG. 6.*

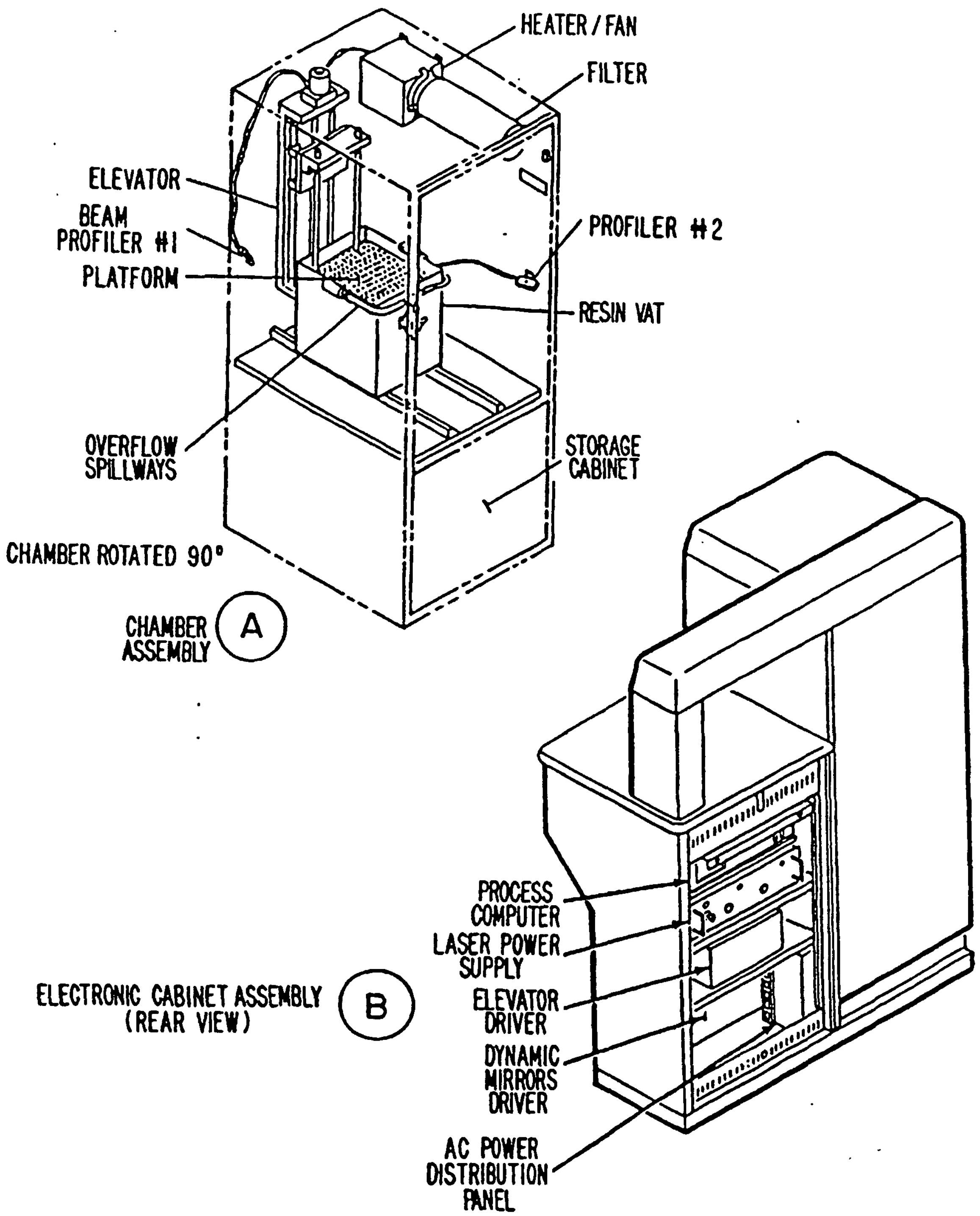


MAJOR COMPONENTS OF THE STEREOLITHOGRAPHY SYSTEM

*FIG. 7.*

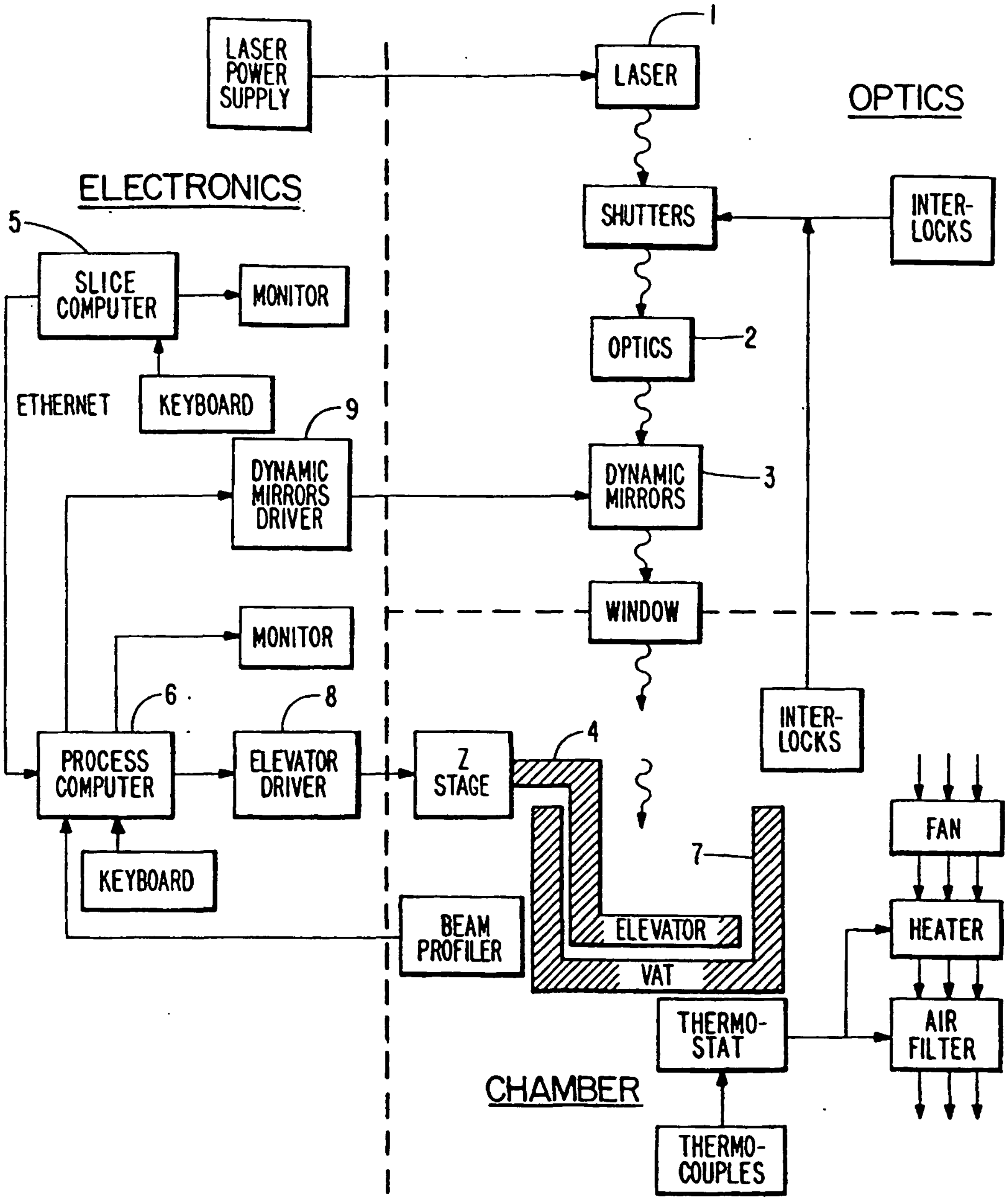


BLOCK DIAGRAM OF THE STEREOLITHOGRAPHY SYSTEM

*FIG. 8.*

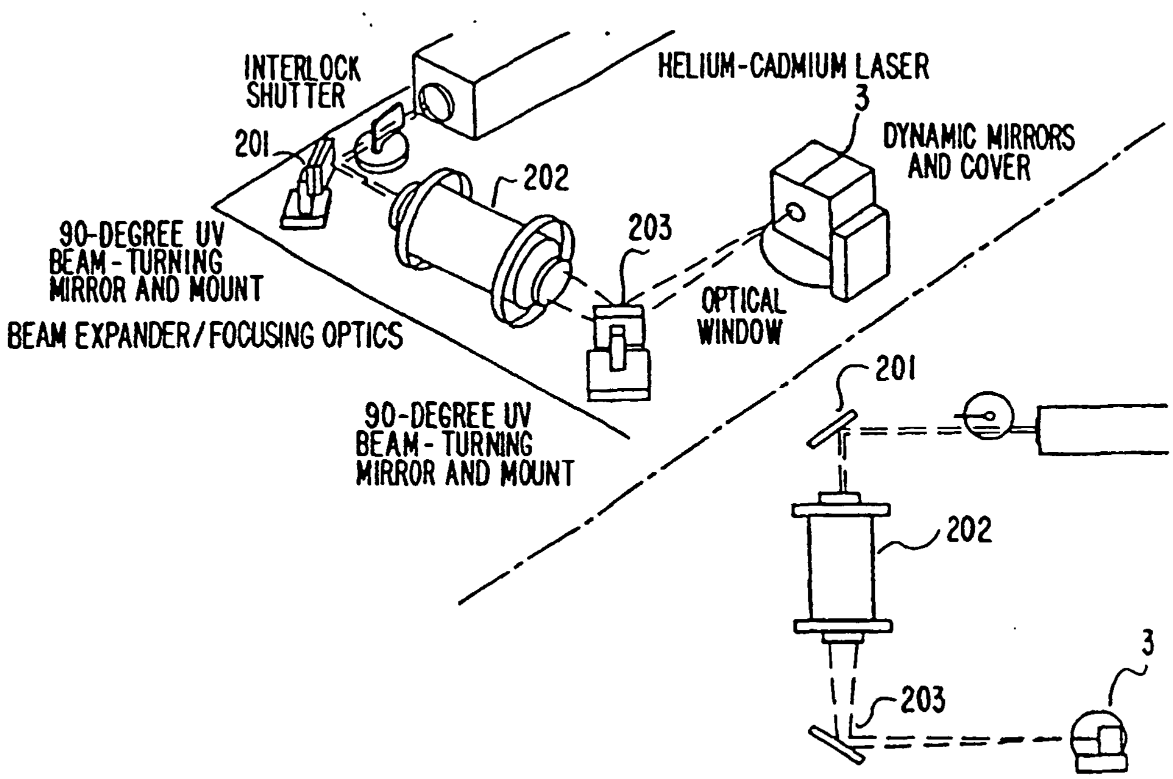


THE SLA-I LASER AND OPTICAL SYSTEM

*FIG. 9.*

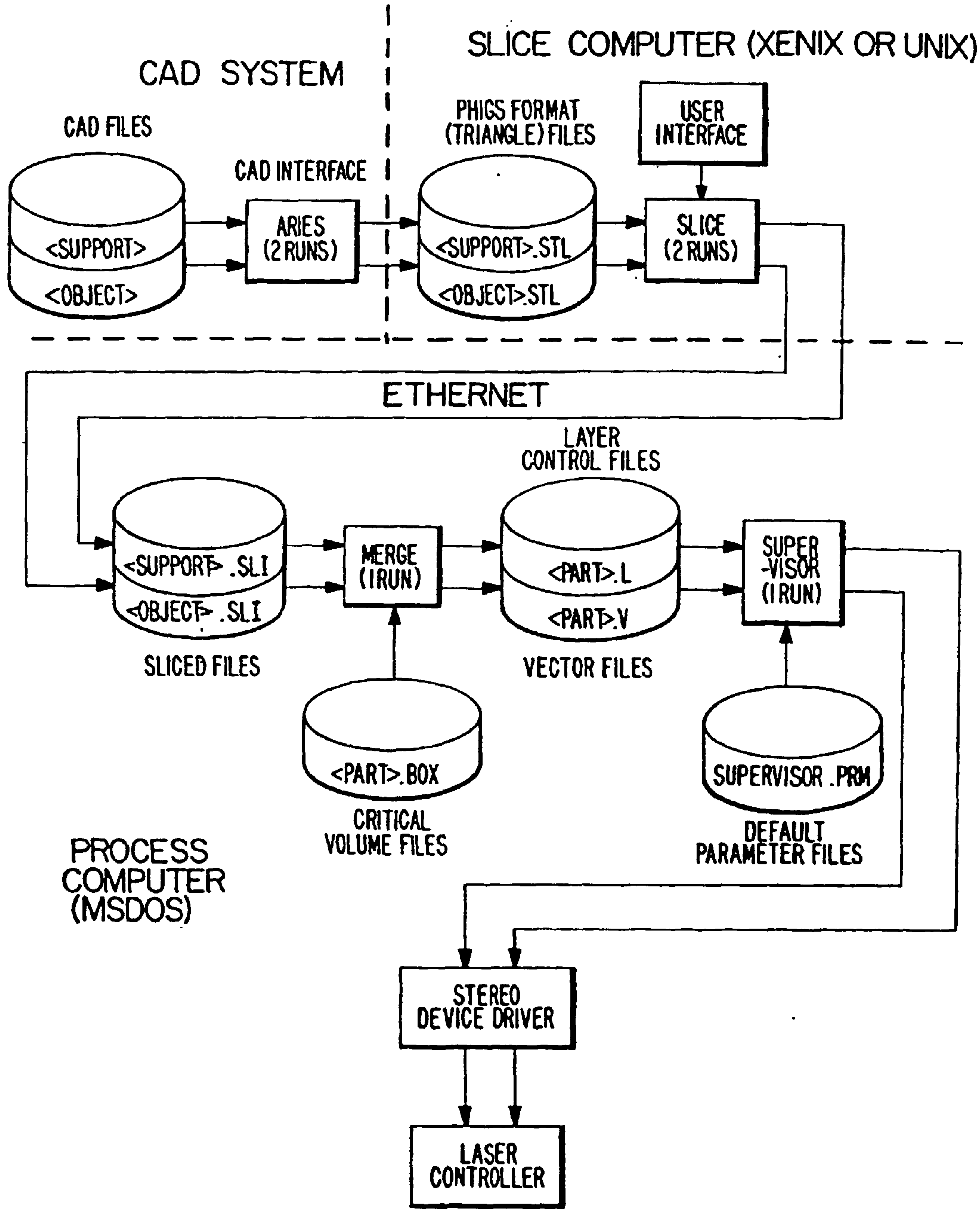


SOFTWARE DIAGRAM OF STEREOLITHOGRAPHY SYSTEM

*FIG. 10.*

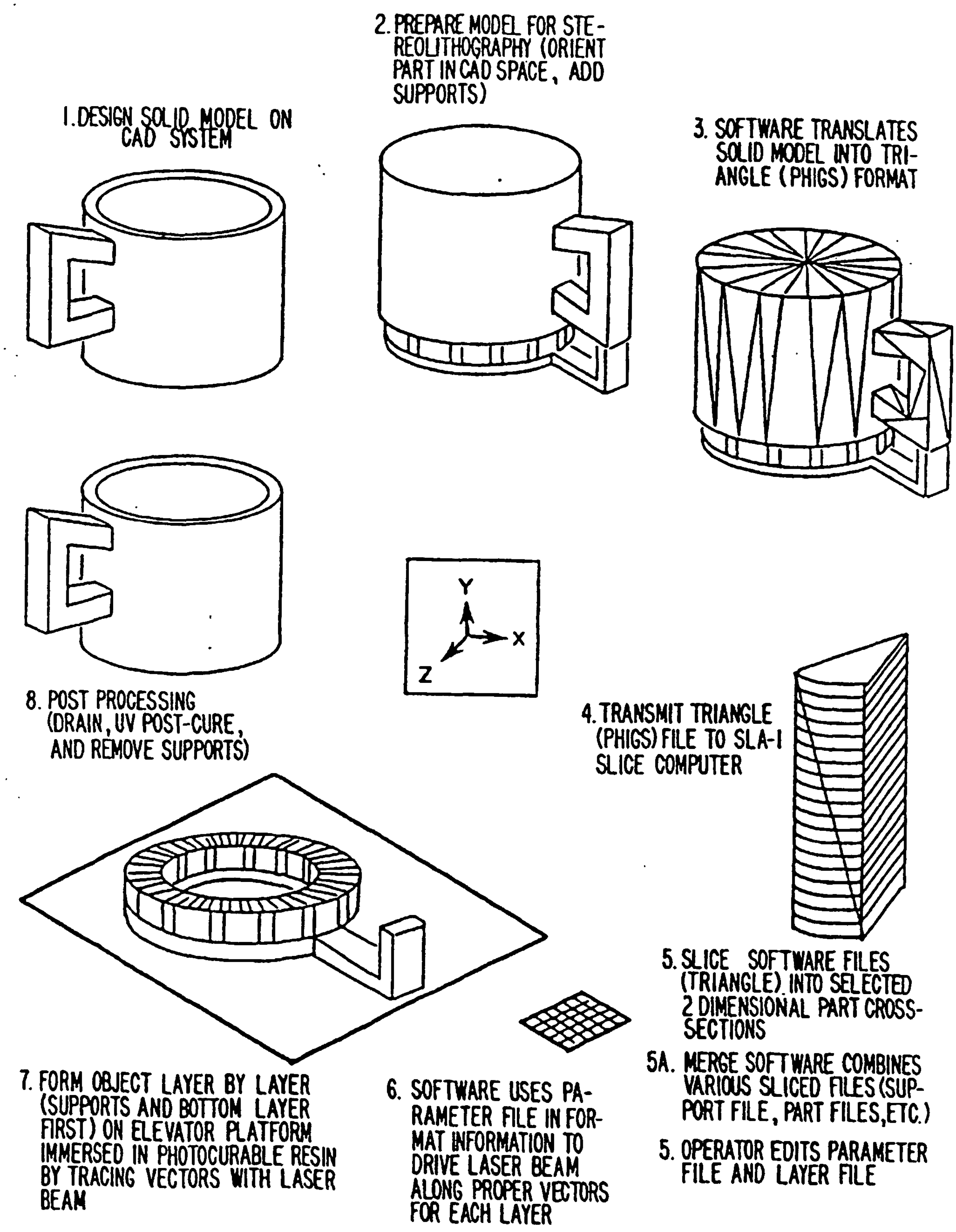
2. PREPARE MODEL FOR STEREOLITHOGRAPHY (ORIENT PART IN CAD SPACE, ADD SUPPORTS)
1. DESIGN SOLID MODEL ON CAD SYSTEM
3. SOFTWARE TRANSLATES SOLID MODEL INTO TRIANGLE (PHIGS) FORMAT
Y
X
Z
8. POST PROCESSING (DRAIN, UV POST-CURE, AND REMOVE SUPPORTS)
4. TRANSMIT TRIANGLE (PHIGS) FILE TO SLA-1 SLICE COMPUTER
5. SLICE SOFTWARE FILES (TRIANGLE) INTO SELECTED 2 DIMENSIONAL PART CROSS-SECTIONS
5A. MERGE SOFTWARE COMBINES VARIOUS SLICED FILES (SUPPORT FILE, PART FILES, ETC.)
7. FORM OBJECT LAYER BY LAYER (SUPPORTS AND BOTTOM LAYER FIRST) ON ELEVATOR PLATFORM IMMERSED IN PHOTOCURABLE RESIN BY TRACING VECTORS WITH LASER BEAM
6. SOFTWARE USES PARAMETER FILE IN FORMAT INFORMATION TO DRIVE LASER BEAM ALONG PROPER VECTORS FOR EACH LAYER
5. OPERATOR EDITS PARAMETER FILE AND LAYER FILE

FIG. 11.

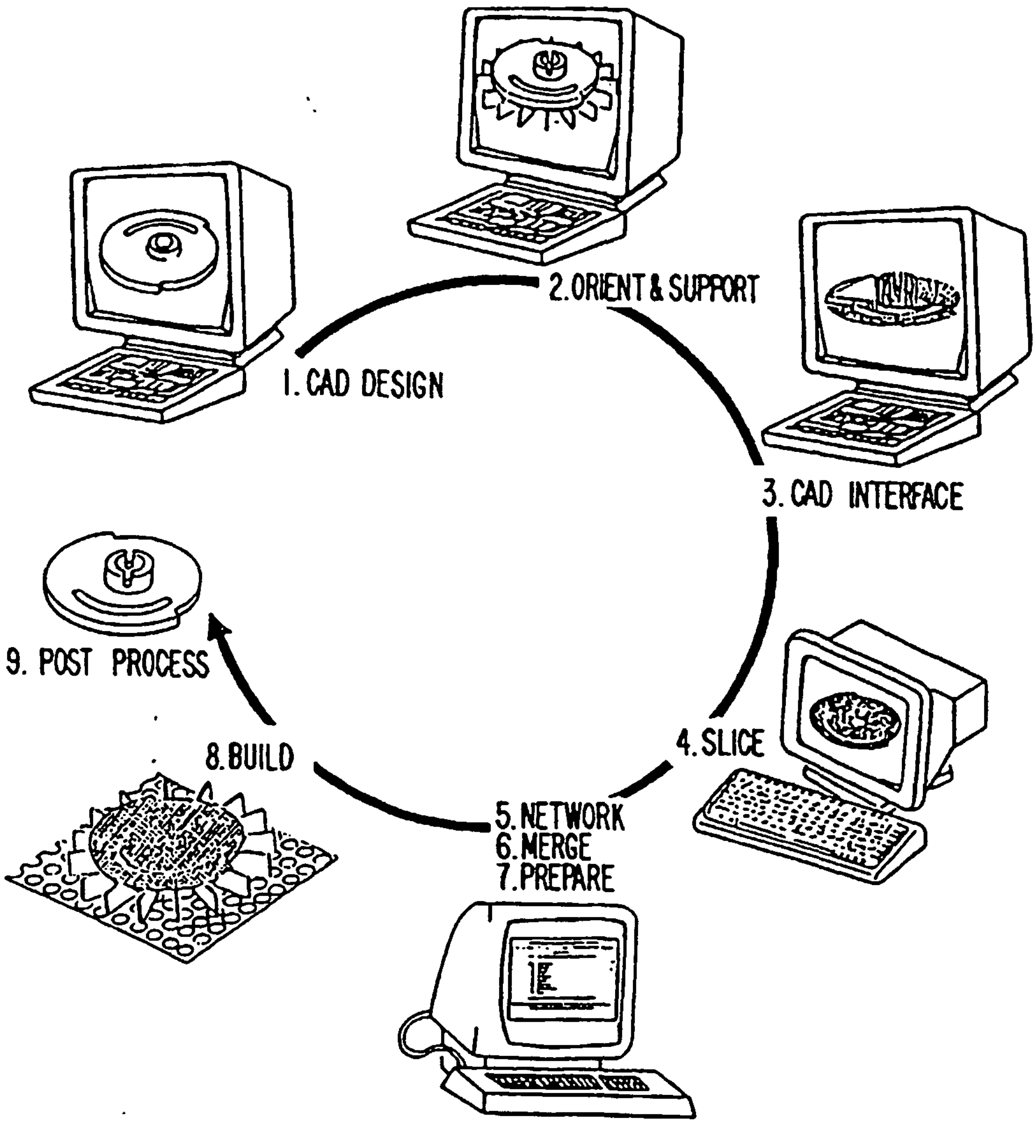
1. CAD DESIGN
2. ORIENT & SUPPORT
3. CAD INTERFACE
4. SLICE
5. NETWORK
6. MERGE
7. PREPARE
8. BUILD
9. POST PROCESS

FIG. 12.

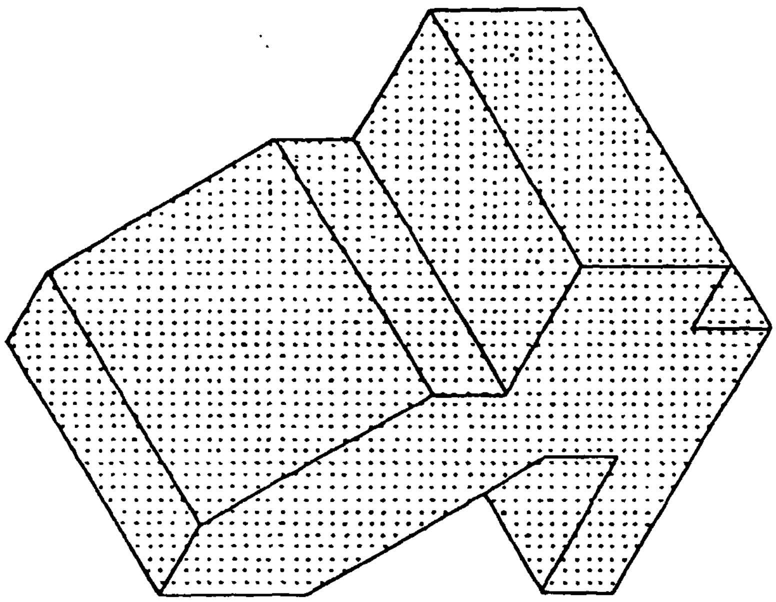

FIG. 14.

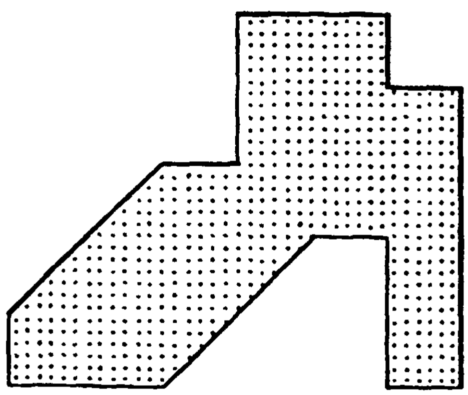

FIG. 13.

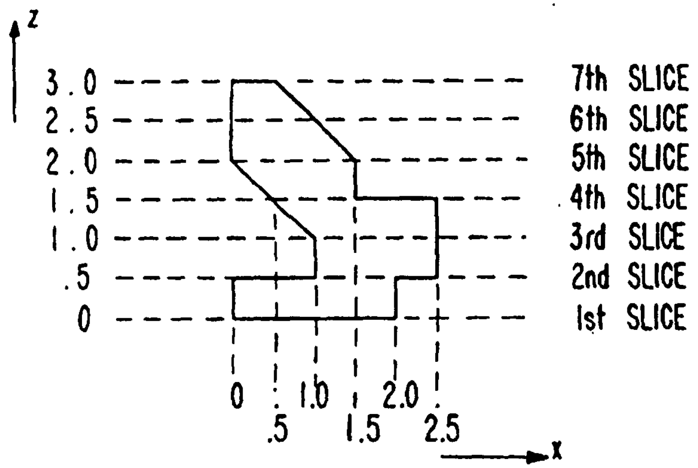


SLICING OF CAD OBJECT
OBJECT AS DESIGNED IN CAD

FIG. 15.

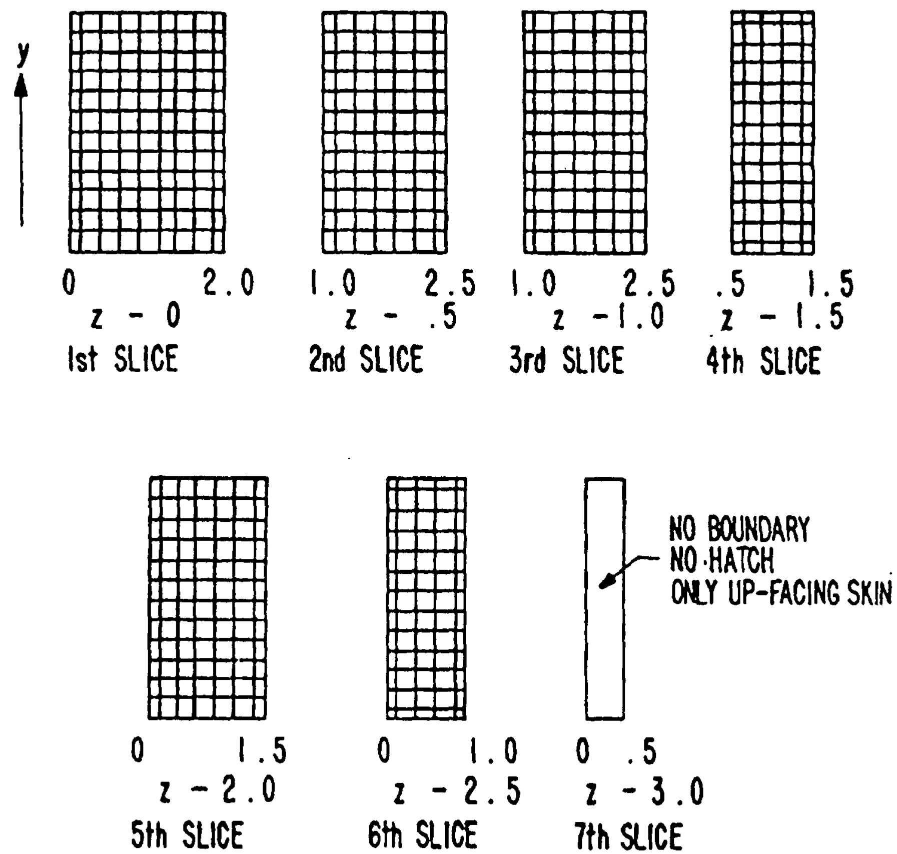


SLICE (LAYER BOUNDARY & HATCH) DATA
FORMING THE OBJECT

TOP VIEW

FIG. 16.

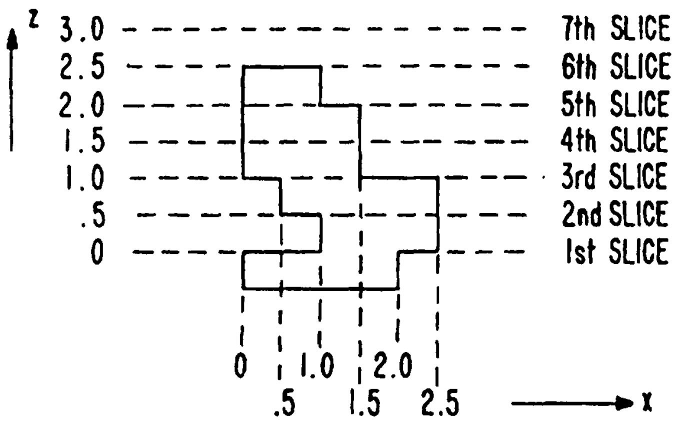


OBJECT AS BUILT USING STYLE I

FIG. 17.

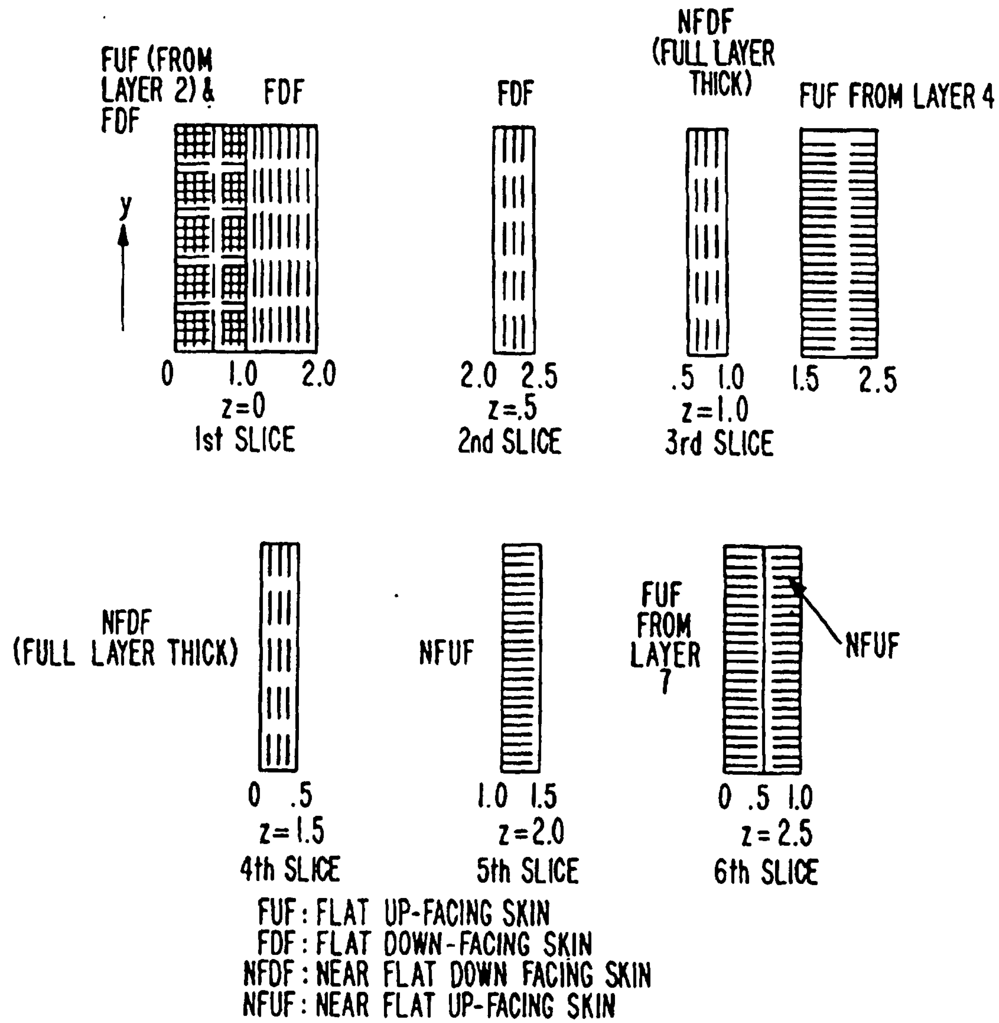


SLICE SKIN DATA SURFACING THE OBJECT STYLE I

FIG. 18.

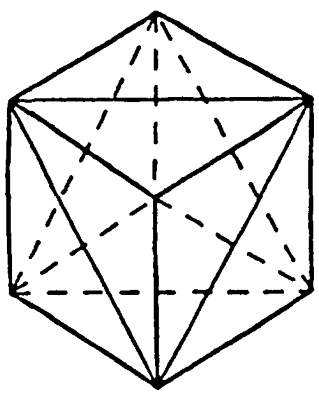

SOLID CUBE
NO. OF FACETS: 12

FIG. 19a.

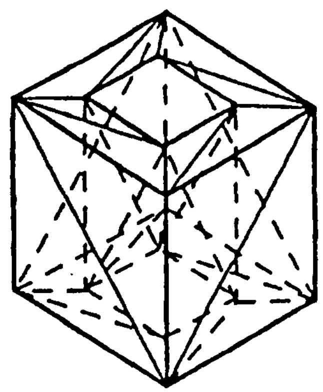

HOLLOW CUBE
NO. OF FACETS: 32

FIG. 19b.

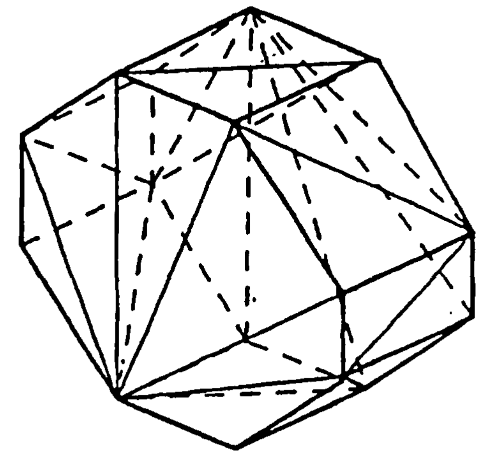

SOLID OCTAGON CYLINDER
NO. OF FACETS: 28

FIG. 19c.

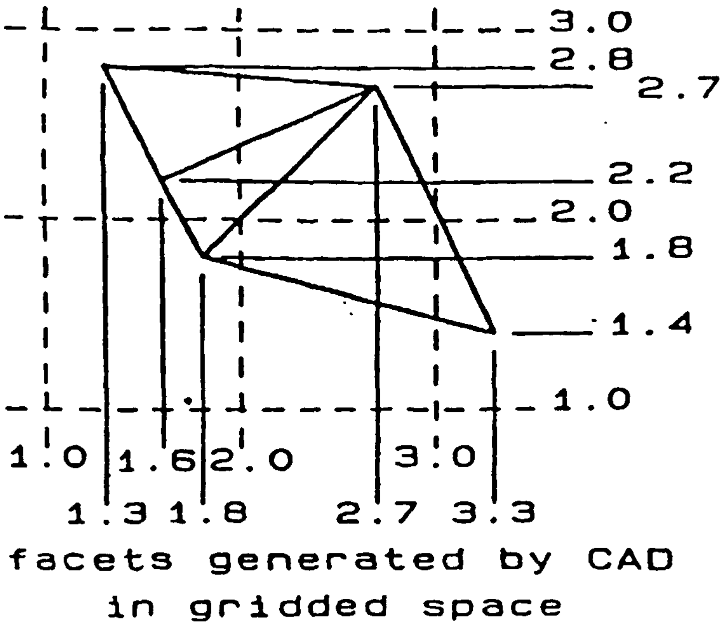


FIG. 20a.

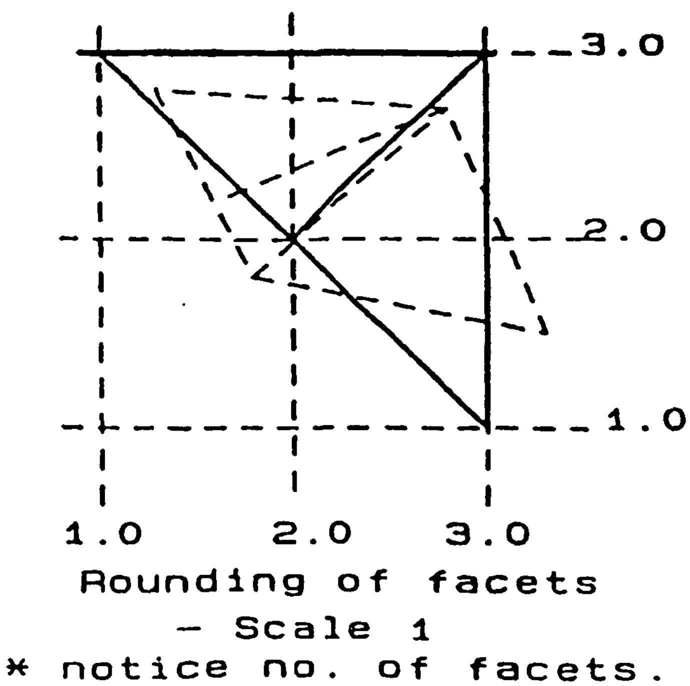


FIG. 20b.

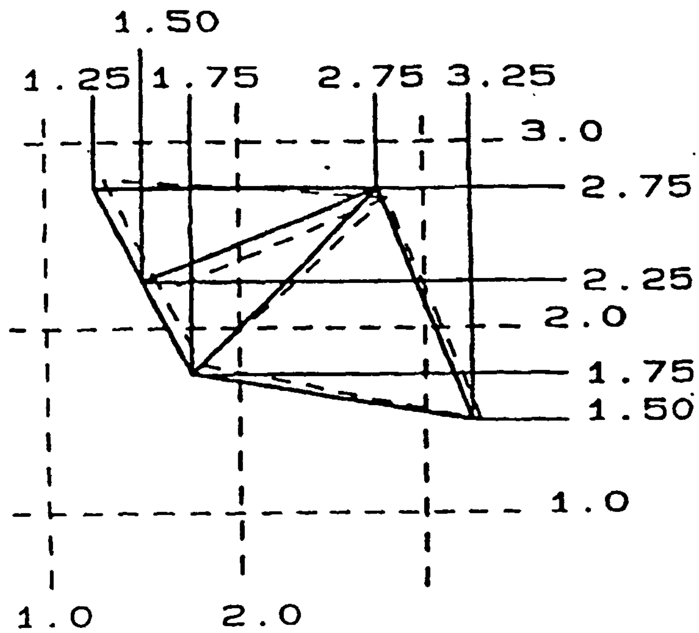


Rounding of facets
- Scale 4

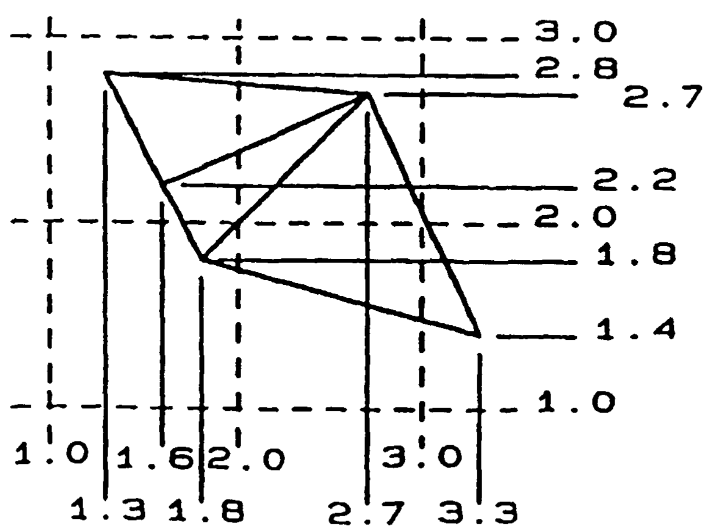


Rounding of facets
- Scale 10

*FIG. 20b.*
*continued*

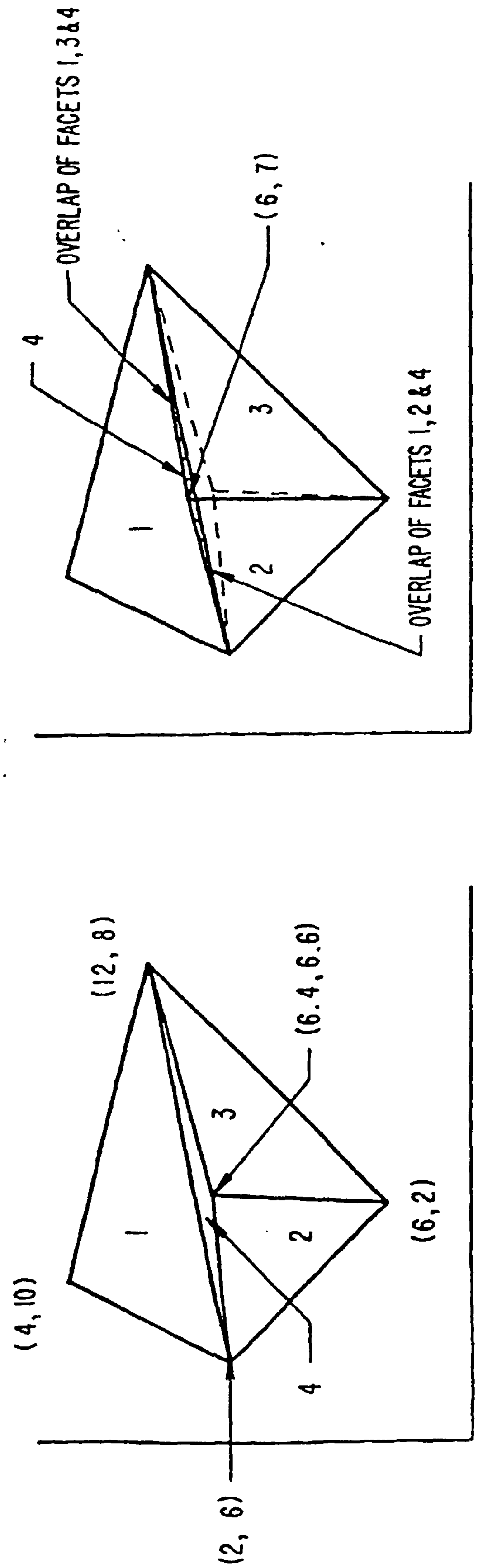


FACET CONFIGURATION THAT CAN LEAD TO OVERLAPPING OF FACETS

FIG. 20C.

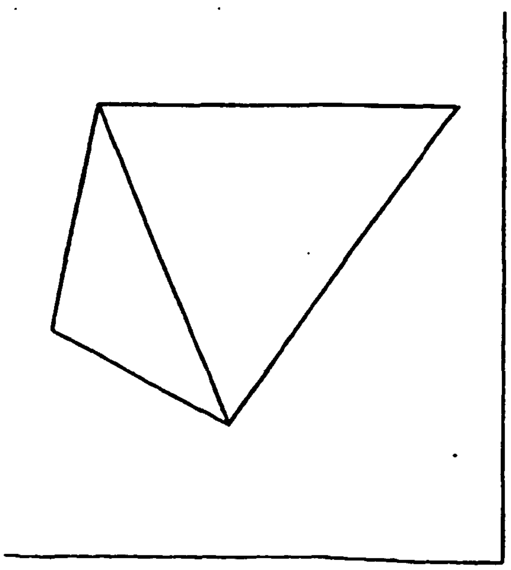

CAD GENERATED FACETS AFTER ROUNDING OF FACETS BASED ON SCALE FACTOR

FIG. 21a.

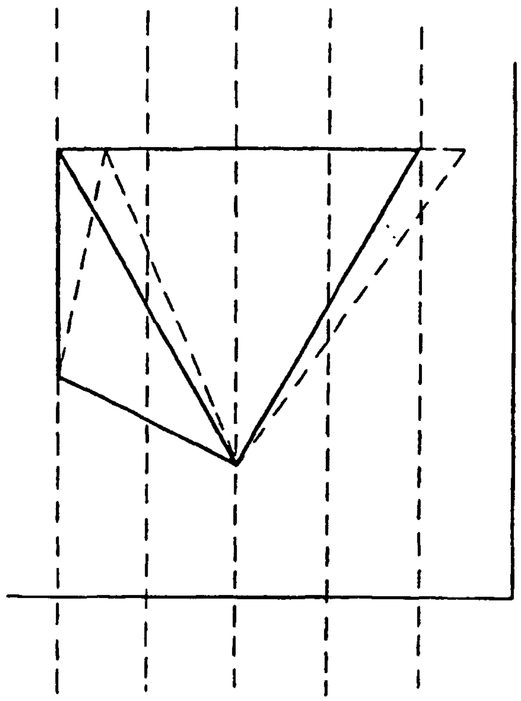

SAME FACETS AFTER ROUNDING OF FACETS IN THE VERTICAL TO SLICING LAYERS—20 MIL LAYER THICK

FIG. 21b.

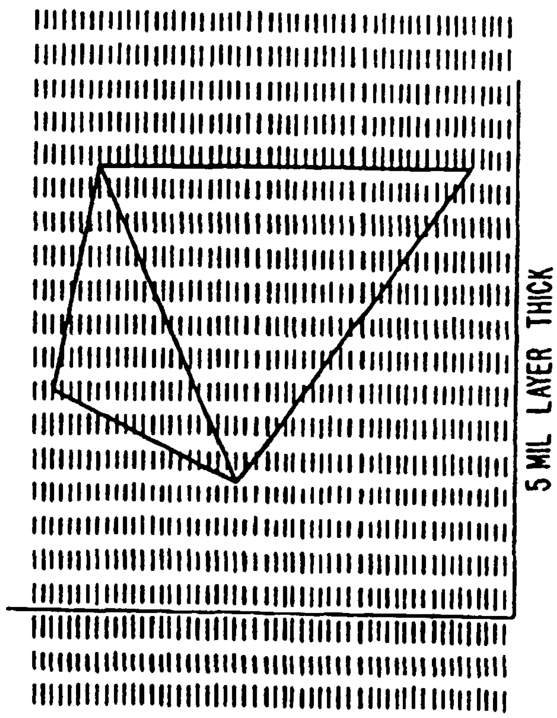


FIG. 21c.

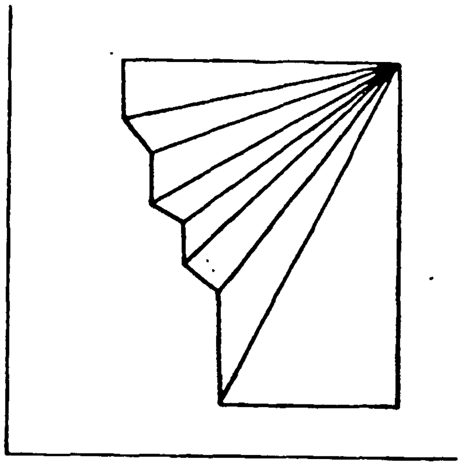

FACETED CAD DESIGN OBJECT

FIG. 22a.

SAME OBJECT SLICED AT
20 mil THICK LAYERS

FIG. 22b.

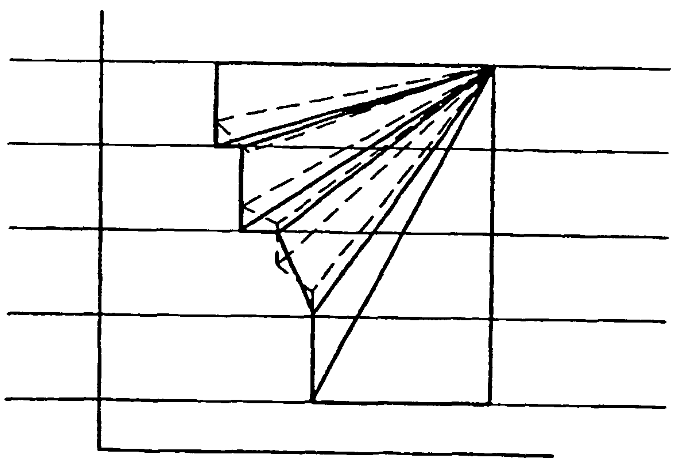

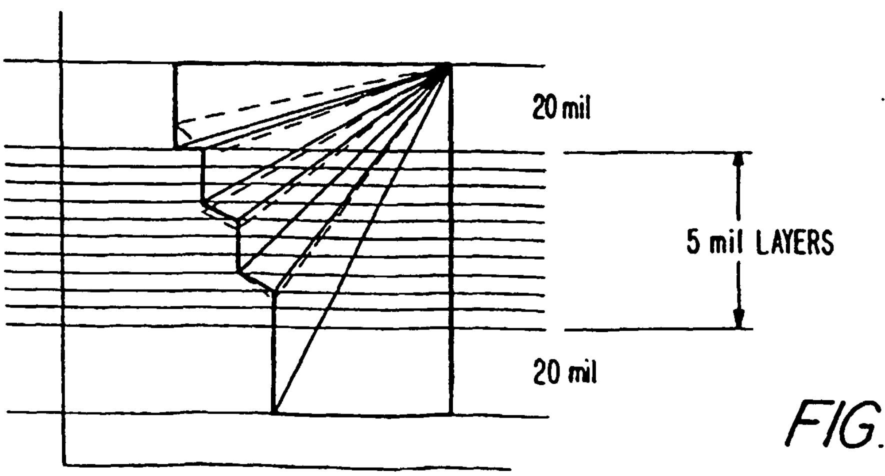


FIG. 22c.

VARIABLE LAYER THICKNESS OF 5 mil AND 20 mil

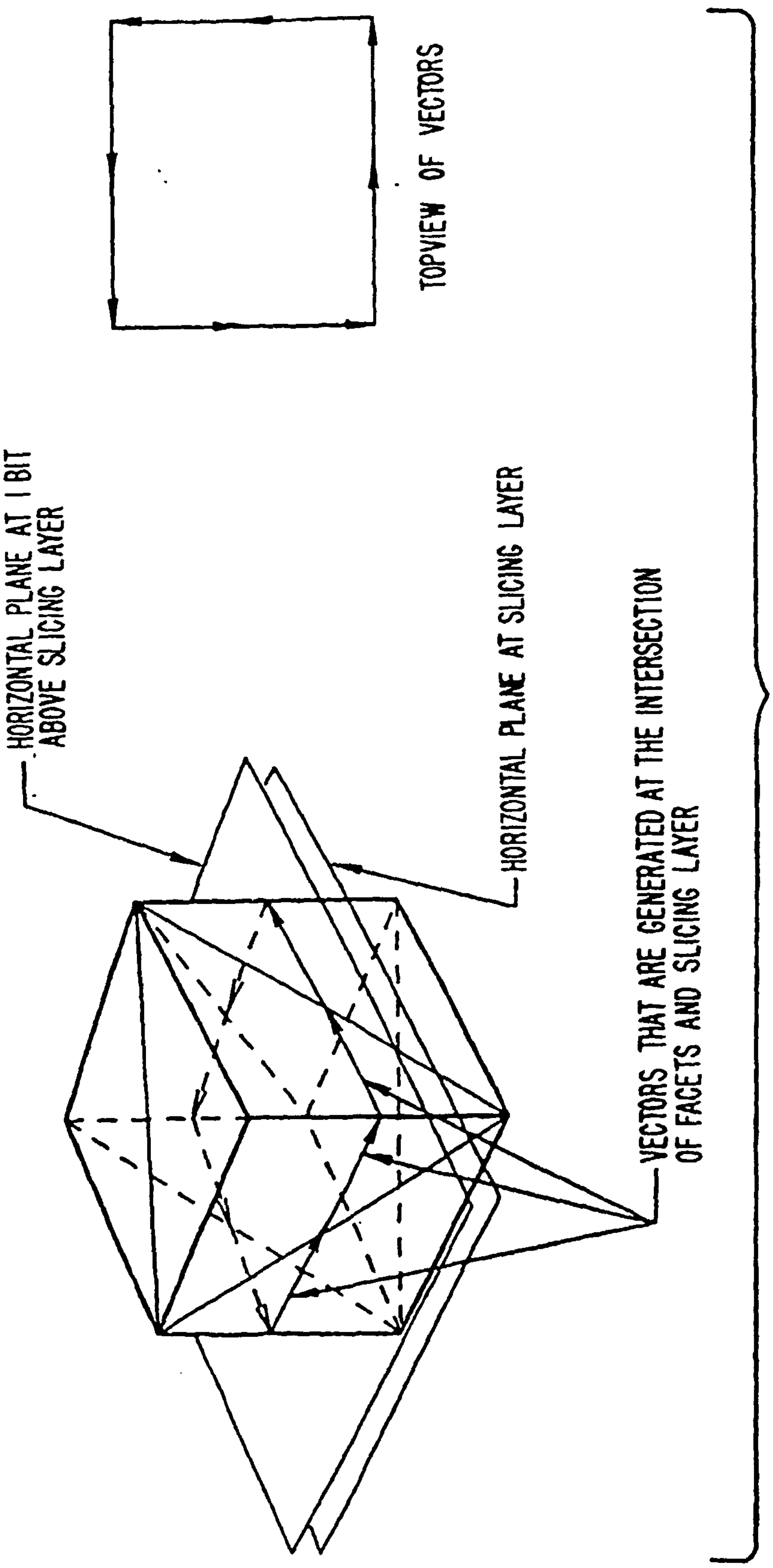
TOPVIEW OF VECTORS
HORIZONTAL PLANE AT I BIT ABOVE SLICING LAYER
HORIZONTAL PLANE AT SLICING LAYER
VECTORS THAT ARE GENERATED AT THE INTERSECTION OF FACETS AND SLICING LAYER

FIG. 23a.

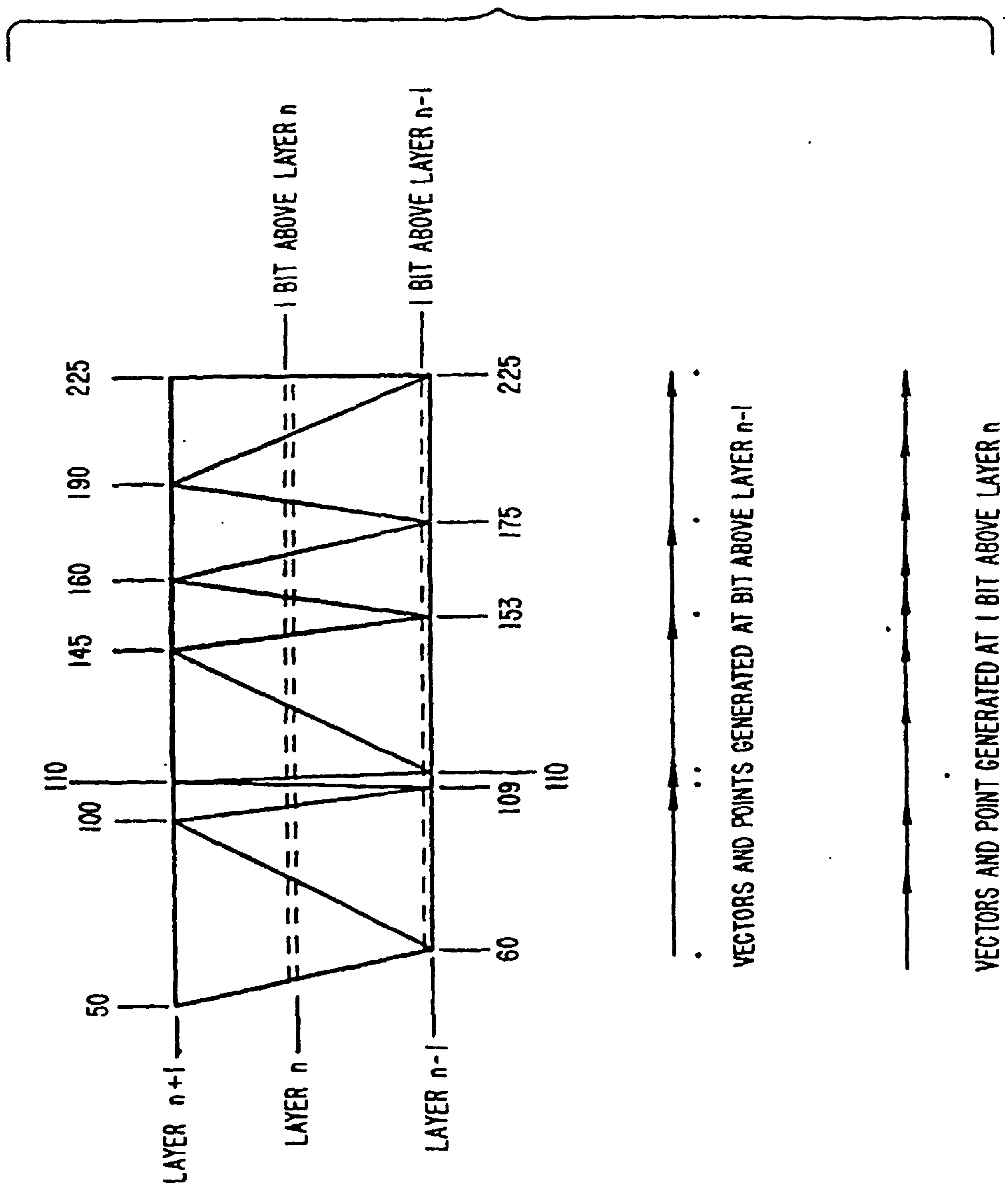
LAYER n+1
LAYER n
LAYER n-1
50
100
110
145
160
190
225
60
109
110
153
175
225
1 BIT ABOVE LAYER n
1 BIT ABOVE LAYER n-1
VECTORS AND POINTS GENERATED AT BIT ABOVE LAYER n-1
VECTORS AND POINT GENERATED AT 1 BIT ABOVE LAYER n

FIG. 23b.

FIG. 23c.

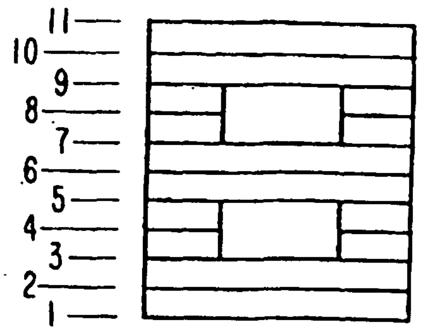


VIEW OF A CAD DESIGNED OBJECT WITH INTERNAL FEATURES (WINDOWS) AFTER ROUNDING HAS OCCURRED

FIG. 23d.

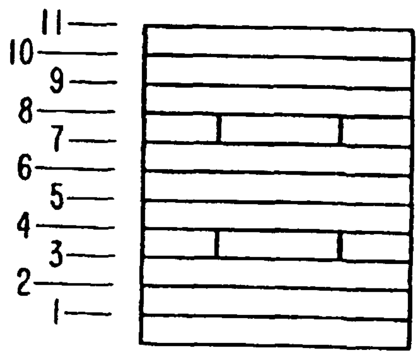


VIEW OF THE SAME OBJECT AFTER BEING BUILT FROM OBTAINING BOUNDARY VECTORS AT THE SLICING LAYER

FIG. 23e.

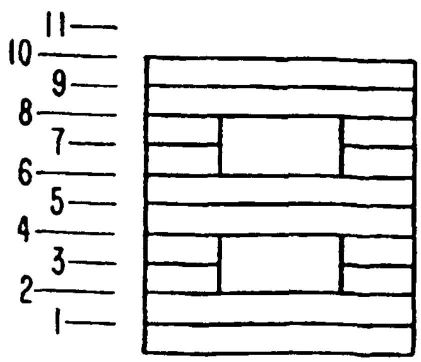


VIEW OF THE SAME OBJECT AFTER BEING BUILT FROM OBTAING BOUNDARY VECTORS AT 1 BIT ABOVE THE SLICING LAYER

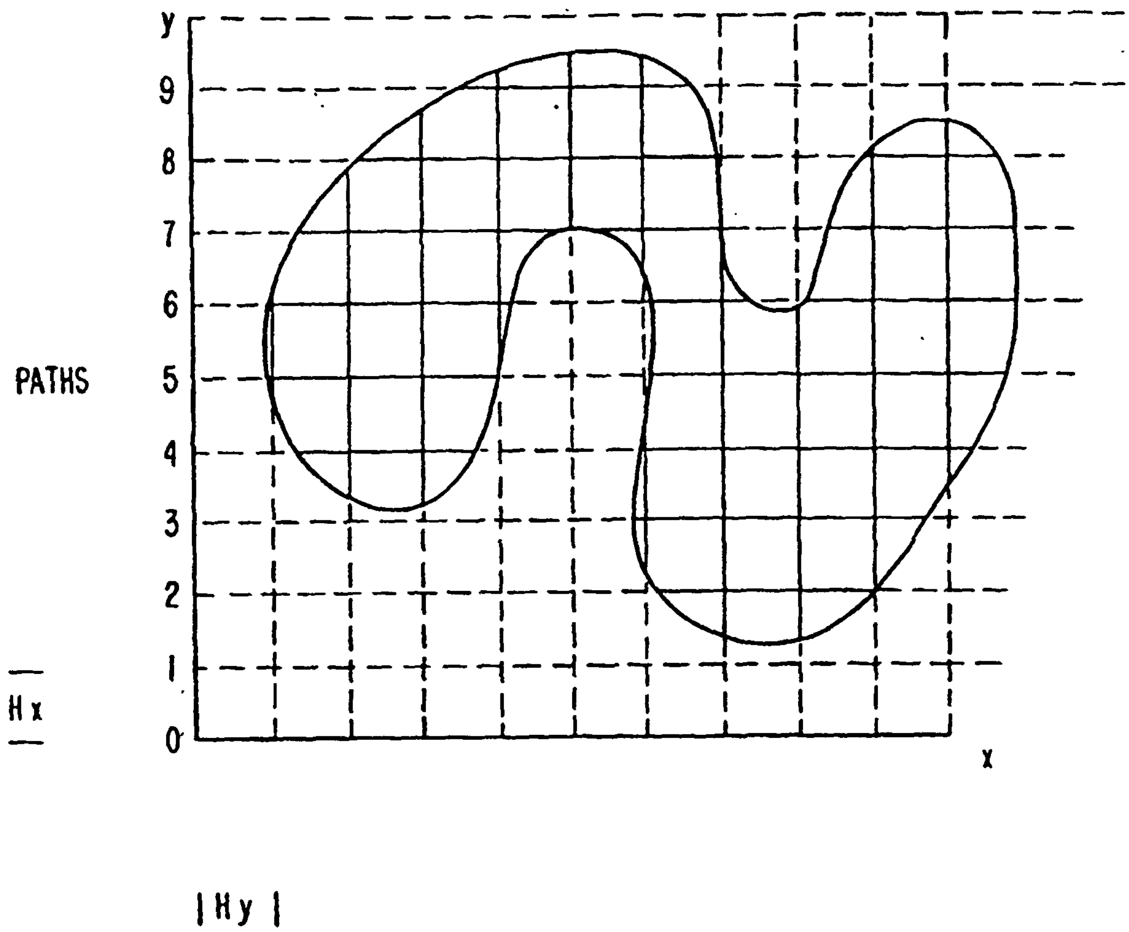


HATCH PATHS ARE ORIENTED IN SCALED CAD SPACE REGARDLESS OF PART ORIENTATION. THE PART ORIENTATION ONLY TRIGGERS THE NEED TO MAKE A DECISION AS TO WHETHER TO TURN HATCH ON OR OFF.

FIG. 24.

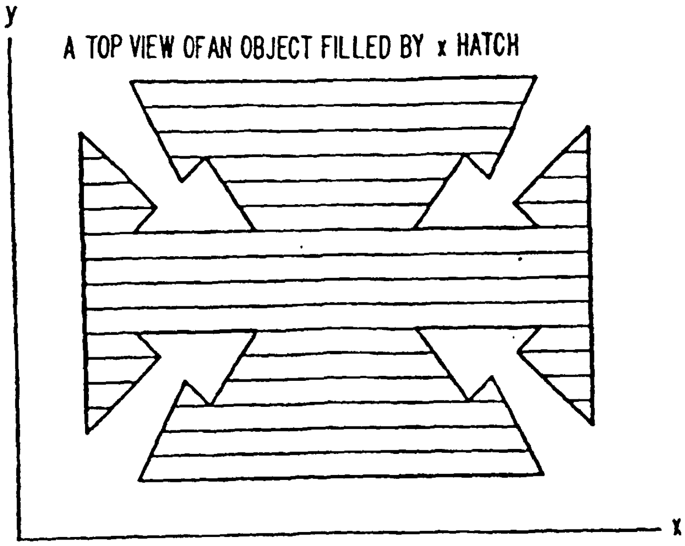


FIG. 24a.

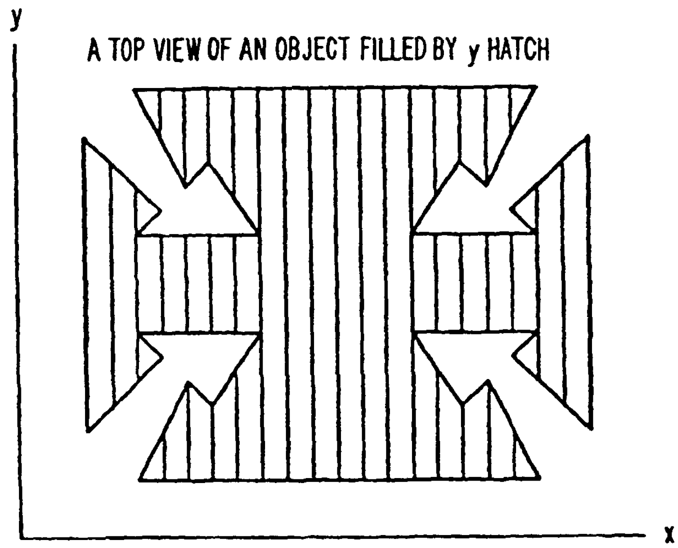


FIG. 24b.

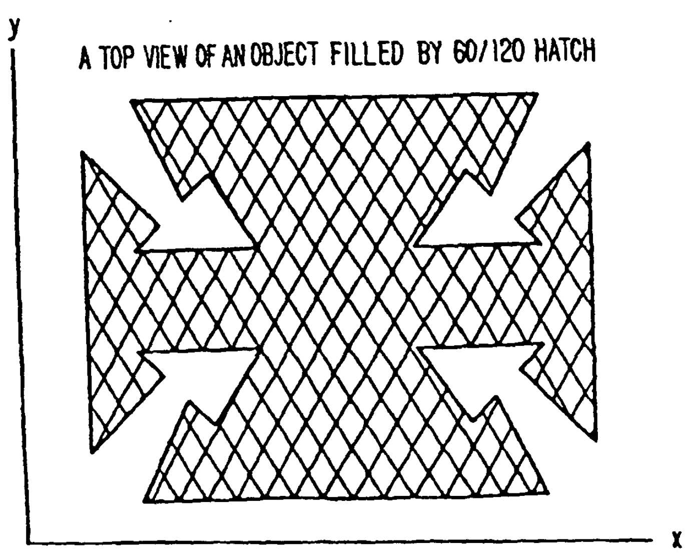


FIG. 24c.

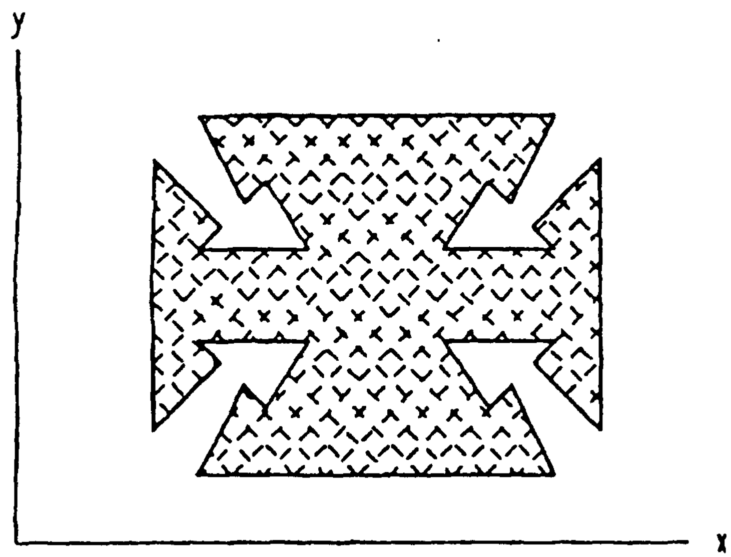


A TOP VIEW OF A LAYER OF AN OBJECT COMPLETELY FILLED IN ITS SOLID REGIONS

FIG. 24d.

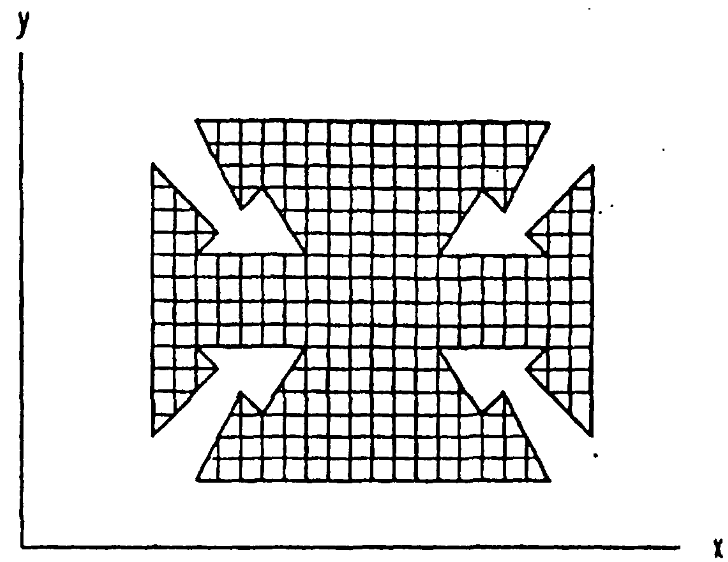


A TOP VIEW OF A LAYER OF AN OBJECT PROPERLY FILLED IN BY CROSSHATCH (x & y)

FIG. 24e.

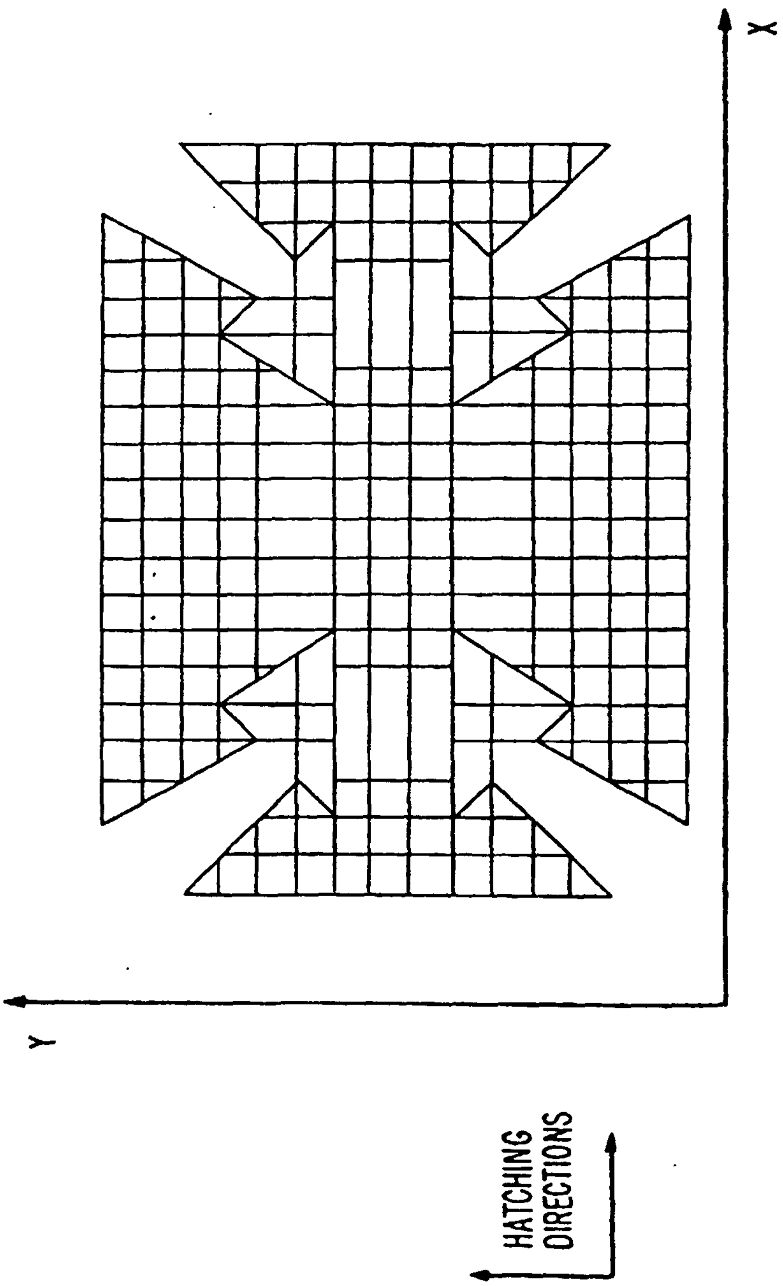


TOP VIEW OF LAYER BOUNDARY ALONG WITH HATCH VECTORS GENERATED BY THE FIRST ALGORITM (X AND Y)

FIG. 24f.

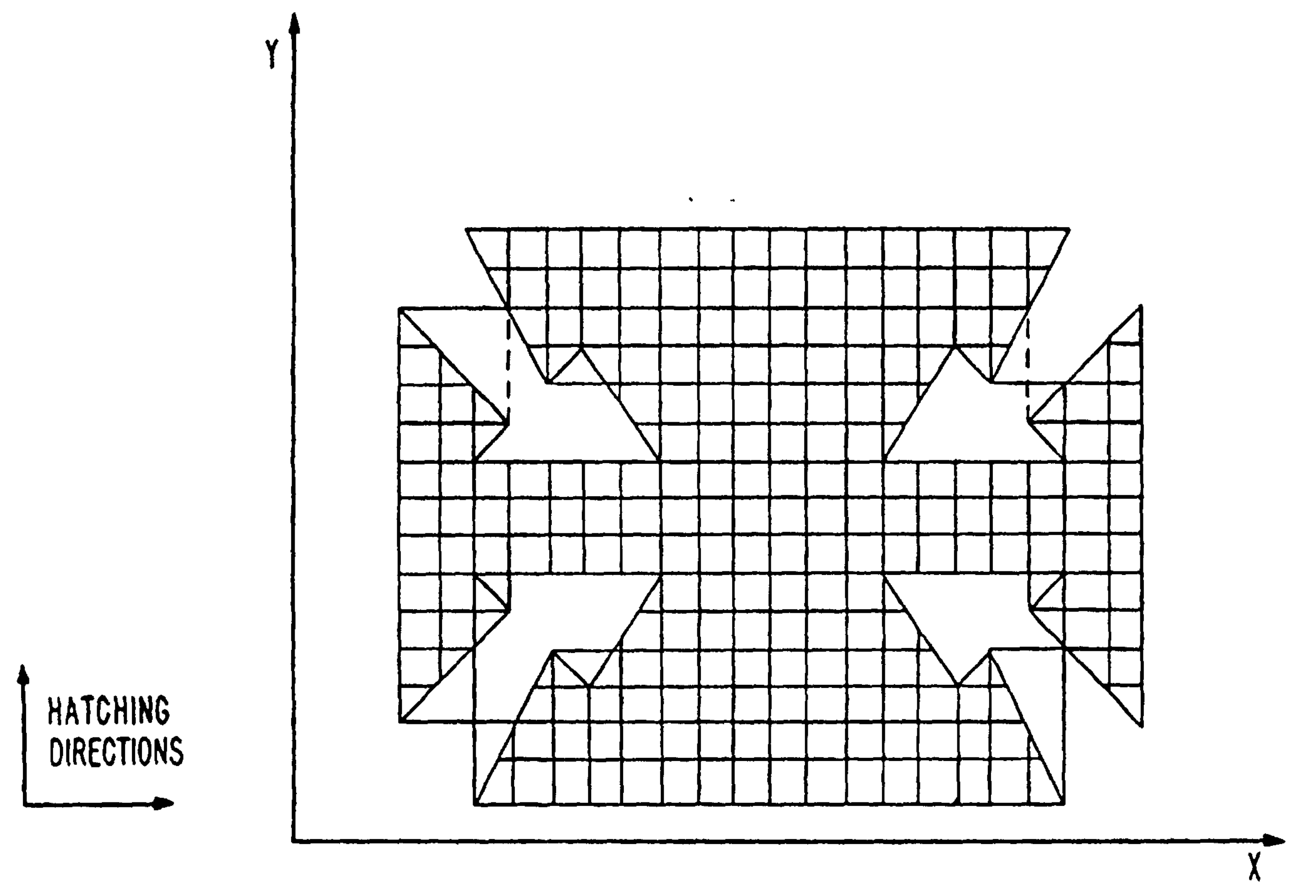


TOP VIEW OF LAYER BOUNDARY ALONG WITH HATCH VECTORS GENERATED BY THE SECOND ALGORITHM (X AND Y)

FIG. 24g.

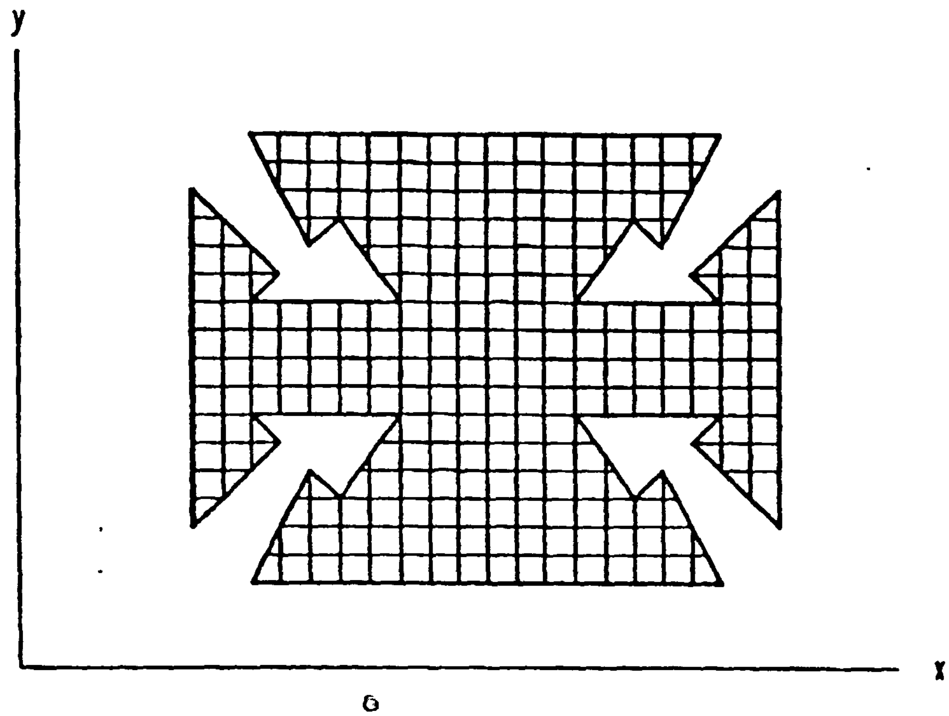


A TOP VIEW OF A LAYER OF BOUNDARY VECTORS ALONG WITH HATCH VECTORS GENERATED BY THE PROPOSED ALGORITHM (x AND x)

FIG. 24h.

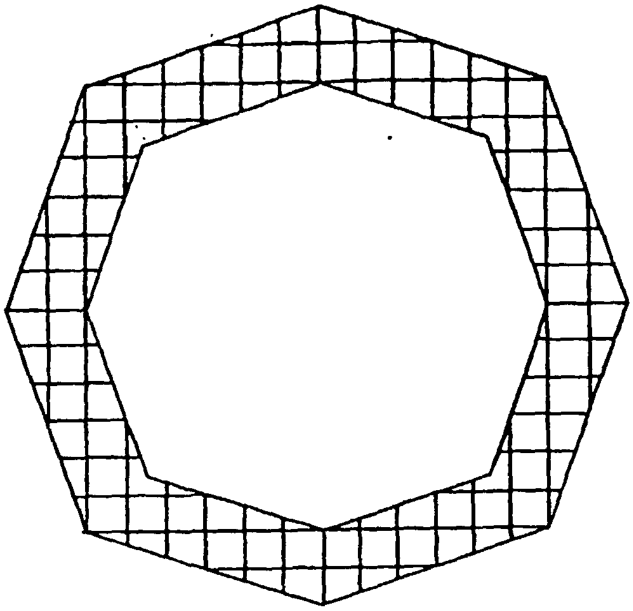

FIG. 24i.

X AND Y CROSSHATCH USING MIA=0

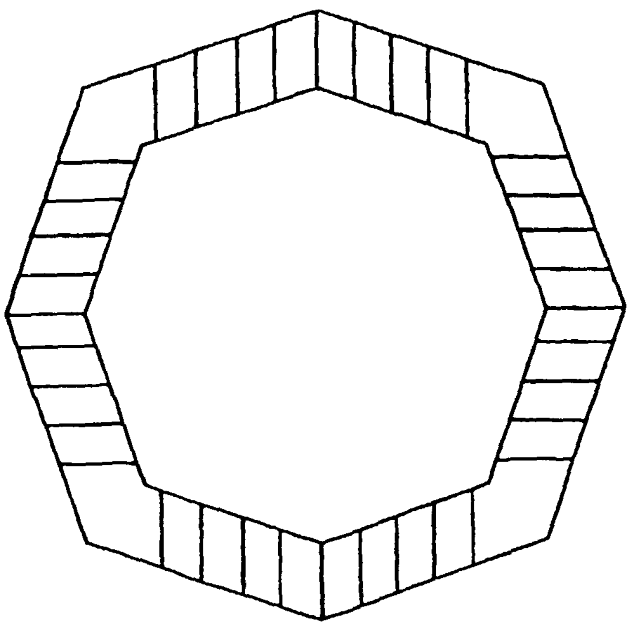

FIG. 24j.

X AND Y CROSSHATCH USING MIA=45°

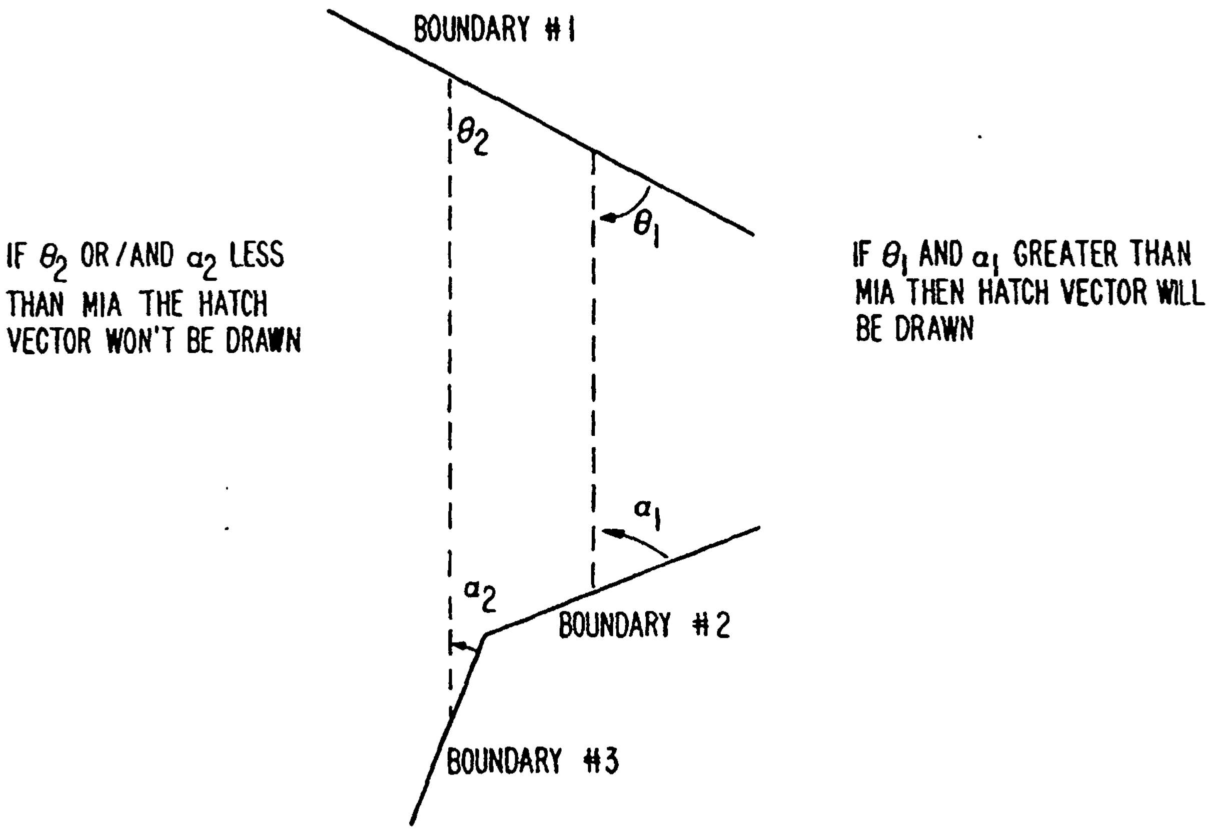
BOUNDARY #1
θ2
θ1
IF θ2 OR/AND α2 LESS THAN MIA THE HATCH VECTOR WON'T BE DRAWN
IF θ1 AND α1 GREATER THAN MIA THEN HATCH VECTOR WILL BE DRAWN
α1
α2
BOUNDARY #2
BOUNDARY #3

FIG. 24k.

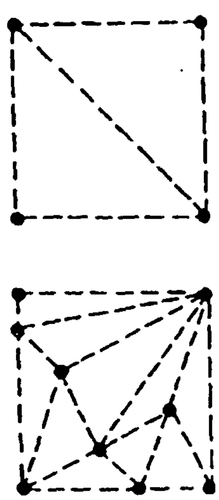

FIG. 25a.

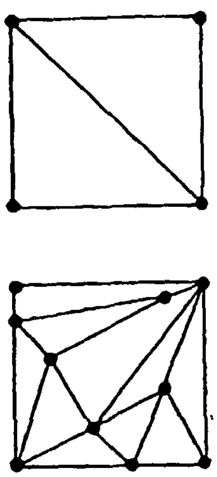

FIG. 25b.

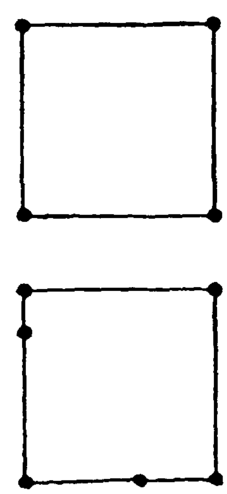

FIG. 25c.

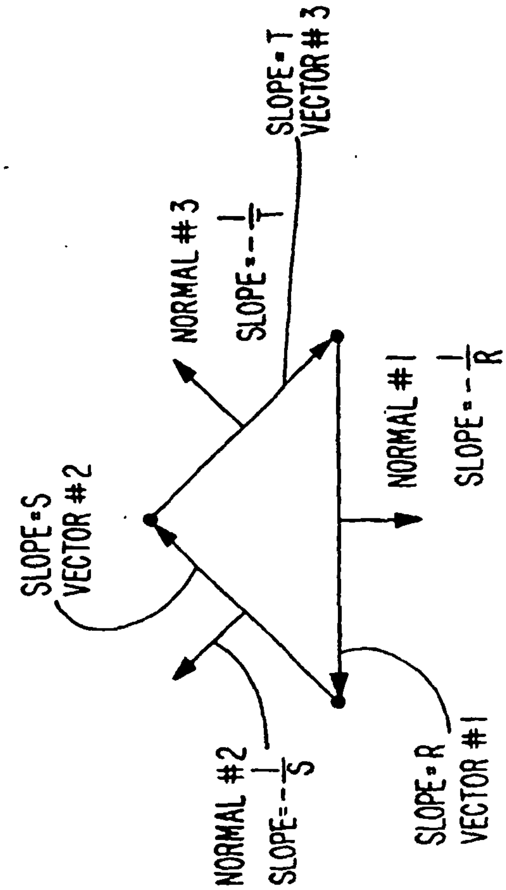


FIG. 25d.

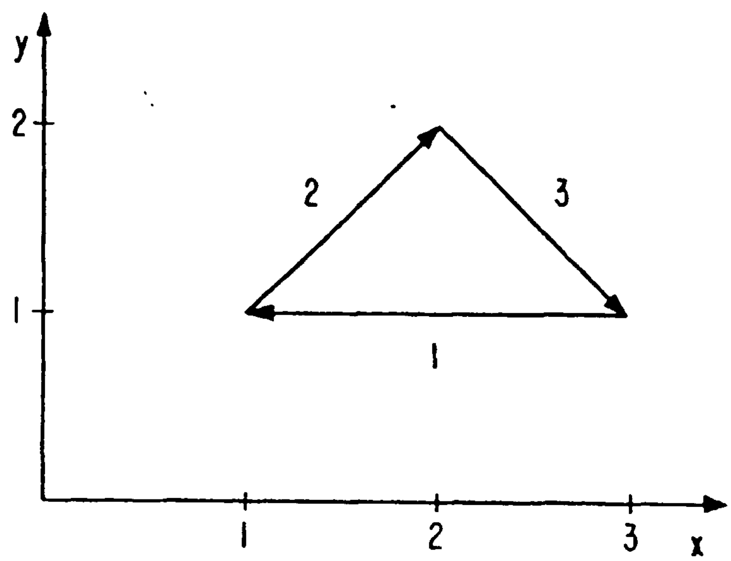


VECTOR LIST

| # | START | END | NORMAL +x −x +y −y |
|---|---|---|---|
| 1 | (3,1) | (1,1) | 0 0 , 0 1 |
| 2 | (1,1) | (2,2) | 0 1 , 1 0 |
| 3 | (2,2) | (3,1) | 1 0 , 1 0 |

*FIG. 25e.*

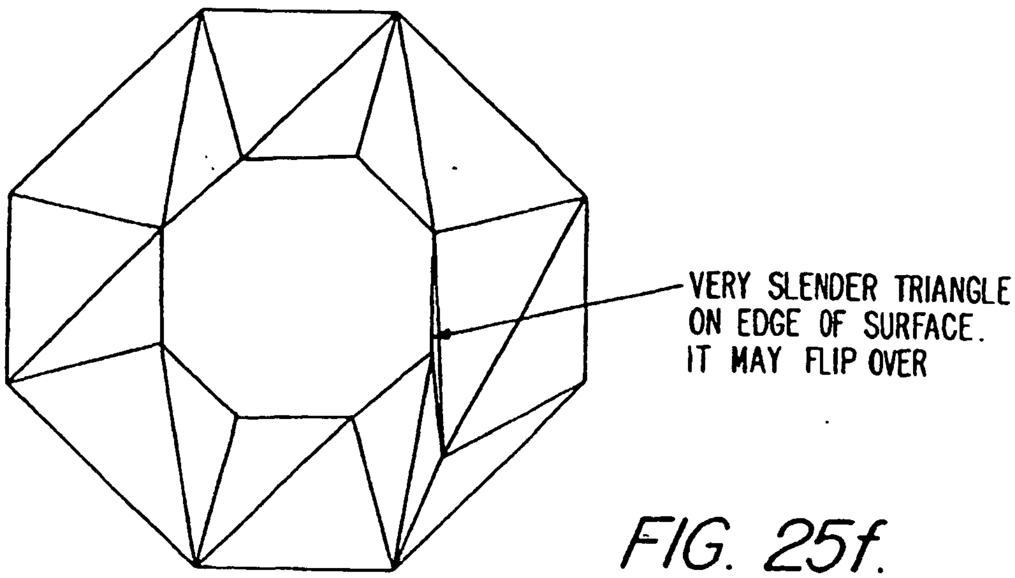


FIG. 25f.

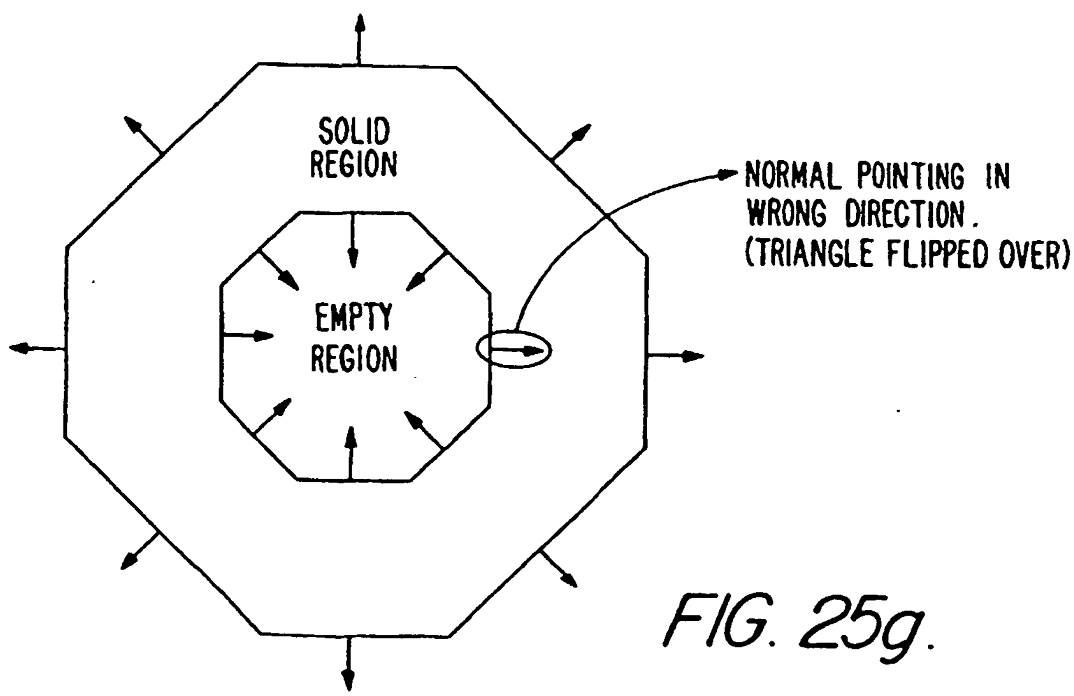


FIG. 25g.

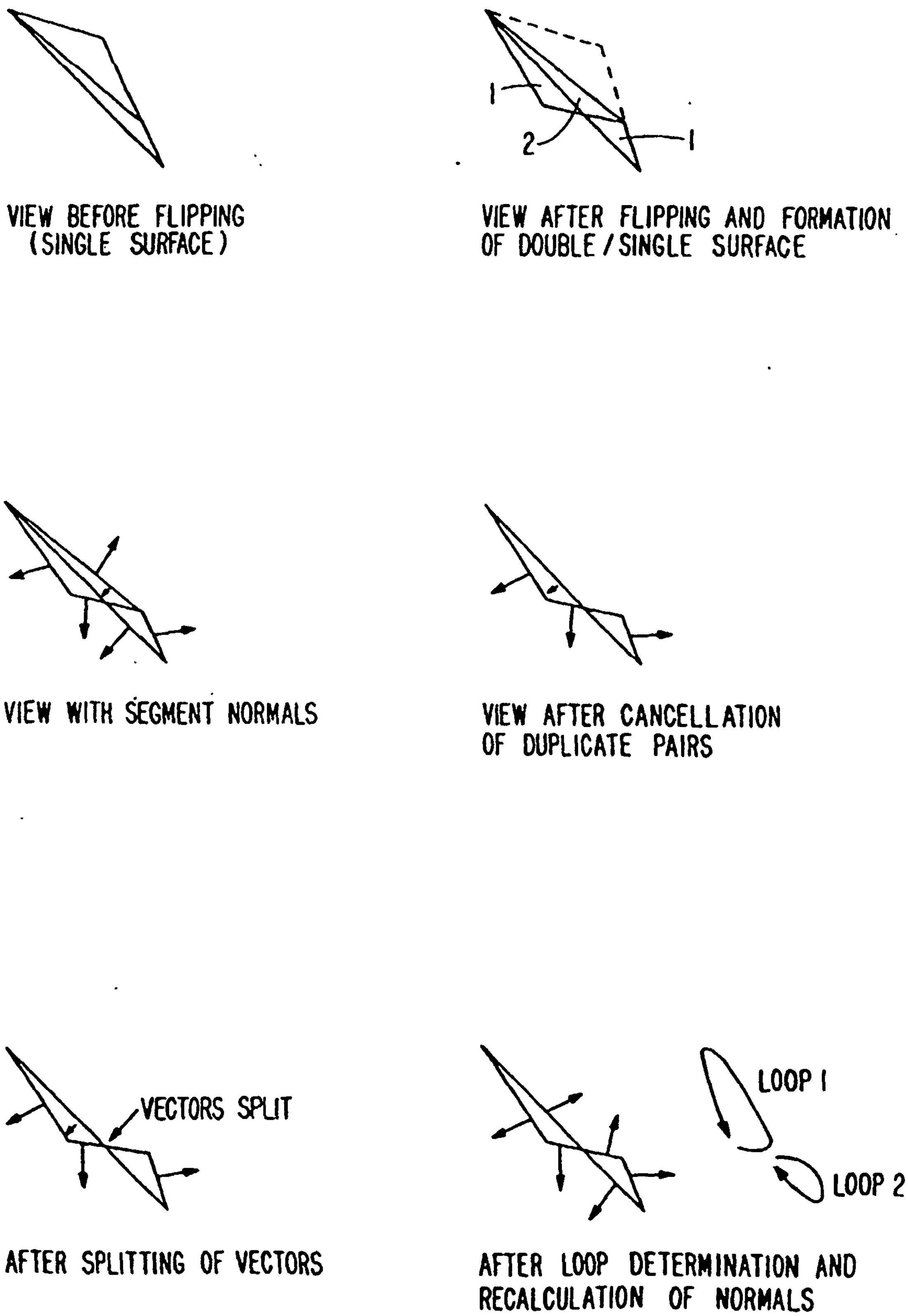
1
2
1
VIEW BEFORE FLIPPING (SINGLE SURFACE)
VIEW AFTER FLIPPING AND FORMATION OF DOUBLE / SINGLE SURFACE
VIEW WITH SEGMENT NORMALS
VIEW AFTER CANCELLATION OF DUPLICATE PAIRS
VECTORS SPLIT
LOOP 1
LOOP 2
AFTER SPLITTING OF VECTORS
AFTER LOOP DETERMINATION AND RECALCULATION OF NORMALS

FIG. 25h.

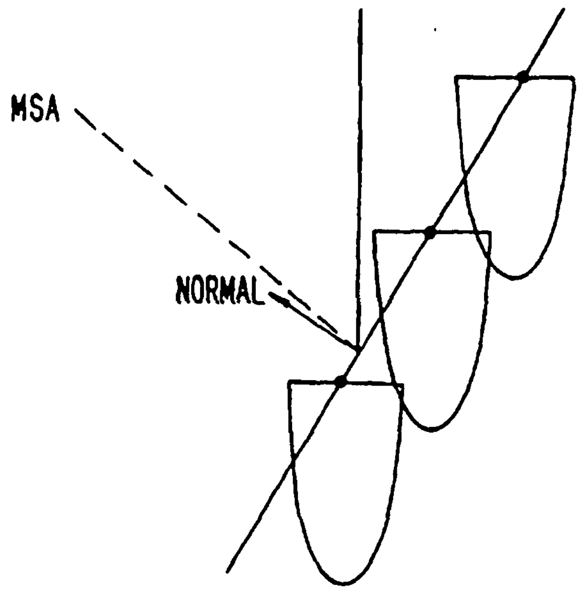


SIDE VIEW OF BOUNDARY VECTORS OVERLAPPING INDICATING THAT NEAR FLAT SKIN IS NOT NECESSARY
α <MSA

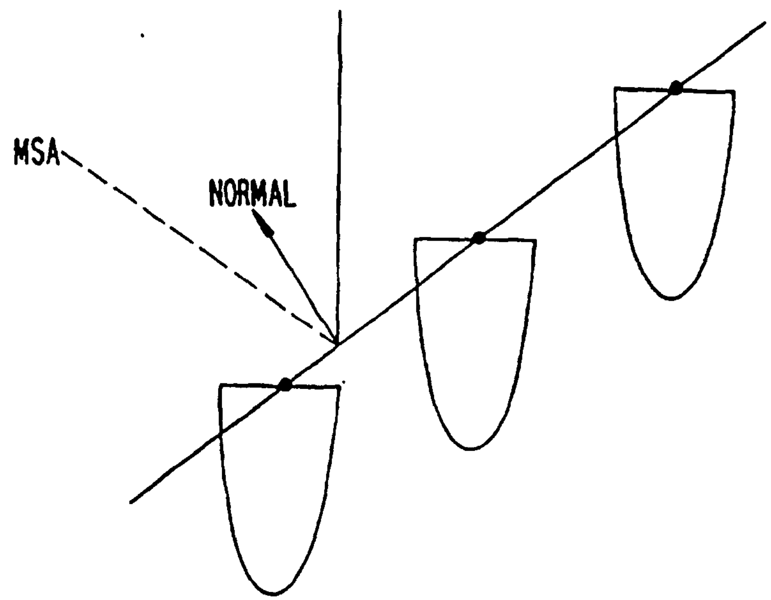


SIDE VIEW OF BOUNDARY VECTORS SHOWING GAPS BETWEEN THEM INDICATING THE NEED FOR NEAR FLAT SKIN

FIG. 26a.

METHOD TO CALCULATE MSA

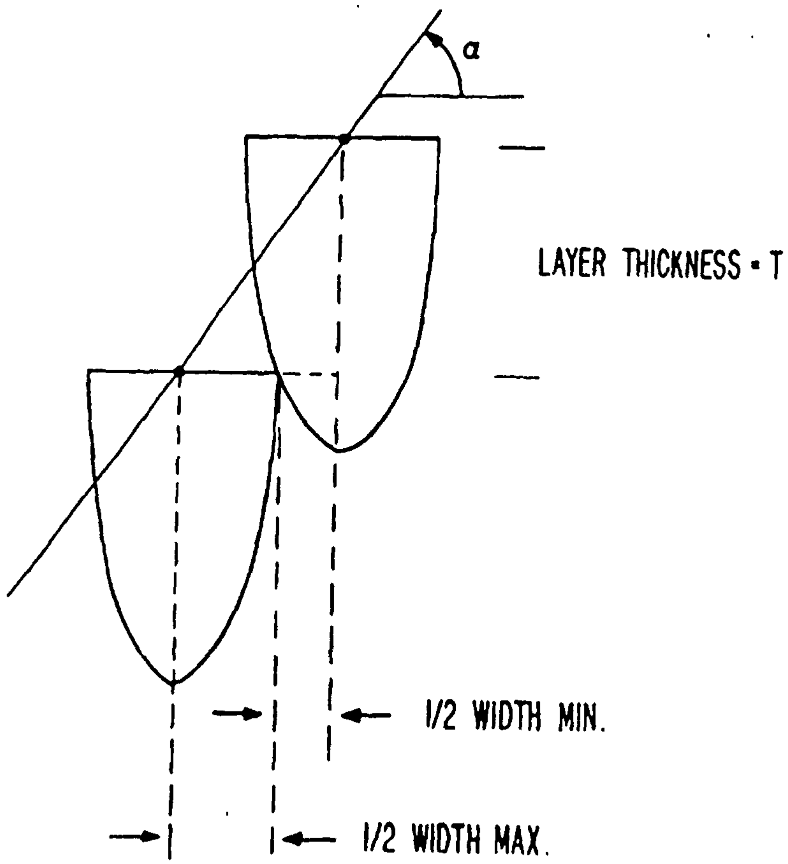


$$\tan\alpha = \frac{OPP}{ADJ} = \frac{T}{1/2(W_{MAX}+W_{MIN})}$$

$$\alpha = \tan^{-1}\left(\frac{2T}{W_{MAX}+W_{MIN}}\right)$$

FIG. 26b.

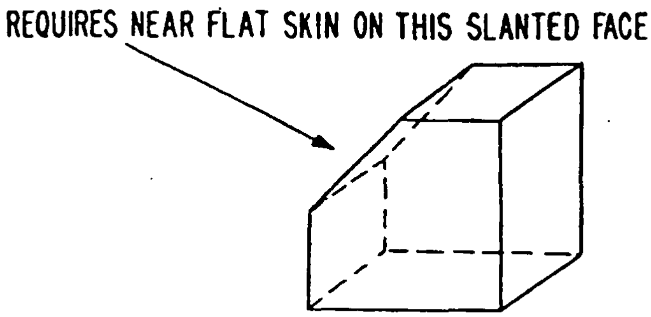


FIG. 26c.

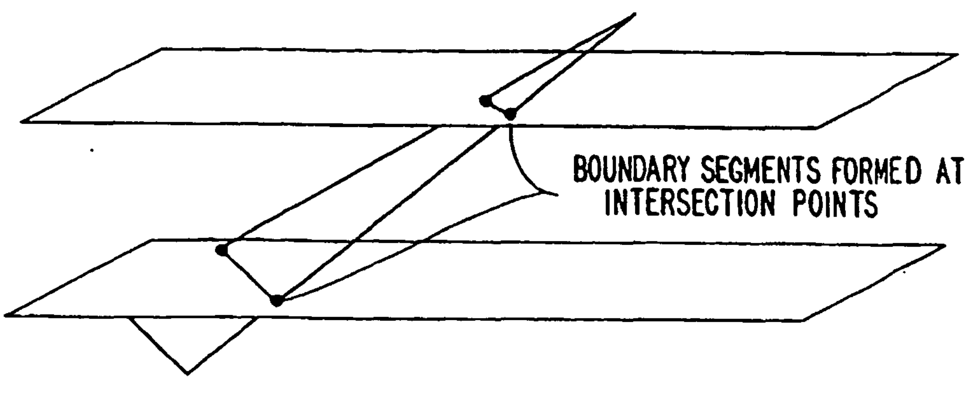


FIG. 26d.

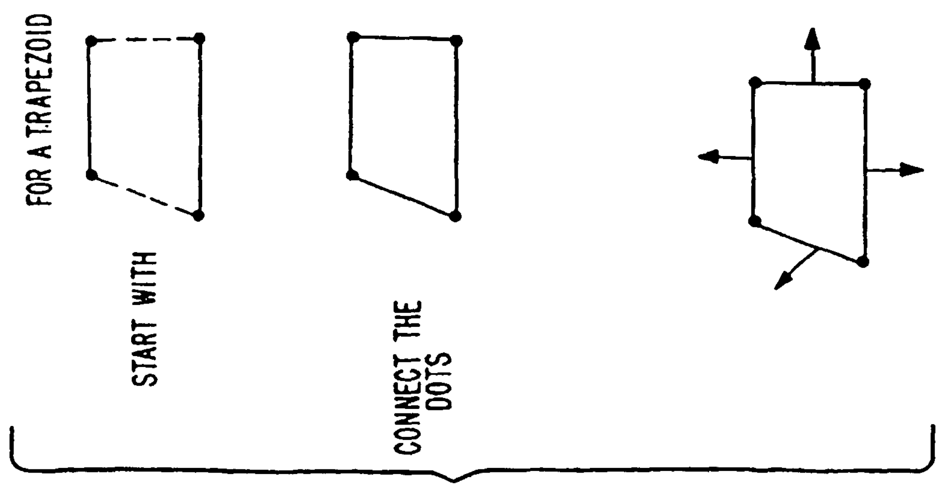


FIG. 26e.

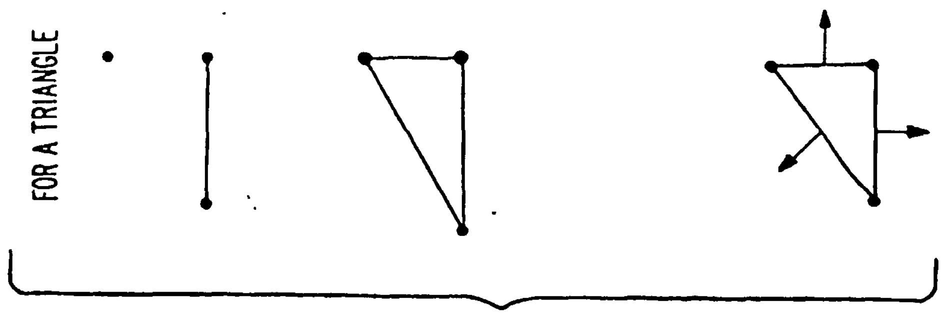


FIG. 26f.

NEAR FLAT TRIANGLE BOUNDARY FOR A CROSS SECTION OF A 4 SIDED PYRAMID

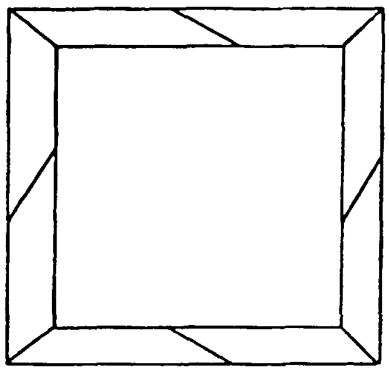

FIG. 26g.

SAME CROSS SECTION AFTER REMOVAL OF PAIRS OF DUPLICATE BOUNDARY VECTORS

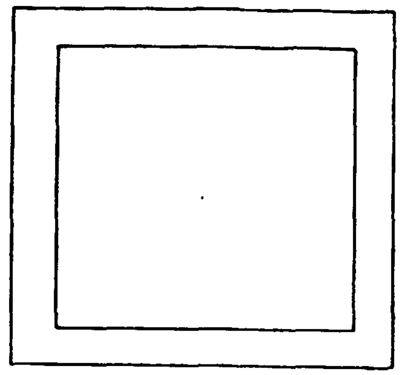

FIG. 26h.

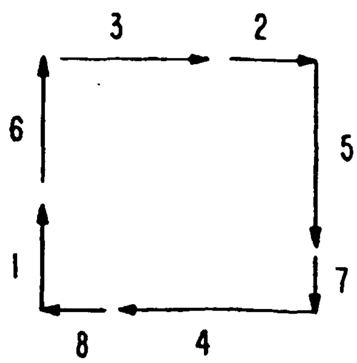


FIG. 27a.

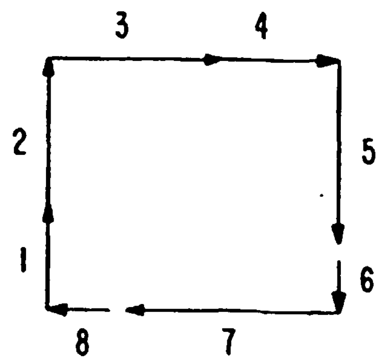


FIG. 27b.

FIG. 27c.

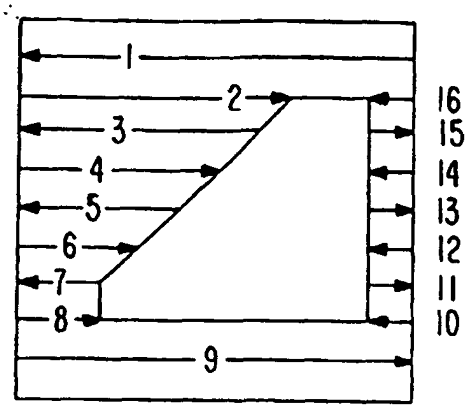


FIG. 27d.

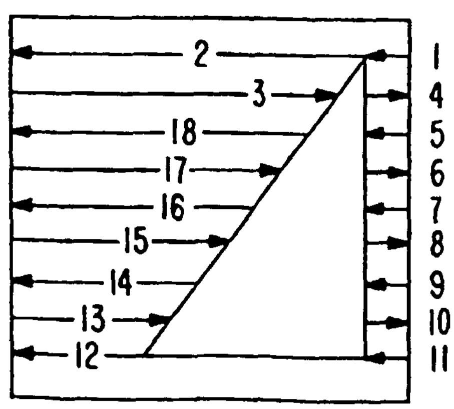

FIG. 27e.

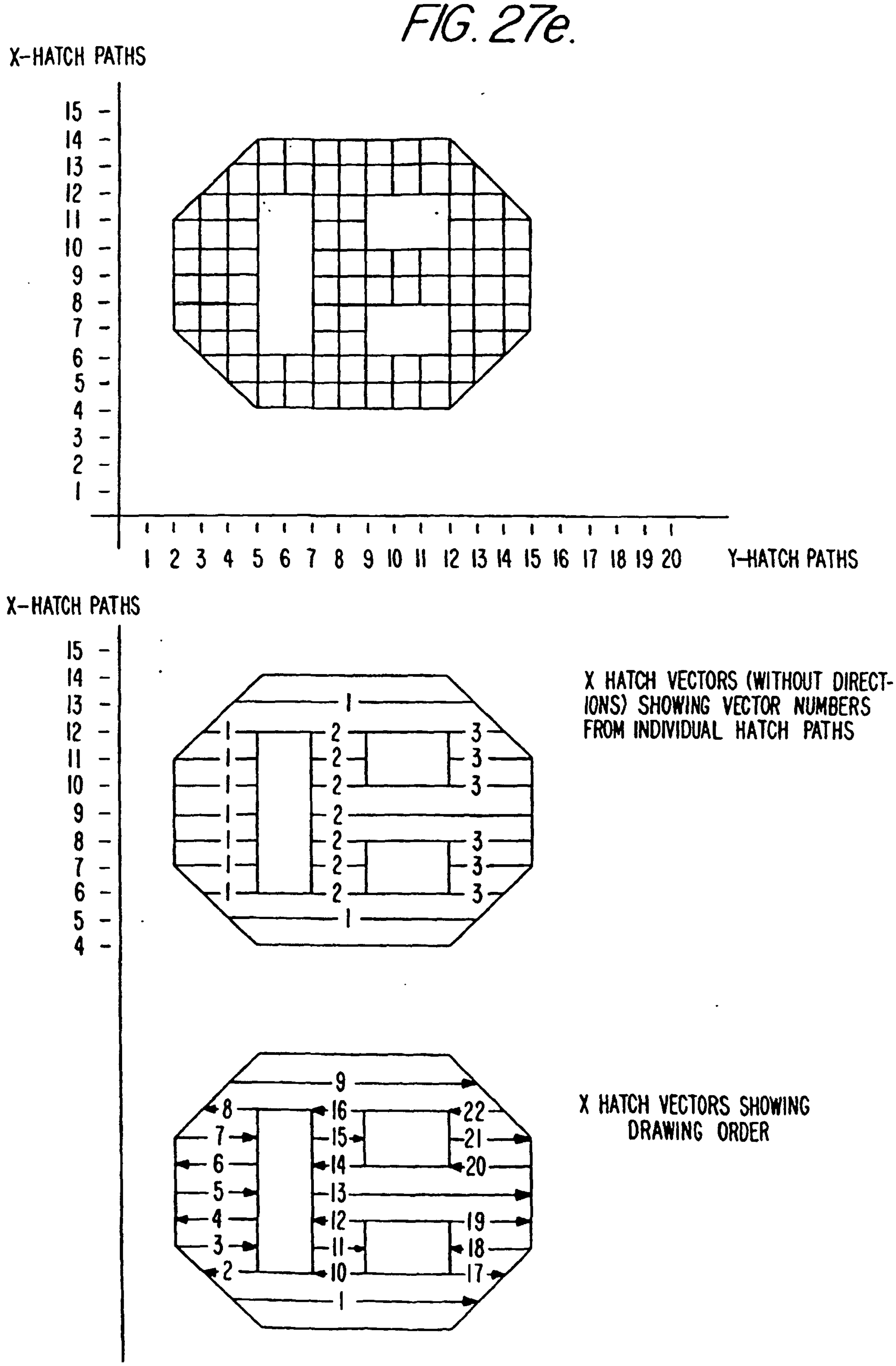

X-HATCH PATHS
Y-HATCH PATHS
X HATCH VECTORS (WITHOUT DIRECTIONS) SHOWING VECTOR NUMBERS FROM INDIVIDUAL HATCH PATHS
X HATCH VECTORS SHOWING DRAWING ORDER

CAD DESIGN

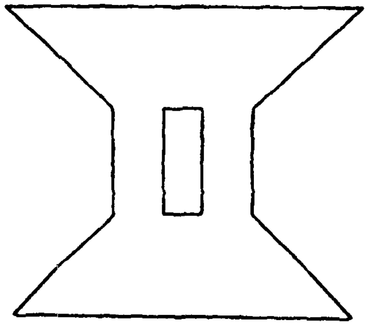

FIG. 28a.

STYLE 1

STYLE 2

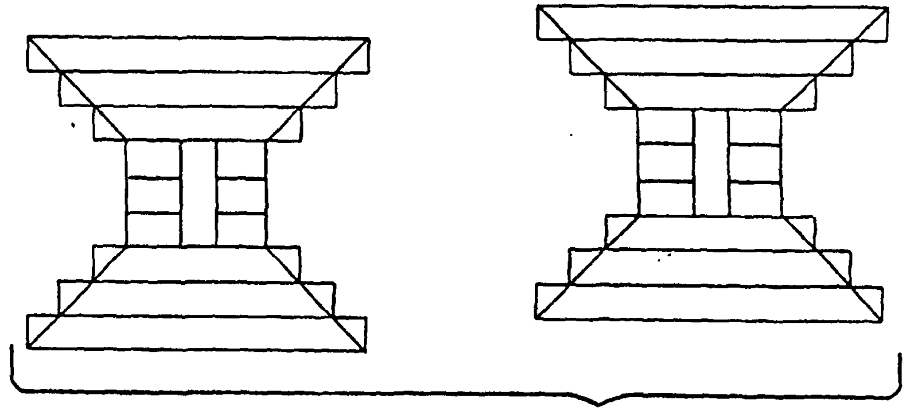

FIG. 28b.

STYLE 3

STYLE 4

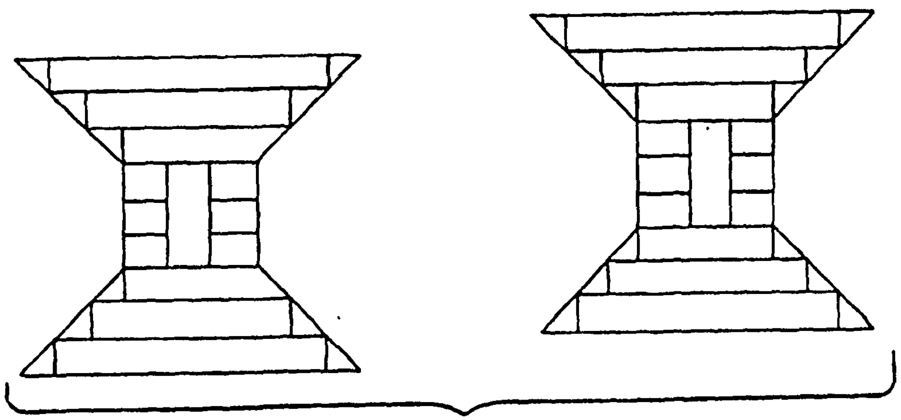

FIG. 28c.

LAYERS AND PLANES 1 BIT UP (FOR CREATING BOUNDARY VECTORS)

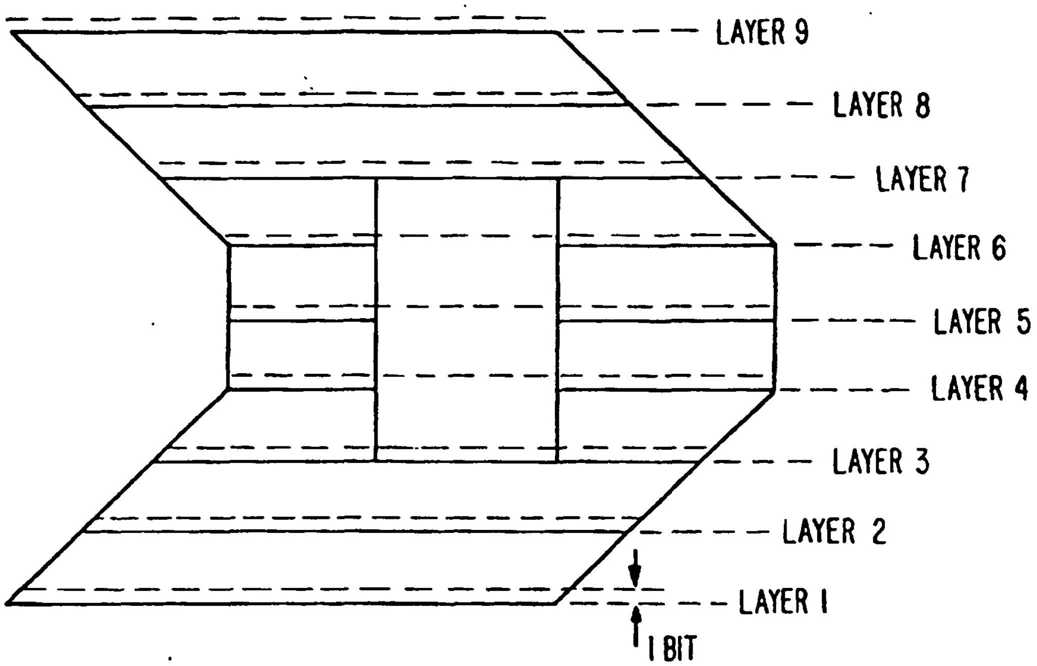


FIG. 29a.

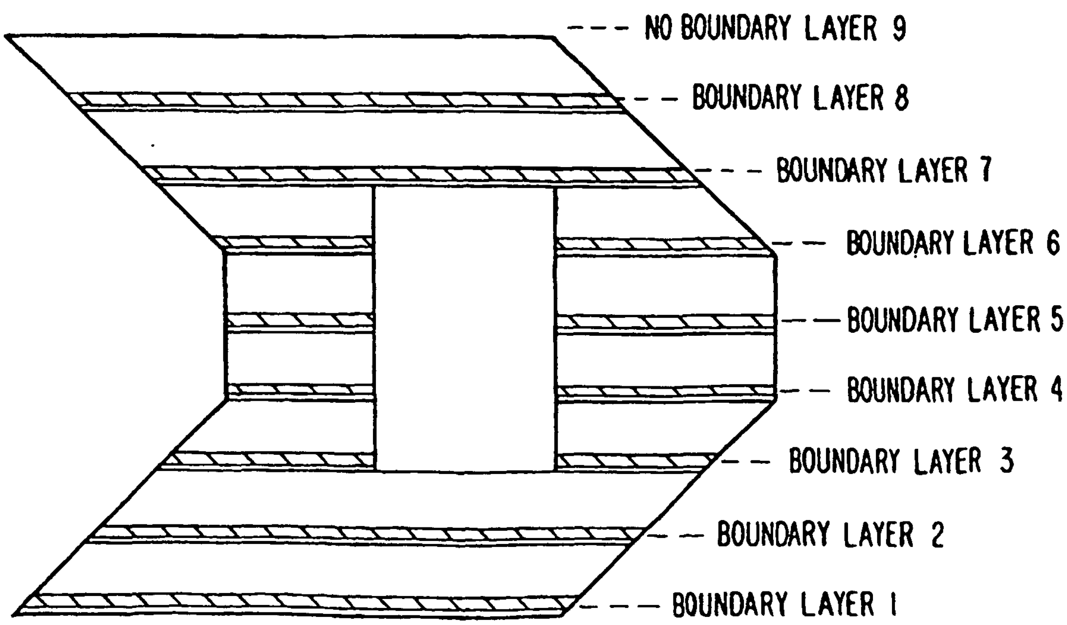


FIG. 29b.

FORMATION OF SOLID MATERIAL FROM CURING LAYER BOUNDARY VECTORS

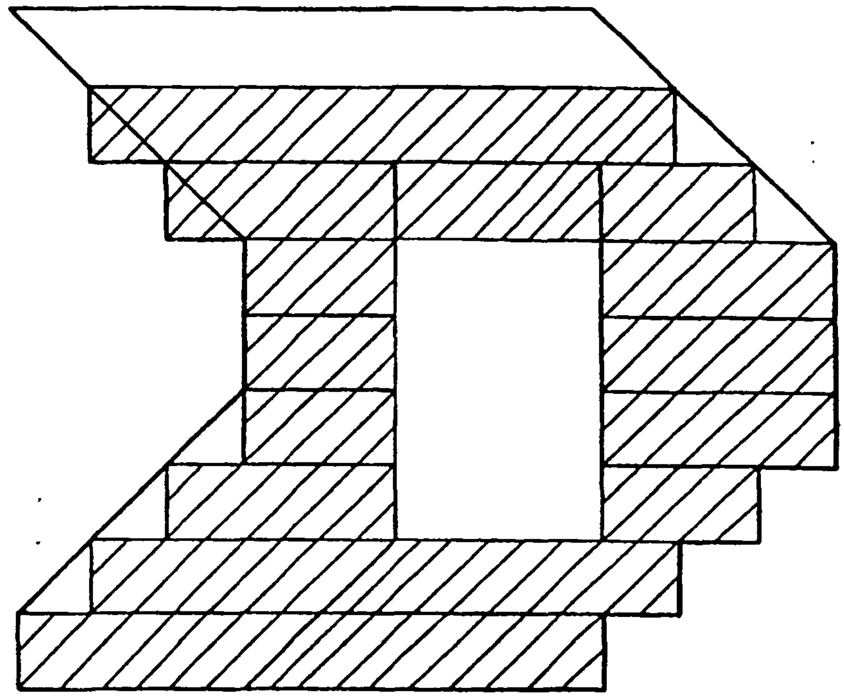

FIG. 29c.

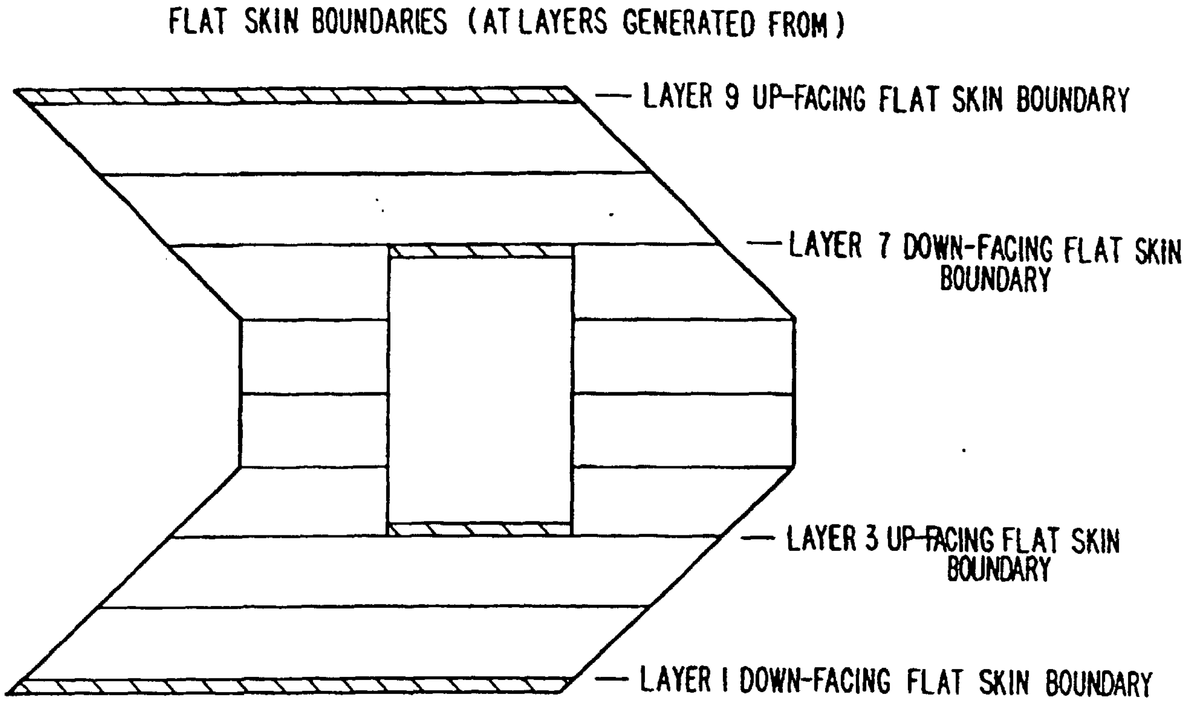


FIG. 29d.

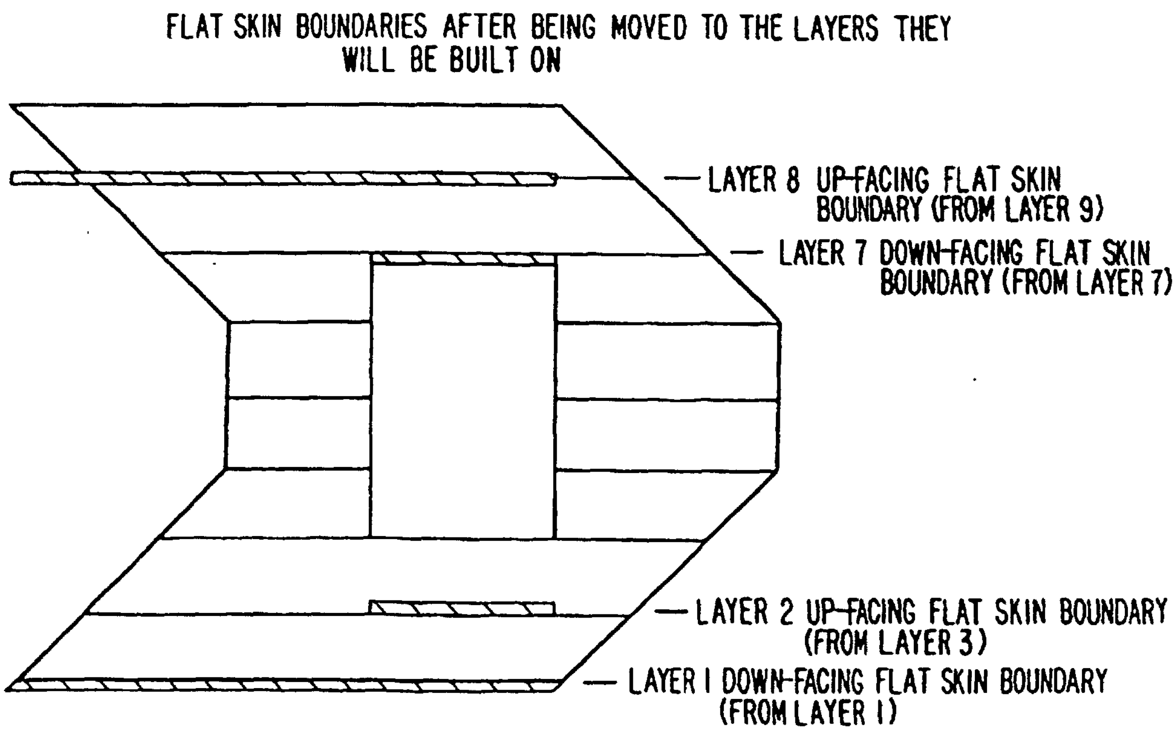


FIG. 29e.

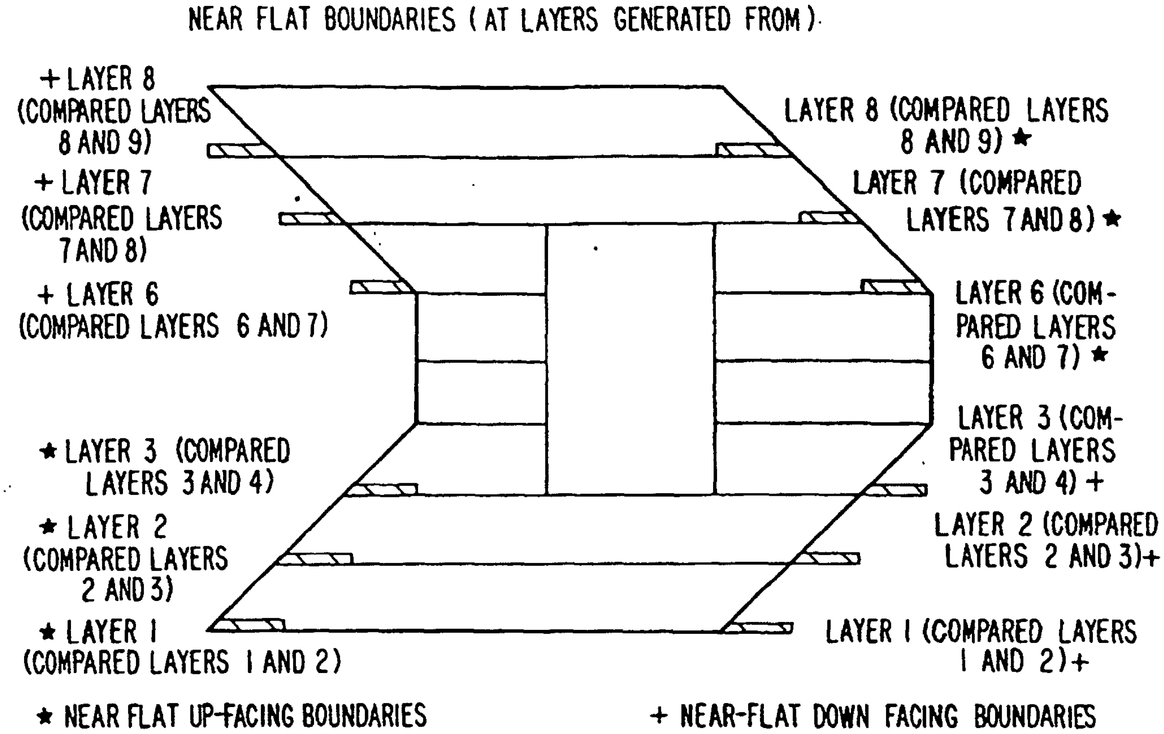


FIG. 29f.

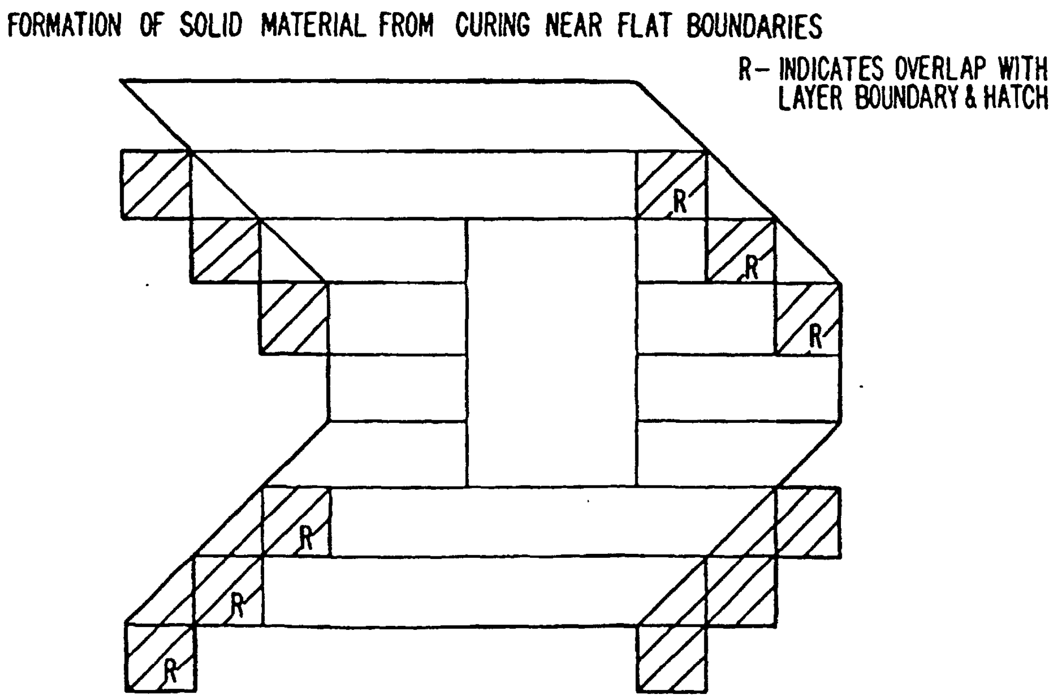


FIG. 29g.

SUPERPOSITION OF LAYER BOUNDARIES AND NEAR-FLAT BOUNDARIES AFTER CURING

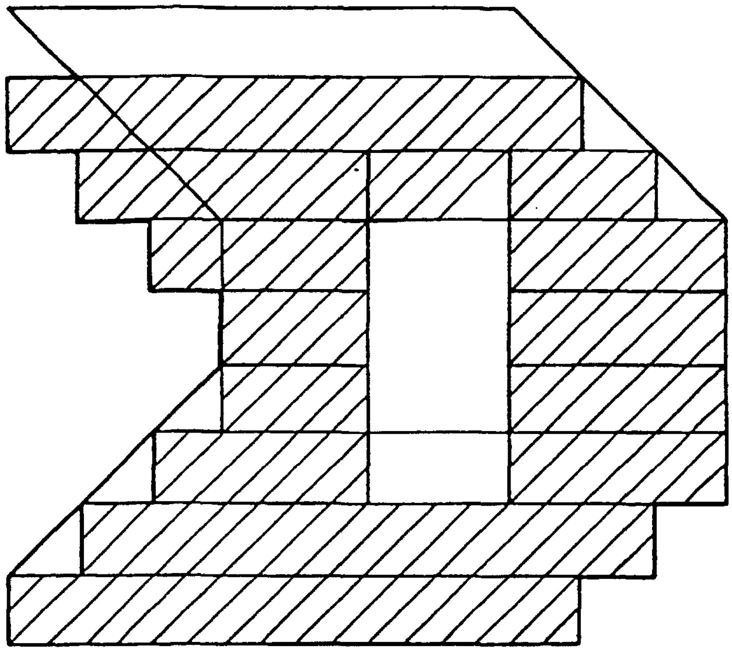

FIG. 29h.

SUPERPOSITION OF LAYER BOUNDARIES & NEAR FLAT BOUNDARIES WITH SKINS (DOWN-FACING SKINS DRAWN AT THE BOTTOM OF THEIR LAYERS

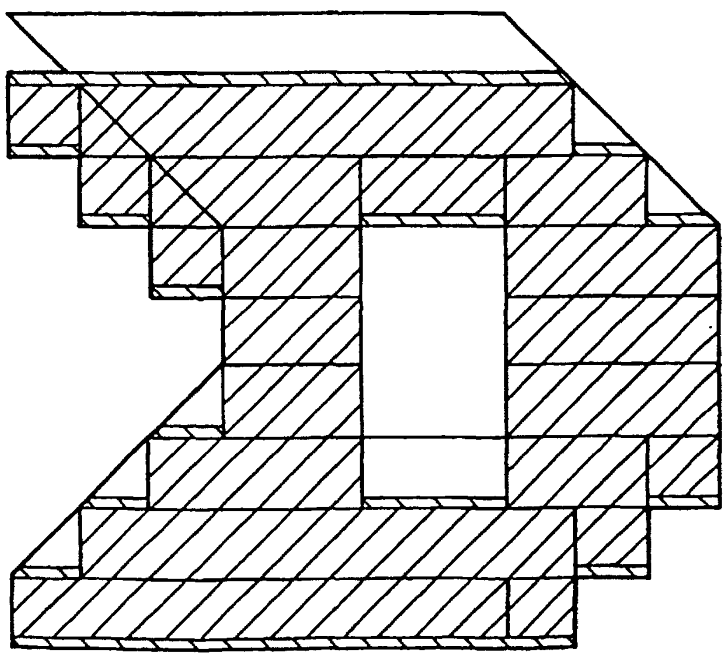

FIG. 29i.

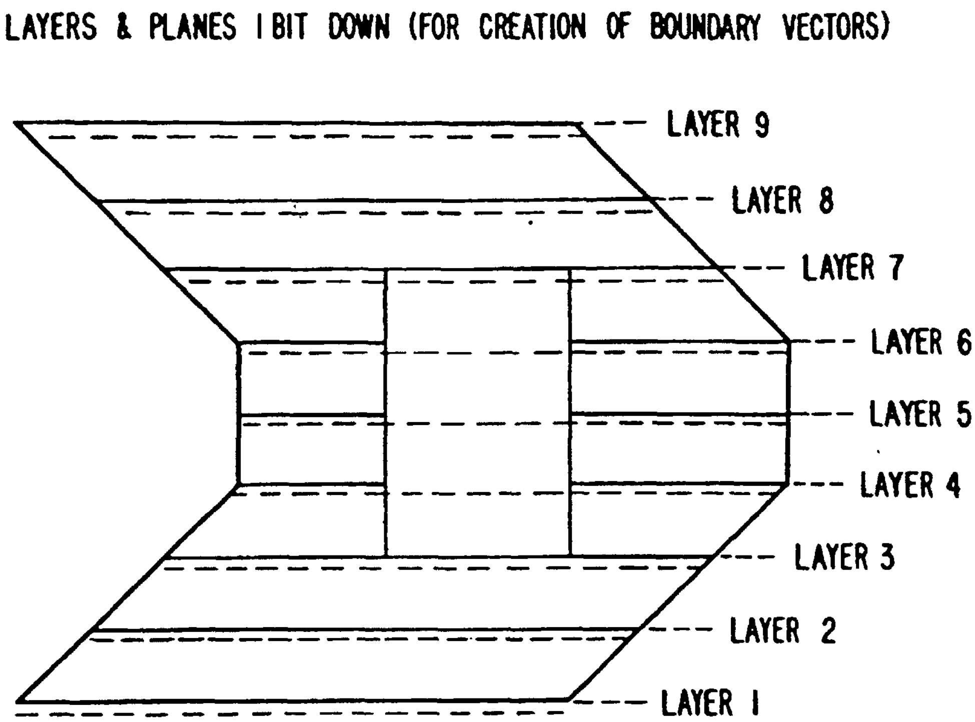


FIG. 30a.

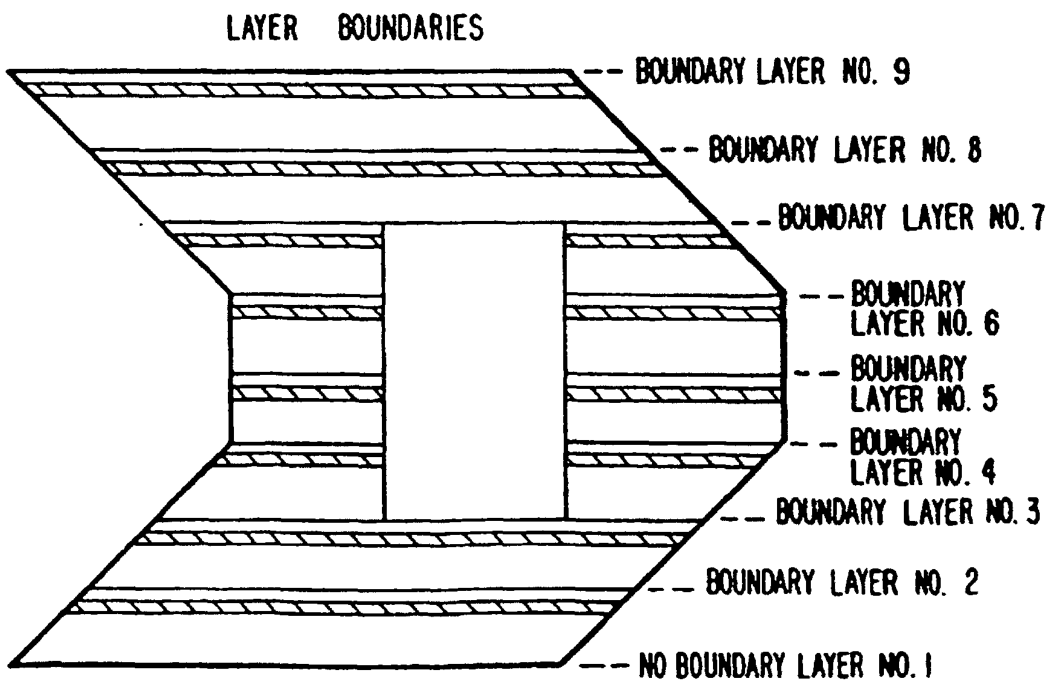


FIG. 30b.

FORMATION OF SOLID MATERIAL FROM LAYER BOUNDARIES AND ASSOCIATED HATCH

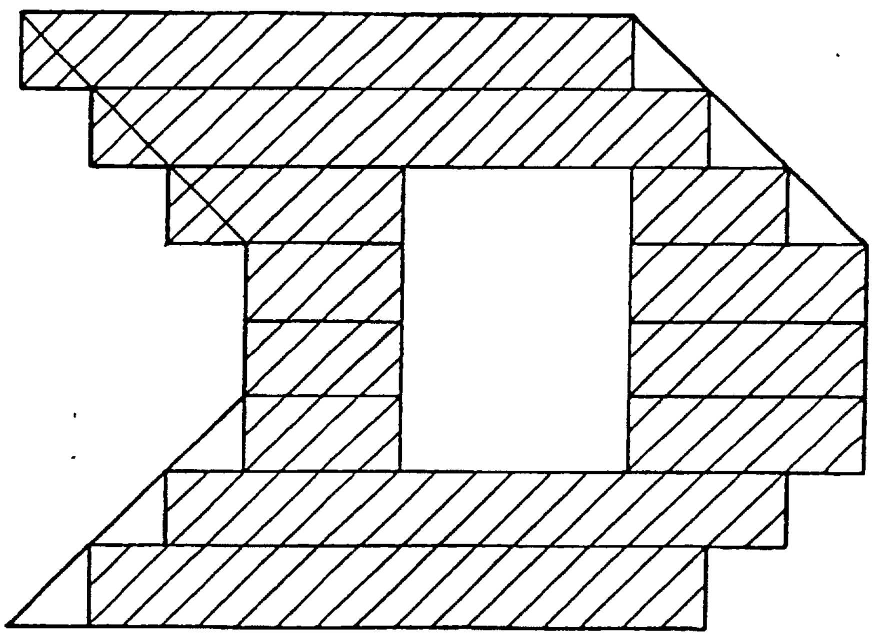

FIG. 30c.

NEAR FLAT BOUNDARIES (AT LAYERS GENERATED)

★ NEAR-FLAT UP-FACING BOUNDARIES + NEAR-FLAT DOWN-FACING BOUNDARIES

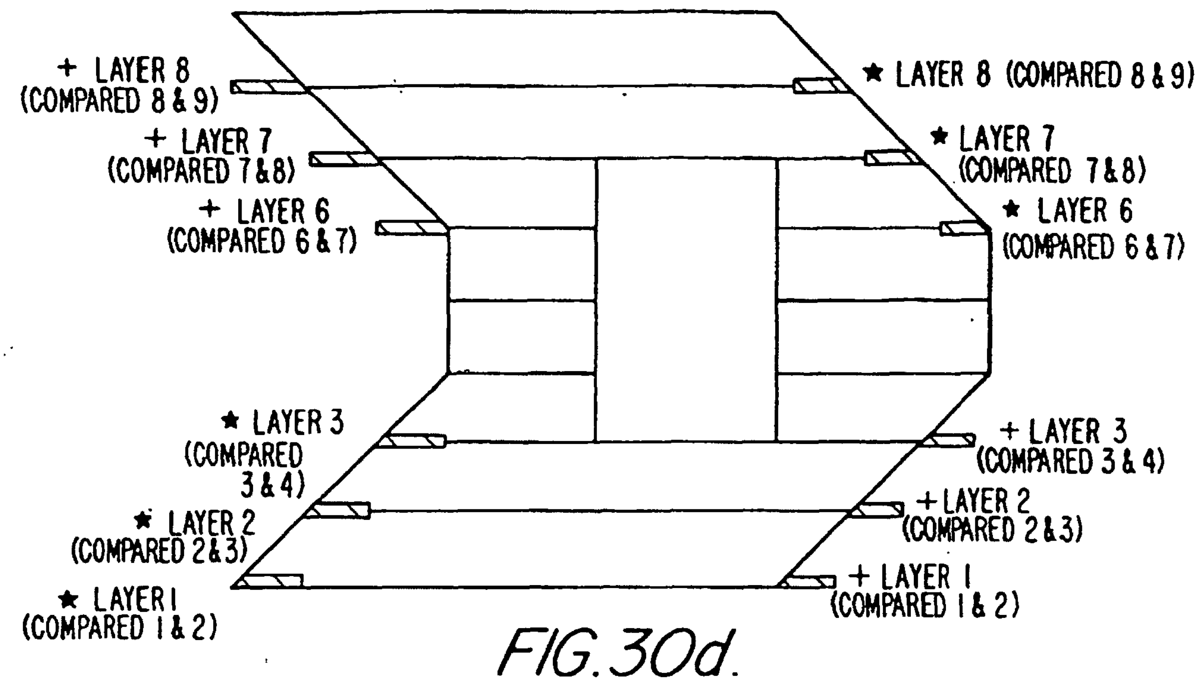


FIG. 30d.

NEAR FLAT BOUNDARIES AFTER BEING MOVED TO THE LAYER THEY WILL BE BUILT ON

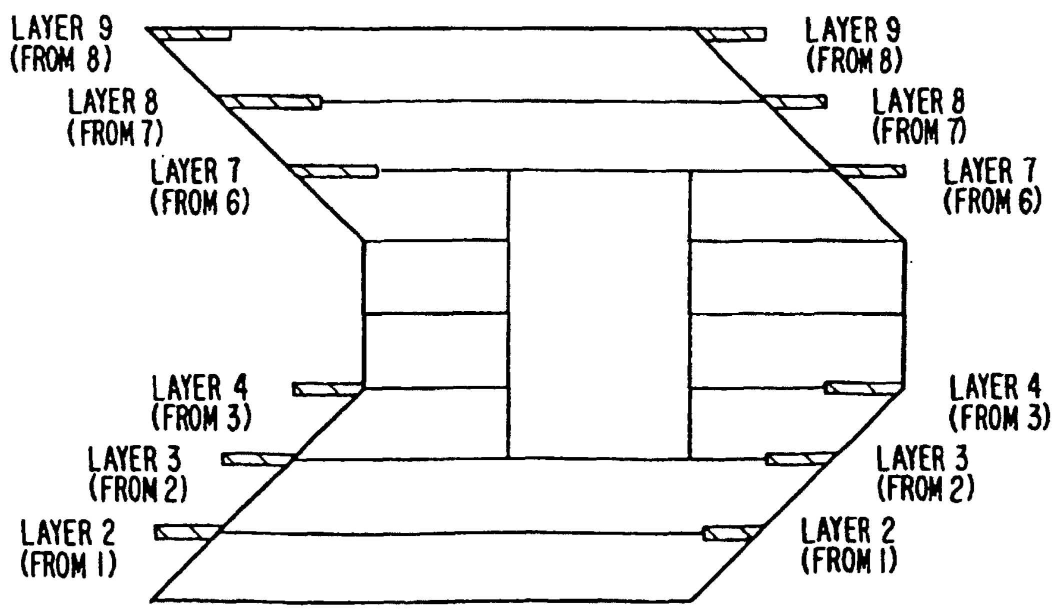


FIG. 30e.

FORMATION OF SOLID AFTER CURING NEAR FLAT BOUNDARIES

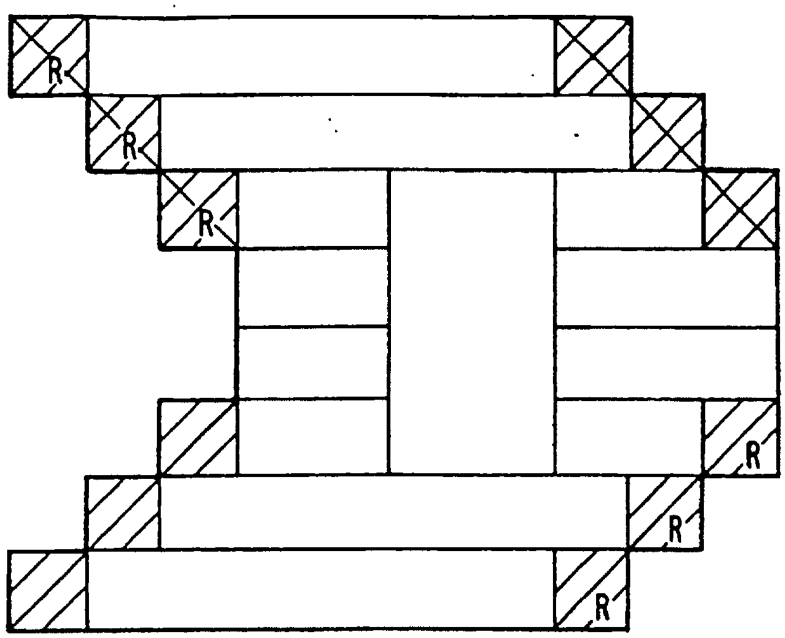


R– INDICATES OVERLAP WITH BOUNDARY AND HATCH

FIG. 30f.

SUPERPOSITION OF LAYER BOUNDARIES AND NEAR FLAT BOUNDARIES AFTER CURING

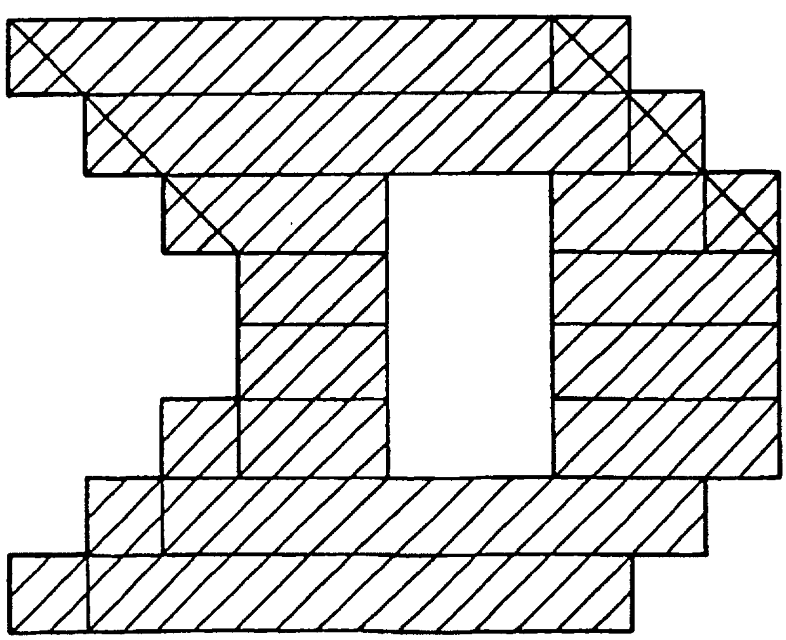

FIG. 30g.

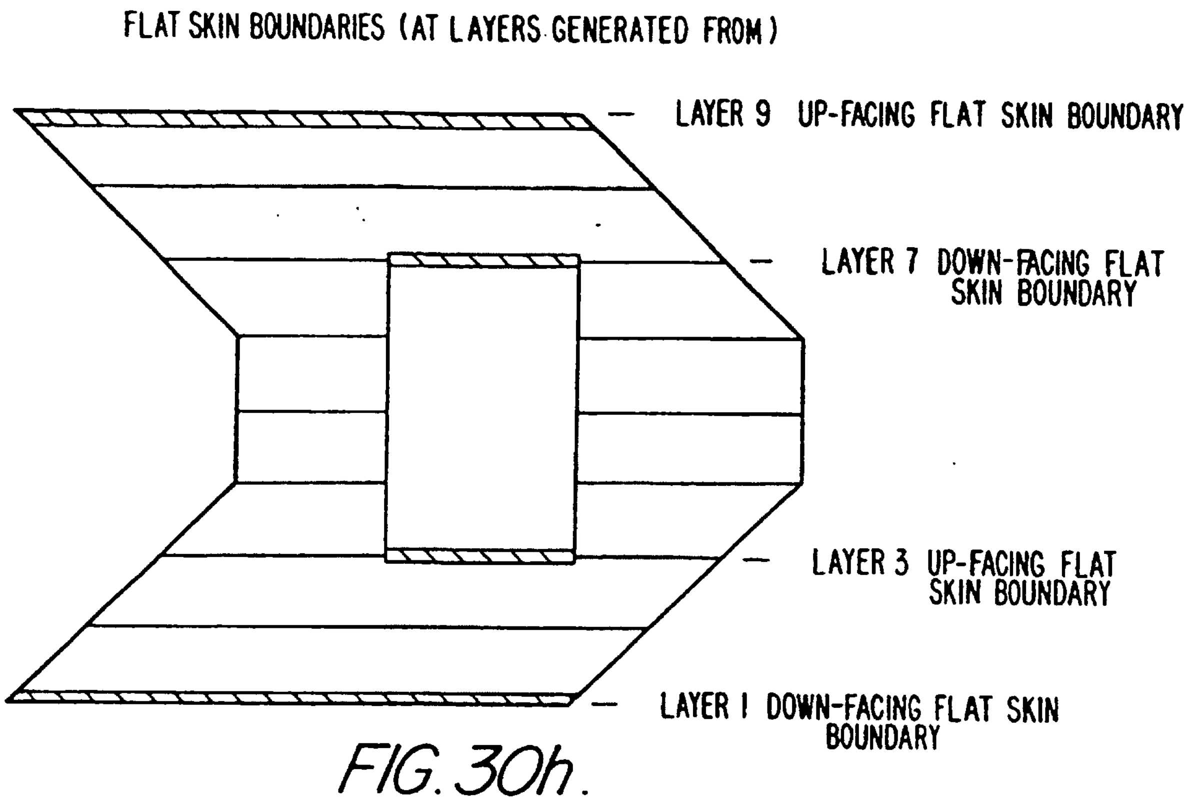


FIG. 30h.

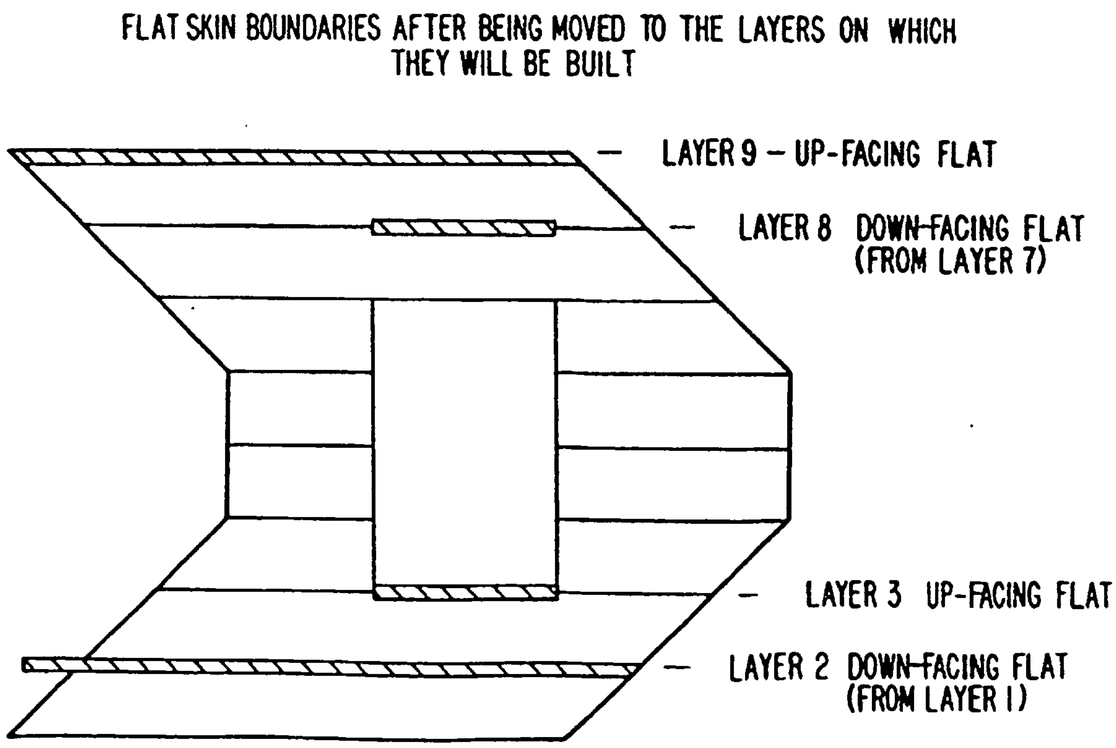


FIG. 30i.

SUPERPOSITION OF LAYER BOUNDARIES, NEAR FLAT BOUNDARIES AND SKINS (DOWN FACING SKINS DRAWN AT THE BOTTOM OF THEIR LAYERS)

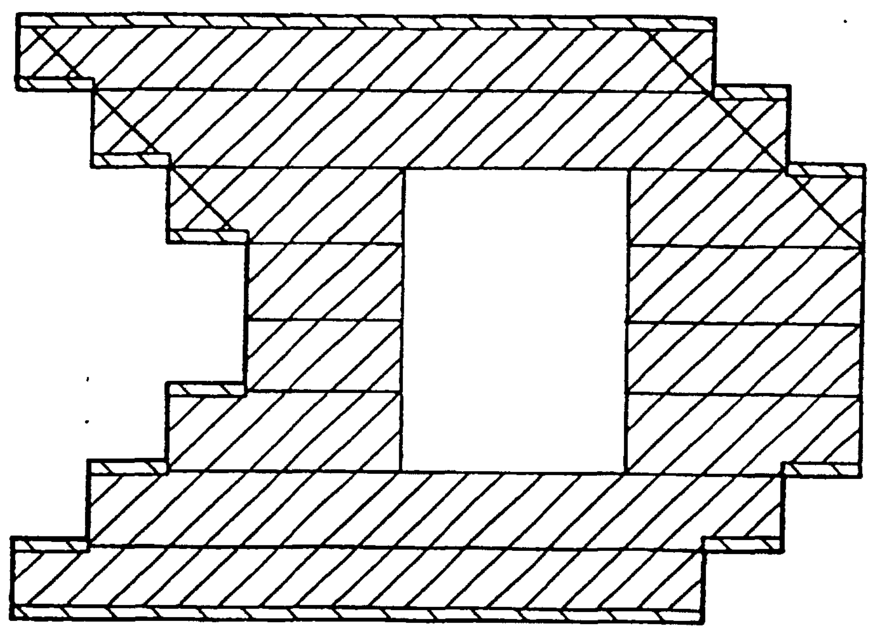

FIG. 30j.

LAYER BOUNDARY (N)= LB (N)(SI) - LB (N)(SI) ∩ NFUB(N)(SI)

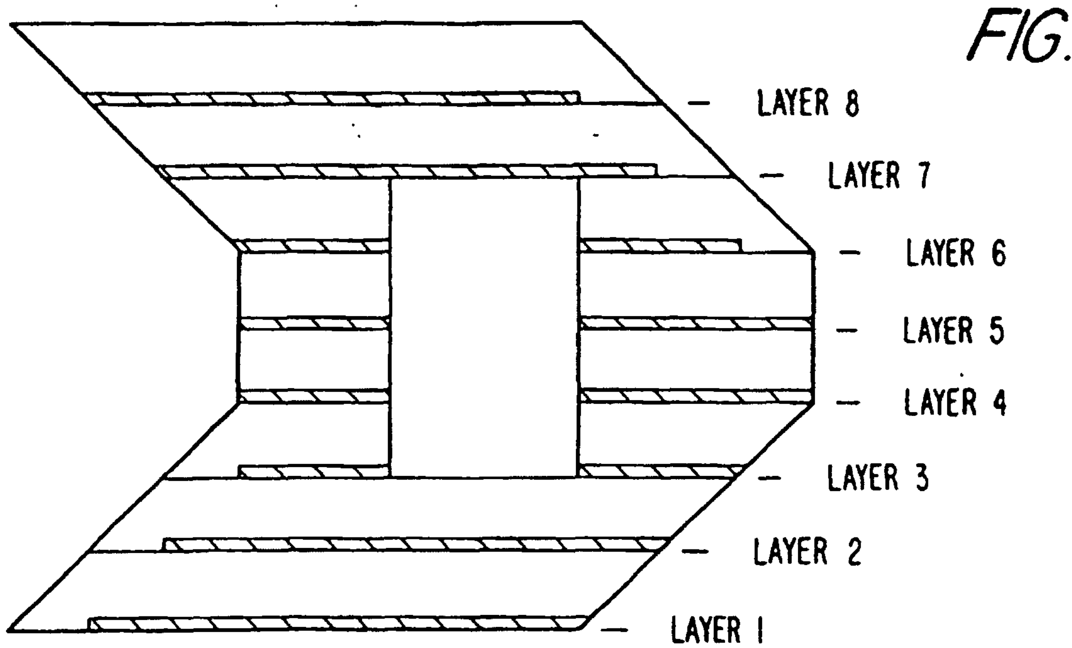


FIG. 31a.

(LAYER BOUNDARIES REMAIN ON THE SAME LAYER FOR BUILDING AS FOR CREATING)
LAYER BOUNDARIES AFTER BEING GIVEN A FULL LAYER CURE

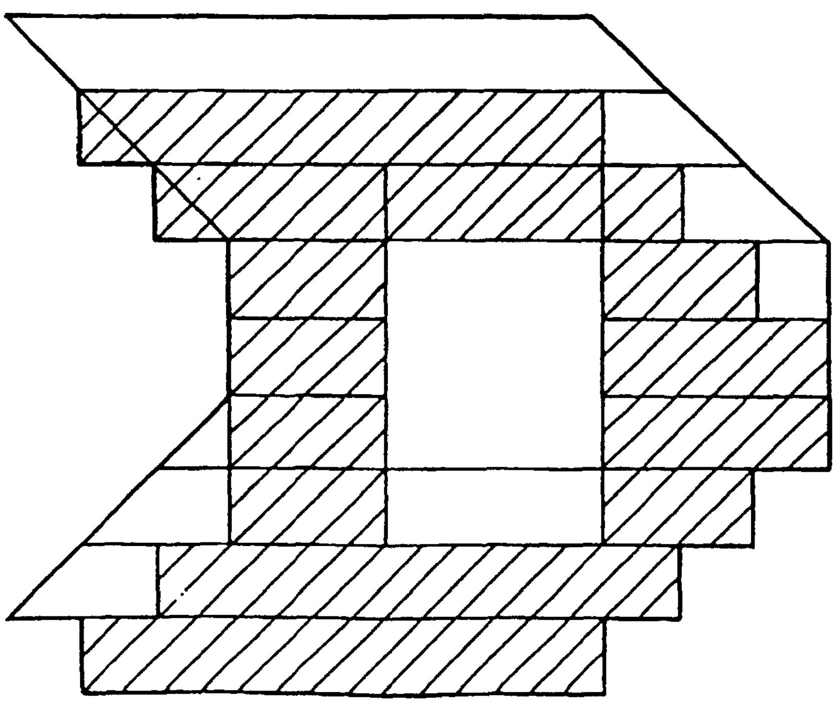

FIG. 31b.

NEAR FLAT BOUNDARIES (DOWN-FACING)

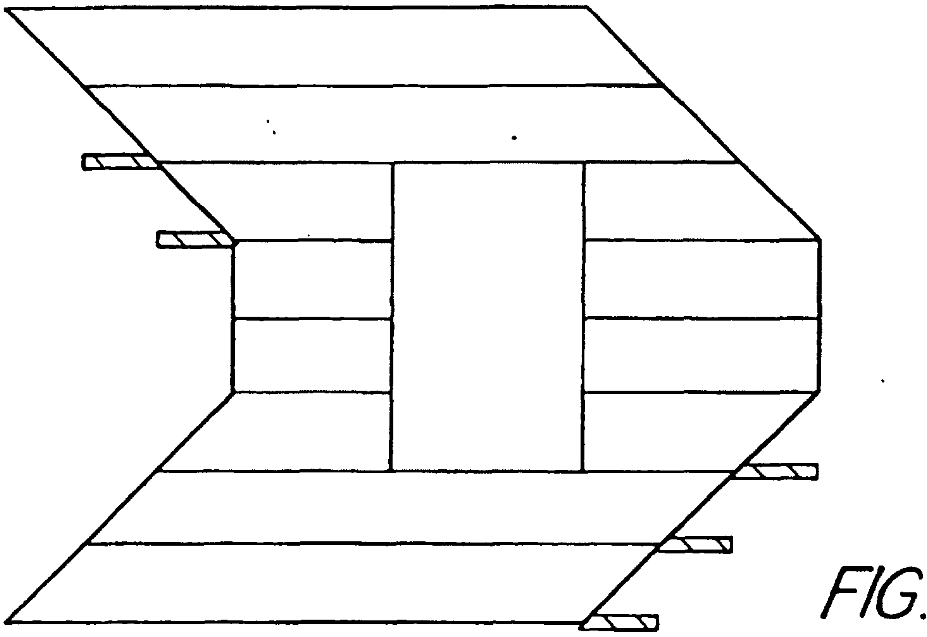

FIG. 31c.

NEAR FLAT BOUNDARIES (DOWN-FACING) AFTER BEING MOVED TO THE LAYERS ON WHICH THEY ARE TO BE BUILT (SINCE THEY ARE CREATED FROM AN INTERSECTION WITH LAYER BOUNDARIES THEY ADD NOTHING NEW TO XY DIMENSIONS OF THE LAYERS)

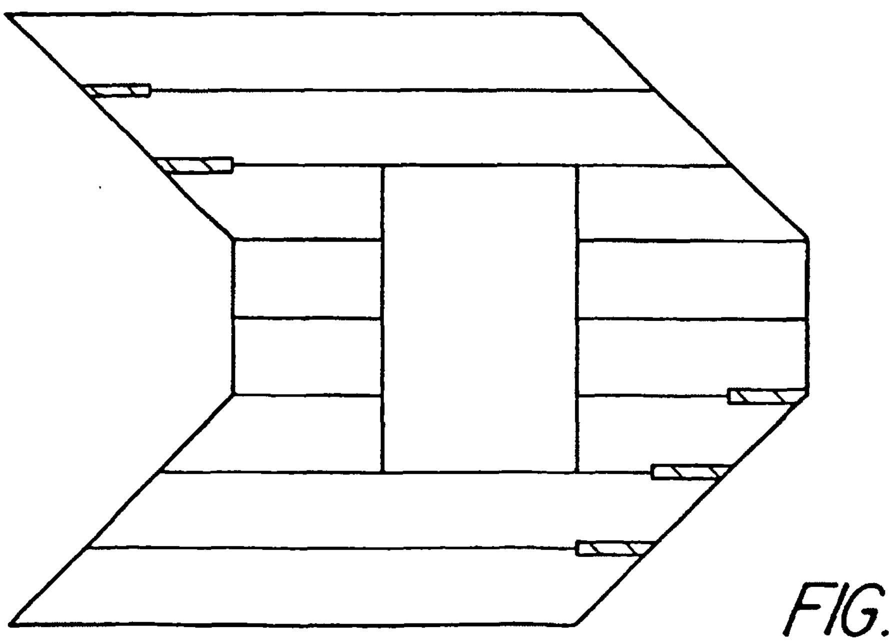

FIG. 31d.

NEAR FLAT BOUNDARIES (UP-FACING)

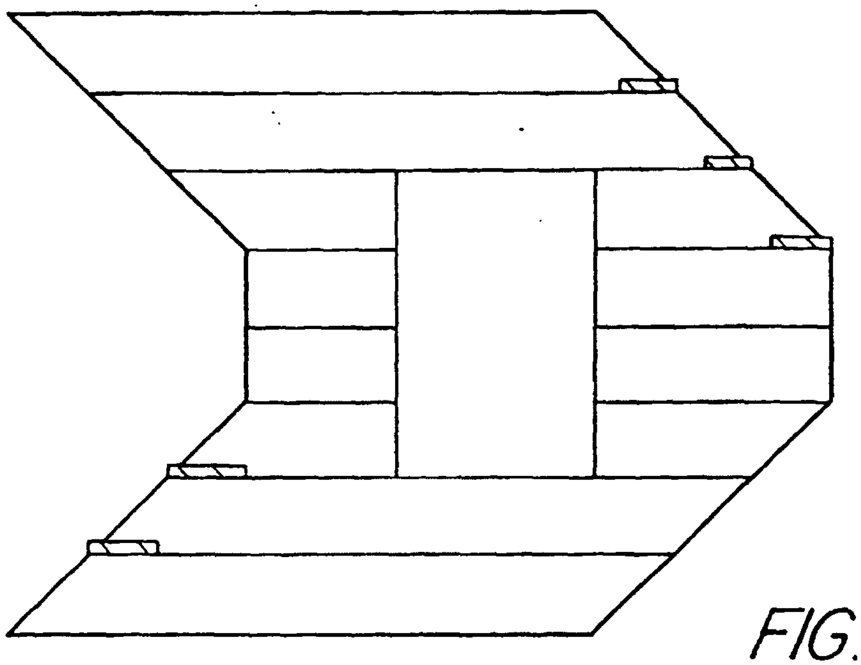

FIG. 31e.

NEAR FLAT BOUNDARIES AFTER BEING MOVED TO THE LAYER THAT THEY WILL BE BUILT ON (UP-FACING)

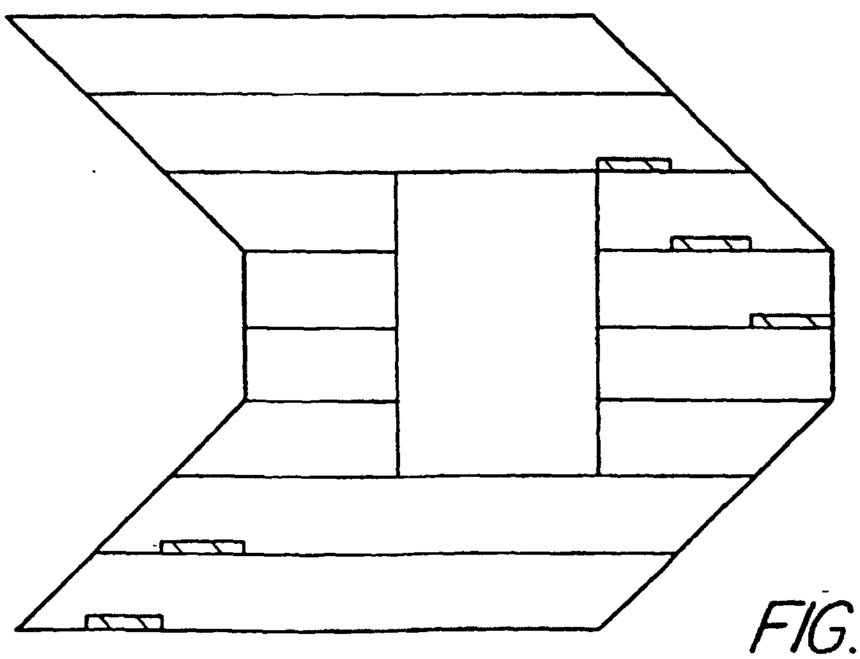

FIG. 31f.

FLAT BOUNDARIES (UP-FACING)

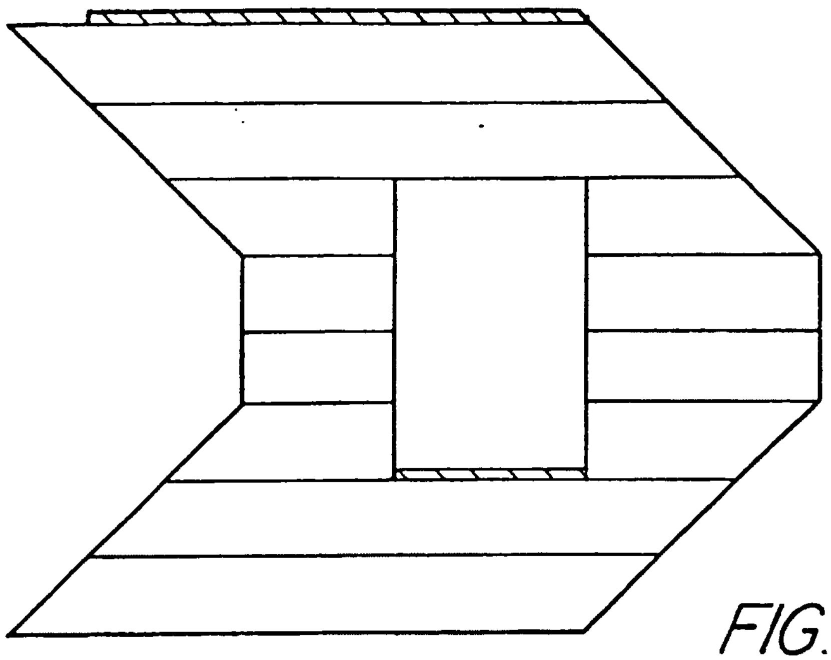

FIG. 31g.

FLAT BOUNDARIES (UP-FACING) AFTER BEING MOVED TO THE LAYER THEY WILL BE BUILT ON

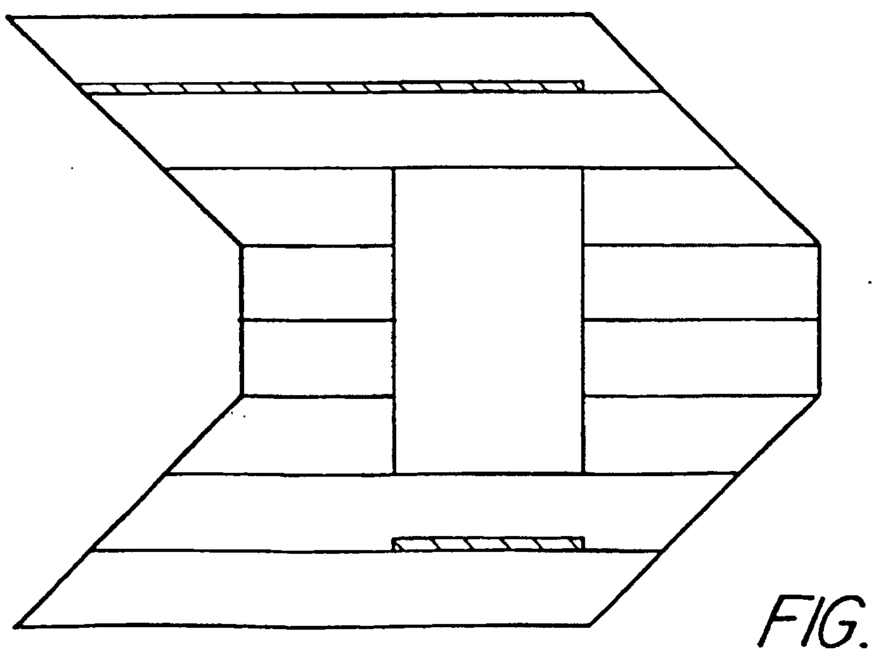

FIG. 31h.

FLAT BOUNDARIES (DOWN-FACING) (BUILT ON SAME LAYER FOUND ON)

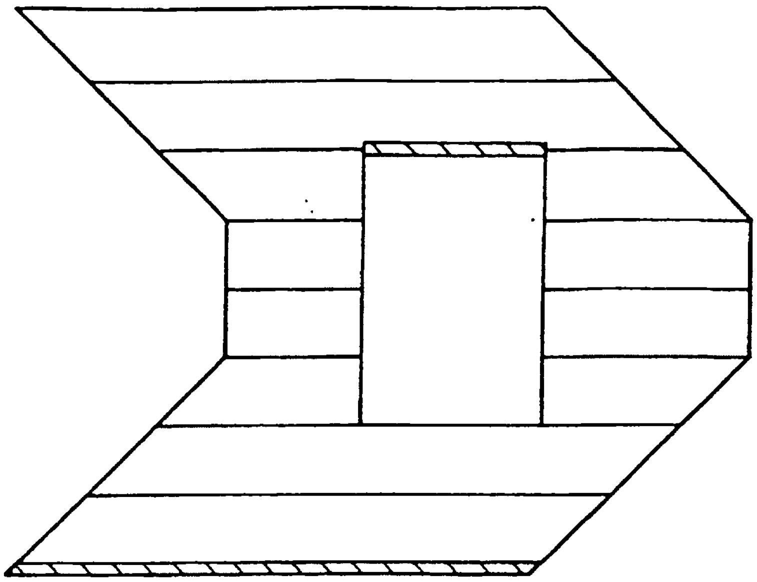

FIG. 31i.

SUPERPOSITION OF LAYER BOUNDARIES, NEAR FLAT BOUNDARIES, AND SKINS
(DOWN-FACING SKINS DRAWN AT THE BOTTOM OF THEIR LAYERS)

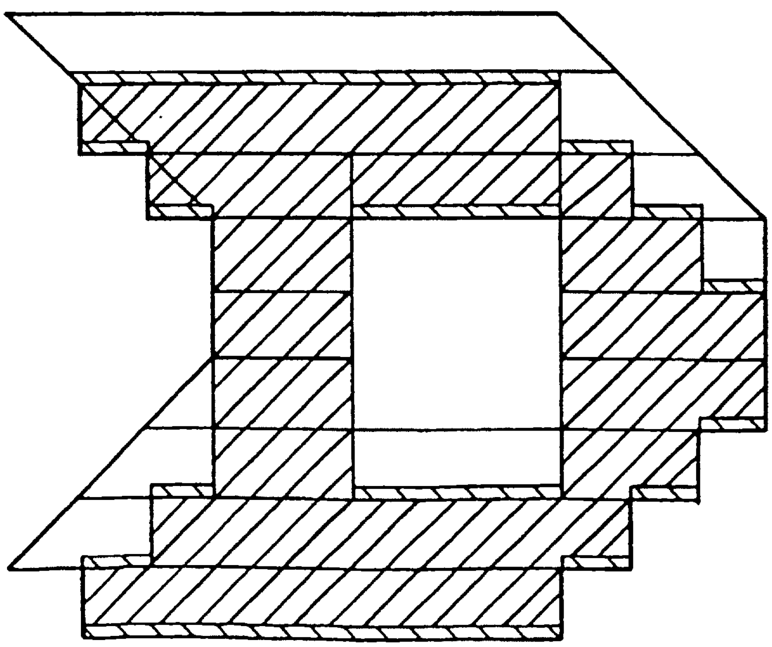

FIG. 31j.

BOUNDARY VECTORS

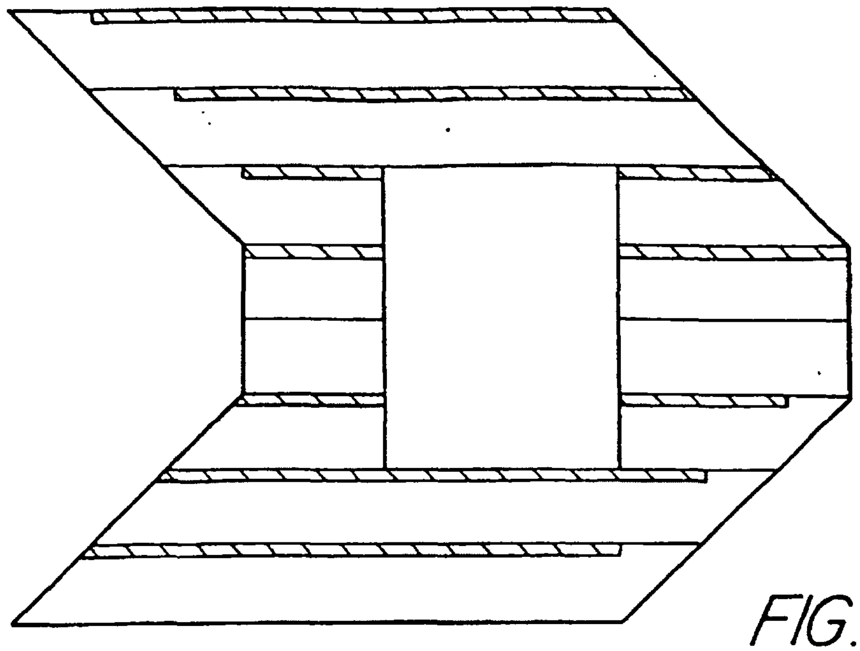

FIG. 31k.

BOUNDARY VECTORS AFTER BEING GIVEN FULL LAYER CURE

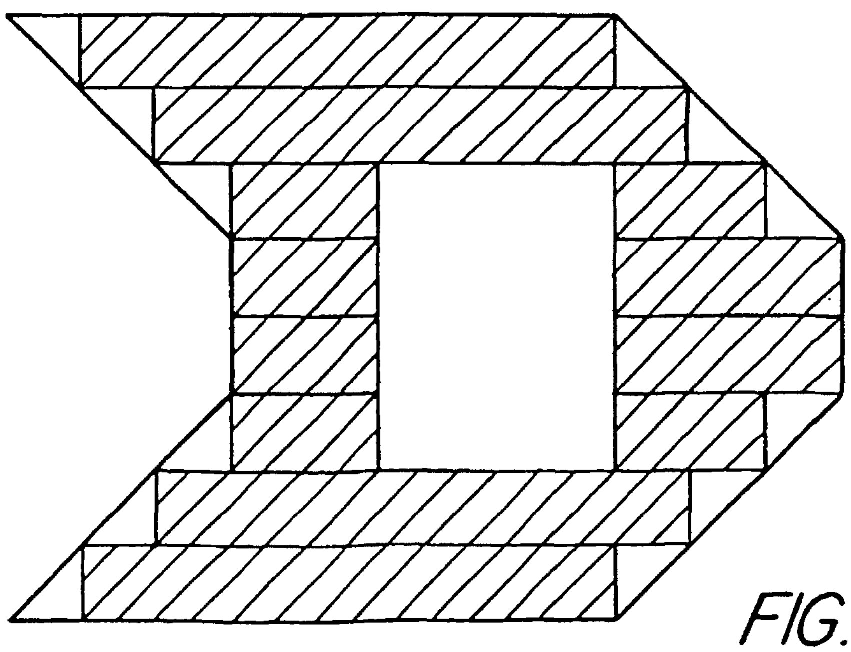

FIG. 31L.

NEAR-FLAT DOWN-FACING BOUNDARIES

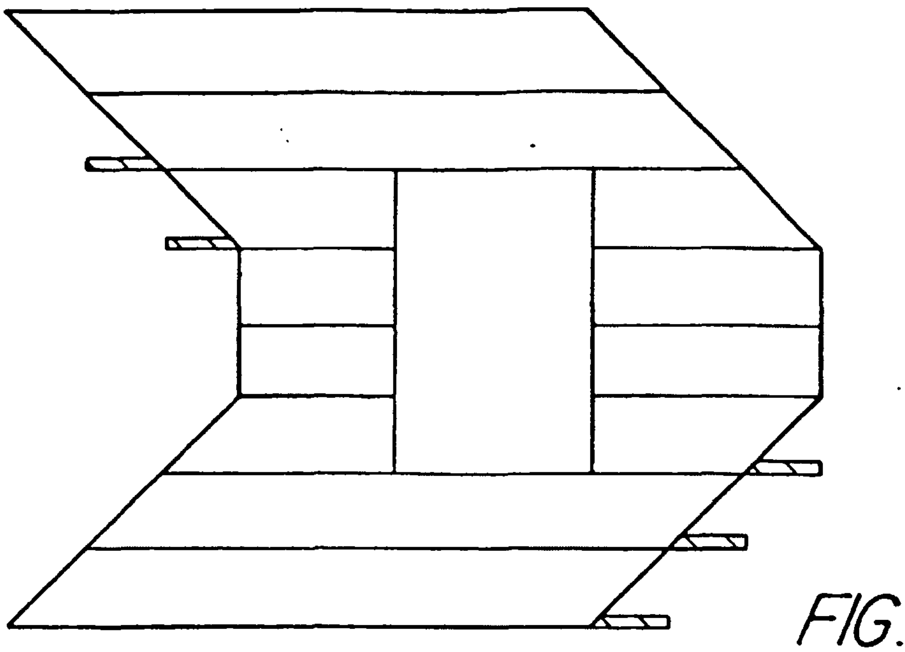

FIG. 31m.

NEAR-FLAT DOWN-FACING BOUNDARIES AFTER BEING MOVED TO THE LAYER THE WILL BE BUILT ON

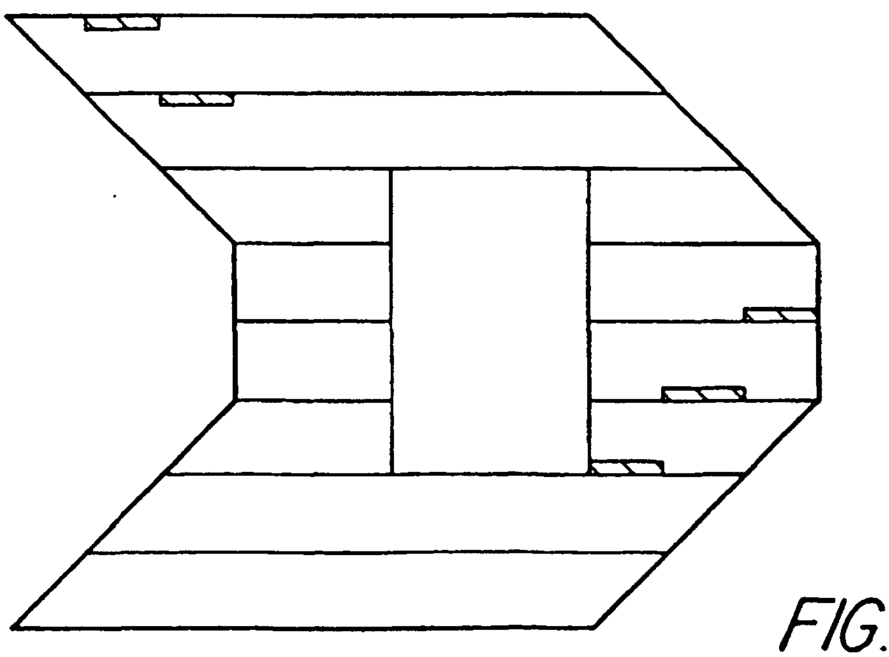

FIG. 31n.

NEAR-FLAT UP-FACING BOUNDARIES (NOT MOVED TO NEW LAYERS WHEN BUILT)

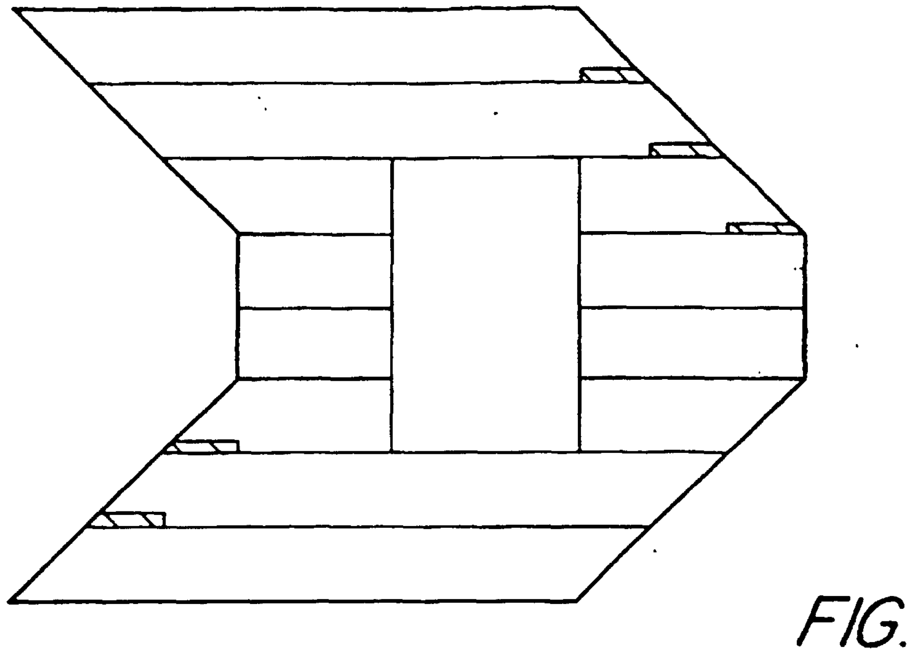

FIG. 31o.

FLAT-UP FACING BOUNDARIES (STAY ON SAME LAYER WHEN BUILT)

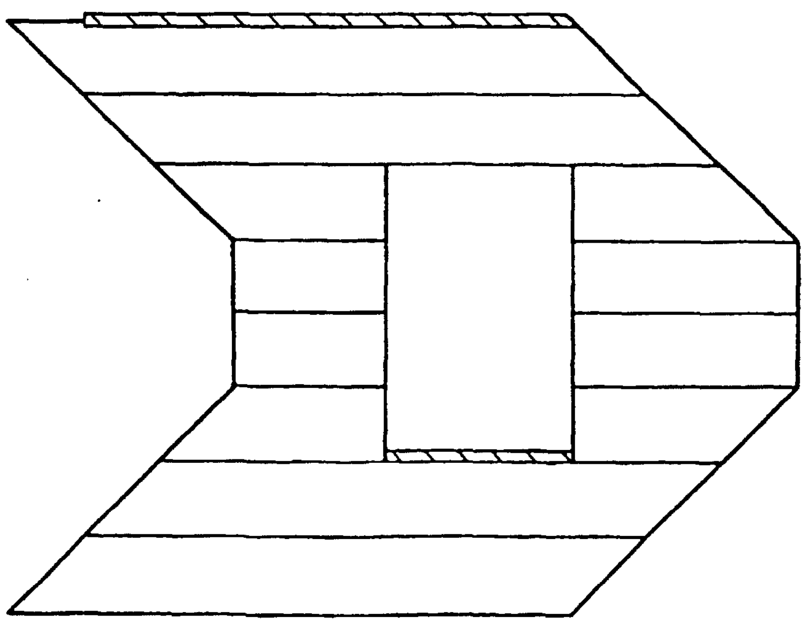

FIG. 31p.

FLAT-DOWN FACING BOUNDARIES

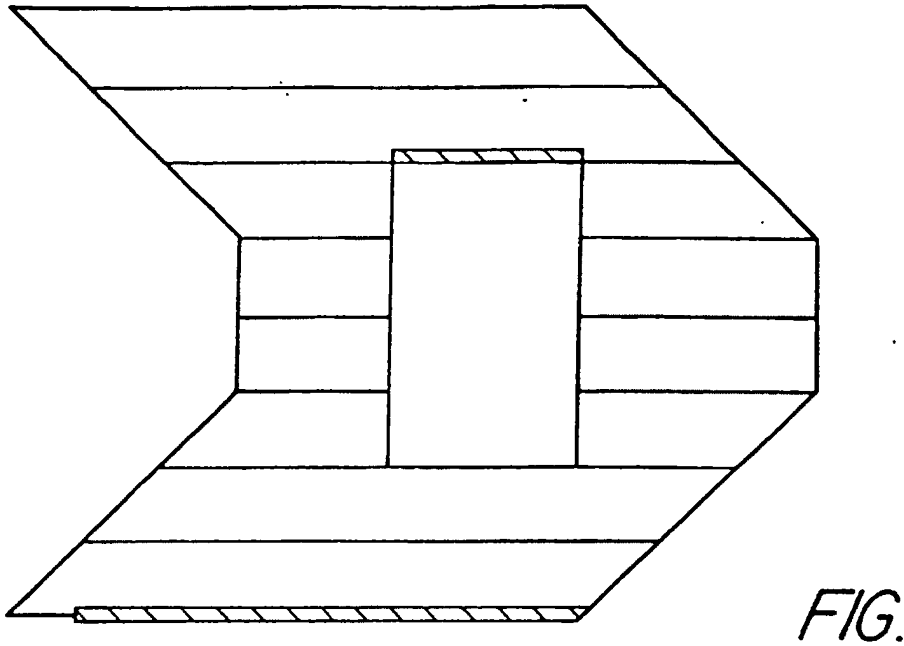

FIG. 31q.

FLAT-DOWN FACING BOUNDARIES AFTER BEING MOVED TO THE LAYERS ON WHICH THEY WILL BE BUILT

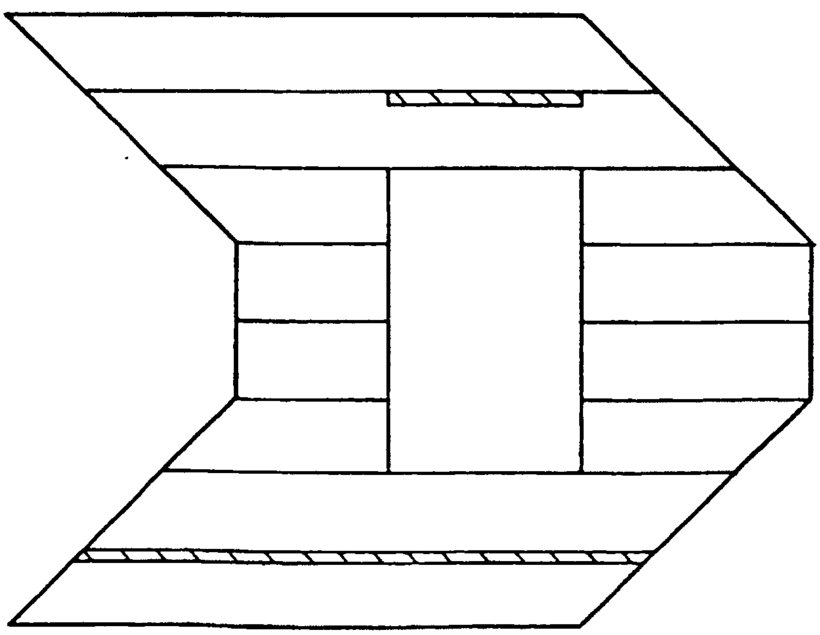

FIG. 31r.

SUPERPOSITION OF LAYER BOUNDARIES, NEAR FLAT BOUNDARIES AND SKIN AFTER ALL HAVE BEEN MOVED TO THE LAYERS ON WHICH THEY WILL BE BUILT AND LAYERS ARE GIVEN APPROPRIATE CURE DEPTHS. DOWN FACING SKINS DRAWN AT THE BOTTOM OF THEIR LAYERS.

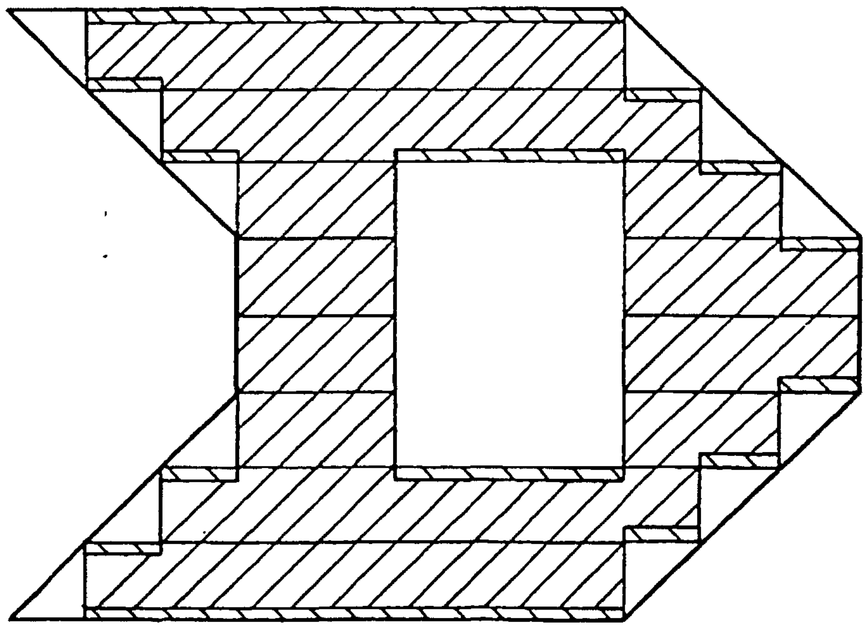

FIG. 31s.

FIG. 31t.

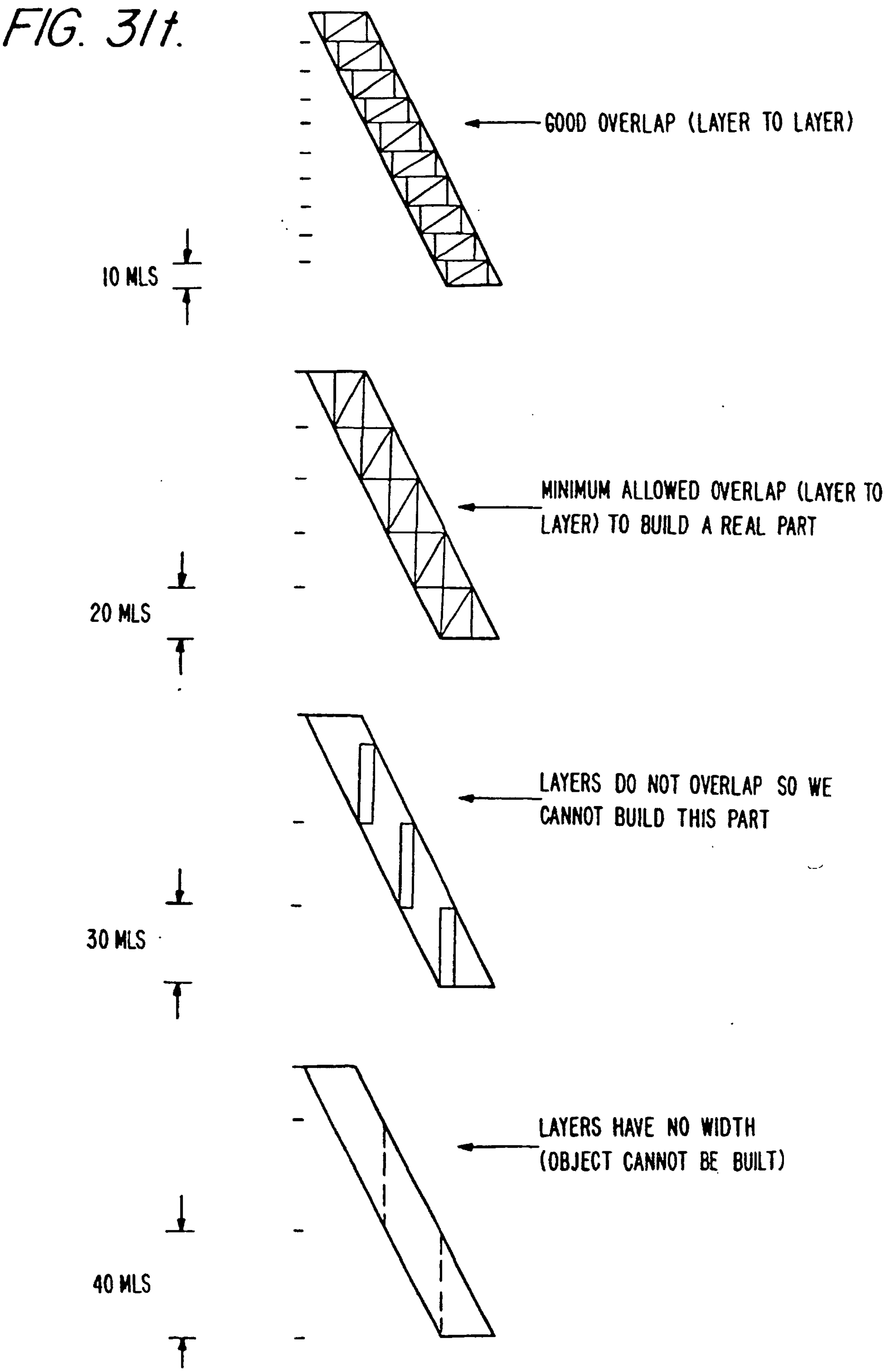
GOOD OVERLAP (LAYER TO LAYER)
10 MLS
MINIMUM ALLOWED OVERLAP (LAYER TO LAYER) TO BUILD A REAL PART
20 MLS
LAYERS DO NOT OVERLAP SO WE CANNOT BUILD THIS PART
30 MLS
LAYERS HAVE NO WIDTH (OBJECT CANNOT BE BUILT)
40 MLS

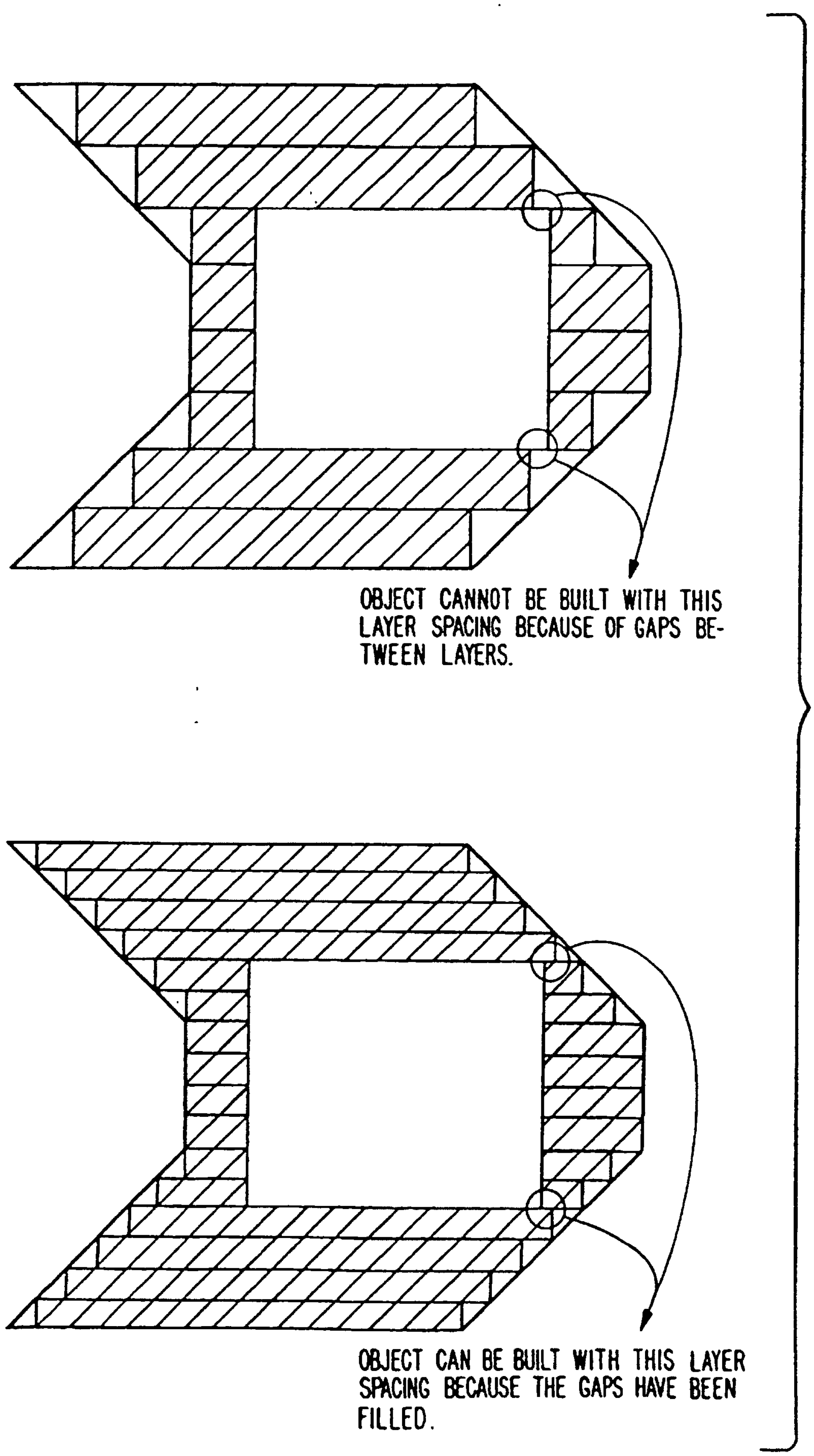
OBJECT CANNOT BE BUILT WITH THIS LAYER SPACING BECAUSE OF GAPS BETWEEN LAYERS.
OBJECT CAN BE BUILT WITH THIS LAYER SPACING BECAUSE THE GAPS HAVE BEEN FILLED.

FIG. 31u.

DESIRED BOUNDARIES

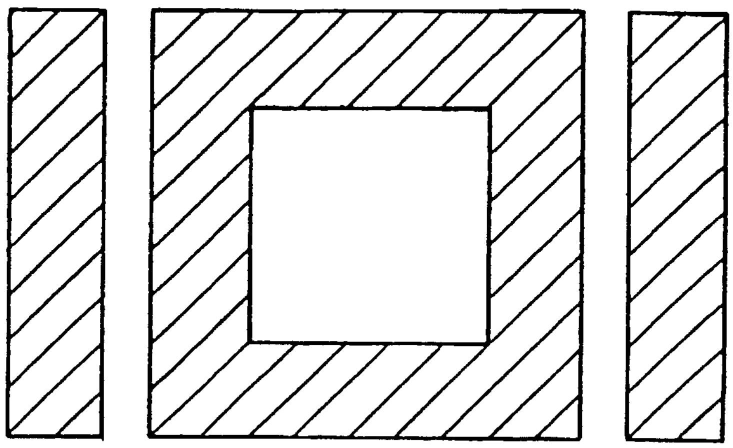

FIG. 32a.

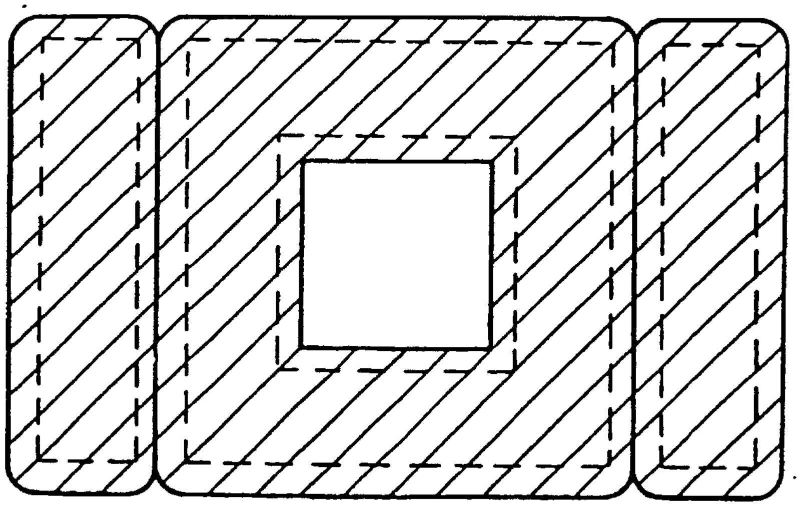

BOUNDARIES AFTER CURING WITHOUT CURE COMPENSATION

FIG. 32b.

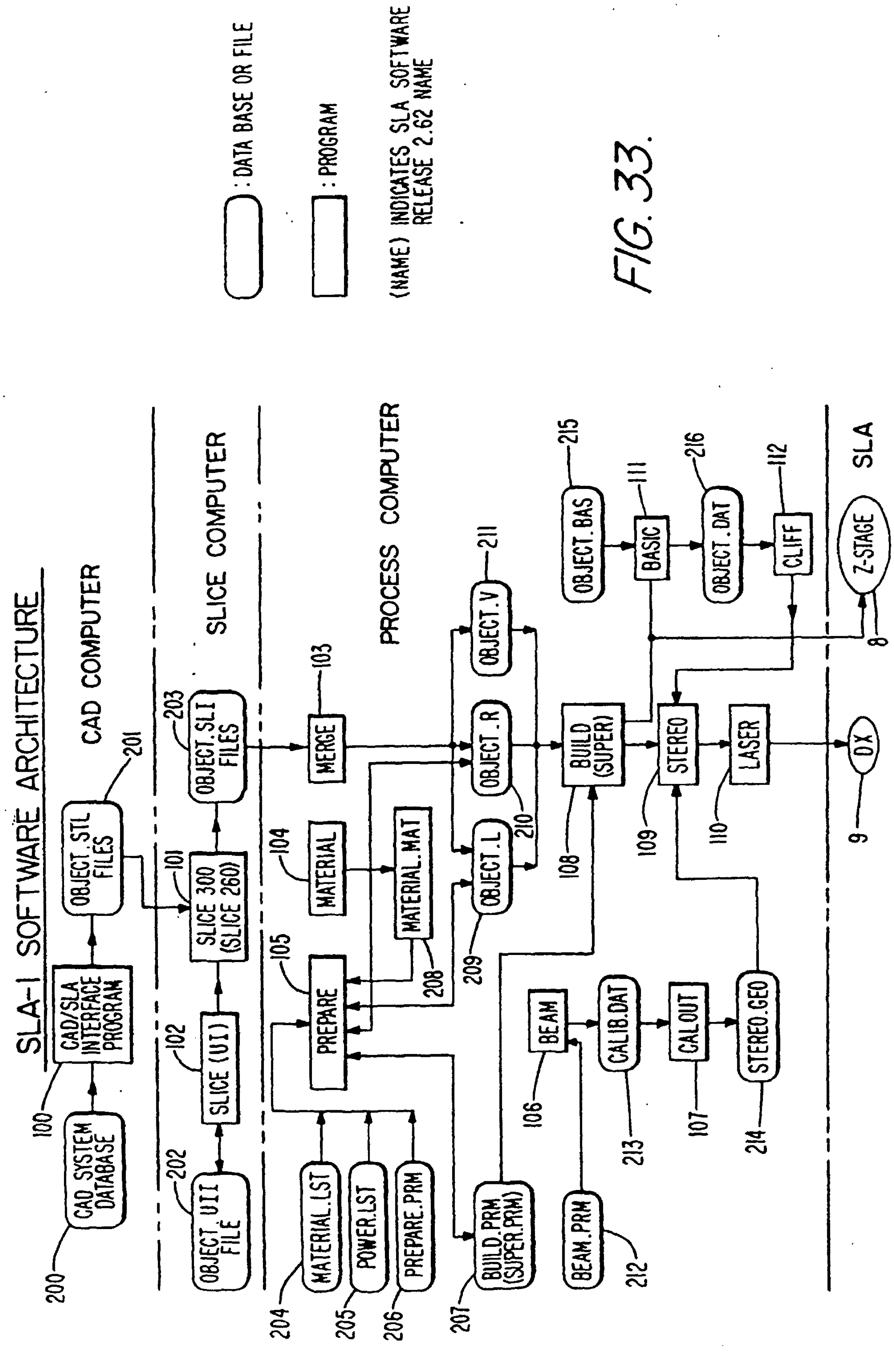
SLA-1 SOFTWARE ARCHITECTURE
CAD COMPUTER
SLICE COMPUTER
PROCESS COMPUTER
SLA
CAD SYSTEM DATABASE
CAD/SLA INTERFACE PROGRAM
OBJECT.STL FILES
OBJECT.UII FILE
SLICE (UI)
SLICE 300 (SLICE 260)
OBJECT.SLI FILES
MATERIAL.LST
POWER.LST
PREPARE.PRM
BUILD.PRM (SUPER.PRM)
PREPARE
MATERIAL
MATERIAL.MAT
MERGE
OBJECT.L
OBJECT.R
OBJECT.V
BUILD (SUPER)
BEAM.PRM
BEAM
CALIB.DAT
CALOUT
STEREO.GEO
STEREO
LASER
OBJECT.BAS
BASIC
OBJECT.DAT
CLIFF
Z-STAGE
DX
200
100
201
202
102
101
203
204
205
206
207
105
104
208
209
103
210
211
108
106
212
213
107
214
109
110
215
111
216
112
8
9
: DATA BASE OR FILE
: PROGRAM
(NAME) INDICATES SLA SOFTWARE RELEASE 2.62 NAME

FIG. 33.

VECTORS BEFORE COMPENSATION

FIG. 34a.

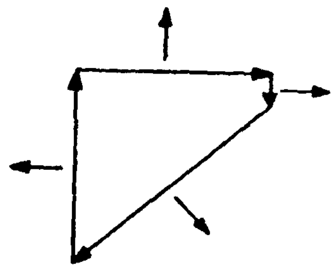

VECTORS AFTER COMPENSATION WITHOUT GUARDING AGAINST CROSSOVERS.

FIG. 34b.

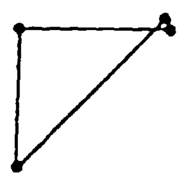

VECTORS AFTER COMPENSATION WITH GUARDING AGAINST CROSS-OVER.

FIG. 34c.

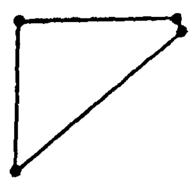

FIG. 34d.

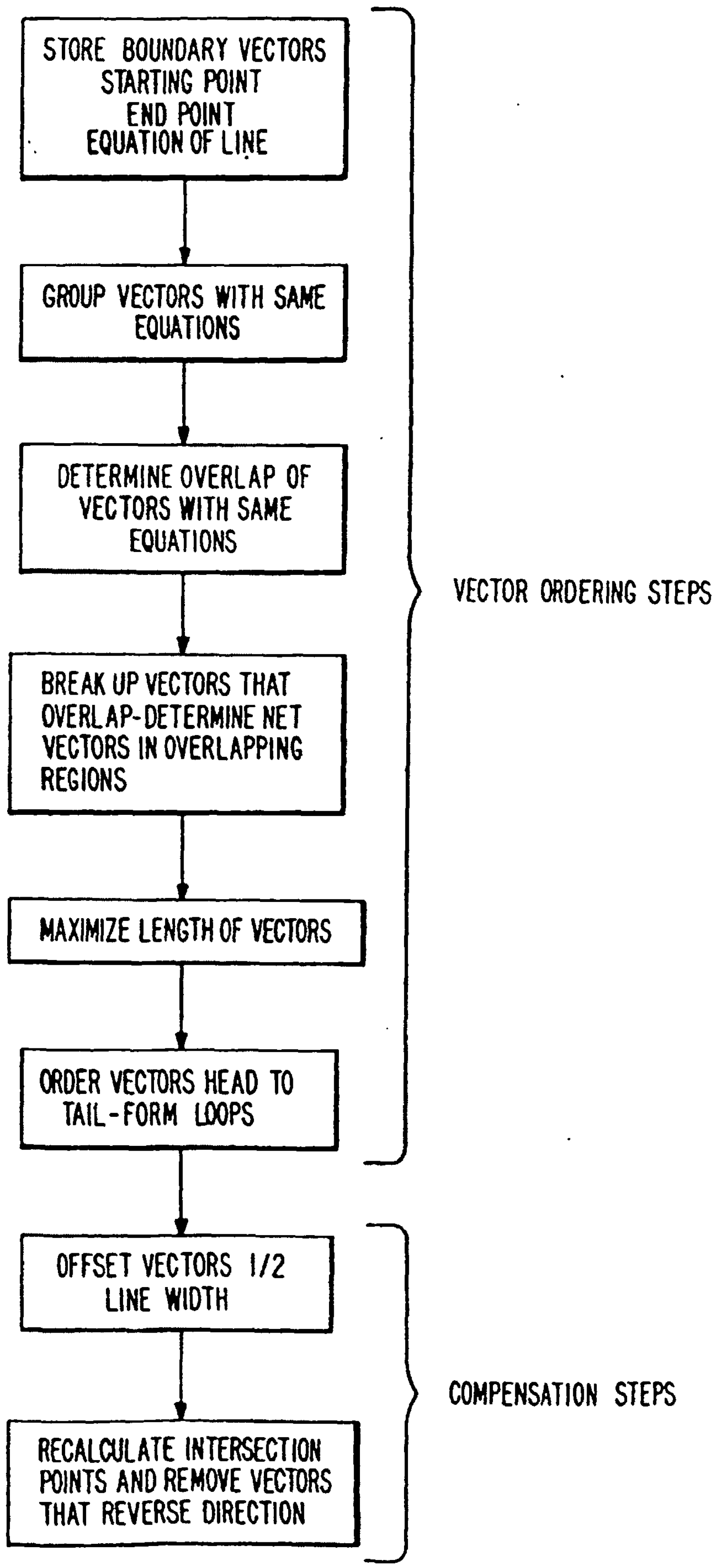
STORE BOUNDARY VECTORS
STARTING POINT
END POINT
EQUATION OF LINE
GROUP VECTORS WITH SAME EQUATIONS
DETERMINE OVERLAP OF VECTORS WITH SAME EQUATIONS
BREAK UP VECTORS THAT OVERLAP-DETERMINE NET VECTORS IN OVERLAPPING REGIONS
MAXIMIZE LENGTH OF VECTORS
ORDER VECTORS HEAD TO TAIL-FORM LOOPS
VECTOR ORDERING STEPS
OFFSET VECTORS 1/2 LINE WIDTH
RECALCULATE INTERSECTION POINTS AND REMOVE VECTORS THAT REVERSE DIRECTION
COMPENSATION STEPS

FIG. 34e.

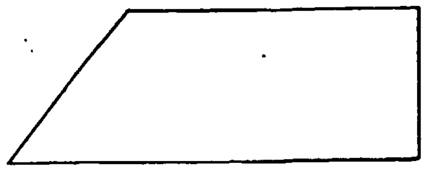


FIG. 34f.

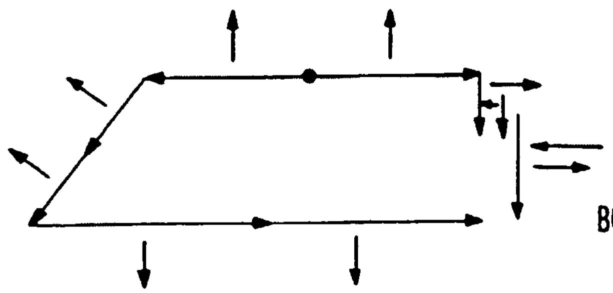


FIG. 34g.

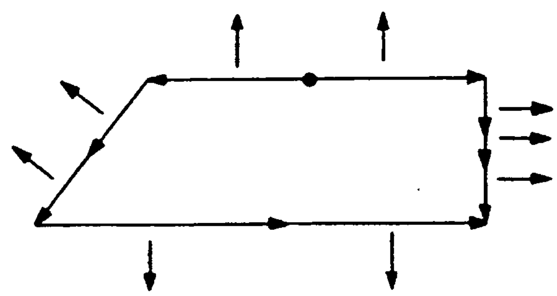


FIG. 34h.

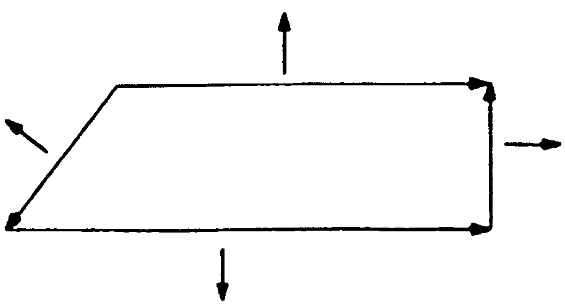

FIG.34i.

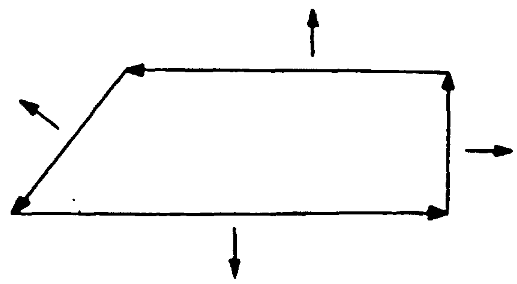

BOUNDARY OUTLINE AFTER ORDERING OF VECTORS.

FIG.34j.

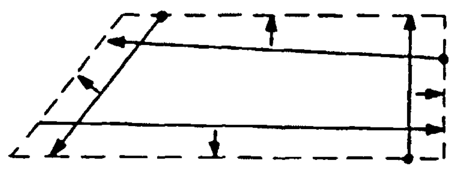

BOUNDARY OUTLINE AFTER OFFSETTING OF VECTORS.

FIG.34k.

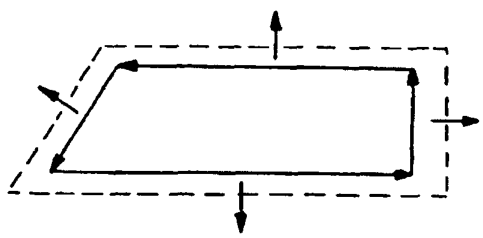

BOUNDARY AFTER RECALCULATION OF INTERSECTION POINTS.

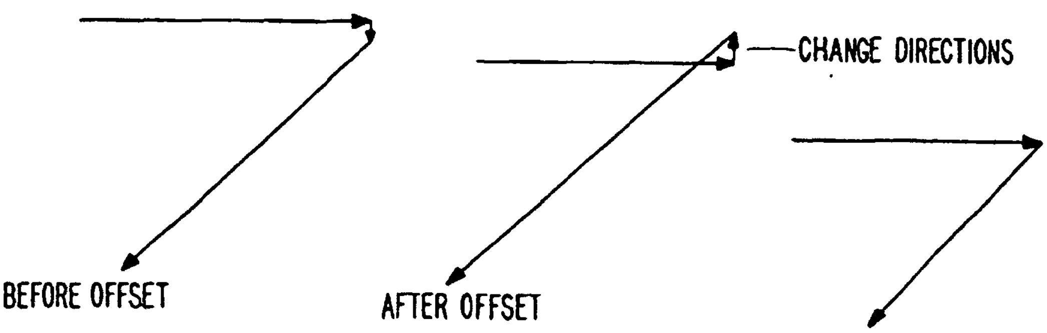


FIG.34L.

```
    ∇R←CURE A;C;DV;F;N;P;UDV
[1]
[2] ⍝ APPLY CURE COMPENSATION TO VERTICES OF A POLYGON
[3] ⍝ PROPRIETARY INFORMATION OF 3D SYSTEMS INC.
[4] ⍝ AUTHOR: DAVE REMBA    FEB. 1988
[5]
[6] ⍝ A        INPUT POLYGON MATRIX, ROWS ARE VERTICES, COLS ARE X Y COORS.
[7] ⍝ R        OUTPUT POLYGON MATRIX AFTER CURE COMPENSATION
[8]
[9] ⍝ INTERNAL VARIABLES:
[10] ⍝ P       PREVIOUS VECTOR TO EACH VERTEX
[11] ⍝ N       NEXT VECTOR FROM EACH VERTEX
[12] ⍝ UDV     UNIT DISPLACEMENT VECTOR FOR EACH VECTOR
[13]
[14] ⍝ FUNCTIONS CALLED:
[15] ⍝
[16] ⍝ A DOT B              RETURNS THE DOT PRODUCT OF VECTORS A AND B
[17] ⍝ SQRT(A)              RETURNS THE SQUARE ROOT OF A
[18] ⍝ UNIT(A)              RETURNS VECTOR A NORMALIZED (WITH UNIT LENGTH)
[19] ⍝ A CP B               RETURNS THE CROSS PRODUCT OF 2D VECTORS A AND B
[20]
[21] ⍝ DELETE COINCIDENT POINTS
[22]
[23]  P←(¯1⌽A) ⍝      ROTATE POINTS FORWARD 1 VERTEX
[24]  A←(∨/A≠P)/A ⍝     REMOVE POINTS EQUAL TO NEXT POINT
[25]
[26] ⍝ PREPARATION: COMPUTE P AND N
[27]
[28]  P←(¯1⌽A) ⍝       ROTATE POINTS FORWARD 1 VERTEX
[29]  N←(1⌽A) ⍝        ROTATE POINTS BACKWARD 1 VERTEX
[30]  P←P-A ⍝              CONVERT TO VECTOR
[31]  N←N-A ⍝              CONVERT TO VECTOR
[32]  P←UNIT(P) ⍝          NORMALIZE PREVIOUS VECTORS (SAVE FOR DOT)
[33]  N←UNIT(H) ⍝          NORMALIZE NEXT VECTORS (SAVE FOR DOT)
[34]
[35] ⍝ COMPUTE DISPLACEMENT VECTOR
[36]
[37]  DV←P+N ⍝             ADD PREVIOUS VECTORS TO NEXT VECTORS
[38]
[39] ⍝ DELETE NULL DISPLACEMENT VECTORS AND ASSOCIATED DATA
[40]
[41]  F←0≠NORM DV ⍝ SET DISPLACEMENT FLAG TRUE IF VECTOR IS >0
[42]  DV←F/DV ⍝            DELETE ZERO VECTORS
[43]  P←F/P ⍝              DELETE PREVIOUS POINTS
[44]  N←F/N ⍝              DELETE NEXT POINTS
[45]  A←F/A ⍝              DELETE POLYGON POINTS
[46]
[47] ⍝ NORMALIZE THE DISPLACEMENT VECTOR
[48]
[49]  UDV←UNIT(DV)
[50]
[51] ⍝ COMPUTE INSIDE OR OUTSIDE BY CROSS PRODUCT METHOD
[52]
```

*FIG. 35a.*

```
[54]
[55] ⍝ COMPUTE COMPENSATION FACTOR (VECTOR SCALING FACTOR)
[56]
[57]  C←F×BEAMRADIUS+SQRT(0.5×1-P DOT N)  ⍝ % IS DIVIDE
[58]
[59] ⍝ SCALE UDVs BY MULTIPLYING X AND Y COMPONENTS BY COMPENSATION FACTOR
[60]
[61]  C←C,[1.5]C ⍝      DUPLICATE SCALE FACTOR FOR X AND Y COMPONENTS OF UDVs
```

FIG. 35a'.

```
[62]  DV←UDV×C ⍝    SCALE UDVs
[63]
[64] ⍝ APPLY DISPLACEMENT VECTORS TO POLYGON VERTICES
[65]
[66]  R←A+DV
[67]
[68] ⍝ END
[69]
   ∇


   ∇ R←UNIT A;B
 [1] ⍝ NORMALIZE ROW VECTORS IN MATRIX A TO UNIT MAGNITUDE
 [2]  B←NORM A
 [3]  ⍎(0∊B)/'⎕SOUND 10 2⍴0 50 2000 100 ◊ ⎕ERROR ''UNIT ZERO!''◊R←⍬ ◊→'
 [4]
 [5]  R←A÷B,[1.5]B
 [6]
   ∇


   ∇ R←A CP B
 [1] ⍝ CROSS PRODUCT (FOR 2D VECTORS IN XY PLANE)
 [2]
 [3] ⍝ A      MATRIX OF ROW VECTORS
 [4] ⍝ B      MATRIX OF ROW VECTORS
 [5]
 [6]  R←(A[;1]×B[;2])-A[;2]×B[;1]
 [7]
   ∇
```

FIG. 35b.

```
   ∇ R←A DOT B
 [1] ⍝ CALCULATE THE DOT PRODUCT BETWEEN VECTORS A AND B
 [2]
 [3] ⍝ x1 x2 + y1 y2
 [4]  R←(A[;1]×B[;1])+A[;2]×B[;2]
 [5]
 [6] ⍝ | V1 | V2 |
 [7]  A←(NORM A)×NORM B ⍝  GENERAL FORM
 [8]
 [9] ⍝ HANDLE 0 CASE
[10]  ⍎(0∊A)/'R←0 ◊ ⎕SOUND 440 100 ◊ ⎕ERROR ''DOT ZERO!'' ◊ →0'
[11]
[12]  R←R÷A
   ∇


   ∇ R←NORM A
 [1] ⍝ CALCULATE THE NORM OF A VECTOR
 [2]
 [3] ⍝ ||v||=SQUARE-ROOT OF THE SUM OF SQUARES OF COMPONENTS
 [4]
 [5]  R←(+/A*2)*0.5
 [6]
   ∇
```

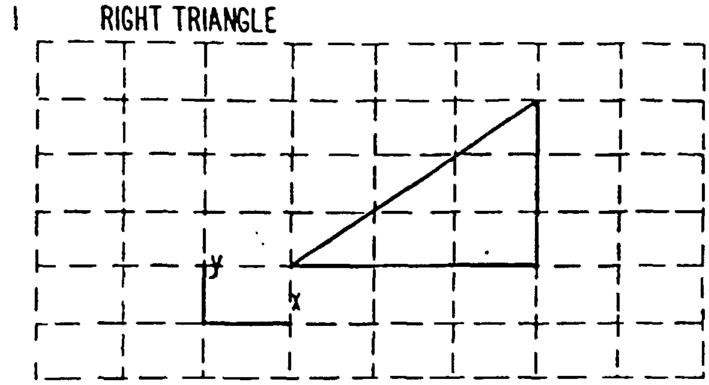


FIG. 36a.

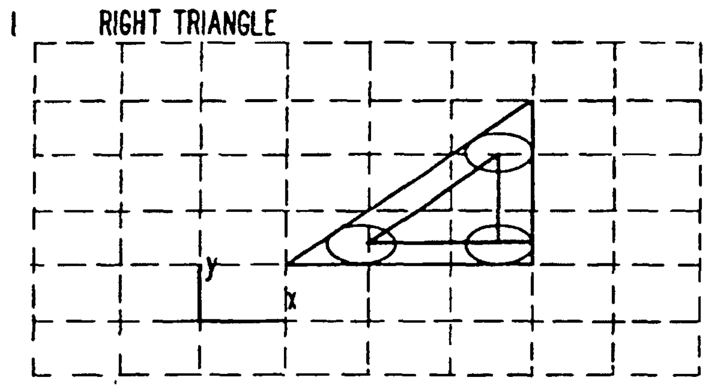


FIG. 36b.

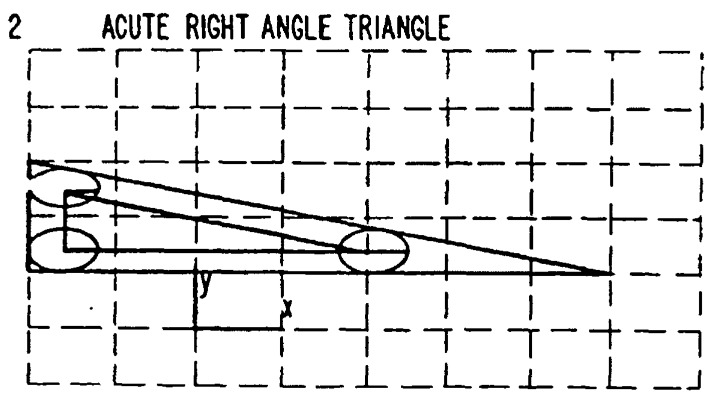


FIG. 36c.

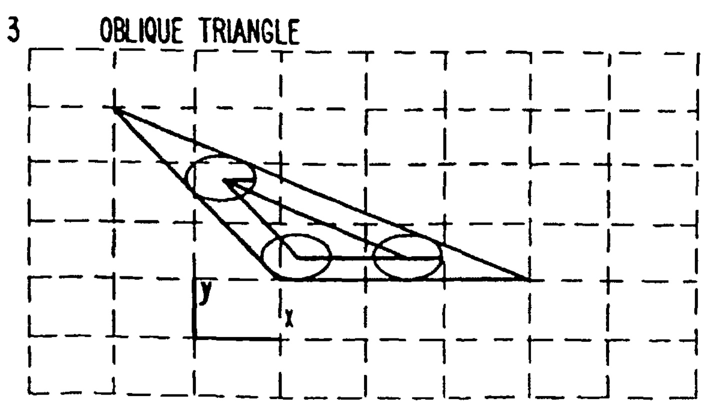


FIG. 36d.

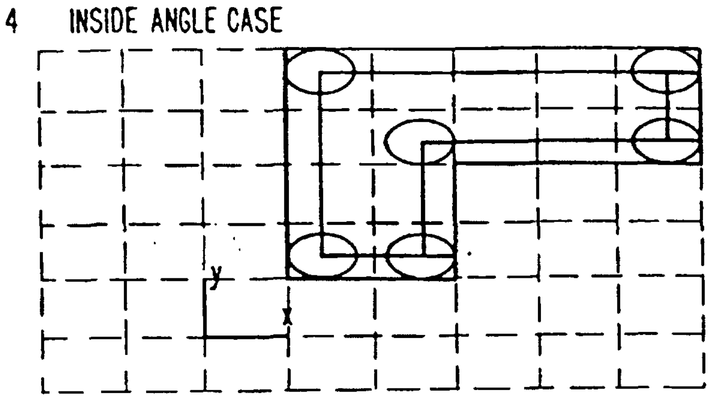


FIG. 36e.

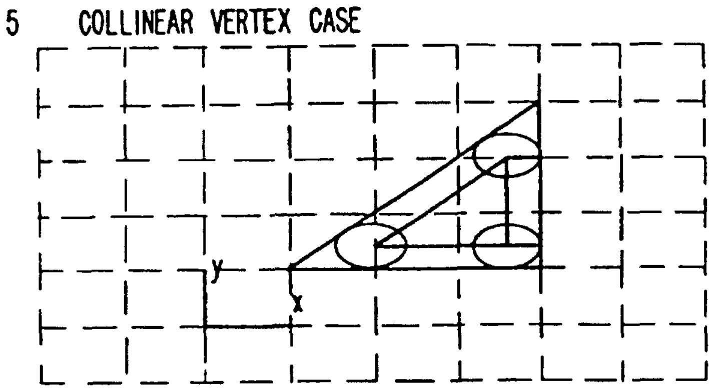


FIG. 36f.

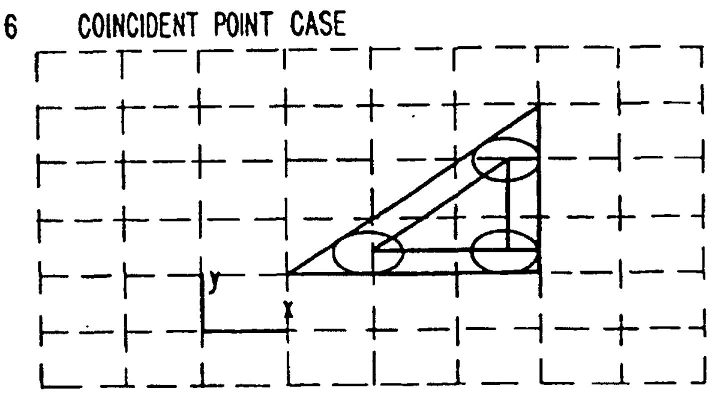


FIG. 36g.

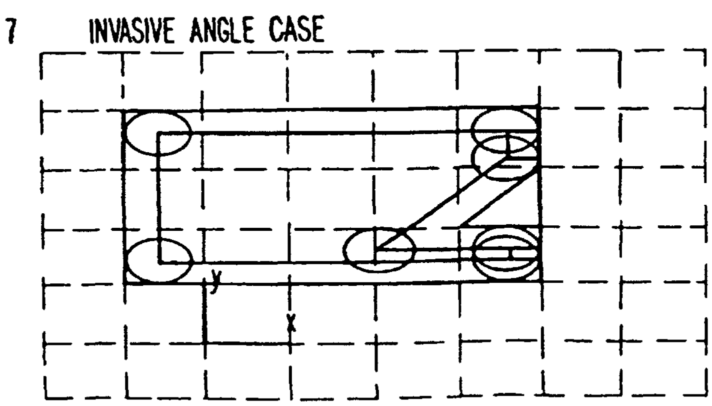


FIG. 36h.

8 COMPLEX POLYGON CASE

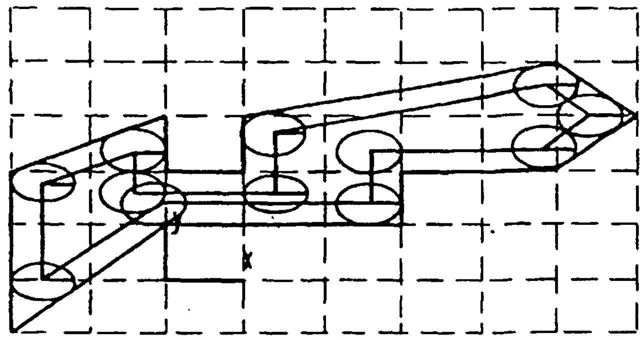


FIG. 36i.

9 WALLS

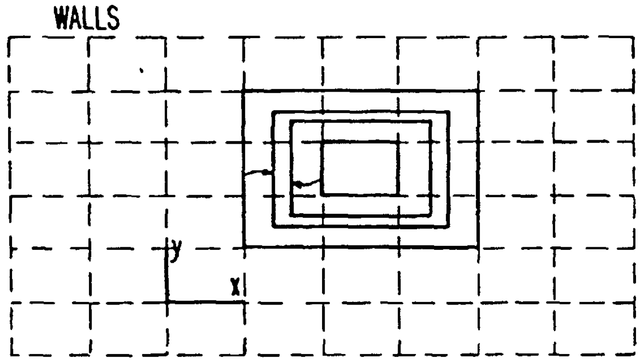


FIG. 36j.

10 ADJOINIG OUTER PERIMETERS

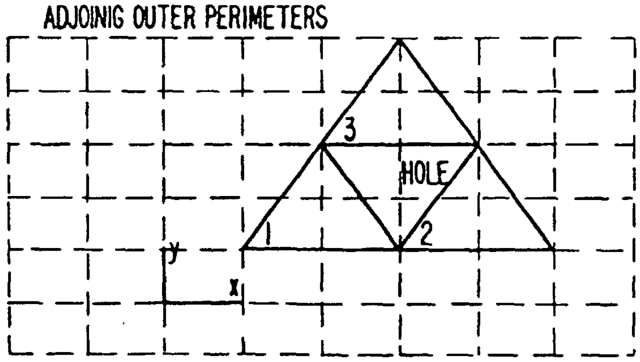


FIG. 36k.

10 CURED OUTER PERIMETERS

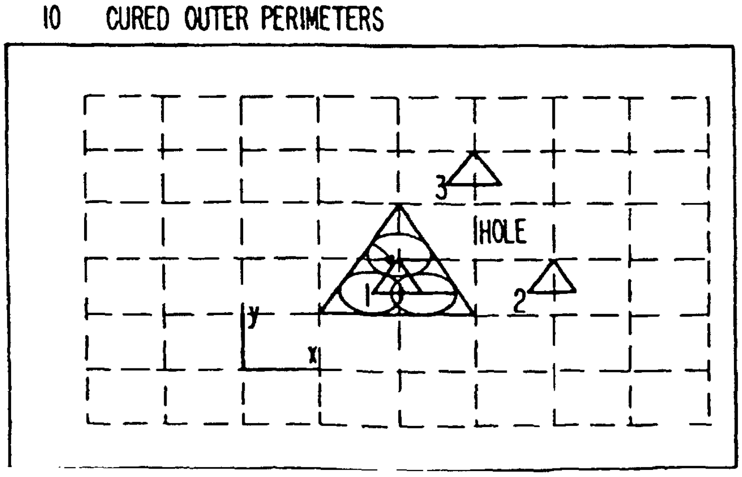


FIG. 36L.

# CURE COMPENSATION

## MATHEMATICAL DERIVATION:

GIVEN TWO VECTORS, $\vec{p}$ AND $\vec{n}$, SHARING ORIGIN POINT 0, OBTAIN A VECTOR $\vec{r}$ WHICH DISPLACES POINT 0 TO 0', i.e. $0' = \vec{r} + 0$.

THIS PROCEDURE IS APPLIED TO EACH VERTEX OF A POLYGONAL BOUNDARY. HERE WE SHALL DERIVE AN EXPRESSION TO CALCULATE $\vec{r}$ IN TERMS OF $\vec{p}$ AND $\vec{n}$.

VECTOR $\vec{p} = P - 0$ WHERE P IS THE PREVIOUS VERTEX.

VECTOR $\vec{n} = N - 0$ WHERE N IS THE NEXT VERTEX.

VECTORS ARE NORMALIZED:

$$\vec{p} = \frac{\vec{p}}{\|\vec{p}\|} \qquad \vec{n} = \frac{\vec{n}}{\|\vec{n}\|}$$

DELETE ANY VECTORS $\vec{p} = .0$ AND $\vec{n} = 0$

COMPUTE THE DISPLACEMENT VECTOR $\vec{d} = \vec{p} + \vec{n}$

NORMALIZE THE DISPLACEMENT VECTOR $\vec{d} = \frac{\vec{d}}{\|\vec{d}\|}$

*FIG. 37a.*

# CURE COMPENSATION

DETERMINE WHETHER ANGLE $\alpha$ BETWEEN $\vec{p}$ AND $\vec{n}$ IS GREATER THAN 180°.

$$f = \frac{\vec{p} \otimes \vec{n}}{\|\vec{p}\| \|\vec{n}\|} = \sin \alpha$$ CROSS PRODUCT

$f' = 1$ IF $f > 0$ $f' = -1$ IF $f < 0$

$c = f' \times \frac{b}{j}$ WHERE b IS THE LASER BEAM RADIUS AND j IS A COMPENSATION FACTOR.

DERIVATION OF j :

$$\cos \alpha = \frac{\vec{p} \cdot \vec{n}}{\|\vec{p}\| \|\vec{n}\|}$$ DOT PRODUCT

$$j = \sin \frac{\alpha}{2} = \pm \sqrt{\frac{1 - \cos \alpha}{2}}$$ HALF ANGLE FORMULA

SCALE THE NORMALIZED DISPLACEMENT VECTOR : $\vec{r} = c\vec{d}$

*FIG. 37b.*

# CURE COMPENSATION COMPUTATIONS

CROSS PRODUCT: $\vec{A} \times \vec{B} = (a2*b3-a3*b2)i+(a3*b1-a1*b3)j+(a1*b2-a2*b1)k$

DOT PRODUCT: $\vec{A} \cdot \vec{B} = a_1b_1+a_2b_2+a_3b_3$

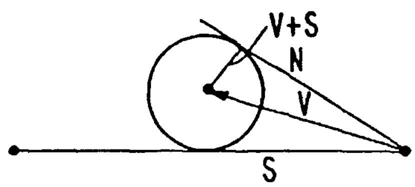


1. REMOVE POINT SEGS. (ALREADY DONE)
2. COMBINE "STRAIGHT" VECTORS (NOT NECESSARY BUT $\vec{S} \times \vec{N} = 0$ IF STRAIGHT)

| |
|---|
| LET S = CURRENT SEGMENT AS VECTOR (DISPLACE TO ORIG.)) NORMALIZED<br>LET N = NEXT SEGMENT AS VECTOR " " " NORMALIZED<br>LET V = DISPLACEMENT VECTOR<br>LET UV = UNIT DISPLACEMENT VECTOR |

3. $UV = -\left(\frac{\vec{S}+\vec{N}}{|\vec{S}+\vec{N}|}\right)$

$$|\vec{V}| = \frac{\text{BEAM RADIUS}}{\sqrt{\frac{1-(\vec{S}\cdot\vec{N})}{2}}}$$

IF $\vec{S}\cdot\vec{N} = 1$ THEN $|\vec{V}| \to \infty$

$$\boxed{\vec{V} = |\vec{V}|\,\vec{UV}}$$

IF $|\vec{V}|$ "TOO BIG" NEED TO DECIDE WHAT TO DO.
(COMPARE $|\vec{S}|$ OR $|\vec{N}|$, SET TO BEAM RADIUS, ETC.

NOTE: BEAM RADIUS IS CAD UNITS x RESOLUTION

*FIG. 37c.*

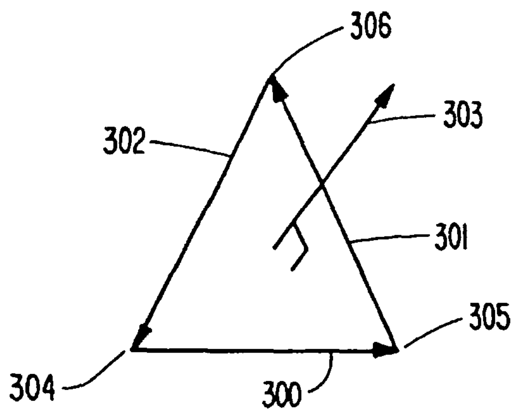


FIG. 38.

```
SOLID ASCII
  FACET NORMAL 0.000000e+00 1.000000e+00 0.000000e+00
    OUTER LOOP
      VERTEX 2.500001e-01 1.040000e+00 8.750000e+00
      VERTEX 8.750000e+00 1.040000e+00 8.750000e+00
      VERTEX 8.750000e+00 1.040000e+00 2.500001e-01
    ENDLOOP
  ENDFACET
  FACET NORMAL 0.000000e+00 1.000000e+00 0.000000e+00
    OUTER LOOP
      VERTEX 8.750000e+00 1.040000e+00 2.500001e-01
      VERTEX 2.500001e-01 1.040000e+00 2.500001e-01
      VERTEX 2.500001e-01 1.040000e+00 8.750000e+00
    ENDLOOP
  ENDFACET
  FACET NORMAL 0.000000e+00 0.000000e+00 1.000000e+00
    OUTER LOOP
      VERTEX 8.750000e+00 1.040000e+00 8.750000e+00
      VERTEX 2.500001e-01 1.040000e+00 8.750000e+00
      VERTEX 2.500001e-01 7.400000e-01 8.750000e+00
    ENDLOOP
  ENDFACET
  FACET NORMAL 0.000000e+00 0.000000e+00 1.000000e+00
    OUTER LOOP
      VERTEX 2.500001e-01 7.400000e-01 8.750000e+00
      VERTEX 8.750000e+00 7.400000e-01 8.750000e+00
      VERTEX 8.750000e+00 1.040000e+00 8.750000e+00
    ENDLOOP
  ENDFACET
  FACET NORMAL 1.000000e+00 0.000000e+00 0.000000e+00
    OUTER LOOP
      VERTEX 8.750000e+00 7.400000e-01 8.750000e+00
      VERTEX 8.750000e+00 7.400000e-01 2.500001e-01
      VERTEX 8.750000e+00 1.040000e+00 2.500001e-01
    ENDLOOP
  ENDFACET
  FACET NORMAL 1.000000e+00 0.000000e+00 0.000000e+00
    OUTER LOOP
      VERTEX 8.750000e+00 1.040000e+00 2.500001e-01
      VERTEX 8.750000e+00 1.040000e+00 8.750000e+00
      VERTEX 8.750000e+00 7.400000e-01 8.750000e+00
    ENDLOOP
  ENDFACET
  FACET NORMAL 0.000000e+00 0.000000e+00 -1.000000e+00
    OUTER LOOP
      VERTEX 2.500001e-01 7.400000e-01 2.500001e-01
      VERTEX 2.500001e-01 1.040000e+00 2.500001e-01
      VERTEX 8.750000e+00 1.040000e+00 2.500001e-01
    ENDLOOP
  ENDFACET
  FACET NORMAL 0.000000e+00 0.000000e+00 -1.000000e+00
    OUTER LOOP
      VERTEX 8.750000e+00 1.040000e+00 2.500001e-01
      VERTEX 8.750000e+00 7.400000e-01 2.500001e-01
```

FIG. 39.

```
    VERTEX   2.500001e-01   7.400000e-01   2.50000e-01
  ENDLOOP
ENDFACET
FACET NORMAL -1.000000e+00  0.000000e+00  0.000000e+00
  OUTER LOOP
    VERTEX   2.500001e-01   1.040000e+00  2.500001e-01
    VERTEX   2.500001e-01   7.400000e-01  2.500001e-01
    VERTEX   2.500001e-01   7.400000e-01  8.750000e+00
  ENDLOOP
ENDFACET
```

FIG. 39'.

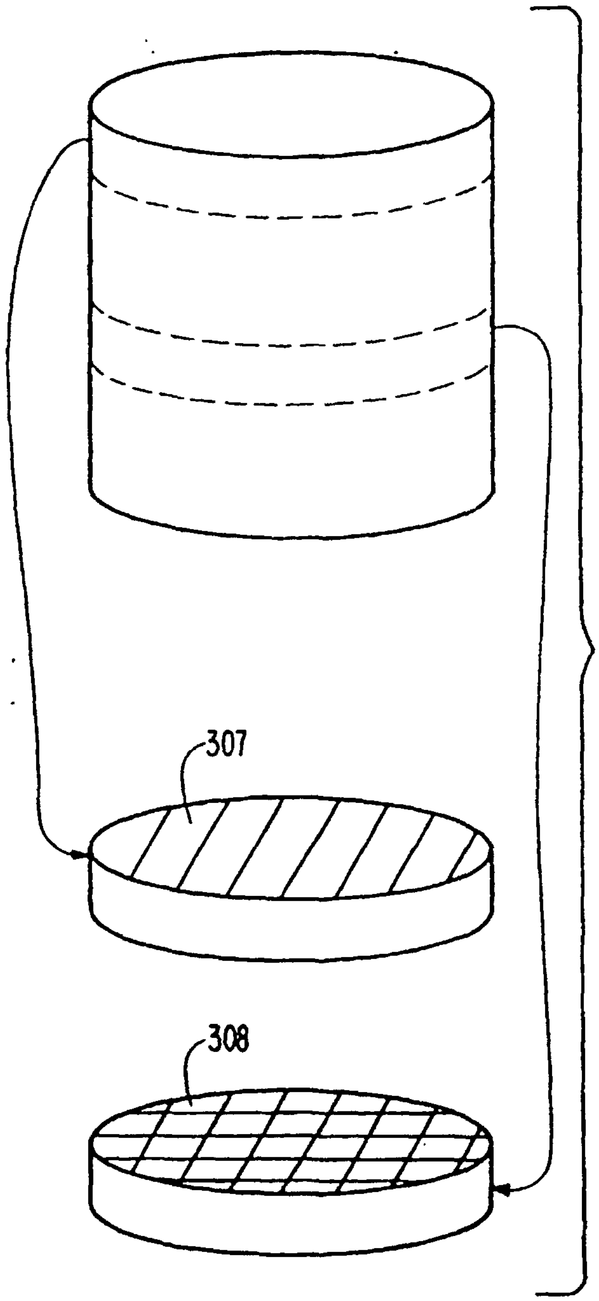


FIG. 40.

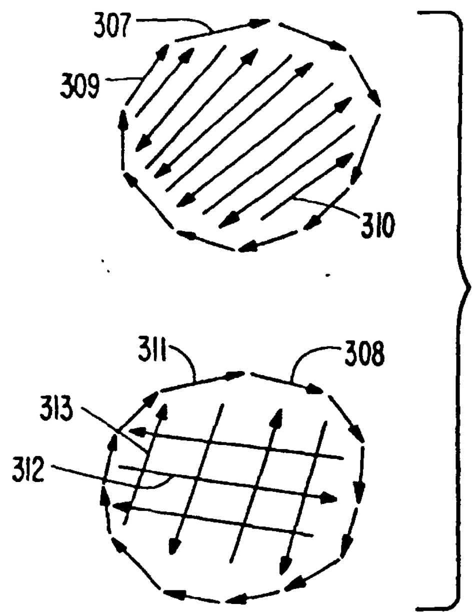
307
309
310
311
308
313
312

FIG. 41.

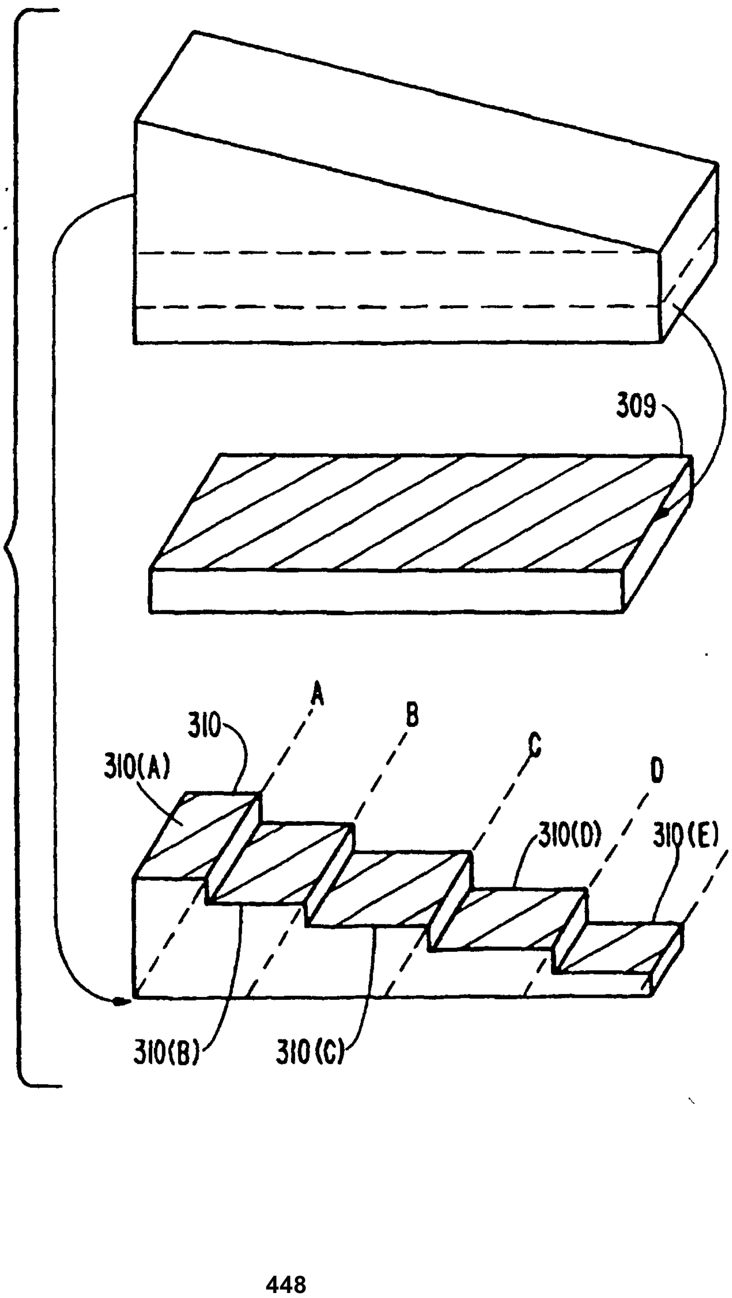
309
A
B
C
D
E
310
310(A)
310(D)
310(E)
310(B)
310(C)

FIG. 42.

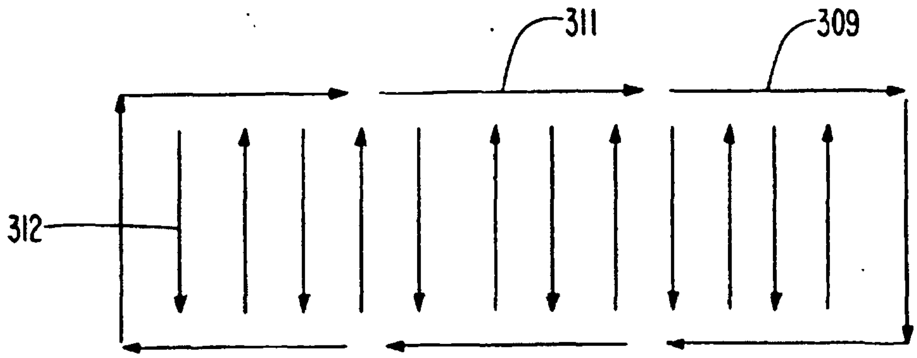


FIG. 43a.

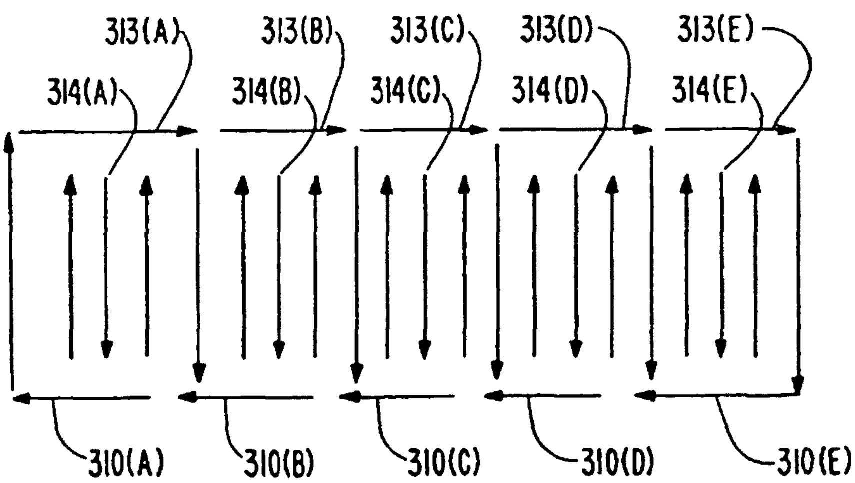


FIG. 43b.

—— SLICE USER INTERFACE ——

CURRENT OBJECT: BASE0412 VERSION 3.11

| OPTION | DESCRIPTION | CAD UNITS | | SLICE UNITS |
|---|---|---|---|---|
| (1) | DATABASE FILE NAME | BASE0412.STL (BINARY) | | |
| (2) | RESOLUTION | 1000.000 | | |
| (3) | LAYER THICKNESS | 0.020 | FIXED | 20 |
| (4) | X HATCH SPACING | 0.400 | | 400 |
| (5) | Y HATCH SPACING | 0.400 | | 400 |
| (6) | 60/120 DEGREE HATCH SPACING | 0.000 | | 0 |
| (7) | X SKIN FILL SPACING | 0.000 | | 0 |
| (8) | Y SKIN FILL SPACING | 0.000 | | 0 |
| (9) | MINIMUM SURFACE ANGLE FOR SCANNED FACETS | 0 | | |
| (10) | MINIMUM HATCH INTERSPECT ANGLE | 0 | | |
| (11) | SEGMENT OUTPUT FILE NAME | BASE412a.SLI | | |
| (Q) | QUIT, RETURN TO MAIN MENU | | | |

*FIG. 44a.*

L 740
LB

| | | | |
|---|---|---|---|
| 250 | 8750 | 8750 | 8750 |
| 8750 | 8750 | 8750 | 250 |
| 8750 | 250 | 250 | 250 |
| 250 | 250 | 250 | 8750 |

LH

| | | | |
|---|---|---|---|
| 8400 | 250 | 8400 | 8750 |
| 8000 | 8750 | 8000 | 250 |
| 7600 | 250 | 7600 | 8750 |
| 7200 | 8750 | 7200 | 250 |
| 6800 | 250 | 6800 | 8750 |
| 6400 | 8750 | 6400 | 250 |
| 6000 | 250 | 6000 | 8750 |
| 5600 | 8750 | 5600 | 250 |
| 5200 | 250 | 5200 | 8750 |
| 4800 | 8750 | 4800 | 250 |
| 4400 | 250 | 4400 | 8750 |
| 4000 | 8750 | 4000 | 250 |
| 3600 | 250 | 3600 | 8750 |
| 3200 | 8750 | 3200 | 250 |
| 2800 | 250 | 2800 | 8750 |
| 2400 | 8750 | 2400 | 250 |
| 2000 | 250 | 2000 | 8750 |
| 1600 | 8750 | 1600 | 250 |
| 1200 | 250 | 1200 | 8750 |
| 800 | 8750 | 800 | 250 |
| 400 | 250 | 400 | 8750 |
| 250 | 8400 | 8750 | 8400 |
| 8750 | 8000 | 250 | 8000 |
| 250 | 7600 | 8750 | 7600 |
| 8750 | 7200 | 250 | 7200 |
| 250 | 6800 | 8750 | 6800 |
| 8750 | 6400 | 250 | 6400 |
| 250 | 6000 | 8750 | 6000 |
| 8750 | 5600 | 250 | 5600 |
| 250 | 5200 | 8750 | 5200 |
| 8750 | 4800 | 250 | 4800 |
| 250 | 4400 | 8750 | 4400 |
| 8750 | 4000 | 250 | 4000 |
| 250 | 3600 | 8750 | 3600 |
| 8750 | 3200 | 250 | 3200 |
| 250 | 2800 | 8750 | 2800 |
| 8750 | 2400 | 250 | 2400 |
| 250 | 2000 | 8750 | 2000 |
| 8750 | 1600 | 250 | 1600 |
| 250 | 1200 | 8750 | 1200 |
| 8750 | 800 | 250 | 800 |
| 250 | 400 | 8750 | 400 |

L 760
LB

| | | | |
|---|---|---|---|
| 250 | 8750 | 8750 | 8750 |
| 8750 | 8750 | 8750 | 250 |
| 8750 | 250 | 250 | 250 |
| 250 | 250 | 250 | 8750 |

LH

| | | | |
|---|---|---|---|
| 8400 | 250 | 8400 | 8750 |
| 8000 | 8750 | 8000 | 250 |
| 7600 | 250 | 7600 | 8750 |
| 7200 | 8750 | 7200 | 250 |
| 6800 | 250 | 6800 | 8750 |
| 6400 | 8750 | 6400 | 250 |
| 6000 | 250 | 6000 | 8750 |
| 5600 | 8750 | 5600 | 250 |
| 5200 | 250 | 5200 | 8750 |
| 4800 | 8750 | 4800 | 250 |
| 4400 | 250 | 4400 | 8750 |
| 4000 | 8750 | 4000 | 250 |
| 3600 | 250 | 3600 | 8750 |
| 3200 | 8750 | 3200 | 250 |
| 2800 | 250 | 2800 | 8750 |
| 2400 | 8750 | 2400 | 250 |
| 2000 | 250 | 2000 | 8750 |
| 1600 | 8750 | 1600 | 250 |

FIG. 44b.

L1,740
LBI,740
250 8750 8750 8750
8750 8750 8750 250
8750 250 250 250
250 250 250 8750
LHI,740
8400 250 8400 8750
8000 8750 8000 250
7600 250 7600 8750
7200 8750 7200 250
6800 250 6800 8750
6400 8750 6400 250
6000 250 6000 8750
5600 8750 5600 250
5200 250 5200 8750
4800 8750 4800 250
4400 250 4400 8750
4000 8750 4000 250
3600 250 3600 8750
3200 8750 3200 250
2800 250 2800 8750
2400 8750 2400 250
2000 250 2000 8750
1600 8750 1600 250
1200 250 1200 8750
800 8750 800 250
400 250 400 8750
250 8400 8750 8400
8750 8000 250 8000
250 7600 8750 7600
8750 7200 250 7200
250 6800 8750 6800
8750 6400 250 6400
250 6000 8750 6000
8750 5600 250 5600
250 5200 8750 5200
8750 4800 250 4800
250 4400 8750 4400
8750 4000 250 4000
250 3600 8750 3600
8750 3200 250 3200
250 2800 8750 2800
8750 2400 250 2400
250 2000 8750 2000
8750 1600 250 1600
250 1200 8750 1200
8750 800 250 800
250 400 8750 400
L1,760
LBI,760
250 8750 8750 8750
8750 8750 8750 250
8750 250 250 250
250 250 250 8750
LHI,760
8400 250 8400 8750
8000 8750 8000 250
7600 250 7600 8750
7200 8750 7200 250
6800 250 6800 8750
6400 8750 6400 250
6000 250 6000 8750
5600 8750 5600 250

FIG. 45.

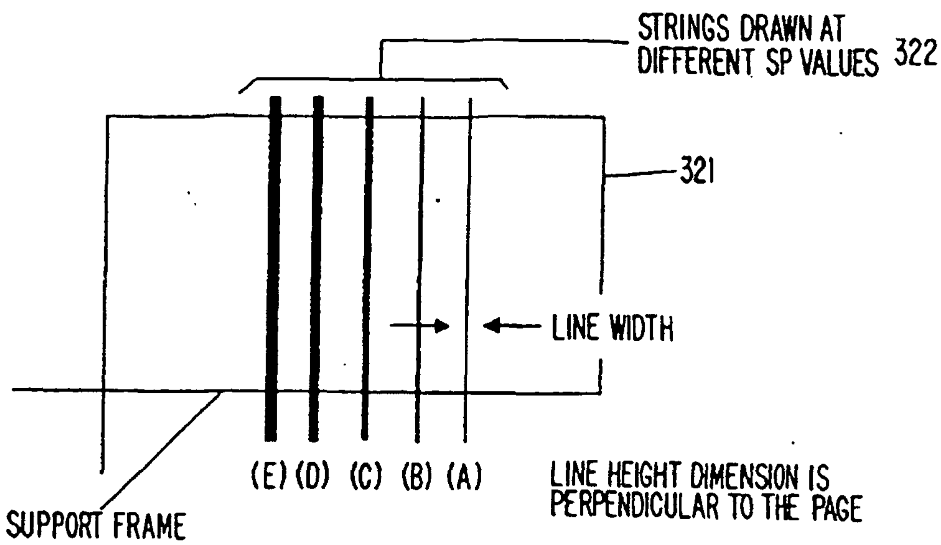
STRINGS DRAWN AT DIFFERENT SP VALUES 322
321
LINE WIDTH
(E) (D) (C) (B) (A)
LINE HEIGHT DIMENSION IS PERPENDICULAR TO THE PAGE
SUPPORT FRAME

FIG. 46.

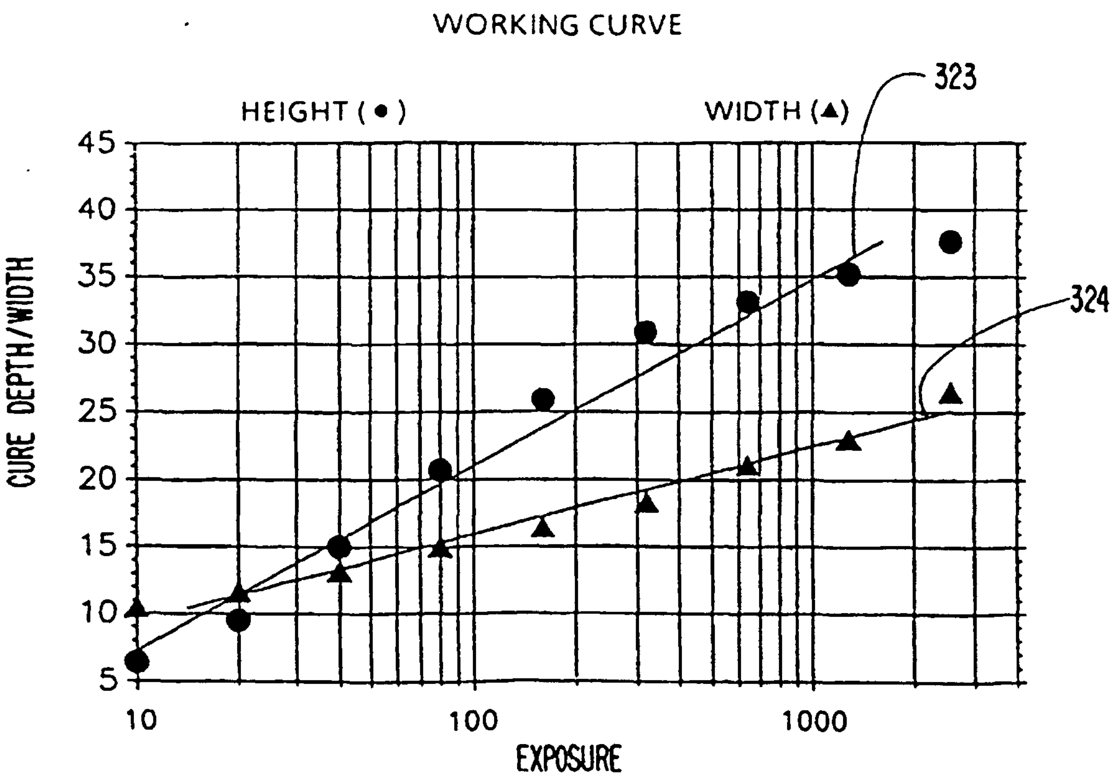
WORKING CURVE
HEIGHT (●)
WIDTH (▲)
323
324
CURE DEPTH/WIDTH
45
40
35
30
25
20
15
10
5
10
100
1000
EXPOSURE

FIG. 47.

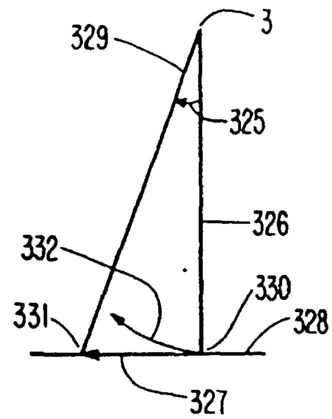
3
329
325
326
332
330
331
328
327

FIG. 48.

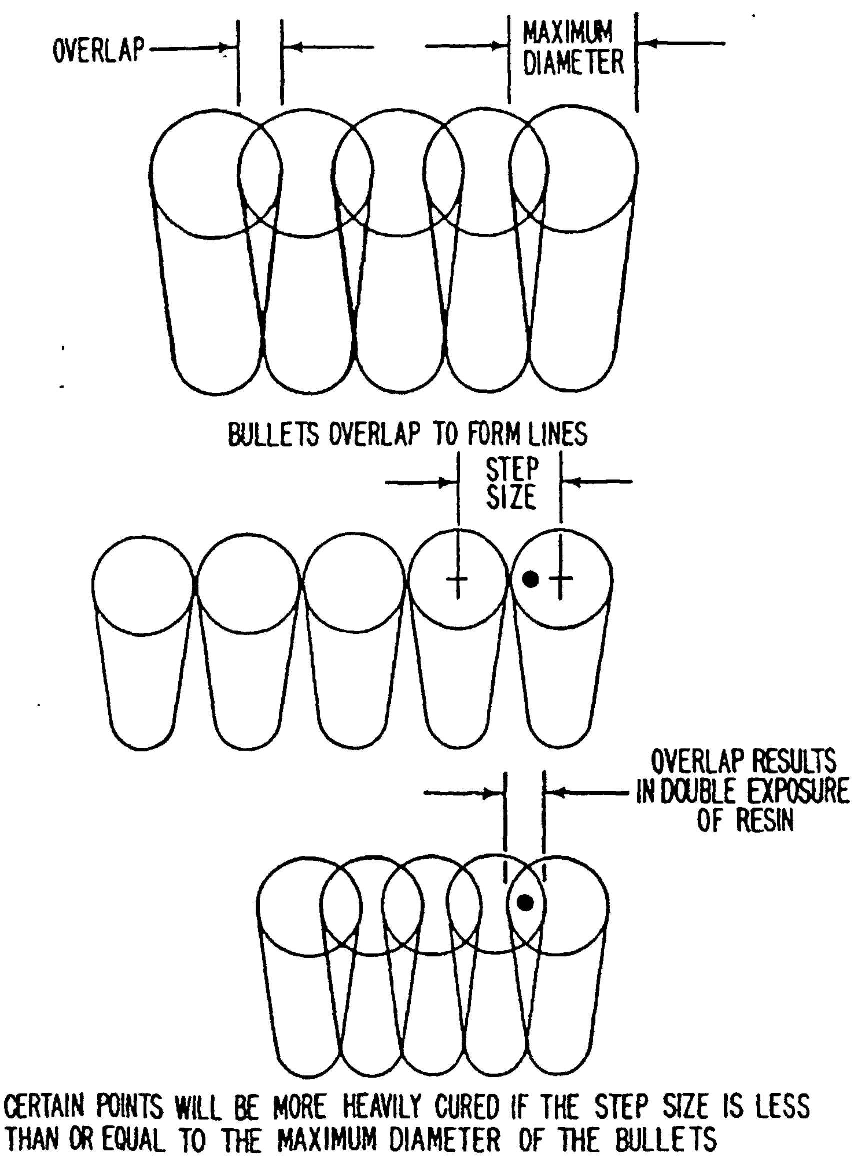
OVERLAP
MAXIMUM DIAMETER
BULLETS OVERLAP TO FORM LINES
STEP SIZE
OVERLAP RESULTS IN DOUBLE EXPOSURE OF RESIN
CERTAIN POINTS WILL BE MORE HEAVILY CURED IF THE STEP SIZE IS LESS THAN OR EQUAL TO THE MAXIMUM DIAMETER OF THE BULLETS

FIG. 49.

RANGE - CALC SP
PREPARE V3.05
WORKING ON FILE PATENT2.R

FIG. 50a.

LASER POWER READING: 16.2 mW
USING WORKING CURVE DATA FROM MATERIAL FILE: 9-16HC07.MAT

DDDDDDDyDDDDDDDDDyDDDDDDDyDDDDDDDDDyDDDDDDDyDDDDDDDDyDDDDDDDyDDDDDDD

| RANGE | Z-START | Z-END | Z-SPACE | DEPTH | EST SP | W MIN | W MAX |
|---|---|---|---|---|---|---|---|
| 1 | 740 | 760 | 20 | 20 | 25 | 0.0 | 0.0 |
| 2 | 780 | 1020 | 20 | 20 | 25 | 0.0 | 0.0 |

DDDDDDDyDDDDDDDDDyDDDDDDDyDDDDDDDDDyDDDDDDDyDDDDDDDDyDDDDDDDyDDDDDDD

PRESS:

R—READ MATERIAL DATA
P—CHANGE POWER RATING
V—VIEW MATERIAL DATA
X—EXIT
S—SAVE NEW RANGE COMMANDS
E—EDIT CURE DEPTH/STEP PERIOD
Q—QUIT PROGRAM

DATA FROM MATERIAL FILE: 9-16HC07.MAT

FIG. 50b.

MATERIAL TEST LASER POWER READING: 15.20

5 MATERIAL DATA PAIRS:

| | | | | |
|---|---|---|---|---|
| 1 | SP = 160.00 | LH = 32.00 | WMIN = 0.00 | WMAX = 0.00 |
| 2 | SP = 80.00 | LH = 28.00 | WMIN = 0.00 | WMAX = 0.00 |
| 3 | SP = 40.00 | LH = 23.50 | WMIN = 0.00 | WMAX = 0.00 |
| 4 | SP = 20.00 | LH = 18.50 | WMIN = 0.00 | WMAX = 0.00 |
| 5 | SP = 10.00 | LH = 12.50 | WMIN = 0.00 | WMAX = 0.00 |

| | | | |
|---|---|---|---|
| LH: | SLOPE = 16.11 | Y-INTERCEPT = -2.92 | R-VALUE = 1.00 |
| WMIN: | SLOPE = 0.00 | Y-INTERCEPT = 0.00 | R-VALUE = 0.00 |
| WMAX: | SLOPE = 0.00 | Y-INTERCEPT = 0.00 | R-VALUE = 0.00 |

```
PREPARE  REPORT  FOR  PATENT2.L                                        10-14-1988   16:35:05

RANGE    Z-START    Z-END    Z-SPACE    CAD-START    CAD-END    CAD-SPACE    COUNT
  1        740       760        20        0.740        0.760       0.020         2
         ---------------------------------------------------------------------------
           BLOCK  1  TYPE  #TOP
           BLOCK  2  TYPE  LI
           BLOCK  3  TYPE  LBI     COMMANDS:    "SP 212;SS 2"
           BLOCK  4  TYPE  LHI     COMMANDS:    "SP 212;SS 2"
           BLOCK  5  TYPE  #BTM
------------------------------------------------------------------------------------
  2        780      1020        20        0.780        1.020       0.020        13
         ---------------------------------------------------------------------------
           BLOCK  1  TYPE  #TOP
           BLOCK  2  TYPE  LI
           BLOCK  3  TYPE  LBI     COMMANDS:    "SP 58;SS 2"
           BLOCK  4  TYPE  LHI     COMMANDS:    "SP 58;SS 2"
           BLOCK  5  TYPE  #BTM
------------------------------------------------------------------------------------
```

FIG. 50c.

```
! MERGE: -FILES BASE412A
! MERGE: -STARTLAYER 740   -ENDLAYER 1020   -NUMLAYERS 15
! MERGE: -MIN X      250   -MAX X     8750
! MERGE: -MIN Y      250   -MAX Y     8750
! 3DSYS SLA-1 SLICE FILE
! SLICE= -VER 3.11 -RES 1000.000000  -HX 400  -HY 400  -HFX 0  -HFY 0  -HA 0   -MSA 0  -M
IA 0 -ZS 20 -Y -B
* 1000.000,20.000,0.508
740,#TOP
740,LI
740,LBI
740,LHI
740,#BTM
760,#TOP
760,LI
760,LBI
760,LHI
760,#BTM
780,#TOP
780,LI
780,LBI
780,LHI
780,#BTM
800,#TOP
800,LI
800,LBI
800,LHI
800,#BTM
820,#TOP
820,LI
820,LBI
820,LHI
820,#BTM
840,#TOP
840,LI
840,LBI
840,LHI
840,#BTM
860,#TOP
860,LI
860,LBI
860,LHI
860,#BTM
880,#TOP
880,LI
880,LBI
880,LHI
880,#BTM
900,#TOP
900,LI
900,LBI
900,LHI
900,#BTM
920,#TOP
920,LI
920,LBI
920,LHI
920,#BTM
940,#TOP
940,LI
940,LBI
940,LHI
940,#BTM
960,#TOP
```

FIG. 50d.

FIG. 51.

```
!
! BUILD PARAMETER FILE
! VERSION 3.00
!
! LAST ALTERED:   4/26/88
!
! DEFAULT SUPER OPTIONS
!
! PLACE OPTIONS TOGETHER INSIDE OF QUOTES; USE " " IF NO OPTIONS
!
""


!
! GENERAL PARAMETERS
!
800      ELEVATOR BOARD BASE ADDRESS
100      ELEVATOR PITCH PARM
3.5559   XY-ONLY SCALE FACTOR; USE 3.556 FOR INCHES AND SLICE RES=1000
10000 !27000        X-COORDINATE OFFSETS
2000 !27000         Y-COORDINATE OFFSETS
5000     MAX NUMBER OF BYTES PER BLOCK IN LASER QUEUE
16384,16384  MINIMUM X AND Y OF VAT AREA (FOR GRAPHICS VIEWPORT)
49152,49152  MAXIMUM X AND Y OF VAT AREA
!
!  -BLOCK DEFAULTS-
!
! EACH TIME THE BUILD PROGRAM STARTS A BLOCK, THE RESPECTIVE DEFAULT STRING BELOW IS SENT
! TO THE STEREO DRIVER. LB, NFDB, ... ARE THE BLOCK TYPES (LAYER BORDER, NEAR-FLAT DOWN
! BORDER, ETC.) AND THEY ARE FOLLOWED BY THE MERGE INPUT FILE NUMBER (E.G. 1 MAY BE FOR
! POST VECTORS AND 2 FOR OBJECT VECTORS). ALTHOUGH ONLY DEFAULTS FOR 2 FILES ARE SET
! FOR HERE, UP TO 10 FILES ARE SUPPORTED.
!
#TOP,"DC+"                    !FORCE DRIFT CORRECTION ON
!
!  FILE #1
!
LB1, "RD 1;RS 300;RC 1;       !REDRAW DELAY, SIZE, COUNT
      SP 176;                 !STEP PERIOD
      JD 0;                   !JUMP DELAY
      SS 1"                   !STEP SIZE
NFDB1,"RD 1;RS 300;RC 1;SP 176; JD 0;SS 1"
NFUB1,"RC 1;SP 100;SS 2;JD 0"
LH1, "RC 1; SP 176; JD 0; SS 2;
      VC 5;                   !RIVET COUNT
      VR 99;                  !RIVET REDUCTION AMOUNT
      VP 11,12,13,14,15"      !RIVET STEP PERIODS
NFDH1,"RC 1;SP 176;JD 0;SS 2;VC 5;VR 99;VP 11,12,13,14,15"
FDF1,"RC 1;SP 25;JD 0;SS 16"
NFDF1,"RC 1;SP 25;JD 0;SS 16"
NFUF1,"RC 1;SP 25;JD 0;SS 16"
FUF1,"RC 1;SP 25;JD 0;SS 16"
```

```
!
!  FILE #2
!
LB2,"RD 1;RS 300;RC 1;SP 352;JD 0;SS 2"
NFDB2,"RD 1;RS 300;RC 1;SP 352;JD 0;SS 2"
NFUB2,"RD 1;RS 300;RC 1;SP 100;JD 0;SS 2"
LH2,"RC 1;SP 352;JD 0;SS 2;VC 5;VR 99;VP 11,12,13,14,15"
NFDH2,"RC 1;SP 352;JD 0;SS 2;VC 5;VR 99;VP 11,12,13,14,15"
FDF2,"RC 1;SP 100;JD 0;SS 16"
NFDF2,"RC 1;SP 100;JD 0;SS 16"
NFUF2,"RC 1;SP 100;JD 0;SS 16"
FUF2,"RC 1;SP 100;JD 0;SS 16"

#BTM,"ZW 5;              ! Z-AXIS WAIT TIME IN SECONDS
      ZD 8;              ! Z-AXIS DIP DEPTH IN mm
      ZV 0.5;            ! Z-AXIS VELOCITY PARAMETER
      ZA 0.5"            ! Z-AXIS ACCELERATION PARAMETER
```

FIG. 51'.

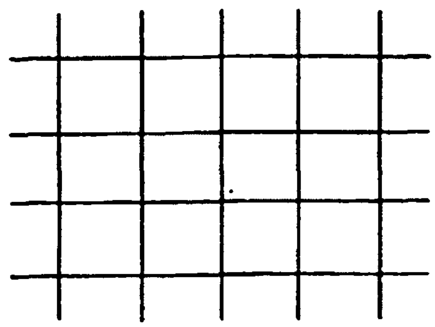

FIG. 52a.

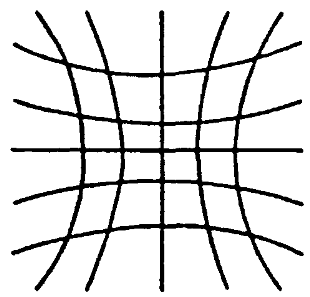

FIG. 52b.

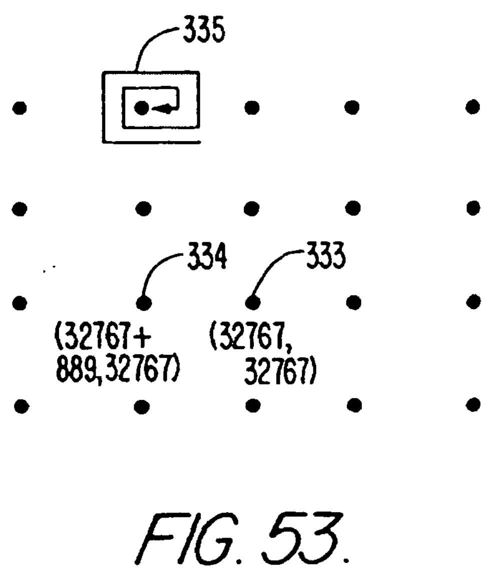


FIG. 53.

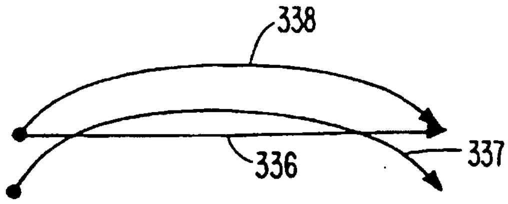


FIG. 54a.

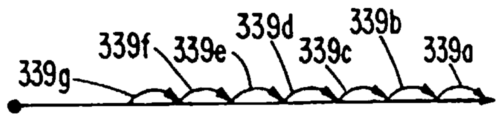


FIG. 54b.

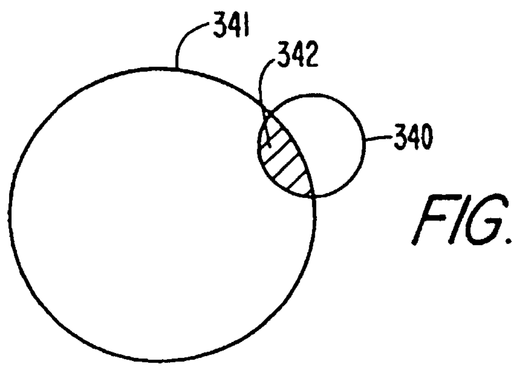


FIG. 55.

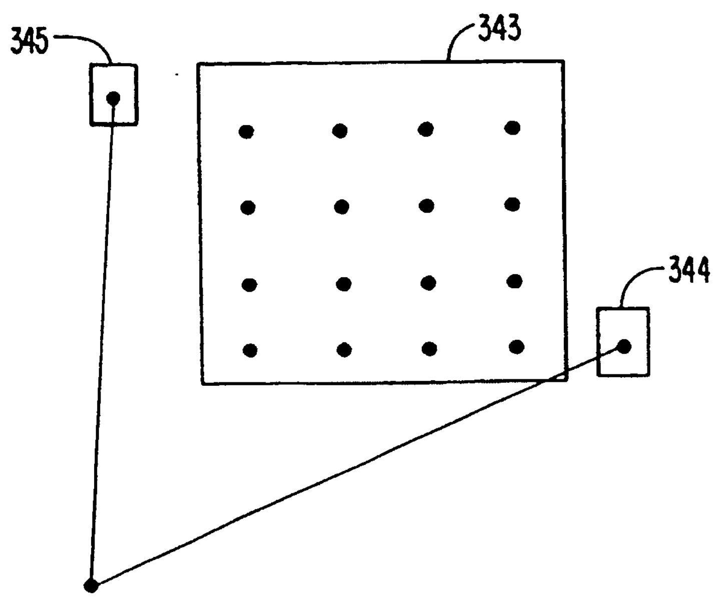


FIG. 56.

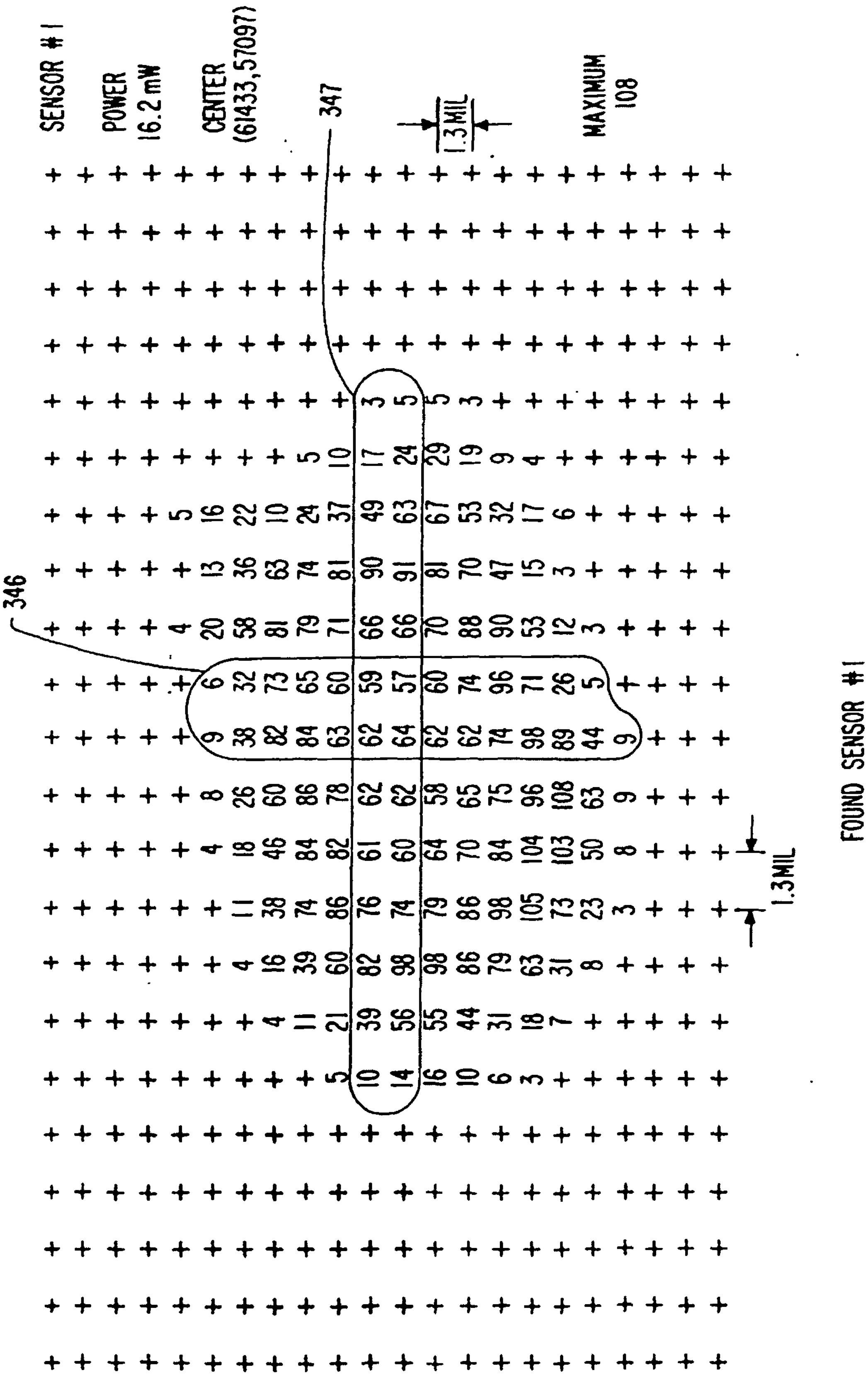
SENSOR # 1
POWER
16.2 mW
CENTER
(61433,57097)
347
1.3MIL
MAXIMUM
108
346
1.3MIL
FOUND SENSOR #1

FIG. 57a.

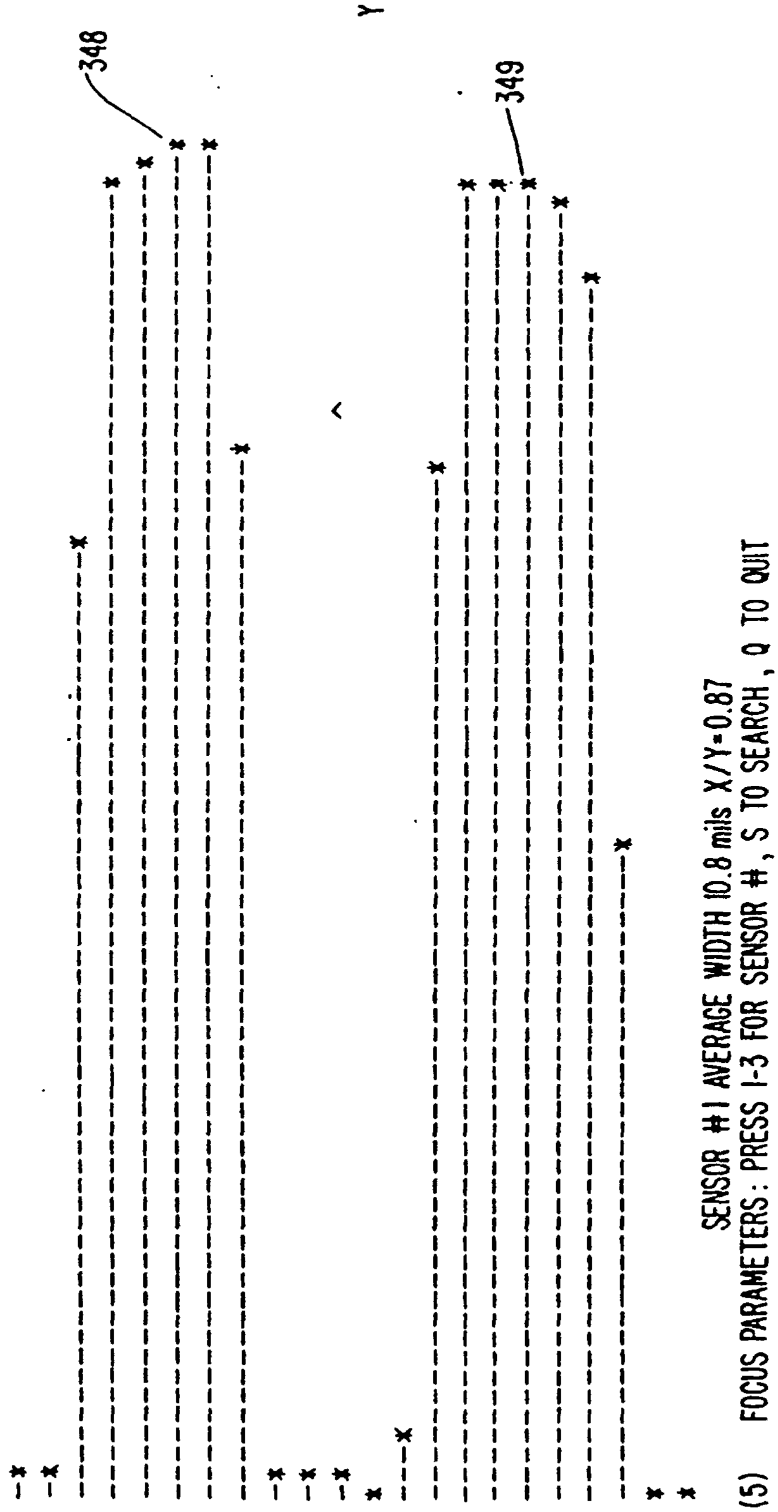
348
349
Y
SENSOR #1 AVERAGE WIDTH 10.8 mils X/Y=0.87
(5) FOCUS PARAMETERS: PRESS 1-3 FOR SENSOR #, S TO SEARCH, Q TO QUIT

FIG. 57b.

FIG. 58a.

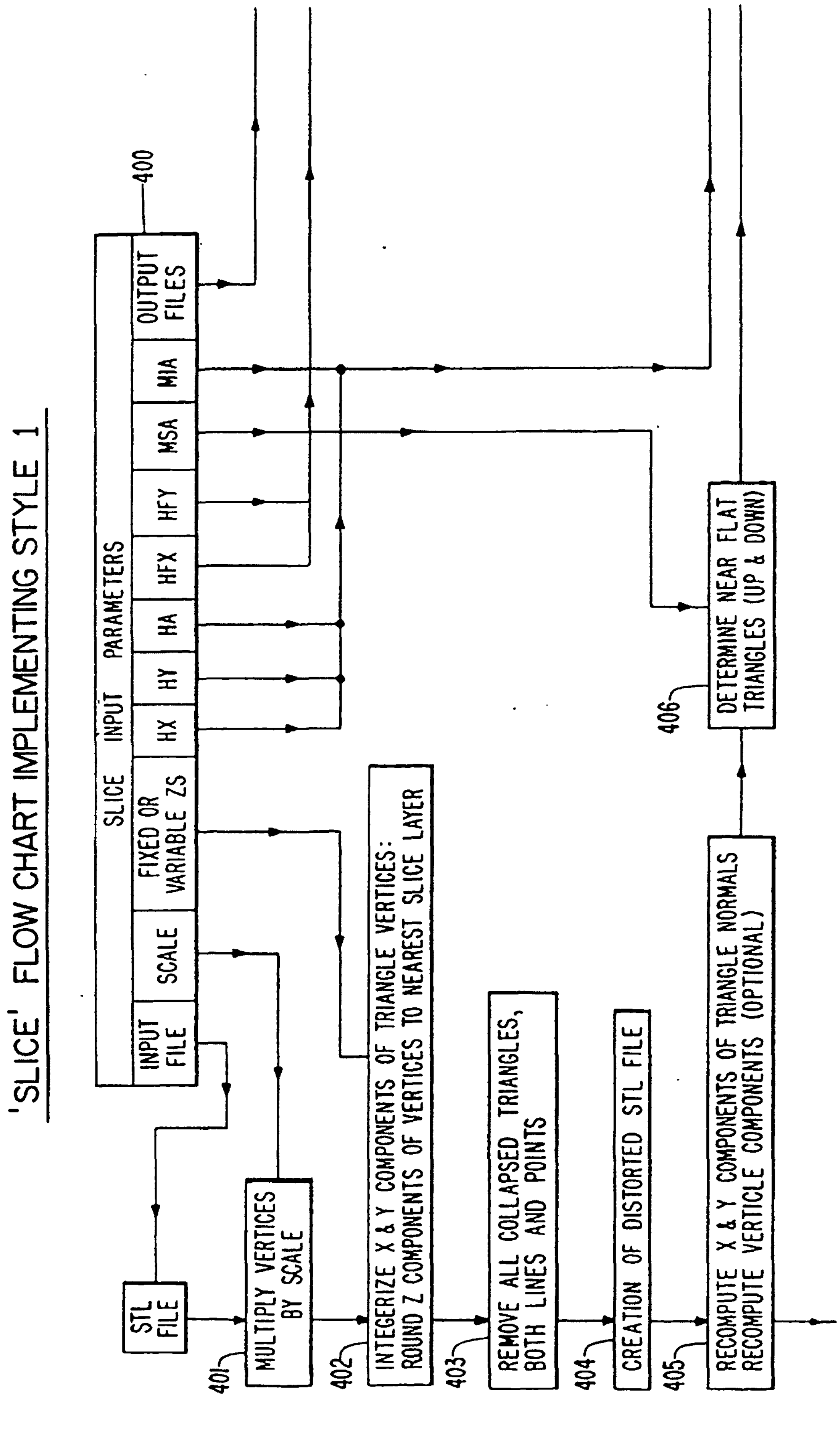
'SLICE' FLOW CHART IMPLEMENTING STYLE 1
SLICE INPUT PARAMETERS
400
INPUT FILE
SCALE
FIXED OR VARIABLE ZS
HX
HY
HA
HFX
HFY
MSA
MIA
OUTPUT FILES
STL FILE
401
MULTIPLY VERTICES BY SCALE
402
INTEGERIZE X & Y COMPONENTS OF TRIANGLE VERTICES: ROUND Z COMPONENTS OF VERTICES TO NEAREST SLICE LAYER
403
REMOVE ALL COLLAPSED TRIANGLES, BOTH LINES AND POINTS
404
CREATION OF DISTORTED STL FILE
405
RECOMPUTE X & Y COMPONENTS OF TRIANGLE NORMALS RECOMPUTE VERTICLE COMPONENTS (OPTIONAL)
406
DETERMINE NEAR FLAT TRIANGLES (UP & DOWN)

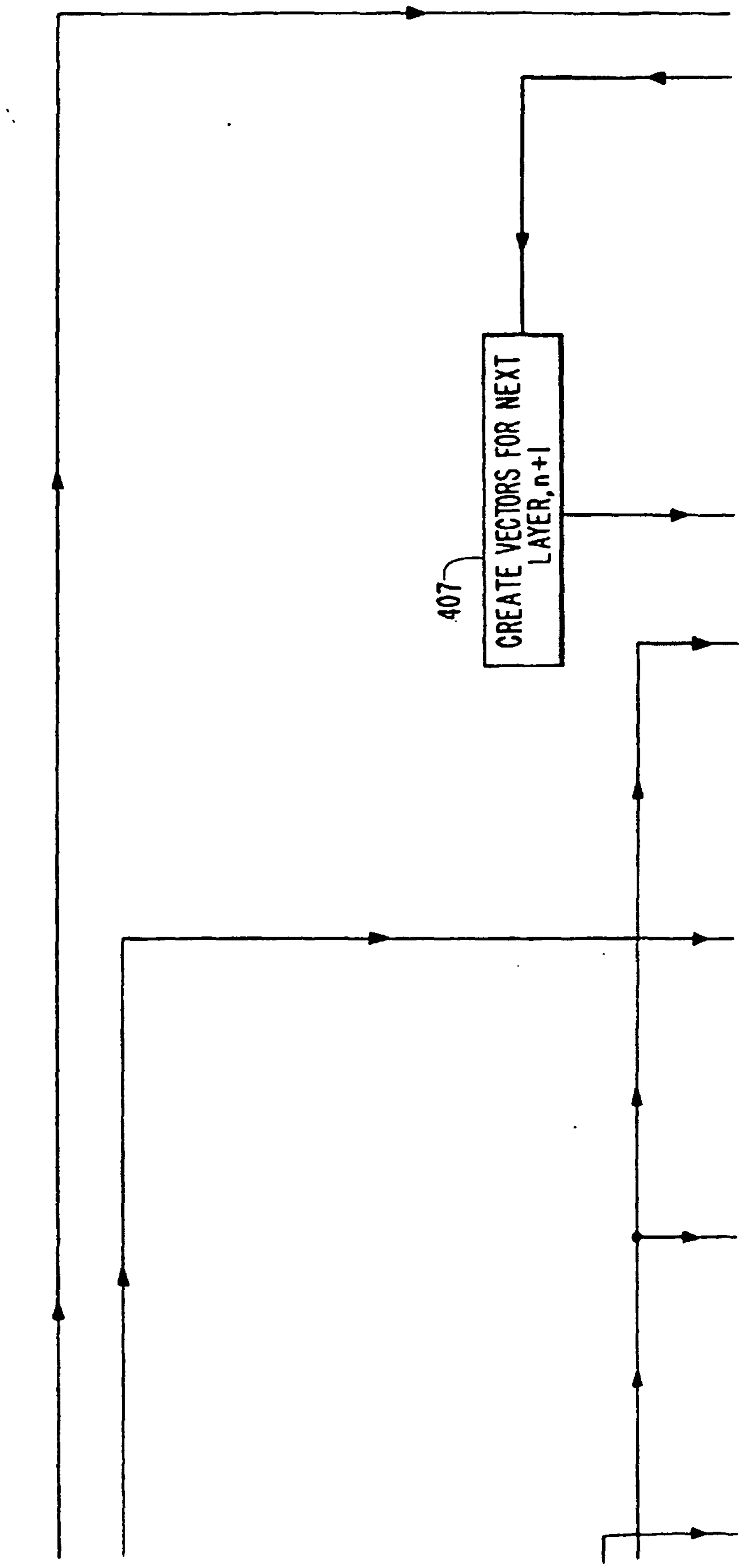


FIG. 58b.

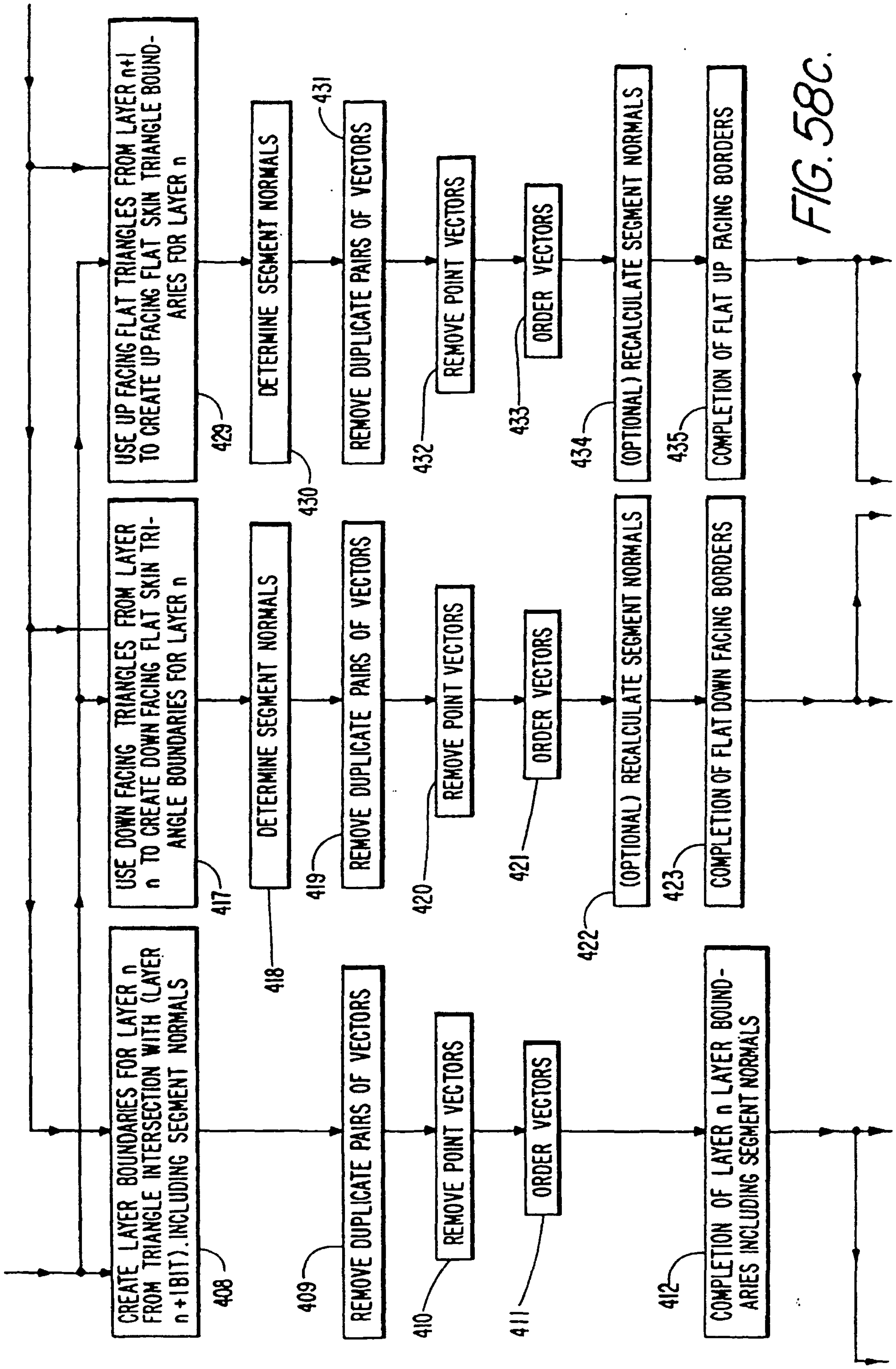
CREATE LAYER BOUNDARIES FOR LAYER n FROM TRIANGLE INTERSECTION WITH (LAYER n +1BIT). INCLUDING SEGMENT NORMALS
408
REMOVE DUPLICATE PAIRS OF VECTORS
409
REMOVE POINT VECTORS
410
ORDER VECTORS
411
COMPLETION OF LAYER n LAYER BOUNDARIES INCLUDING SEGMENT NORMALS
412
USE DOWN FACING TRIANGLES FROM LAYER n TO CREATE DOWN FACING FLAT SKIN TRIANGLE BOUNDARIES FOR LAYER n
417
DETERMINE SEGMENT NORMALS
418
REMOVE DUPLICATE PAIRS OF VECTORS
419
REMOVE POINT VECTORS
420
ORDER VECTORS
421
(OPTIONAL) RECALCULATE SEGMENT NORMALS
422
COMPLETION OF FLAT DOWN FACING BORDERS
423
USE UP FACING FLAT TRIANGLES FROM LAYER n+1 TO CREATE UP FACING FLAT SKIN TRIANGLE BOUNDARIES FOR LAYER n
429
DETERMINE SEGMENT NORMALS
430
REMOVE DUPLICATE PAIRS OF VECTORS
431
REMOVE POINT VECTORS
432
ORDER VECTORS
433
(OPTIONAL) RECALCULATE SEGMENT NORMALS
434
COMPLETION OF FLAT UP FACING BORDERS
435

FIG. 58c.

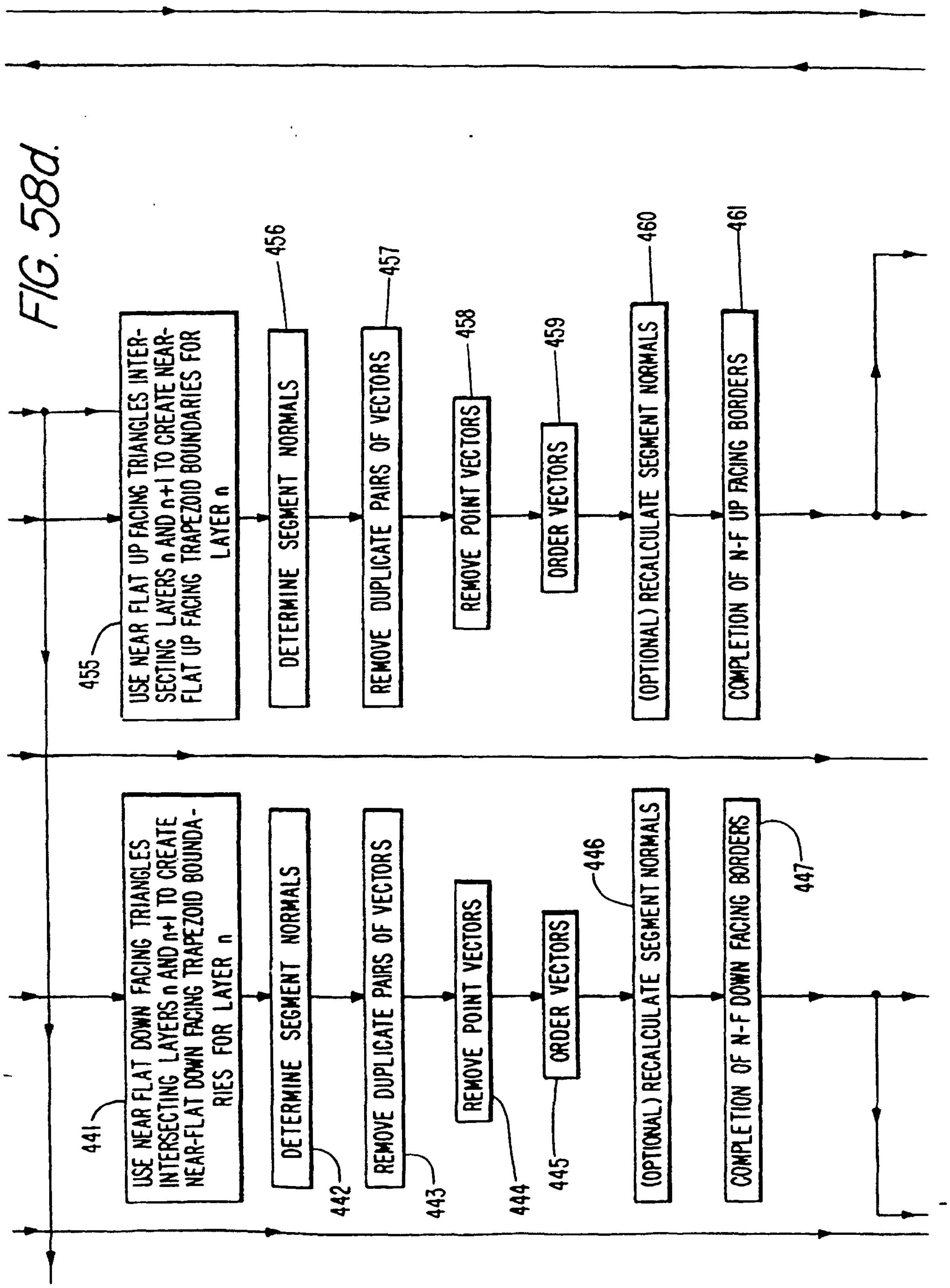
USE NEAR FLAT UP FACING TRIANGLES INTERSECTING LAYERS n AND n+1 TO CREATE NEAR-FLAT UP FACING TRAPEZOID BOUNDARIES FOR LAYER n
455
DETERMINE SEGMENT NORMALS
456
REMOVE DUPLICATE PAIRS OF VECTORS
457
REMOVE POINT VECTORS
458
ORDER VECTORS
459
(OPTIONAL) RECALCULATE SEGMENT NORMALS
460
COMPLETION OF N-F UP FACING BORDERS
461
USE NEAR FLAT DOWN FACING TRIANGLES INTERSECTING LAYERS n AND n+1 TO CREATE NEAR-FLAT DOWN FACING TRAPEZOID BOUNDARIES FOR LAYER n
441
DETERMINE SEGMENT NORMALS
442
REMOVE DUPLICATE PAIRS OF VECTORS
443
REMOVE POINT VECTORS
444
ORDER VECTORS
445
(OPTIONAL) RECALCULATE SEGMENT NORMALS
446
COMPLETION OF N-F DOWN FACING BORDERS
447

FIG. 58d.

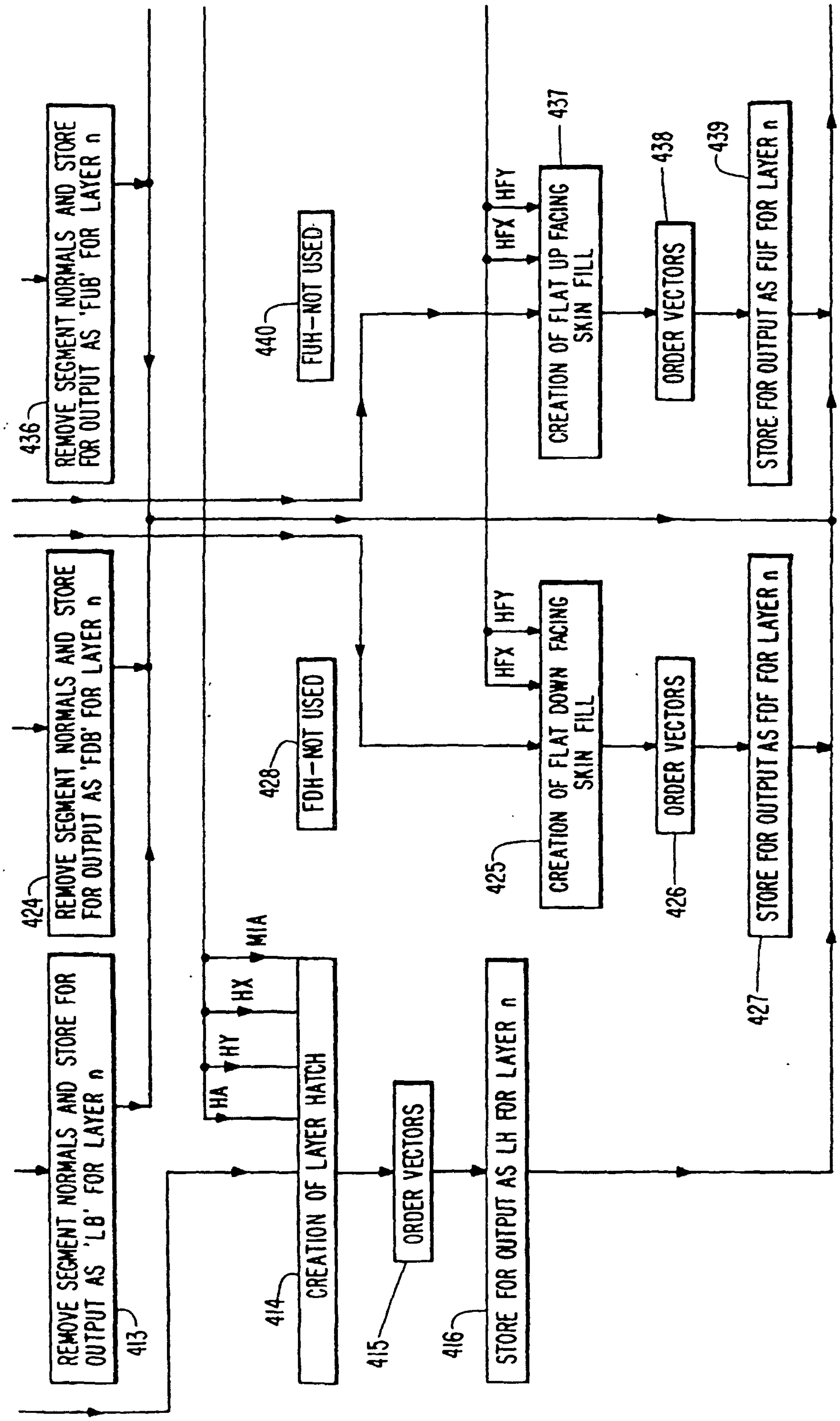
REMOVE SEGMENT NORMALS AND STORE FOR OUTPUT AS 'LB' FOR LAYER n
413
REMOVE SEGMENT NORMALS AND STORE FOR OUTPUT AS 'FDB' FOR LAYER n
424
REMOVE SEGMENT NORMALS AND STORE FOR OUTPUT AS 'FUB' FOR LAYER n
436
HA
HY
HX
MIA
CREATION OF LAYER HATCH
414
FDH-NOT USED
428
FUH-NOT USED
440
ORDER VECTORS
415
HFX
HFY
CREATION OF FLAT DOWN FACING SKIN FILL
425
CREATION OF FLAT UP FACING SKIN FILL
437
STORE FOR OUTPUT AS LH FOR LAYER n
416
ORDER VECTORS
426
ORDER VECTORS
438
STORE FOR OUTPUT AS FDF FOR LAYER n
427
STORE FOR OUTPUT AS FUF FOR LAYER n
439

FIG. 58e.

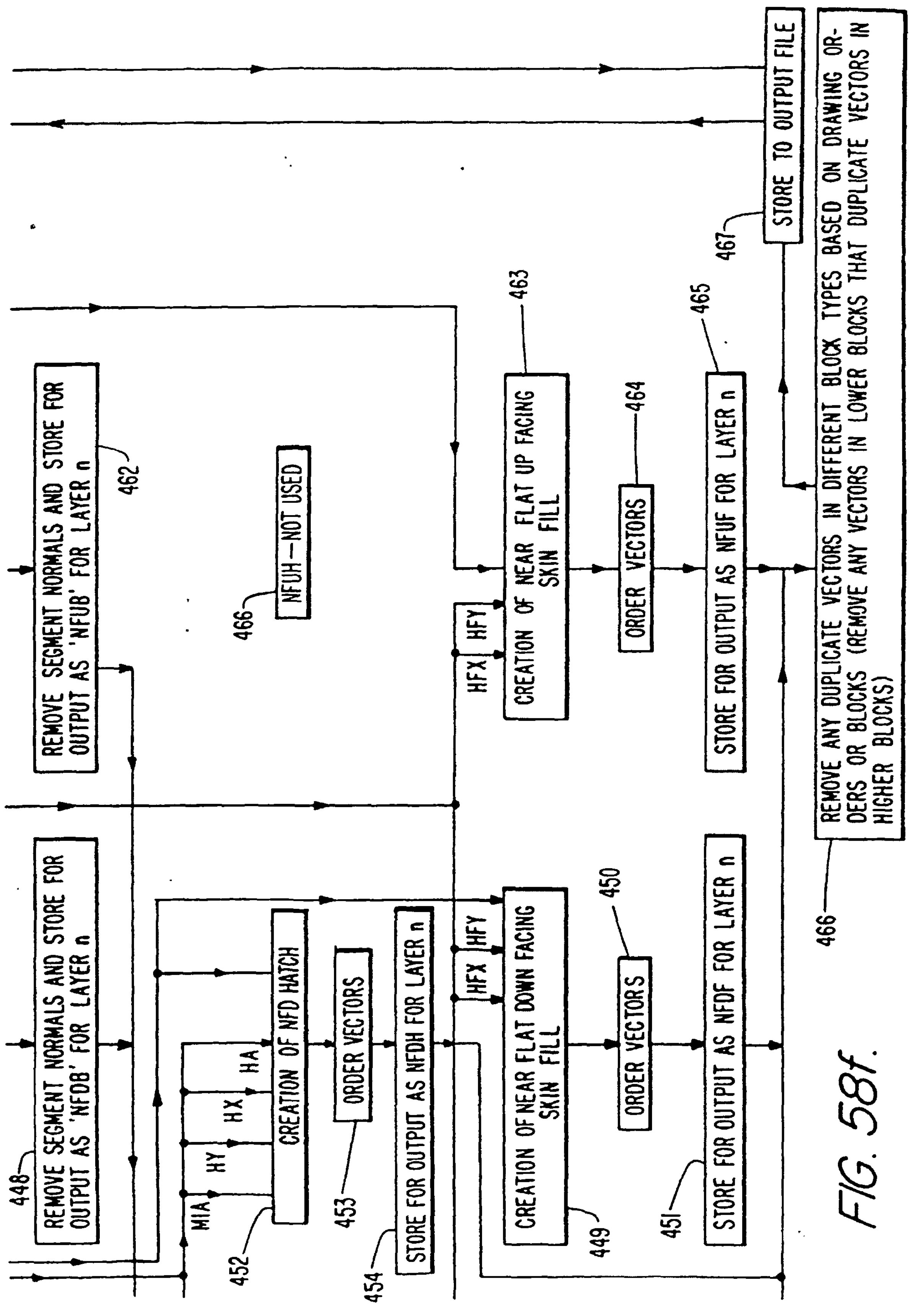
448
REMOVE SEGMENT NORMALS AND STORE FOR OUTPUT AS 'NFDB' FOR LAYER n
462
REMOVE SEGMENT NORMALS AND STORE FOR OUTPUT AS 'NFUB' FOR LAYER n
466
NFUH—NOT USED
MIA
HY
HX
HA
452
CREATION OF NFD HATCH
453
ORDER VECTORS
454
STORE FOR OUTPUT AS NFDH FOR LAYER n
HFX
HFY
449
CREATION OF NEAR FLAT DOWN FACING SKIN FILL
450
ORDER VECTORS
451
STORE FOR OUTPUT AS NFDF FOR LAYER n
HFX
HFY
463
CREATION OF NEAR FLAT UP FACING SKIN FILL
464
ORDER VECTORS
465
STORE FOR OUTPUT AS NFUF FOR LAYER n
466
REMOVE ANY DUPLICATE VECTORS IN DIFFERENT BLOCK TYPES BASED ON DRAWING ORDERS OR BLOCKS (REMOVE ANY VECTORS IN LOWER BLOCKS THAT DUPLICATE VECTORS IN HIGHER BLOCKS)
467
STORE TO OUTPUT FILE

FIG. 58f.

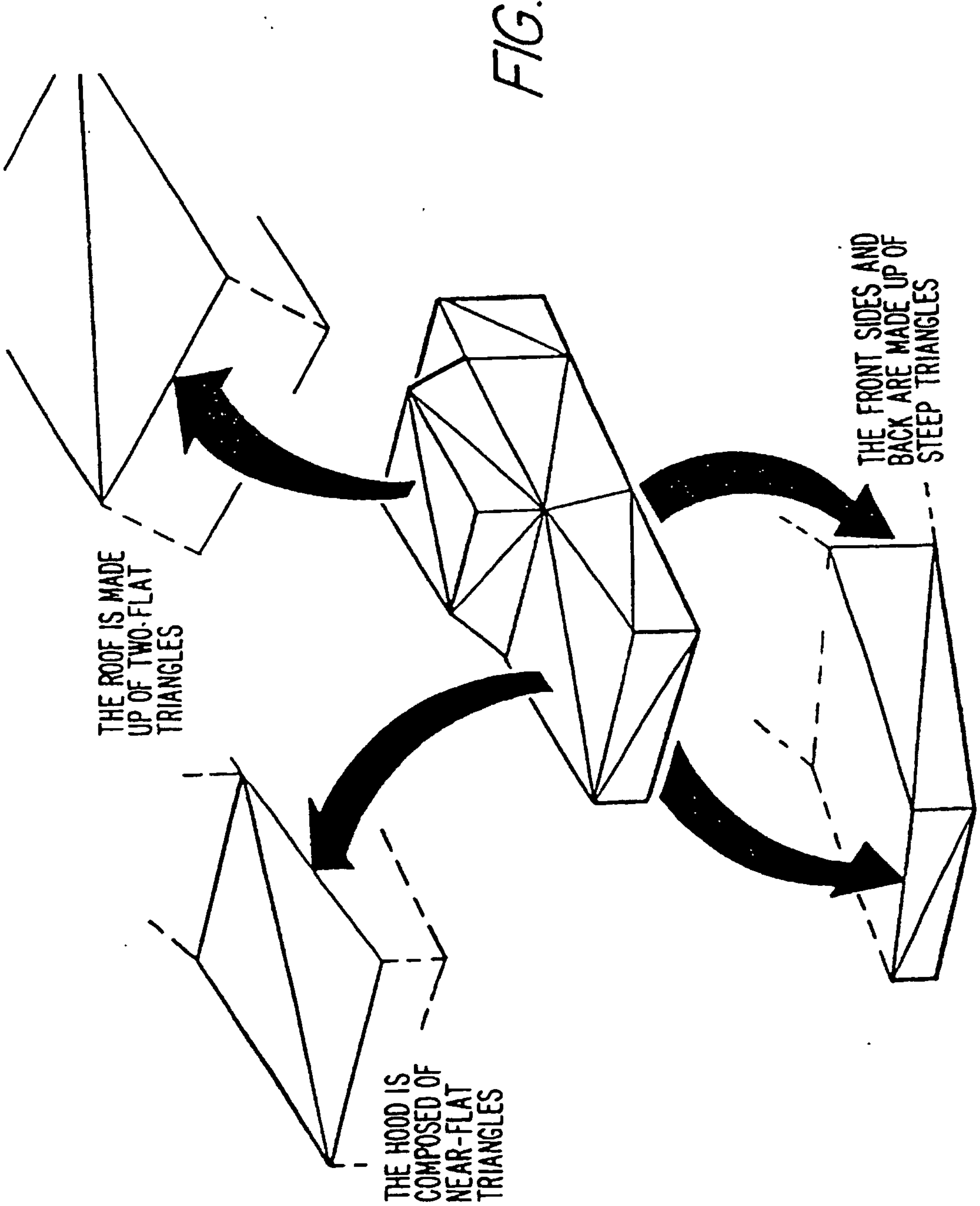
THE ROOF IS MADE UP OF TWO-FLAT TRIANGLES
THE FRONT SIDES AND BACK ARE MADE UP OF STEEP TRIANGLES
THE HOOD IS COMPOSED OF NEAR-FLAT TRIANGLES

FIG. 59a.

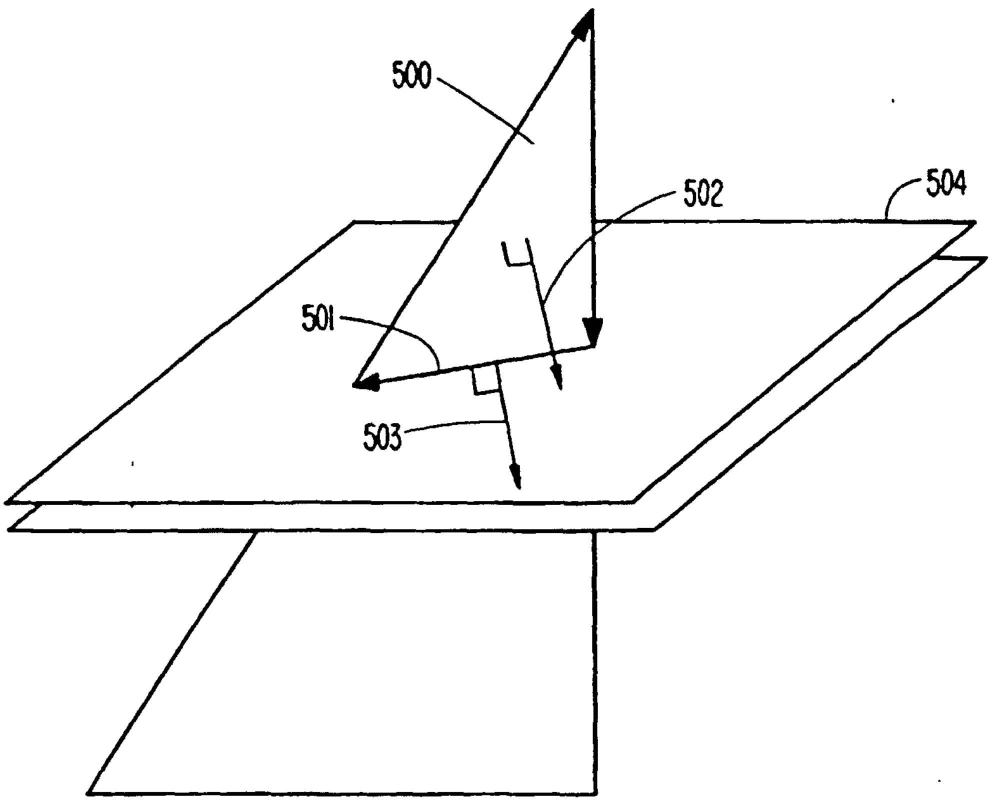


FIG. 59b.

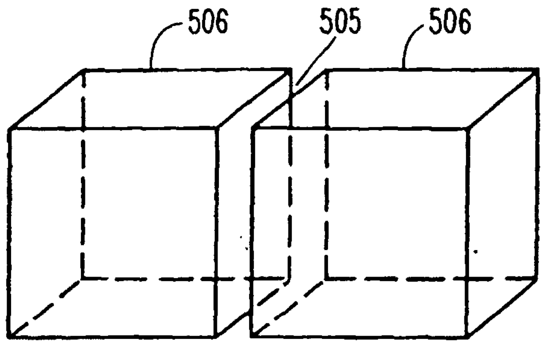


FIG. 60a.

FIG. 60b.

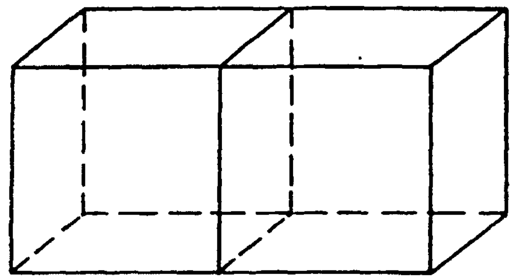

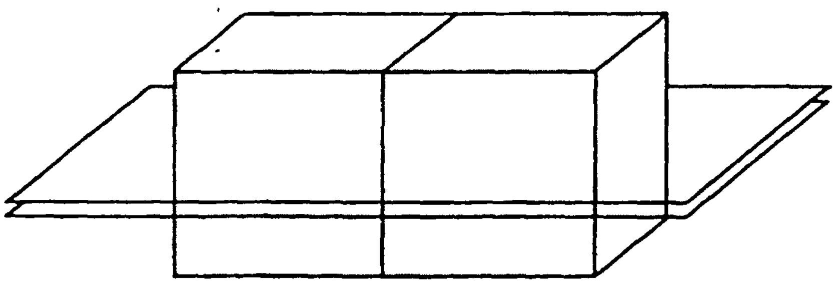

FIG. 60c.

FIG. 60d.

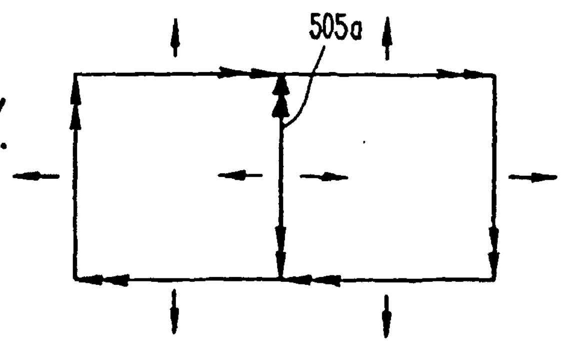


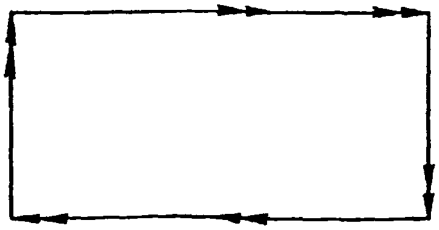

FIG. 60e.

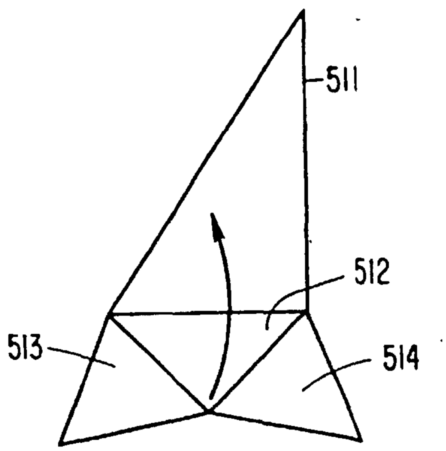


FIG. 61a.

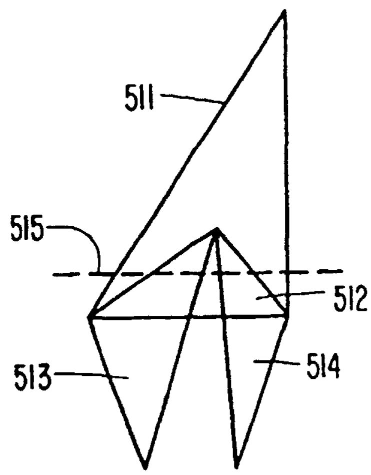


FIG. 61b.

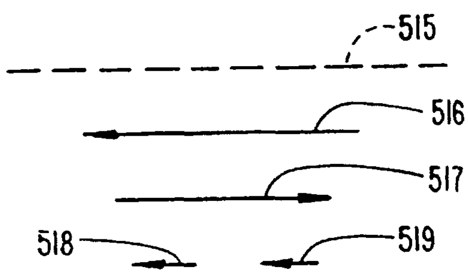


FIG. 61c.

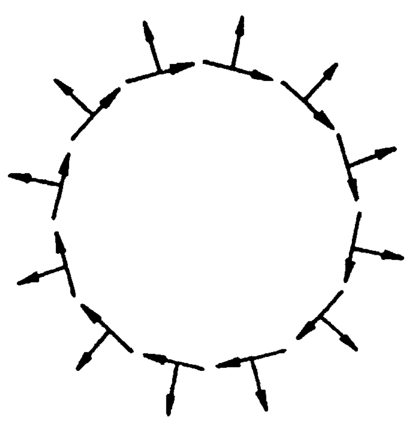

FIG. 62a.

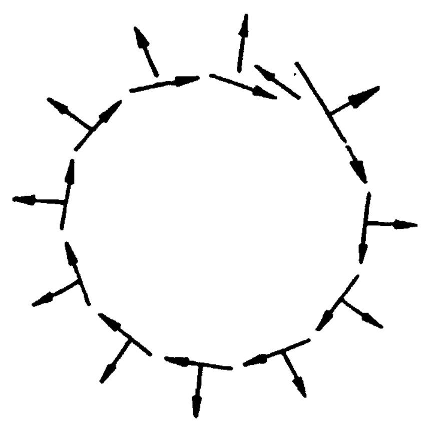

FIG. 62b.

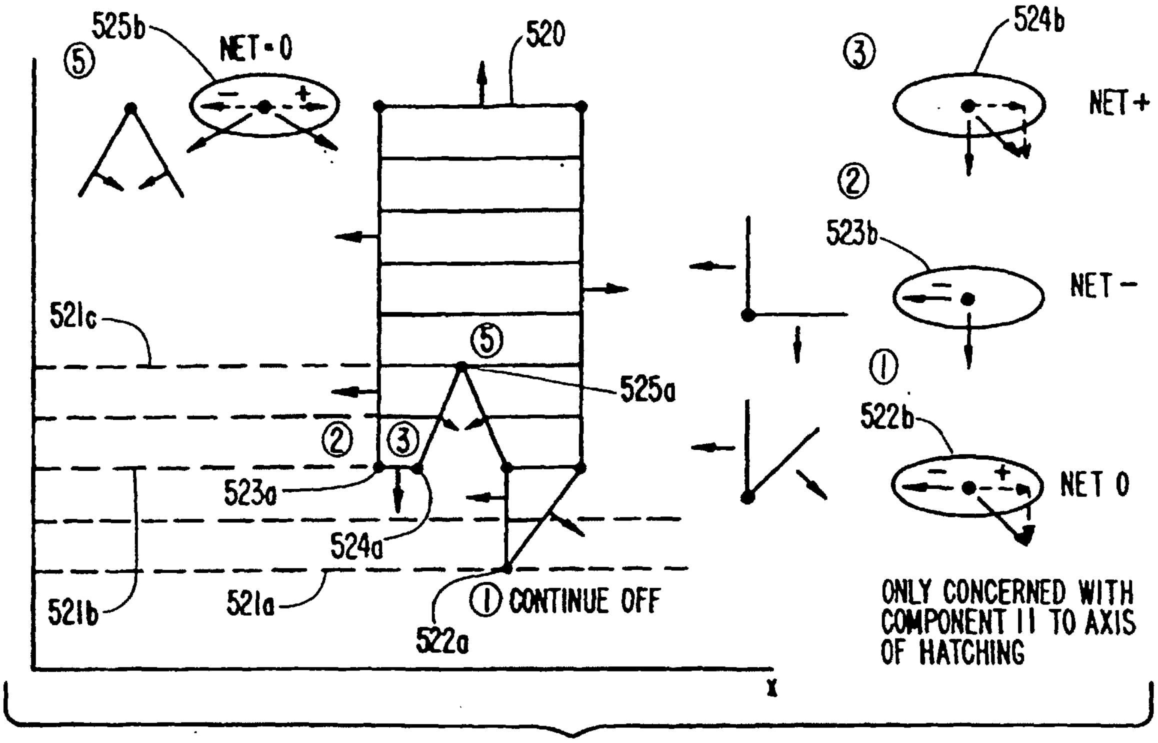


FIG. 63a

FIG. 63b.

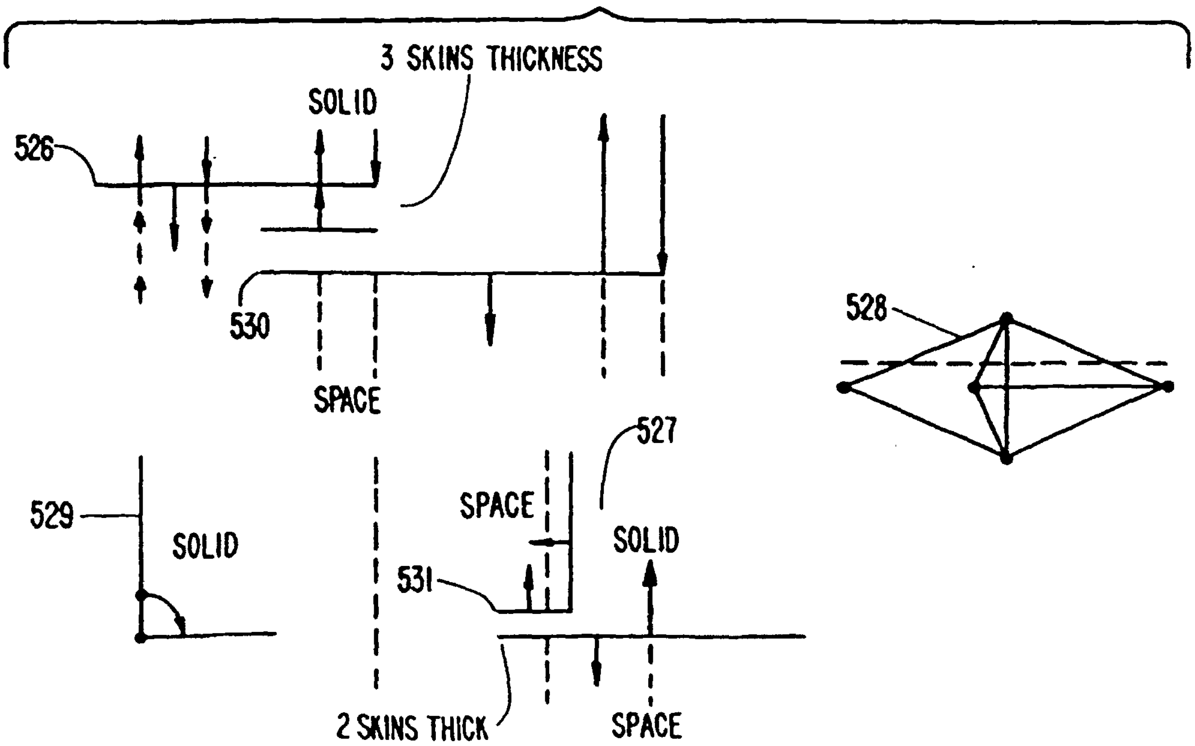

FIG. 64a.

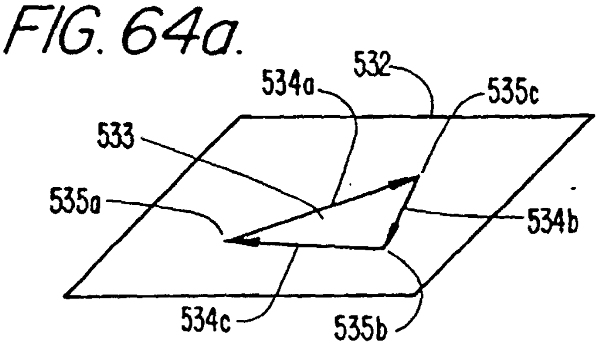


FIG. 65a.

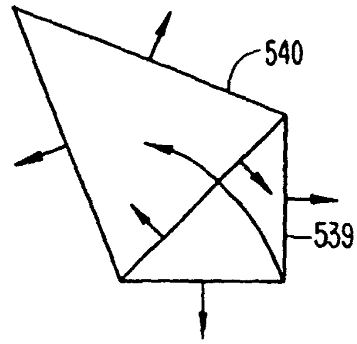


FIG. 64b.

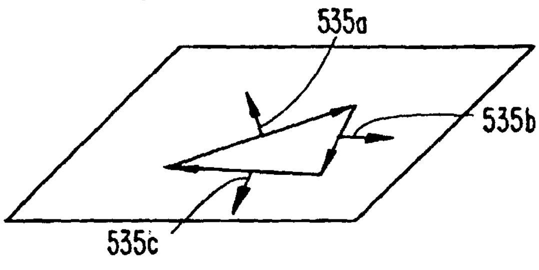


FIG. 65b.

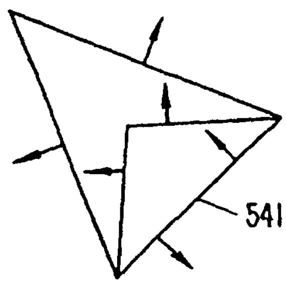


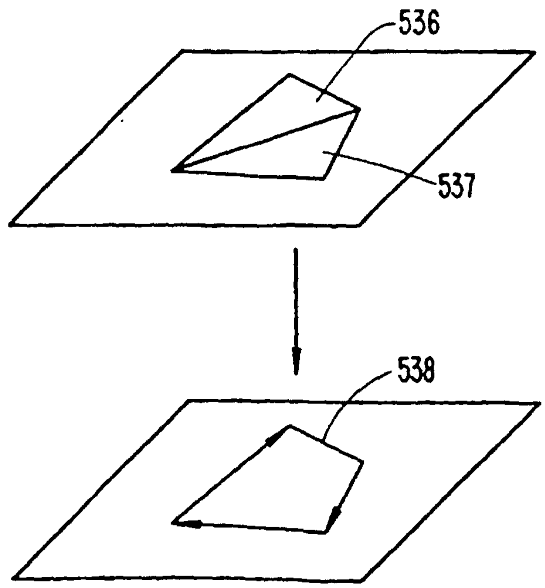


FIG. 64c.

FIG. 66a.

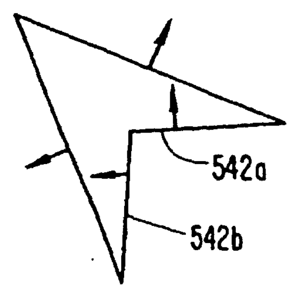


FIG. 66b.

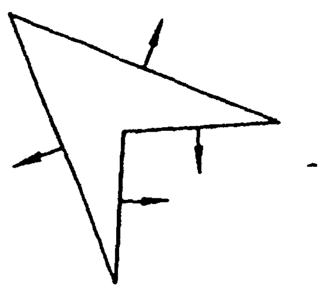

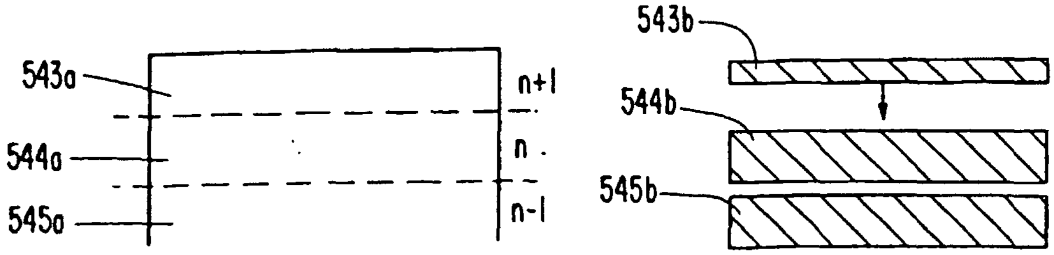
543a
544a
545a
n+1
n
n-1
543b
544b
545b

FIG. 67.

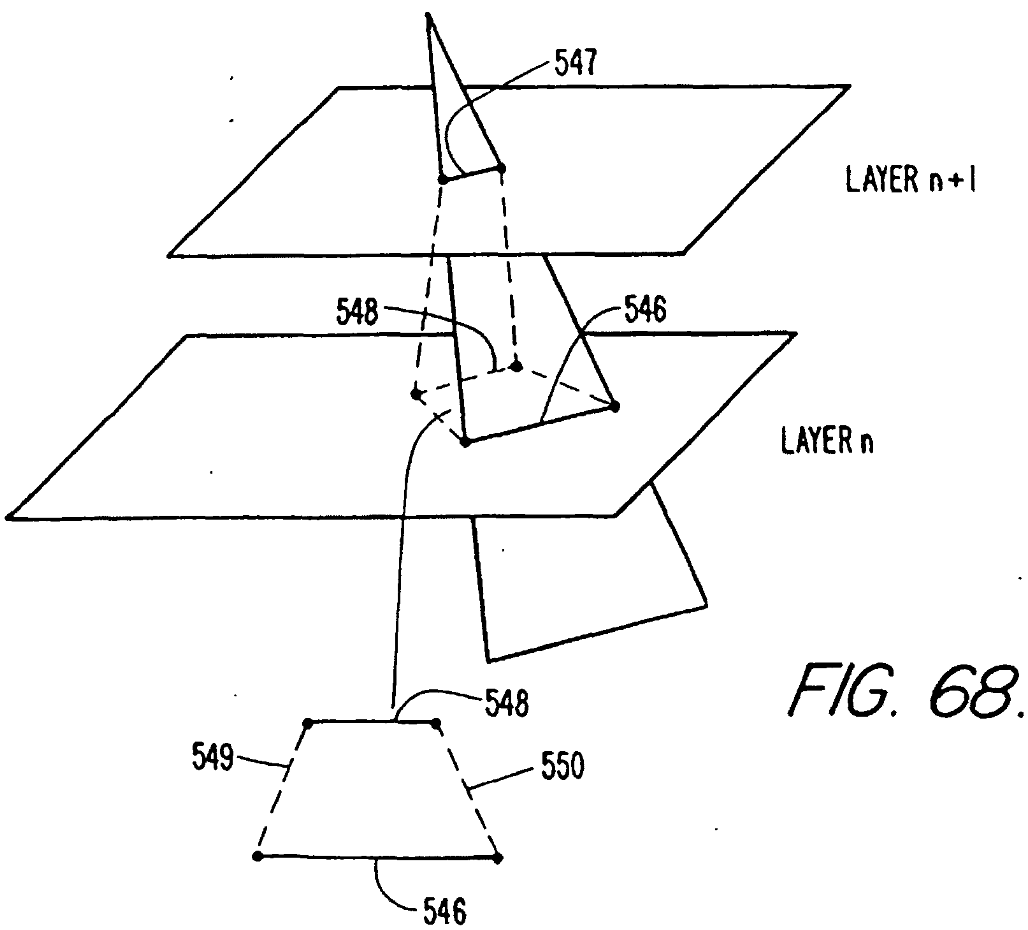
547
LAYER n+1
548
546
LAYER n
548
549
550
546

FIG. 68.

FIG. 69.

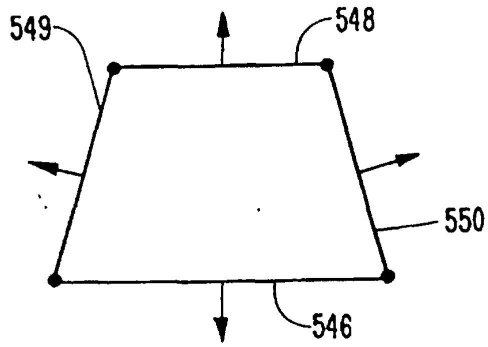


FIG. 70.

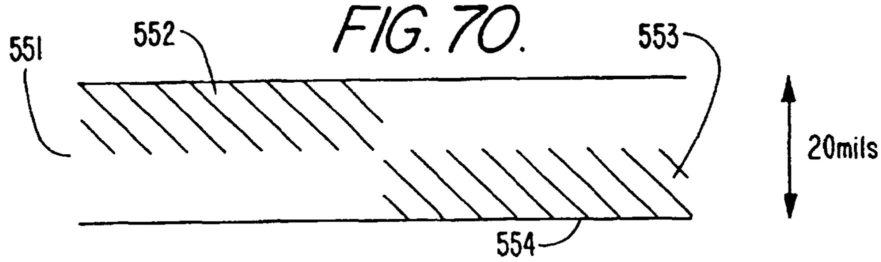


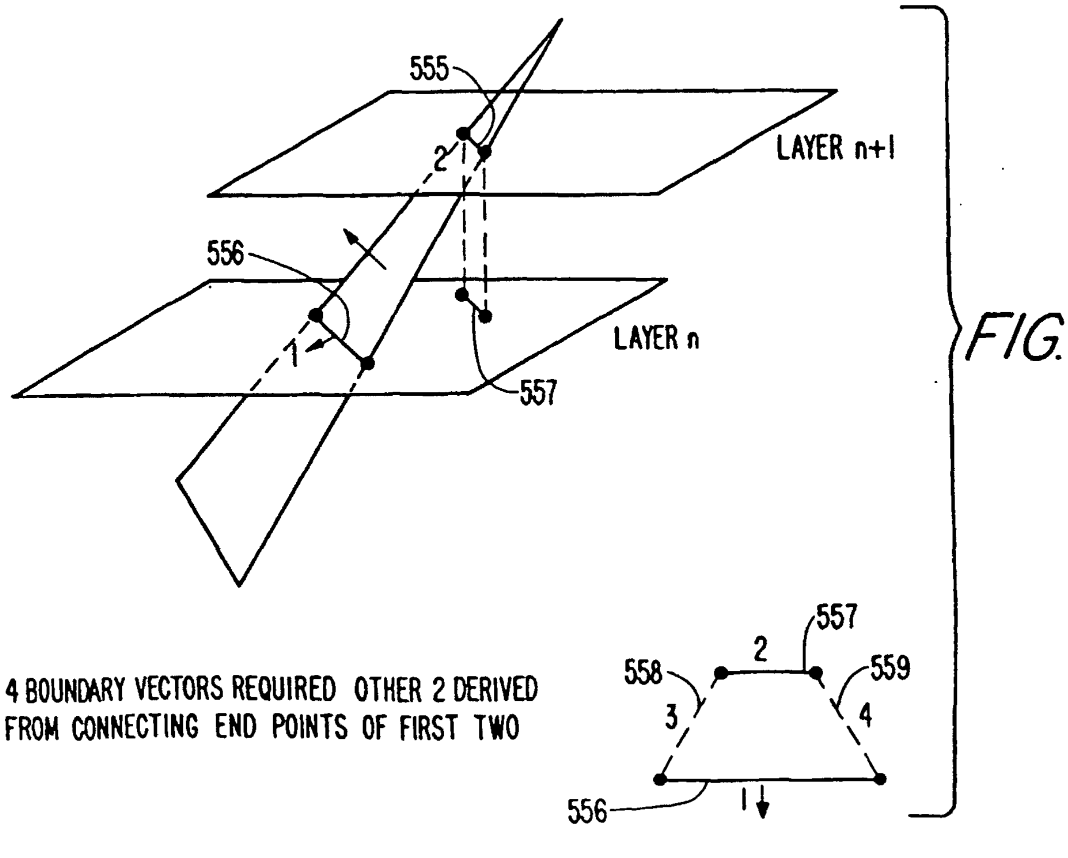


FIG. 71.

FIG. 72a.

'SLICE' FLOW CHART IMPLEMENTING STYLE 2

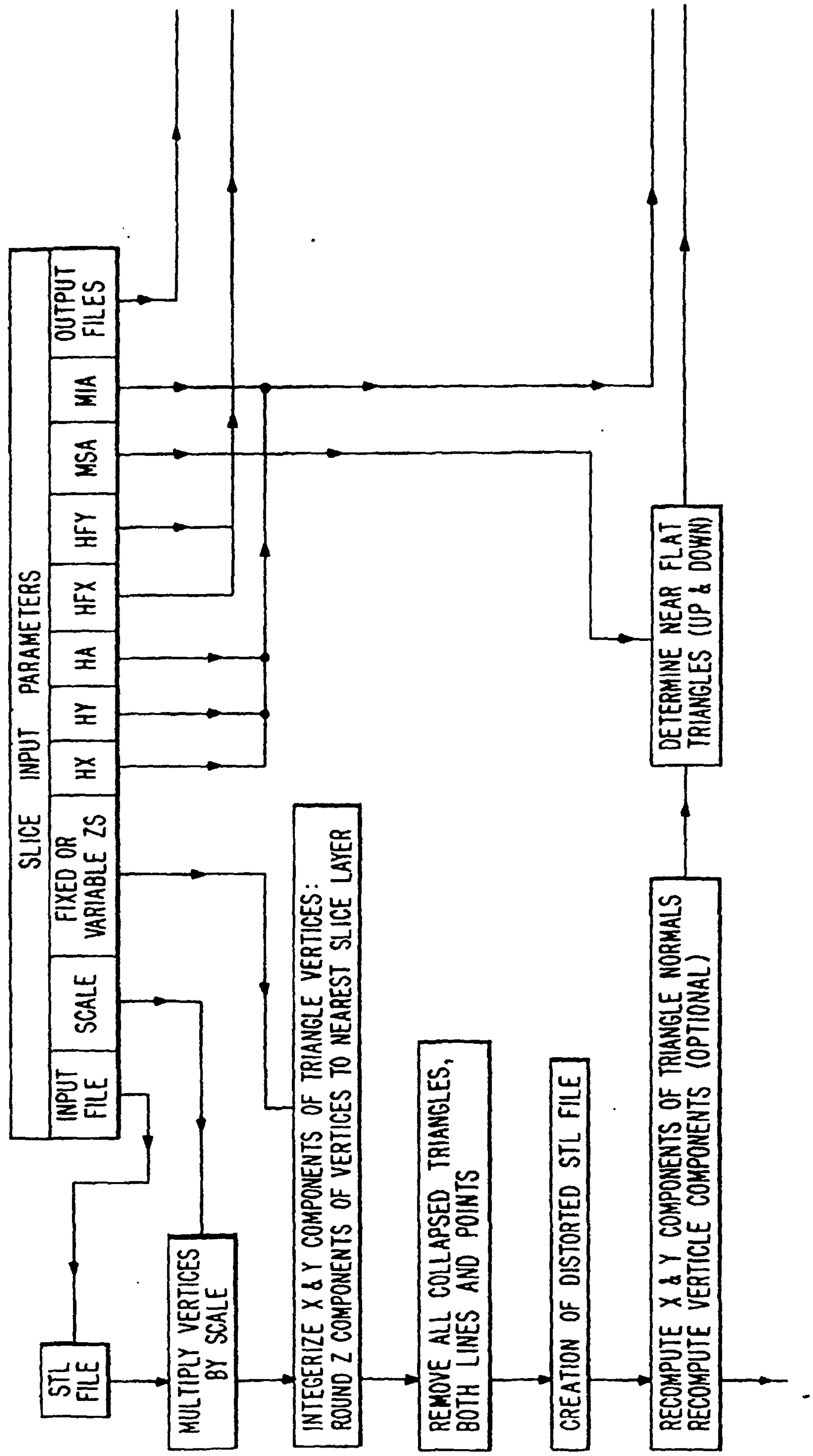

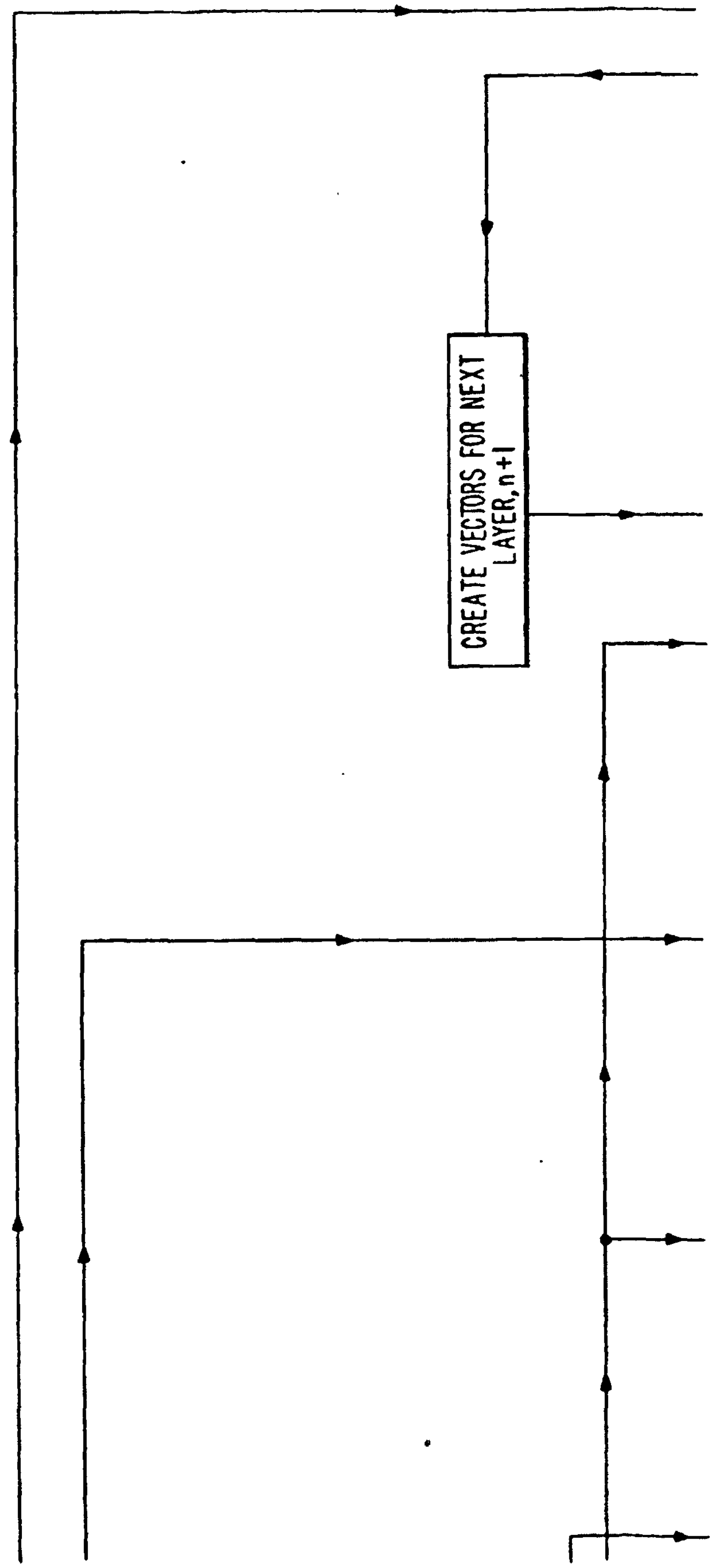


FIG. 72b.

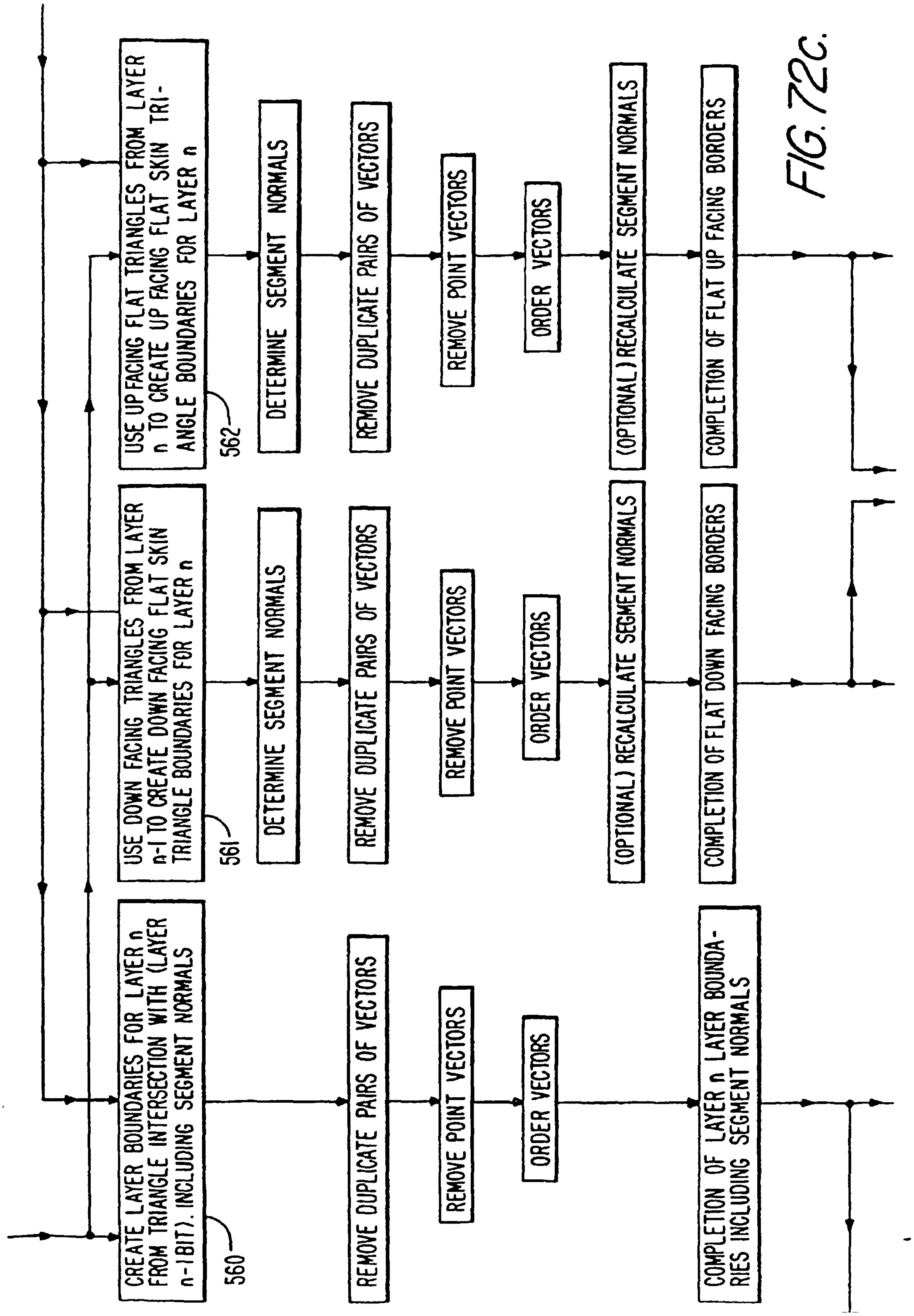
CREATE LAYER BOUNDARIES FOR LAYER n FROM TRIANGLE INTERSECTION WITH (LAYER n-1 BIT). INCLUDING SEGMENT NORMALS
560
REMOVE DUPLICATE PAIRS OF VECTORS
REMOVE POINT VECTORS
ORDER VECTORS
COMPLETION OF LAYER n LAYER BOUNDARIES INCLUDING SEGMENT NORMALS
USE DOWN FACING TRIANGLES FROM LAYER n-1 TO CREATE DOWN FACING FLAT SKIN TRIANGLE BOUNDARIES FOR LAYER n
561
DETERMINE SEGMENT NORMALS
REMOVE DUPLICATE PAIRS OF VECTORS
REMOVE POINT VECTORS
ORDER VECTORS
(OPTIONAL) RECALCULATE SEGMENT NORMALS
COMPLETION OF FLAT DOWN FACING BORDERS
USE UP FACING FLAT TRIANGLES FROM LAYER n TO CREATE UP FACING FLAT SKIN TRIANGLE BOUNDARIES FOR LAYER n
562
DETERMINE SEGMENT NORMALS
REMOVE DUPLICATE PAIRS OF VECTORS
REMOVE POINT VECTORS
ORDER VECTORS
(OPTIONAL) RECALCULATE SEGMENT NORMALS
COMPLETION OF FLAT UP FACING BORDERS

FIG. 72c.

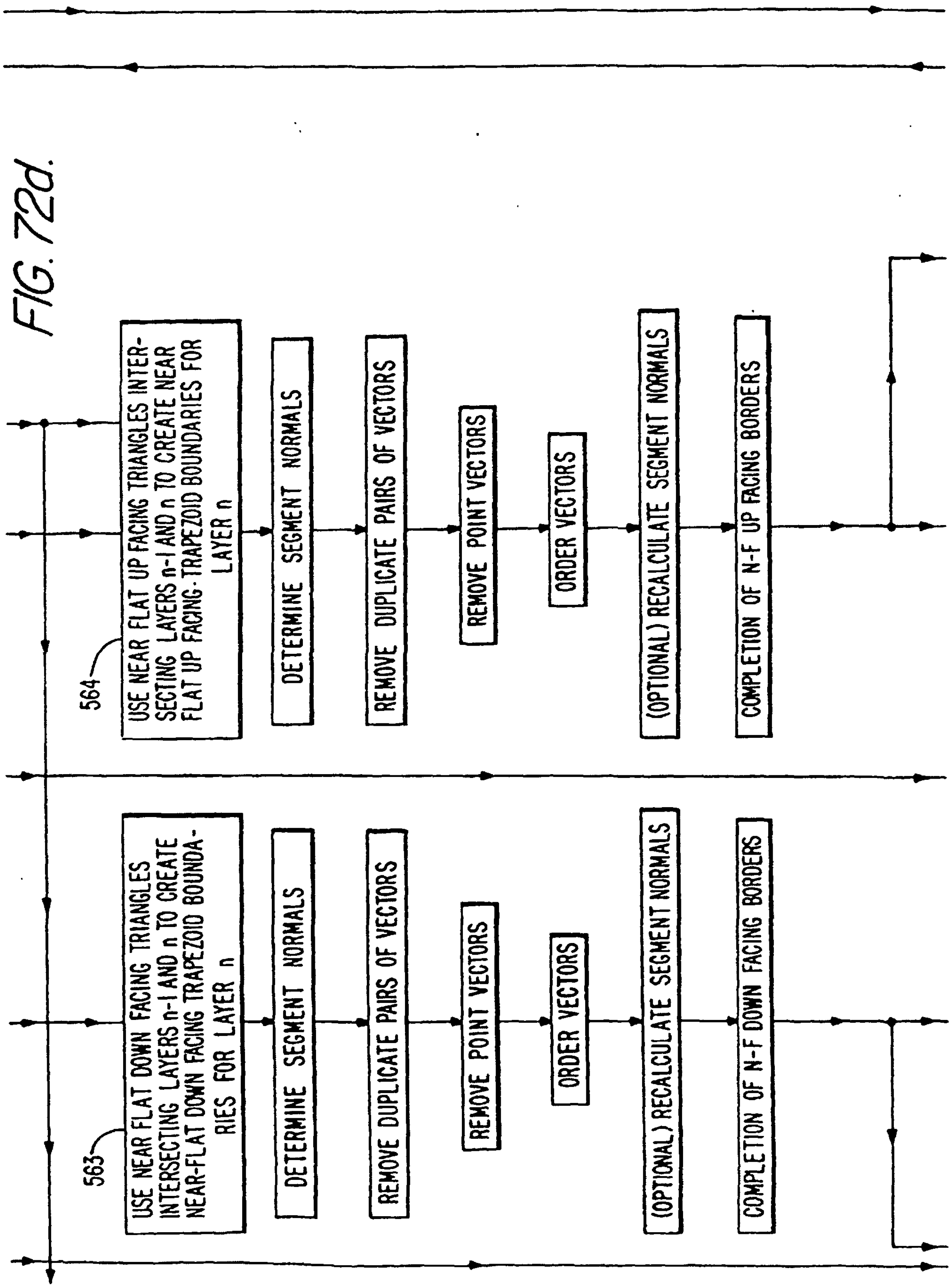
564
USE NEAR FLAT UP FACING TRIANGLES INTERSECTING LAYERS n-1 AND n TO CREATE NEAR FLAT UP FACING-TRAPEZOID BOUNDARIES FOR LAYER n
DETERMINE SEGMENT NORMALS
REMOVE DUPLICATE PAIRS OF VECTORS
REMOVE POINT VECTORS
ORDER VECTORS
(OPTIONAL) RECALCULATE SEGMENT NORMALS
COMPLETION OF N-F UP FACING BORDERS
563
USE NEAR FLAT DOWN FACING TRIANGLES INTERSECTING LAYERS n-1 AND n TO CREATE NEAR-FLAT DOWN FACING TRAPEZOID BOUNDARIES FOR LAYER n
DETERMINE SEGMENT NORMALS
REMOVE DUPLICATE PAIRS OF VECTORS
REMOVE POINT VECTORS
ORDER VECTORS
(OPTIONAL) RECALCULATE SEGMENT NORMALS
COMPLETION OF N-F DOWN FACING BORDERS

FIG. 72d.

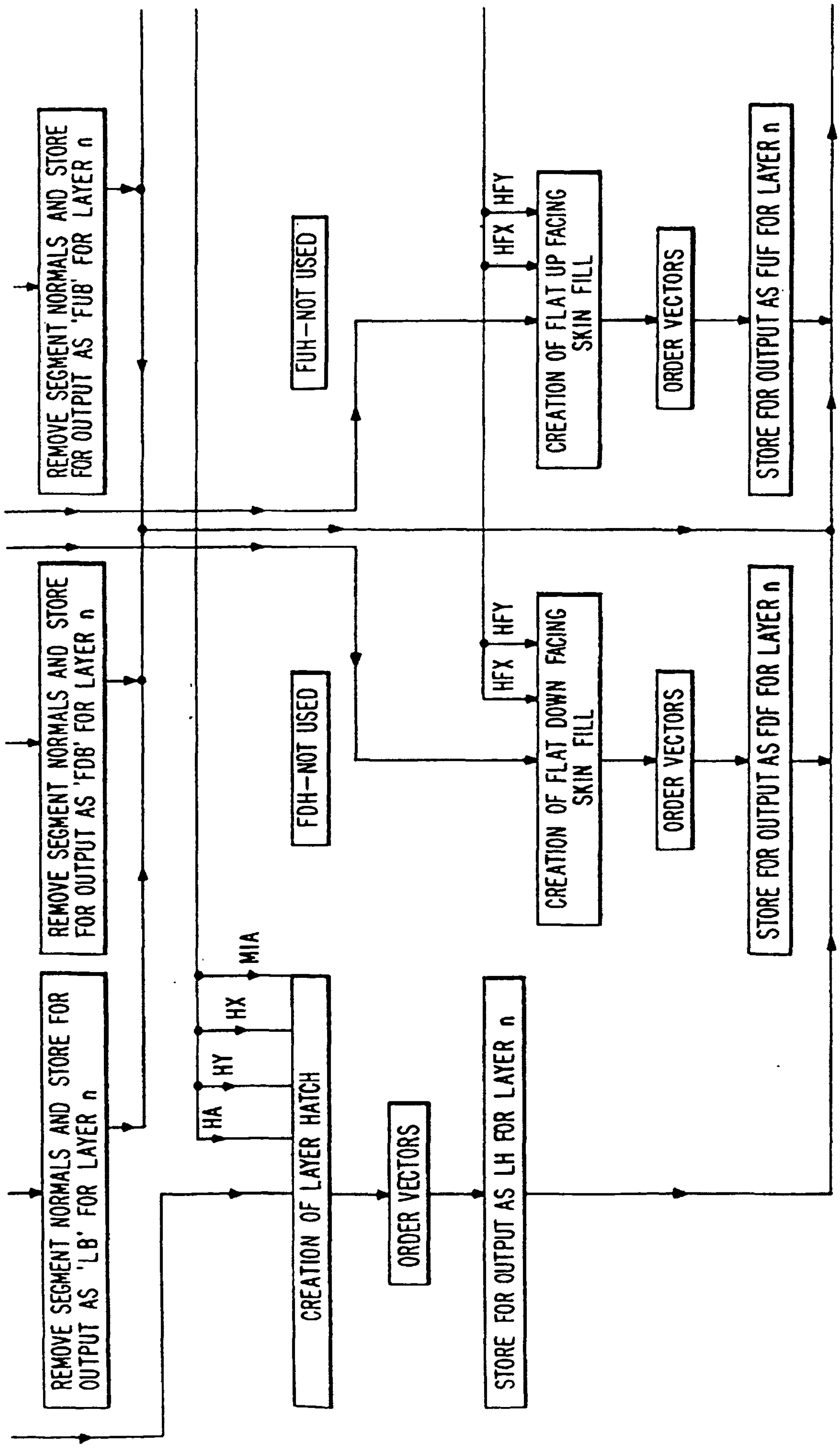
REMOVE SEGMENT NORMALS AND STORE FOR OUTPUT AS 'LB' FOR LAYER n
REMOVE SEGMENT NORMALS AND STORE FOR OUTPUT AS 'FDB' FOR LAYER n
REMOVE SEGMENT NORMALS AND STORE FOR OUTPUT AS 'FUB' FOR LAYER n
HA
HY
HX
MIA
CREATION OF LAYER HATCH
FDH-NOT USED
FUH-NOT USED
ORDER VECTORS
STORE FOR OUTPUT AS LH FOR LAYER n
HFX
HFY
CREATION OF FLAT DOWN FACING SKIN FILL
CREATION OF FLAT UP FACING SKIN FILL
ORDER VECTORS
ORDER VECTORS
STORE FOR OUTPUT AS FDF FOR LAYER n
STORE FOR OUTPUT AS FUF FOR LAYER n

FIG. 72e.

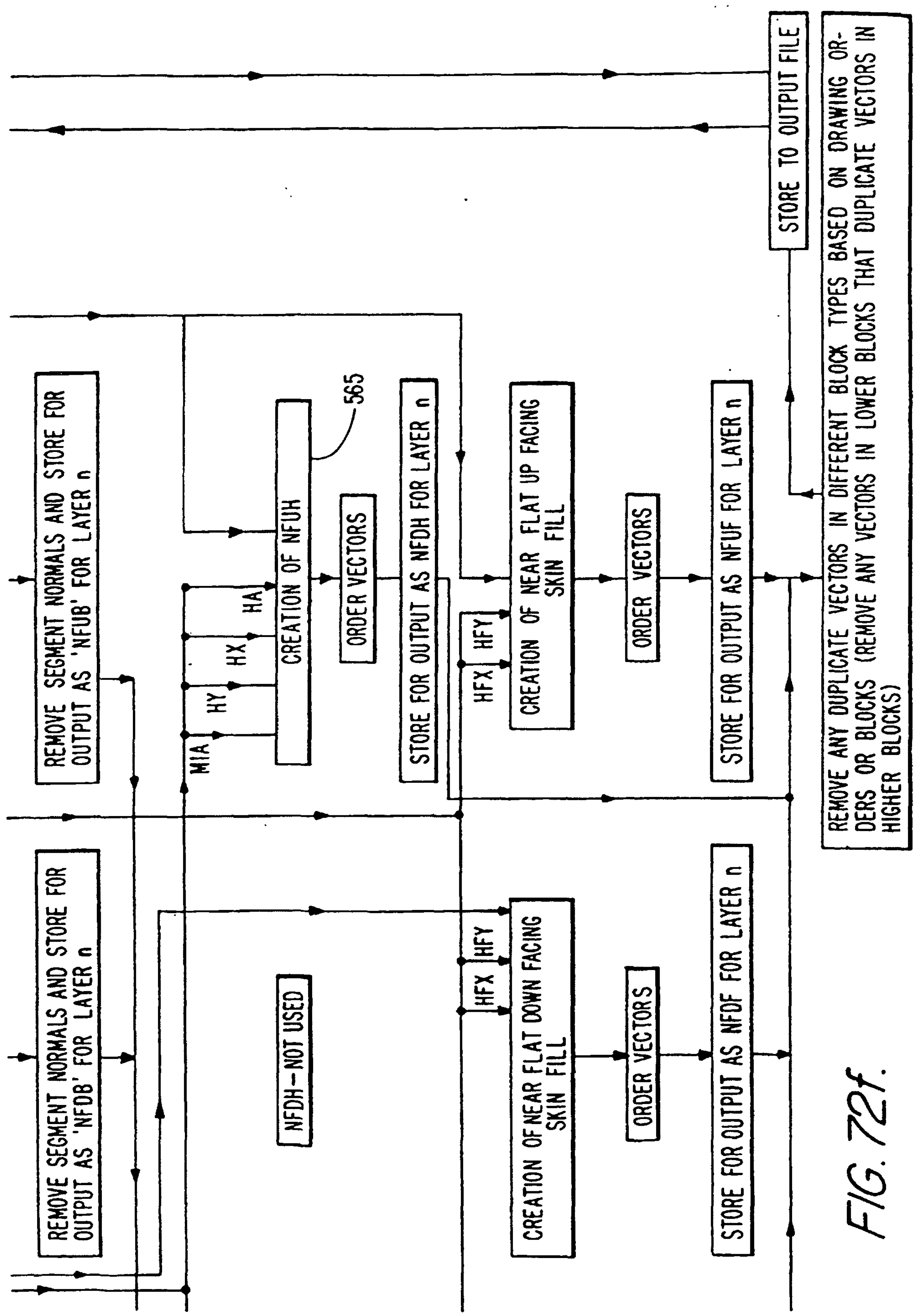
REMOVE SEGMENT NORMALS AND STORE FOR OUTPUT AS 'NFDB' FOR LAYER n
REMOVE SEGMENT NORMALS AND STORE FOR OUTPUT AS 'NFUB' FOR LAYER n
NFDH-NOT USED
MIA
HY
HX
HA
CREATION OF NFUH
565
ORDER VECTORS
STORE FOR OUTPUT AS NFDH FOR LAYER n
HFX
HFY
CREATION OF NEAR FLAT DOWN FACING SKIN FILL
CREATION OF NEAR FLAT UP FACING SKIN FILL
ORDER VECTORS
ORDER VECTORS
STORE FOR OUTPUT AS NFDF FOR LAYER n
STORE FOR OUTPUT AS NFUF FOR LAYER n
STORE FOR OUTPUT AS NFDF FOR LAYER n
STORE TO OUTPUT FILE
REMOVE ANY DUPLICATE VECTORS IN DIFFERENT BLOCK TYPES BASED ON DRAWING ORDERS OR BLOCKS (REMOVE ANY VECTORS IN LOWER BLOCKS THAT DUPLICATE VECTORS IN HIGHER BLOCKS)

FIG. 72f.

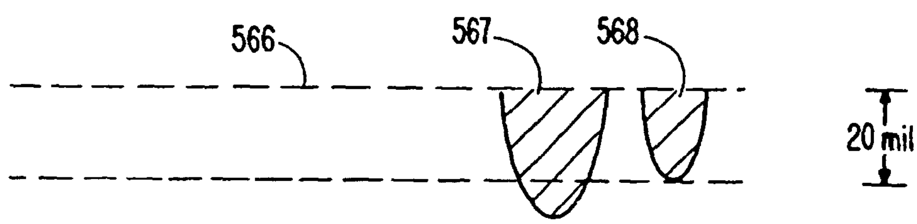


FIG. 73.

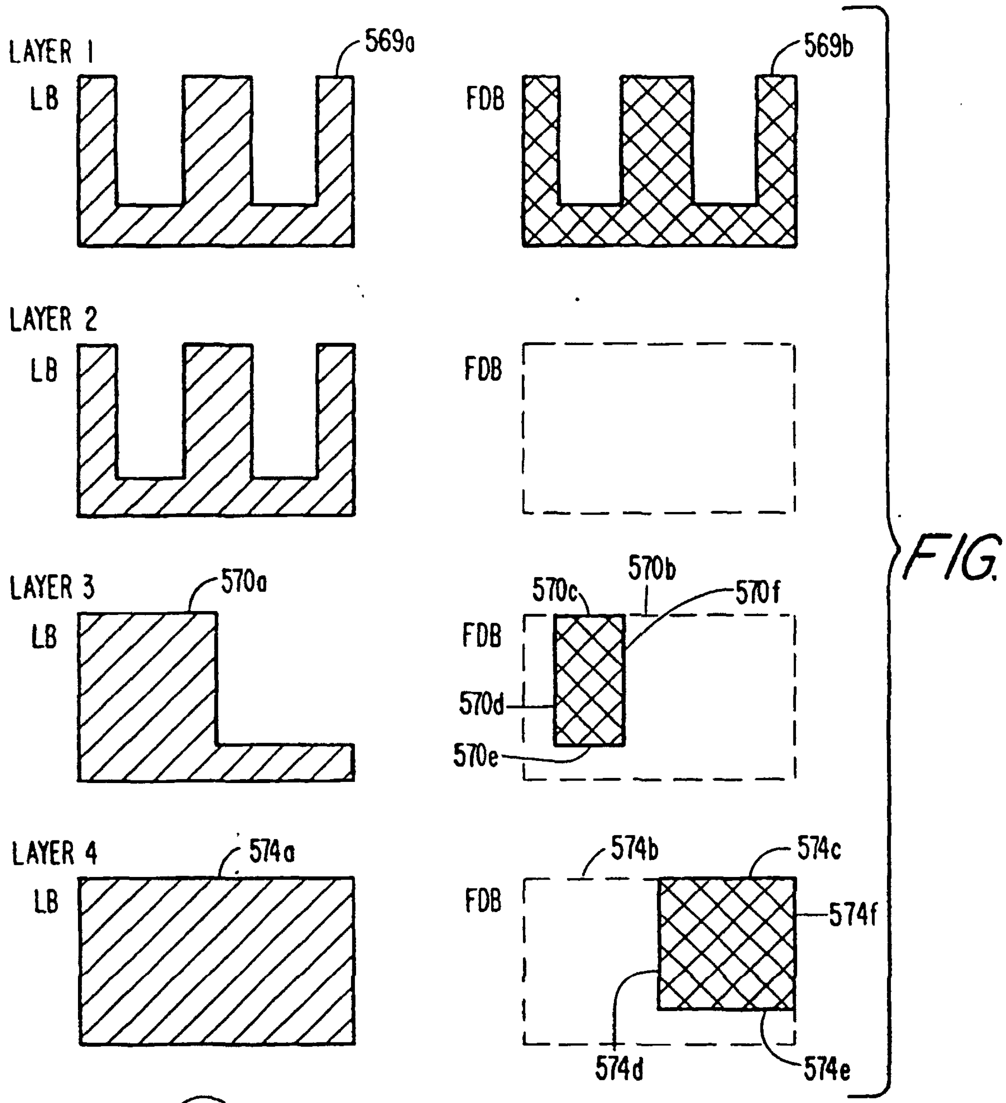


FIG. 74a.

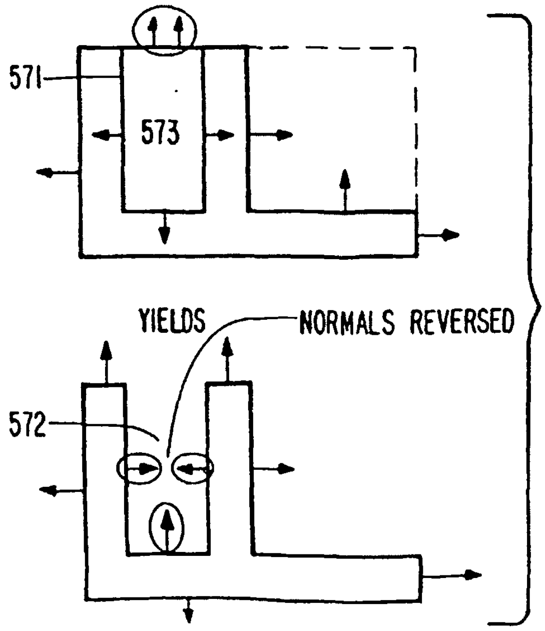


FIG. 74b.

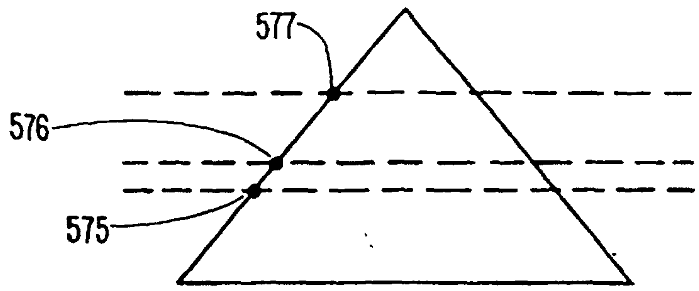


FIG. 75a.

FIG. 75b.

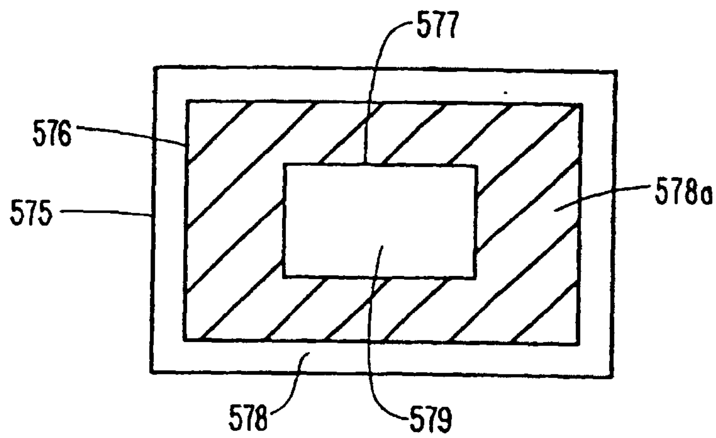


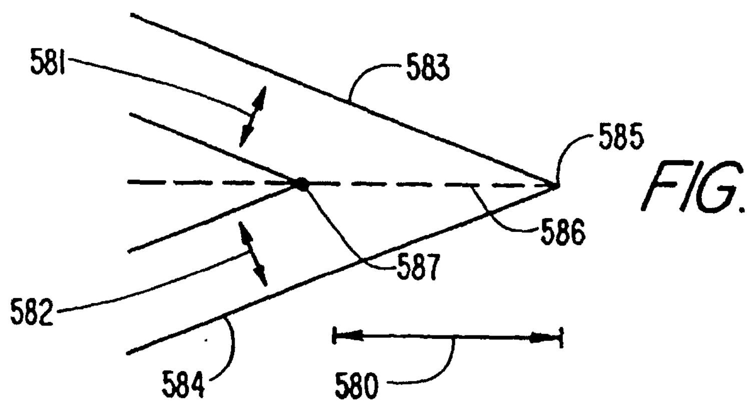


FIG. 76a.

FIG. 76b.

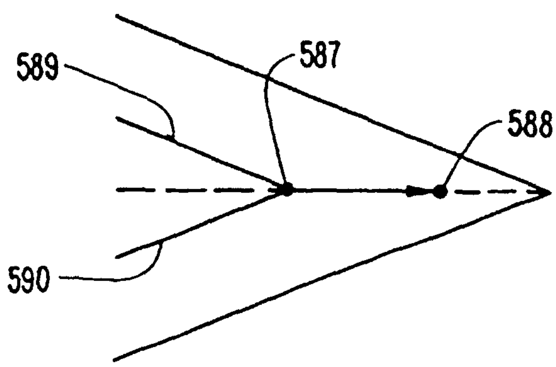

FIG. 77a.

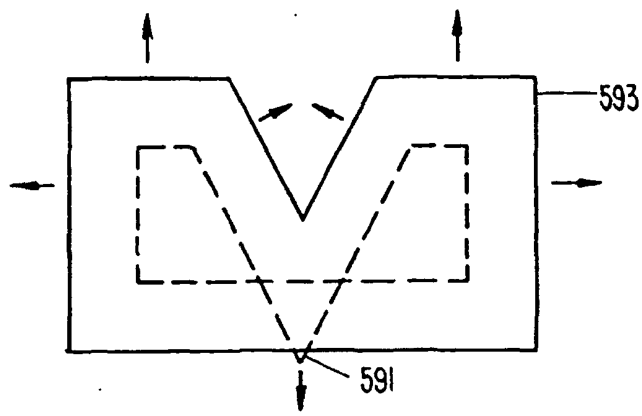


FIG. 77b.

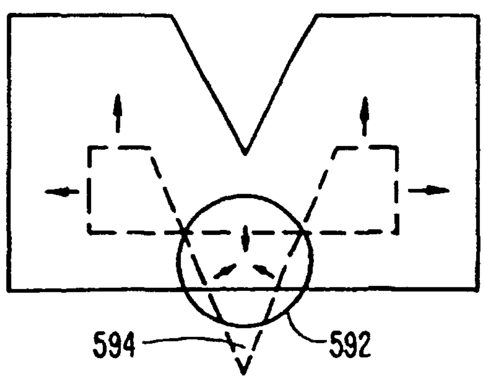


FIG. 77c.

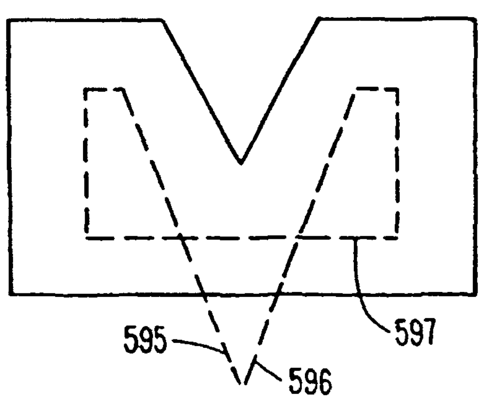

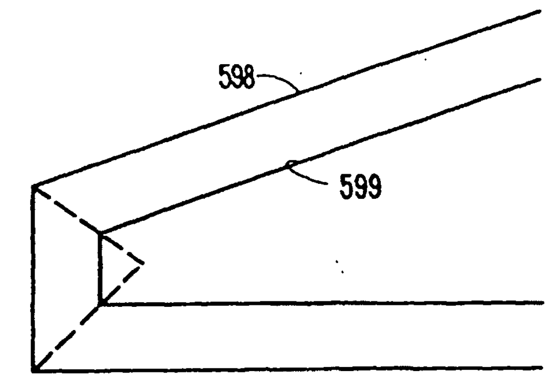


FIG. 78a.

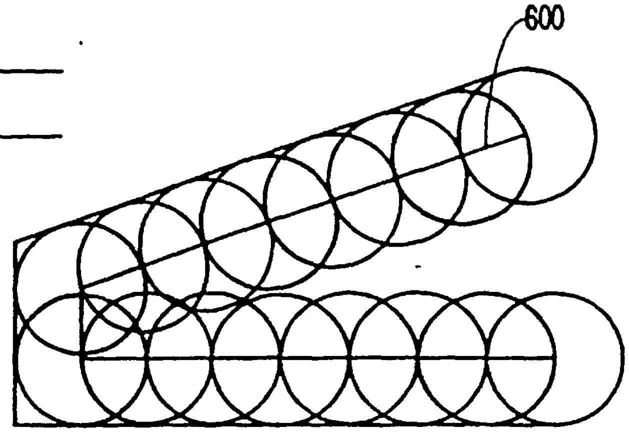


FIG. 78b.

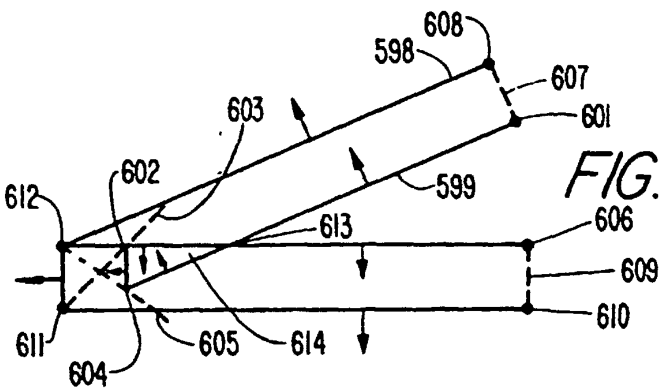


FIG. 78c.

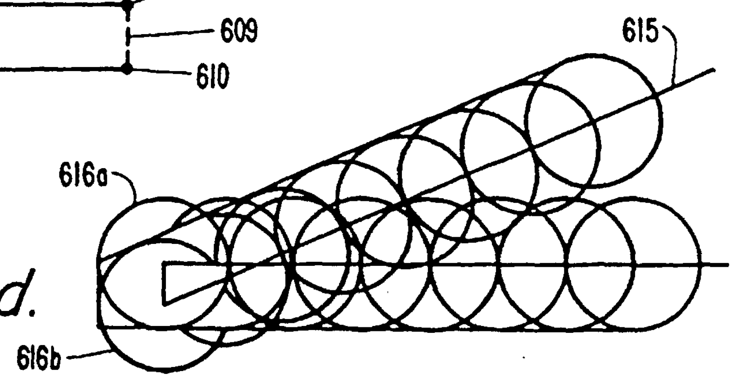


FIG. 78d.

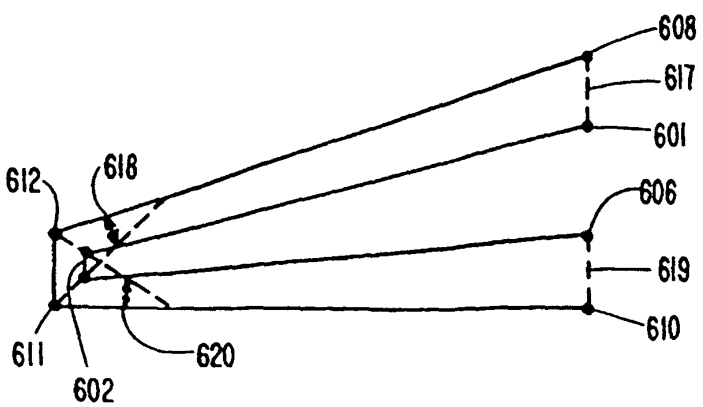


FIG. 78e.

FIG. 79.

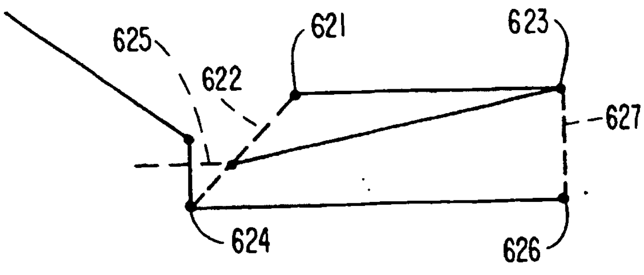


FIG. 80a.

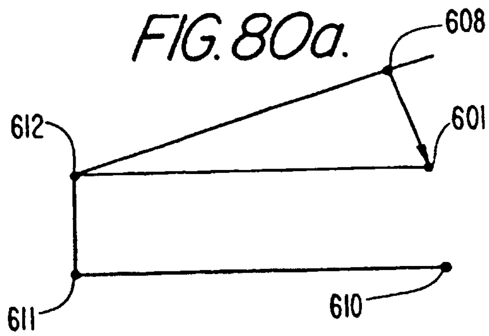


FIG. 80b.

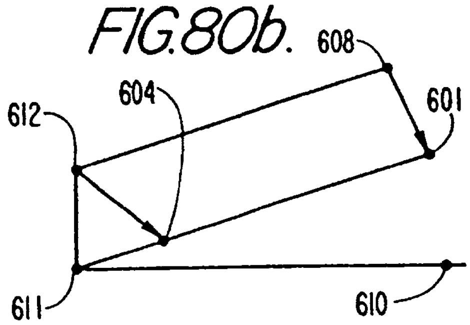


FIG. 80c.

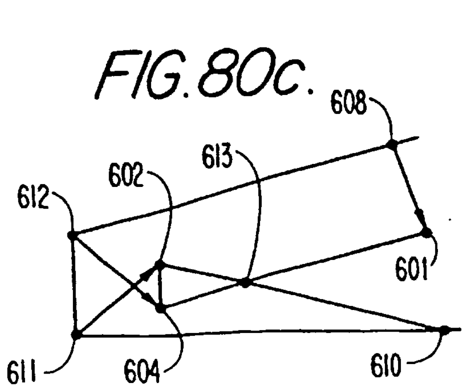


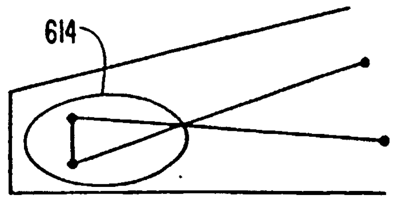


FIG. 81a.

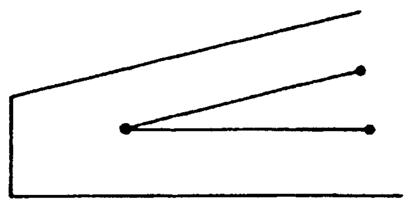

FIG. 81b.

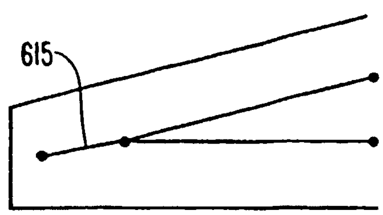


FIG. 81c.

FIG. 82a.

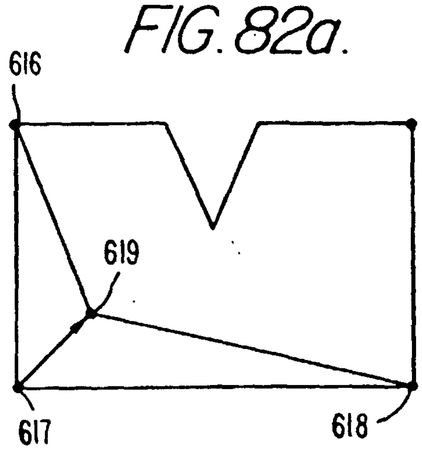


FIG. 82b.

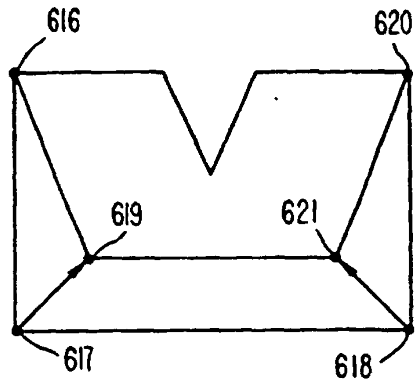


FIG. 82c.

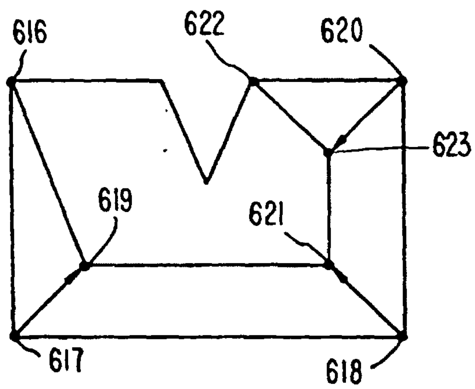


FIG. 82d.

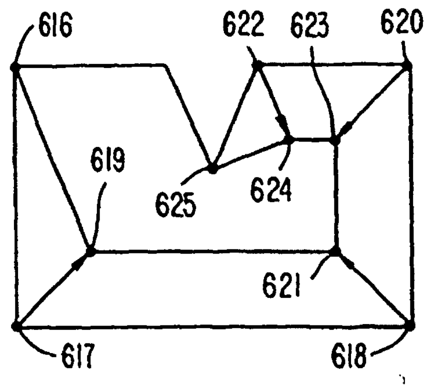


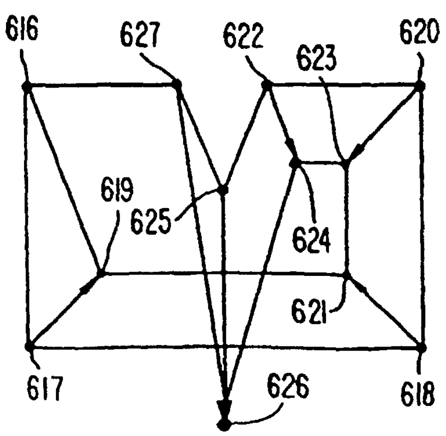


FIG. 82e.

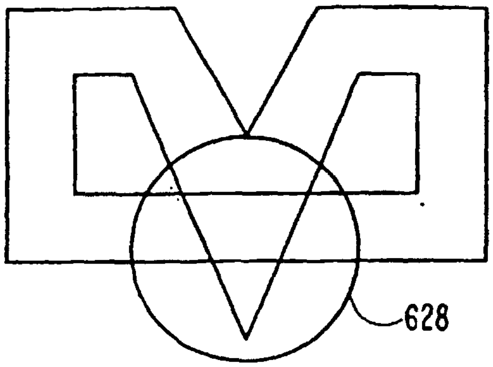


FIG. 83a.

FIG. 83b.

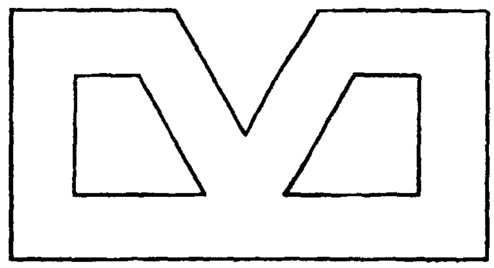

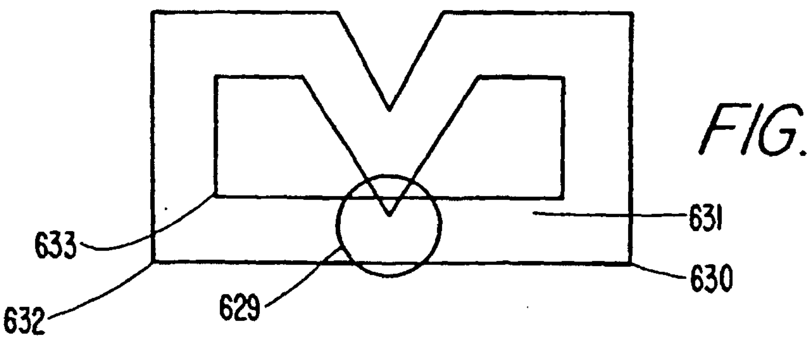


FIG. 83c.

FIG. 83d.

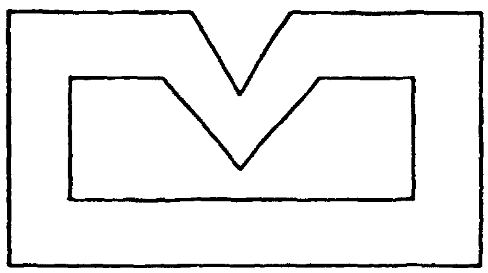

FIG. 84a.

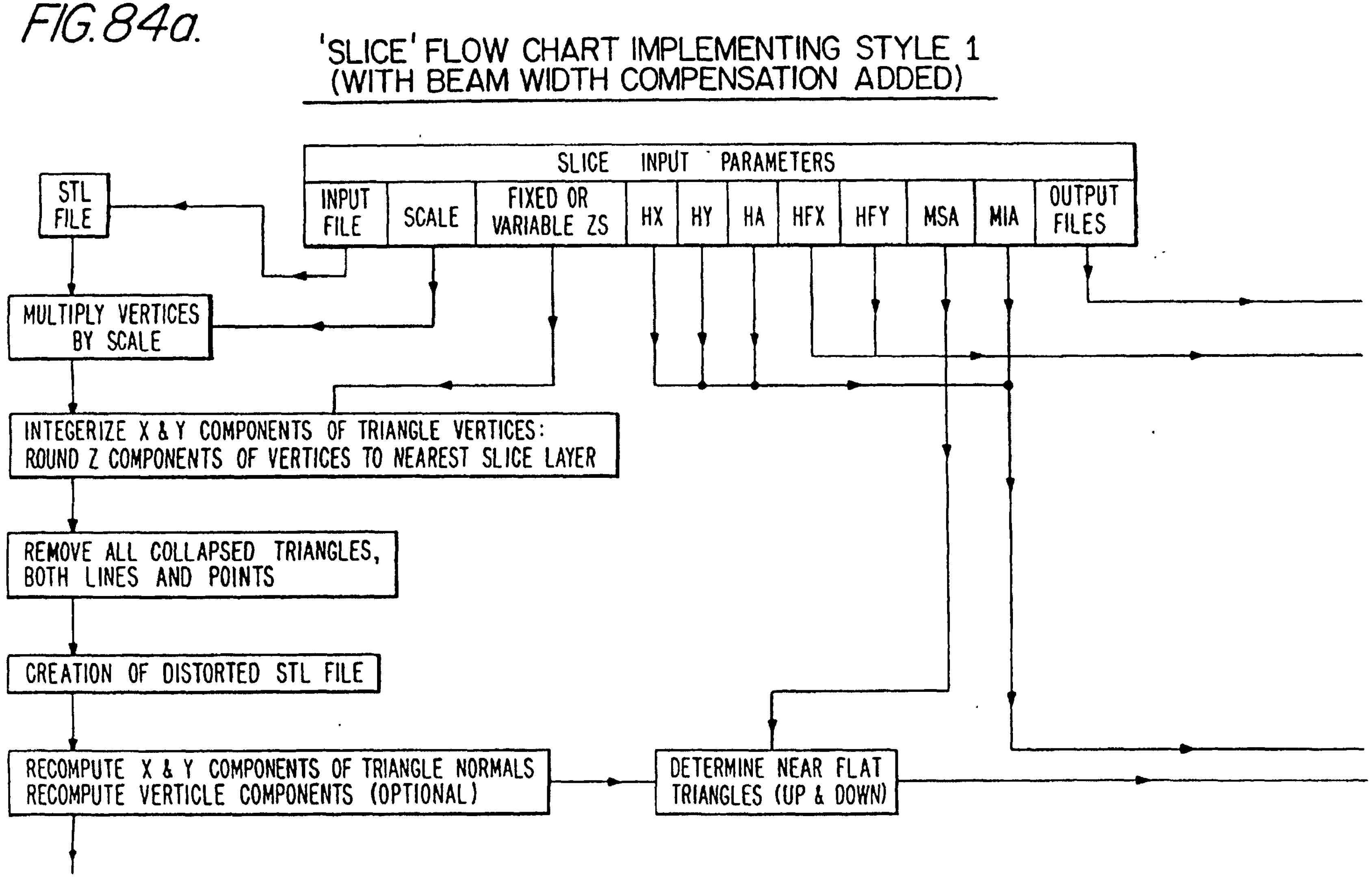
'SLICE' FLOW CHART IMPLEMENTING STYLE 1
(WITH BEAM WIDTH COMPENSATION ADDED)
SLICE INPUT PARAMETERS
INPUT FILE
SCALE
FIXED OR VARIABLE ZS
HX
HY
HA
HFX
HFY
MSA
MIA
OUTPUT FILES
STL FILE
MULTIPLY VERTICES BY SCALE
INTEGERIZE X & Y COMPONENTS OF TRIANGLE VERTICES:
ROUND Z COMPONENTS OF VERTICES TO NEAREST SLICE LAYER
REMOVE ALL COLLAPSED TRIANGLES,
BOTH LINES AND POINTS
CREATION OF DISTORTED STL FILE
RECOMPUTE X & Y COMPONENTS OF TRIANGLE NORMALS
RECOMPUTE VERTICLE COMPONENTS (OPTIONAL)
DETERMINE NEAR FLAT
TRIANGLES (UP & DOWN)

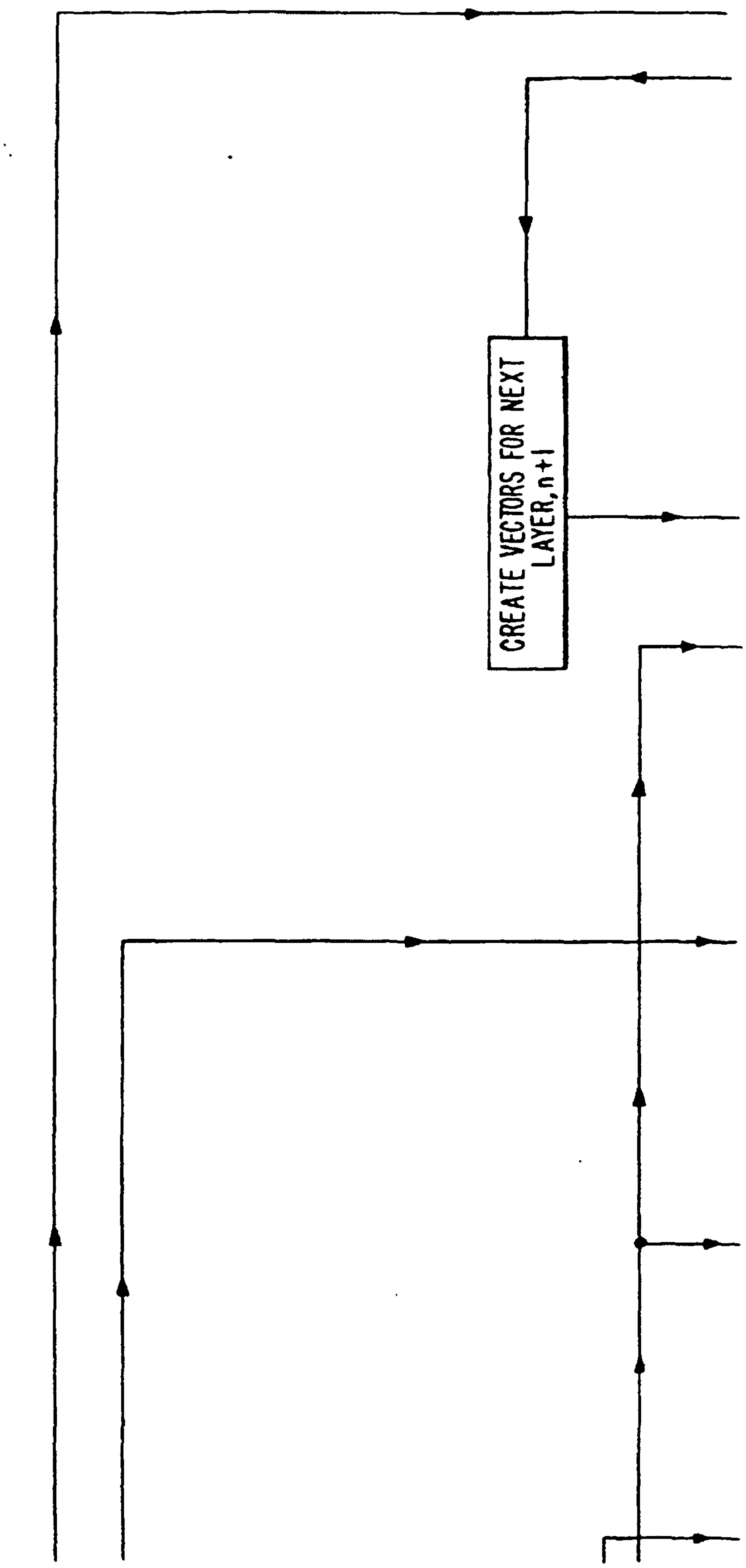


FIG. 84b.

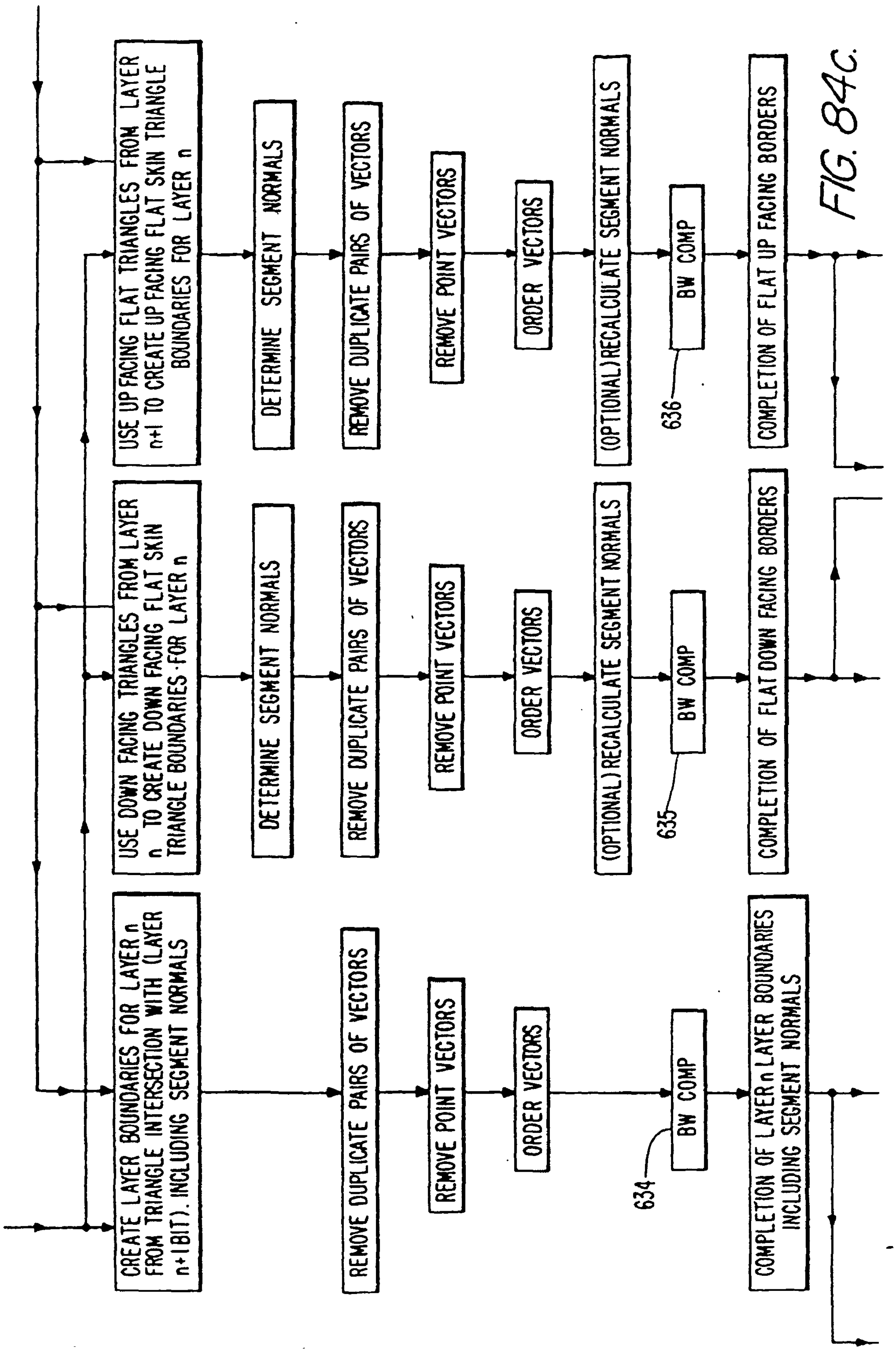
CREATE LAYER BOUNDARIES FOR LAYER n FROM TRIANGLE INTERSECTION WITH (LAYER n+1 BIT). INCLUDING SEGMENT NORMALS
REMOVE DUPLICATE PAIRS OF VECTORS
REMOVE POINT VECTORS
ORDER VECTORS
BW COMP
634
COMPLETION OF LAYER n LAYER BOUNDARIES INCLUDING SEGMENT NORMALS
USE DOWN FACING TRIANGLES FROM LAYER n TO CREATE DOWN FACING FLAT SKIN TRIANGLE BOUNDARIES FOR LAYER n
DETERMINE SEGMENT NORMALS
REMOVE DUPLICATE PAIRS OF VECTORS
REMOVE POINT VECTORS
ORDER VECTORS
(OPTIONAL) RECALCULATE SEGMENT NORMALS
BW COMP
635
COMPLETION OF FLAT DOWN FACING BORDERS
USE UP FACING FLAT TRIANGLES FROM LAYER n+1 TO CREATE UP FACING FLAT SKIN TRIANGLE BOUNDARIES FOR LAYER n
DETERMINE SEGMENT NORMALS
REMOVE DUPLICATE PAIRS OF VECTORS
REMOVE POINT VECTORS
ORDER VECTORS
(OPTIONAL) RECALCULATE SEGMENT NORMALS
BW COMP
636
COMPLETION OF FLAT UP FACING BORDERS

FIG. 84c.

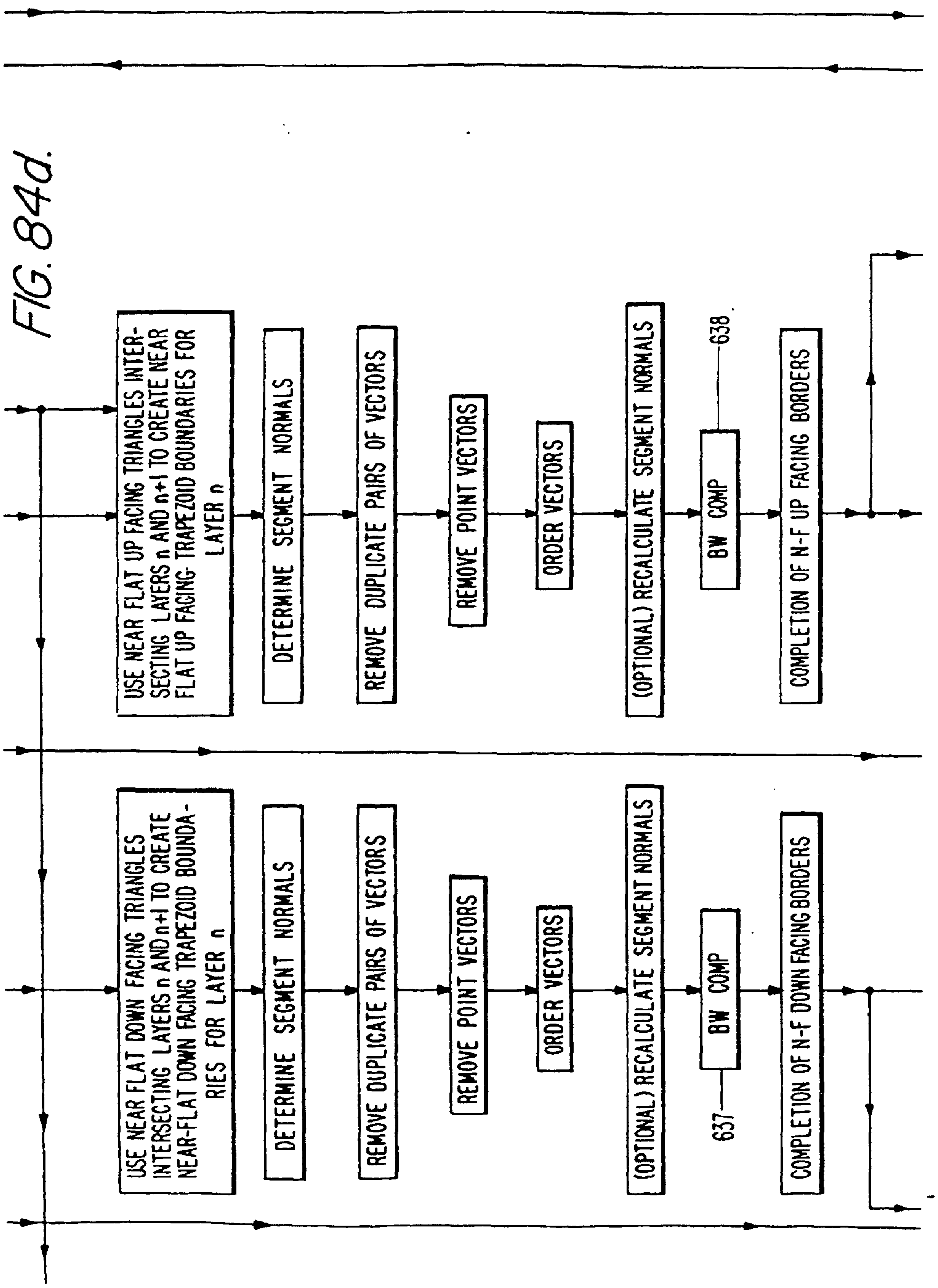
USE NEAR FLAT UP FACING TRIANGLES INTERSECTING LAYERS n AND n+1 TO CREATE NEAR FLAT UP FACING TRAPEZOID BOUNDARIES FOR LAYER n
DETERMINE SEGMENT NORMALS
REMOVE DUPLICATE PAIRS OF VECTORS
REMOVE POINT VECTORS
ORDER VECTORS
(OPTIONAL) RECALCULATE SEGMENT NORMALS
BW COMP
638
COMPLETION OF N-F UP FACING BORDERS
USE NEAR FLAT DOWN FACING TRIANGLES INTERSECTING LAYERS n AND n+1 TO CREATE NEAR-FLAT DOWN FACING TRAPEZOID BOUNDARIES FOR LAYER n
DETERMINE SEGMENT NORMALS
REMOVE DUPLICATE PAIRS OF VECTORS
REMOVE POINT VECTORS
ORDER VECTORS
(OPTIONAL) RECALCULATE SEGMENT NORMALS
BW COMP
637
COMPLETION OF N-F DOWN FACING BORDERS

FIG. 84d.

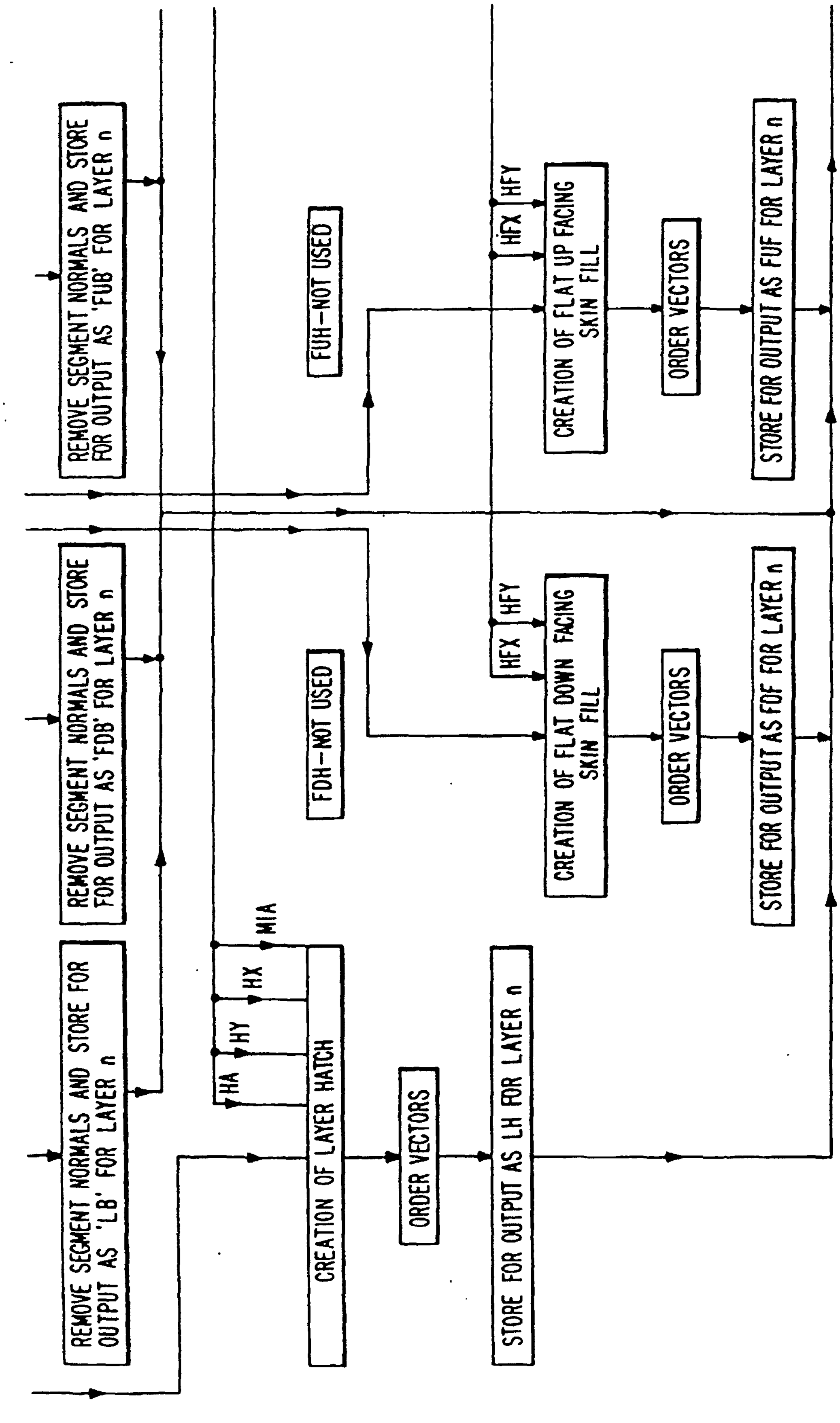
REMOVE SEGMENT NORMALS AND STORE FOR OUTPUT AS 'LB' FOR LAYER n
REMOVE SEGMENT NORMALS AND STORE FOR OUTPUT AS 'FDB' FOR LAYER n
REMOVE SEGMENT NORMALS AND STORE FOR OUTPUT AS 'FUB' FOR LAYER n
HA
HY
HX
MIA
CREATION OF LAYER HATCH
FDH—NOT USED
FUH—NOT USED
ORDER VECTORS
STORE FOR OUTPUT AS LH FOR LAYER n
HFX
HFY
CREATION OF FLAT DOWN FACING SKIN FILL
CREATION OF FLAT UP FACING SKIN FILL
ORDER VECTORS
ORDER VECTORS
STORE FOR OUTPUT AS FDF FOR LAYER n
STORE FOR OUTPUT AS FUF FOR LAYER n

FIG. 84e.